(19) Europäisches Patentamt
European Patent Office
Office européen des brevets

(11) EP 4 580 378 A1

(12) **EUROPEAN PATENT APPLICATION**

(43) Date of publication:
**02.07.2025 Bulletin 2025/27**

(21) Application number: **24215190.0**

(22) Date of filing: **25.11.2024**

(51) International Patent Classification (IPC):
***H10K 85/30*** *(2023.01)* ***H10K 50/852*** *(2023.01)*
***H10K 50/85*** *(2023.01)* *H10K 50/11 (2023.01)*
*H10K 101/10 (2023.01)*

(52) Cooperative Patent Classification (CPC):
**H10K 85/342; H10K 50/85;** H10K 50/11;
H10K 2101/10

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.12.2023 US 202318542270**

(71) Applicant: **Universal Display Corporation**
**Ewing, NJ 08618 (US)**

(72) Inventors:
- **MILAS, Ivan**
**Ewing, 08618 (US)**
- **RYNO, Sean Michael**
**Ewing, 08618 (US)**
- **MARGULIES, Eric A.**
**Ewing, 08618 (US)**
- **SZIGETHY, Geza**
**Ewing, 08618 (US)**
- **SHIH, Wei-Chun**
**Ewing, 08618 (US)**

(74) Representative: **Dragotti & Associati S.R.L.**
**Via Nino Bixio, 7**
**20129 Milano (IT)**

(54) **ORGANIC ELECTROLUMINESCENT MATERIALS AND DEVICES**

(57) The present disclosure provides a metal coordination complex compound. The metal complex compound is capable of functioning as an emitter in an organic light emitting device (OLED) at room temperature, and has a vertical dipole ratio (VDR) greater than 0.33 in the OLED. Formulations, OLEDs, and consumer products including the same are also provided.

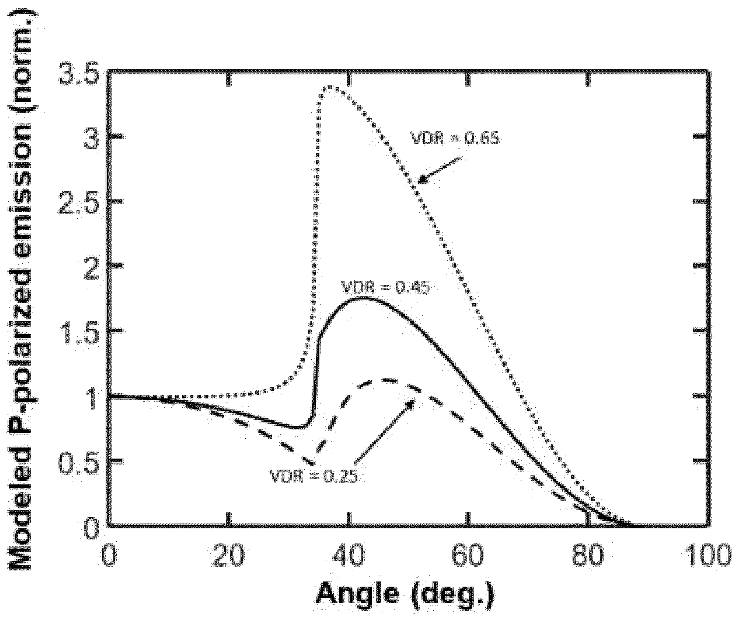


FIG. 3



Processed by Luminess, 75001 PARIS (FR)

## Description

### FIELD

The present disclosure generally relates to organometallic compounds and formulations and their various uses including as emitters in devices such as organic light emitting diodes and related electronic devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as flat panel displays, illumination, and backlighting.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

In some OLED applications, a novel metal coordination complex compound is disclosed that is capable of functioning as an emitter in an organic light emitting device (OLED) at room temperature. The compound comprises a first emissive ligand that is coordinated to the metal;

the compound has a vertical dipole ratio (VDR) > 0.33; and
at least one of the following is true:

(1) the emissive ligand has a spin density population is > 60%;
(2) the emissive ligand has a natural transition orbital (NTO) particle population is > 50%;
(3) the emissive ligand has a ligand-centered character (LC) is > 30%;
(4) the emissive ligand has a complex LLCT is < 40%; and
(5) the emissive ligand has an M/T ratio is > 0.42.

In another aspect, the present disclosure provides a formulation comprising a metal coordination complex compound as described herein.

In yet another aspect, the present disclosure provides an OLED having an organic layer comprising a metal coordination complex compound as described herein.

In yet another aspect, the present disclosure provides a consumer product comprising an OLED with an organic layer comprising a metal coordination complex compound as described herein.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows a graph of modeled P-polarized photoluminescence as a function of angle for emitters with different vertical dipole ratio (VDR) values.
FIG. 4 shows the structure of a metal coordination complex compound as described herein and relevant measurements and features of the same.

FIG. 5 shows the structure of a metal coordination complex compound as described herein and locations of relevant free and bound vectors used for defining a plane P.

## DETAILED DESCRIPTION

### A. Terminology

Unless otherwise specified, the below terms used herein are defined as follows:

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical ($C(O)-R_s$).

The term "ester" refers to a substituted oxycarbonyl ($-O-C(O)-R_s$ or $-C(O)-O-R_s$) radical.

The term "ether" refers to an $-OR_s$ radical.

The terms "sulfanyl" or "thio-ether" are used interchangeably and refer to a -SR, radical.

The term "selenyl" refers to a $-SeR_s$ radical.

The term "sulfinyl" refers to a $-S(O)-R_s$ radical.

The term "sulfonyl" refers to a $-SO_2-R_s$ radical.

The term "phosphino" refers to a $-P(R_s)_2$ radical, wherein each $R_s$ can be same or different.

The term "silyl" refers to a $-Si(R_s)_3$ radical, wherein each $R_s$ can be same or different.

The term "germyl" refers to a $-Ge(R_s)_3$ radical, wherein each $R_s$ can be same or different.

The term "boryl" refers to a $-B(R_s)_2$ radical or its Lewis adduct $-B(R_s)_3$ radical, wherein $R_s$ can be same or different.

In each of the above, $R_s$ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl,

heteroalkenyl, alkynyl, aryl, heteroaryl, and combination thereof. Preferred $R_s$ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group may be optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more General Substituents.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, aryl, heteroaryl, sulfanyl, and combinations thereof.

In yet other instances, the Most Preferred General Substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when $R^1$ represents mono-substitution, then one $R^1$ must be other than H (i.e., a substitution). Similarly, when $R^1$ represents di-substitution, then two of $R^1$ must be other than H. Similarly, when $R^1$ represents zero or no substitution, $R^1$, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[f,h]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

**B. The Compounds of the Present Disclosure**

In some OLED applications, a novel metal coordination complex compound is disclosed that is capable of functioning as an emitter in an organic light emitting device (OLED) at room temperature. The compound comprises a first emissive ligand that is coordinated to the metal;

the compound has a vertical dipole ratio (VDR) > 0.33; and
at least one of the following conditions is true:

(1) the first emissive ligand has a spin density population is > 60%;
(2) the first emissive ligand has a natural transition orbital (NTO) particle population is > 50%;
(3) the first emissive ligand has a ligand-centered character (LC) is > 30%;
(4) the first emissive ligand has a complex LLCT is < 40%; and
(5) the first emissive ligand has an M/T ratio is > 0.42.

Although the minimum requirement is that at least one of the above-listed five conditions is true in the compound, any number of combinations of the five conditions can be true.

As used herein, room temperature is defined as approximately 22°C (*e.g.,* 22°C ± 1°C).

As used herein, "spin density" refers to the electron density applied to free radicals and other open-shell structures. It is defined as the total electron density of electrons of one spin minus the total electron density of the electrons of other spin.

Density functional theory (DFT) was used to calculate the triplet spin density of the compounds. Calculations were performed using the unrestricted B3LYP functional with a CEP-31G basis set. Geometry optimizations for the first triplet excited state were performed in vacuum by setting a spin multiplicity of three. Spin density was then calculated using the CubeGen utility in the program Gaussian as the difference between the alpha and beta spin densities. All calculations were carried out using the program Gaussian. To determine the spin density population on each atom and each grouping of atoms, the spin density was subjected to a Löwdin population analysis as described by Löwdin, P.-O. J. Chem. Phys. 1950, 18, 365 and Löwdin, P.-O. Adv Quantum Chem 1970, 5, 185. This is accomplished by partitioning the spin density into disjoint atom-centered contributions that collectively compose a molecule. These contributions are then collected either individually or as groups as needed.

DFT calculations were performed to determine the energy of the lowest triplet excited state ($T_1$), the percentage of ligand-centered (LC) character, and the percentage of ligand-to-ligand charge transfer (LLCT) involved in $T_1$ of the compounds. The data was gathered using the program Gaussian16. Geometries were optimized using B3LYP functional and CEP-31G basis set. Excited state energies were computed by TDDFT at the optimized ground state geometries. THF solvent was simulated using a self-consistent reaction field to further improve agreement with the experiment. LC character and LLCT contributions were determined via transition density matrix analysis of the excited states.

The calculations obtained with the above-identified DFT functional set and basis set are theoretical. Computational composite protocols, such as the Gaussian16 with B3LYP and CEP-31G protocol used herein, rely on the assumption that electronic effects are additive and, therefore, larger basis sets can be used to extrapolate to the complete basis set (CBS) limit. However, when the goal of a study is to understand variations in HOMO, LUMO, $S_1$, $T_1$, bond dissociation energies, etc. over a series of structurally-related compounds, the additive effects are expected to be similar. Accordingly, while absolute errors from using the B3LYP may be significant compared to other computational methods, the relative differences between the HOMO, LUMO, $S_1$, $T_1$, and bond dissociation energy values calculated with B3LYP protocol are expected to reproduce experiment quite well. See, e.g., Hong et al., Chem. Mater. 2016, 28, 5791-98, 5792-93 and Supplemental Information (discussing the reliability of DFT calculations in the context of OLED materials). Moreover, with respect to iridium or platinum complexes that are useful in the OLED art, the data obtained from DFT calculations correlate very well to actual experimental data. See Tavasli et al., J. Mater. Chem. 2012, 22, 6419-29, 6422 (Table 3) (showing DFT calculations closely correlating with actual data for a variety of emissive complexes); Morello, G.R., J. Mol. Model. 2017, 23:174 (studying of a variety of DFT functional sets and basis sets and concluding the combination of B3LYP and CEP-31G is particularly accurate for emissive complexes). The determination of excited state transition character is performed as a post-processing step on the above-mentioned DFT and TDDFT calculations. This analysis allows for decomposition of the excited state into the hole, i.e., where the excitation originates, and the electron, i.e., the final location of the excited state. Additionally, as this analysis is performed on a calculated property it is objective and repeatable; see Mai et al., Coord. Chem. Rev. 2018, 361, 74-97 (discussing the theoretical basis of the excited state decomposition in transition metal complexes).

Natural transition orbitals (NTO) are obtained from the singular value decomposition of the transition density matrix from the Gaussian16 program. The transition density matrix is obtained from TDDFT at ground state geometries, which were optimized using B3LYP functional and CEP-31G basis set. THF solvent was simulated using a self-consistent

reaction field. The hole NTOs are orbitals obtained by a unitary transformation of the canonical occupied molecular orbitals. The particle NTOs are orbitals obtained by a unitary transformation of the canonical virtual molecular orbitals and represent the location of the excited electron. NTO hole/particle population of an atom and each grouping of atoms are obtained from a Löwdin population analysis.

M/T ratio is calculated from emission spectra of OLED emitters. M is the area of main peak, which is defined as the integration of the area of max peak wavelength ($\lambda_{max}$) $\pm$ 15 nm., while T is total area of the spectrum (normalized intensity) between the points where intensity of the spectra is 0.1%. A high M/T ratio means a dopant has a narrow lineshape (i.e., a larger portion of the emission spectrum is part of the main peak). To determine M/T ratio, thin films are prepared by depositing the same composition and thickness used in the emissive region of the OLED onto a quartz substrate. The emission spectra of the thin films are measured using a Hamamatsu Quantaurus-QY Plus UV-NIR absolute PL quantum yield spectrometer with an excitation wavelength of 340nm.

Vertical dipole ratio (VDR) is the ensemble averaged fraction of dipoles in a sample that are oriented vertically, relative to the substrate plane (where vertical and normal to the substrate are the same). A similar concept is horizontal dipole ratio (HDR) is the ensemble average fraction of dipoles oriented horizontally relative to the substrate plane. By definition, VDR+HDR = 1. VDR can be measured by angle dependent, polarization dependent, photoluminescence measurements. By comparing the measured emission pattern of a photoexcited thin film sample, as a function of polarization, to the computationally modeled pattern, one can determine VDR of the emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher.

In this example used to generate FIG. 3, there is a 30 nm thick film of material with a refractive index of 1.75 and the emission is monitored in a semi-infinite medium of index of 1.75. Each curve is normalized to a photoluminescence intensity of 1 at an angle of zero degrees, which is perpendicular to the surface of the film. As the VDR of the emitter is varied, the peak around 45 degrees increases greatly. When using software to fit the VDR of experimental data, the modeled VDR would be varied until the difference between the modeled data and the experimental data is minimized.

Importantly, the VDR represents the average dipole orientation of the light-emitting compound. Thus, if there are additional emitters in the emissive layer that are not contributing to the emission, the VDR measurement does not report or reflect their VDR. Further, by inclusion of a host that interacts with the emitter, the VDR of a given emitter can be modified, resulting in the measured VDR for the layer that is different from that of the emitter in a different host. Further, in some embodiments, exciplex or excimers are desirable which form emissive states between two neighboring molecules. These emissive states may have a VDR that is different than that if only one of the components of the exciplex or excimer were emitting or present in the sample.

An emitter emits in a direction perpendicular to its transition dipole moment (TDM) vector as this aligns with the electric field vector of the resulting light wave. As such, in a conventional OLED, it is desired for the emitter TDM vector to be highly horizontally aligned to get light emitted in a direction perpendicular to the substrate towards the viewer. Doing this maximizes light outcoupling and minimizes efficiency loss mechanisms such as light waveguiding, within the OLED or substrate, or plasmon coupling. Plasmon coupling is conventionally a major limitation to OLED efficiency which has been designed around, in the art, by spacing the emitter away from the cathode, to the detriment of the device voltage.

For the reasons as identified above, vertically aligned emitters, those possessing a high VDR, have not been widely studied or applied to the field of OLEDs, simply because it is contradictory to the good design purpose of the conventional OLED device. It's now discovered that a high degree of plasmon coupling is desirable for a carefully designed plasmonic OLED. Therefore, high VDR emitters can be used in this situation to increase the rate or yield of plasmon coupling and improve plasmonic OLED efficiency.

In some embodiments, the OLED is a plasmonic OLED. In some embodiments, the OLED is a wave-guided OLED.

In some embodiments, the compound has a VDR equal to or greater than 0.35. In some embodiments, the compound has a VDR equal to or greater than 0.4. In some embodiments, the compound has a VDR equal to or greater than 0.45. In some embodiments, the compound has a VDR equal to or greater than 0.5. In some embodiments, the compound has a VDR equal to or greater than 0.6. In some embodiments, the compound has a VDR equal to or greater than 0.7. In some embodiments, the compound has a VDR equal to or greater than 0.8. In some embodiments, the compound has a VDR equal to or greater than 0.9.

In some embodiments of the metal coordination complex compound of the present disclosure, at least two of the conditions (1) to (5) enumerated above are true. In some embodiments, at least three of the conditions (1) to (5) are true. In some embodiments, at least four of the condition (1) to condition (5) are true.

In some embodiments, the first emissive ligand has a spin density population > 60%. In some embodiments, the first emissive ligand has a spin density population > 70%. In some embodiments, the first emissive ligand has a spin density population > 80%. In some embodiments, the first emissive ligand has a spin density population > 90%. In some embodiments, the first emissive ligand has a spin density population > 95%.

In some embodiments, the first emissive ligand has an NTO particle population > 50%. In some embodiments, the first emissive ligand has an NTO particle population > 60%. In some embodiments, the first emissive ligand has an NTO particle population > 70%. In some embodiments, the first emissive ligand has an NTO particle population > 80%. In some embodiments, the first emissive ligand has an NTO particle population > 90%.

In some embodiments, first emissive ligand has a LC > 30%. In some embodiments, the first emissive ligand has a LC > 40%. In some embodiments, the first emissive ligand has a LC > 50%. In some embodiments, the first emissive ligand has a LC > 60%. In some embodiments, the first emissive ligand has a LC > 70%. In some embodiments, the first emissive ligand has a LC > 80%. In some embodiments, the first emissive ligand has a LC > 90%.

In some embodiments, the first emissive ligand has a complex LLCT < 40%. In some embodiments, the first emissive ligand has a complex LLCT < 30%. In some embodiments, the first emissive ligand has a complex LLCT < 20%. In some embodiments, the first emissive ligand has a complex LLCT < 10%.

In some embodiments, the first emissive ligand has an M/T ratio > 0.42. In some embodiments, the first emissive ligand has an M/T ratio > 0.44. In some embodiments, the first emissive ligand has an M/T ratio > 0.46. In some embodiments, the first emissive ligand has an M/T ratio > 0.48. In some embodiments, the first emissive ligand has an M/T ratio > 0.50.

In some embodiments, the first emissive ligand comprises a polycyclic fused ring system coordinating to the metal.

In some of these embodiments, the polycyclic fused ring system comprises at least three fused rings. In some embodiments, the polycyclic fused ring structure has two 6-membered rings and one 5-membered ring. In some such embodiments, the 5-membered ring is fused to the ring coordinated to Ir and the second 6-membered ring is fused to the 5-membered ring. In some embodiments, the polycyclic fused ring system is selected from the group consisting of dibenzofuran, dibenzothiophene, dibenzoselenophene, and aza-variants thereof. In some such embodiments, moiety E can be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exact one N atom at the 6-position (ortho to the O, S, or Se) with a substituent at the 7-position (meta to the O, S, or Se).

In some of these embodiments, the polycyclic fused ring structure comprises at least four fused rings. In some embodiments, the polycyclic fused ring structure comprises three 6-membered rings and one 5-membered ring. In some such embodiments, the 5-membered ring is fused to the ring coordinated to Ir, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some of these embodiments, the polycyclic fused ring structure comprises at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to Ir, the second 6-membered ring is fused to the 5-membered ring, the third 6-membered ring is fused to the second 6-membered ring, and the fourth 6-membered ring is fused to the third 6-membered ring.

In some of these embodiments, the polycyclic fused ring structure comprises an aza version of the fused rings as described above. In some such embodiments, the polycyclic fused ring structure comprises contains exactly one aza N atom. In some such embodiments, the polycyclic fused ring structure comprises contains exactly two aza N atoms, which can be in one ring, or in two different rings. In some such embodiments, the ring having aza N atom is at least separated by another two rings from the Ir atom. In some such embodiments, the ring having aza N atom is at least separated by another three rings from the Ir atom. In some such embodiments, each of the ortho position of the aza N atom is substituted.

In some embodiments, the compound further comprises a second ligand that is coordinated to the metal; and/or wherein each of the emissive ligand and the second ligand has an effective length, and wherein the effective length of the emissive ligand is at least 3 Å greater than that of the second ligand; and/or

wherein the emissive ligand has at least 5 more non-hydrogen atoms than the second ligand; and/or
wherein the emissive ligand has a molecular weight that is at least 100 amu greater than the molecular weight of the second ligand; and/or
wherein the emissive ligand has at least 3 more aliphatic methylene carbons than the second ligand.

In some embodiments, the compound further comprises a second ligand that is coordinated to the metal; wherein the compound has a first free vector $\mathbf{F_1}$, represented by a bound vector $\mathbf{M_1}$ that connects any two atoms in the compound and passes within 2Å of the metal, and the length of the bound vector $\mathbf{M_1}$ is greater than 18 **Å;** wherein the compound has a second free vector $\mathbf{F_2}$, represented by a bound vector $\mathbf{M_2}$ that connects any two atoms in the compound;

wherein the length of the bound vector $\mathbf{M_2}$ is greater than 18 **Å;** and wherein the compound has a transition dipole moment vector and an angle between the transition dipole moment vector and the cross product of vectors $\mathbf{F_1}$ and $\mathbf{F_2}$ is less than 45 degrees. The transition dipole moment vector is the transition dipole moment vector on the emissive ligand.

An example is shown in FIG. 5 for compound

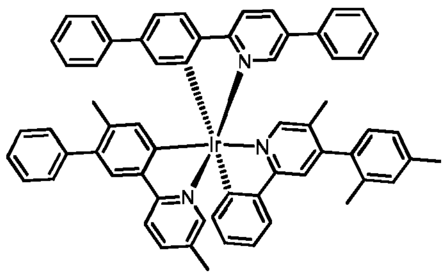

.

As defined herein, a vector defined by two points in the space in the frame of reference of a compound is called a "bound vector" (*e.g.*, $\mathbf{M_1}$ and $M_2$**)**. The location of a bound vector in the space in the frame of reference of the compound is fixed at that particular location within the frame of reference of the compound. In contrast, a "free vector," such as **F1** or **F2** has a magnitude and direction only. In this instance, plane **P** is defined by free vectors **F1** and **F2,** and the metal M. Thus, the cross-product of **F1** and **F2** would define the normal to plane **P.** Sample calculations for the compound in FIG. 5 are provided in the following Table 2:

| M1 Length (Å) | M1 Length (Å) | Angle Between F1 and F2 (degrees) | Maximum ⊥ Distance from Plane P (Å) | Angle between TDM and Normal to Plane P (degrees) |
|---|---|---|---|---|
| 20.7 | 18.1 | 79 | 5.1 | 9 |

In this aspect, the coordinates of the atoms were determined using the lowest energy structure in the triplet state with the spin constrained on the emitting ligand performed using DFT in the LACVP* basis set and B3LYP functional. The transition dipole moment (TDM) is then calculated using this geometry.

In Table 2, "maximum ⊥ Distance from Plane P (Å)" means the maximum perpendicular distance of an atom from Plane P.

In some embodiments, the second free vector $\mathbf{F_2}$ forms an angle greater than 45 degrees with the first free vector $F_1$.

Where more than one pair of atoms meets the requirements for the first bound vector $\mathbf{M_1}$**,** the pair forming the longest first bound vector that meets the other requirements is selected. Where more than one pair of atoms meets the requirements for the second bound vector $\mathbf{M_2}$**,** the pair forming the longest second bound vector that meets the other requirements is selected.

In some embodiments, the complex compound has a first free vector $\mathbf{F_1}$, represented by a first bound vector $\mathbf{M_1}$ that connects any two atoms in the compound and passes within 1 **Å** of the metal, and has a length greater than 18 **Å;** wherein the compound has a second free vector $\mathbf{F_2}$, represented by a second bound vector $\mathbf{M_2}$ that connects any two atoms in the compound and has a length greater than 18 **Å;** and wherein the angle between the emissive transition dipole moment vector and the cross product of vectors $\mathbf{F_1}$ and $\mathbf{F_2}$ is less than 45 degrees.

In some embodiments, the atoms forming the second bound vector $\mathbf{M_2}$ are in the same ligand and the atoms forming the first bound vector $\mathbf{M_1}$ are in different ligands. In some embodiments, the atoms forming the second bound vector $\mathbf{M_2}$ are in a different ligand that either of the atoms forming the first bound vector $\mathbf{M_1}$**.**

In some embodiments, the second vector $\mathbf{F_2}$ forms an angle greater than 45 degrees with $\mathbf{F_1}$**.**

In some embodiments of the second aspect, the second vector $\mathbf{F_2}$ is the longest vector that connects any two atoms in the molecule and forms an angle greater than 60 degrees with $\mathbf{F_1}$**.**

In some embodiments of the second aspect, the lengths of $\mathbf{F_1}$ and $\mathbf{F_2}$ are both greater than 20 Å. In some embodiments of the second aspect, the lengths of $F_1$ and $\mathbf{F_2}$ are both greater than 22 Å.

In some embodiments, the angle between the emissive transition dipole moment vector and the cross product of vectors $\mathbf{F_1}$ and $\mathbf{F_2}$ is less than 30 degrees. In some embodiments, the angle between the emissive transition dipole moment vector and the cross product of vectors $\mathbf{F_1}$ and $\mathbf{F_2}$ is less than 20 degrees.

In some embodiments, the compound has a plane **P** defined by free vectors $\mathbf{F_1}$ and $\mathbf{F_2}$**,** represented by corresponding bound vectors $\mathbf{M_1}$ and $\mathbf{M_2}$**,** and the plane **P** is parallel to $\mathbf{M_1}$ and $\mathbf{M_2}$ and passes through the metal M; and a sum of the perpendicular distance from the plane **P** to an atom farthest above the plane **P,** and the perpendicular distance from the plane P to an atom farthest below the plane **P,** is less than 14 Å. In some such embodiments, a sum of the

perpendicular distance from the plane **P** to an atom farthest above the plane **P,** and the perpendicular distance from the plane P to an atom farthest below the plane **P,** is less than 12 Å. In some such embodiments, a sum of the perpendicular distance from the plane **P** to an atom farthest above the plane **P,** and the perpendicular distance from the plane P to an atom farthest below the plane **P,** is less than 10 **Å.**

The perpendicular distance from the plane **P** was calculated using the standard formula for distance of a point from a plane:

$$distance = \frac{|ax_0 + by_0 + cz_0 + d|}{\sqrt{a^2 + b^2 + c^2}}$$

where a, b, c are components of the plane normal vector, $x_0$, $y_0$, $z_0$ are the coordinates of the atom, and d is the constant of the plane equation that ensures that the plane passes through the metal atom.

In some embodiments, the compound comprises a first ligand and a second ligand with each coordinated to the metal. In some embodiments of such compound, the compound can have two metal-dative bonds in a trans configuration; wherein the compound has a first vector $\mathbf{W_1}$ formed between any atom on the periphery of the compound and the metal; wherein the compound has a second vector $\mathbf{W_2}$ formed between any other atom on the periphery of the compound and the metal; wherein each magnitude of $\mathbf{W_1}$ and $W_2$ is greater than 9.5 Â; and wherein the compound has an emissive transition dipole moment vector and an angle between the emissive transition dipole moment vector and the cross product of vectors $\mathbf{W_1}$ and $\mathbf{W_2}$ is less than 45 degrees.

In some embodiments, the compound has a transition dipole moment vector and the compound is a tetracoordinate square planar in which the transition dipole moment vector is no less than 45 degrees deviated from a reference plane defined by at least three atoms at the periphery of a ligand that are at least 8Å away from one another.

In some embodiments, the metal M is selected from the group consisting of Ir, Rh, Re, Ru, Os, Pt, Pd, Ag, Au, and Cu.

In some embodiments, the compound has a formula of $M(L_A)_p(L_B)_q(L_C)_r$, wherein $L_A$ is the emissive ligand; $L_B$ and $L_C$ are each a bidentate ligand; and wherein p is 1, 2, or 3; q is 0, 1, or 2; r is 0, 1, or 2; and p+q+r is the oxidation state of the metal M.

In some embodiments where the compound has the formula of $M(L_A)_p(L_B)_q(L_C)_r$, the compound can have a formula selected from the group consisting of $Ir(L_A)_3$, $Ir(L_A)(L_B)_2$, $Ir(L_A)_2(L_B)$, $Ir(L_A)_2(L_C)$, and $Ir(L_A)(L_B)(L_C)$; and wherein $L_A$, $L_B$, and $L_C$ are different from each other.

In some embodiments where the compound has the formula of $M(L_A)_p(L_B)_q(L_C)_r$, where $L_A$ comprises a structure of Formula I:

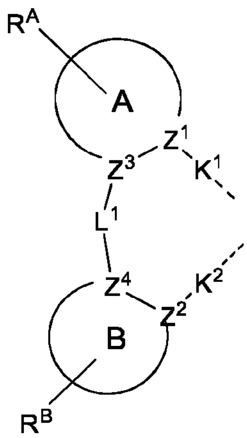
;

wherein moieties A and B are each independently a monocyclic ring or a polycyclic fused ring system, wherein the monocyclic ring or each ring of the polycyclic fused ring system is independently a 5-membered to 10-membered carbocyclic or heterocyclic ring;

wherein $Z^1$-$Z^4$ are each independently C or N;

wherein $K^1$ and $K^2$ are each independently selected from the group consisting of a direct bond, O, S, $N(R^\alpha)$, $P(R^\alpha)$, $B(R^\alpha)$, $C(R^\alpha)(R^\beta)$, and $Si(R^\alpha)(R^\beta)$;

wherein $L^1$ selected from the group consisting of a direct bond, BR, BRR', NR, PR, P(O)R, O, S, Se, C=O, C=S, C=Se, C=NR', C=CRR', S=O, $SO_2$, CR, CRR', SiRR', and GeRR';

wherein $R^A$ and $R^B$ each independently represents mono to the maximum allowable substitutions, or no substitution;

wherein each R, R', $R^{\alpha}$, $R^{\beta}$, $R^A$, and $R^B$ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
wherein $L_A$ is coordinated to a metal M;
wherein M is coordinated to at least one ancillary ligand;
wherein $L_A$ can be joined with one or more additional ligands to form a tridentate, tetradentate, pentadentate, or hexadentate ligand; and
any two substituents may be joined or fused to form a ring.

In some embodiments of Formula I, at least one of moieties A or B having a fused ring system comprising four or more 5-membered and/or 6 membered carbocyclic or heterocyclic rings.

In some embodiments of Formula I, each R, R', Rα, Rβ, RA, and RB is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments of Formula I, the ligand $L_A$ has a structure of Formula I. In some embodiments, the ligand $L_A$ has a structure consisting essentially of a structure of Formula I.

In some embodiments of Formula I, moieties A and B in Formula I are each independently a monocyclic ring or a polycyclic fused ring system, wherein the monocyclic ring or each ring of the polycyclic fused ring system is independently a 5- or 6-membered carbocyclic or heterocyclic ring. In some embodiments, each of moiety A and moiety B is independently aryl or heteroaryl.

In some embodiments of Formula I, at least one of $R^A$ or $R^B$ is partially or fully deuterated. In some embodiments, at least one $R^A$ is partially or fully deuterated. In some embodiments, at least one $R^B$ is partially or fully deuterated. In some embodiments, at least one R or R' is partially or fully deuterated.

In some embodiments of Formula I, each of moiety A and moiety B is independently selected from the group consisting of the moieties in the following Cyclic Moiety LIST: benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, benzimidazole derived carbene, aza-benzimidazole, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments of Formula I, the aza variant includes one N on a benzo ring. In some embodiments, the aza variant includes one N on a benzo ring and the N is bonded to the metal M.

In some embodiments of Formula I, moiety A is a monocyclic ring.

In some embodiments of Formula I, moiety A is selected from the group consisting of benzene, pyridine, pyrimidine, pyridazine, pyrazine, triazine, imidazole, pyrazole, pyrrole, oxazole, furan, thiophene, thiazole, and triazole.

In some embodiments of Formula I, moiety A is pyridine, pyrazole, imidazole, or imidazole derived carbene. In some embodiments, moiety A is a polycyclic fused ring system. In some embodiments, moiety A is selected from the group consisting of naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, benzimidazole derived carbene, aza-benzimidazole, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments of Formula I, moiety A is a polycyclic fused ring comprising three 5- or 6-membered carbocyclic or heterocyclic rings. In some embodiments, moiety A is quinoline, isoquinoline, indazole, benzimidazole, or benzimidazole-derived carbene. In some embodiments, moiety A is a polycyclic fused ring comprising at least four 5- or 6-membered carbocyclic or heterocyclic rings.

In some embodiments of Formula I, moiety A comprises a moiety A1 that is annulated by a moiety A2, wherein moiety A1 comprises $Z^1$, and each of moiety A1 and moiety A2 are independently selected from the group consisting of the moieties in the Cyclic Moiety List.

In some embodiments of Formula I, moiety A1 is selected from the group consisting of aza-carbazole, aza-dibenzofuran, aza-dibenzothiophene, quinoxaline, phthalazine, aza-phenanathrene, aza-anthracene, phenanthridine, and aza-fluorene.

In some embodiments of Formula I, moiety A2 is benzene or naphthalene.

In some embodiments of Formula I, moiety B is a monocyclic ring. In some embodiments, moiety B is selected

from the group consisting of benzene, pyridine, pyrimidine, pyridazine, pyrazine, triazine, imidazole, pyrazole, pyrrole, oxazole, furan, thiophene, thiazole, and triazole. In some embodiments, moiety B is benzene. In some embodiments, moiety B is a polycyclic fused ring system.

In some embodiments of Formula I, moiety B is selected from the group consisting of naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, benzimidazole derived carbene, aza-benzimidazole, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments of Formula I, moiety B is a polycyclic fused ring comprising three 5- or 6-membered carbocyclic or heterocyclic rings.

In some embodiments of Formula I, moiety B is carbazole, dibenzofuran, dibenzothiophene, quinoxaline, phthalazine, phenanthrene, anthracene, phenanthridine, and fluorene.

In some embodiments of Formula I, moiety B is a polycyclic fused ring comprising at least four 5- or 6-membered carbocyclic or heterocyclic rings.

In some embodiments of Formula I, moiety B comprises a moiety B1 that is annulated by a moiety B2, wherein moiety B1 comprises $Z^2$, and each of moiety B1 and moiety B2 are independently selected from the group consisting of the moieties in the Cyclic Moiety List.

In some embodiments of Formula I, moiety B1 is selected from the group consisting of carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments of Formula I, moiety B2 is benzene or naphthalene. In some embodiments, moiety B2 is dibenzofuran or naphthalene.

In some embodiments of Formula I, $Z^1$ is N and $Z^2$ is C. In some embodiments, $Z^1$ is carbene carbon and $Z^2$ is C.

In some embodiments of Formula I, each of $Z^2$ to $Z^4$ is C. In some embodiments, at least one of $Z^2$ to $Z^4$ is N.

In some embodiments of Formula I, each of $K^1$ and $K^2$ is a direct bond. In some embodiments, at least one of $K^1$ or $K^2$ is not a direct bond. In some embodiments, exactly one of $K^1$ or $K^2$ is not a direct bond. In some embodiments, $K^1$ is not a direct bond and $Z^1$ is C. In some embodiments, $K^2$ is not a direct bond and $Z^2$ is C. In some embodiments, $K^1$ is a direct bond. In some embodiments, $K^1$ is O or S. In some embodiments, $K^1$ is O. In some embodiments, $K^1$ is S.

In some embodiments of Formula I, $K^1$ is selected from the group consisting of $N(R^\alpha)$, $P(R^\alpha)$, and $B(R^\alpha)$. In some embodiments, $K^1$ is selected from the group consisting of $C(R^\alpha)(R^\beta)$, and $Si(R^\alpha)(R^\beta)$.

In some embodiments of Formula I, $K^2$ is a direct bond. In some embodiments, $K^2$ is O or S. In some embodiments $K^2$ is O. In some embodiments, $K^2$ is S.

In some embodiments of Formula I, $K^2$ is selected from the group consisting of $N(R^\alpha)$, $P(R^\alpha)$, and $B(R^\alpha)$. In some embodiments, $K^2$ is selected from the group consisting of $C(R^\alpha)(R^\beta)$, and $Si(R^\alpha)(R^\beta)$.

In some embodiments of the compound having $L_A$ of Formula I, the ligand $L_A$ comprises an electron-withdrawing group selected from the group consisting of the structures of the following EWG1 LIST: F, $CF_3$, CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^+N(R^{k2})_3$, $(R^{k2})_2CCN$, $(R^{k2})_2CCF_3$, $CNC(CF_3)_2$, $BR^{k3}R^{k2}$, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate,

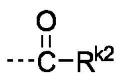, 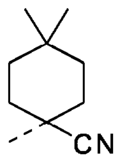,

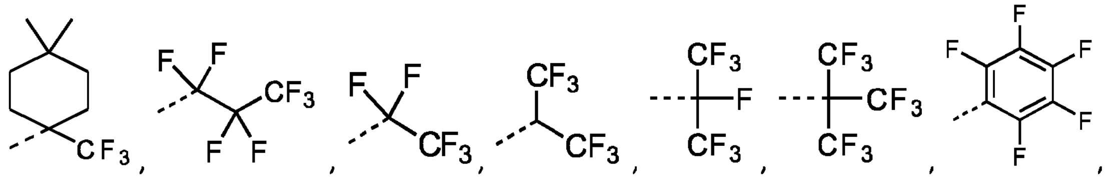

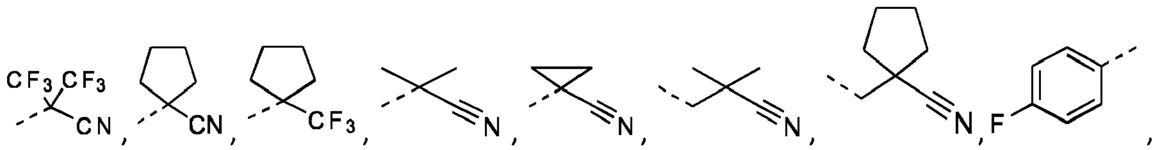

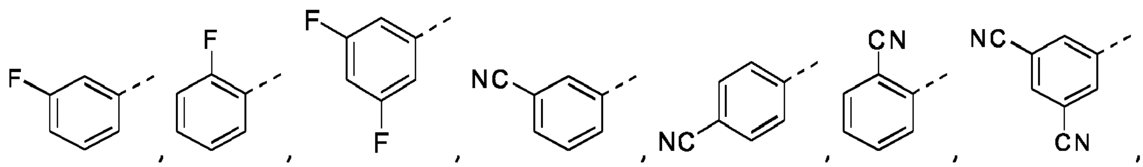

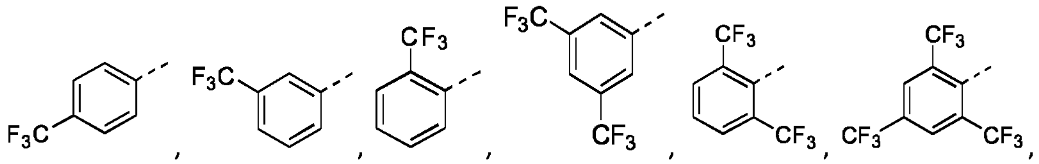

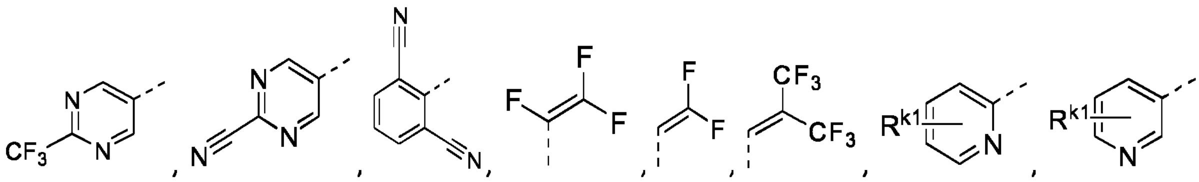

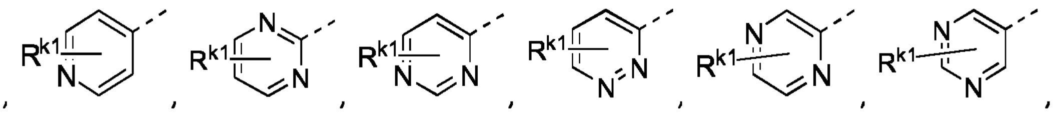

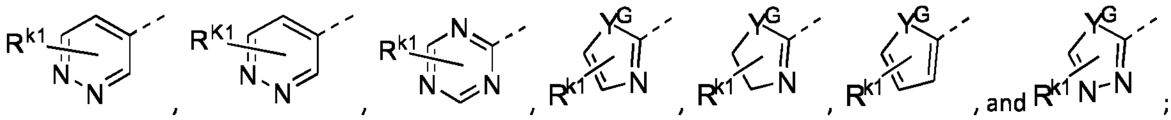

wherein each $R^{k1}$ represents mono to the maximum allowable substitution, or no substitutions;

wherein $Y^G$ is selected from the group consisting of $BR_e$, $NR_e$, $PR_e$, O, S, Se, C=O, S=O, $SO_2$, $CR_eR_f$, $SiR_eR_f$, and $GeR_eR_f$; and

wherein each of $R^{k1}$, $R^{k2}$, $R^{k3}$, $R_e$, and $R_f$ is independently a hydrogen or a substituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof.

In some embodiments of the compound having $L_A$ of Formula I, the ligand $L_A$ comprises an electron-withdrawing group selected from the group consisting of the structures of the following EWG2 List: ,

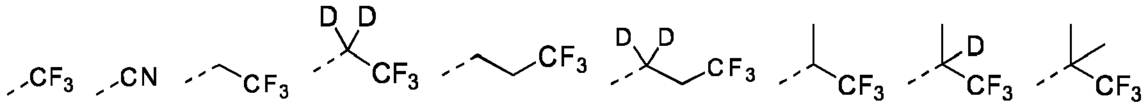

E2, E3, E4, E5, E6, E7, E8, E9, E10,

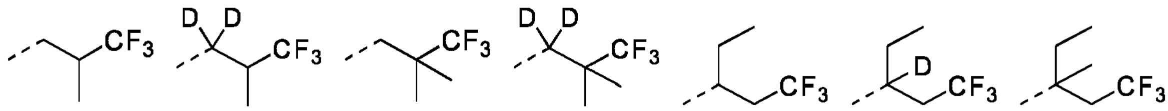

E11, E12, E13, E14, E15, E16, E17,

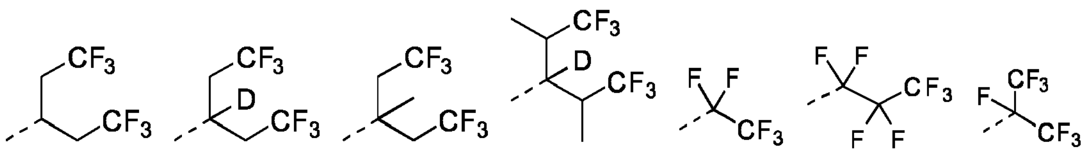

E18, E19, E20, E21, E22, E23, E24,

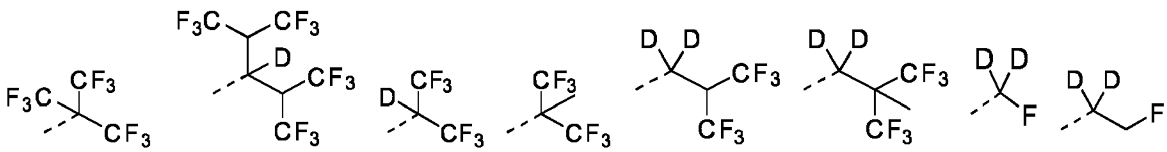

E25, E26, E27, E28, E29, E30, E31, E32,

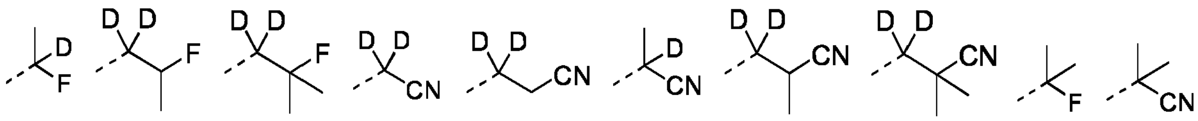

E33, E34, E35, E36, E37, E38, E39, E40, E41, E42,

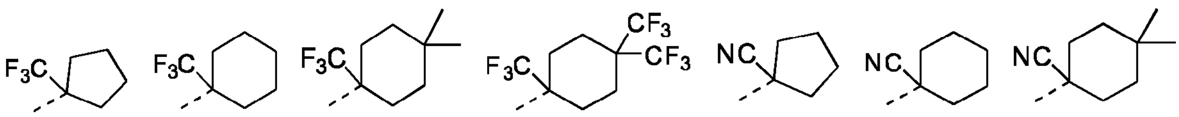

E43, E44, E45, E46, E47, E48, E49,

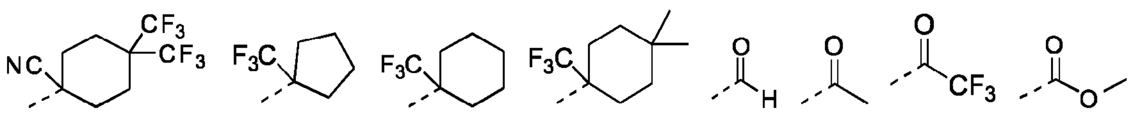

E50, E51, E52, E53, E54, E55, E56, E57,

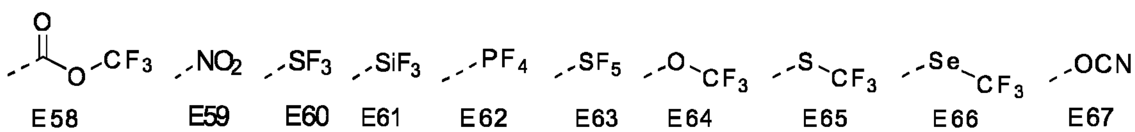

E58, E59, E60, E61, E62, E63, E64, E65, E66, E67,

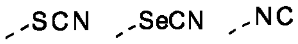
E68 , E69 , E70 ,
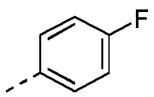
E71 ,
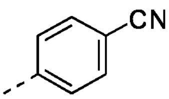
E72 ,
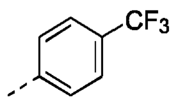
E73 ,
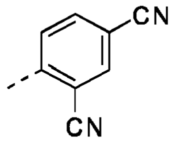
E74 ,

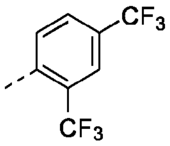
E75 ,
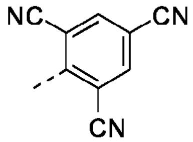
E76 ,
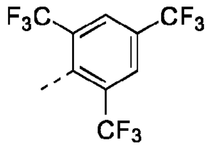
E77 ,
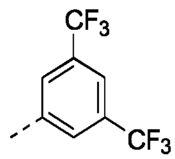
E78 ,
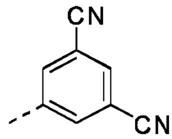
E79 ,
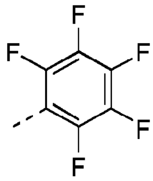
E80 ,

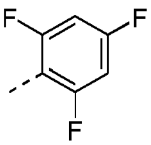
E81 ,
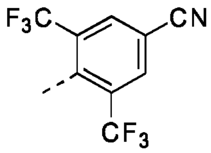
E82 ,
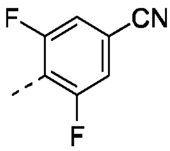
E83 ,
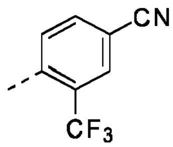
E84 ,
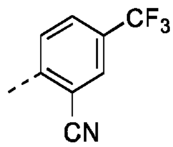
E85 ,
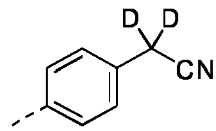
E86 ,

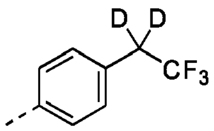
E87 ,
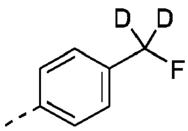
E88 ,
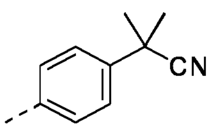
E89 ,
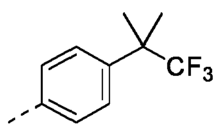
E90 ,
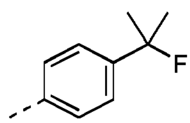
E91 ,

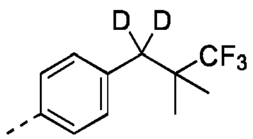
E92 ,
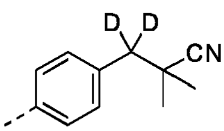
E93 ,
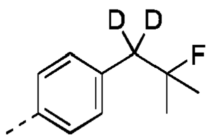
E94 ,
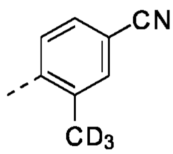
E95 ,
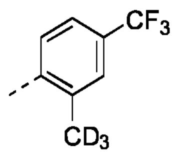
E96 ,

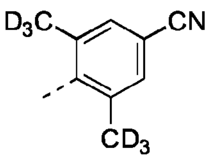
E97 ,
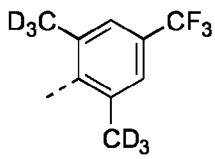
E98 ,
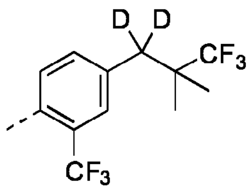
E99 ,
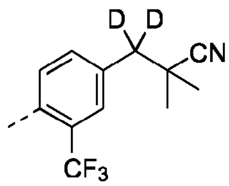
E100 ,
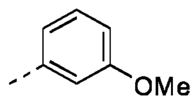
E101 ,

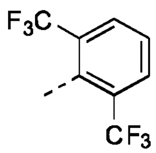
E102 ,
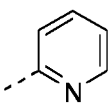
E103 ,
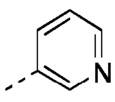
E104 ,
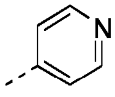
E105 ,
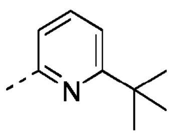
E106 ,
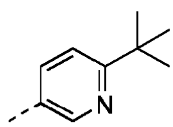
E107 ,
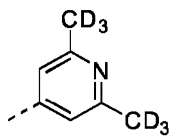
E108 ,

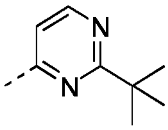
E109,
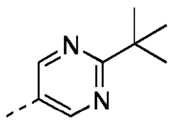
E110,
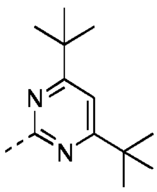
E111,
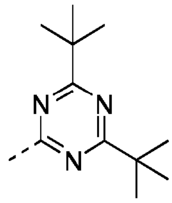
E112,
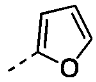
E113,
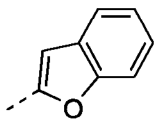
E114,
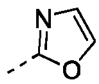
E115,

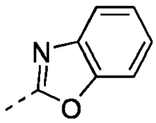
E116,
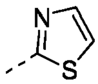
E117,
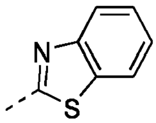
E118,
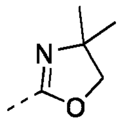
E119,
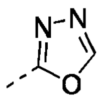
E120,
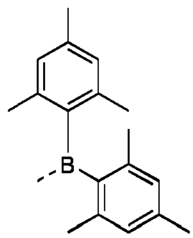
E121,
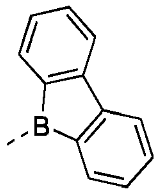
E122,

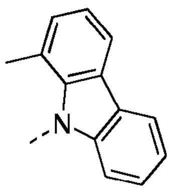
E123,
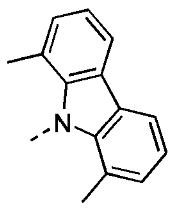
E124, and
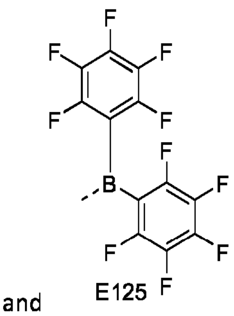
E125.

In some embodiments of the compound having $L_A$ of Formula I, the ligand $L_A$ comprises an electron-withdrawing group selected from the group consisting of the structures of the following EWG3 LIST: ,

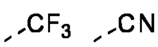
E2, E3,
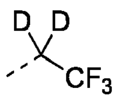
E5,
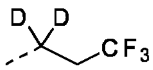
E7,
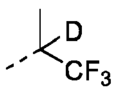
E9,
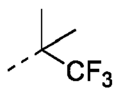
E10,
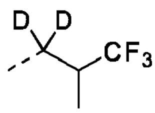
E12,
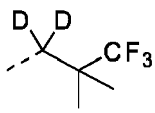
E14,
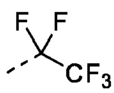
E22,

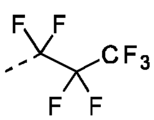
E23,
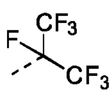
E24,
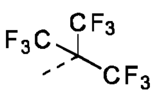
E25,
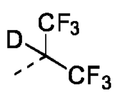
E27,
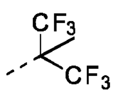
E28,
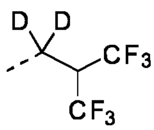
E29,
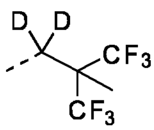
E30,
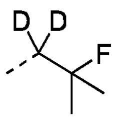
E35,

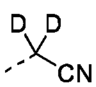
E36,
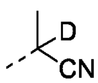
E38,
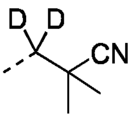
E40,
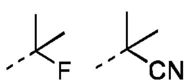
E41, E42,
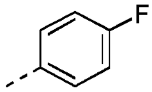
E71,
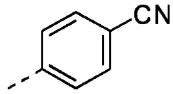
E72,
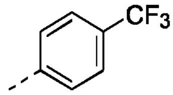
E73,

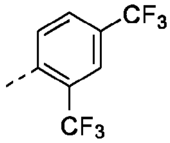 E75 , 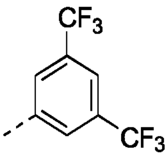 E78 , 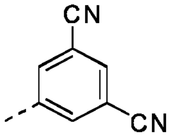 E79 , 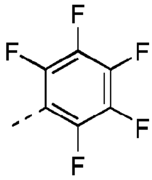 E80 , 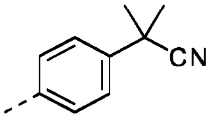 E89 , 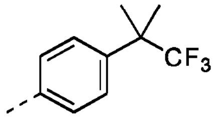 E90 ,

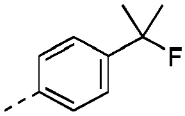 E91 , 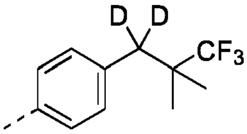 E92 , 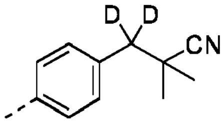 E93 , 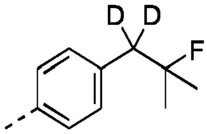 E94 , 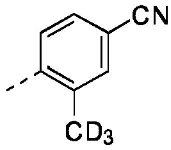 E95 ,

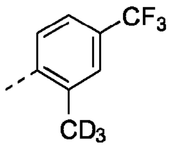 E96 , 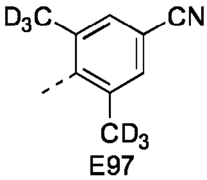 E97 , 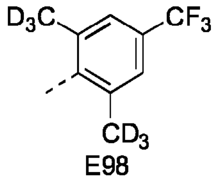 E98 , 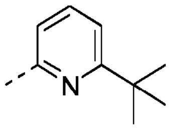 E106 , 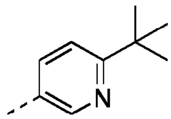 E107 , 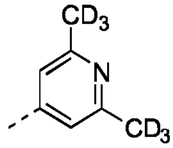 E108 ,

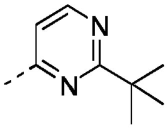 E109 , 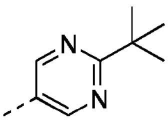 E110 , 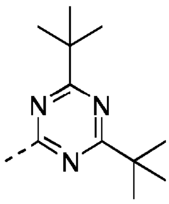 E112 , 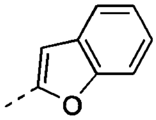 E114 , 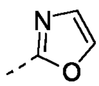 E115 , 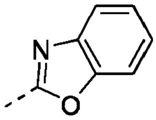 E116 , and 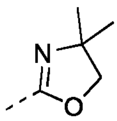 E119 .

In some embodiments of the compound having $L_A$ of Formula I, the ligand $L_A$ comprises an electron-withdrawing group selected from the group consisting of the structures of the following EWG4 LIST: ,

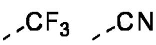 E2 , E3 , 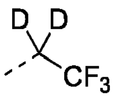 E5 , 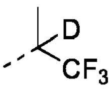 E9 , 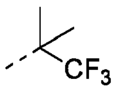 E10 , 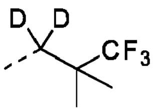 E14 , 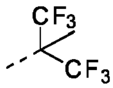 E28 , 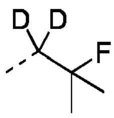 E35 , 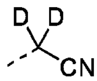 E36 , 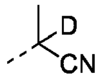 E38

, 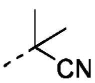 E42 , 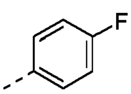 E71 , 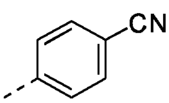 E72 , 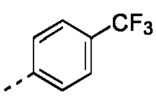 E73 , 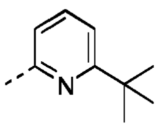 E106 , 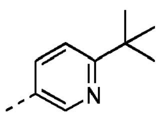 E107 , 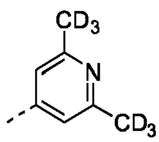 E108 ,

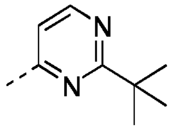
E109 ,
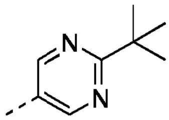
E110 ,
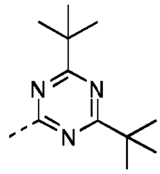
E112 ,
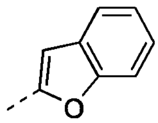
E114 ,
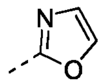
E115 ,
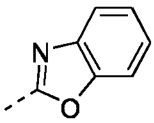
E116 , and
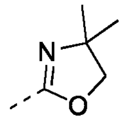
E119 .

In some embodiments of the compound having $L_A$ of Formula I, the ligand $L_A$ comprises an electron-withdrawing group that is a π-electron deficient electron-withdrawing group. In some embodiments, the π-electron deficient electron-withdrawing group is selected from the group consisting of the structures of the following Pi-EWG LIST: CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^+N(R^{k2})_3$, $BR^{k2}R^{k3}$, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate,

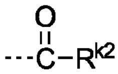 , 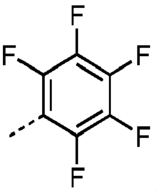 , 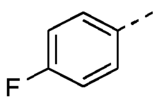 , 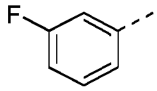 , 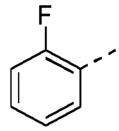 , 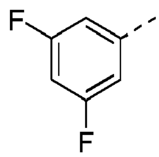 ,

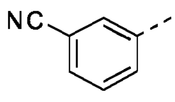 , 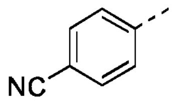 , 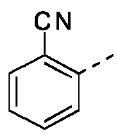 , 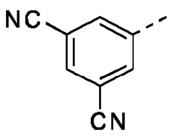 , 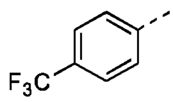 , 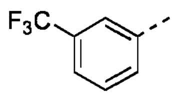 , 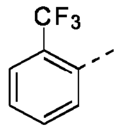 ,

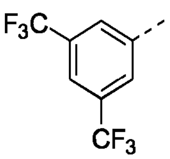 , 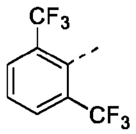 , 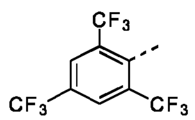 , 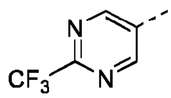 , 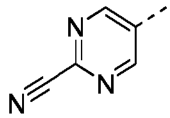 , 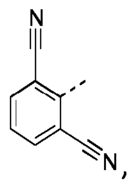 , 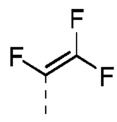 ,

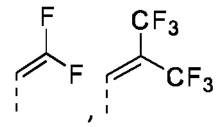 , , 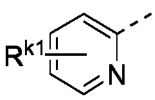 , 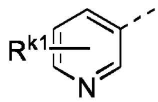 , 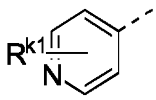 , 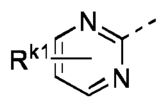 , 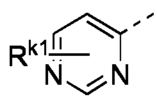 ,

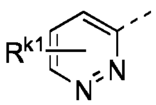 , 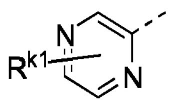 , 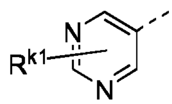 , 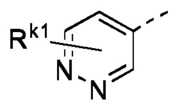 , 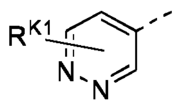 , 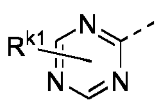 ,

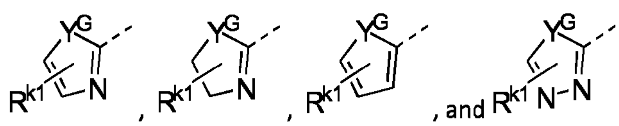 , , , and ;

wherein the variables are the same as previously defined.

In some embodiments of the compound having $L_A$ of Formula I, at least one of R, R', $R^\alpha$, $R^\beta$, $R^A$, and $R^B$ is or comprises an electron-withdrawing group from the EWG1 LIST as defined herein. In some embodiments, at least one of R, R', $R^\alpha$, $R^\beta$, $R^A$, and $R^B$ is or comprises an electron-withdrawing group from the EWG2 LIST as defined herein. In some embodiments, at least one of R, R', $R^\alpha$, $R^\beta$, $R^A$, and $R^B$ is or comprises an electron-withdrawing group from the EWG3 LIST as defined herein. In some embodiments, at least one of R, R', $R^\alpha$, $R^\beta$, $R^A$, and $R^B$ is or comprises an electron-withdrawing group from the EWG4 LIST as defined herein. In some embodiments, at least one of R, R', $R^\alpha$, $R^\beta$, $R^A$, and $R^B$ is or comprises an electron-withdrawing group from the Pi-EWG LIST as defined herein.

In some embodiments of the compound having $L_A$ of Formula I, at least one of $R^A$ is or comprises an electron-withdrawing group from the EWG1 LIST as defined herein. In some embodiments, at least one of $R^A$ is or comprises an electron-withdrawing group from the EWG2 LIST as defined herein. In some embodiments, at least one of $R^A$ is or comprises an electron-withdrawing group from the EWG3 LIST as defined herein. In some embodiments, at least one of $R^A$ is or comprises an electron-withdrawing group from the EWG4 LIST as defined herein. In some embodiments, at least one of $R^A$ is or comprises an electron-withdrawing group from the Pi-EWG LIST as defined herein.

In some embodiments of the compound having $L_A$ of Formula I, at least one of $R^B$ is or comprises an electron-withdrawing group from the EWG1 LIST as defined herein. In some embodiments, at least one of $R^B$ is or comprises an electron-withdrawing group from the EWG2 LIST as defined herein. In some embodiments, at least one of $R^B$ is or comprises an electron-withdrawing group from the EWG3 LIST as defined herein. In some embodiments, at least one of $R^B$ is or comprises an electron-withdrawing group from the EWG4 LIST as defined herein. In some embodiments, at least one of $R^B$ is or comprises an electron-withdrawing group from the Pi-EWG LIST as defined herein.

In some embodiments of the compound having $L_A$ of Formula I, R is or comprises an electron-withdrawing group from the EWG1 LIST as defined herein. In some embodiments, R is or comprises an electron-withdrawing group from the EWG2 LIST as defined herein. In some embodiments, R is or comprises an electron-withdrawing group from the EWG3 LIST as defined herein. In some embodiments, R is or comprises an electron-withdrawing group from the EWG4 LIST as defined herein. In some embodiments, R is or comprises an electron-withdrawing group from the Pi-EWG LIST as defined herein.

In some embodiments of the compound having $L_A$ of Formula I, R' is or comprises an electron-withdrawing group from the EWG1 LIST as defined herein. In some embodiments, R' is or comprises an electron-withdrawing group from the EWG2 LIST as defined herein. In some embodiments, R' is or comprises an electron-withdrawing group from the EWG3 LIST as defined herein. In some embodiments, R' is or comprises an electron-withdrawing group from the EWG4 LIST as defined herein. In some embodiments, R' is or comprises an electron-withdrawing group from the Pi-EWG LIST as defined herein.

In some embodiments of the compound having $L_A$ of Formula I, $R^\alpha$ is or comprises an electron-withdrawing group from the EWG1 LIST as defined herein. In some embodiments, $R^\alpha$ is or comprises an electron-withdrawing group from the EWG2 LIST as defined herein. In some embodiments, $R^\alpha$ is or comprises an electron-withdrawing group from the EWG3 LIST as defined herein. In some embodiments, $R^\alpha$ is or comprises an electron-withdrawing group from the EWG4 LIST as defined herein. In some embodiments, $R^\alpha$ is or comprises an electron-withdrawing group from the Pi-EWG LIST as defined herein.

In some embodiments of the compound having $L_A$ of Formula I, $R^\beta$ is or comprises an electron-withdrawing group from the EWG1 LIST as defined herein. In some embodiments, $R^\beta$ is or comprises an electron-withdrawing group from the EWG2 LIST as defined herein. In some embodiments, $R^\beta$ is or comprises an electron-withdrawing group from the EWG3 LIST as defined herein. In some embodiments, $R^\beta$ is or comprises an electron-withdrawing group from the EWG4 LIST as defined herein. In some embodiments, $R^\beta$ is or comprises an electron-withdrawing group from the Pi-EWG LIST as defined herein.

In some embodiments of the compound having $L_A$ of Formula I, at least one $R^A$ or $R^B$ comprises an electron-withdrawing group that is not F.

In some embodiments of the compound having $L_A$ of Formula I, at least one $R^A$ comprises an electron-withdrawing group that is not F.

In some embodiments of the compound having $L_A$ of Formula I, at least one $R^B$ comprises an electron-withdrawing group that is not F.

In some embodiments of the compound having $L_A$ of Formula I, a total of at least two of $R^A$ and $R^B$ independently comprise electron-withdrawing groups that are not F.

In some embodiments of the compound having $L_A$ of Formula I, at least one $R^A$ is or comprises an electron-withdrawing group other the F that is selected from the EWG1 LIST as defined herein. In some embodiments, $R^A$ is an electron-withdrawing group other the F that is selected from the EWG1 LIST as defined herein. In some embodiments, $R^A$ comprises an electron-withdrawing group other the F that is selected from the EWG1 LIST as defined herein.

In some embodiments of the compound having $L_A$ of Formula I, at least one $R^A$ is or comprises an electron-withdrawing group other the F that is selected from the EWG2 LIST as defined herein. In some embodiments, $R^A$ is an

electron-withdrawing group other the F that is selected from the EWG2 LIST as defined herein. In some embodiments, $R^A$ comprises an electron-withdrawing group other the F that is selected from the EWG2 LIST as defined herein.

In some embodiments of the compound having $L_A$ of Formula I, at least one $R^A$ is or comprises an electron-withdrawing group other the F that is selected from the EWG3 LIST as defined herein. In some embodiments, $R^A$ is an electron-withdrawing group other the F that is selected from the EWG3 LIST as defined herein. In some embodiments, $R^A$ comprises an electron-withdrawing group other the F that is selected from the EWG3 LIST as defined herein.

In some embodiments of the compound having $L_A$ of Formula I, at least one $R^A$ is or comprises an electron-withdrawing group other the F that is selected from the EWG4 LIST as defined herein. In some embodiments, $R^A$ is an electron-withdrawing group other the F that is selected from the EWG4 LIST as defined herein. In some embodiments, $R^A$ comprises an electron-withdrawing group other the F that is selected from the EWG4 LIST as defined herein.

In some embodiments of the compound having $L_A$ of Formula I, at least one $R^A$ is or comprises an electron-withdrawing group other the F that is selected from the Pi-EWG LIST as defined herein. In some embodiments, $R^A$ is an electron-withdrawing group other the F that is selected from the Pi-EWG LIST as defined herein. In some embodiments, $R^A$ comprises an electron-withdrawing group other the F that is selected from the Pi-EWG LIST as defined herein.

In some embodiments of the compound having $L_A$ of Formula I, at least one $R^B$ is or comprises an electron-withdrawing group other the F that is selected from the EWG1 LIST as defined herein. In some embodiments, $R^B$ is an electron-withdrawing group other the F that is selected from the EWG1 LIST as defined herein. In some embodiments, $R^B$ comprises an electron-withdrawing group other the F that is selected from the EWG1 LIST as defined herein.

In some embodiments of the compound having $L_A$ of Formula I, at least one $R^B$ is or comprises an electron-withdrawing group other the F that is selected from the EWG2 LIST as defined herein. In some embodiments, $R^B$ is an electron-withdrawing group other the F that is selected from the EWG2 LIST as defined herein. In some embodiments, $R^B$ comprises an electron-withdrawing group other the F that is selected from the EWG2 LIST as defined herein.

In some embodiments of the compound having $L_A$ of Formula I, at least one $R^B$ is or comprises an electron-withdrawing group other the F that is selected from the EWG3 LIST as defined herein. In some embodiments, $R^B$ is an electron-withdrawing group other the F that is selected from the EWG3 LIST as defined herein. In some embodiments, $R^B$ comprises an electron-withdrawing group other the F that is selected from the EWG3 LIST as defined herein.

In some embodiments of the compound having $L_A$ of Formula I, at least one $R^B$ is or comprises an electron-withdrawing group other the F that is selected from the EWG4 LIST as defined herein. In some embodiments, $R^B$ is an electron-withdrawing group other the F that is selected from the EWG4 LIST as defined herein. In some embodiments, $R^B$ comprises an electron-withdrawing group other the F that is selected from the EWG4 LIST as defined herein.

In some embodiments of the compound having $L_A$ of Formula I, at least one $R^B$ is or comprises an electron-withdrawing group other the F that is selected from the Pi-EWG LIST as defined herein. In some embodiments, $R^B$ is an electron-withdrawing group other the F that is selected from the Pi-EWG LIST as defined herein. In some embodiments, $R^B$ comprises an electron-withdrawing group other the F that is selected from the Pi-EWG LIST as defined herein.

In some embodiments of the compound having the formula of $M(L_A)_p(L_B)_q(L_C)_r$, the ligand $L_B$ comprises an electron-withdrawing group from the EWG1 LIST as defined herein. In some embodiments, $L_B$ comprises an electron-withdrawing group from the EWG2 LIST as defined herein. In some embodiments, $L_B$ comprises an electron-withdrawing group from the EWG3 LIST as defined herein. In some embodiments, $L_B$ comprises an electron-withdrawing group from the EWG4 LIST as defined herein. In some embodiments, $L_B$ comprises an electron-withdrawing group from the Pi-EWG LIST as defined herein.

In some embodiments of the compound having the formula of $M(L_A)_p(L_B)_q(L_C)_r$, the ligand $L_C$ comprises an electron-withdrawing group from the EWG1 LIST as defined herein. In some embodiments, $L_C$ comprises an electron-withdrawing group from the EWG2 LIST as defined herein. In some embodiments, $L_C$ comprises an electron-withdrawing group from the EWG3 LIST as defined herein. In some embodiments, $L_C$ comprises an electron-withdrawing group from the EWG4 LIST as defined herein. In some embodiments, $L_C$ comprises an electron-withdrawing group from the Pi-EWG LIST as defined herein.

In some embodiments of the compound having an $L_A$ of Formula I, at least one $R^A$ is not hydrogen. In some embodiments, at least one $R^A$ comprises at least one C atom.

In some embodiments of the compound having an $L_A$ of Formula I, at least one $R^B$ is not hydrogen. In some embodiments, at least one $R^B$ comprises at least one C atom.

In some embodiments of the compound having an $L_A$ of Formula I, L is a direct bond. In some embodiments, L is selected from the group consisting of O, S, and Se. In some embodiments, L is selected from the group consisting of BR, NR, and PR. In some embodiments, L is BR. In some embodiments, L is NR. In some embodiments, L is PR. In some embodiments, R is aryl or heteroaryl. In some embodiments, R is joined or fused with one of $R^A$ or $R^B$ to form a ring, where the ring can be a 5-membered ring. In some embodiments, the 5-membered ring is a pyrrole ring.

In some embodiments of the compound having an $L_A$ of Formula I, L is selected from the group consisting of P(O)R, C=O, C=S, C=Se, C=NR', C=CRR', S=O, and $SO_2$.

In some embodiments of the compound having an $L_A$ of Formula I, L is selected from the group consisting of

BRR', CRR', SiRR', and GeRR'.

In some embodiments of the compound having an $L_A$ of Formula I, L is CR.

In some embodiments of the compound having an $L_A$ of Formula I, the ligand $L_A$ is selected from the group consisting of:

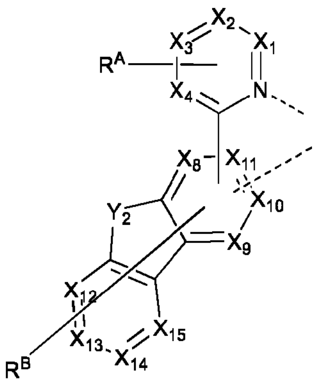
,
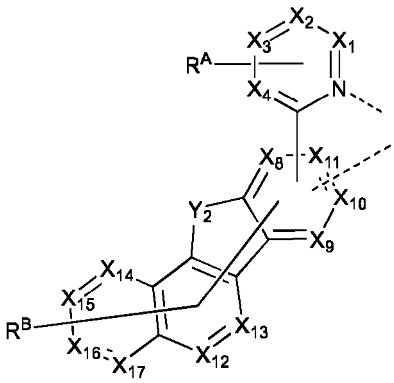
,
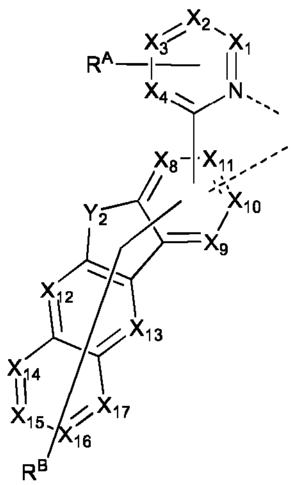
,
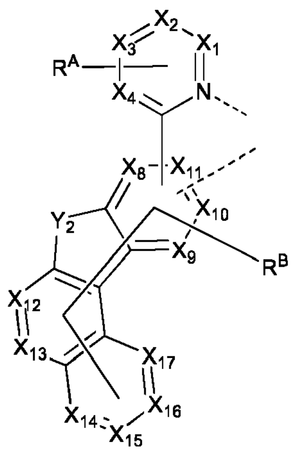
,
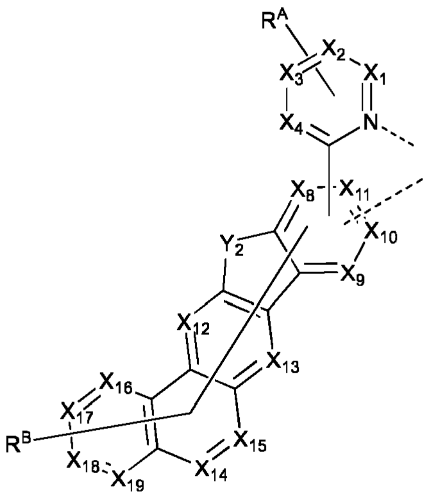
,
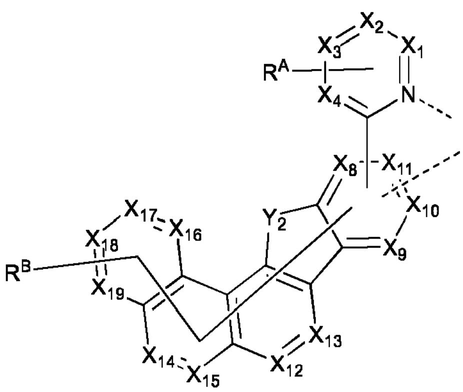
,
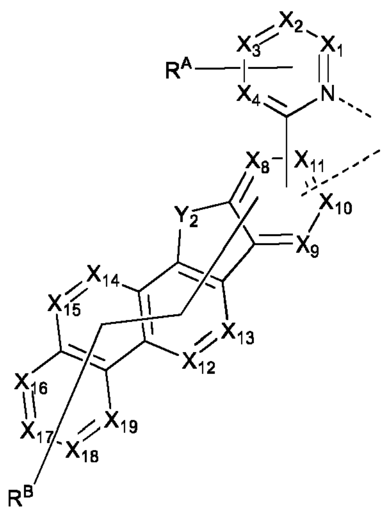
,
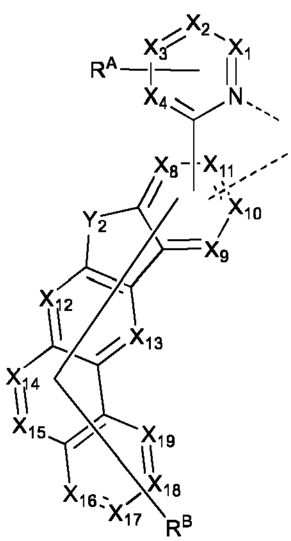
,

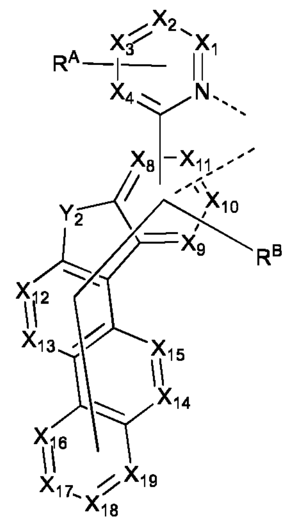,
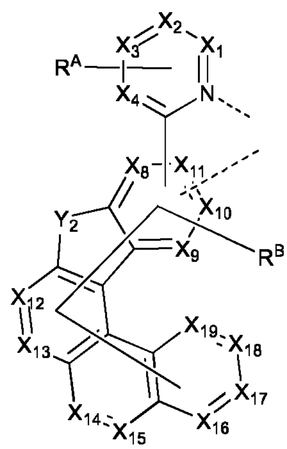,
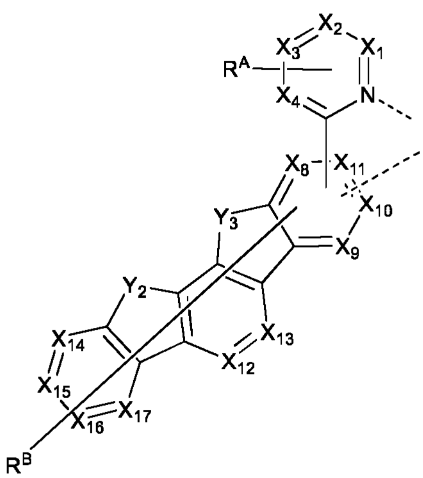,

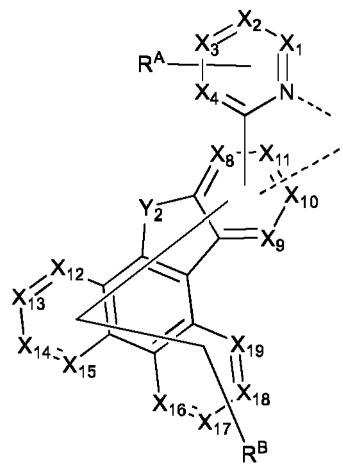,
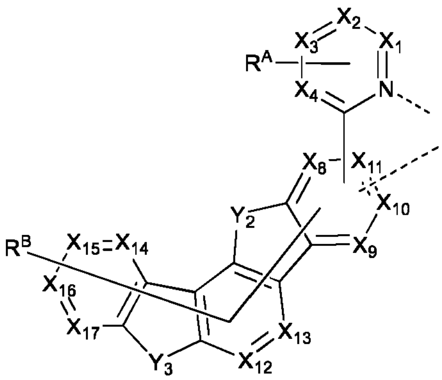,
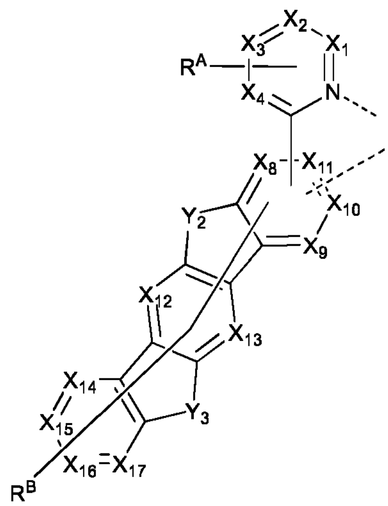,

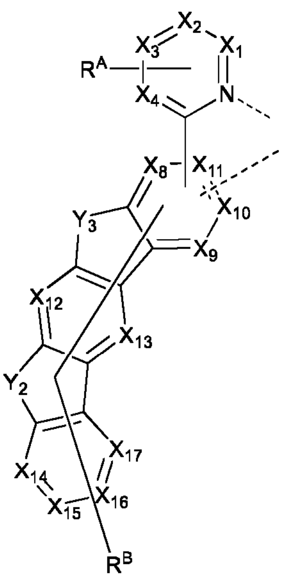,
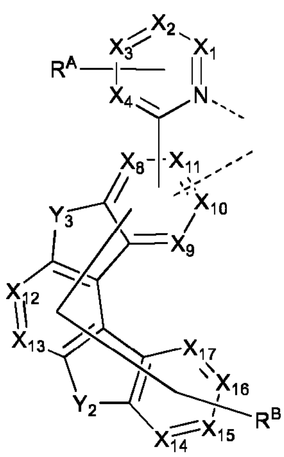,
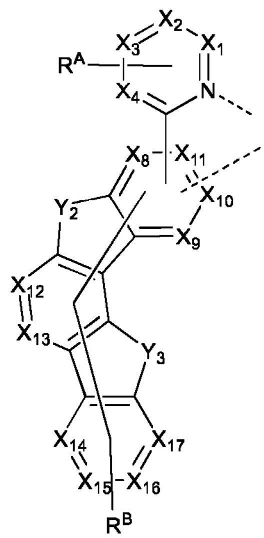,
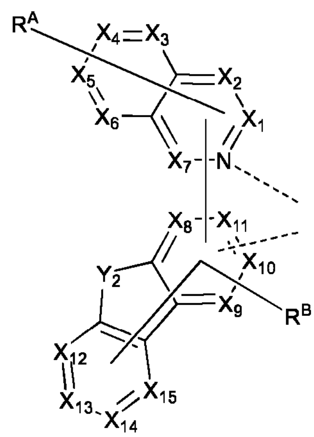,

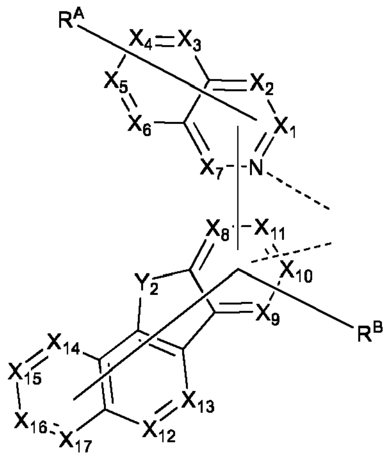,

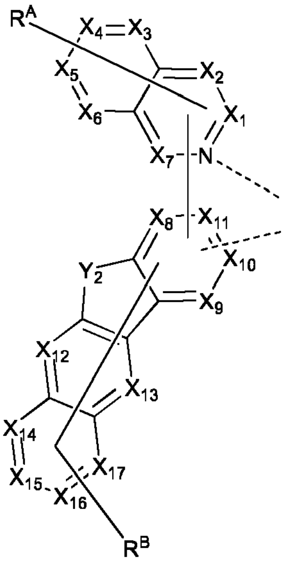,

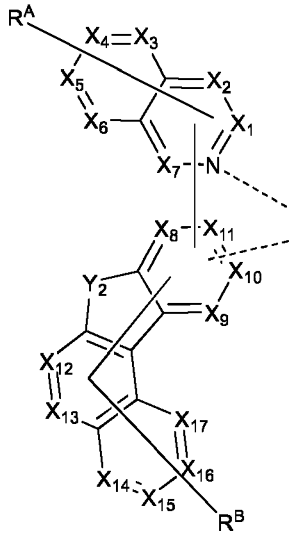,

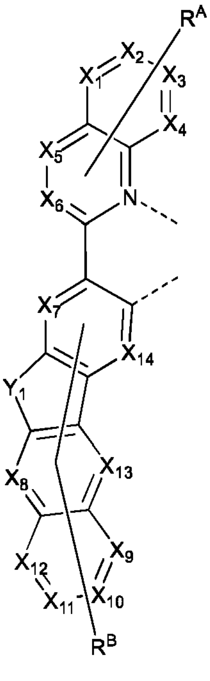,

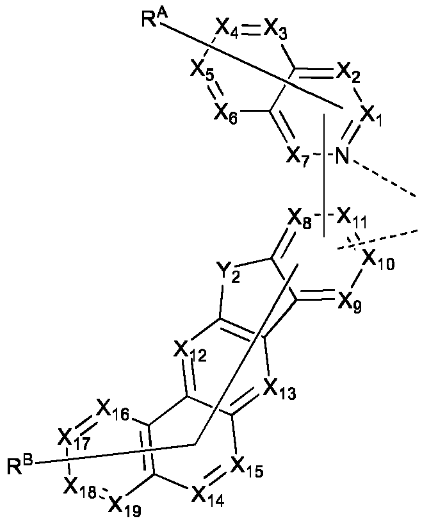,

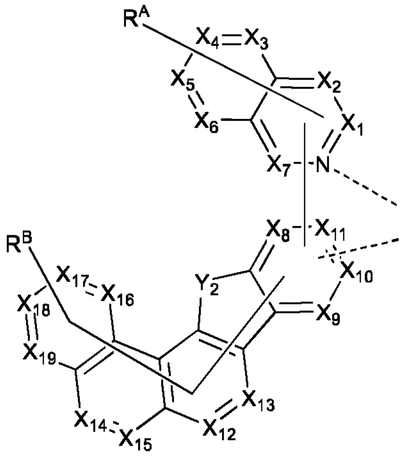,

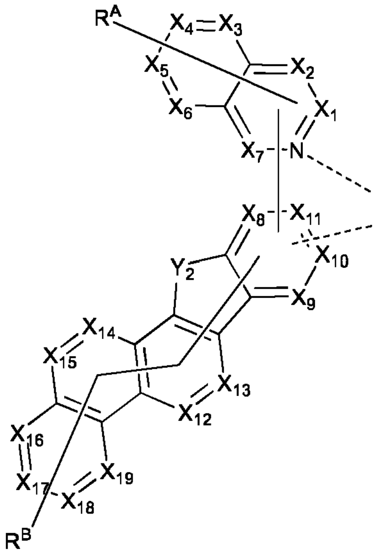,
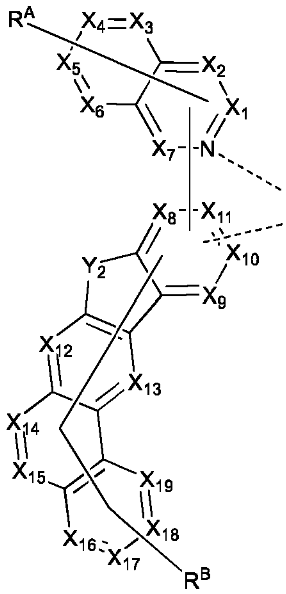,
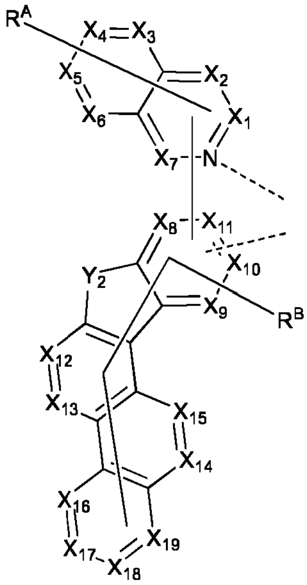,

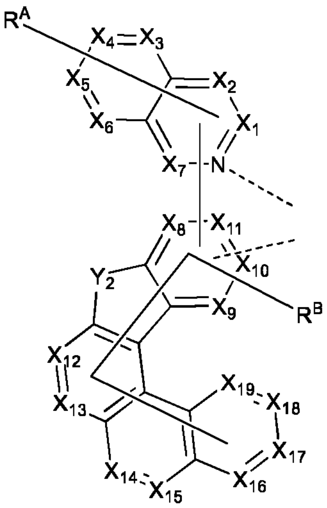,
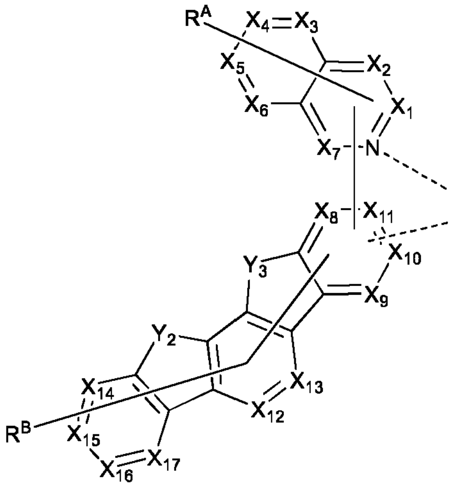,
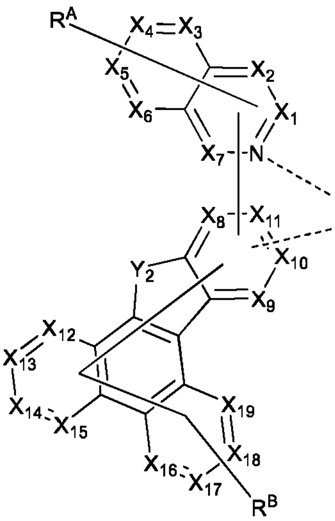,

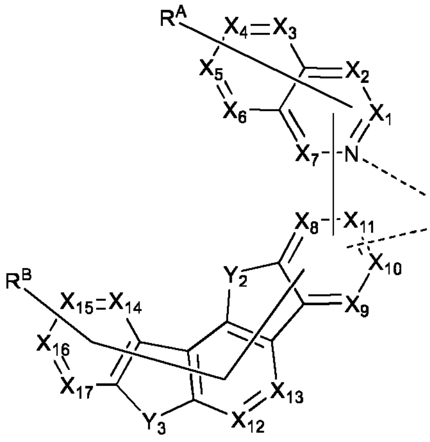
,
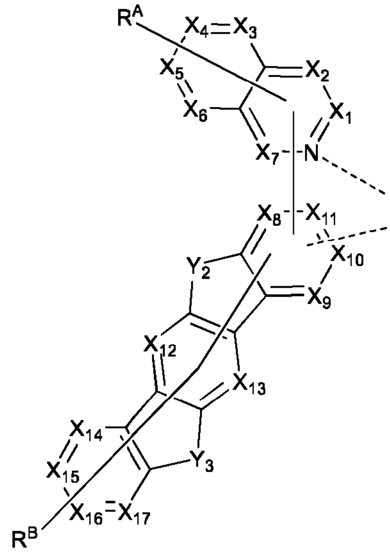
,
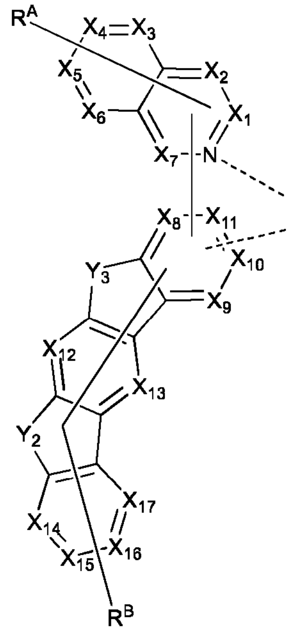
,

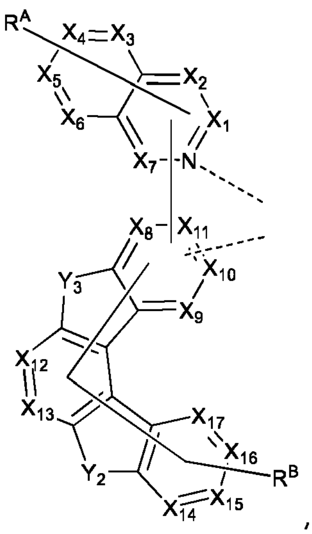
,
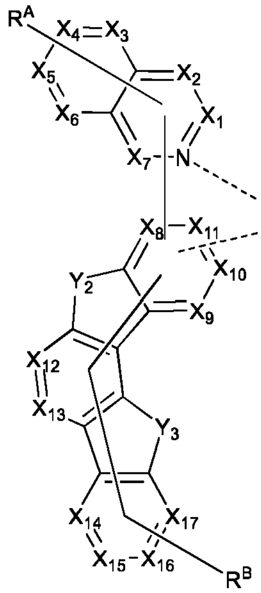
,
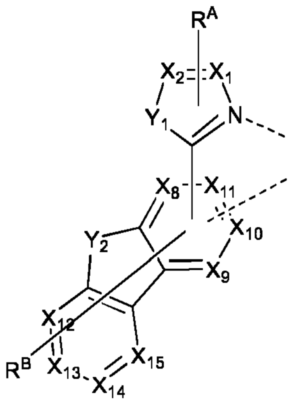
,

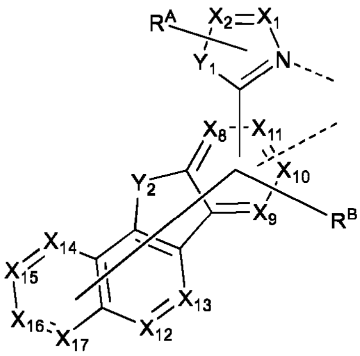
,
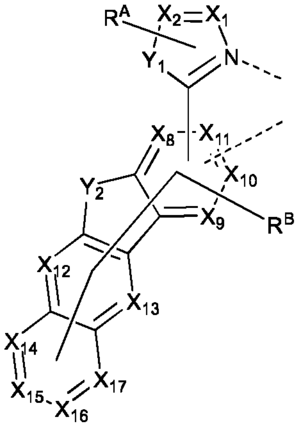
,
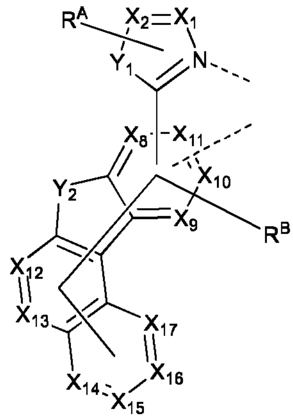
,

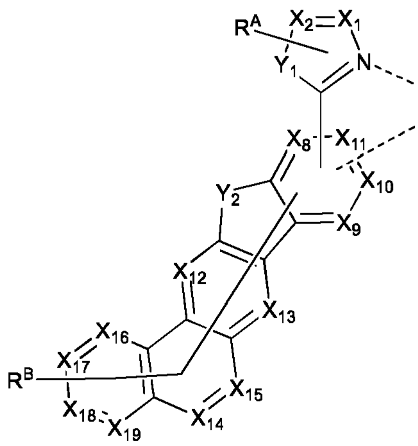

,

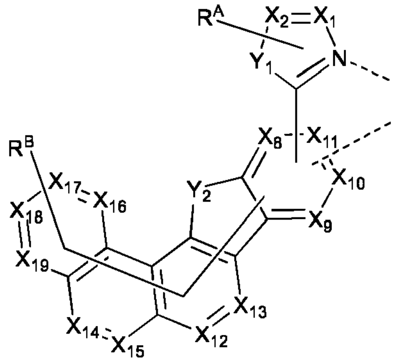

,

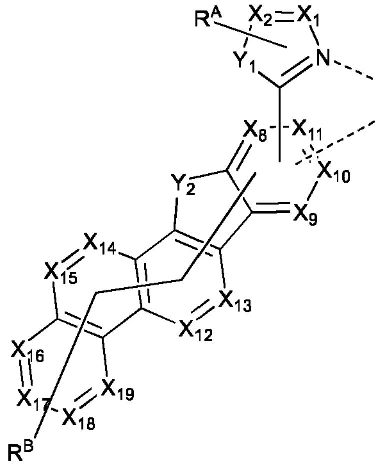

,

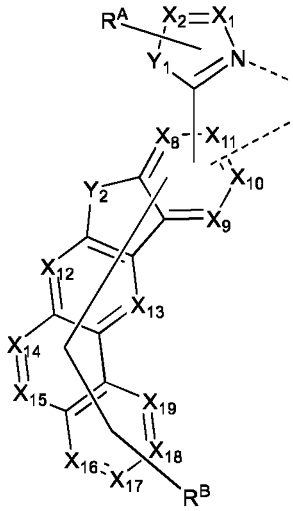

,

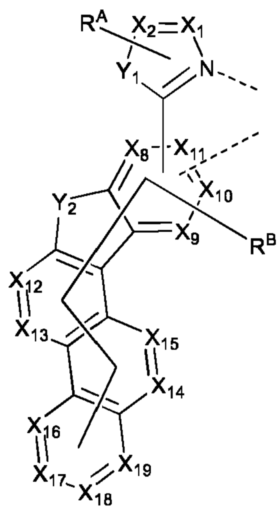

,

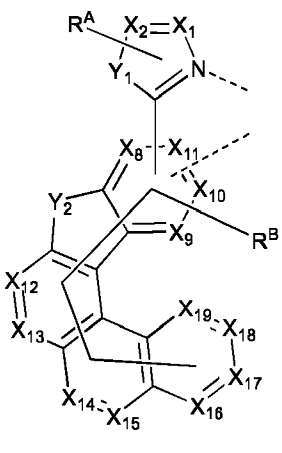

,

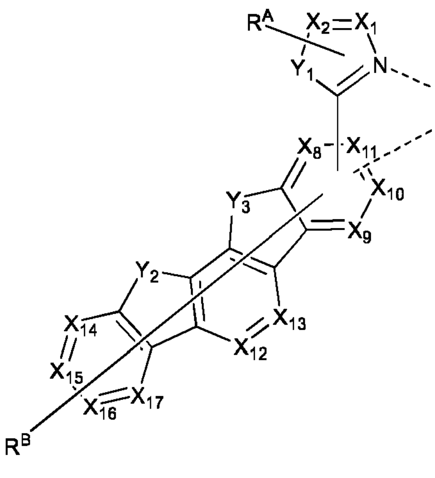

,

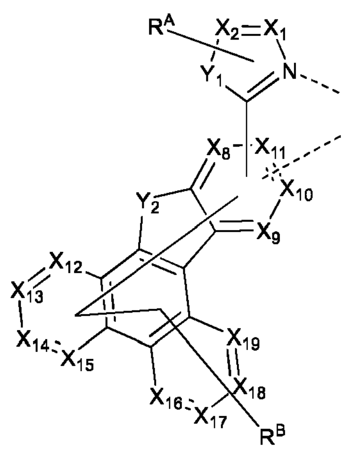

,

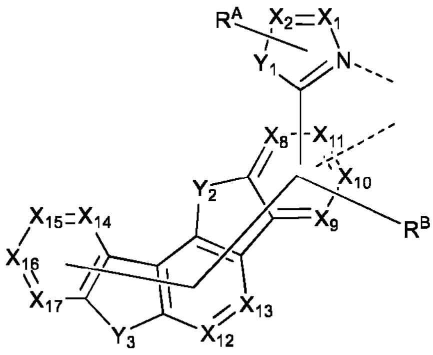
,
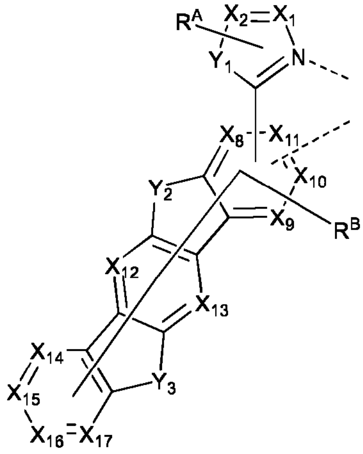
,
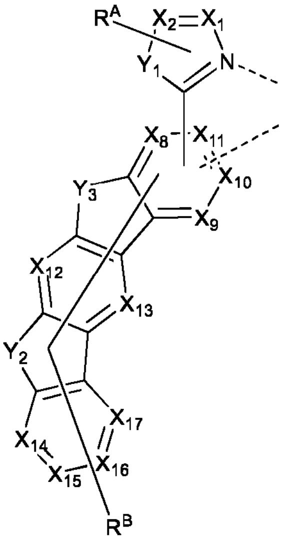
,

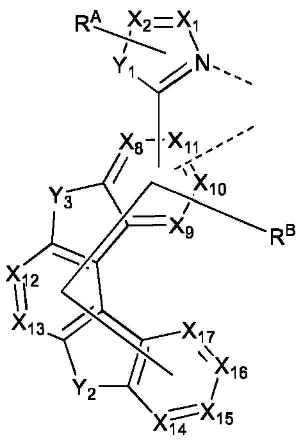
,
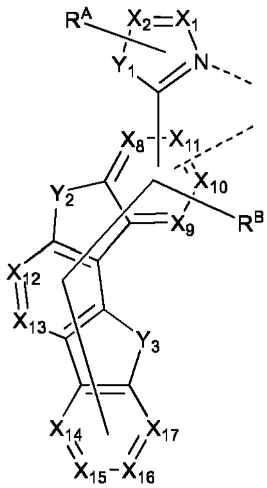
,
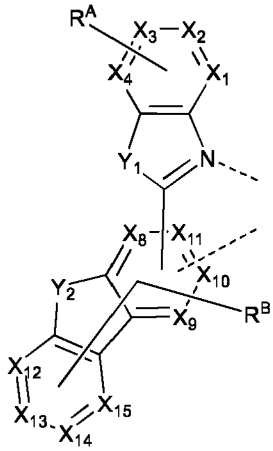
,

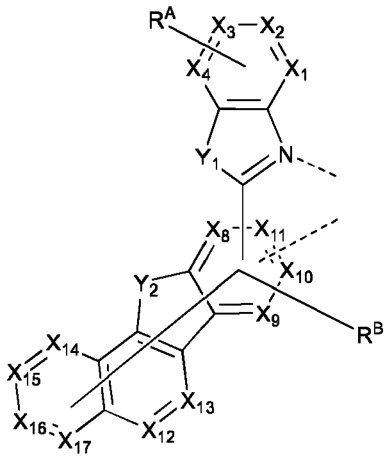
,
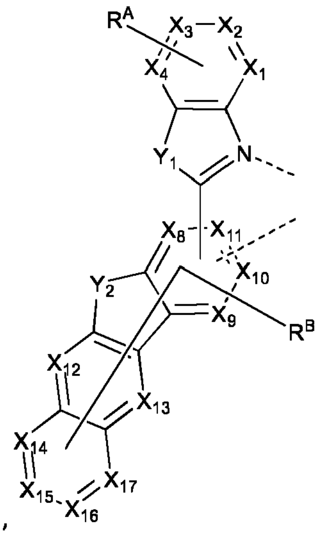
,
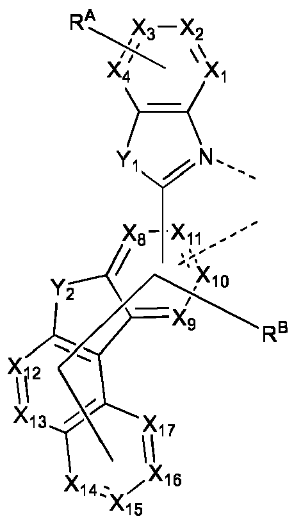
,

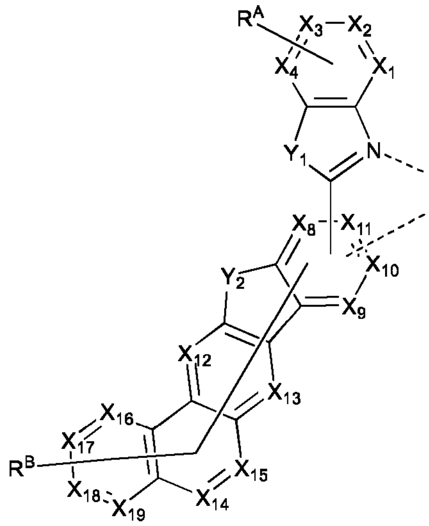
,
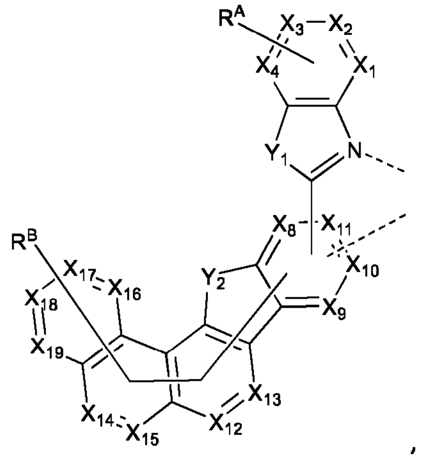
,
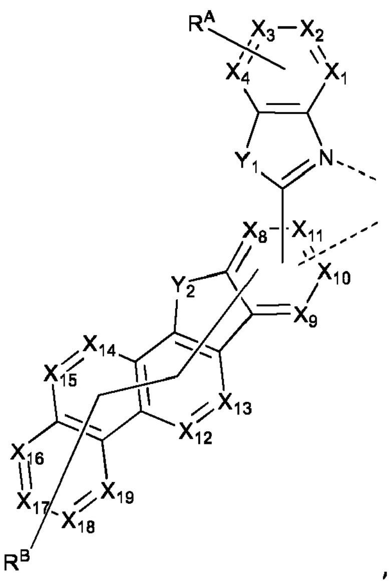
,
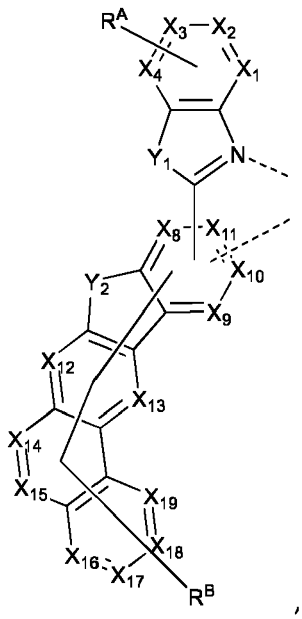
,
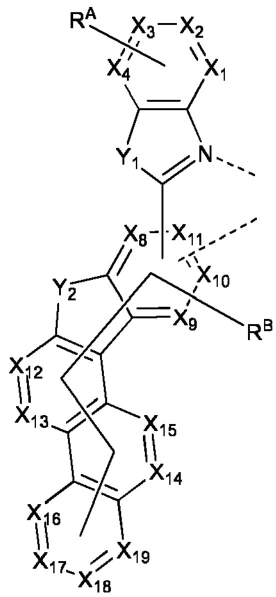
,
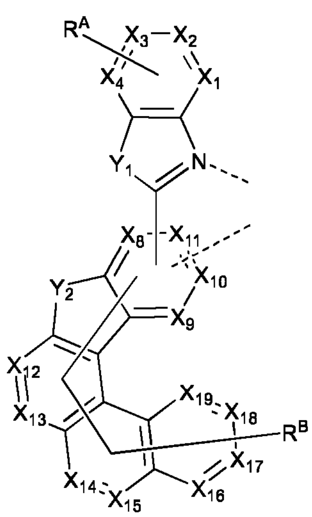
,
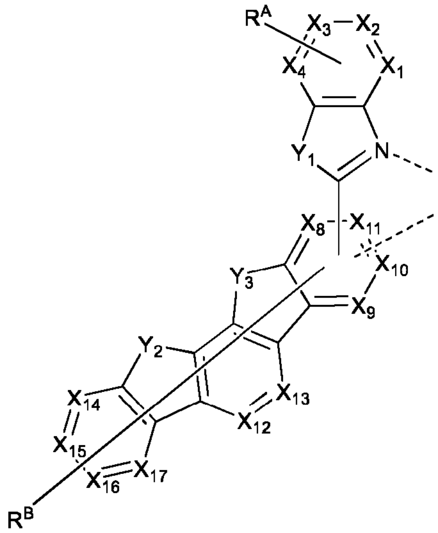
,
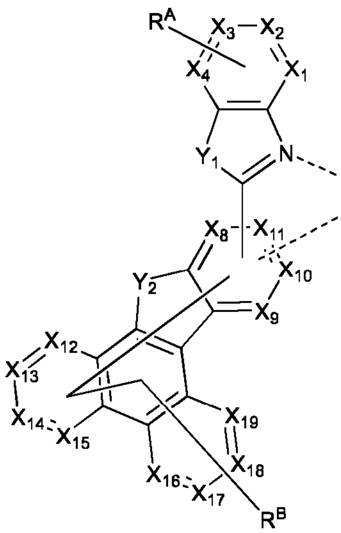
,

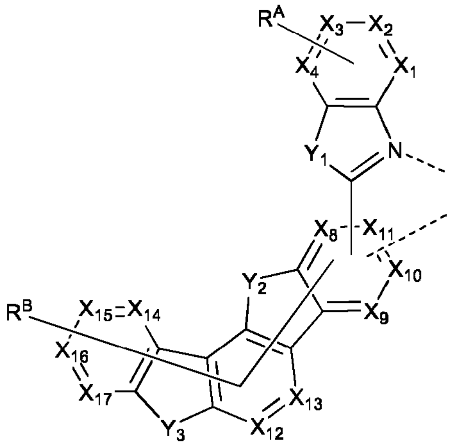 , 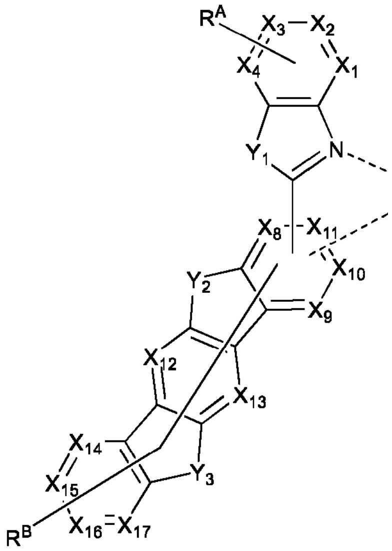 , 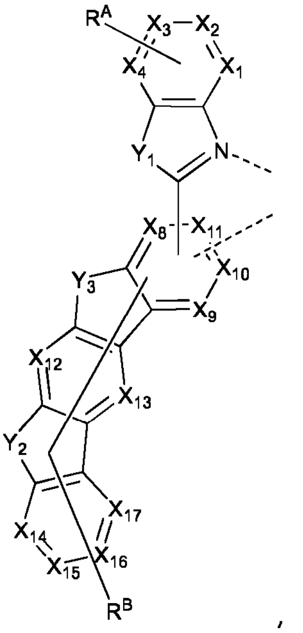 ,

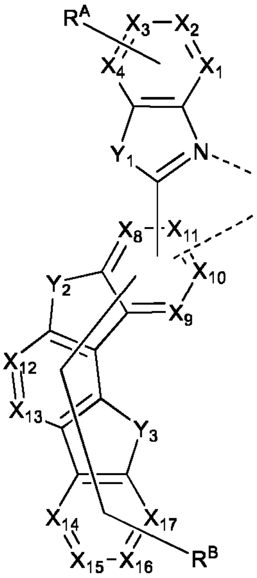 , 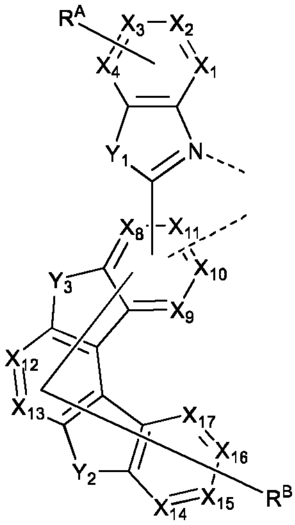 , 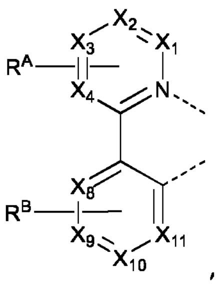 , 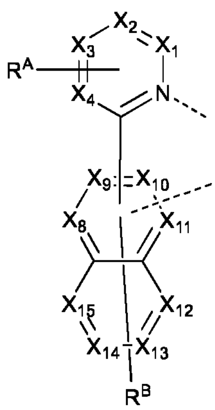 ,

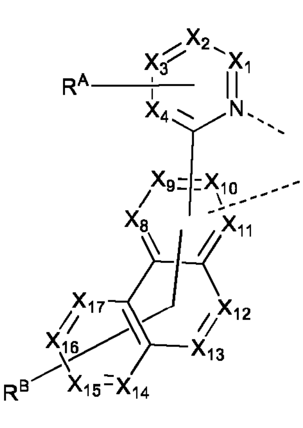 , 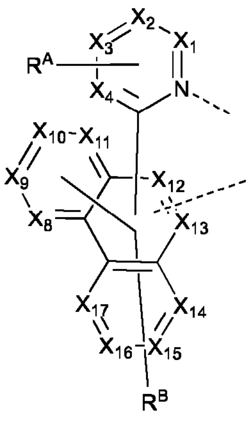 , 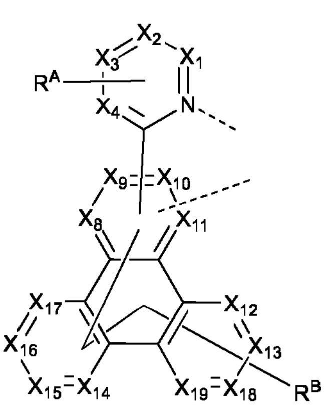 , 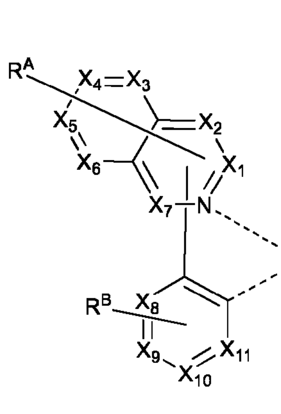

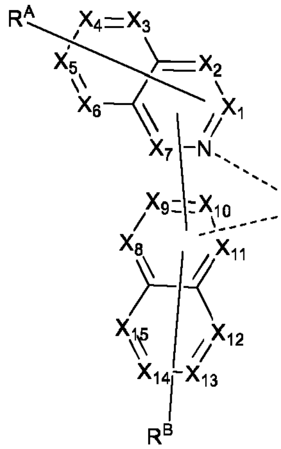,
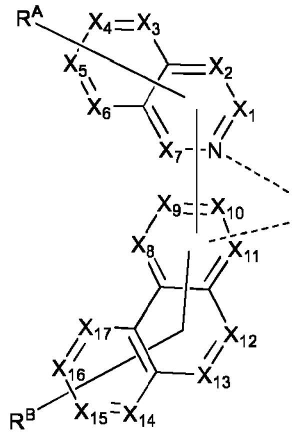,
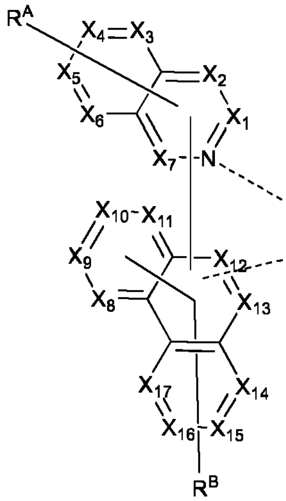,

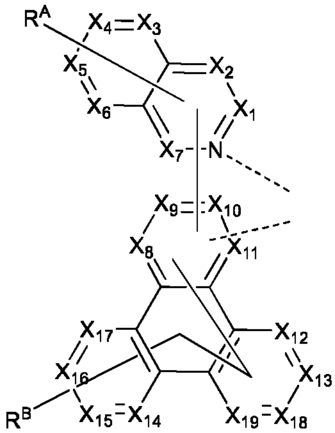,
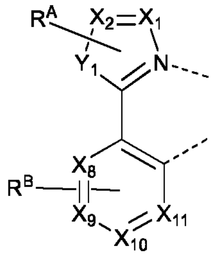,
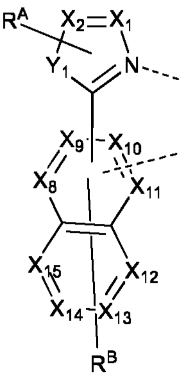,
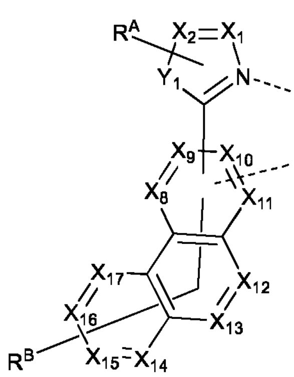,

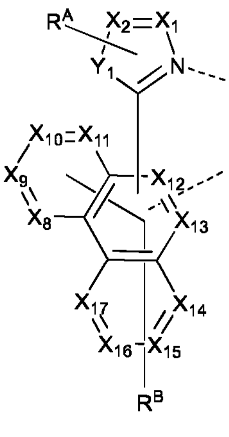,
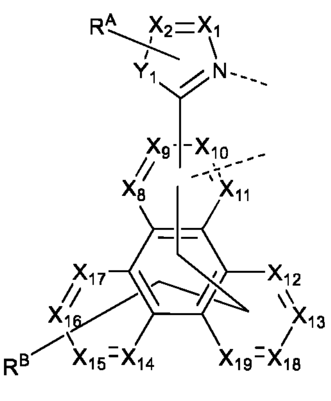,
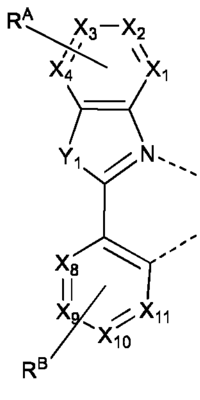,
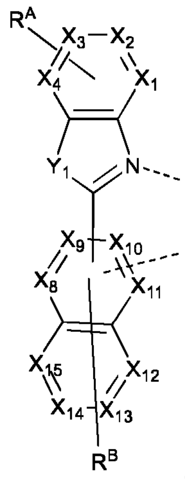,

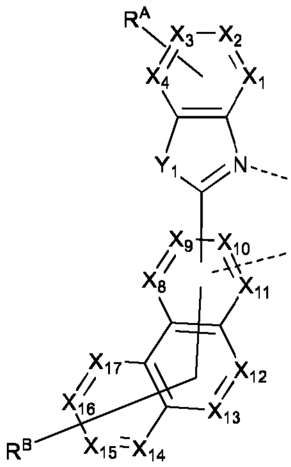,

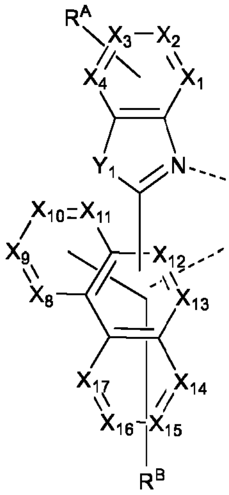, and

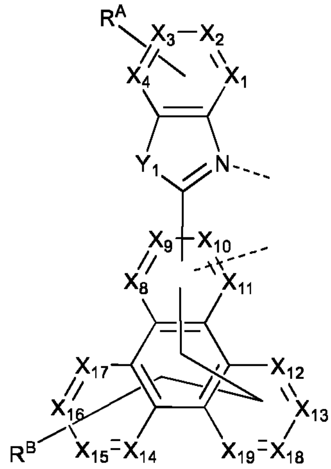;

wherein $X_1$ to $X_{19}$ are each independently C or N;

wherein each $R^A$, and $R^B$ independently represent from mono to the maximum possible number of substitutions, or no substitution;

wherein each $R^A$, and $R^B$, $R_e$, and $R_f$ is independently a hydrogen or a substituent selected from the group consisting of the General Substituents as defined herein; and

wherein each of $Y_1$, $Y_2$, and $Y_3$ is independently selected from the group consisting of $BR_e$, $NR_e$, $PR_e$, O, S, Se, C=O, S=O, $SO_2$, $CR_eR_f$, $SiR_eR_f$, and $GeR_eR_f$; and any two substituents can be joined or fused to form a ring.

In some embodiments of the compound, the ligand $L_A$ can be selected from the group consisting of:

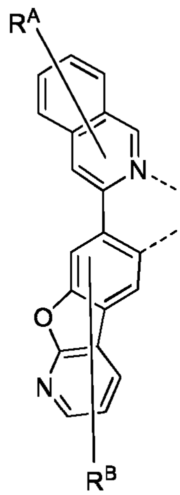,

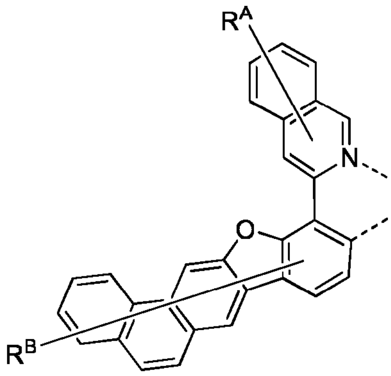,

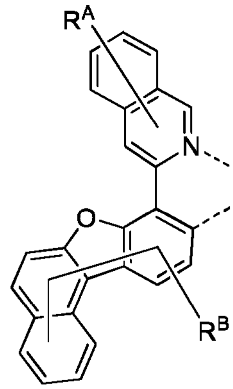,

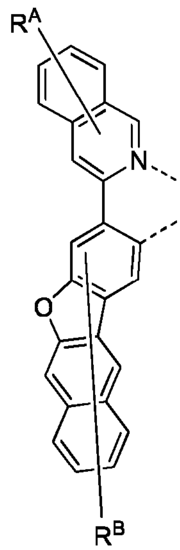,

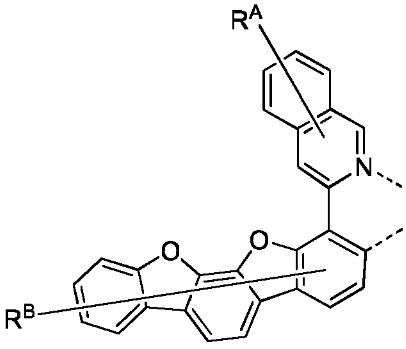 , 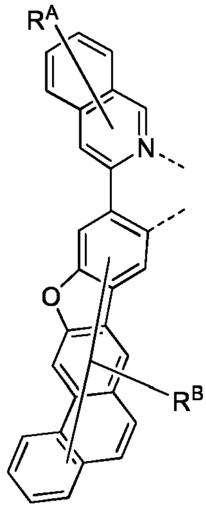 , 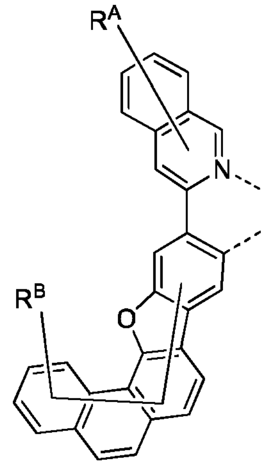 , 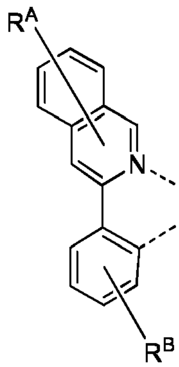 ,

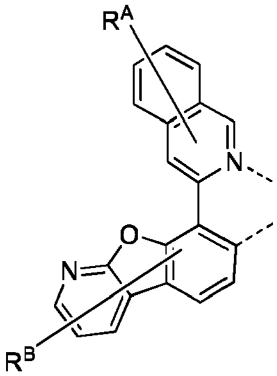 , 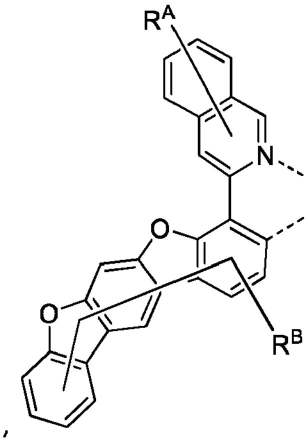 , 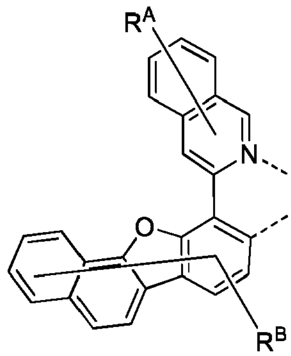 ,

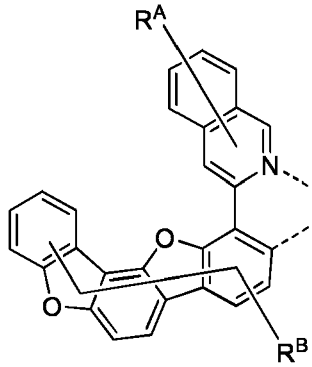 , 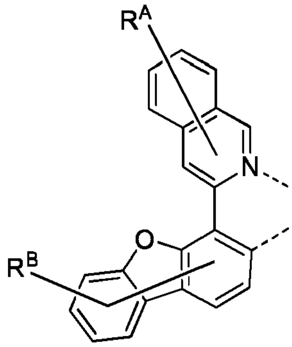 , 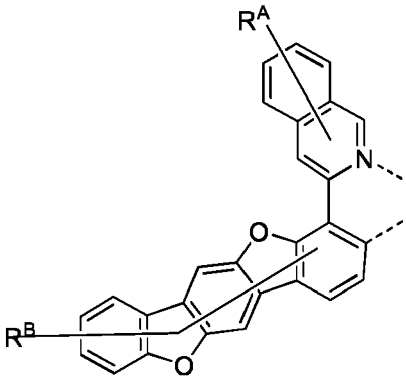 ,

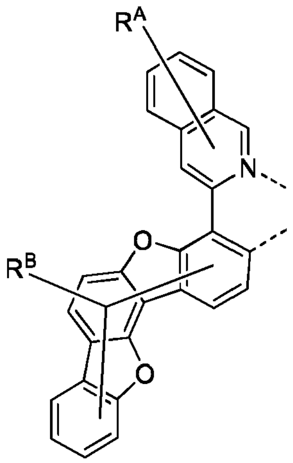
,
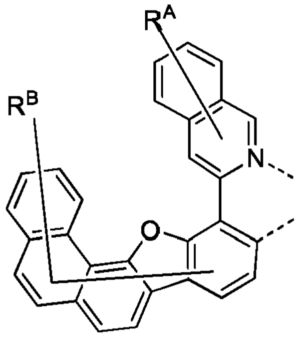
,
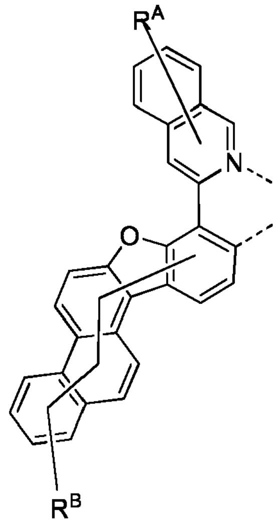
,
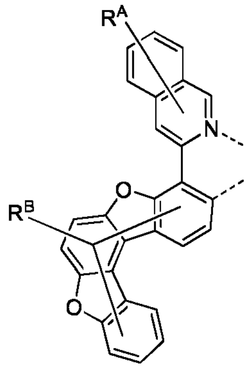
,

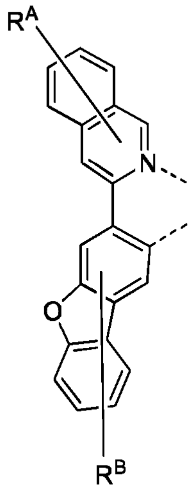
,
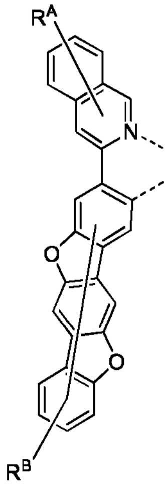
,
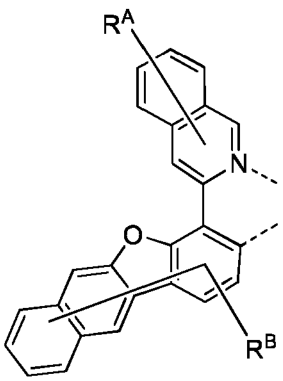
,
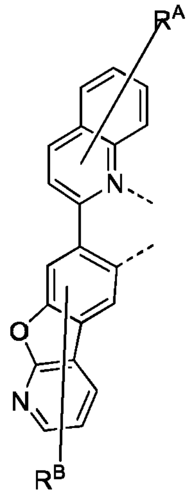
,

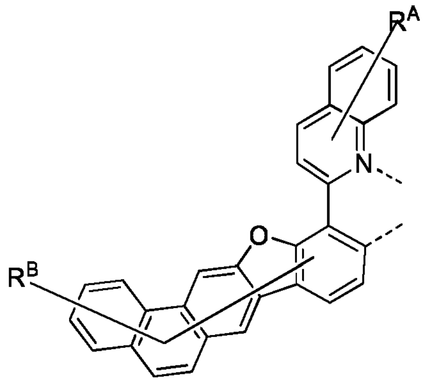
,
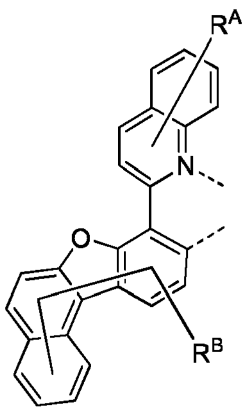
,
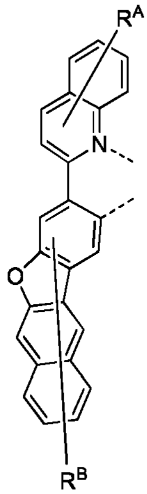
,

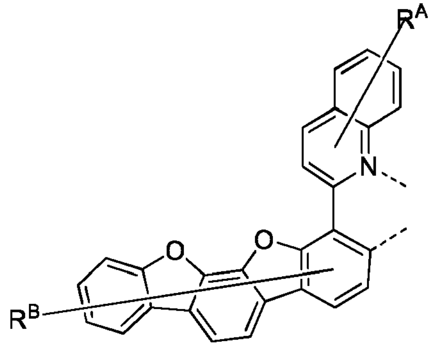 , 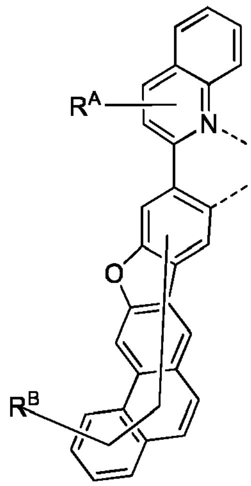 , 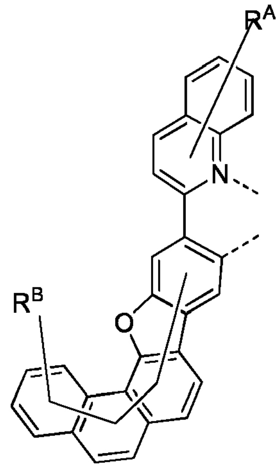 , 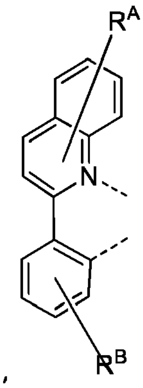 ,

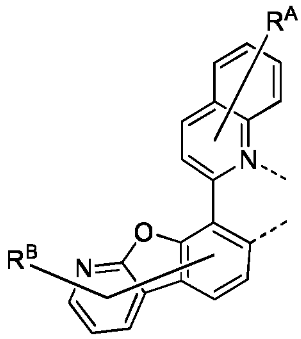 , 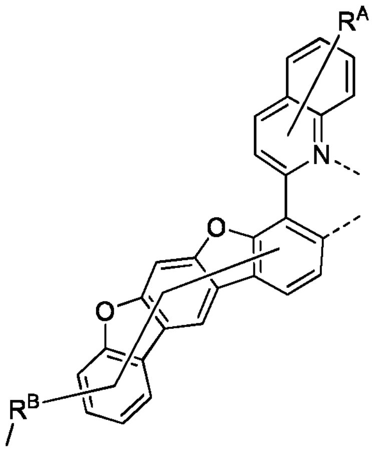 , 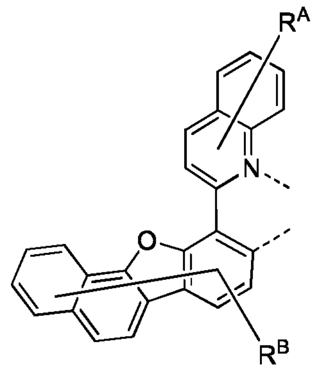 ,

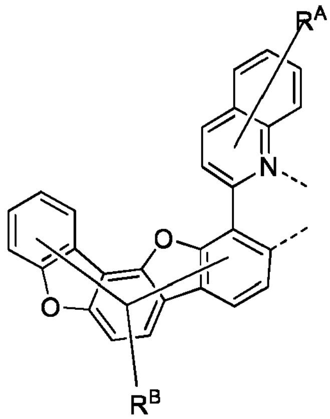 , 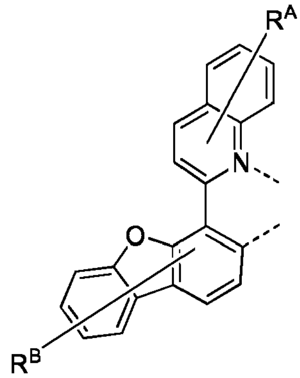 , 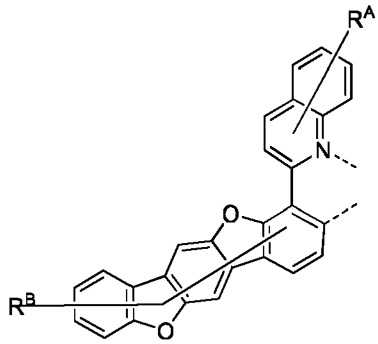 ,

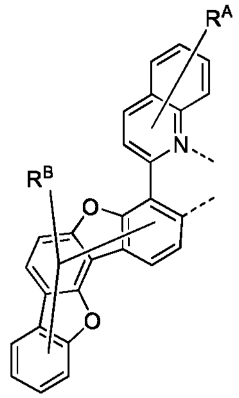,
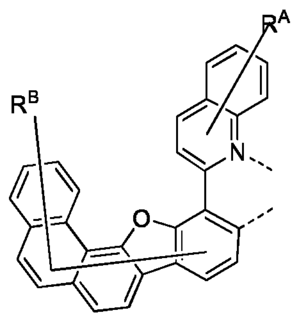,
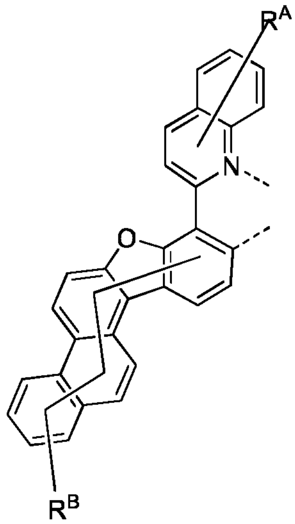,
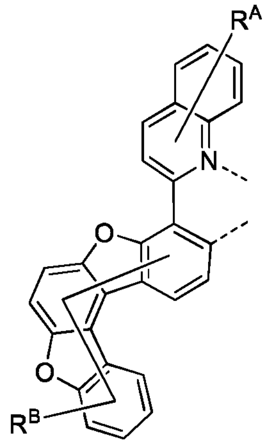,

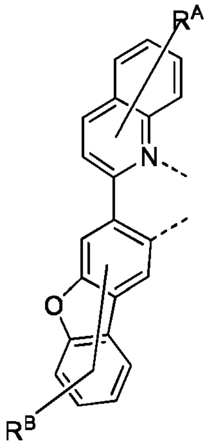,
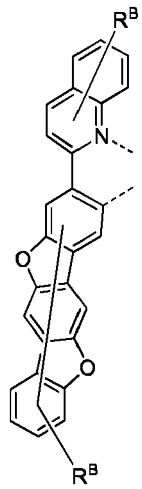,
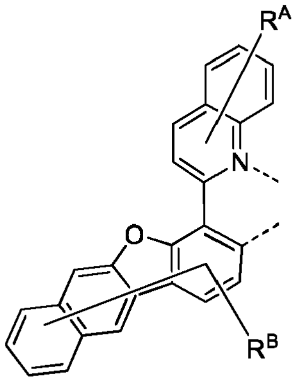,
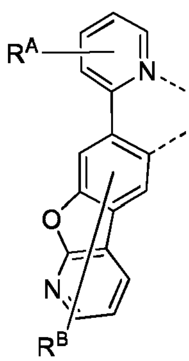,

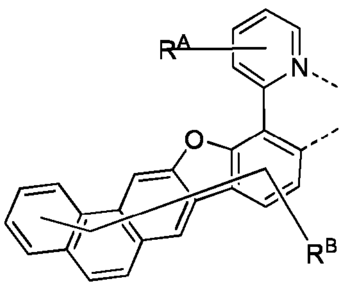,
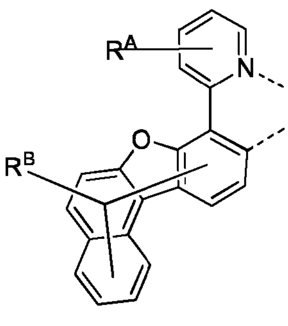,
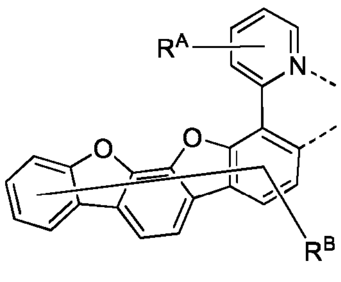,

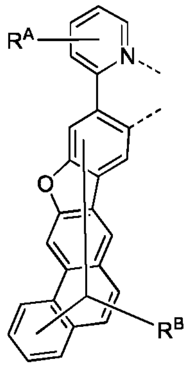,
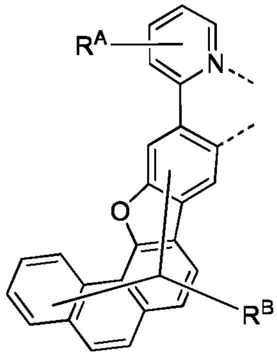,
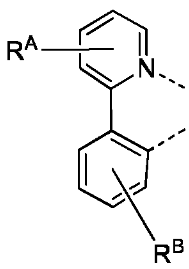,
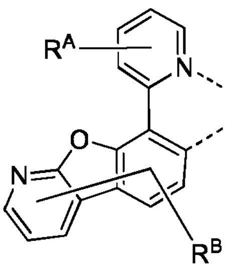,

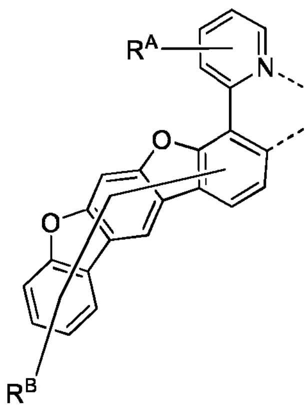,
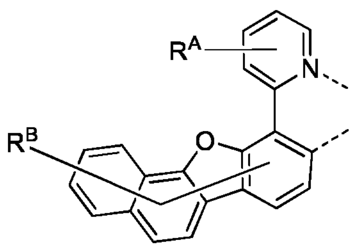,
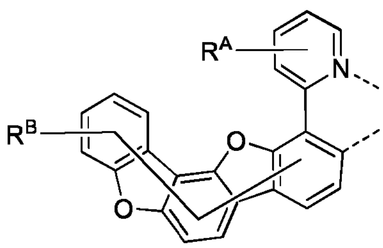,

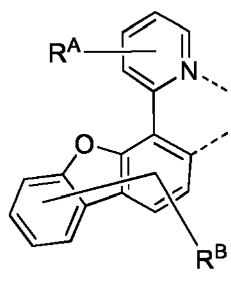,
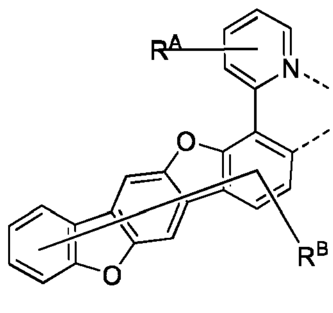,
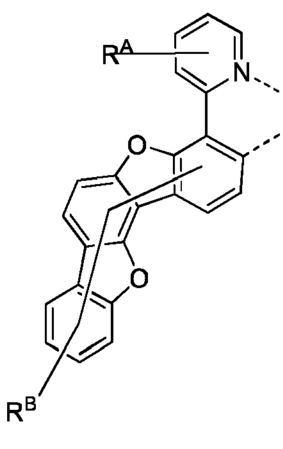,
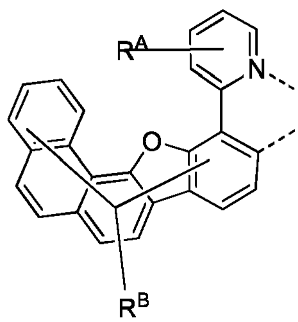,

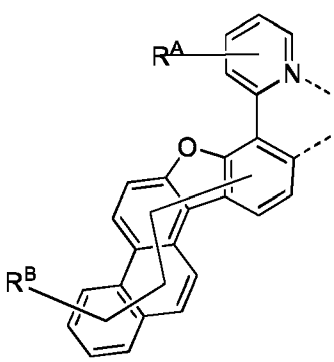,
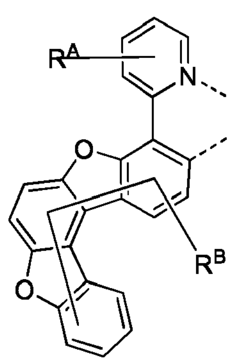,
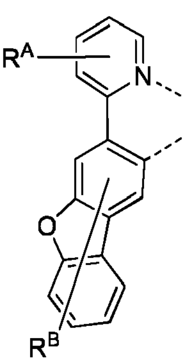,
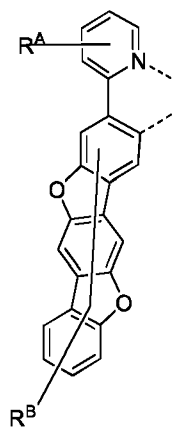,

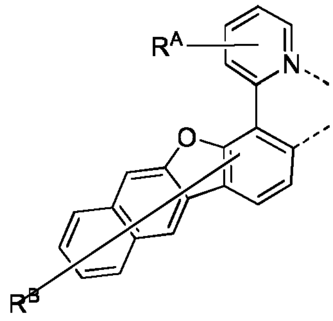, 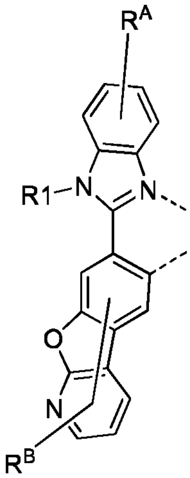, 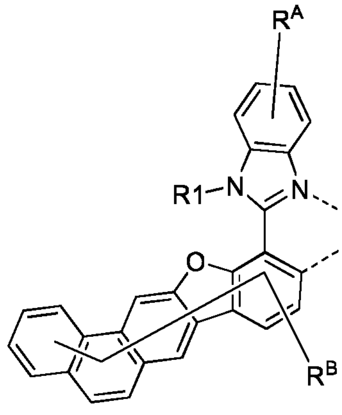,

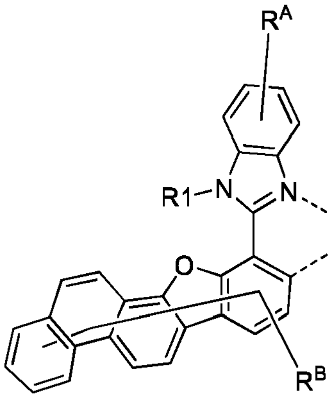, 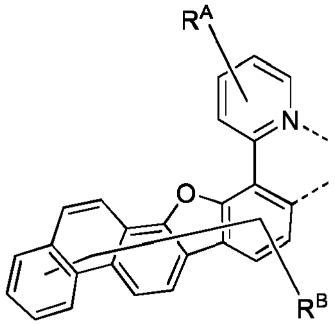, 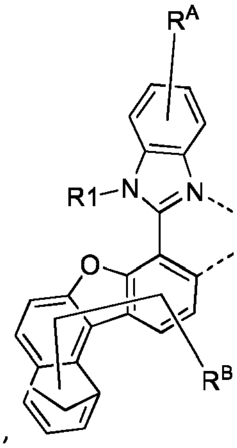, 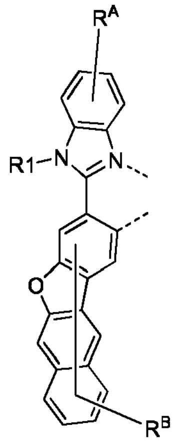,

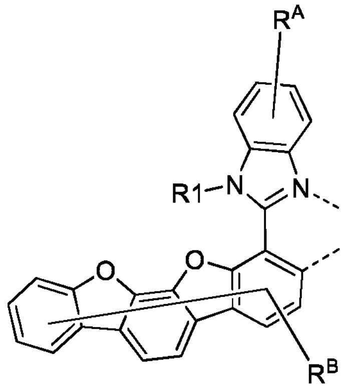, 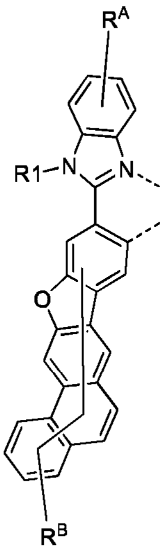, 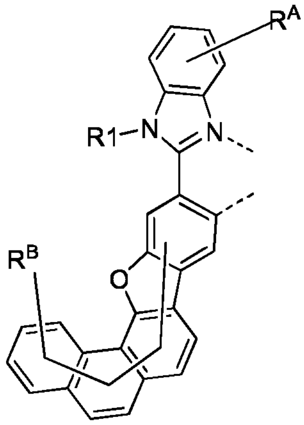, 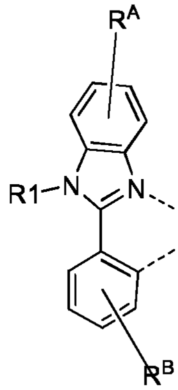,

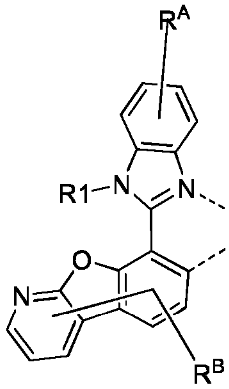, 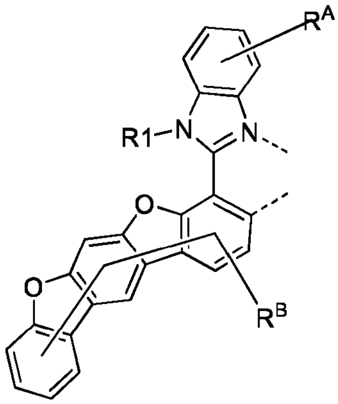, 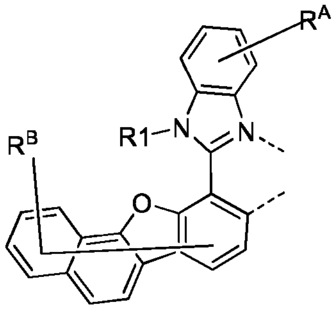,

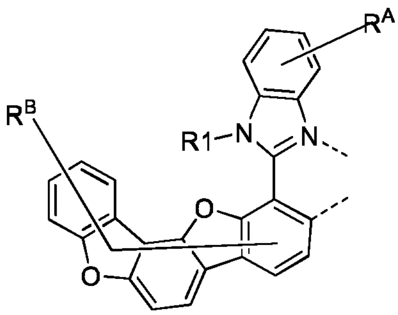, 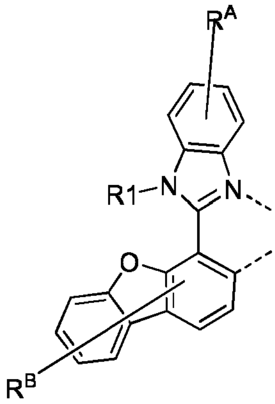, 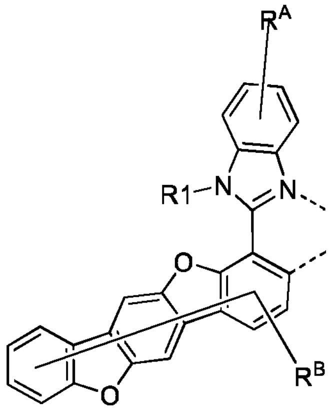,

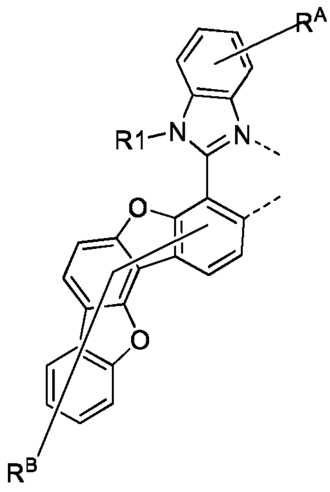, 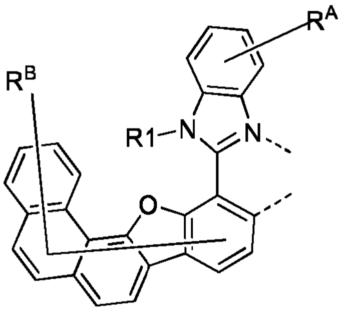, 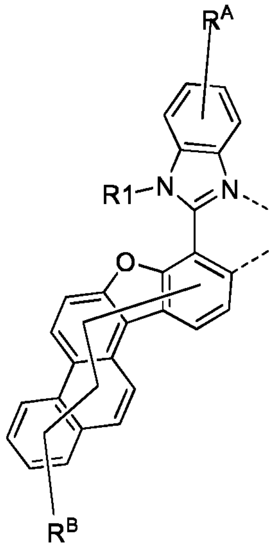,

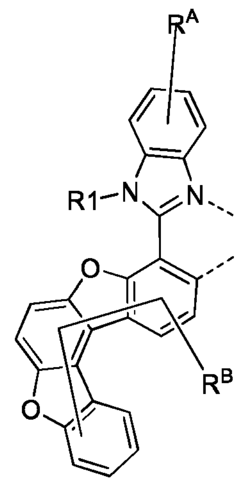,
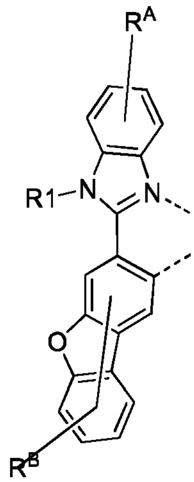,
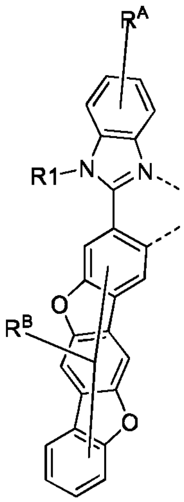,
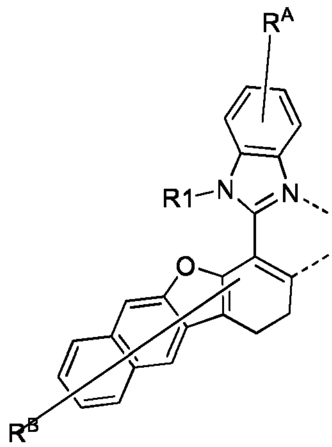,
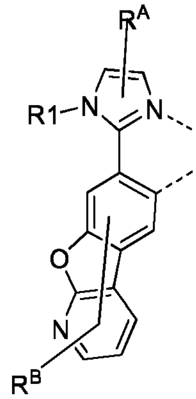,
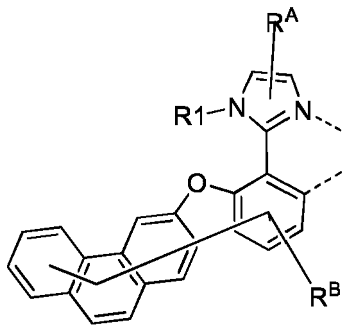,
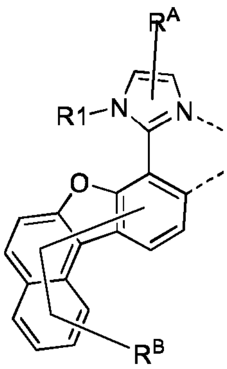,
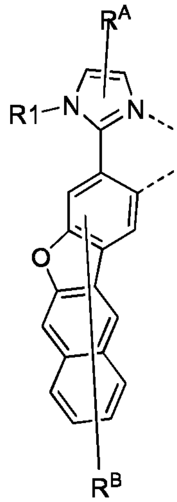,
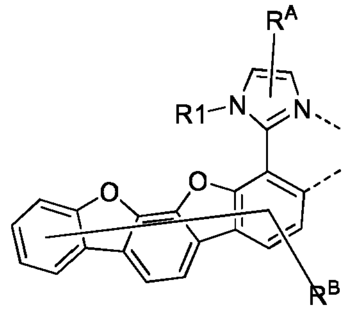,
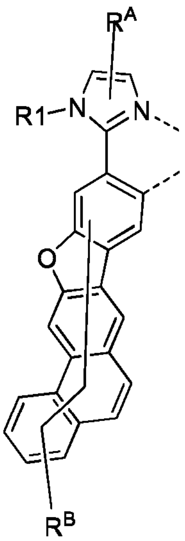,
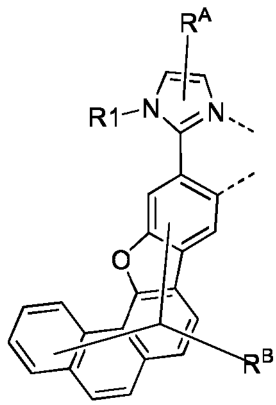,
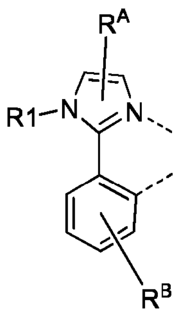,
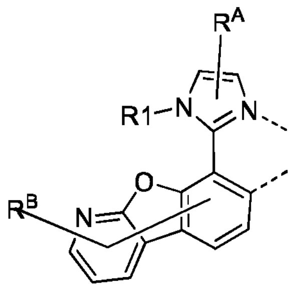,

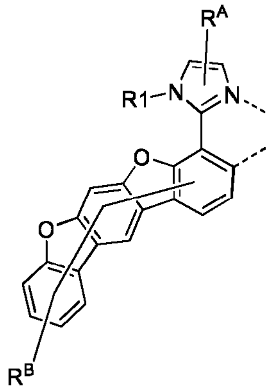 , 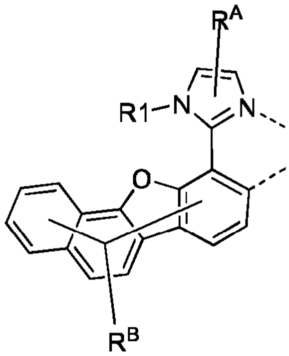 , 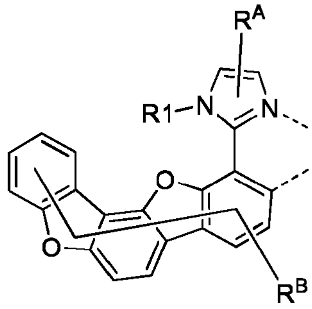 , 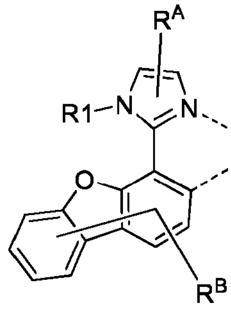 ,

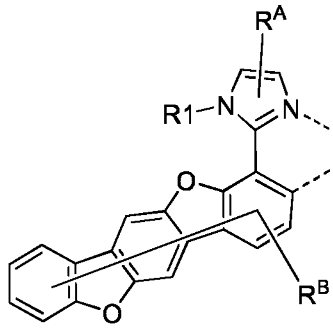 , 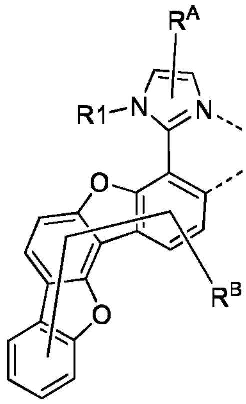 , 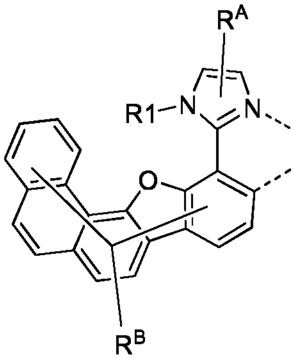 ,

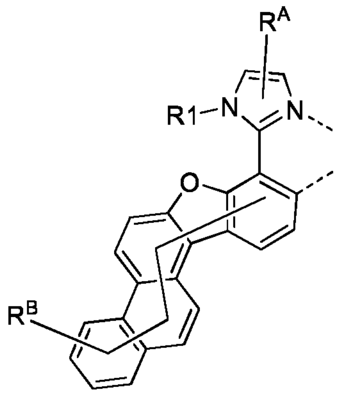 , 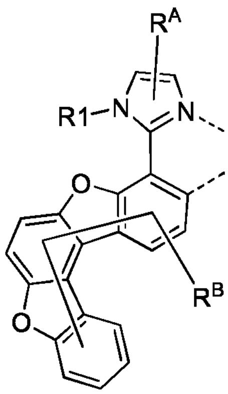 , 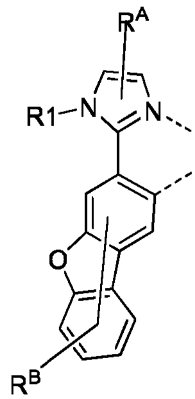 , 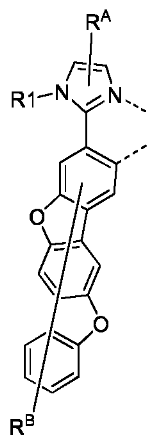 ,

and

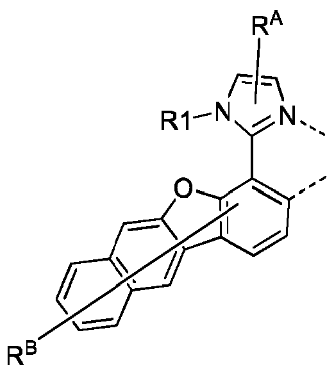 ;

wherein each R1 is independently a hydrogen or a substituent selected from the group consisting of the General Substituents as defined herein;

the remaining variables are the same as previously defined; and any two substituents can be joined or fused to form a ring.

In some embodiments of the compound, the ligand $L_A$ is selected from $L_{Ai}$, wherein i is an integer from 1 to 335; and each $L_{Ai}$ is as defined below:

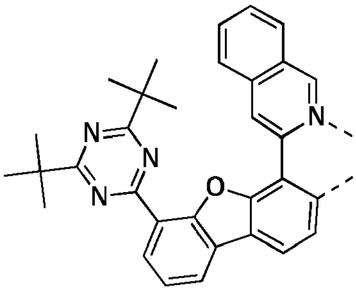

$L_{A1}$ ,

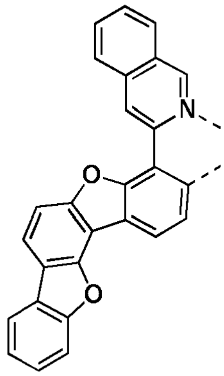

$L_{A2}$ ,

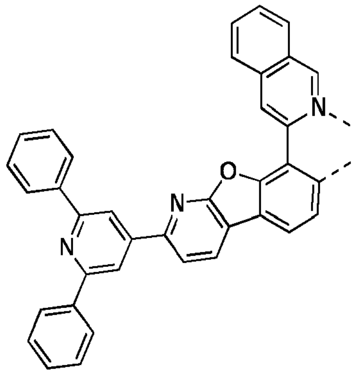

$L_{A3}$ ,

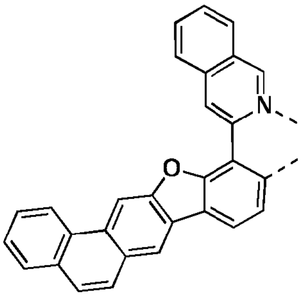

$L_{A4}$ ,

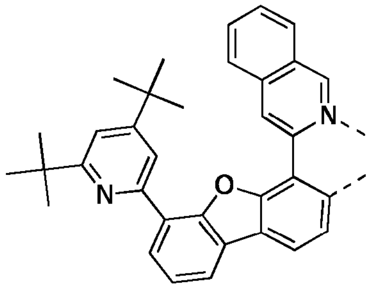

$L_{A5}$ ,

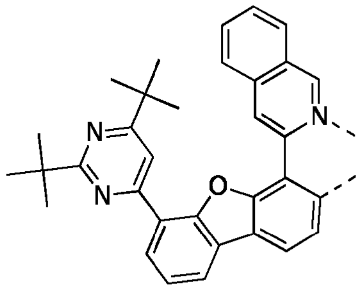

$L_{A6}$ ,

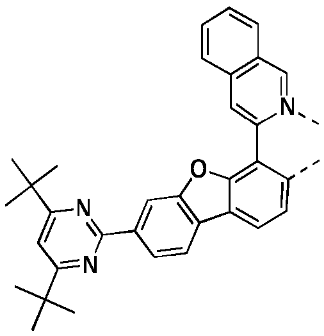

$L_{A7}$ ,

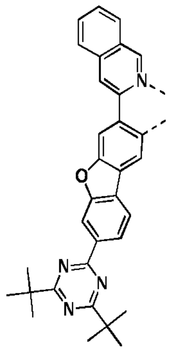

$L_{A8}$ ,

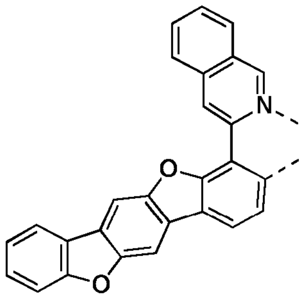

$L_{A9}$ ,

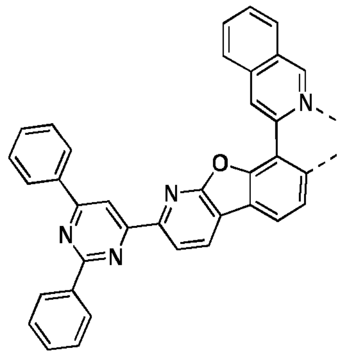

$L_{A10}$ ,

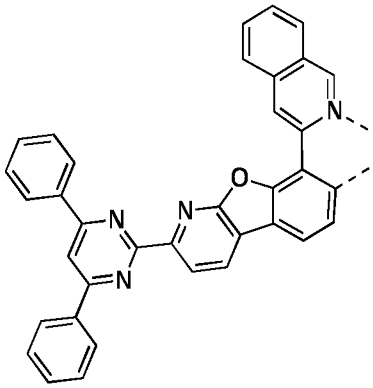
$L_{A11}$ ,
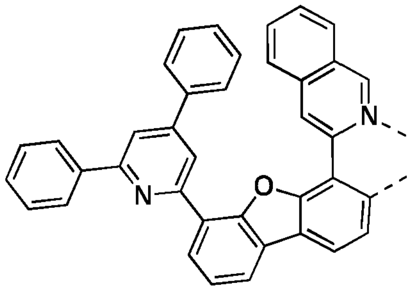
$L_{A12}$ ,
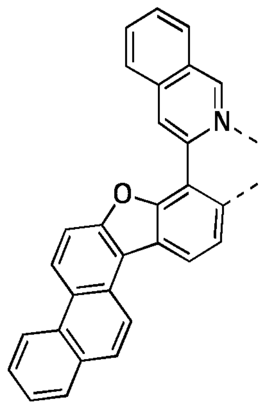
$L_{A13}$ ,

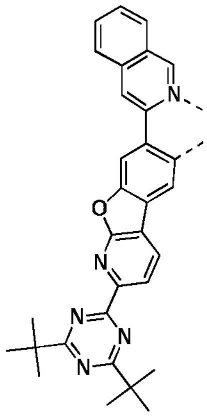
$L_{A14}$ ,
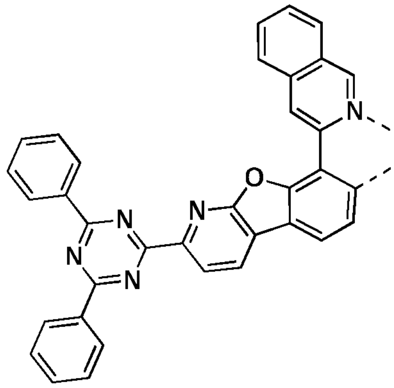
$L_{A15}$ ,
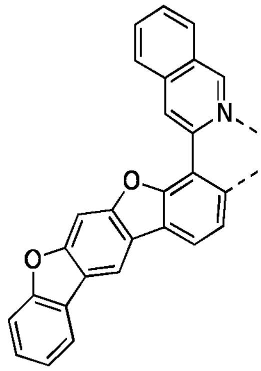
$L_{A16}$ ,

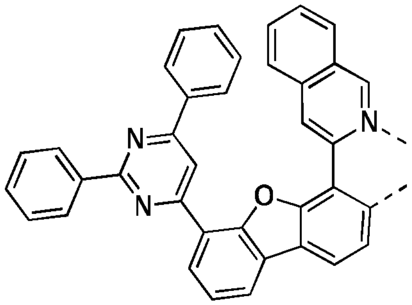
$L_{A17}$ ,
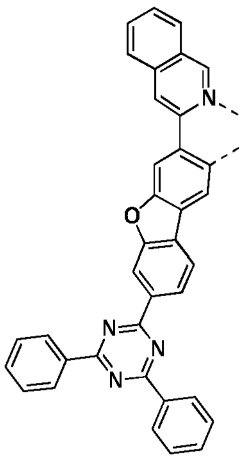
$L_{A18}$ ,
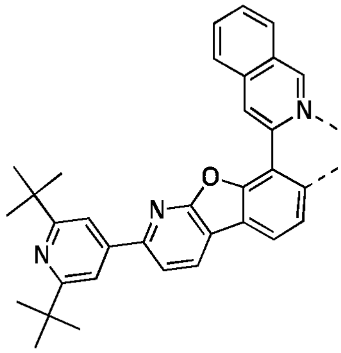
$L_{A19}$ ,

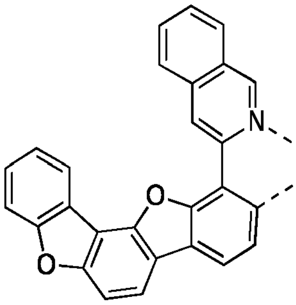

$L_{A20}$ ,

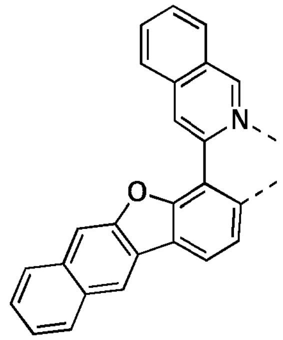

$L_{A21}$ ,

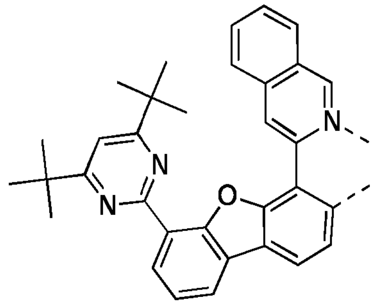

$L_{A22}$ ,

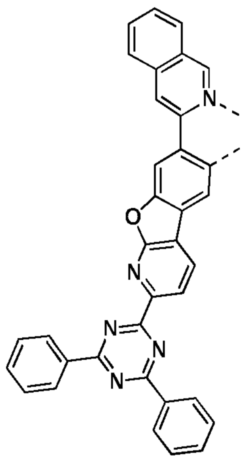

$L_{A23}$ ,

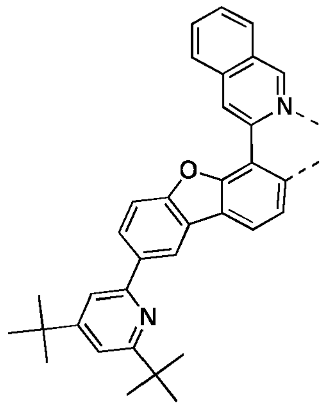

$L_{A24}$ ,

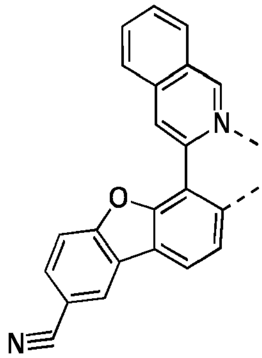

$L_{A25}$ ,

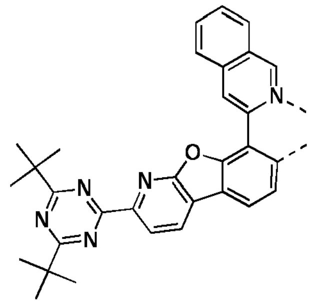

$L_{A26}$ ,

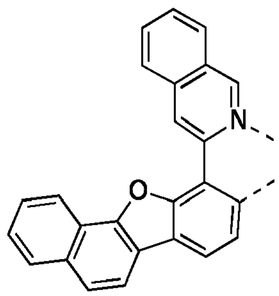

$L_{A27}$ ,

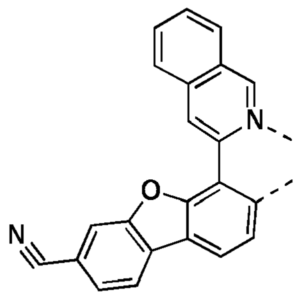

$L_{A28}$ ,

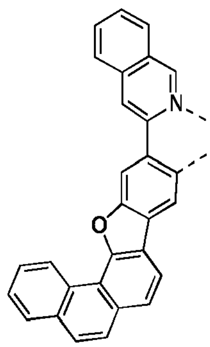

$L_{A29}$ ,

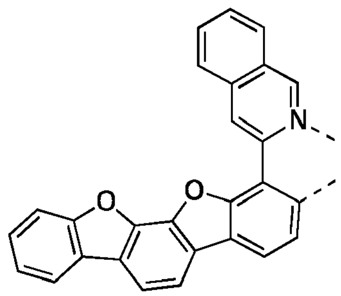

$L_{A30}$ ,

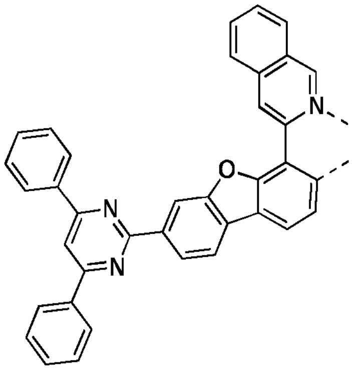

$L_{A31}$ ,

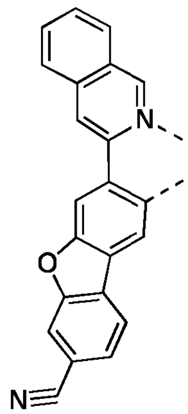

$L_{A32}$ ,

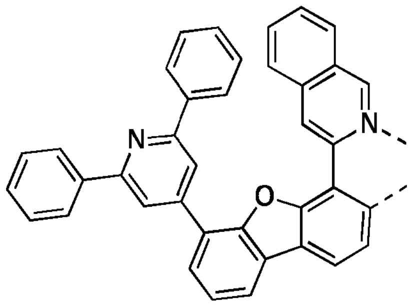

$L_{A33}$ ,

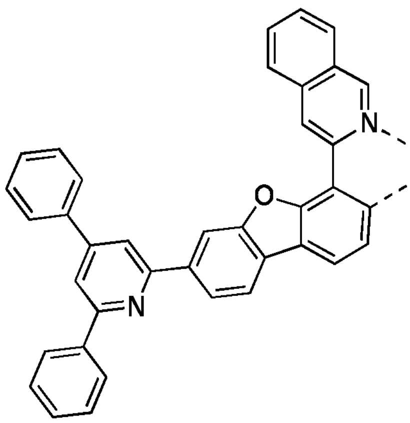

$L_{A34}$ ,

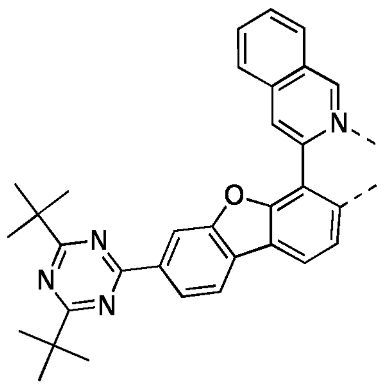

$L_{A35}$ ,

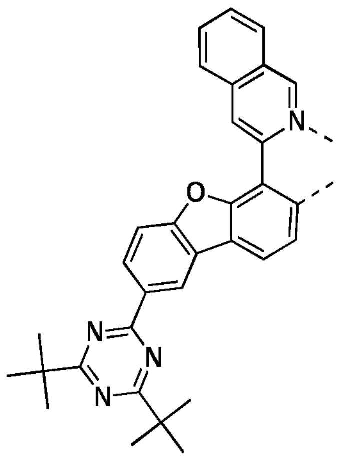

$L_{A36}$ ,

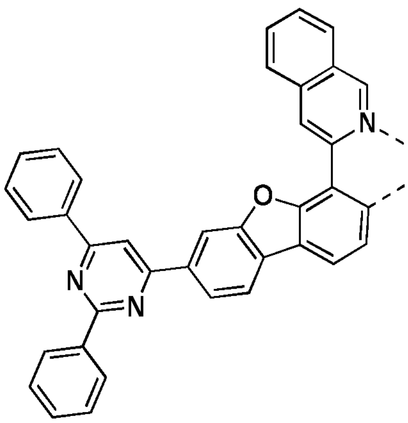

$L_{A37}$ ,

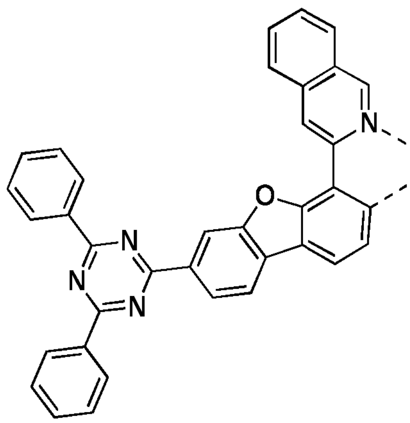

$L_{A38}$ ,

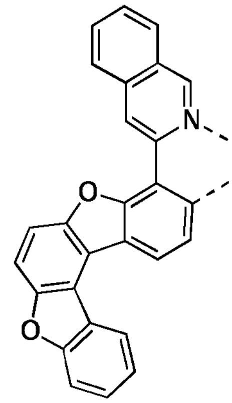

$L_{A39}$ ,

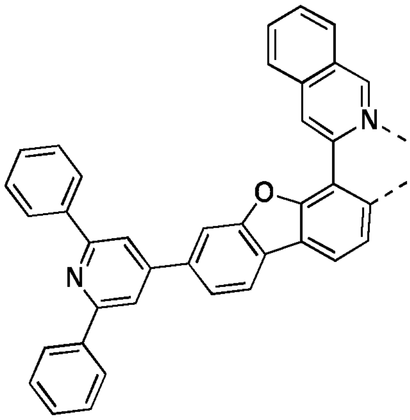

$L_{A40}$ ,

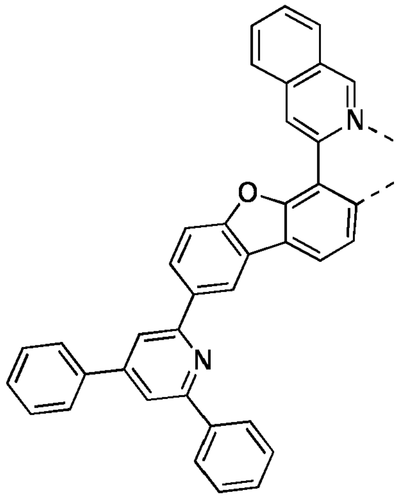

$L_{A41}$ ,

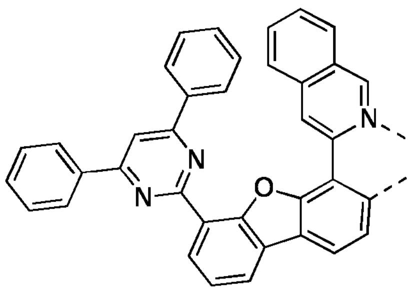

$L_{A42}$ ,

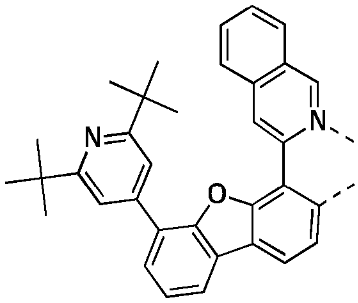

$L_{A43}$ ,

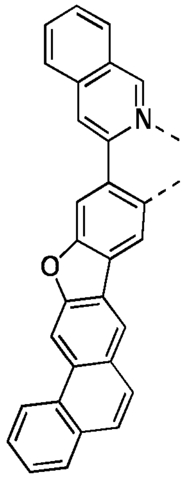

$L_{A44}$ ,

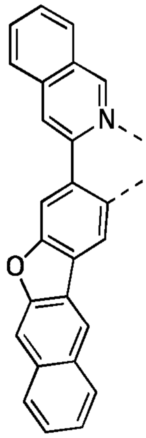

$L_{A45}$ ,

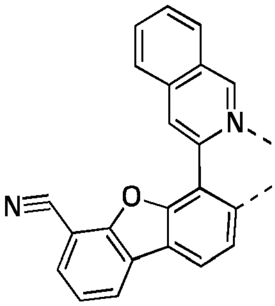

$L_{A46}$ ,

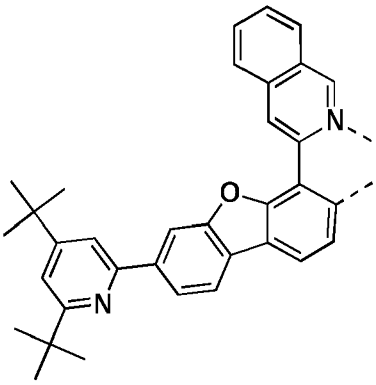

$L_{A47}$ ,

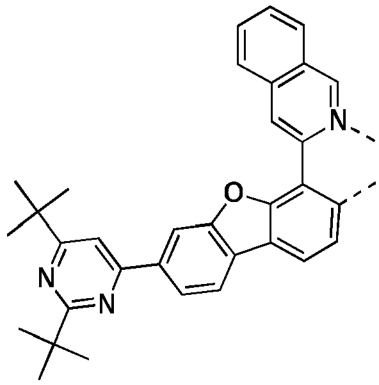

$L_{A48}$ ,

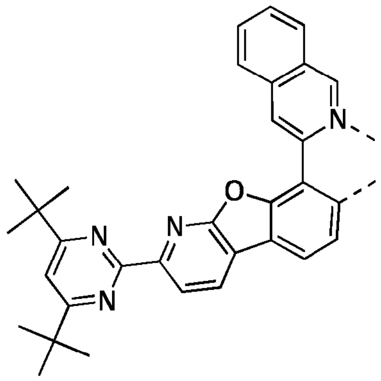
$L_{A49}$ ,
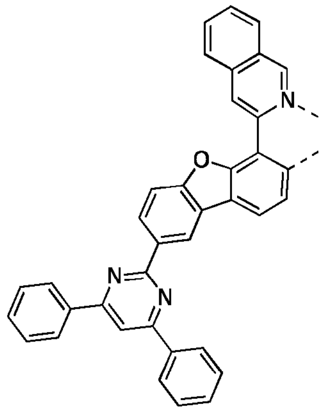
$L_{A50}$ ,
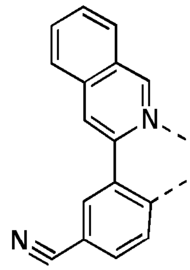
$L_{A51}$ ,

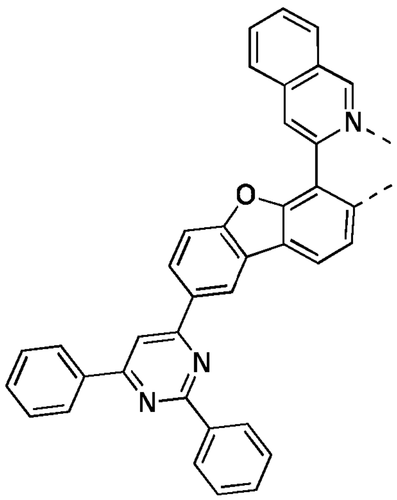
$L_{A52}$ ,
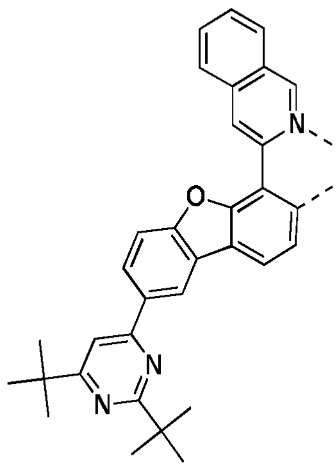
$L_{A53}$ ,
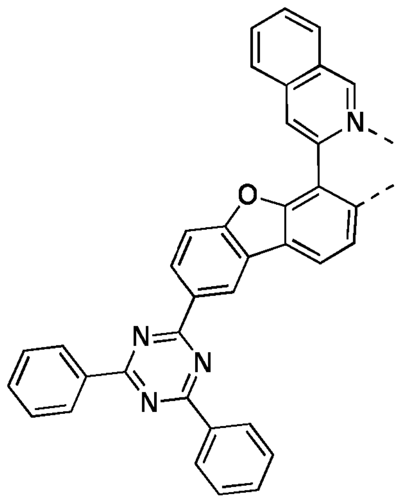
$L_{A54}$ ,

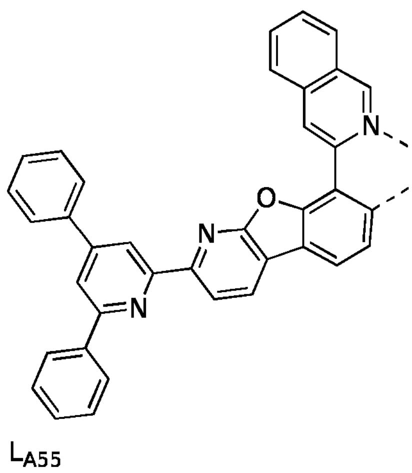
$L_{A55}$ ,
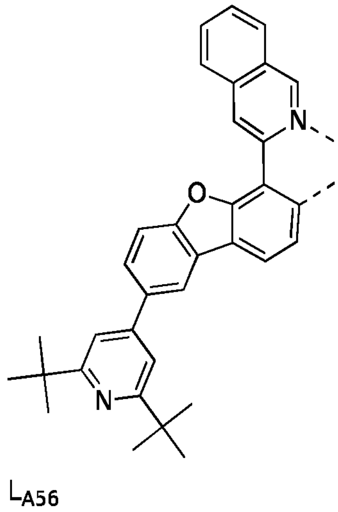
$L_{A56}$ ,
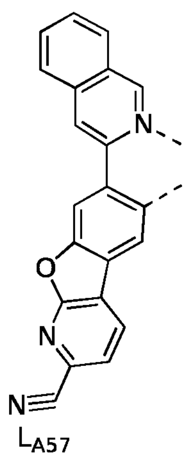
$L_{A57}$ ,

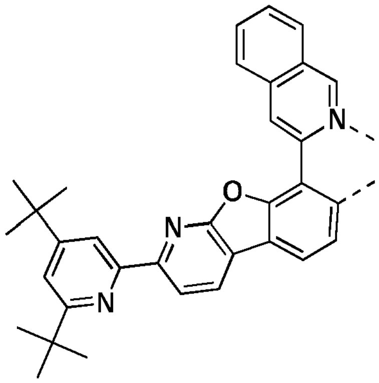

LA58 ,

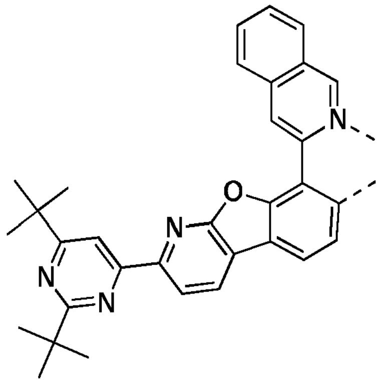

LA59 ,

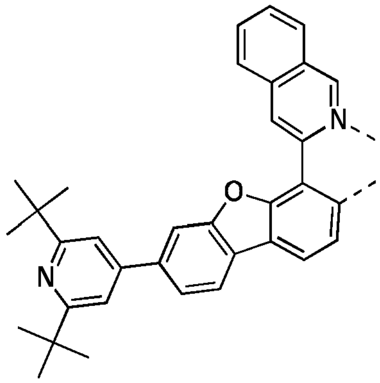

LA60 ,

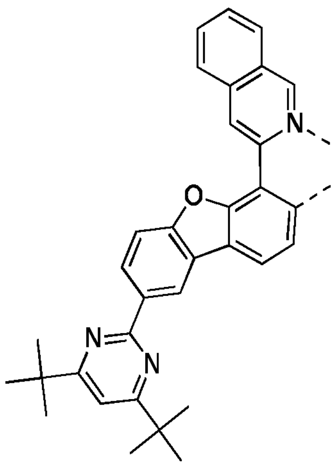

LA61 ,

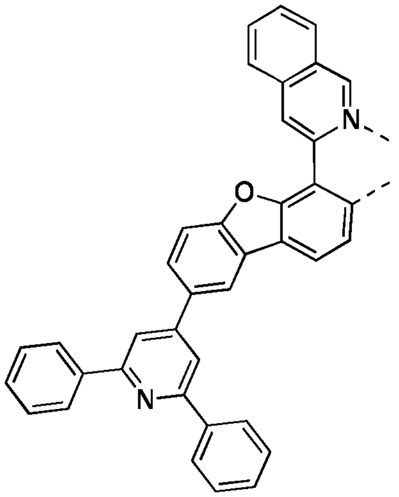

LA62 ,

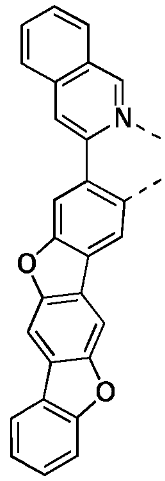

LA63 ,

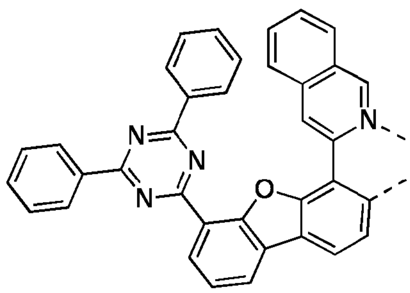

LA64 ,

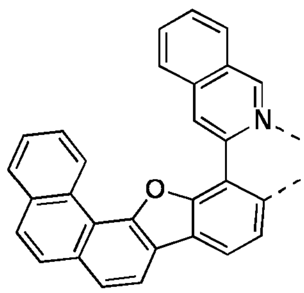

LA65 ,

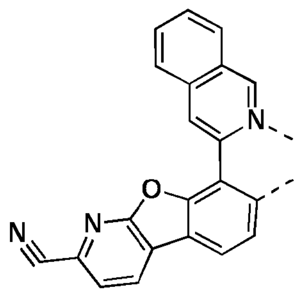

LA66 ,

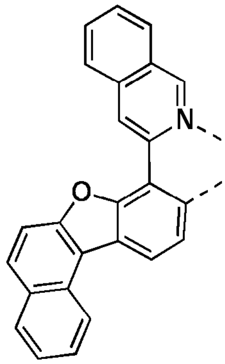

$L_{A67}$ ,

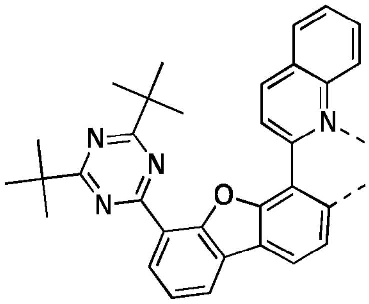

$L_{A68}$ ,

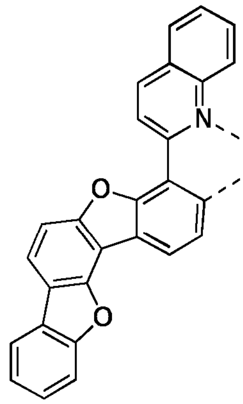

$L_{A69}$ ,

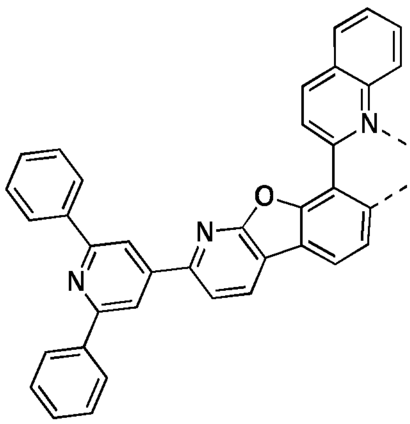

$L_{A70}$ ,

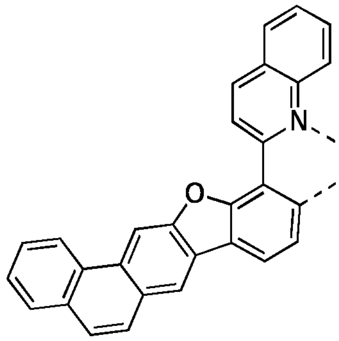

$L_{A71}$ ,

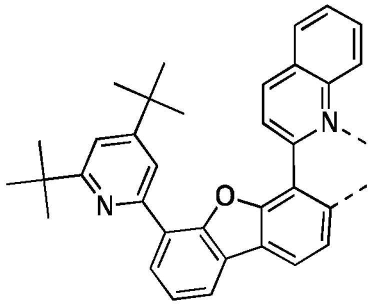

$L_{A72}$ ,

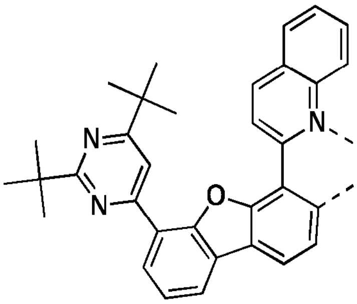

$L_{A73}$ ,

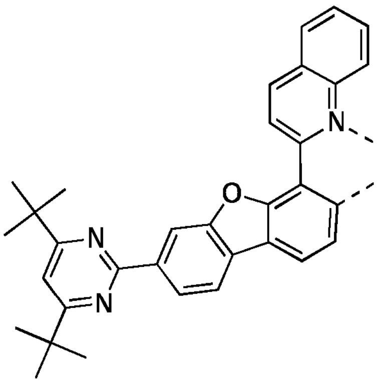

$L_{A74}$ ,

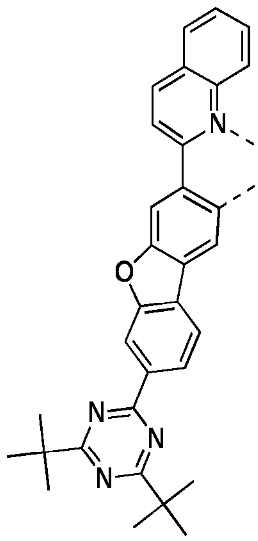

$L_{A75}$ ,

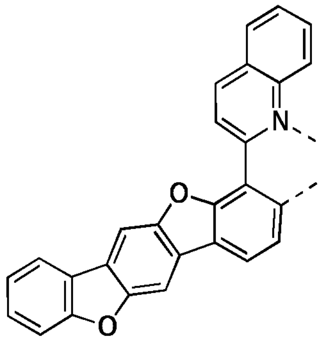

$L_{A76}$

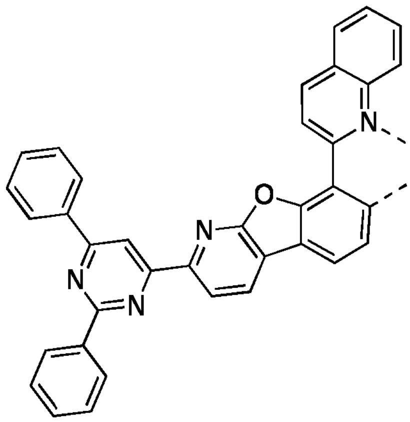

, $L_{A77}$

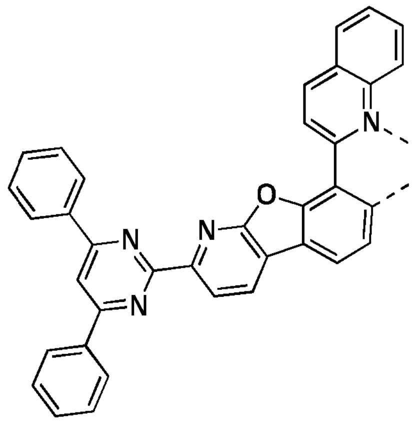

, $L_{A78}$

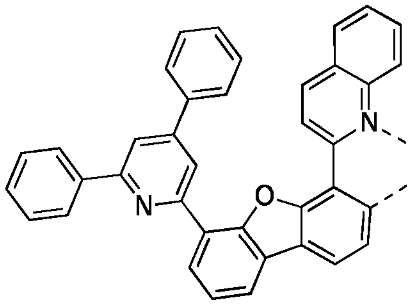

, $L_{A79}$

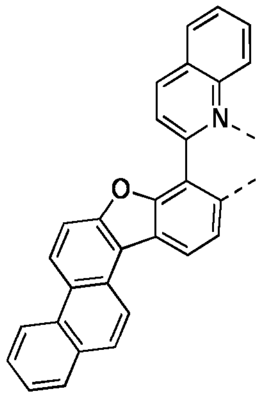

, $L_{A80}$

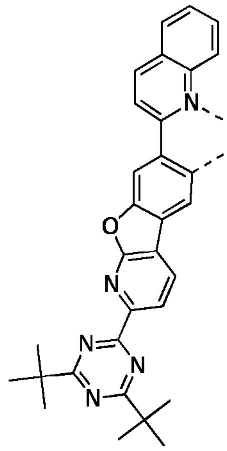

, $L_{A81}$ ,

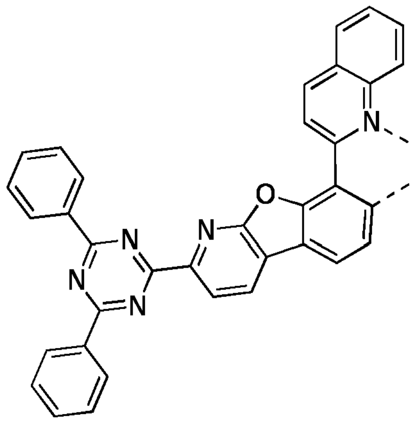

$L_{A82}$

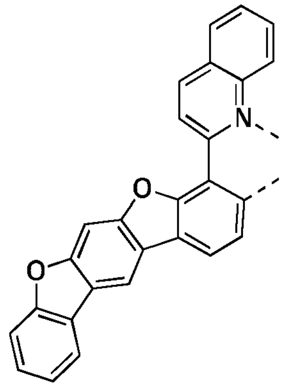

, $L_{A83}$

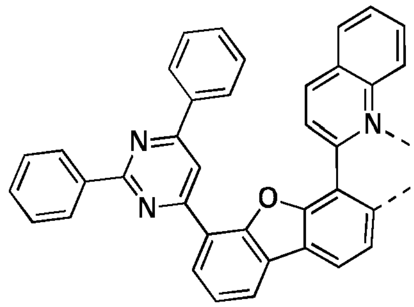

, $L_{A84}$ ,

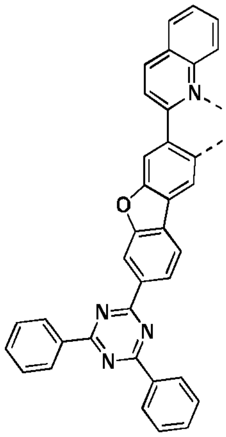
$L_{A85}$ ,
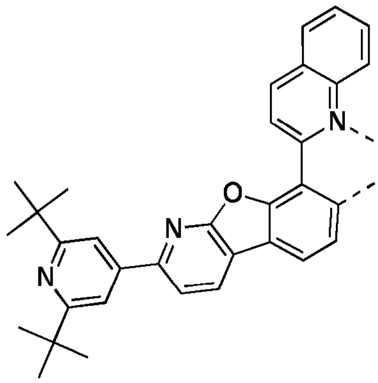
$L_{A86}$ ,
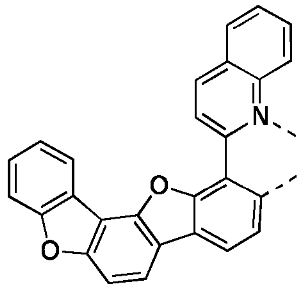
$L_{A87}$ ,

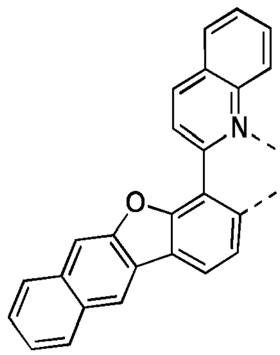
$L_{A88}$ ,
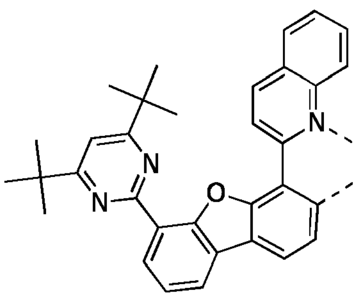
$L_{A89}$ ,
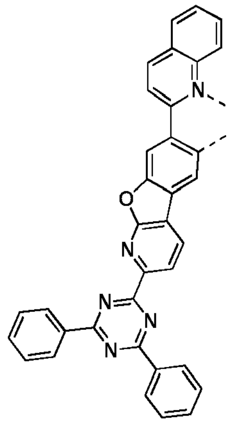
$L_{A90}$ ,

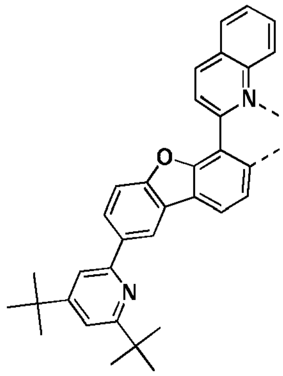
$L_{A91}$ ,
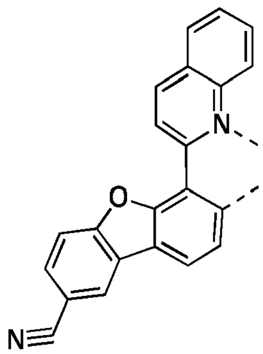
$L_{A92}$ ,
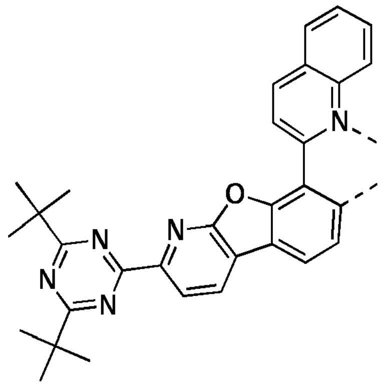
$L_{A93}$ ,

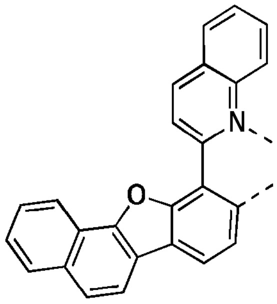
$L_{A94}$ ,

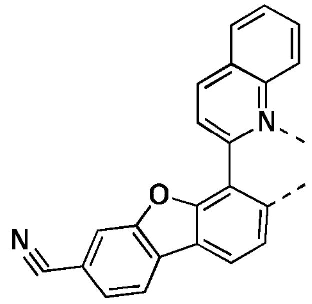
$L_{A95}$ ,

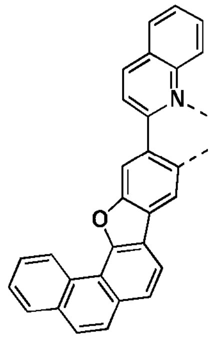
$L_{A96}$ ,

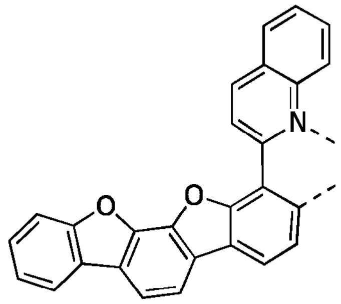
$L_{A97}$ ,

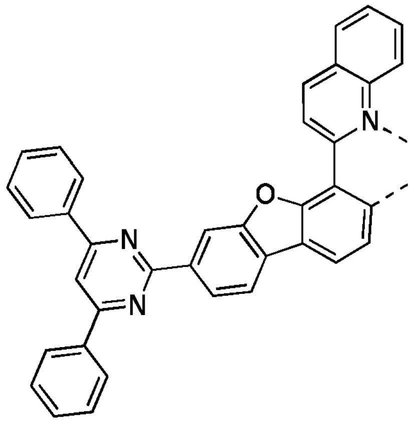
$L_{A98}$ ,

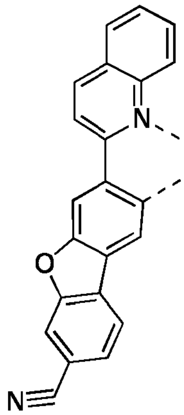
$L_{A99}$ ,

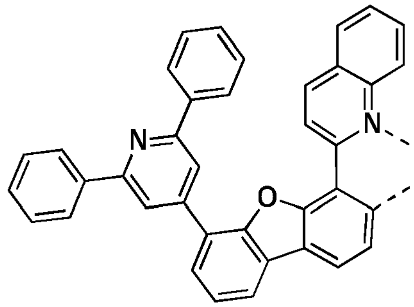
$L_{A100}$ ,

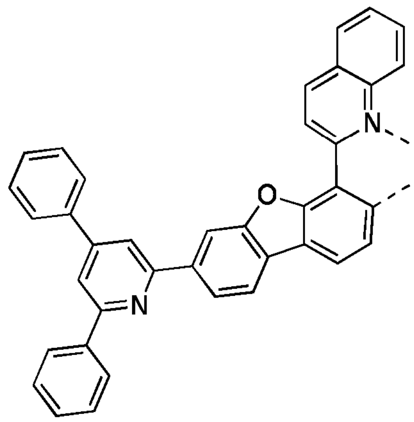
$L_{A101}$ ,

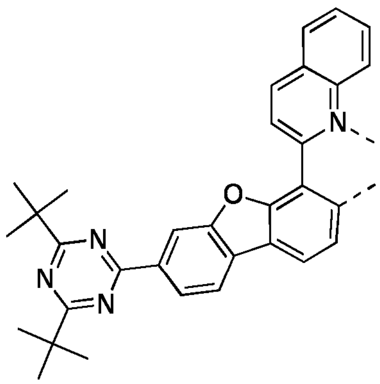
$L_{A102}$ ,

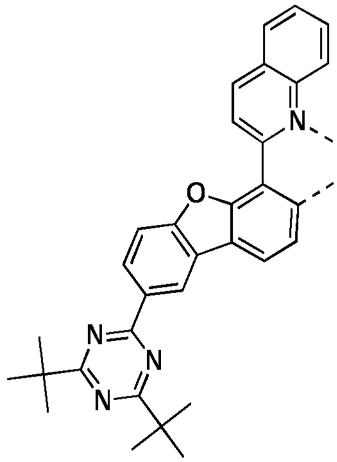
$L_{A103}$ ,

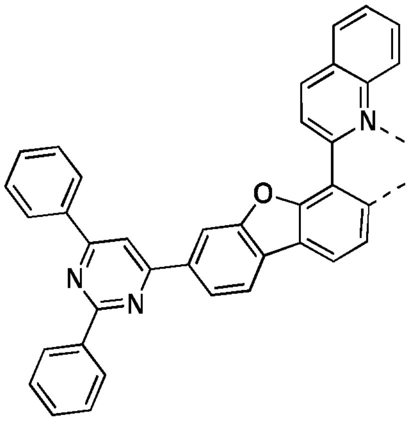

$L_{A104}$ ,

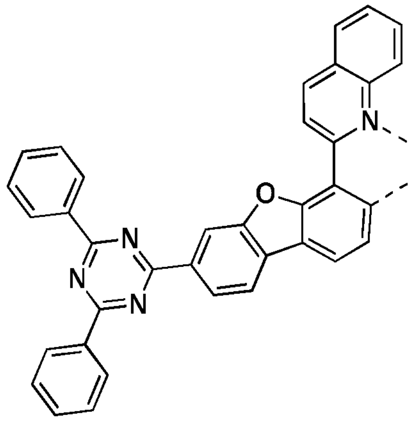

$L_{A105}$ ,

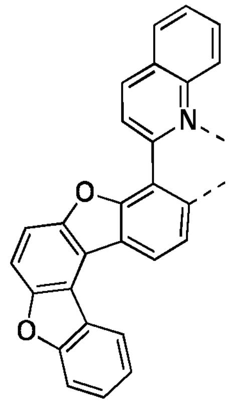

$L_{A106}$ ,

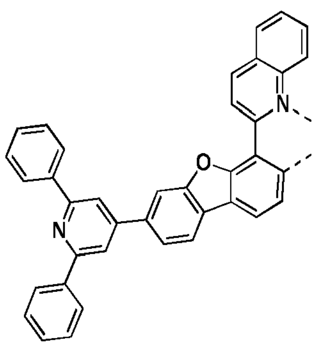

$L_{A107}$ ,

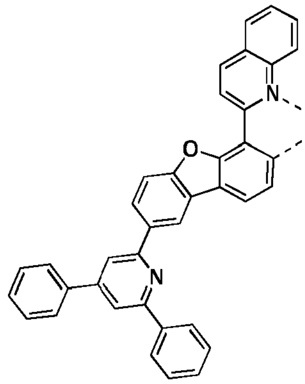

$L_{A108}$ ,

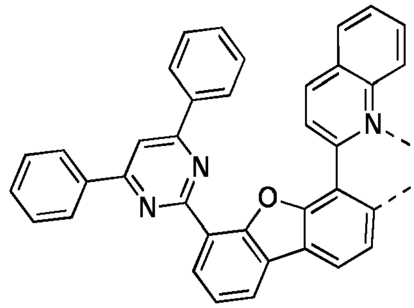

$L_{A109}$ ,

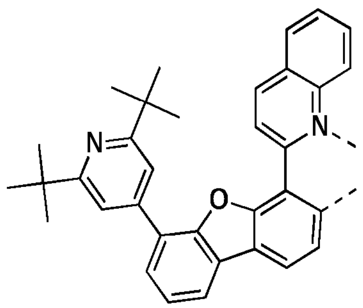

$L_{A110}$ ,

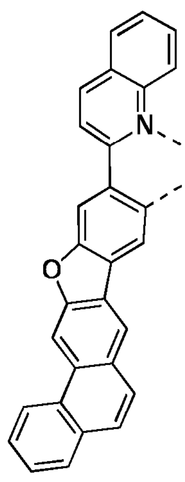

$L_{A111}$ ,

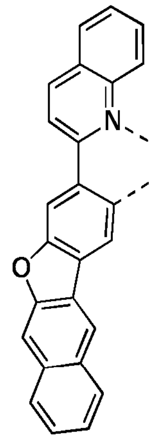

$L_{A112}$ ,

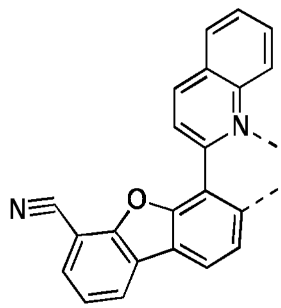

$L_{A113}$ ,

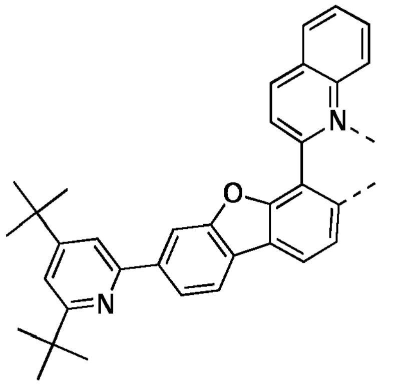

$L_{A114}$ ,

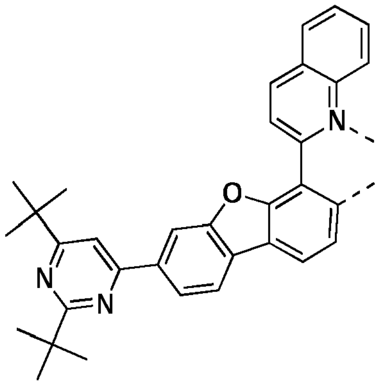

$L_{A115}$ ,

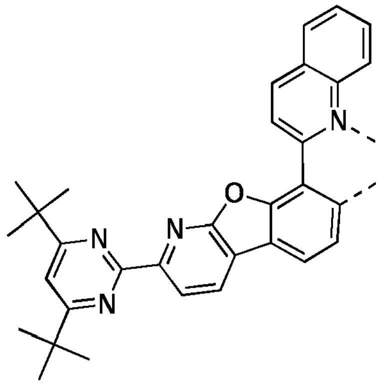

$L_{A116}$ ,

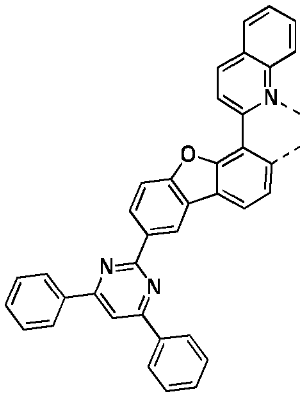

$L_{A117}$ ,

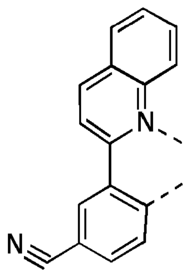

$L_{A118}$ ,

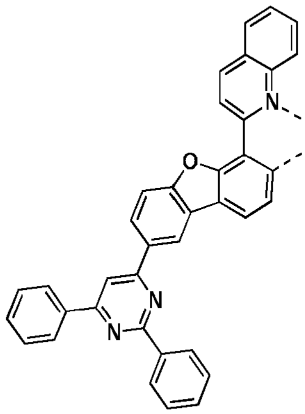

$L_{A119}$ ,

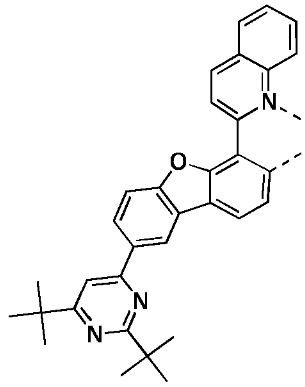

$L_{A120}$ ,

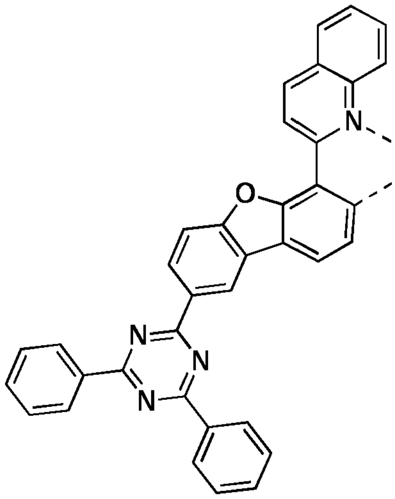

$L_{A121}$ ,

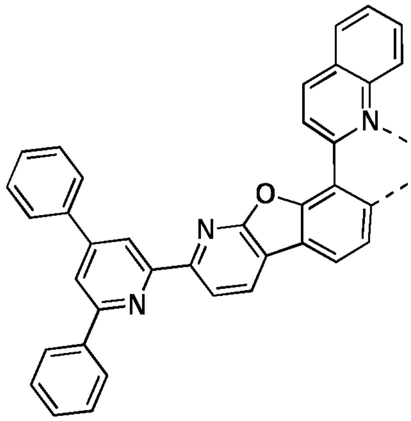

$L_{A122}$ ,

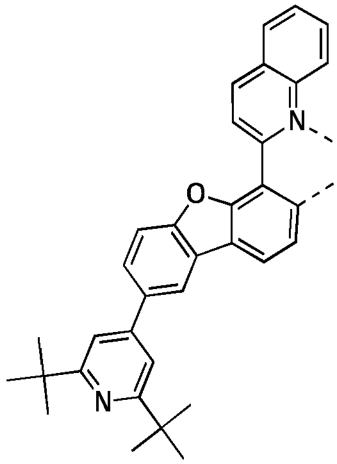

$L_{A123}$

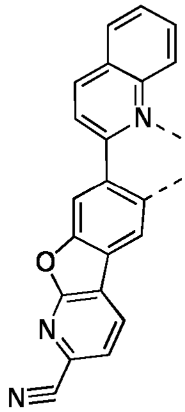

, $L_{A124}$

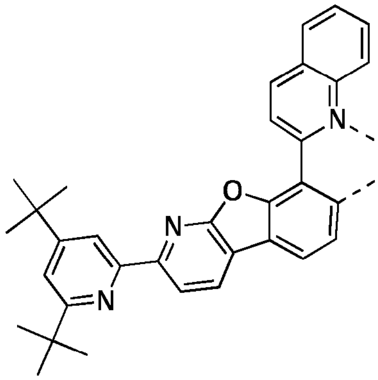

, $L_{A125}$

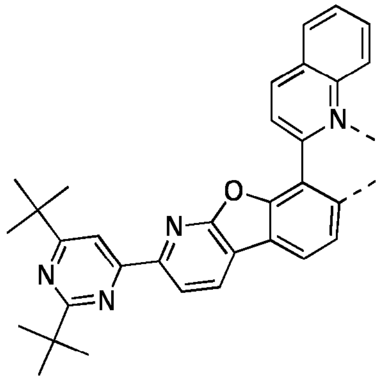

, $L_{A126}$

,

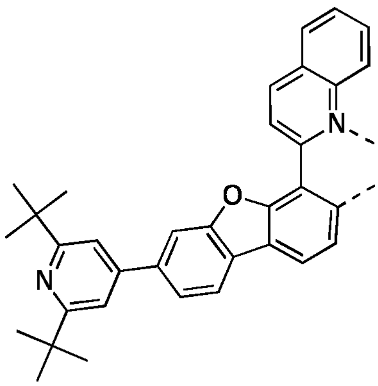

$L_{A127}$

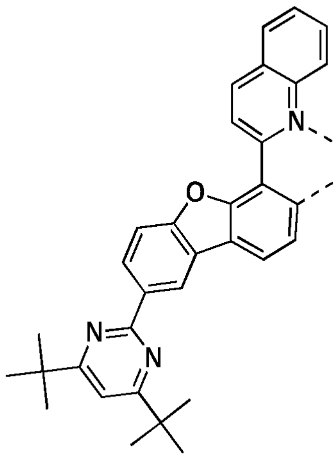

, $L_{A128}$

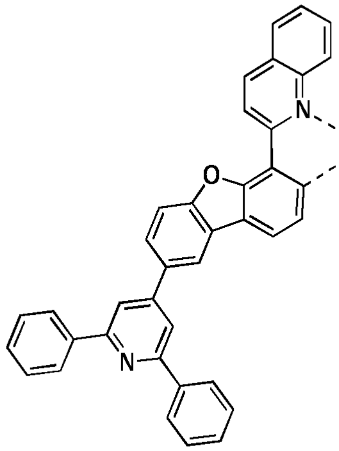

, $L_{A129}$

,

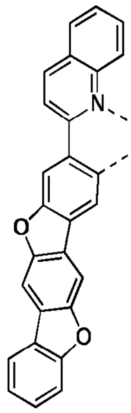

$L_{A130}$

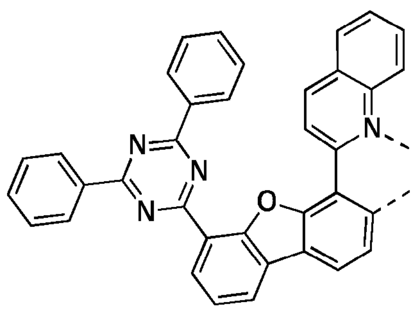

, $L_{A131}$

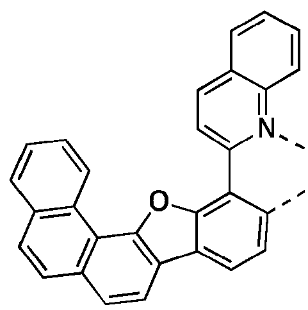

, $L_{A132}$

,

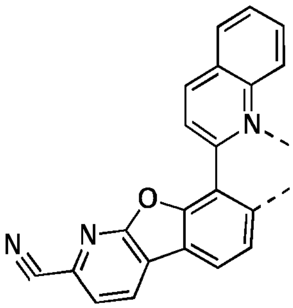
$L_{A133}$ ,
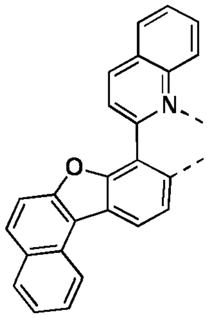
$L_{A134}$ ,
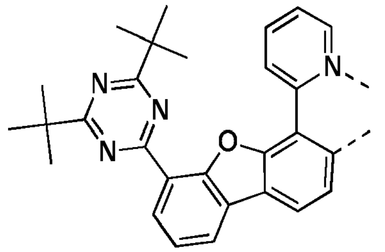
$L_{A135}$ ,
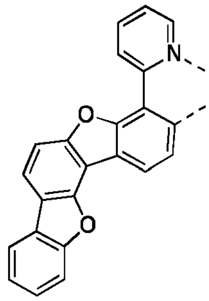
$L_{A136}$ ,

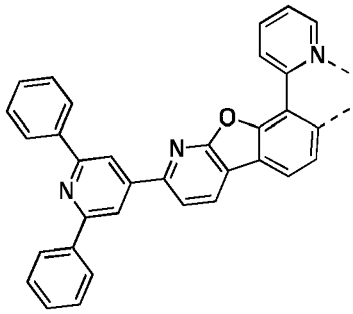
$L_{A137}$ ,
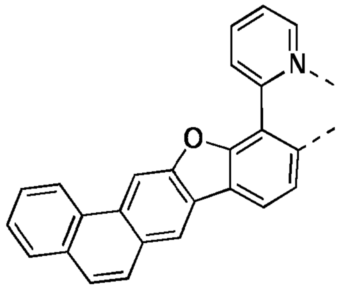
$L_{A138}$ ,
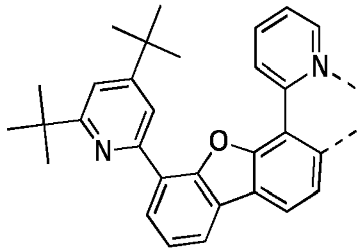
$L_{A139}$ ,

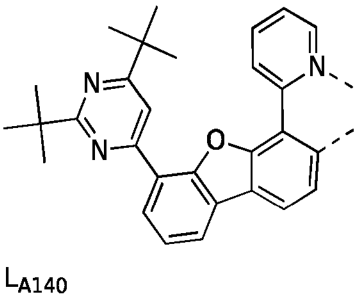
$L_{A140}$ ,
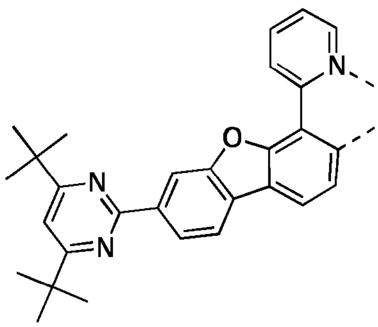
$L_{A141}$ ,
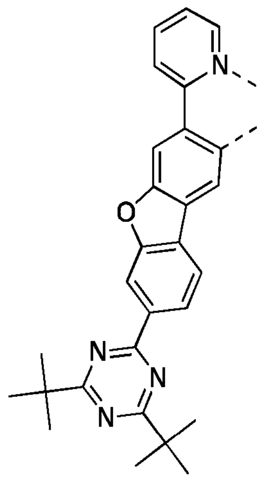
$L_{A142}$ ,

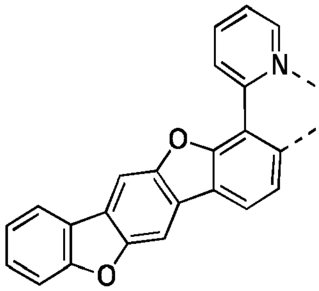

$L_{A143}$ ,

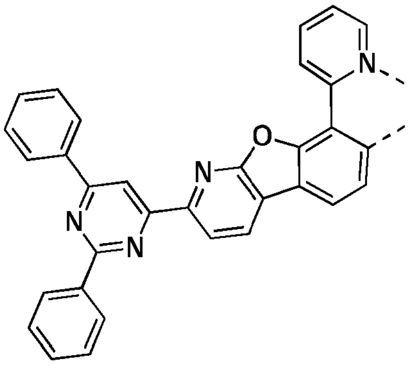

$L_{A144}$ ,

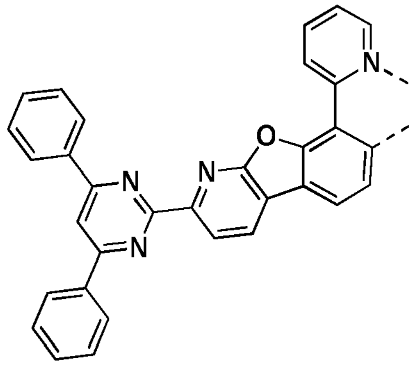

$L_{A145}$ ,

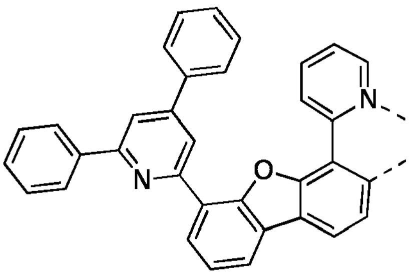

$L_{A146}$ ,

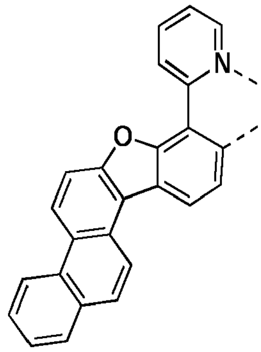

$L_{A147}$ ,

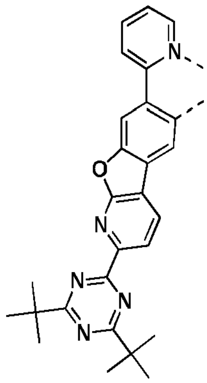

$L_{A148}$ ,

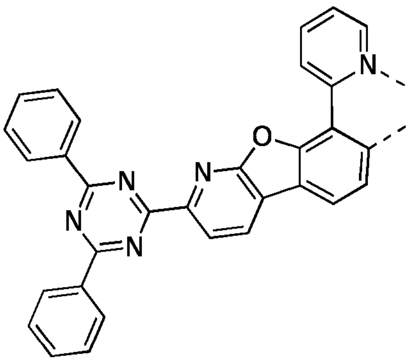

$L_{A149}$ ,

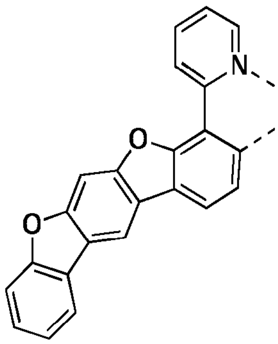

$L_{A150}$ ,

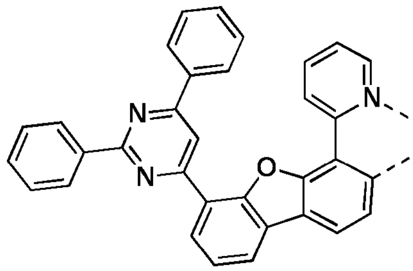

$L_{A151}$ ,

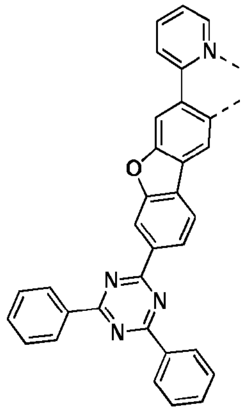

$L_{A152}$ ,

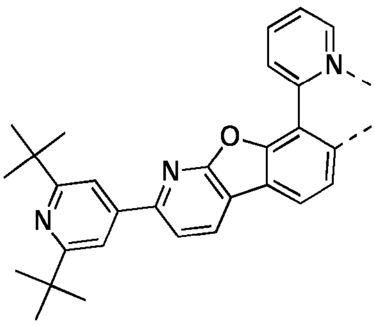

$L_{A153}$ ,

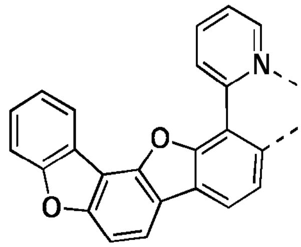

$L_{A154}$ ,

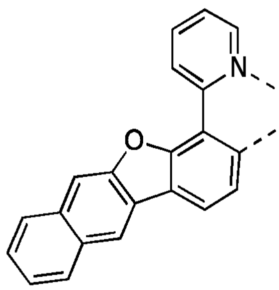

$L_{A155}$ ,

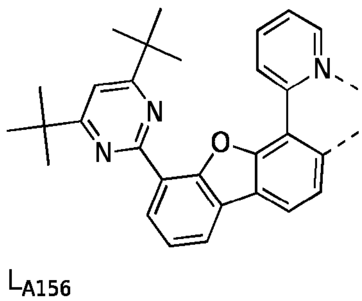

$L_{A156}$ ,

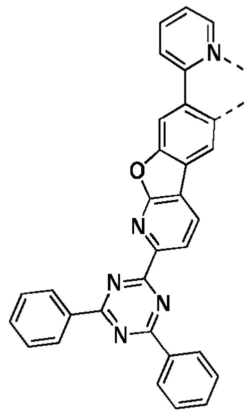

$L_{A157}$ ,

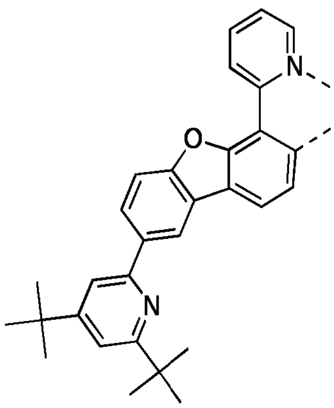

$L_{A158}$ ,

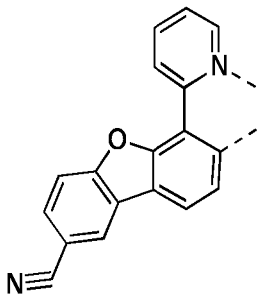

$L_{A159}$ ,

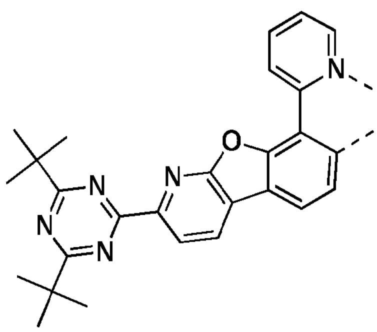

$L_{A160}$ ,

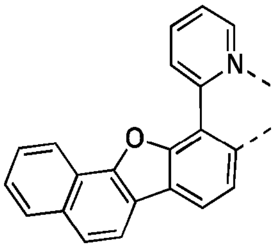

$L_{A161}$ ,

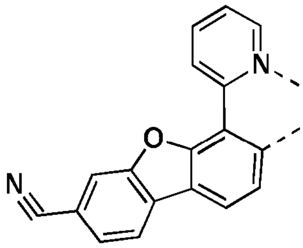

$L_{A162}$ ,

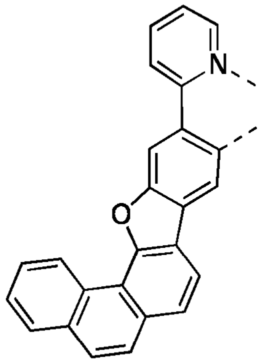

$L_{A163}$ ,

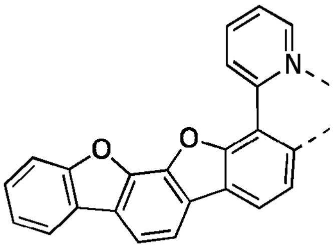

$L_{A164}$ ,

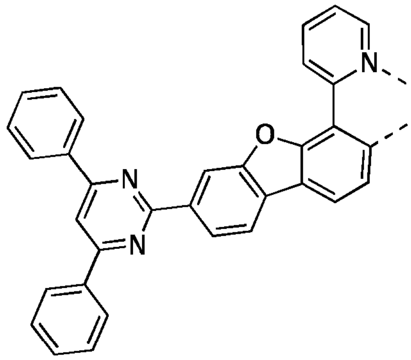

$L_{A165}$ ,

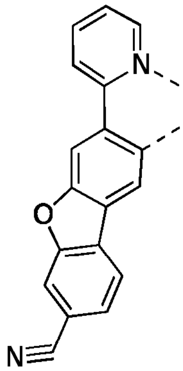

$L_{A166}$ ,

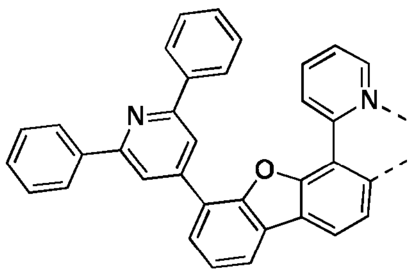

$L_{A167}$ ,

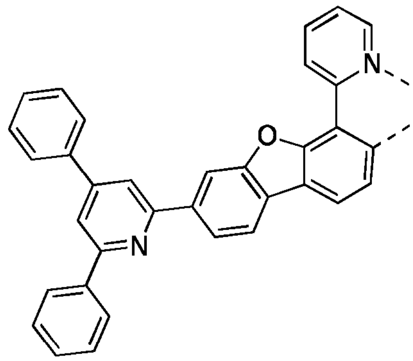

$L_{A168}$ ,

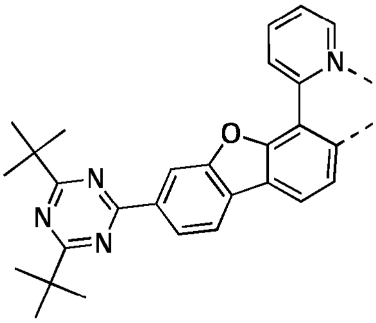

$L_{A169}$ ,

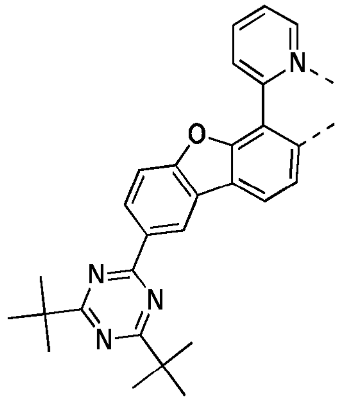

$L_{A170}$ ,

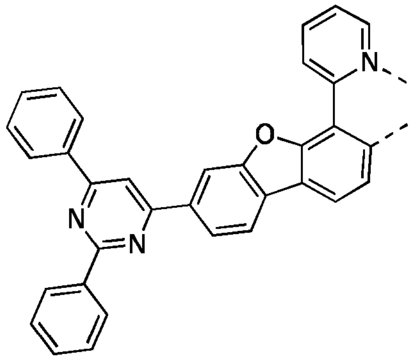

$L_{A171}$ ,

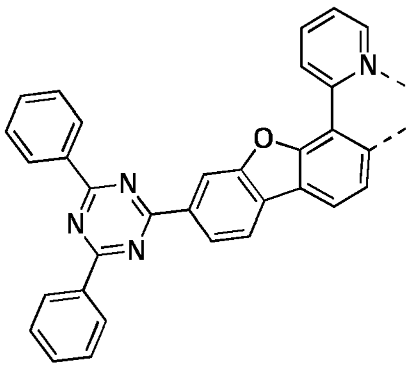

$L_{A172}$ ,

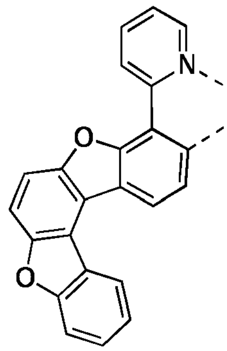

$L_{A173}$ ,

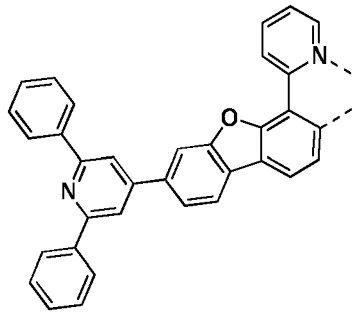

$L_{A174}$ ,

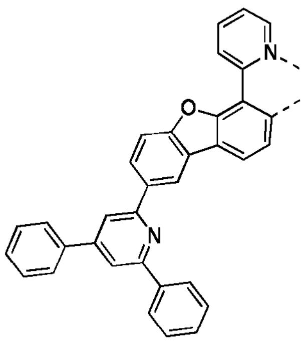

$L_{A175}$ ,

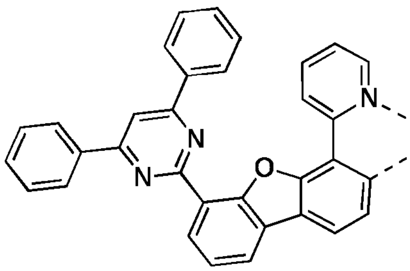

$L_{A176}$ ,

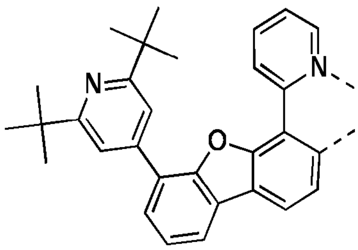

$L_{A177}$ ,

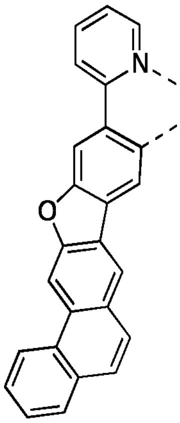

$L_{A178}$ ,

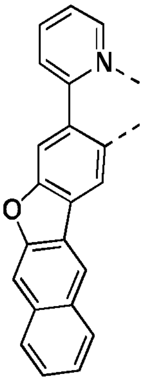

$L_{A179}$ ,

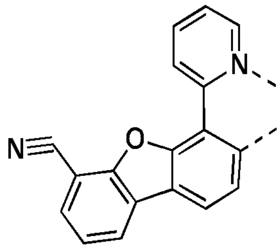

$L_{A180}$ ,

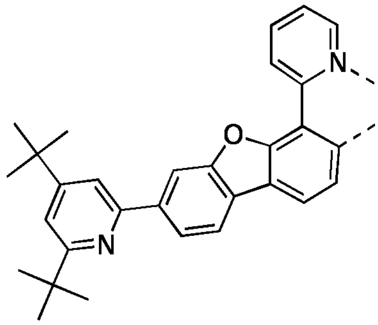

$L_{A181}$ ,

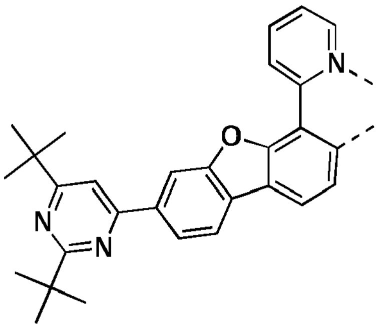

$L_{A182}$ ,

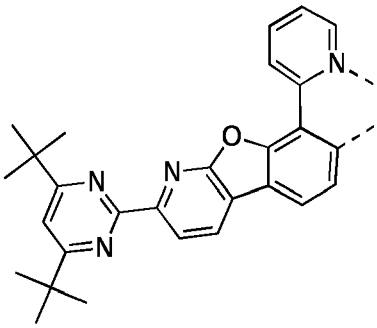

$L_{A183}$ ,

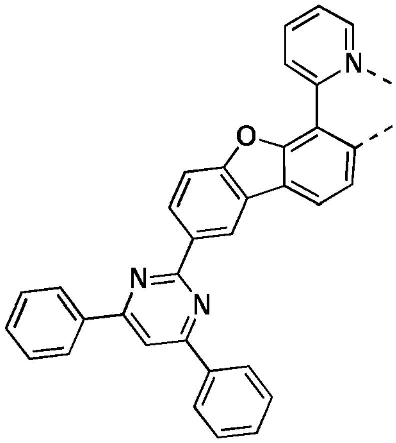

$L_{A184}$

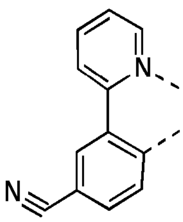

, $L_{A185}$ ,

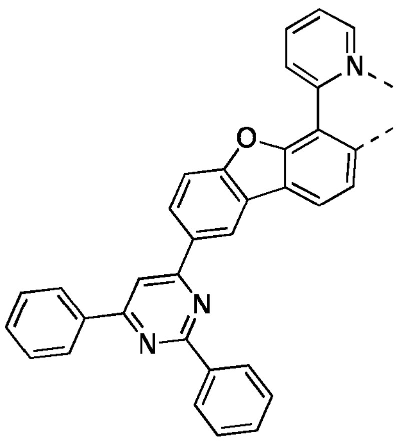

$L_{A186}$ ,

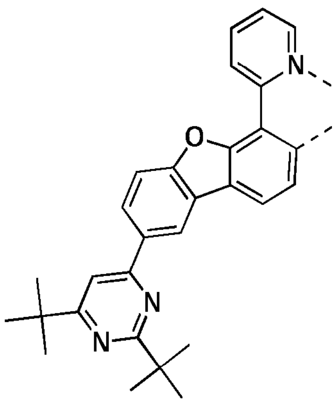

$L_{A187}$ ,

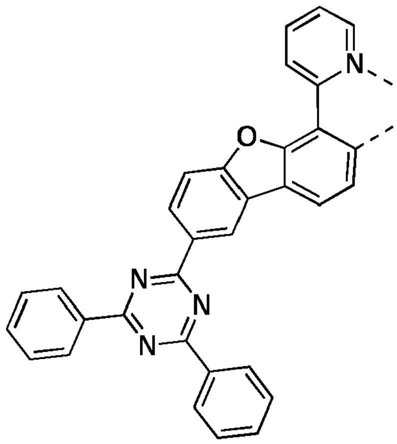

$L_{A188}$ ,

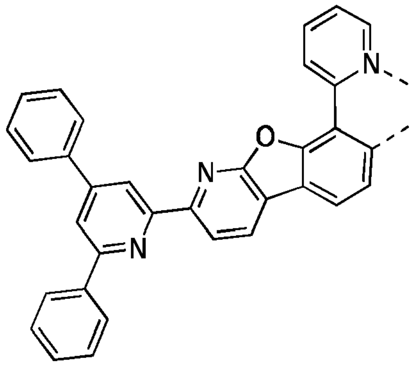

$L_{A189}$ ,

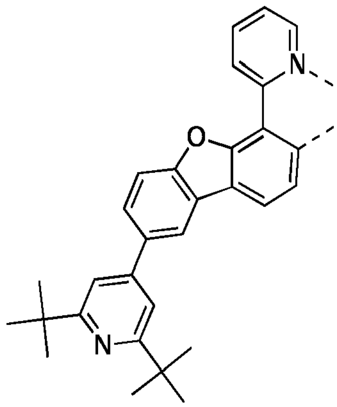

$L_{A190}$ ,

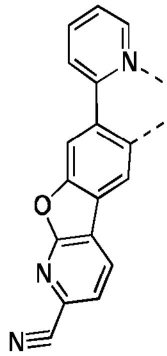

$L_{A191}$ ,

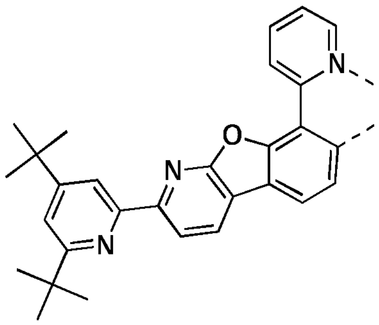

$L_{A192}$ ,

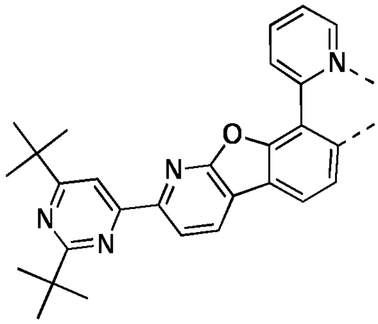

$L_{A193}$ ,

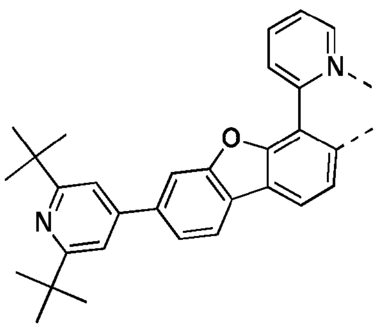

$L_{A194}$ ,

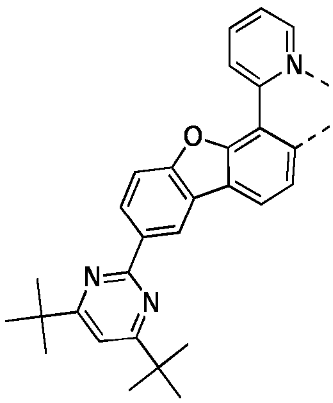

$L_{A195}$ ,

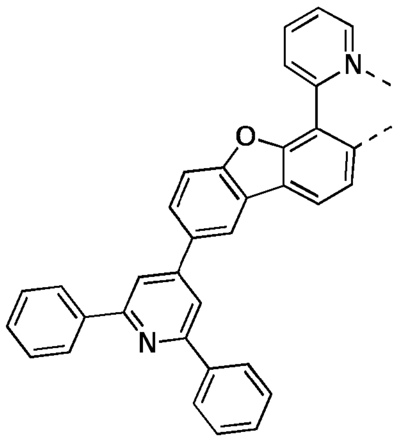

$L_{A196}$ ,

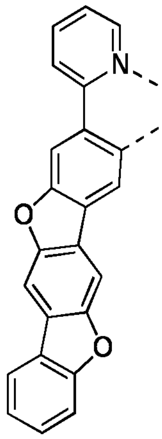

$L_{A197}$ ,

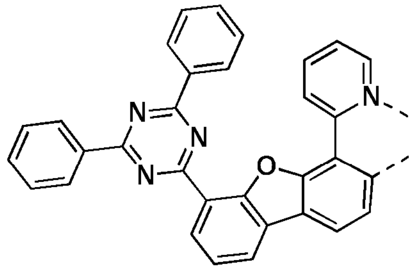

$L_{A198}$ ,

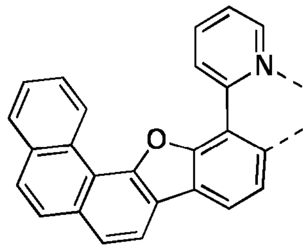

$L_{A199}$ ,

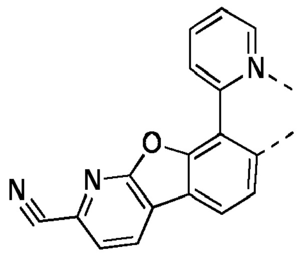

$L_{A200}$ ,

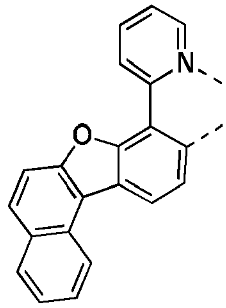

$L_{A201}$ ,

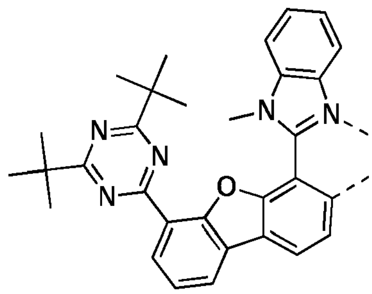

$L_{A202}$ ,

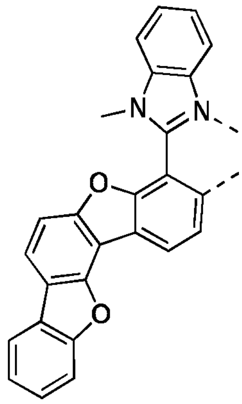

$L_{A203}$ ,

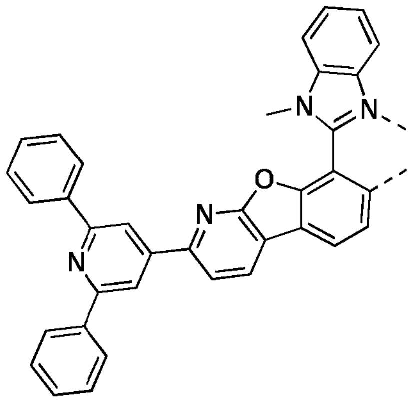

$L_{A204}$ ,

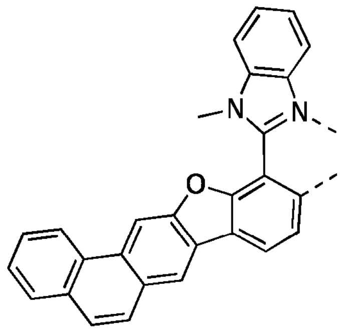

$L_{A205}$ ,

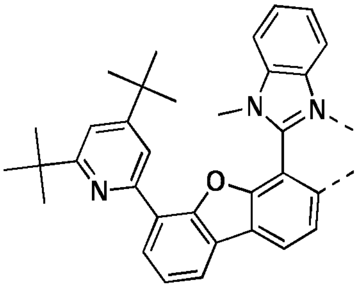

$L_{A206}$ ,

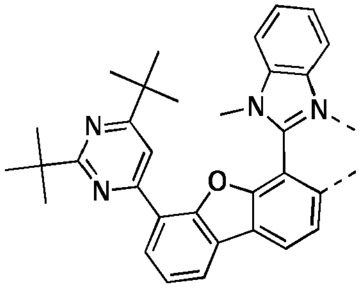

$L_{A207}$ ,

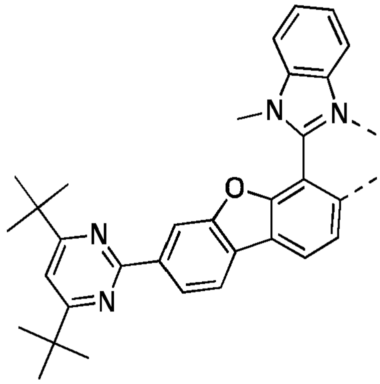

$L_{A208}$ ,

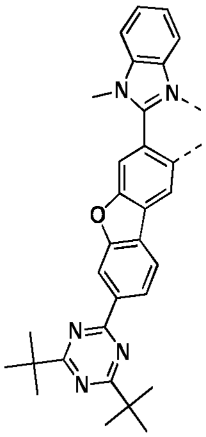

$L_{A209}$ ,

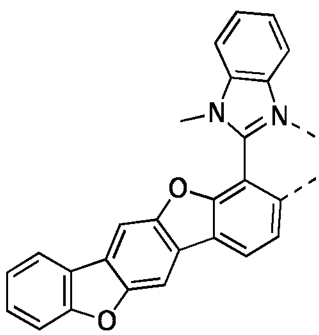

$L_{A210}$ ,

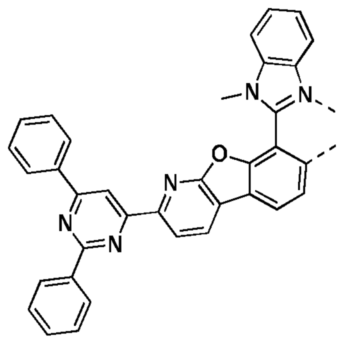

$L_{A211}$ ,

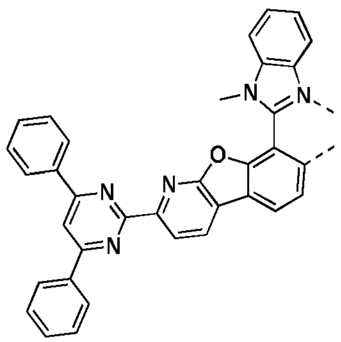

$L_{A212}$ ,

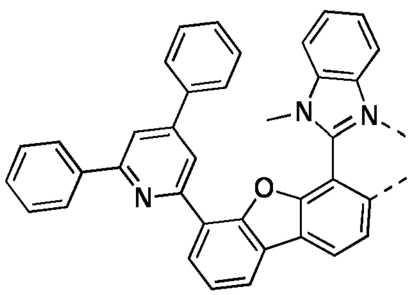

$L_{A213}$ ,

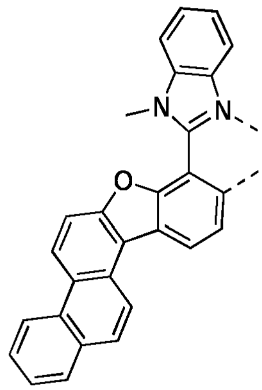

$L_{A214}$ ,

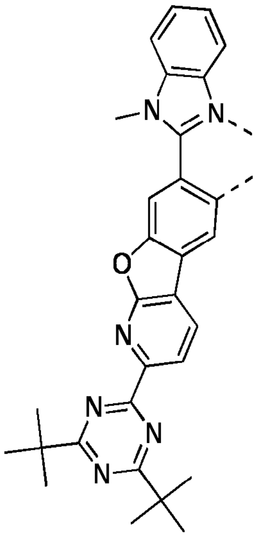
$L_{A215}$ ,
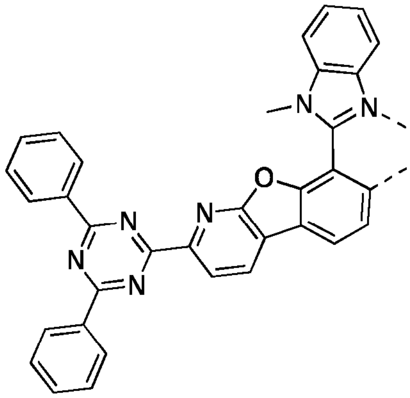
$L_{A216}$ ,
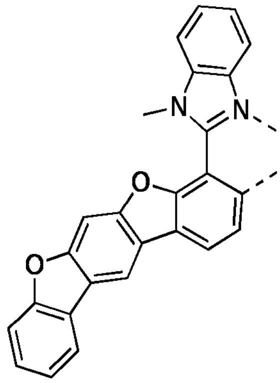
$L_{A217}$ ,

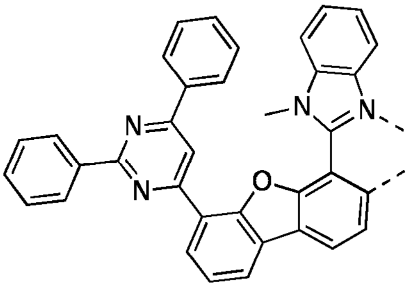
$L_{A218}$ ,
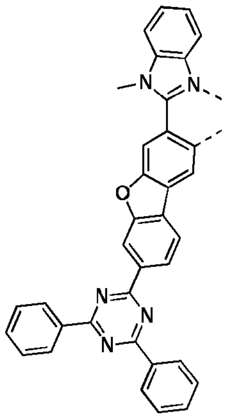
$L_{A219}$ ,
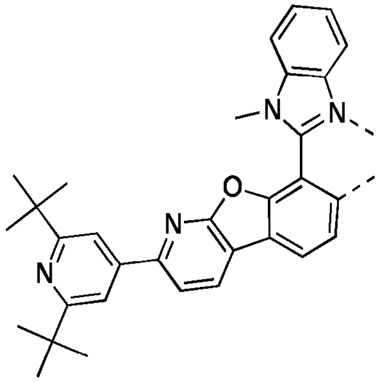
$L_{A220}$ ,

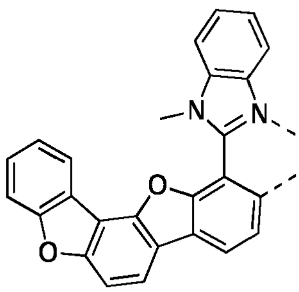
$L_{A221}$ ,
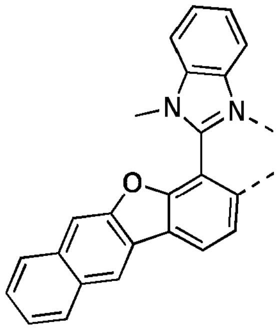
$L_{A222}$ ,
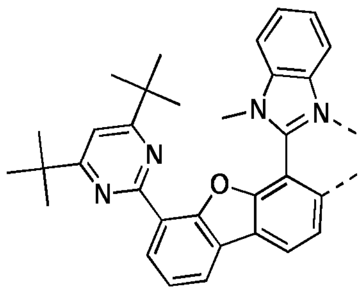
$L_{A223}$ ,

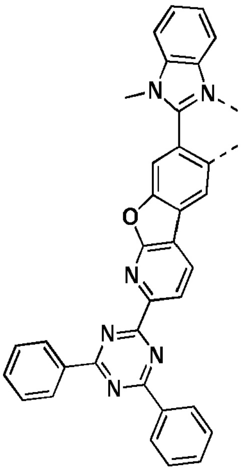
$L_{A224}$ ,

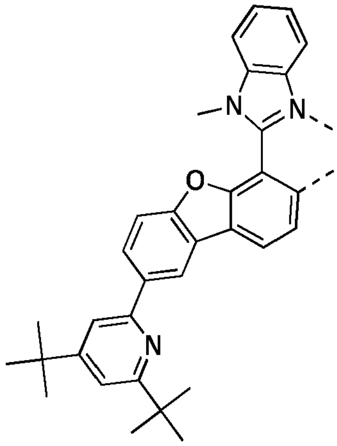
$L_{A225}$ ,

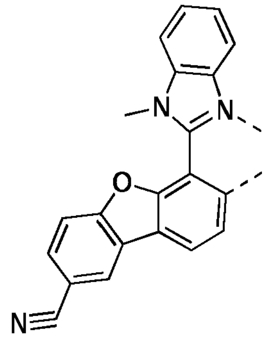
$L_{A226}$ ,

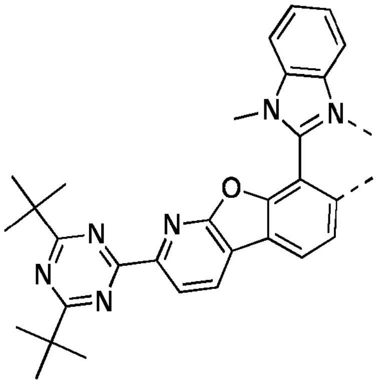
$L_{A227}$ ,

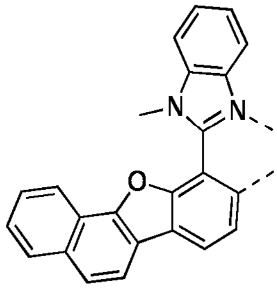
$L_{A228}$ ,

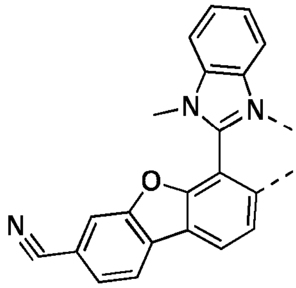
$L_{A229}$ ,

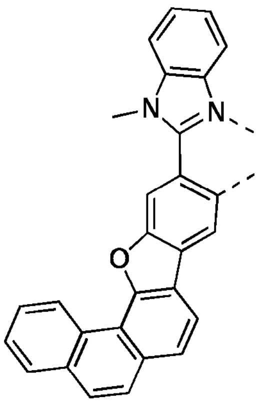
$L_{A230}$ ,

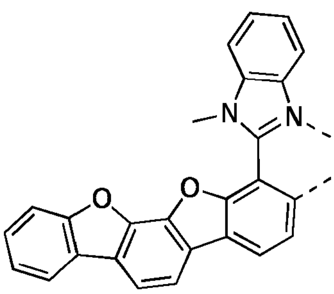
$L_{A231}$ ,

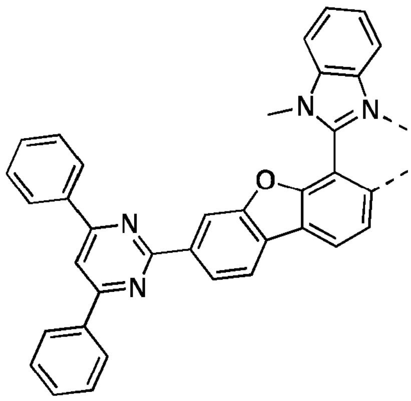
$L_{A232}$ ,

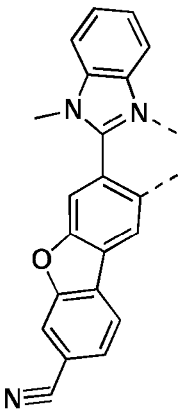
$L_{A233}$ ,
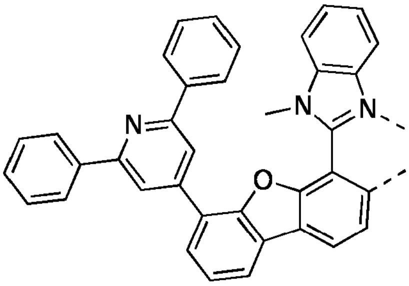
$L_{A234}$ ,
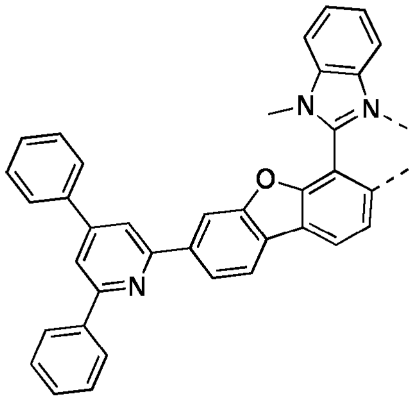
$L_{A235}$ ,

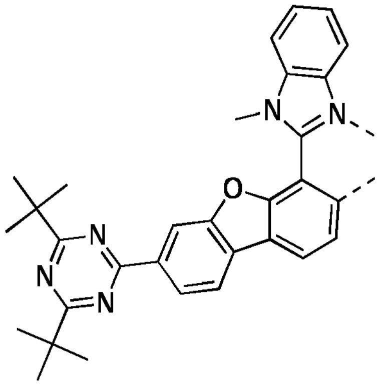
$L_{A236}$ ,
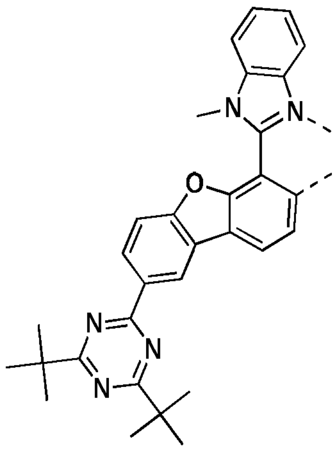
$L_{A237}$ ,
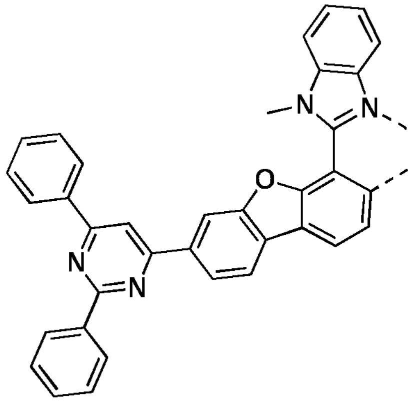
$L_{A238}$ ,

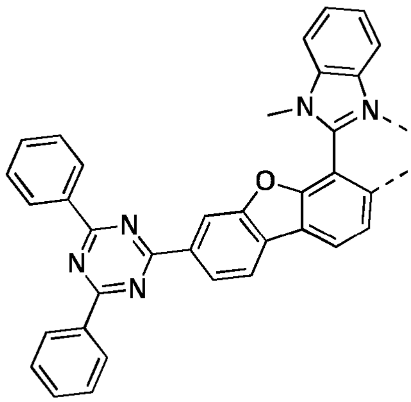
$L_{A239}$ ,
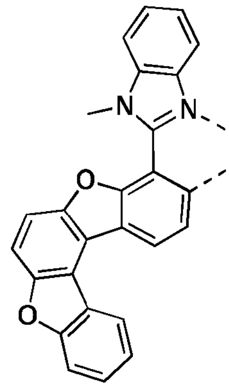
$L_{A240}$ ,
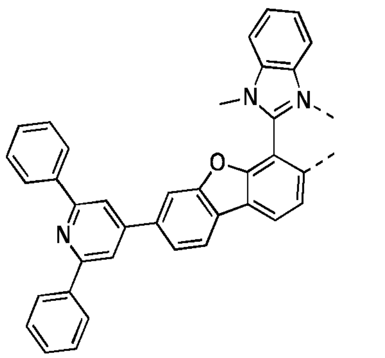
$L_{A241}$ ,

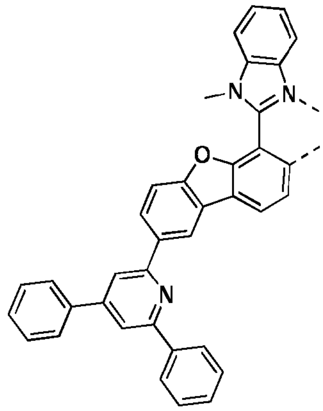

$L_{A242}$ ,

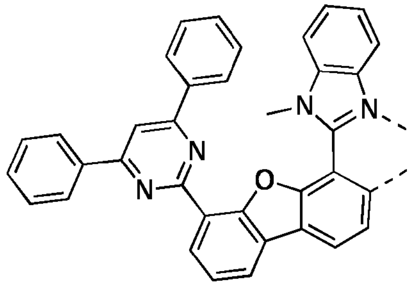

$L_{A243}$ ,

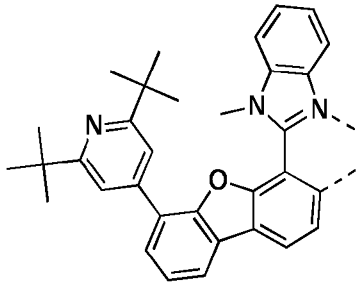

$L_{A244}$ ,

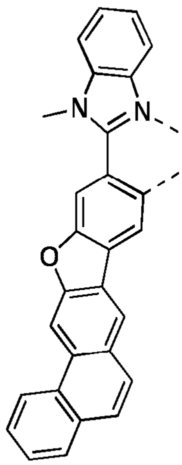

$L_{A245}$ ,

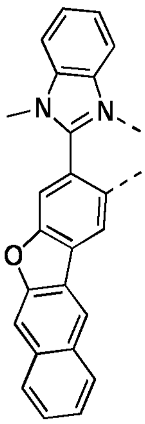

$L_{A246}$ ,

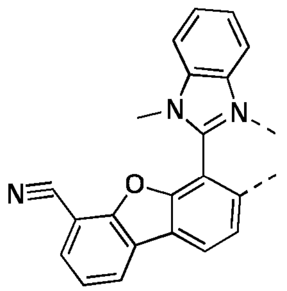

$L_{A247}$ ,

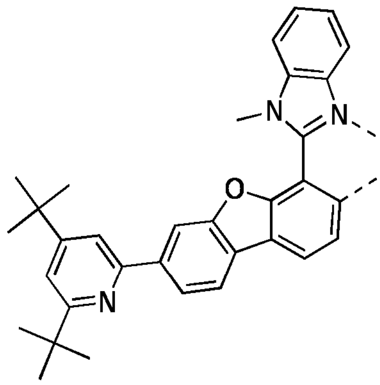

$L_{A248}$ ,

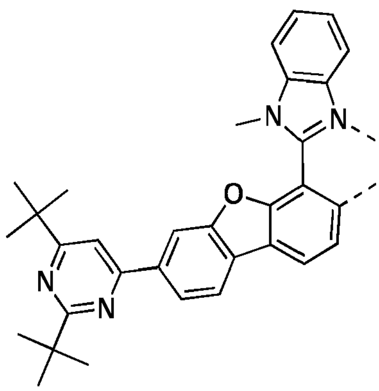

$L_{A249}$ ,

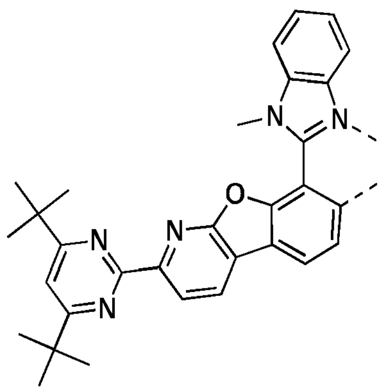

$L_{A250}$ ,

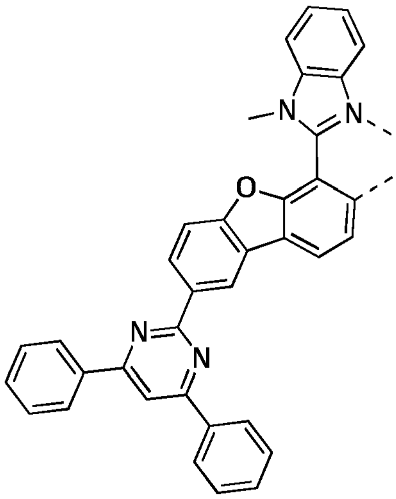

$L_{A251}$

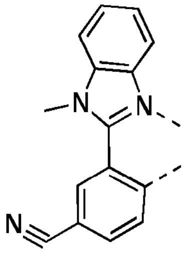
, LA252
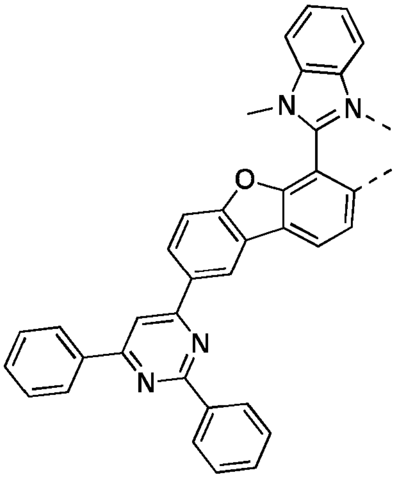
, LA253
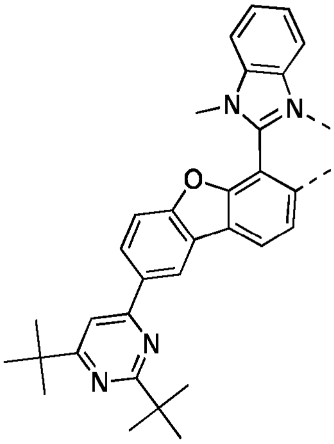
, LA254
,

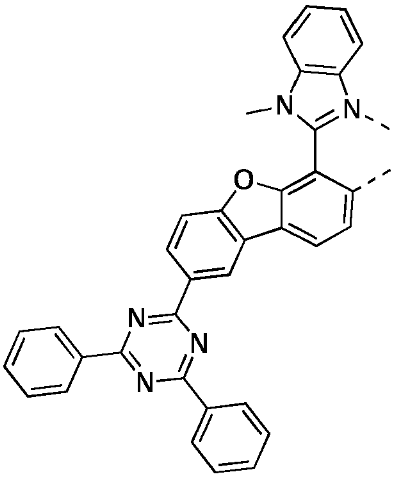
LA255
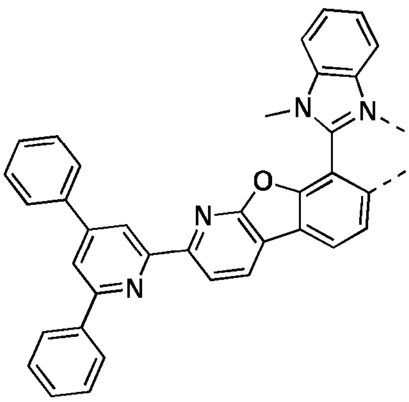
, LA256
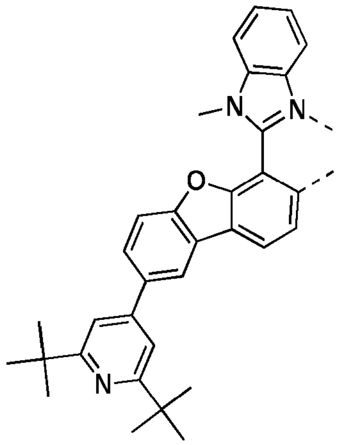
, LA257

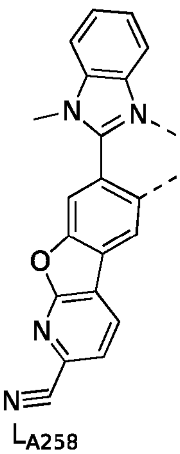
, LA258
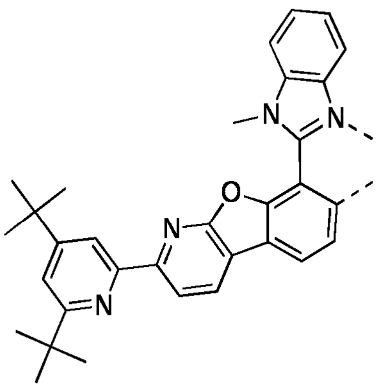
, LA259
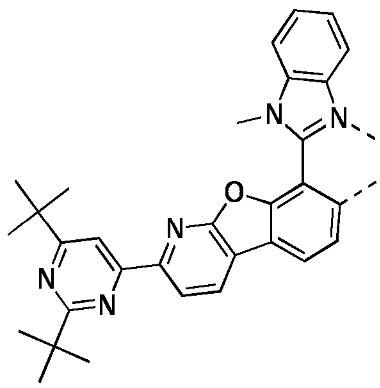
, LA260
,

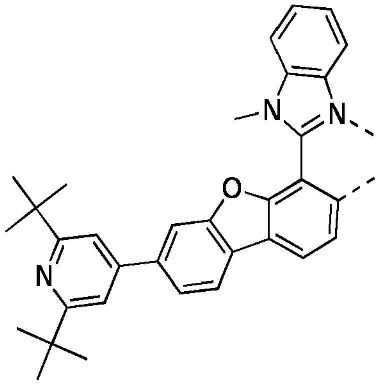

$L_{A261}$ ,

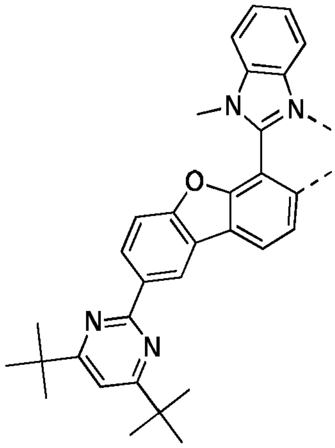

$L_{A262}$ ,

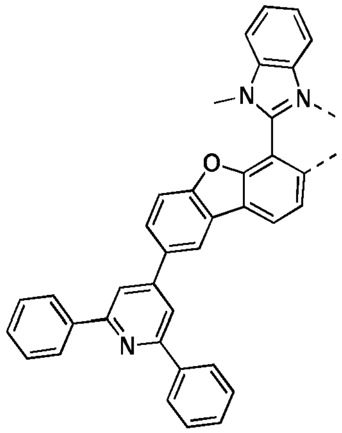

$L_{A263}$ ,

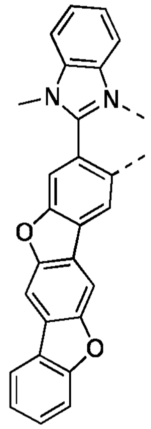

$L_{A264}$ ,

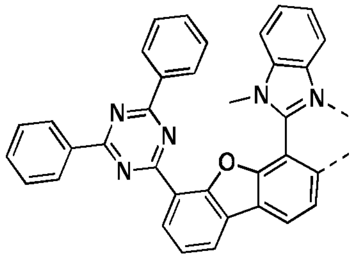

$L_{A265}$ ,

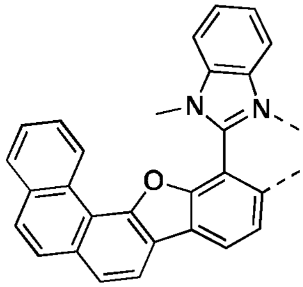

$L_{A266}$ ,

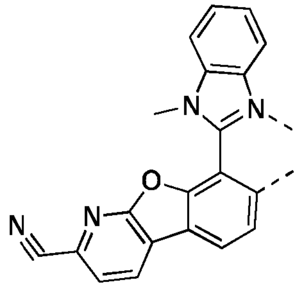

$L_{A267}$ ,

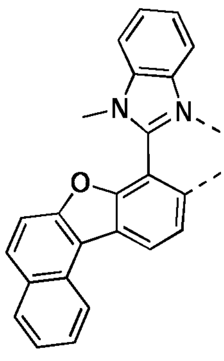

$L_{A268}$ ,

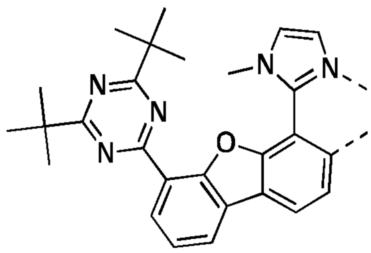

$L_{A269}$ ,

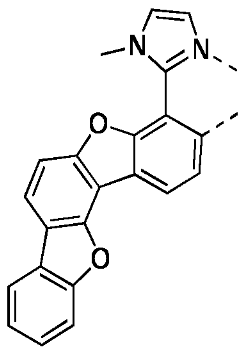

$L_{A270}$ ,

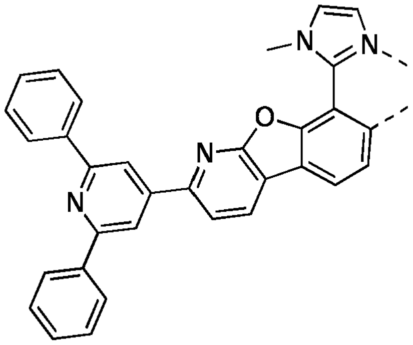

$L_{A271}$,

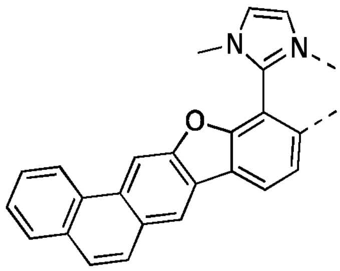

$L_{A272}$,

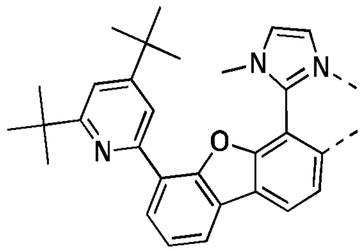

$L_{A273}$,

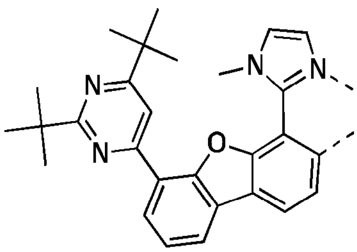

$L_{A274}$,

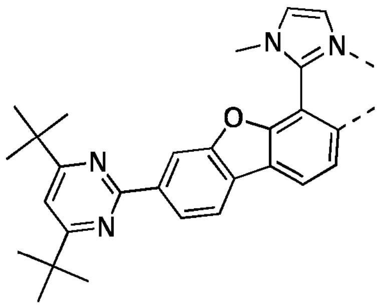

$L_{A275}$,

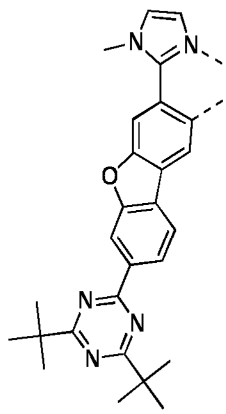

$L_{A276}$,

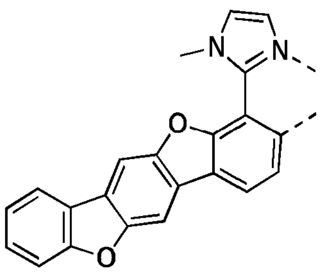

$L_{A277}$,

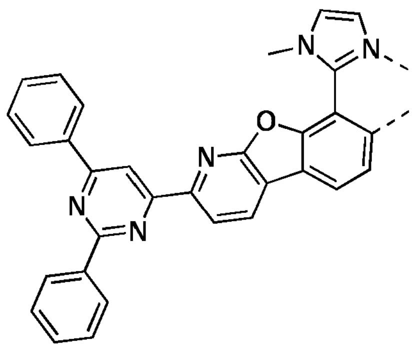

$L_{A278}$,

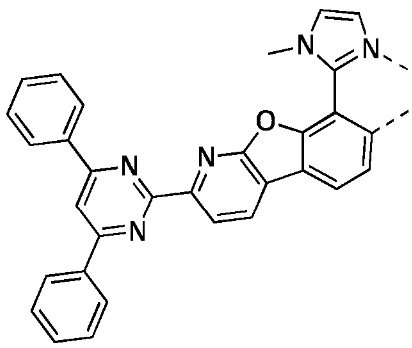

$L_{A279}$

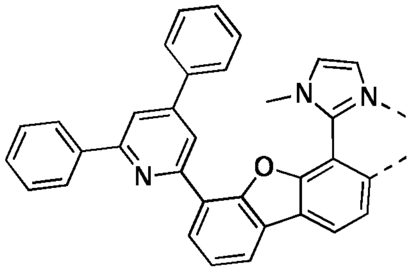

, $L_{A280}$

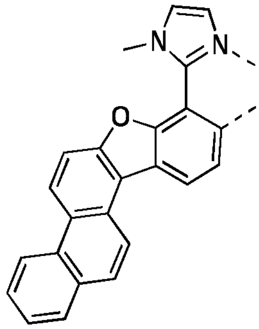

, $L_{A281}$

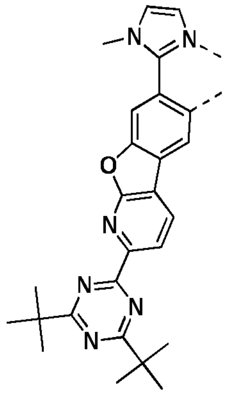

, $L_{A282}$ ,

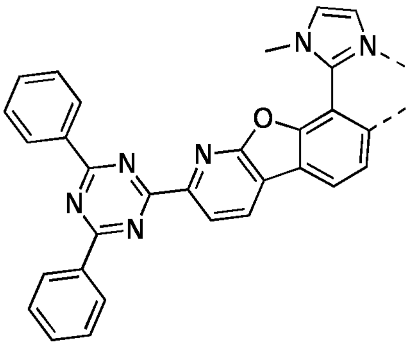

$L_{A283}$

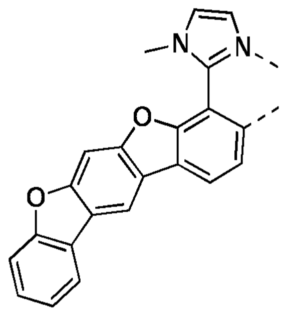

, $L_{A284}$

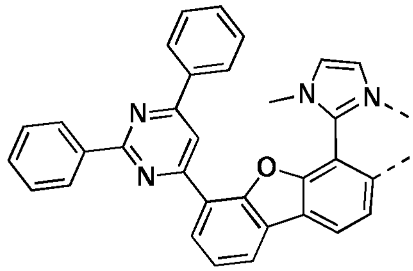

, $L_{A285}$ ,

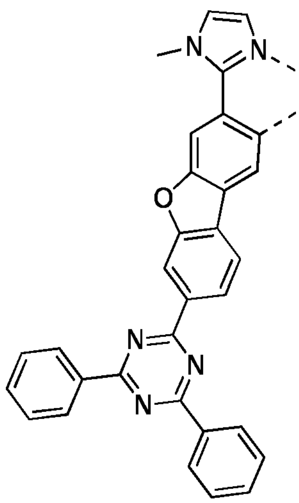

$L_{A286}$

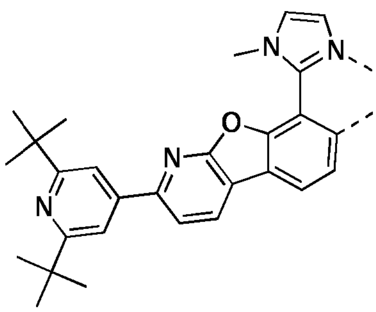

, $L_{A287}$

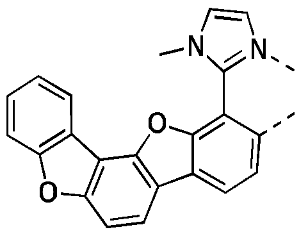

, $L_{A288}$ ,

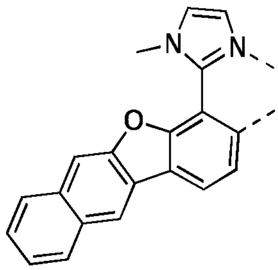

$L_{A289}$ ,

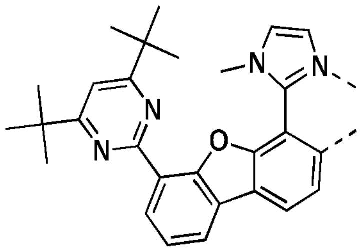

$L_{A290}$ ,

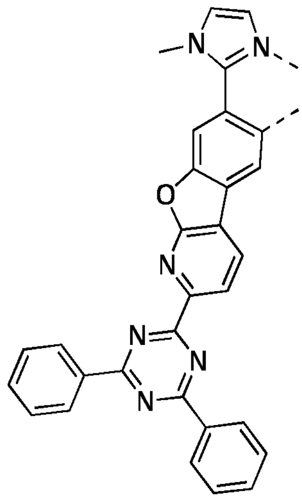

$L_{A291}$ ,

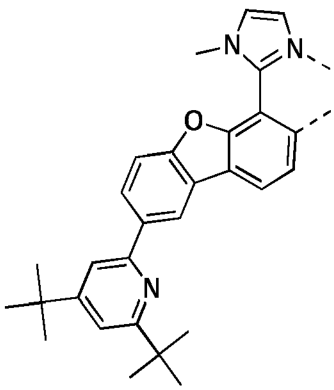

$L_{A292}$ ,

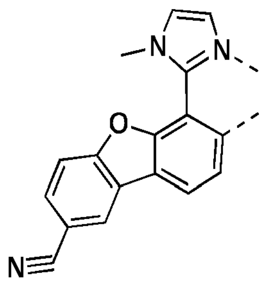

$L_{A293}$ ,

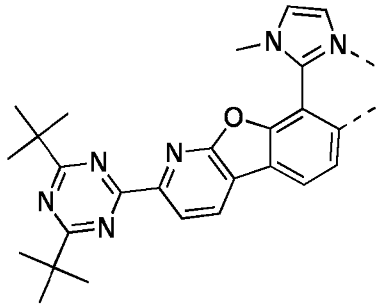

$L_{A294}$ ,

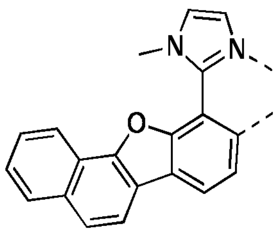

$L_{A295}$ ,

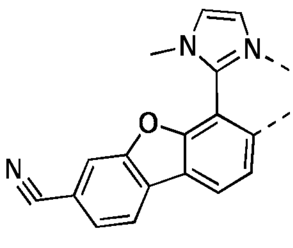

$L_{A296}$ ,

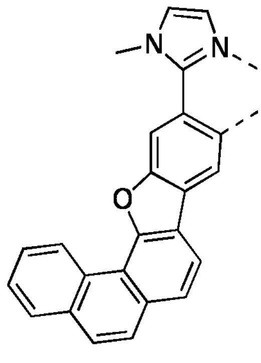

$L_{A297}$ ,

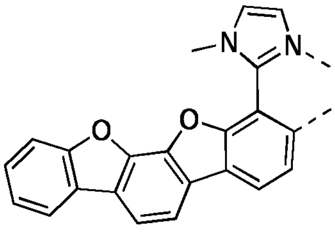

$L_{A298}$ ,

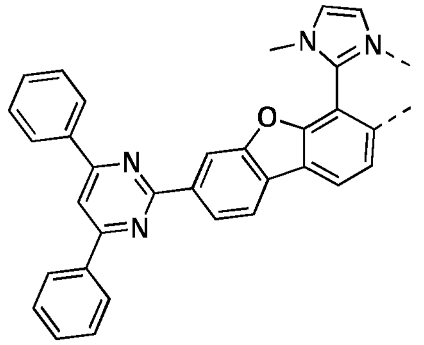

$L_{A299}$ ,

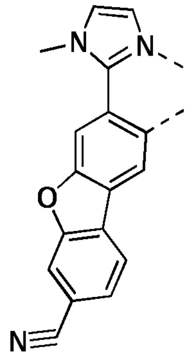

$L_{A300}$ ,

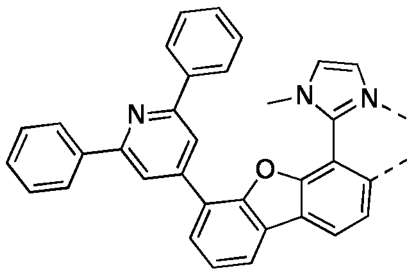

$L_{A301}$ ,

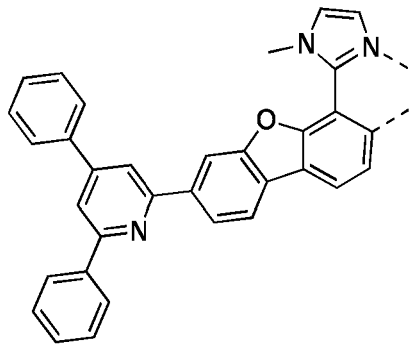

$L_{A302}$ ,

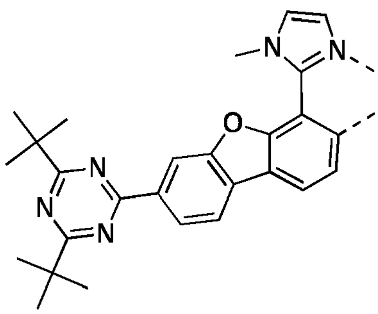

$L_{A303}$ ,

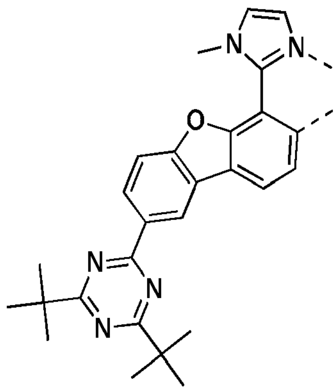

$L_{A304}$ ,

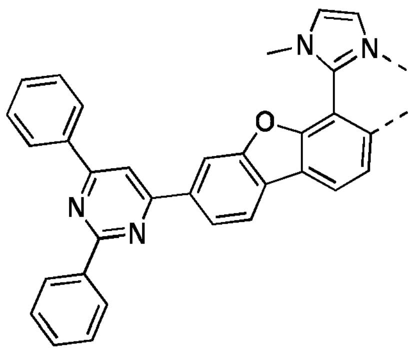

$L_{A305}$ ,

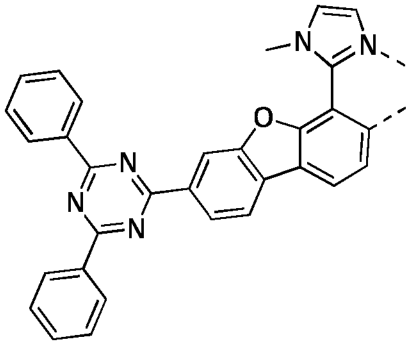

$L_{A306}$ ,

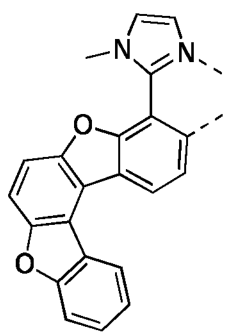

$L_{A307}$ ,

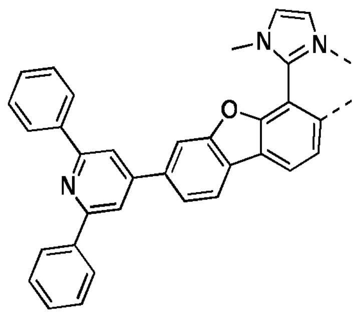

$L_{A308}$ ,

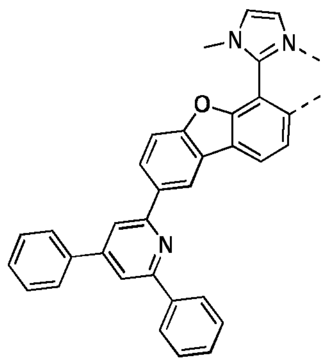
$L_{A309}$ ,
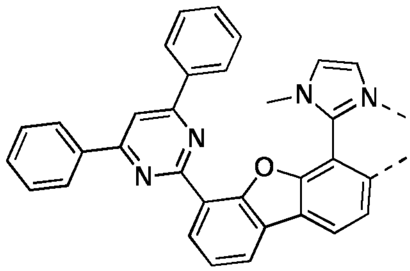
$L_{A310}$ ,
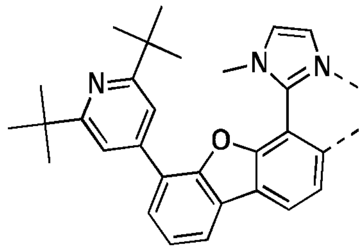
$L_{A311}$ ,

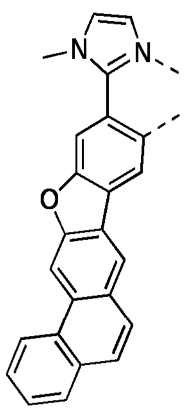
$L_{A312}$ ,
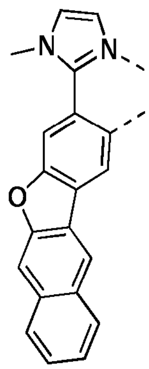
$L_{A313}$ ,
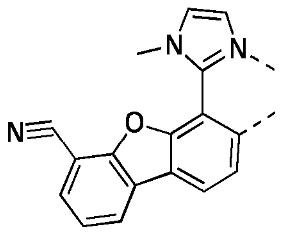
$L_{A314}$ ,
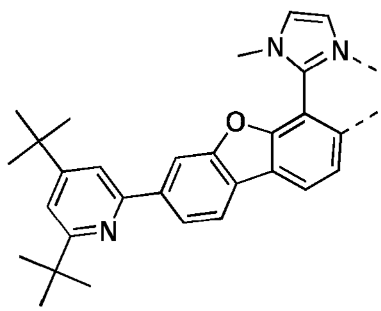
$L_{A315}$ ,

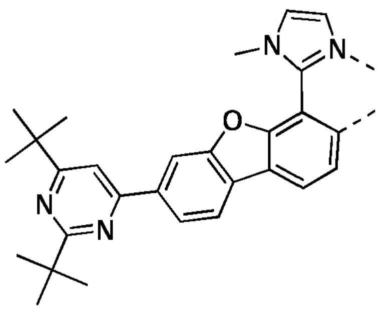
$L_{A316}$ ,
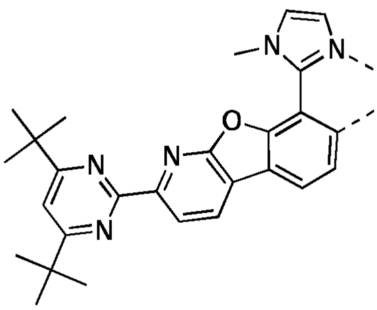
$L_{A317}$ ,
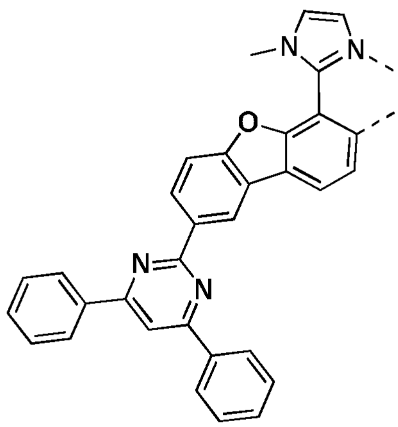
$L_{A318}$

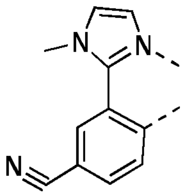

$L_{A319}$ ,

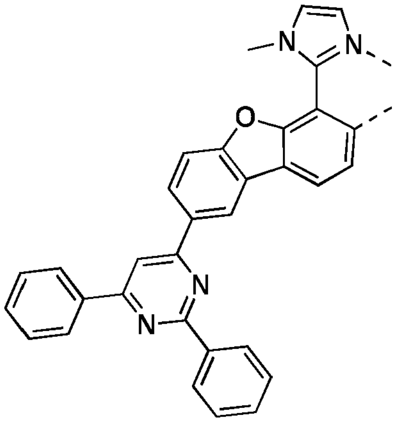

$L_{A320}$ ,

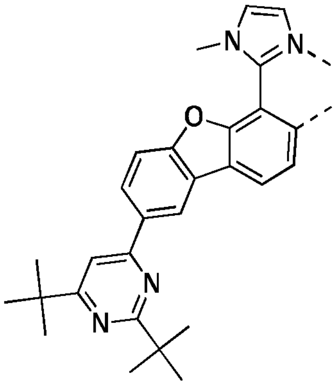

$L_{A321}$ ,

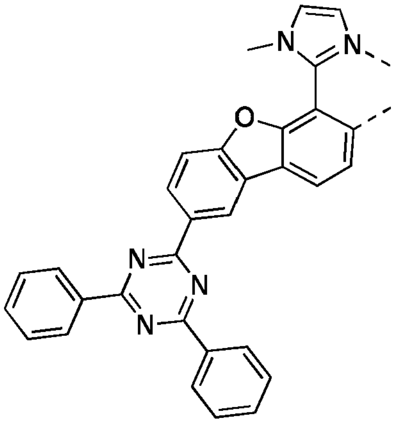

$L_{A322}$

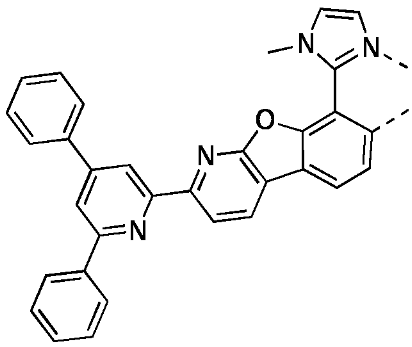

$L_{A323}$ ,

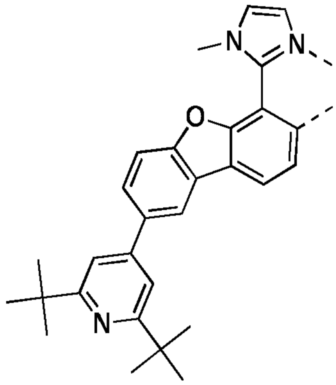

$L_{A324}$ ,

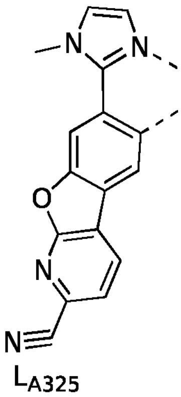

$L_{A325}$ ,

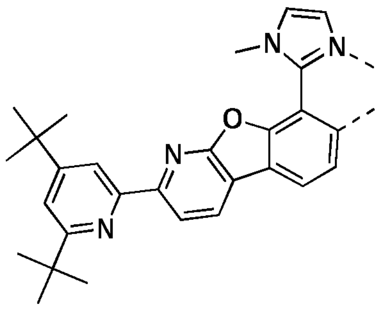

$L_{A326}$ ,

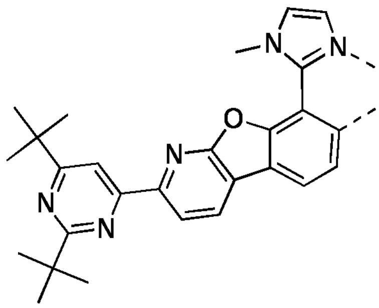

$L_{A327}$ ,

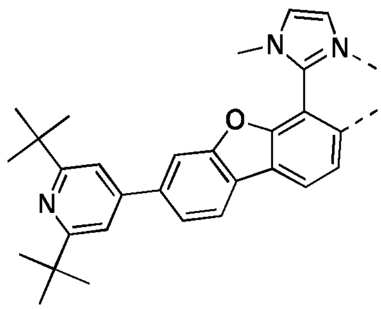

$L_{A328}$ ,

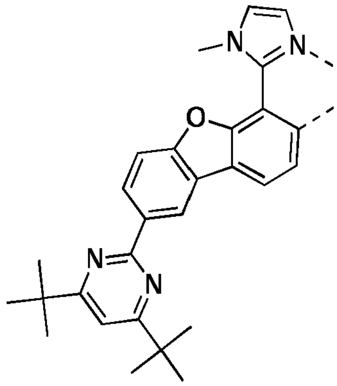

$L_{A329}$ ,

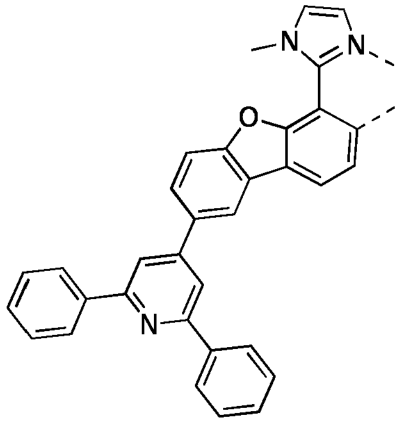

$L_{A330}$ ,

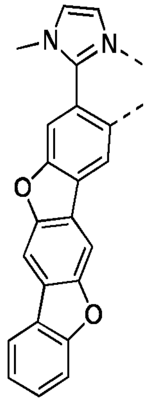

$L_{A331}$ ,

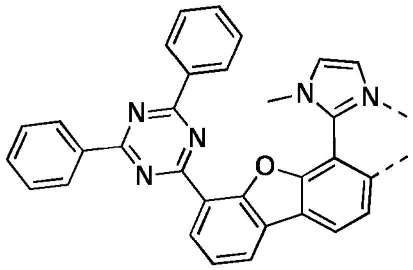

$L_{A332}$ ,

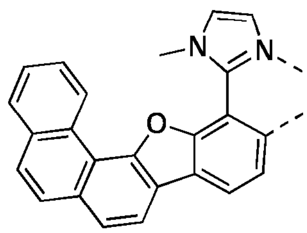

$L_{A333}$ ,

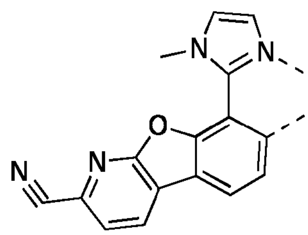

$L_{A334}$ , and

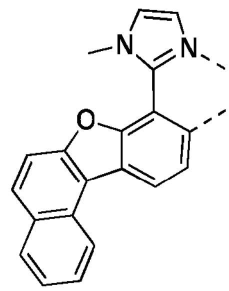

$L_{A335}$ .

In some embodiments of the compound having the formula of $M(L_A)_p(L_B)_q(L_C)_r$ $L_B$ is a substituted or unsubstituted phenylpyridine, and $L_C$ is a substituted or unsubstituted acetylacetonate.

In some embodiments of the compound having the formula of $M(L_A)_p(L_B)_q(L_C)_r$, wherein $L_B$ and $L_C$ are each independently selected from the group consisting of:

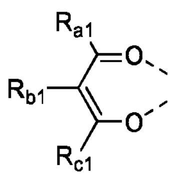

,

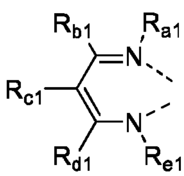

,

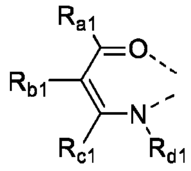,
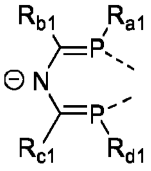,
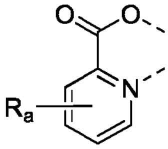,
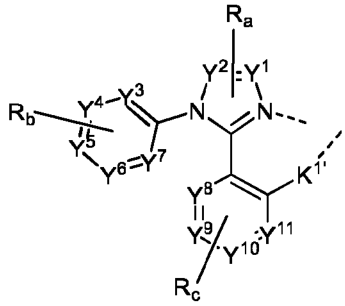,

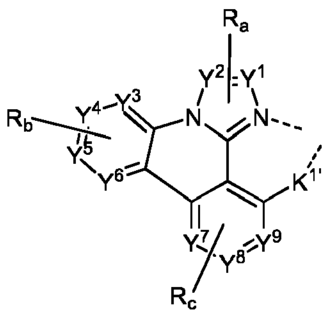,
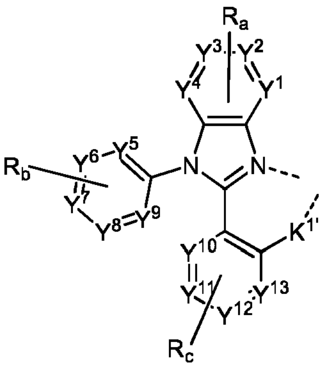,
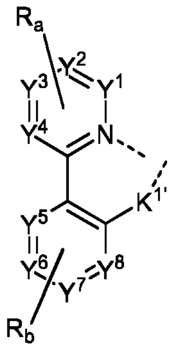,
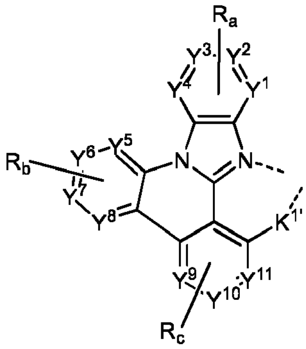,

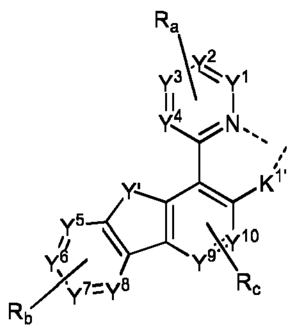,
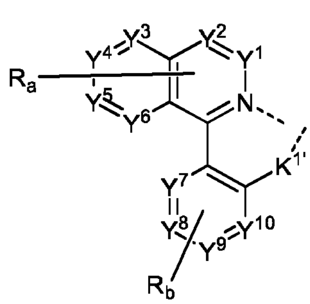,
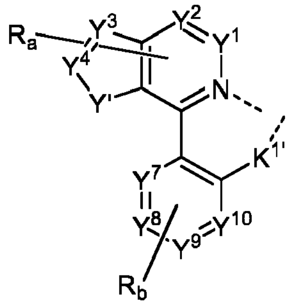,

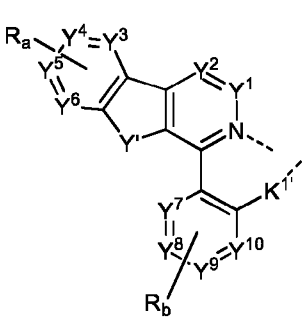,
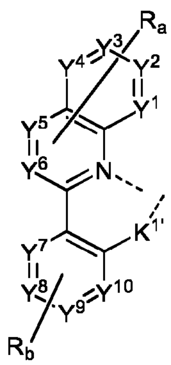,
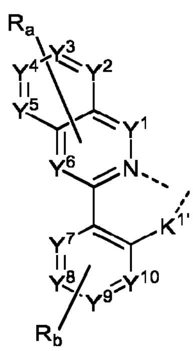,
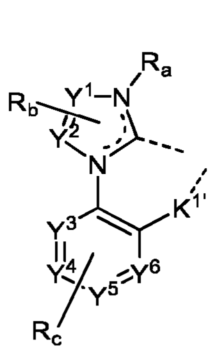,
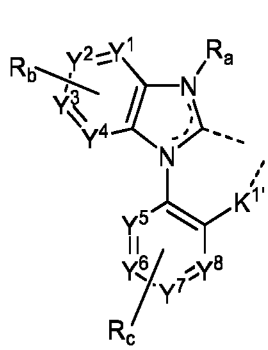

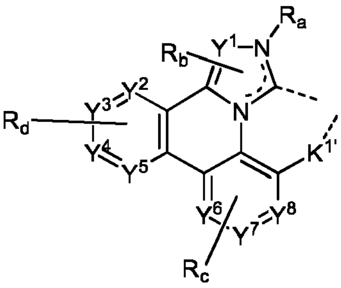
,
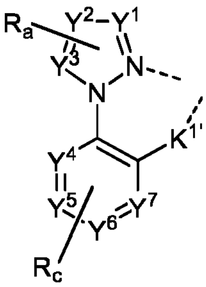
,
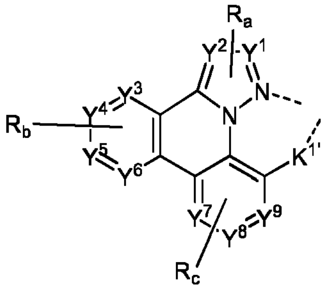
,

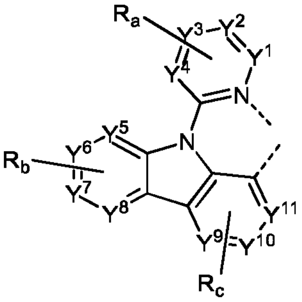
,
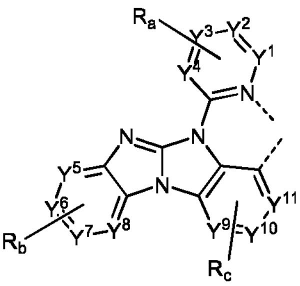
,
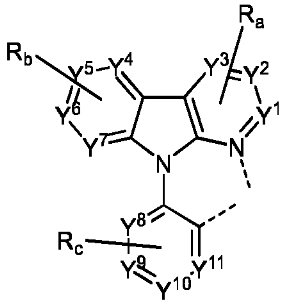
,

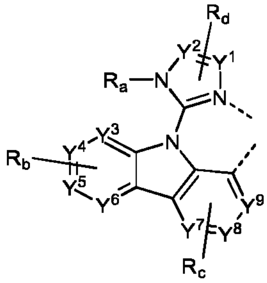
,
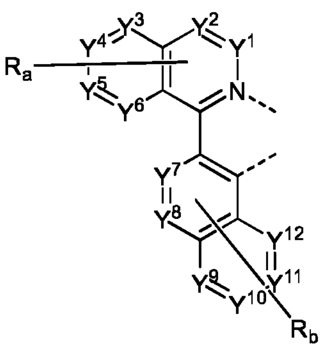
,
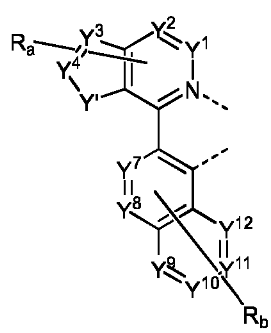
,
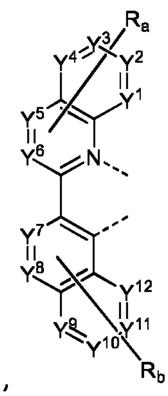
,

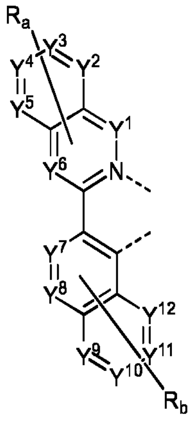
,
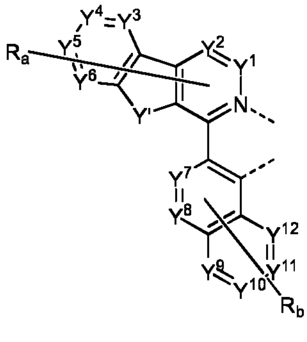
,
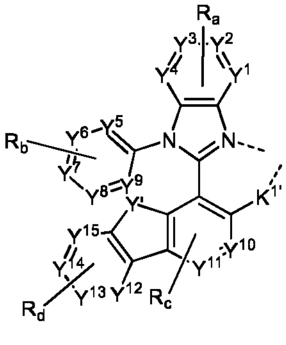
,
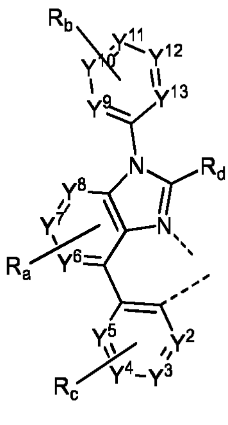
,

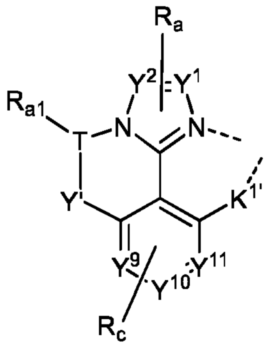, 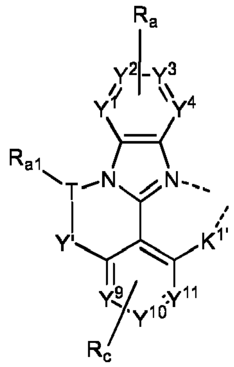, 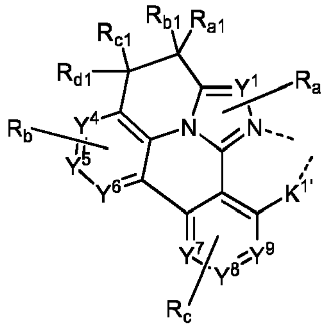, 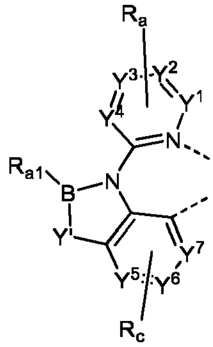,

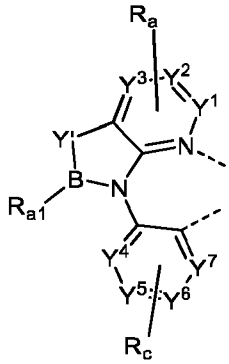, 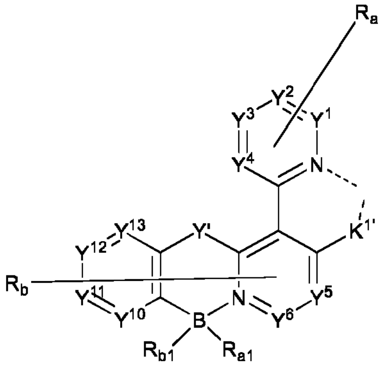, and 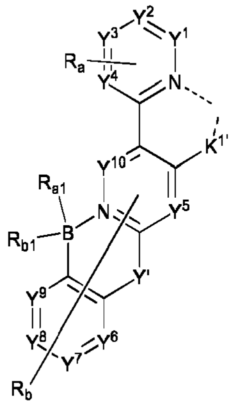,

wherein:

T is selected from the group consisting of B, Al, Ga, and In;

$K^{1'}$ is selected from the group consisting of a single bond, O, S, $NR_e$, $PR_e$, $BR_e$, $CR_eR_f$, and $SiR_eR_f$;

each of $Y^1$ to $Y^{13}$ is independently selected from the group consisting of C and N;

Y' is selected from the group consisting of $BR_e$, $BR_eR_f$, $NR_e$, $PR_e$, $P(O)R_e$, O, S, Se, C=O, C=S, C=Se, $C=NR_e$, $C=CR_eR_f$, S=O, $SO_2$, $CR_eR_f$, $SiR_eR_f$, and $GeR_eR_f$;

$R_e$ and $R_f$ can be fused or joined to form a ring;

each $R_a$, $R_b$, $R_c$, and $R_d$ independently represents from mono to the maximum allowed number of substitutions, or no substitution;

each of $R_{a1}$, $R_{b1}$, $R_{c1}$, $R_{d1}$, $R_{e1}$, $R_a$, $R_b$, $R_c$, $R_d$, $R_e$, and $R_f$ is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and any two substituents of $R_{a1}$, $R_{b1}$, $R_{c1}$, $R_{d1}$, $R_a$, $R_b$, $R_c$, and $R_d$ can be fused or joined to form a ring or form a multidentate ligand.

In some embodiments of the compound having the formula of $M(L_A)_p(L_B)_q(L_C)_r$, $L_B$ and $L_C$ are each independently selected from the group consisting of:

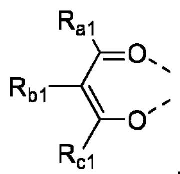, 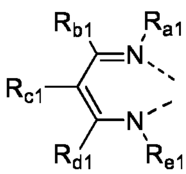,

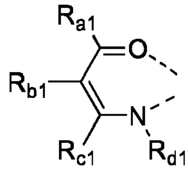, 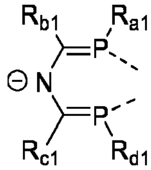, 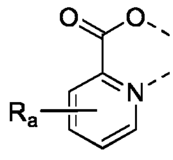, 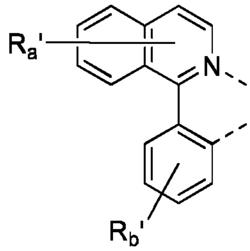, 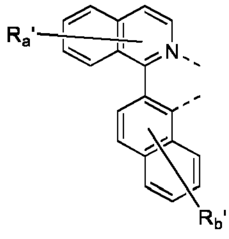,

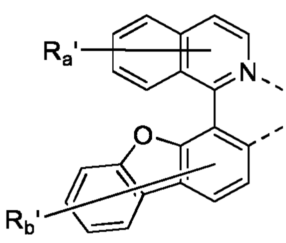, 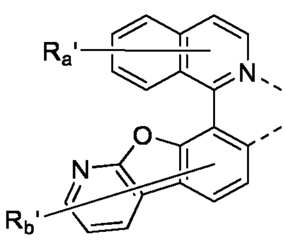, 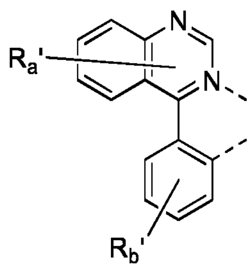, 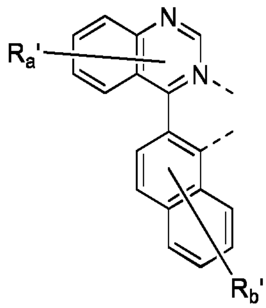,

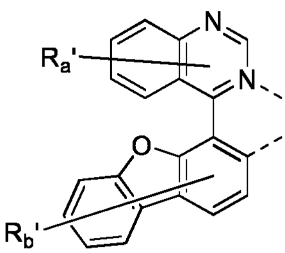, 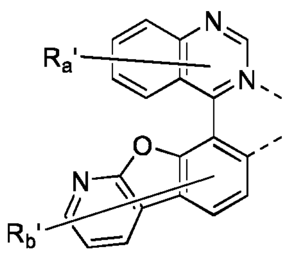, 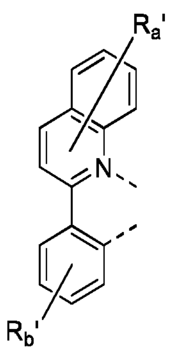, 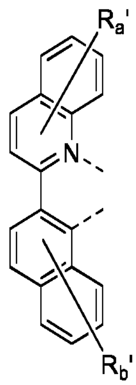,

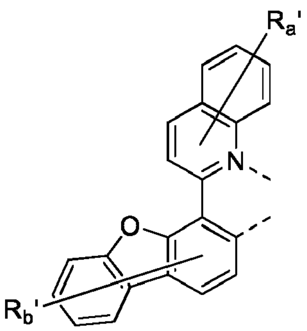, 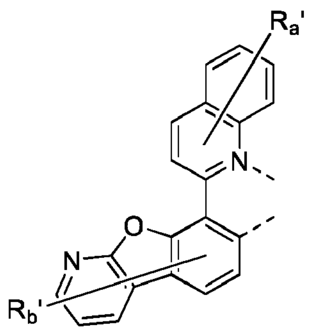, 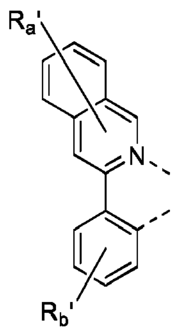, 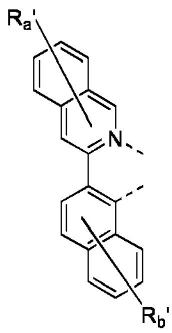,

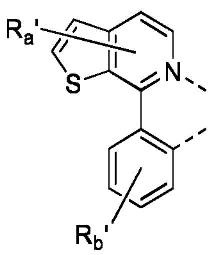, 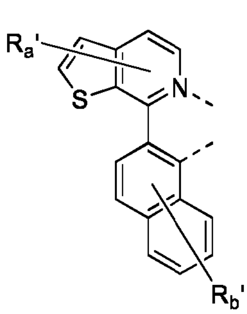, 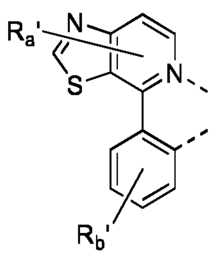, 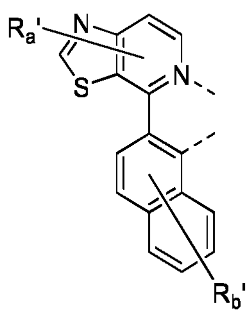, 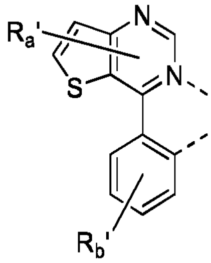,

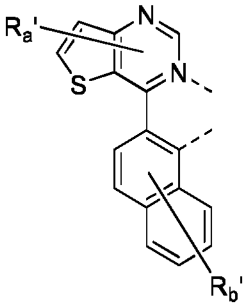, 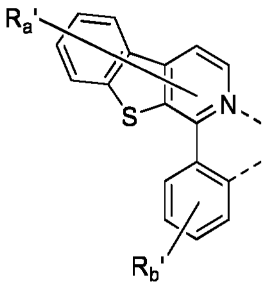, 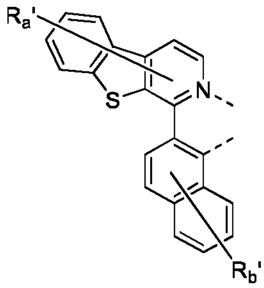, 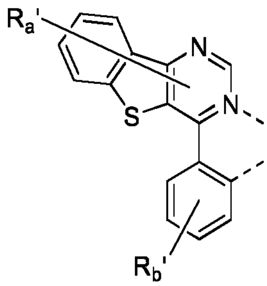,

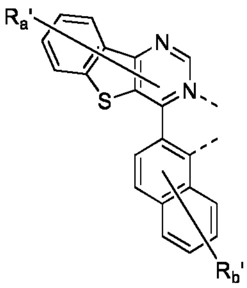, 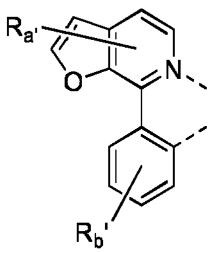, 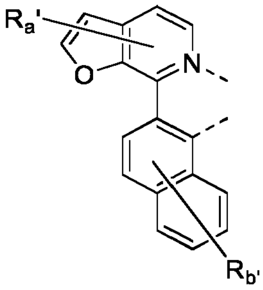, 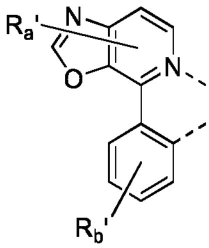,

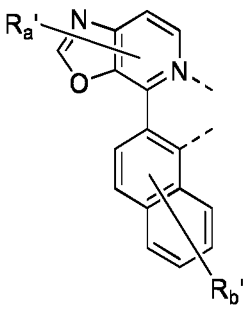, 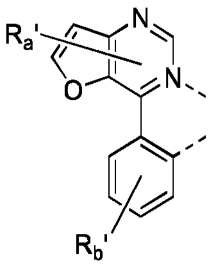, 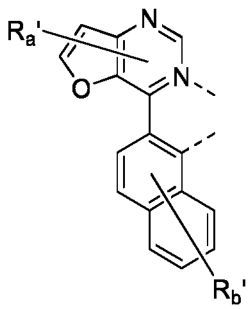, 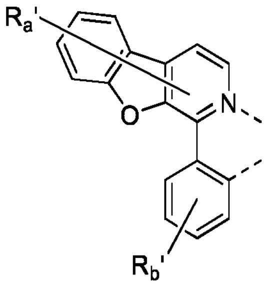,

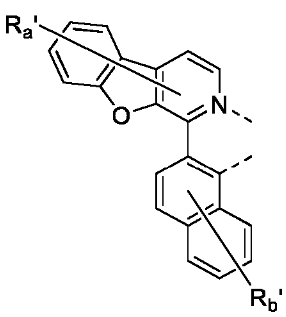, 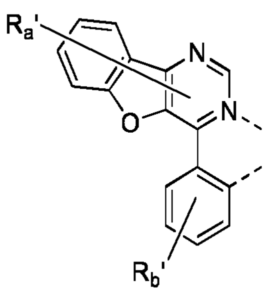, 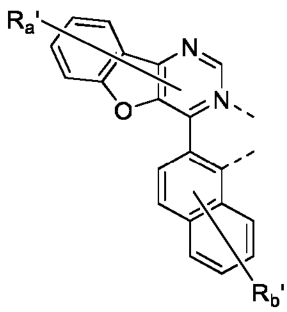, 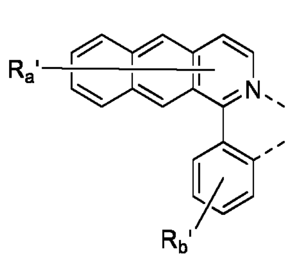,

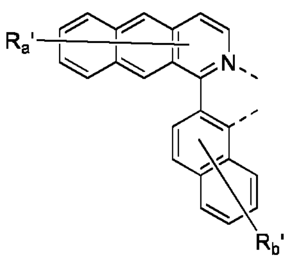, 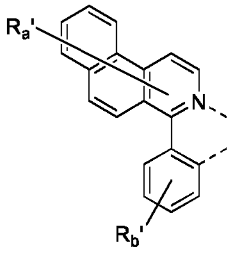, 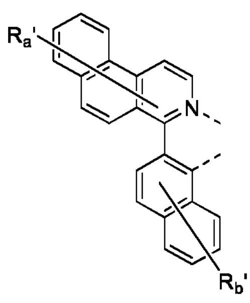, 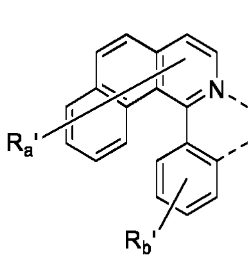,

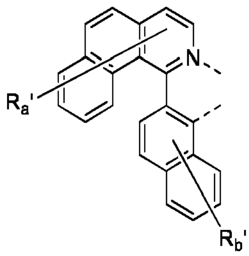,
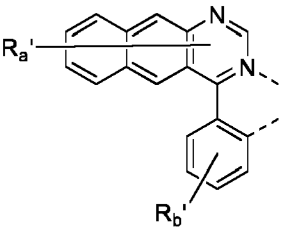,
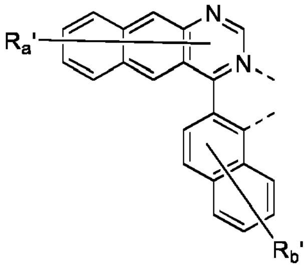,
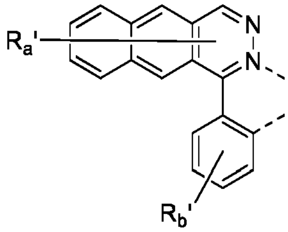,

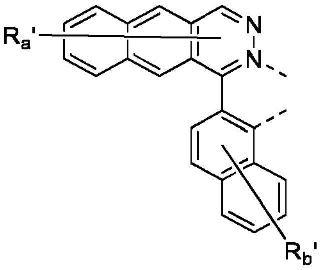,
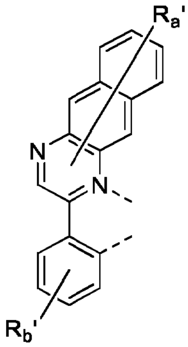,
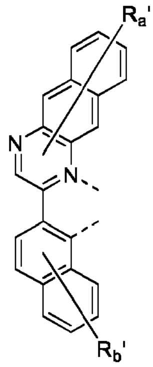,
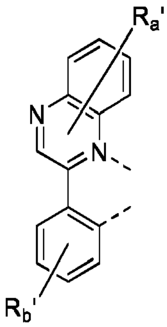,
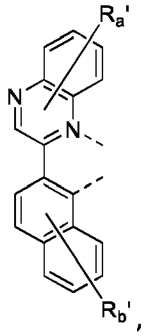,

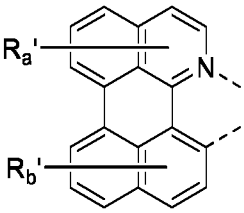,
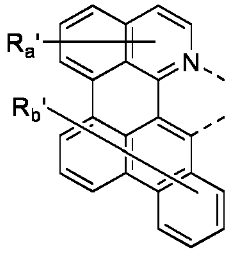,
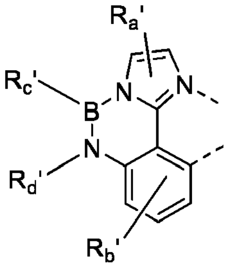,
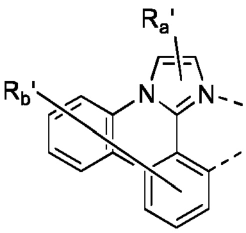,

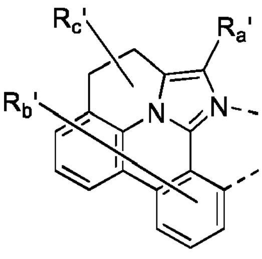,
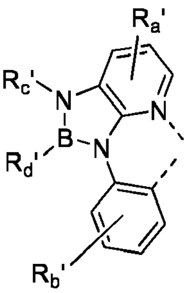,
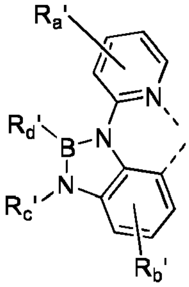,
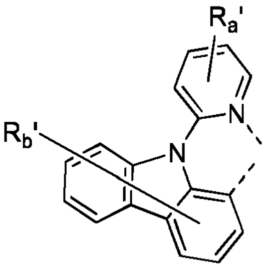,
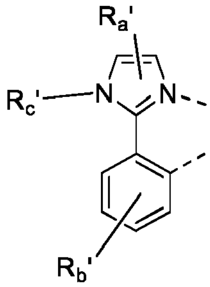,

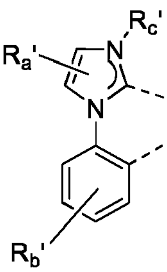,
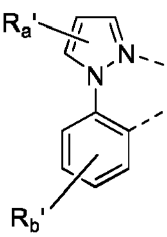,
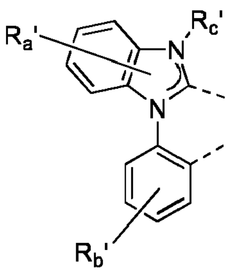,
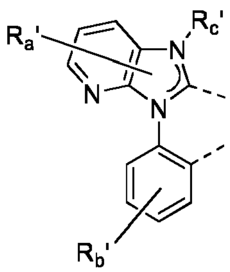,
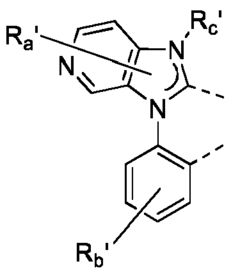,

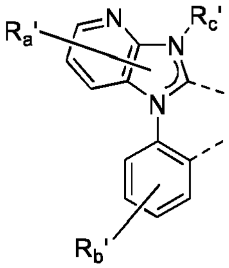,
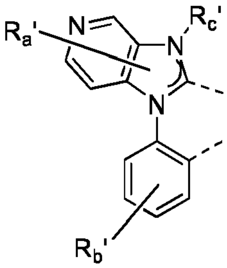,
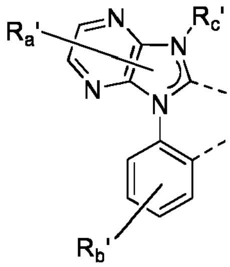,
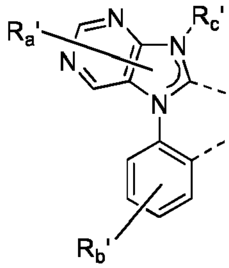,
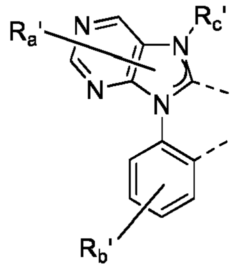

, 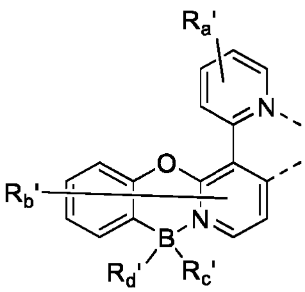, 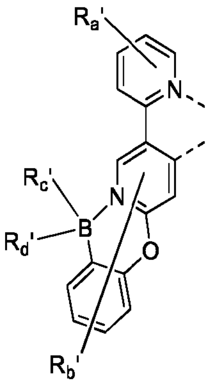, 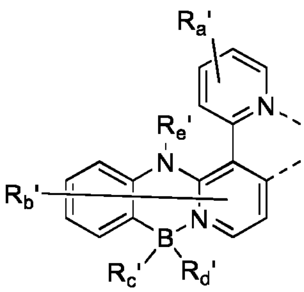, 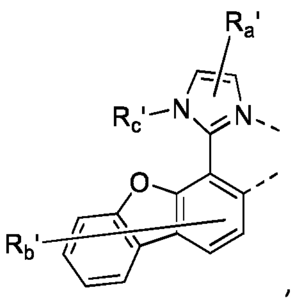,

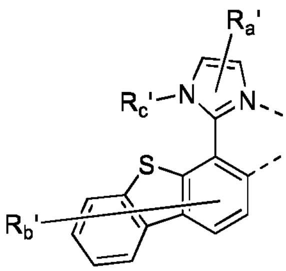, 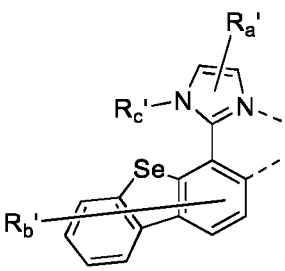, 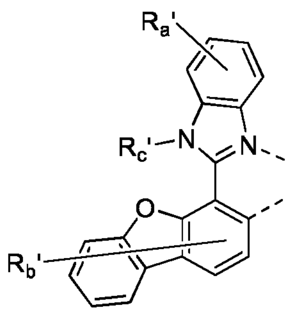,

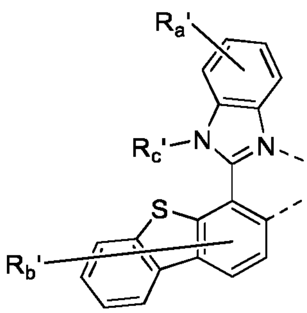, 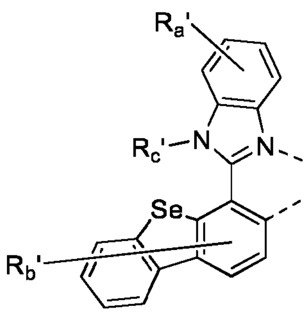, 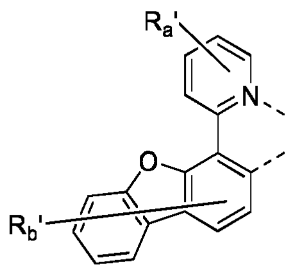,

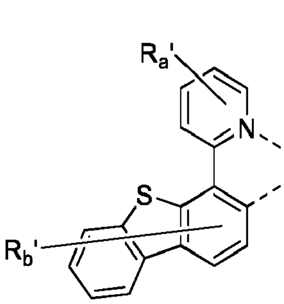, 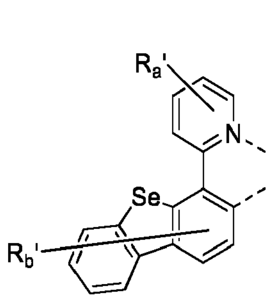, 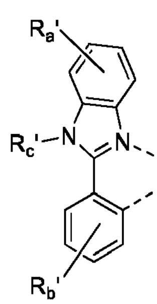, 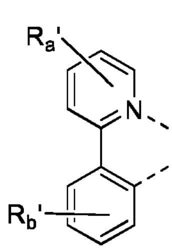,

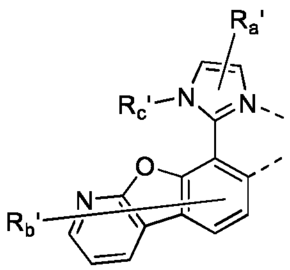,
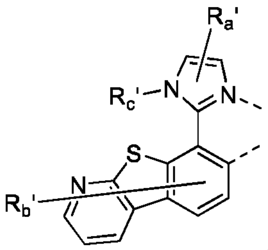,
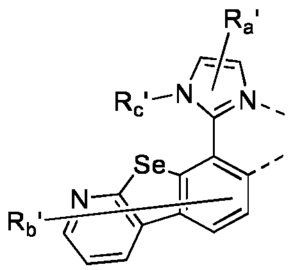,
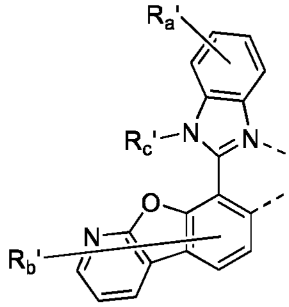,

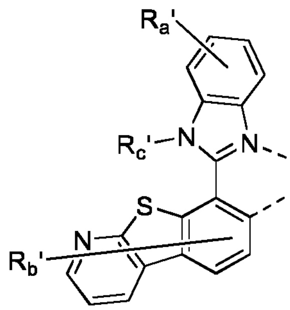,
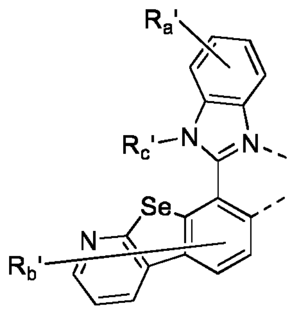,
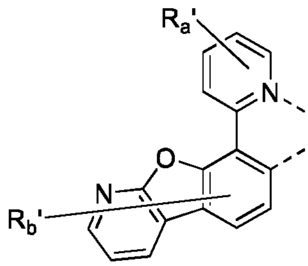,

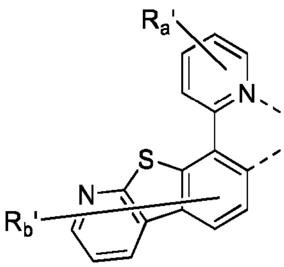,
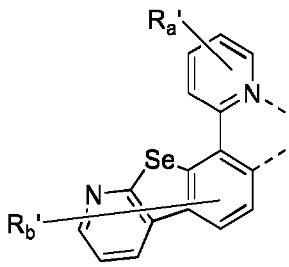,
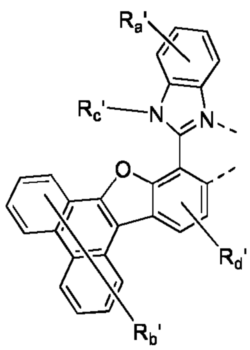,
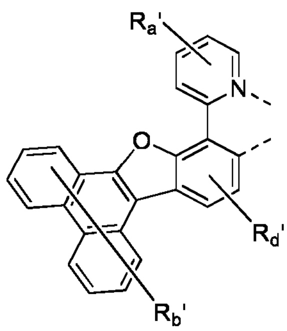,

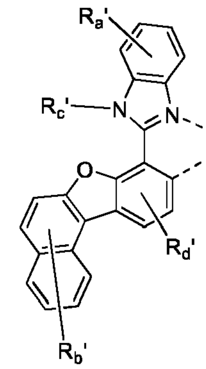,
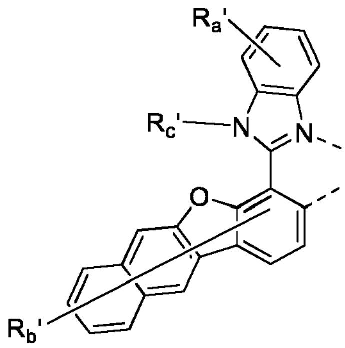,
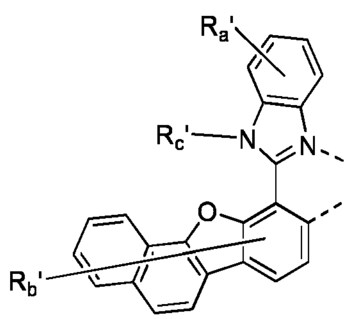,
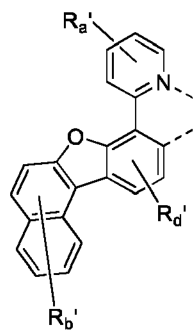,

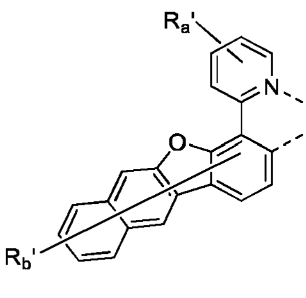,
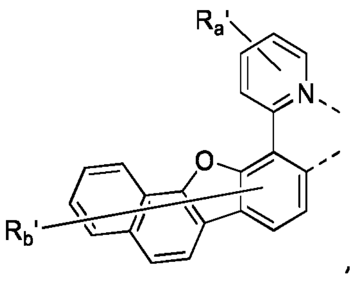,
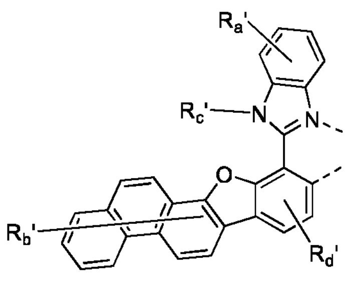,

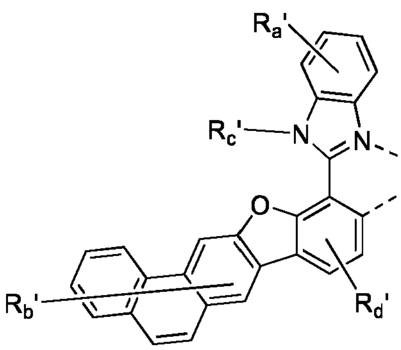,
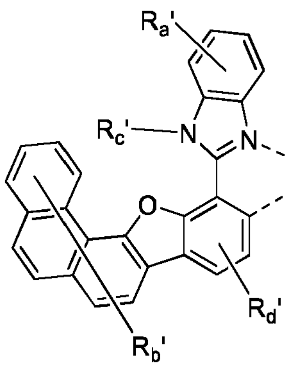,
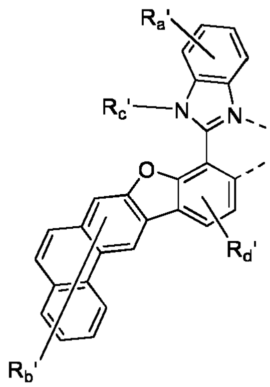,
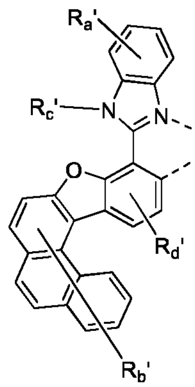,

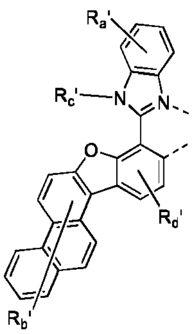,
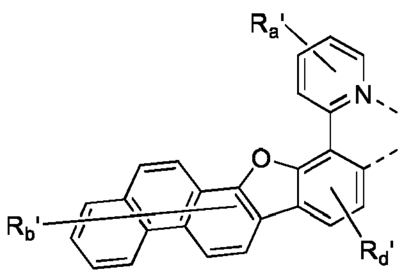,
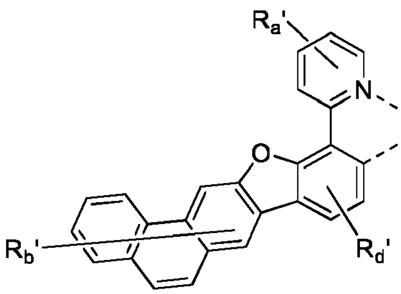,

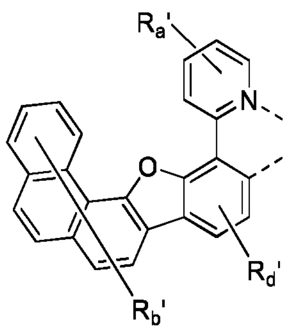,
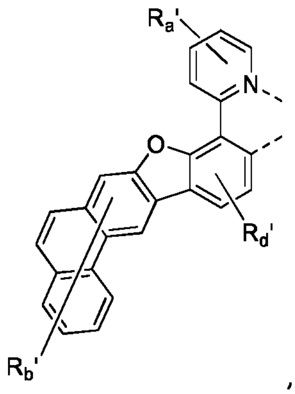,
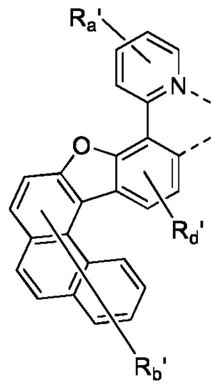,
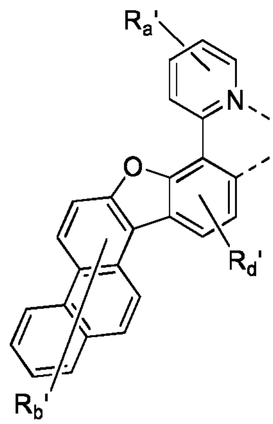,

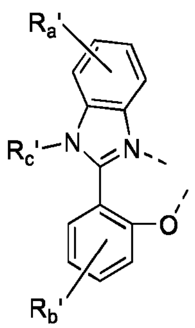,
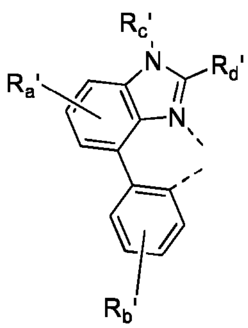,
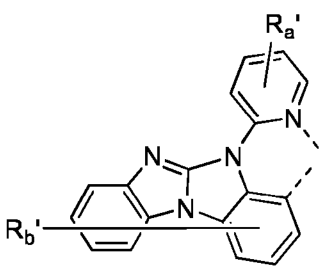, and
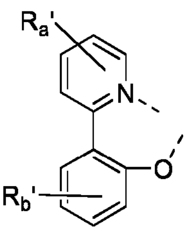,

wherein:

$R_a$', $R_b$', $R_c$', $R_d$', and $R_e$' each independently represents zero, mono, or up to a maximum allowed number of substitution to its associated ring;

$R_a$', $R_b$', $R_c$', $R_d$', and $R_e$' each independently hydrogen or a substituent selected from the group consisting of

deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and

two substituents of $R_a$', $R_b$', $R_c$', $R_d$', and $R_e$' can be fused or joined to form a ring or to form a multidentate ligand.

In some embodiments of the compound having the formula of $M(L_A)_p(L_B)_q(L_C)_r$, wherein $L_A$ is selected from $L_{Ai}$, wherein *i* is an integer from 1 to 335; and $L_B$ is selected from $L_{Bk}$, wherein *k* is an integer from 1 to 836, wherein:

when the compound has formula $Ir(L_{Ai})_3$, the compound is selected from the group consisting of $Ir(L_{A1})_3$ to $Ir(L_{A335})_3$;

when the compound has formula $Ir(L_{Ai})(L_{Bk})_2$, the compound is selected from the group consisting of $Ir(L_{A1})(L_{B1})_2$ to $Ir(L_{A335})(L_{B836})_2$;

when the compound has formula $Ir(L_{Ai})_2(L_{Bk})$, the compound is selected from the group consisting of $Ir(L_{A1})_2(L_{B1})$ to $Ir(L_{A335})_2(L_{B836})$;

when the compound has formula $Ir(L_{Ai})_2(L_{Cj\text{-}I})$, the compound is selected from the group consisting of $Ir(L_{A1})_2(L_{C1\text{-}I})$ to $Ir(L_{A335})_2(L_{C1416\text{-}I})$; and

when the compound has formula $Ir(L_{Ai})_2(L_{Cj\text{-}II})$, the compound is selected from the group consisting of $Ir(L_{A1})_2(L_{C1\text{-}II})$ to $Ir(L_{A335})_2(L_{C1416\text{-}II})$;

wherein each $L_{Bk}$ has the structure defined as follows:

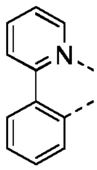
$L_{B1}$ ,
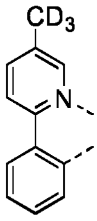
$L_{B2}$ ,
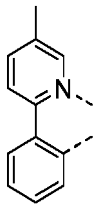
$L_{B3}$ ,
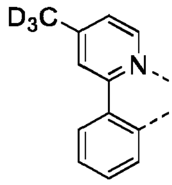
$L_{B4}$ ,

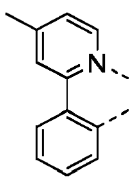
$L_{B5}$ ,
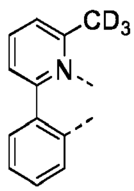
$L_{B6}$ ,
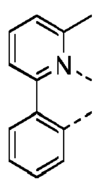
$L_{B7}$ ,
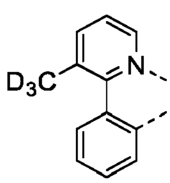
$L_{B8}$ ,
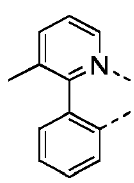
$L_{B9}$ ,
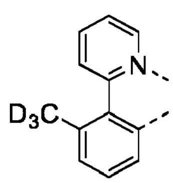
$L_{B10}$ ,
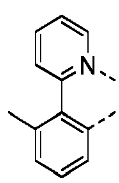
$L_{B11}$ ,

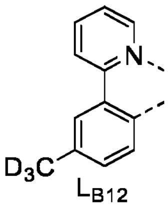
$L_{B12}$ ,
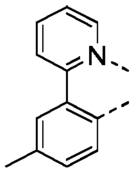
$L_{B13}$ ,
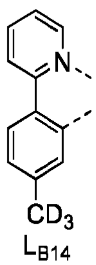
$L_{B14}$ ,
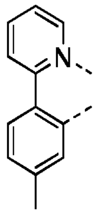
$L_{B15}$ ,
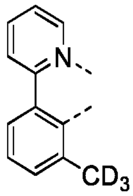
$L_{B16}$ ,
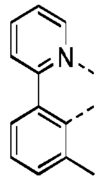
$L_{B17}$ ,
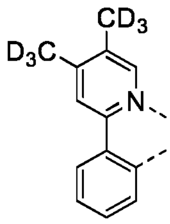
$L_{B18}$ ,
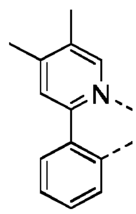
$L_{B19}$ ,

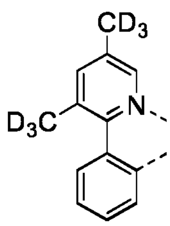
$L_{B20}$ ,
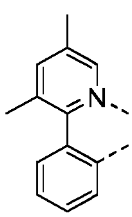
$L_{B21}$ ,
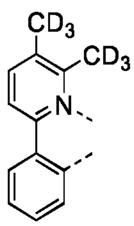
$L_{B22}$ ,
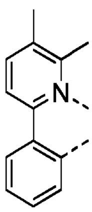
$L_{B23}$ ,
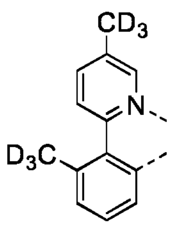
$L_{B24}$ ,
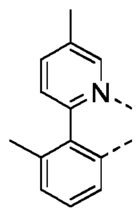
$L_{B25}$ ,
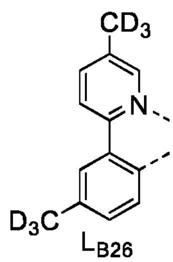
$L_{B26}$ ,

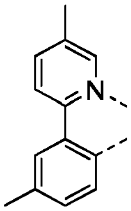
$L_{B27}$ ,
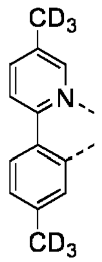
$L_{B28}$ ,
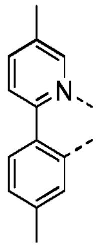
$L_{B29}$ ,
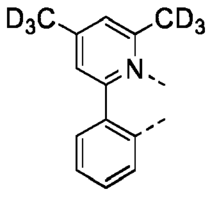
$L_{B30}$ ,
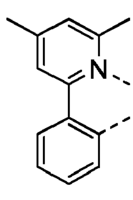
$L_{B31}$ ,
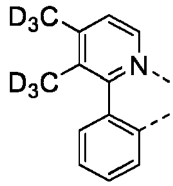
$L_{B32}$ ,
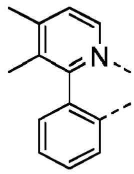
$L_{B33}$ ,

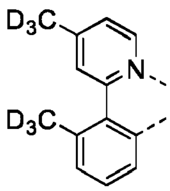
$L_{B34}$ ,
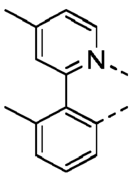
$L_{B35}$ ,
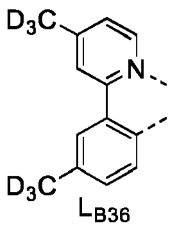
$L_{B36}$ ,
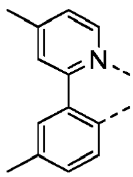
$L_{B37}$ ,
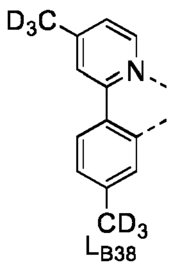
$L_{B38}$ ,
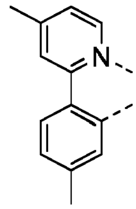
$L_{B39}$ ,

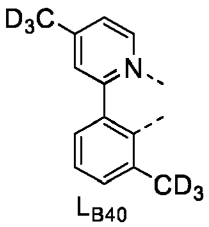
$L_{B40}$ ,
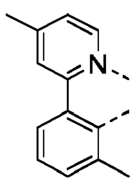
$L_{B41}$ ,
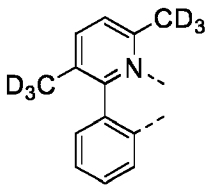
$L_{B42}$ ,
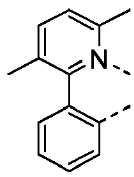
$L_{B43}$ ,
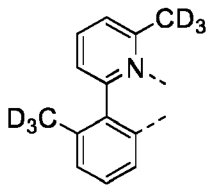
$L_{B44}$ ,
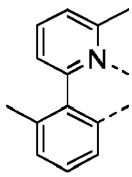
$L_{B45}$ ,

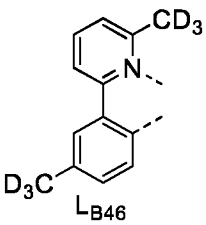
$L_{B46}$ ,
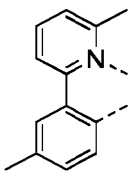
$L_{B47}$ ,
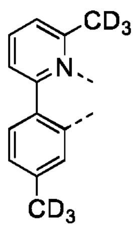
$L_{B48}$ ,
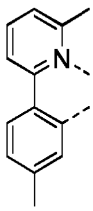
$L_{B49}$ ,
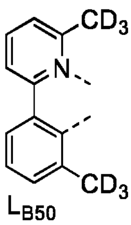
$L_{B50}$ ,
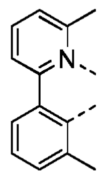
$L_{B51}$ ,
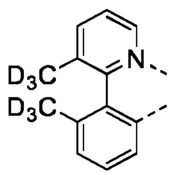
$L_{B52}$ ,
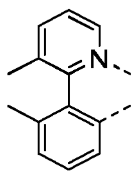
$L_{B53}$

,
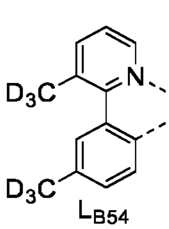
$L_{B54}$ ,
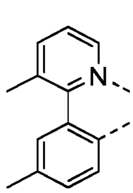
$L_{B55}$ ,
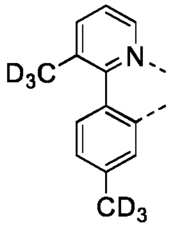
$L_{B56}$ ,
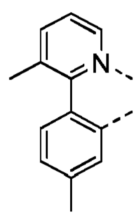
$L_{B57}$ ,
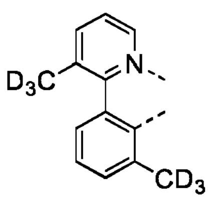
$L_{B58}$ ,
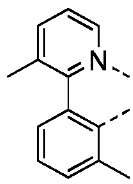
$L_{B59}$ ,

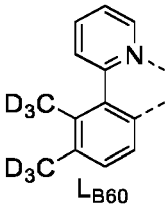
$L_{B60}$ ,

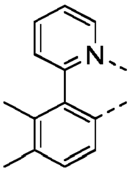
$L_{B61}$ ,

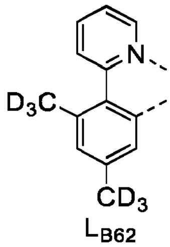
$L_{B62}$ ,

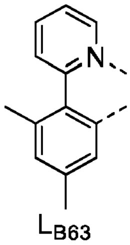
$L_{B63}$ ,

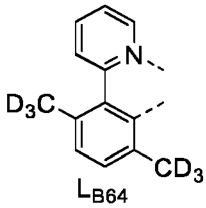
$L_{B64}$ ,

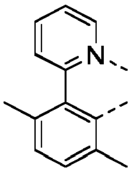
$L_{B65}$ ,

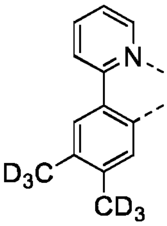
$L_{B66}$ ,

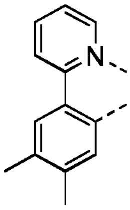
$L_{B67}$ ,

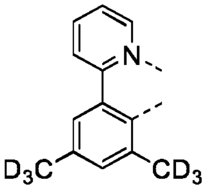
$L_{B68}$ ,

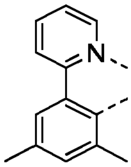
$L_{B69}$ ,

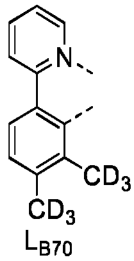
$L_{B70}$ ,

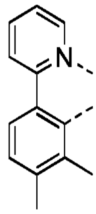
$L_{B71}$ ,

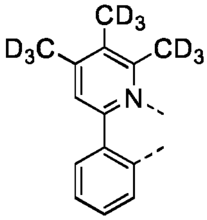
$L_{B72}$ ,

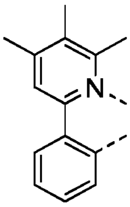
$L_{B73}$ ,

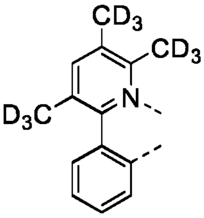
$L_{B74}$ ,

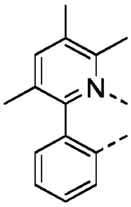
$L_{B75}$ ,

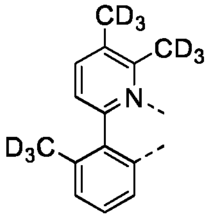
$L_{B76}$ ,

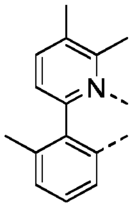
$L_{B77}$ ,

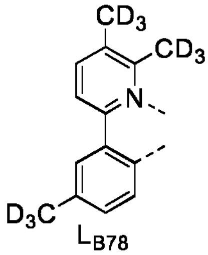
$L_{B78}$ ,

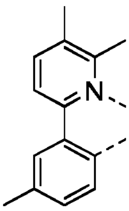
$L_{B79}$ ,

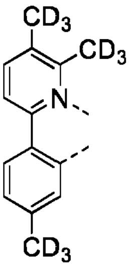
$L_{B80}$ ,

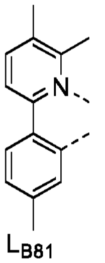
$L_{B81}$ ,

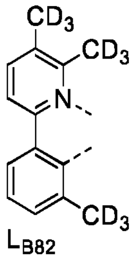
$L_{B82}$ ,

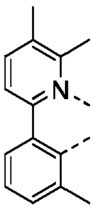
$L_{B83}$ ,

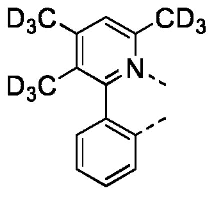
$L_{B84}$ ,

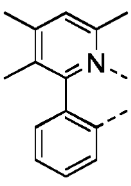
$L_{B85}$ ,

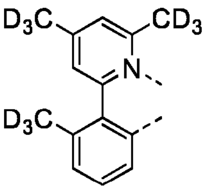
$L_{B86}$ ,

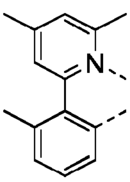
$L_{B87}$ ,

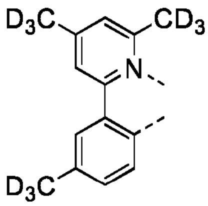
$L_{B88}$ ,

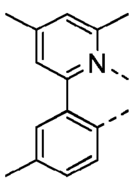
$L_{B89}$ ,

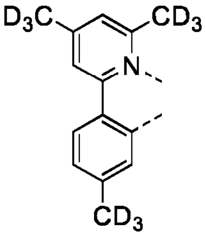
$L_{B90}$ ,

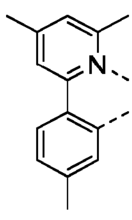
$L_{B91}$ ,

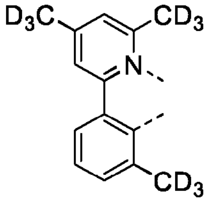
$L_{B92}$ ,
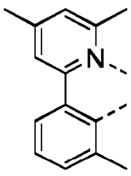
$L_{B93}$ ,
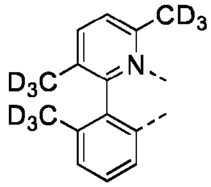
$L_{B94}$ ,
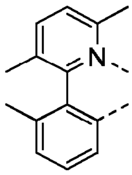
$L_{B95}$ ,
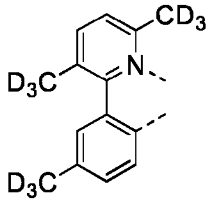
$L_{B96}$ ,
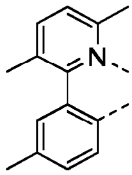
$L_{B97}$ ,

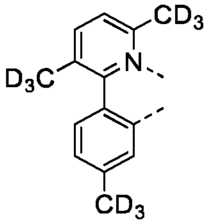
$L_{B98}$ ,
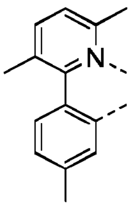
$L_{B99}$ ,
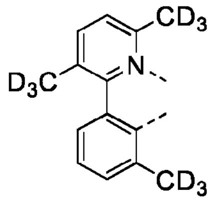
$L_{B100}$ ,
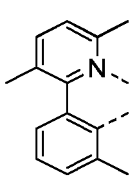
$L_{B101}$ ,
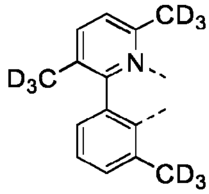
$L_{B102}$ ,
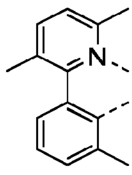
$L_{B103}$ ,

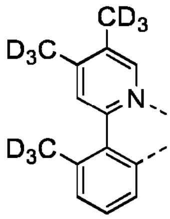
$L_{B104}$ ,
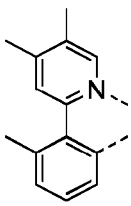
$L_{B105}$ ,
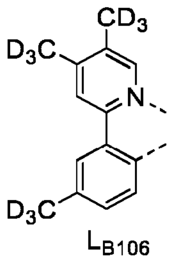
$L_{B106}$ ,
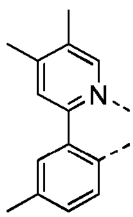
$L_{B107}$ ,
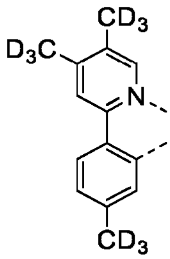
$L_{B108}$ ,
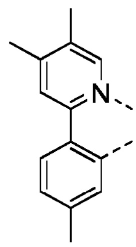
$L_{B109}$ ,

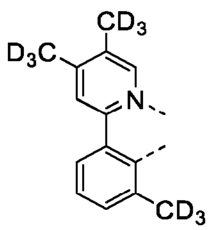
$L_{B110}$ ,
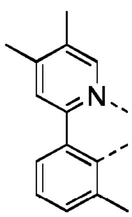
$L_{B111}$ ,
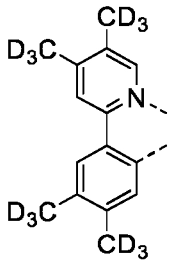
$L_{B112}$ ,
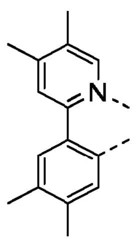
$L_{B113}$ ,
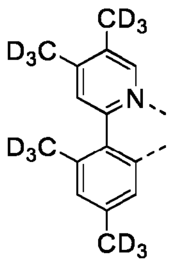
$L_{B114}$ ,
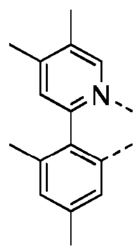
$L_{B115}$ ,

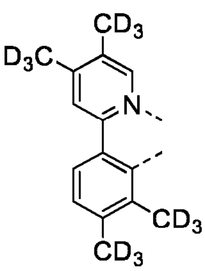
$L_{B116}$ ,
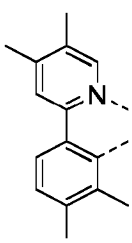
$L_{B117}$ ,
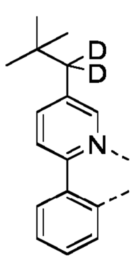
$L_{B118}$ ,
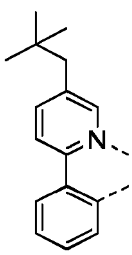
$L_{B119}$ ,
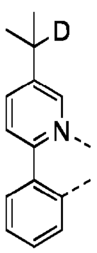
$L_{B120}$ ,
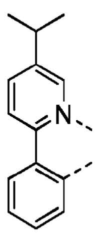
$L_{B121}$ ,
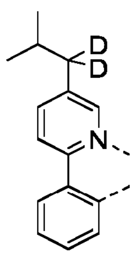
$L_{B122}$ ,
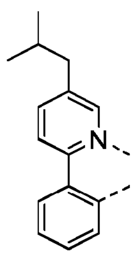
$L_{B123}$ ,

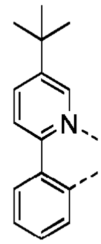 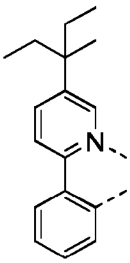 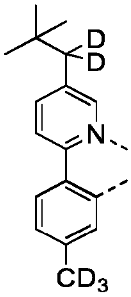 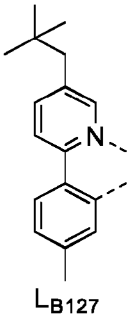 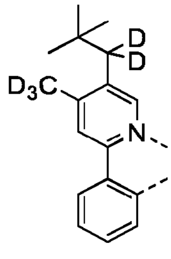 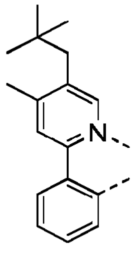 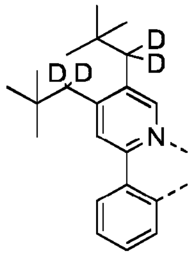

$L_{B124}$ , $L_{B125}$ , $L_{B126}$ , $L_{B127}$ , $L_{B128}$ , $L_{B129}$ , $L_{B130}$ ,

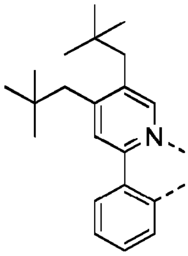 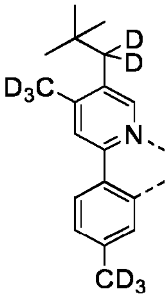 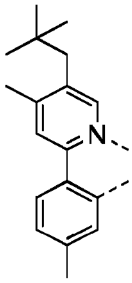 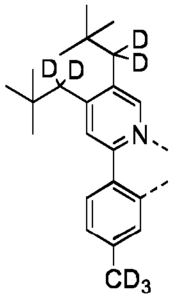 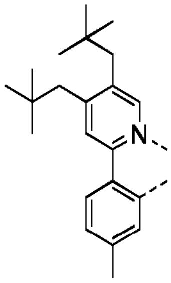 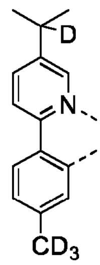 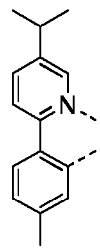

$L_{B131}$ , $L_{B132}$ , $L_{B133}$ , $L_{B134}$ , $L_{B135}$ , $L_{B136}$ , $L_{B137}$ ,

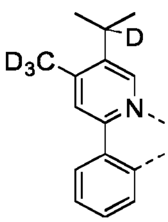 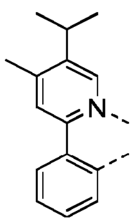 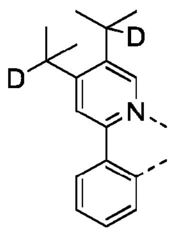 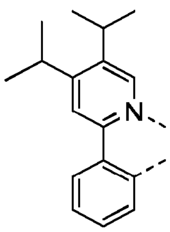 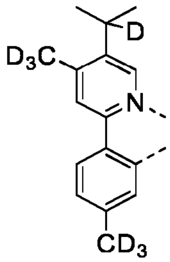 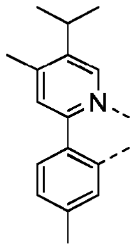

$L_{B138}$ , $L_{B139}$ , $L_{B140}$ , $L_{B141}$ , $L_{B142}$ , $L_{B143}$ ,

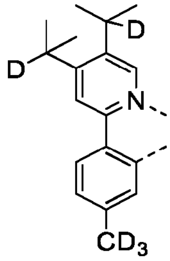 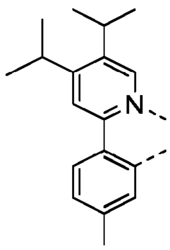 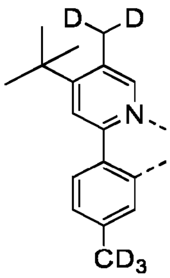 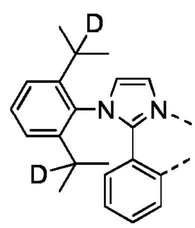 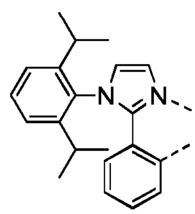

$L_{B144}$ , $L_{B145}$ , $L_{B146}$ , $L_{B147}$ , $L_{B148}$ ,

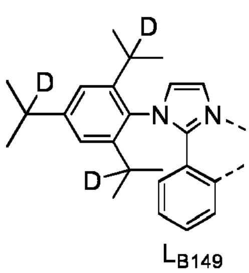 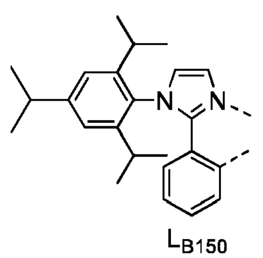 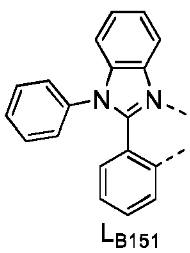 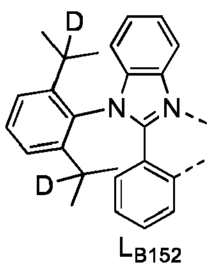 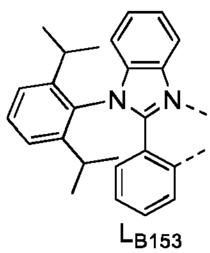

$L_{B149}$ , $L_{B150}$ , $L_{B151}$ , $L_{B152}$ , $L_{B153}$ ,

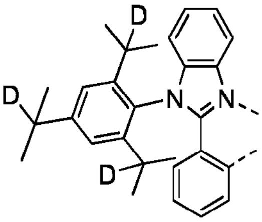 $L_{B154}$, 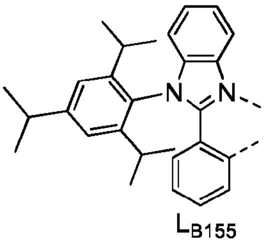 $L_{B155}$, 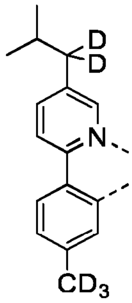 $L_{B156}$, 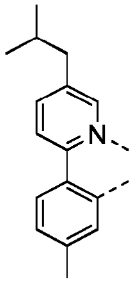 $L_{B157}$, 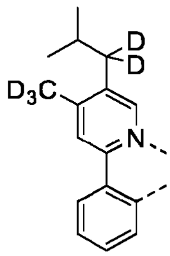 $L_{B158}$, 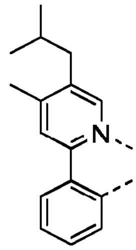 $L_{B159}$,

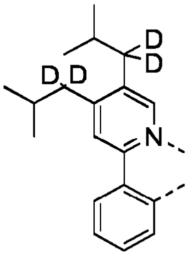 $L_{B160}$, 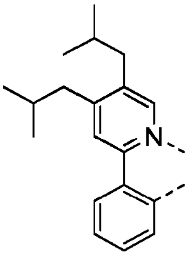 $L_{B161}$, 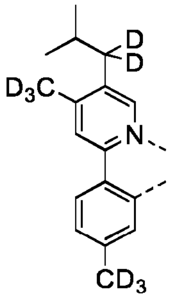 $L_{B162}$, 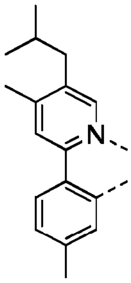 $L_{B163}$, 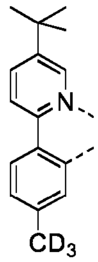 $L_{B164}$, 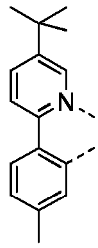 $L_{B165}$, 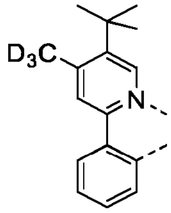 $L_{B166}$,

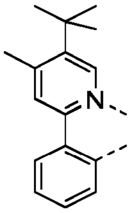 $L_{B167}$, 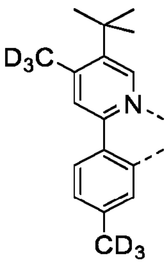 $L_{B168}$, 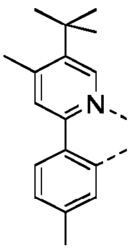 $L_{B169}$, 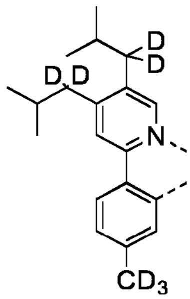 $L_{B170}$, 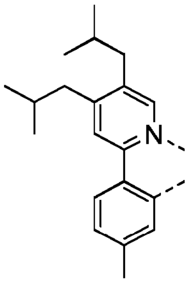 $L_{B171}$, 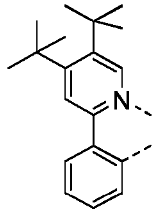 $L_{B172}$,

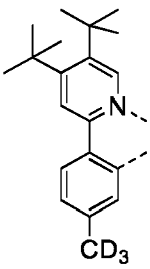 $L_{B173}$, 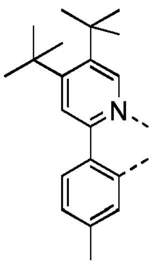 $L_{B174}$, 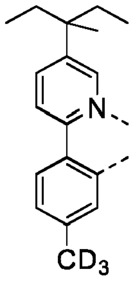 $L_{B175}$, 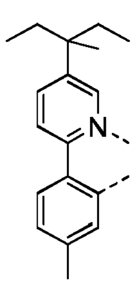 $L_{B176}$, 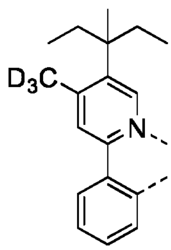 $L_{B177}$, 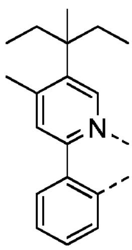 $L_{B178}$, 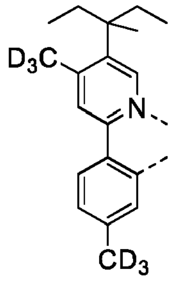 $L_{B179}$,

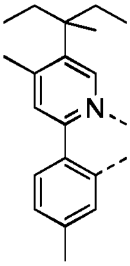
$L_{B180}$ ,
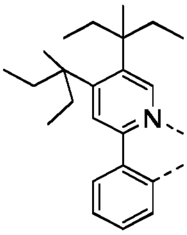
$L_{B181}$ ,
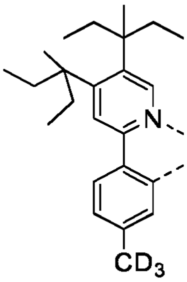
$L_{B182}$ ,
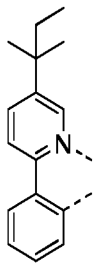
$L_{B183}$ ,
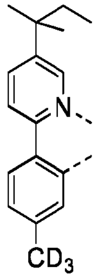
$L_{B184}$ ,
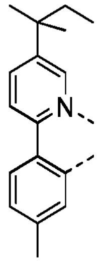
$L_{B185}$ ,
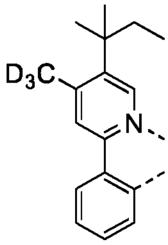
$L_{B186}$ ,
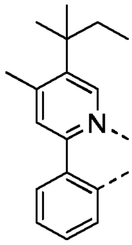
$L_{B187}$

,
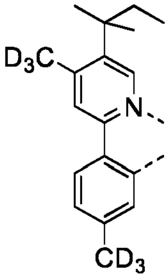
$L_{B188}$ ,
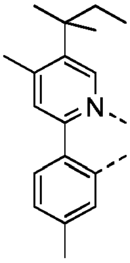
$L_{B189}$ ,
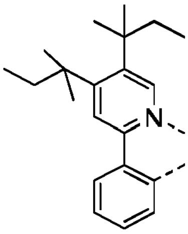
$L_{B190}$ ,
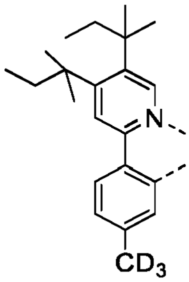
$L_{B191}$ ,
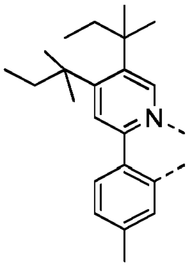
$L_{B192}$ ,
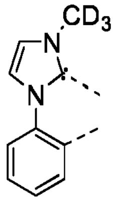
$L_{B193}$ ,

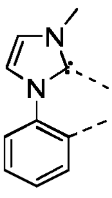
$L_{B194}$ ,
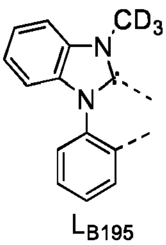
$L_{B195}$ ,
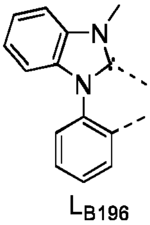
$L_{B196}$ ,
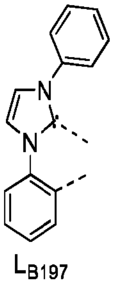
$L_{B197}$ ,
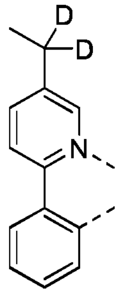
$L_{B198}$ ,
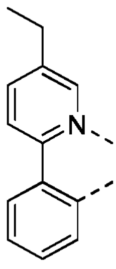
$L_{B199}$ ,
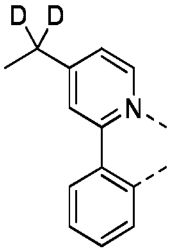
$L_{B200}$ ,

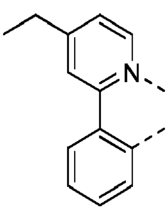
$L_{B201}$ ,
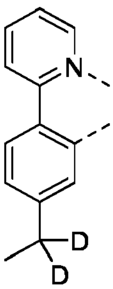
$L_{B202}$ ,
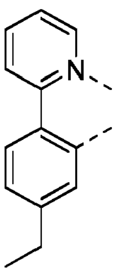
$L_{B203}$ ,
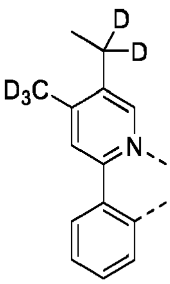
$L_{B204}$ ,
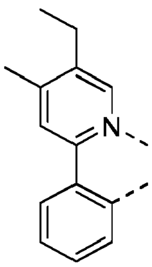
$L_{B205}$ ,
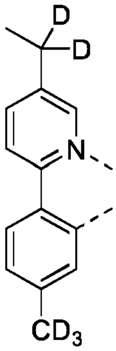
$L_{B206}$ ,
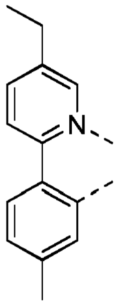
$L_{B207}$ ,

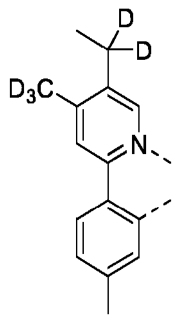 $L_{B208}$ , 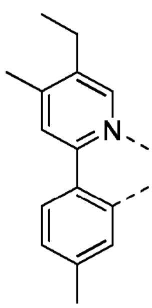 $L_{B209}$ , 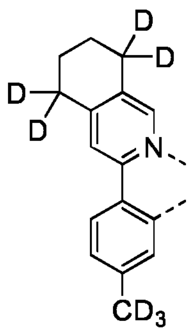 $L_{B210}$ , 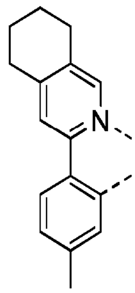 $L_{B211}$ , 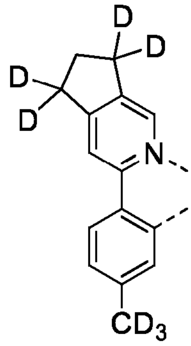 $L_{B212}$ , 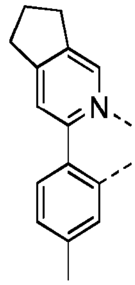 $L_{B213}$ ,

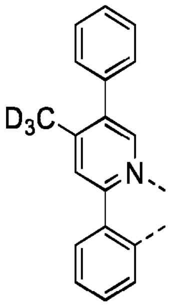 $L_{B214}$ , 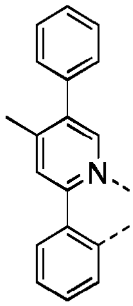 $L_{B215}$ , 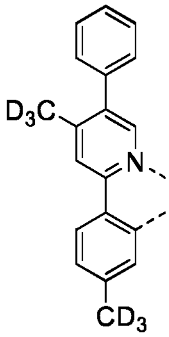 $L_{B216}$ , 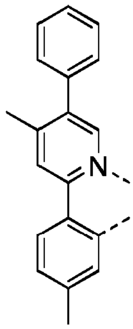 $L_{B217}$ , 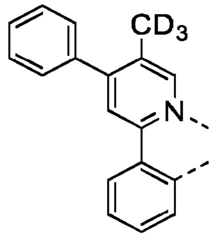 $L_{B218}$ , 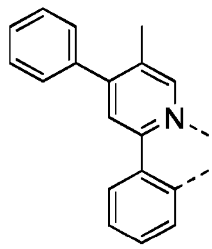 $L_{B219}$ ,

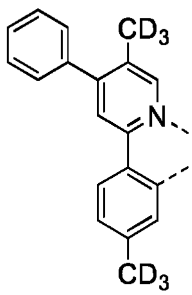 $L_{B220}$ , 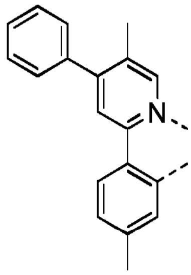 $L_{B221}$ , 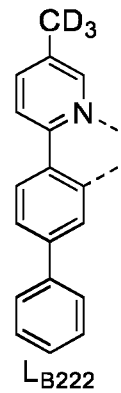 $L_{B222}$ , 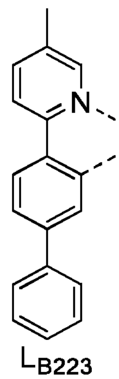 $L_{B223}$ , 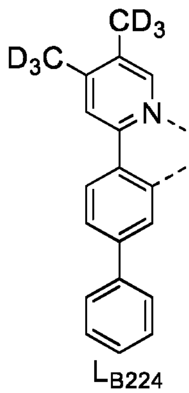 $L_{B224}$ , 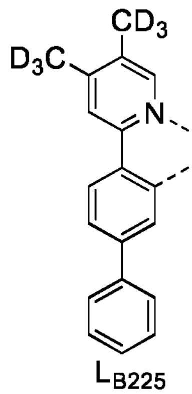 $L_{B225}$ ,

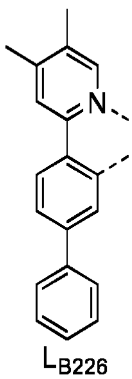 $L_{B226}$ , 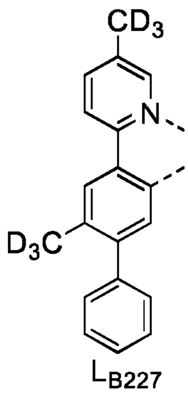 $L_{B227}$ , 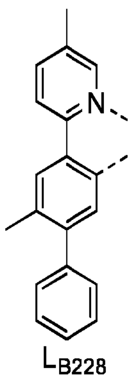 $L_{B228}$ , 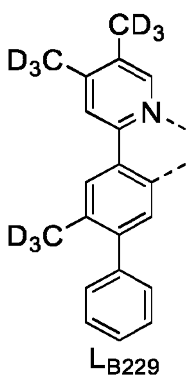 $L_{B229}$ , 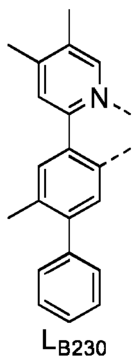 $L_{B230}$ , 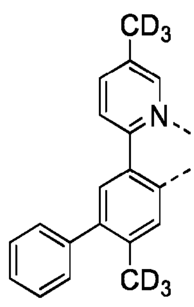 $L_{B231}$ ,

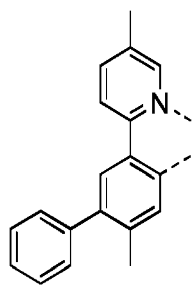
$L_{B232}$ ,
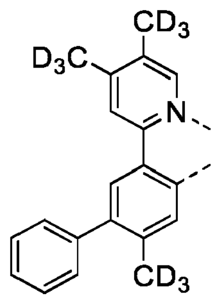
$L_{B233}$ ,
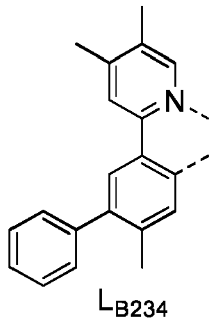
$L_{B234}$ ,
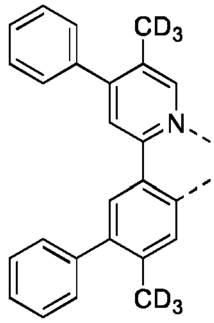
$L_{B235}$ ,
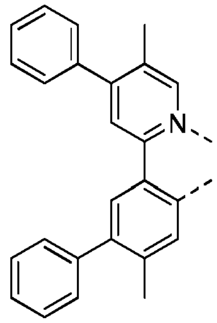
$L_{B236}$ ,

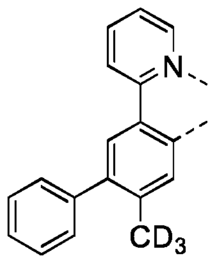
$L_{B237}$ ,
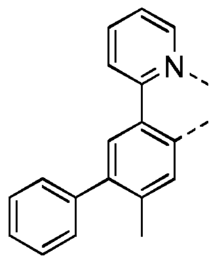
$L_{B238}$ ,
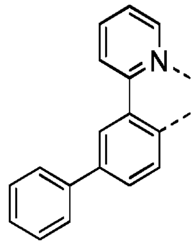
$L_{B239}$ ,
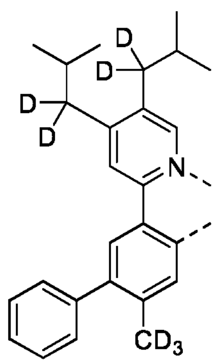
$L_{B240}$ ,
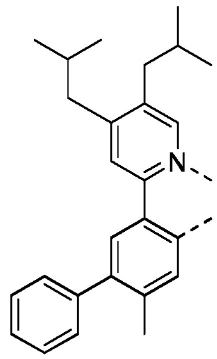
$L_{B241}$ ,

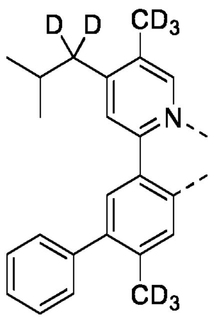
$L_{B242}$ ,
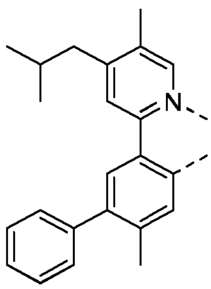
$L_{B243}$ ,
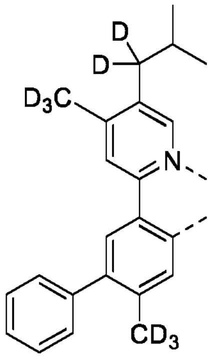
$L_{B244}$ ,
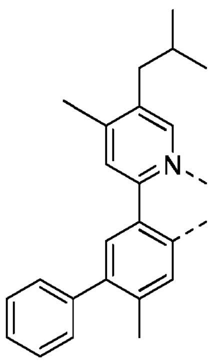
$L_{B245}$ ,
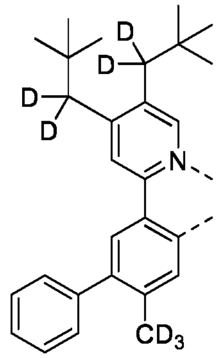
$L_{B246}$ ,

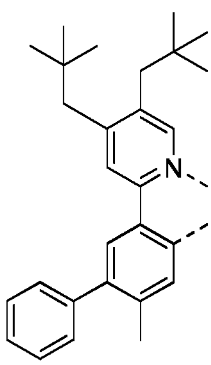
$L_{B247}$ ,
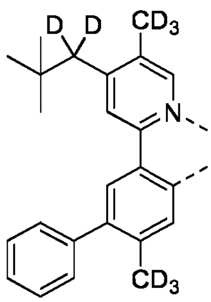
$L_{B248}$ ,
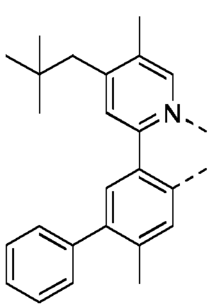
$L_{B249}$ ,
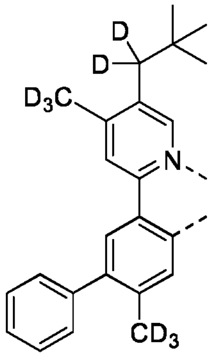
$L_{B250}$ ,
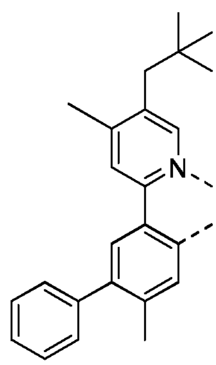
$L_{B251}$ ,

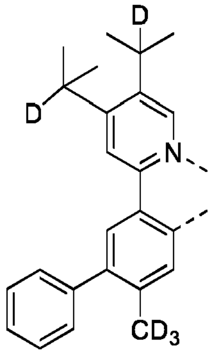
LB252 ,
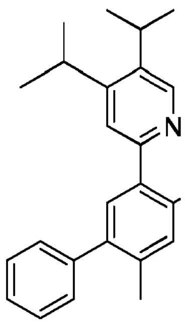
LB253 ,
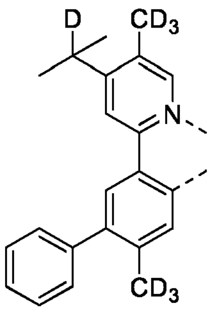
LB254 ,
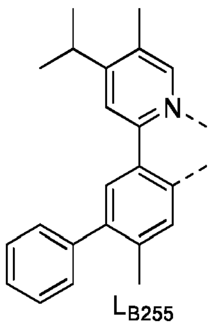
LB255 ,
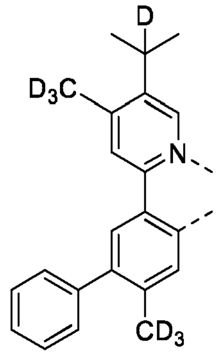
LB256 ,

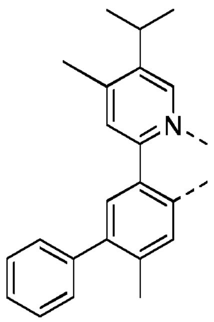
LB257 ,
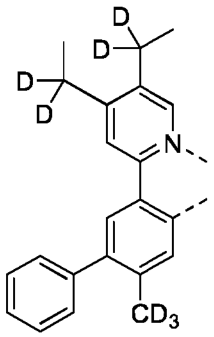
LB258 ,
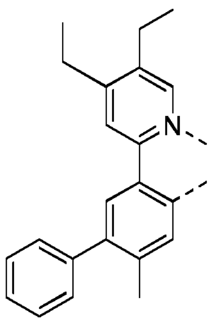
LB259 ,
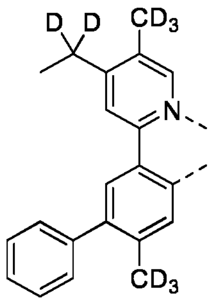
LB260 ,
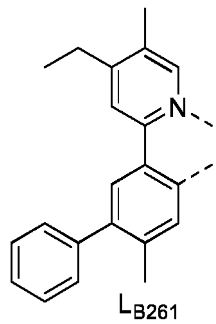
LB261 ,

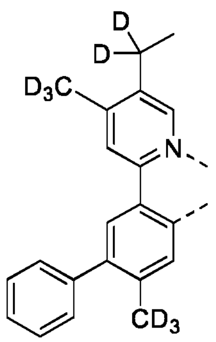
LB262 ,
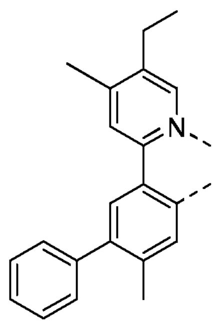
LB263 ,
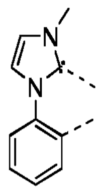
LB264 ,
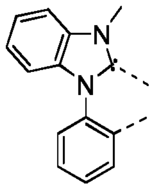
LB265 ,
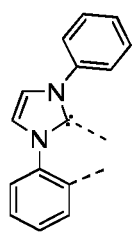
LB266 ,
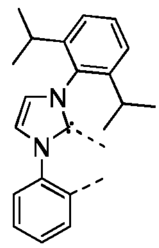
LB267 ,

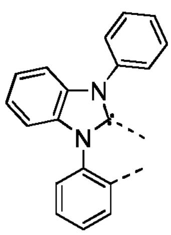
LB268 ,
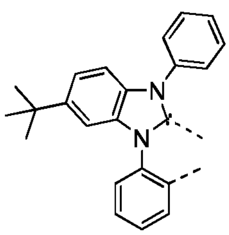
LB269 ,
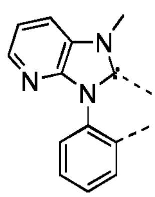
LB270 ,
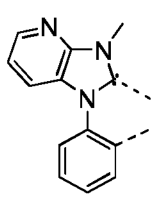
LB271 ,
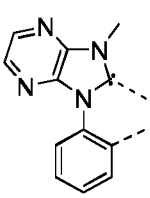
LB272 ,
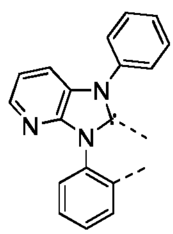
LB273 ,

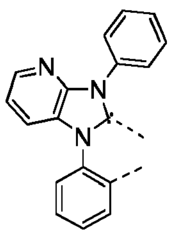
$L_{B274}$ ,
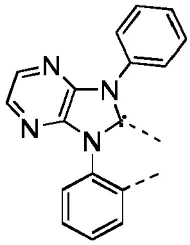
$L_{B275}$ ,
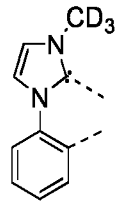
$L_{B276}$ ,
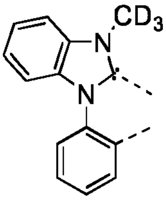
$L_{B277}$ ,
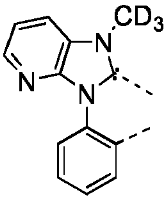
$L_{B278}$ ,
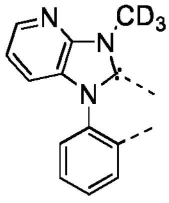
$L_{B279}$ ,

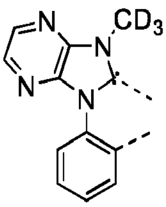
$L_{B280}$ ,
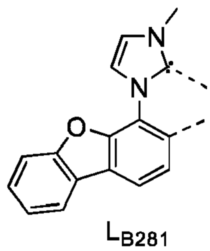
$L_{B281}$ ,
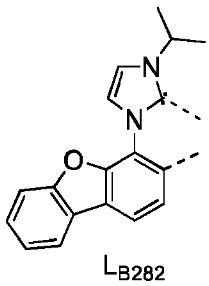
$L_{B282}$ ,
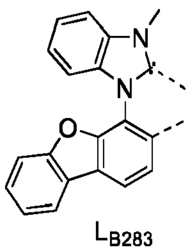
$L_{B283}$ ,
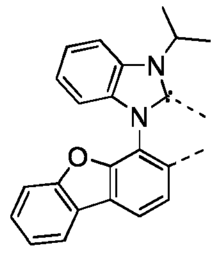
$L_{B284}$ ,

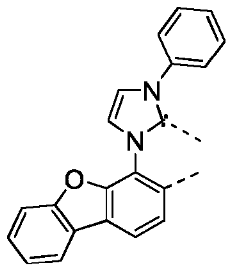
$L_{B285}$ ,
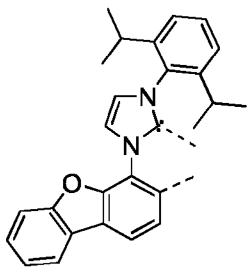
$L_{B286}$ ,
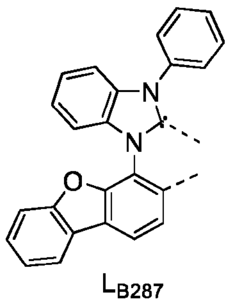
$L_{B287}$ ,
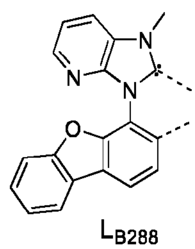
$L_{B288}$ ,
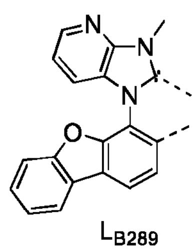
$L_{B289}$ ,

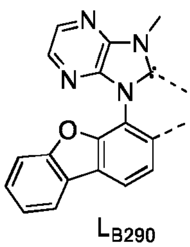
$L_{B290}$ ,
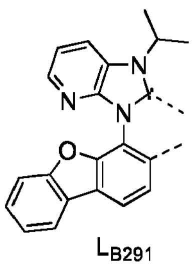
$L_{B291}$ ,
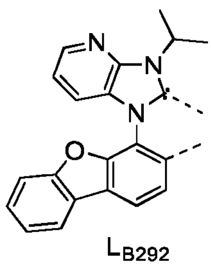
$L_{B292}$ ,
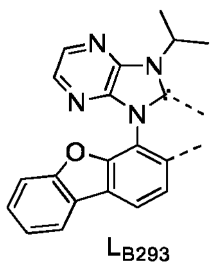
$L_{B293}$ ,
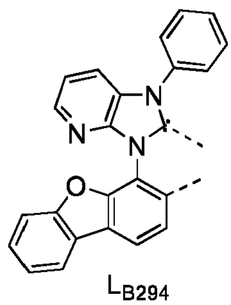
$L_{B294}$ ,

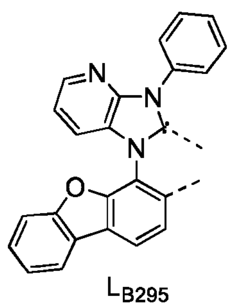
$L_{B295}$ ,
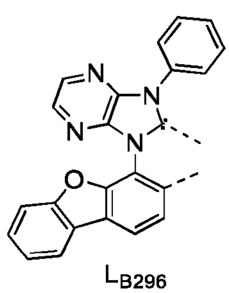
$L_{B296}$ ,
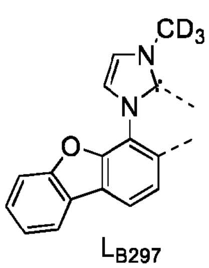
$L_{B297}$ ,
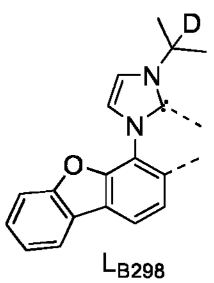
$L_{B298}$ ,
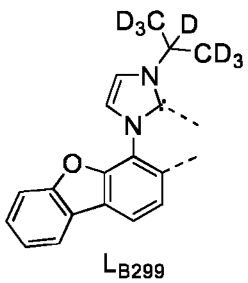
$L_{B299}$ ,

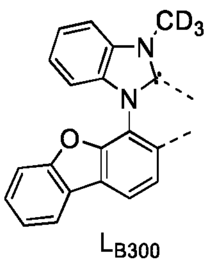
$L_{B300}$ ,
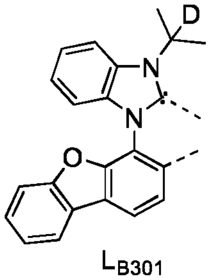
$L_{B301}$ ,
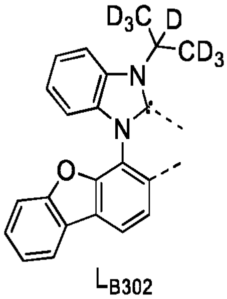
$L_{B302}$ ,
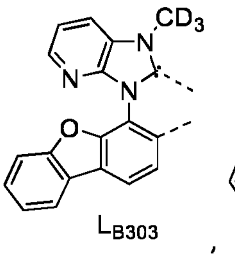
$L_{B303}$ ,
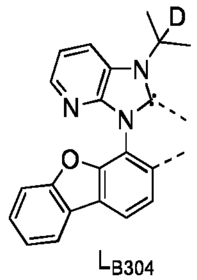
$L_{B304}$ ,
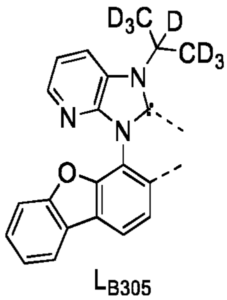
$L_{B305}$ ,
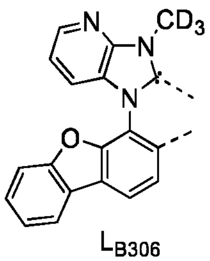
$L_{B306}$ ,
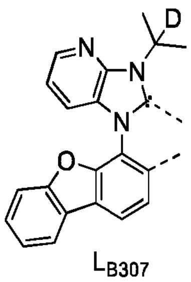
$L_{B307}$ ,
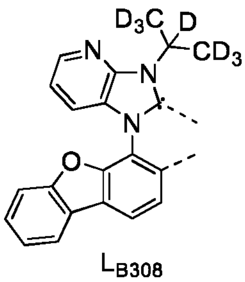
$L_{B308}$ ,
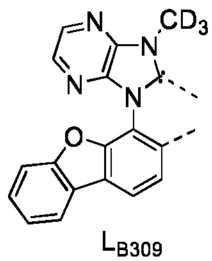
$L_{B309}$ ,
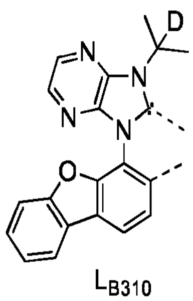
$L_{B310}$ ,
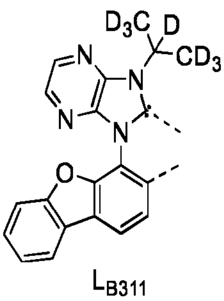
$L_{B311}$ ,
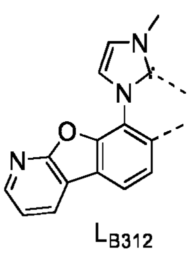
$L_{B312}$ ,
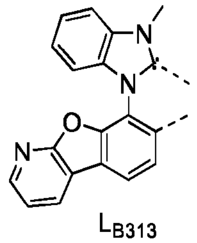
$L_{B313}$ ,
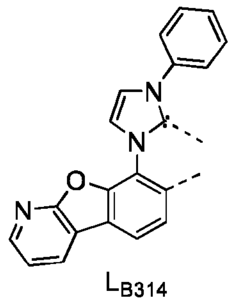
$L_{B314}$ ,
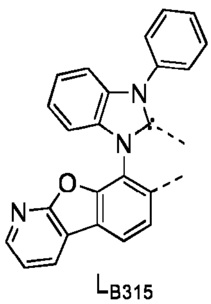
$L_{B315}$ ,
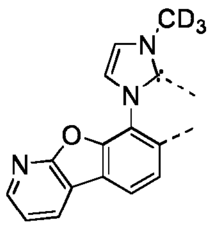
$L_{B316}$ ,
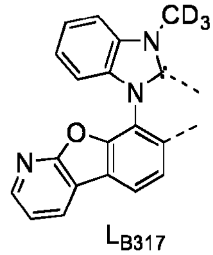
$L_{B317}$ ,
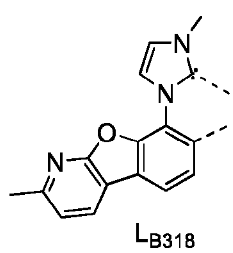
$L_{B318}$ ,
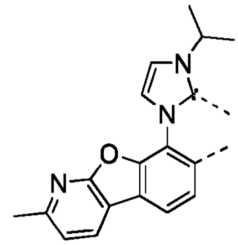
$L_{B319}$ ,
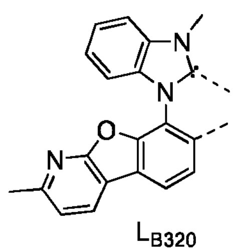
$L_{B320}$ ,
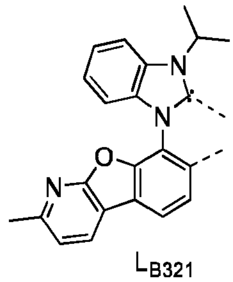
$L_{B321}$ ,
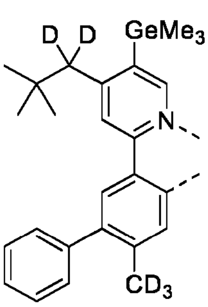
$L_{B322}$ ,
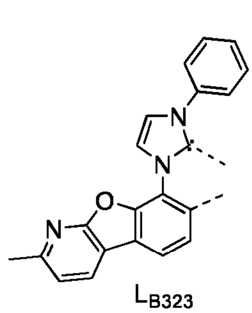
$L_{B323}$ ,

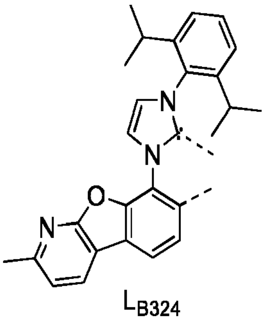
$L_{B324}$ ,
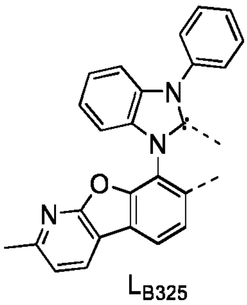
$L_{B325}$ ,
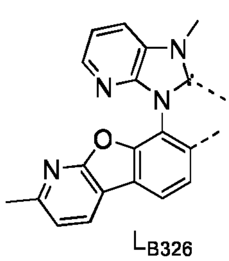
$L_{B326}$ ,
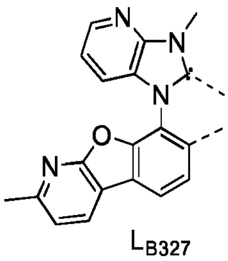
$L_{B327}$ ,

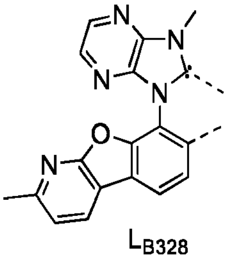
$L_{B328}$ ,
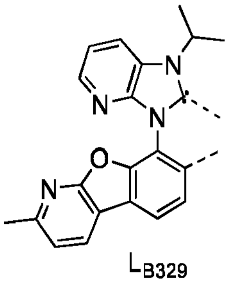
$L_{B329}$ ,
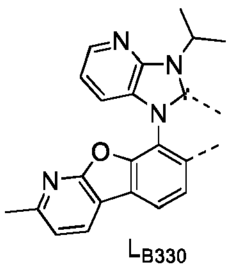
$L_{B330}$ ,
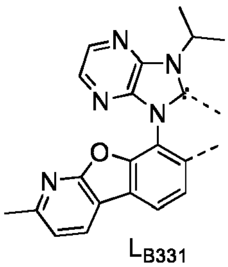
$L_{B331}$ ,

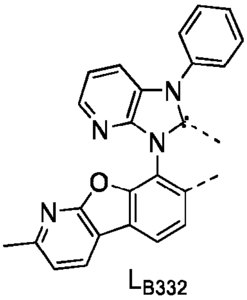
$L_{B332}$ ,
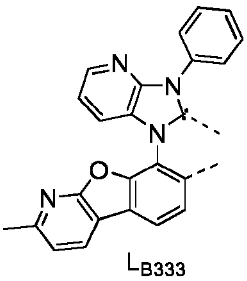
$L_{B333}$ ,
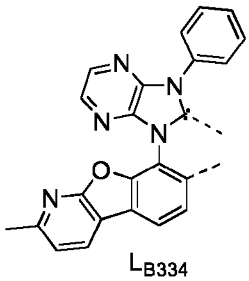
$L_{B334}$ ,
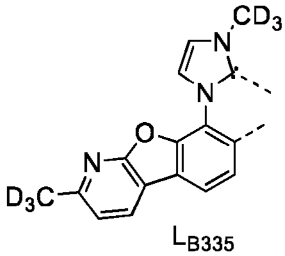
$L_{B335}$ ,

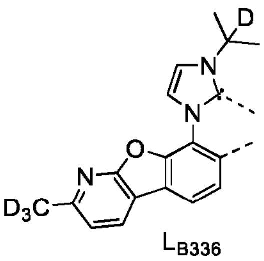
$L_{B336}$ ,
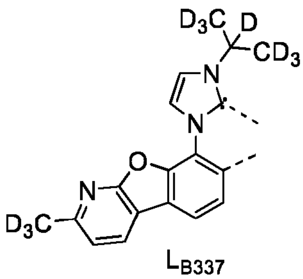
$L_{B337}$ ,
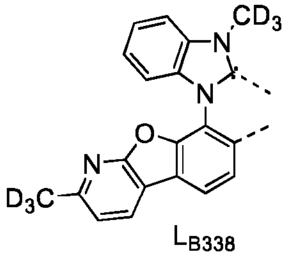
$L_{B338}$ ,
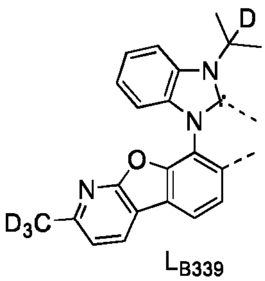
$L_{B339}$ ,

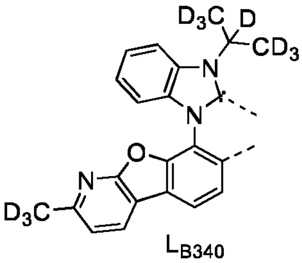
$L_{B340}$ ,
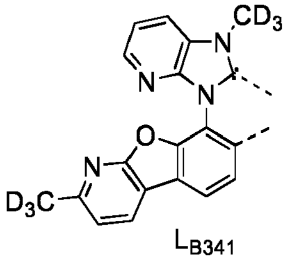
$L_{B341}$ ,
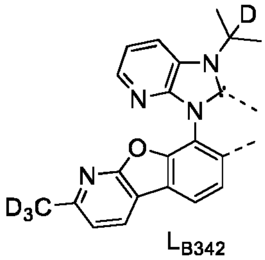
$L_{B342}$ ,

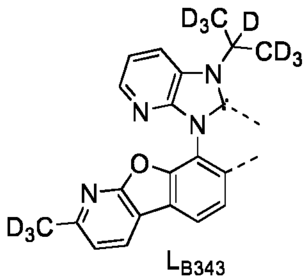
$L_{B343}$ ,
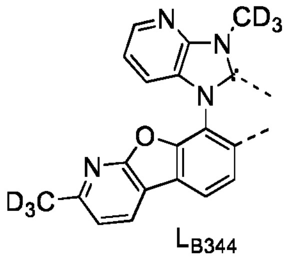
$L_{B344}$ ,
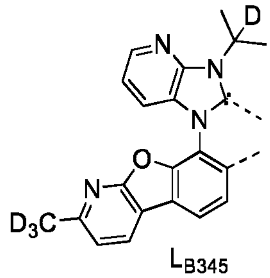
$L_{B345}$ ,

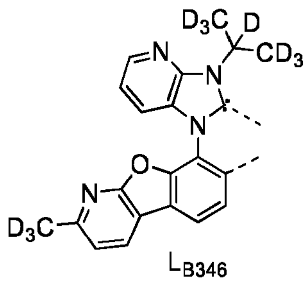
$L_{B346}$ ,
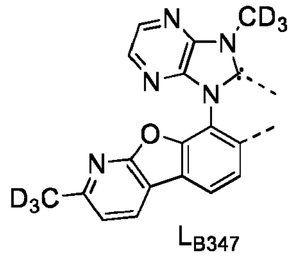
$L_{B347}$ ,
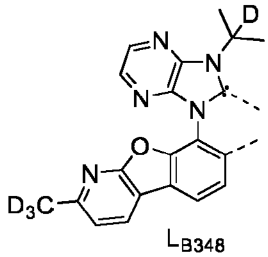
$L_{B348}$ ,

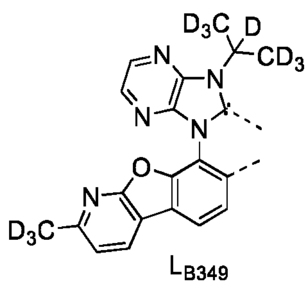
$L_{B349}$ ,
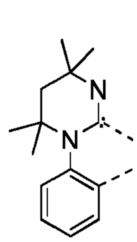
$L_{B350}$ ,
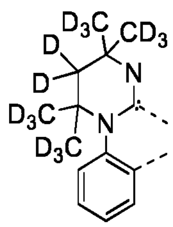
$L_{B351}$ ,
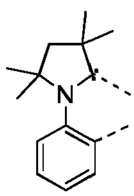
$L_{B352}$ ,
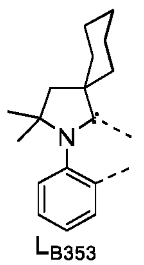
$L_{B353}$ ,
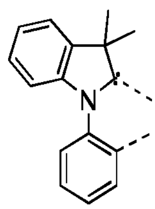
$L_{B354}$ ,

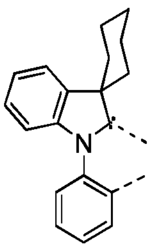
$L_{B355}$ ,
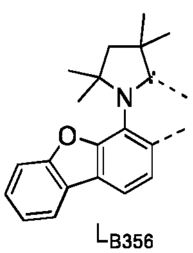
$L_{B356}$ ,
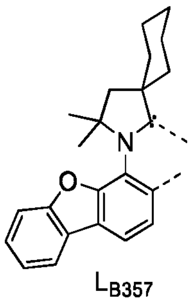
$L_{B357}$ ,
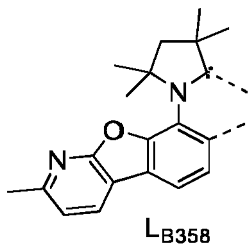
$L_{B358}$ ,
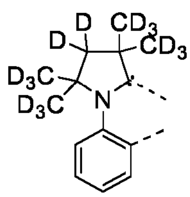
$L_{B359}$ ,

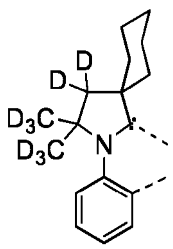
$L_{B360}$ ,
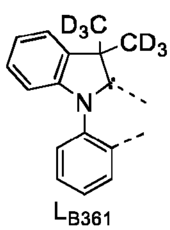
$L_{B361}$ ,
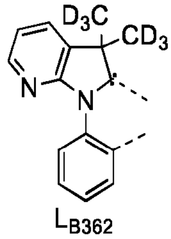
$L_{B362}$ ,
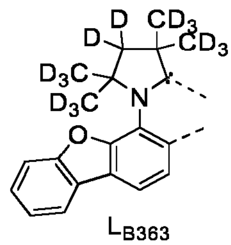
$L_{B363}$ ,
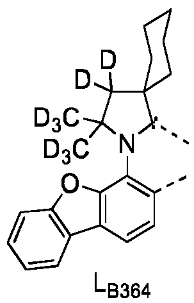
$L_{B364}$ ,

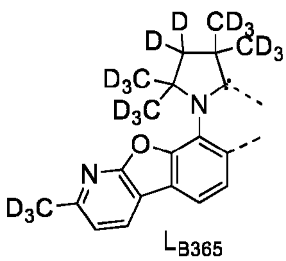 $L_{B365}$ , 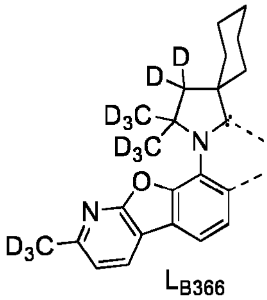 $L_{B366}$ , 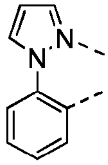 $L_{B367}$ , 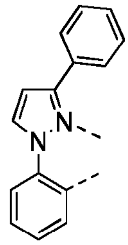 $L_{B368}$ , 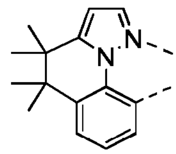 $L_{B369}$ ,

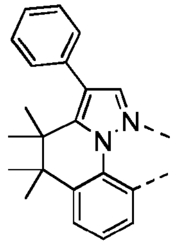 $L_{B370}$ , 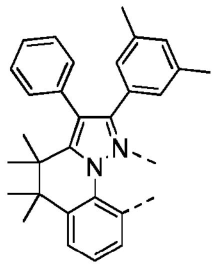 $L_{B371}$ , 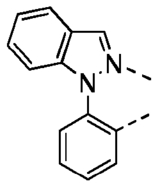 $L_{B372}$ , 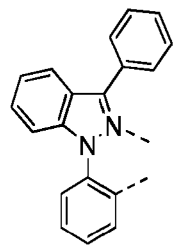 $L_{B373}$ , 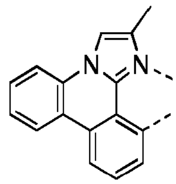 $L_{B374}$ , 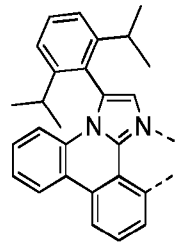 $L_{B375}$ ,

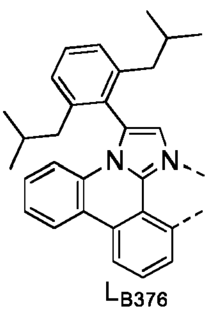 $L_{B376}$ , 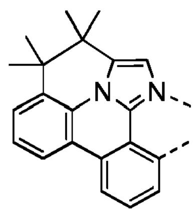 $L_{B377}$ , 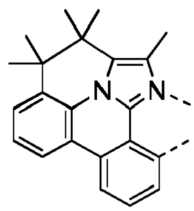 $L_{B378}$ , 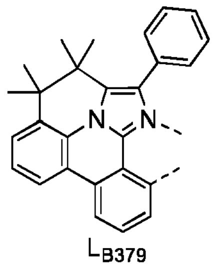 $L_{B379}$ , 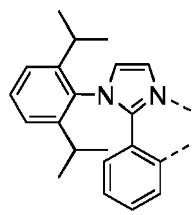 $L_{B380}$ ,

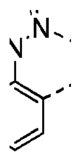
367

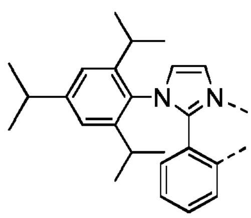 $L_{B381}$ , 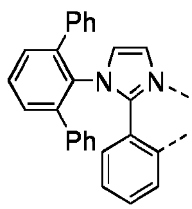 $L_{B382}$ , 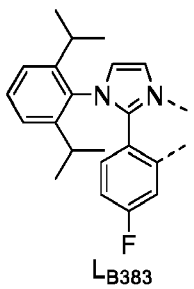 $L_{B383}$ , 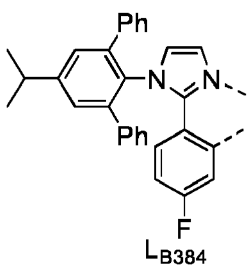 $L_{B384}$ , 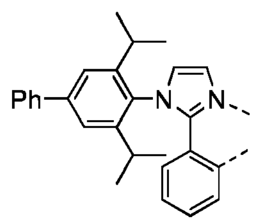 $L_{B385}$ ,

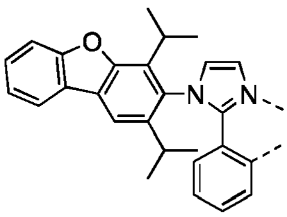 $L_{B386}$ , 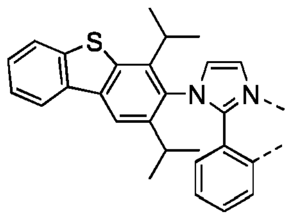 $L_{B387}$ , 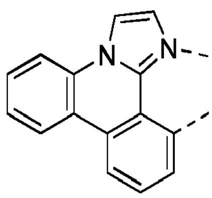 $L_{B388}$ , 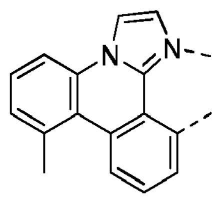 $L_{B389}$ ,

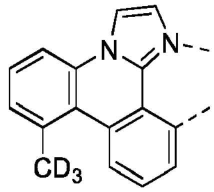 $L_{B390}$ , 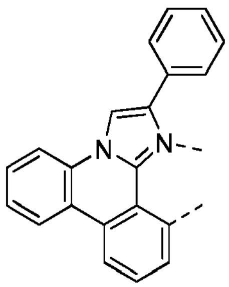 $L_{B391}$ , 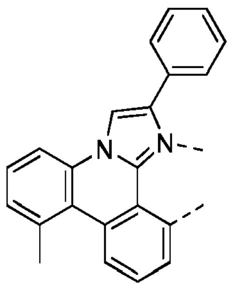 $L_{B392}$ , 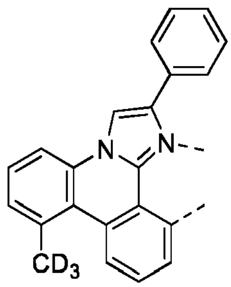 $L_{B393}$ , 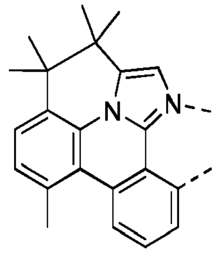 $L_{B394}$ ,

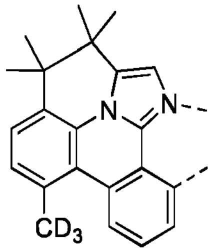 $L_{B395}$ , 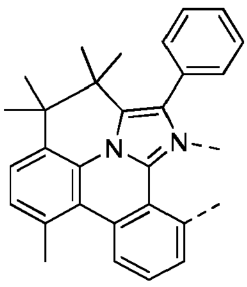 $L_{B396}$ , 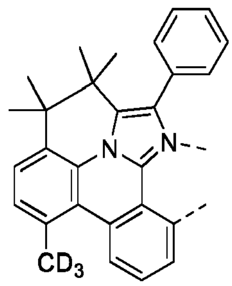 $L_{B397}$ , 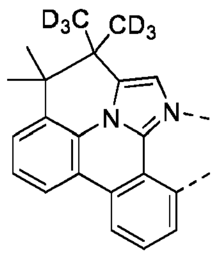 $L_{B398}$ , 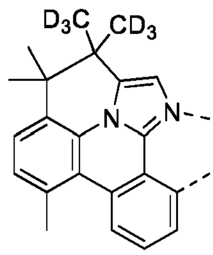 $L_{B399}$ ,

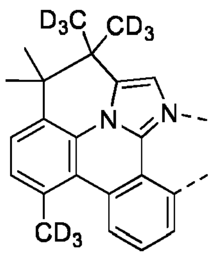 $L_{B400}$ , 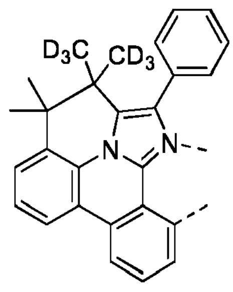 $L_{B401}$ , 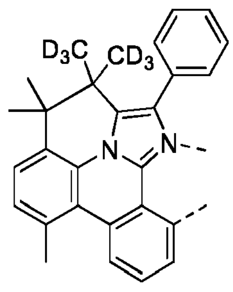 $L_{B402}$ , 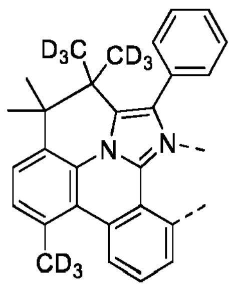 $L_{B403}$ ,

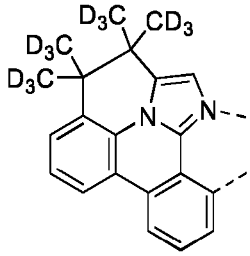 $L_{B404}$ , 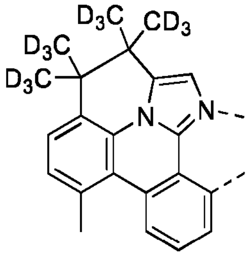 $L_{B405}$ , 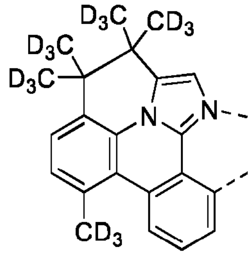 $L_{B406}$ , 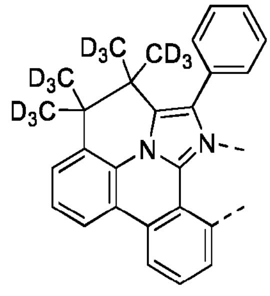 $L_{B407}$ ,

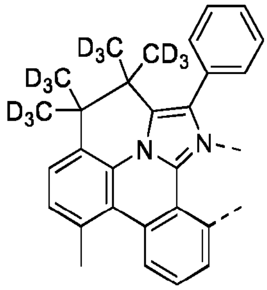
$L_{B408}$ ,
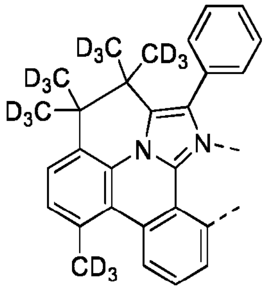
$L_{B409}$ ,
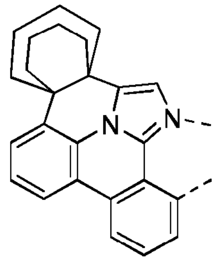
$L_{B410}$ ,
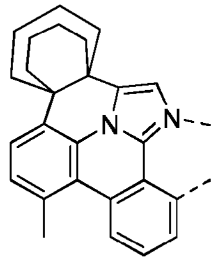
$L_{B411}$ ,

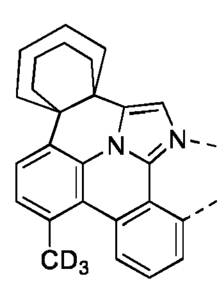
$L_{B412}$ ,
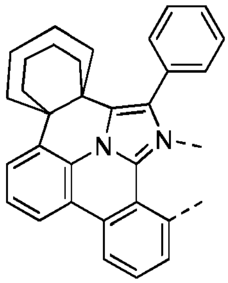
$L_{B413}$ ,
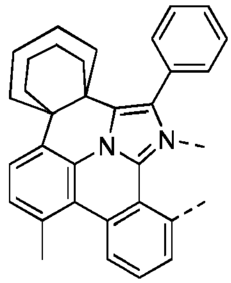
$L_{B414}$ ,
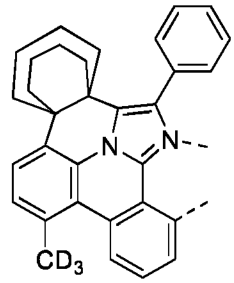
$L_{B415}$ ,
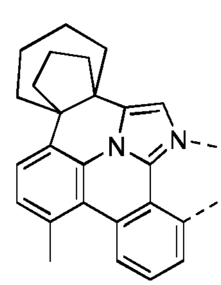
$L_{B416}$ ,

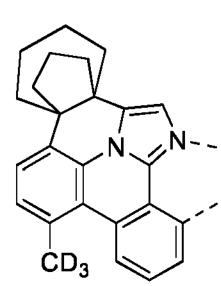
$L_{B417}$ ,
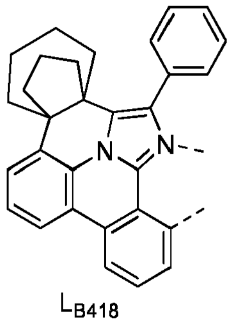
$L_{B418}$ ,
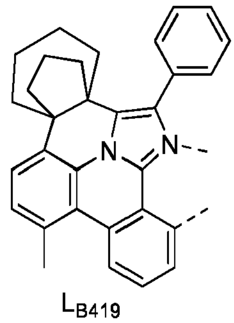
$L_{B419}$ ,
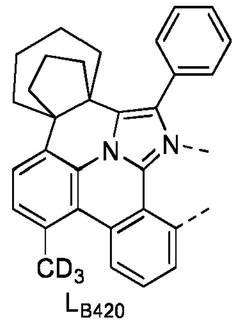
$L_{B420}$ ,
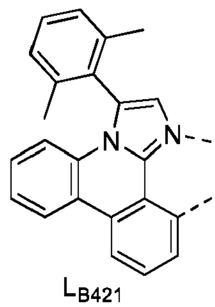
$L_{B421}$ ,

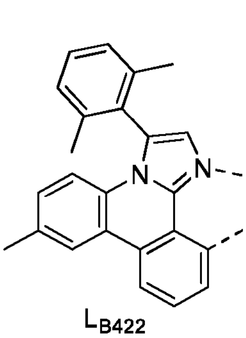
$L_{B422}$ ,
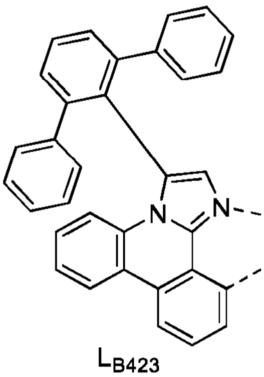
$L_{B423}$ ,
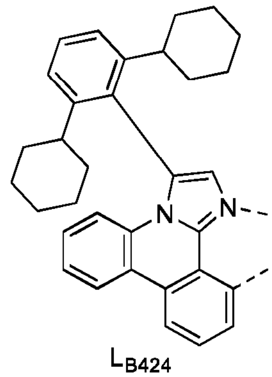
$L_{B424}$ ,
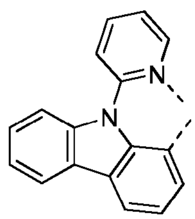
$L_{B425}$ ,

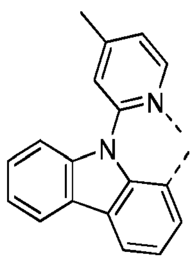
$L_{B426}$ ,
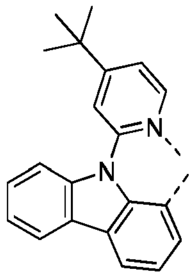
$L_{B427}$ ,
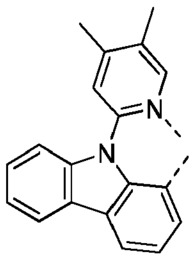
$L_{B428}$ ,
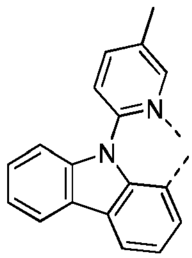
$L_{B429}$ ,
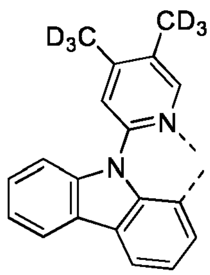
$L_{B430}$ ,

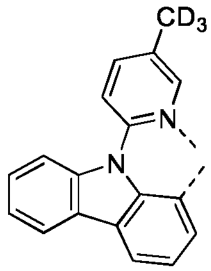
$L_{B431}$ ,
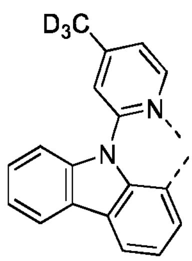
$L_{B432}$ ,
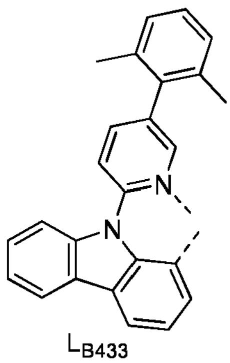
$L_{B433}$ ,
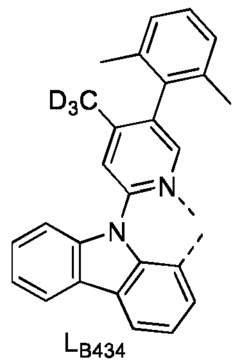
$L_{B434}$ ,
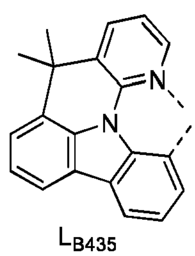
$L_{B435}$ ,

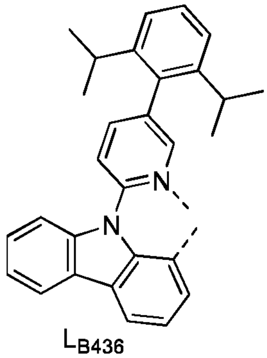
$L_{B436}$ ,
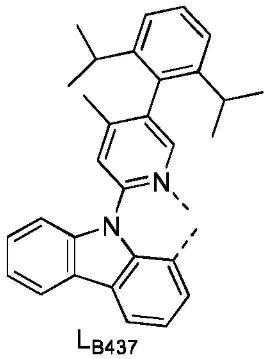
$L_{B437}$ ,
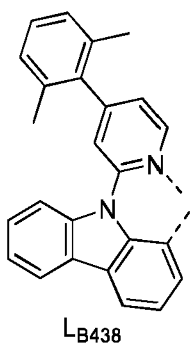
$L_{B438}$ ,
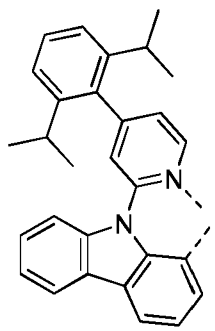
$L_{B439}$ ,
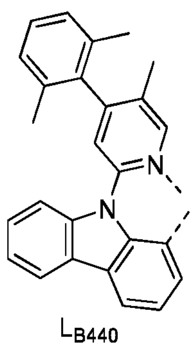
$L_{B440}$ ,

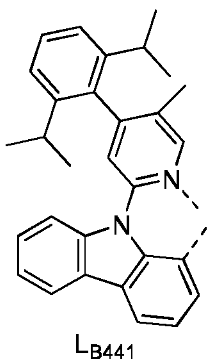
$L_{B441}$ ,
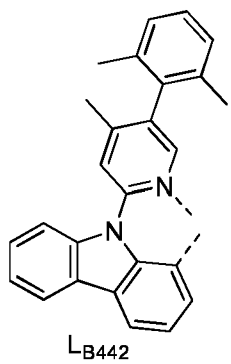
$L_{B442}$ ,
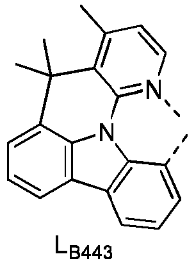
$L_{B443}$ ,
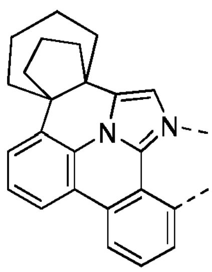
$L_{B444}$ ,
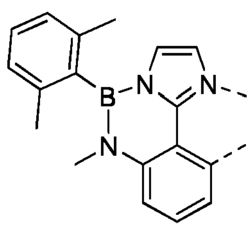
$L_{B445}$ ,

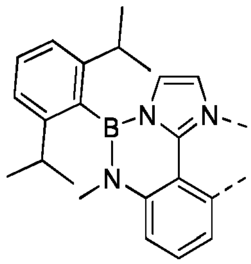
$L_{B446}$ ,

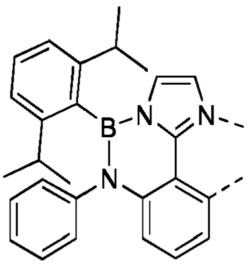
$L_{B447}$ ,

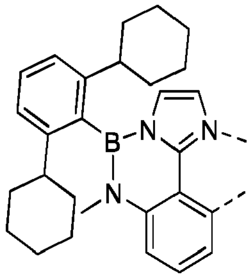
$L_{B448}$ ,

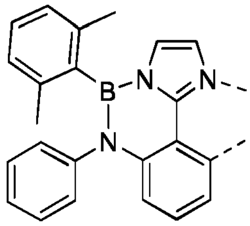
$L_{B449}$ ,

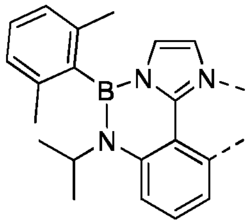
$L_{B450}$ ,

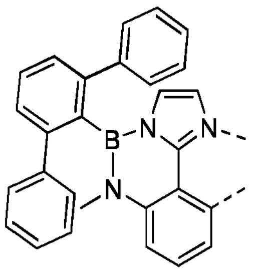
$L_{B451}$ ,

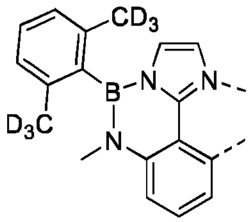
$L_{B452}$ ,

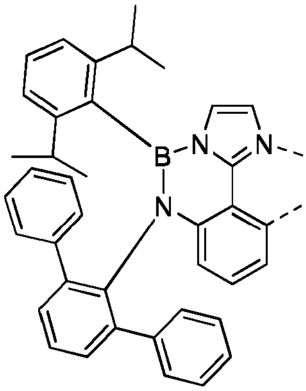
$L_{B453}$ ,

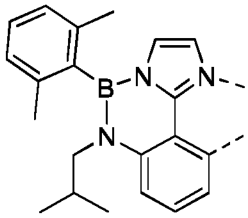
$L_{B454}$ ,

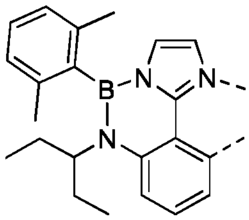
$L_{B455}$ ,

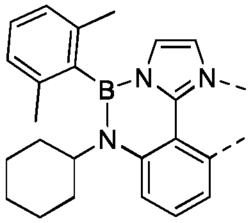
$L_{B456}$ ,

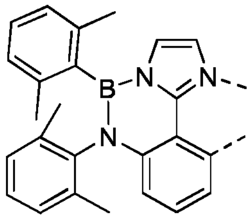
$L_{B457}$ ,

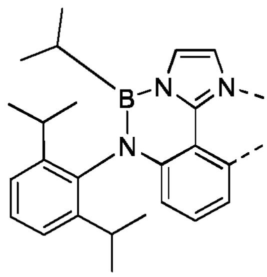
$L_{B458}$ ,

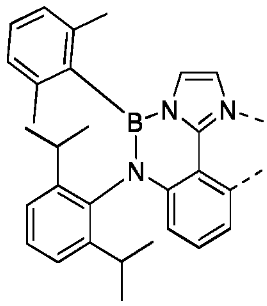
$L_{B459}$ ,

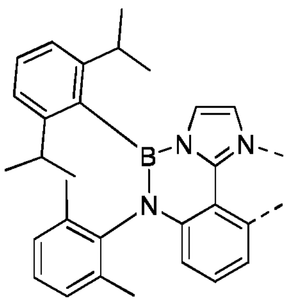
$L_{B460}$ ,

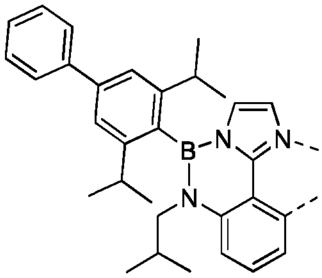
$L_{B461}$ ,

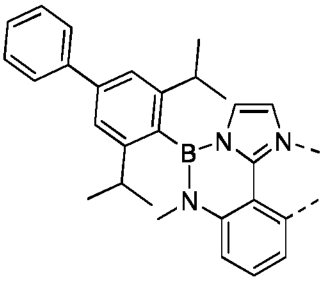
$L_{B462}$ ,
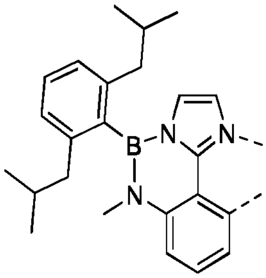
$L_{B463}$ ,
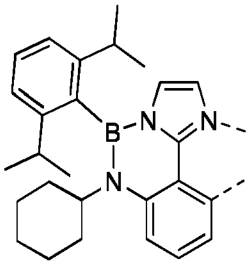
$L_{B464}$ ,
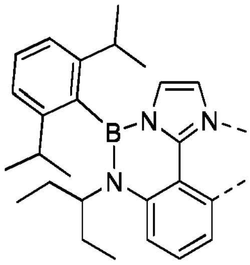
$L_{B465}$ ,

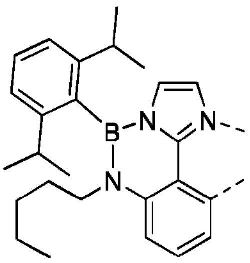
$L_{B466}$ ,
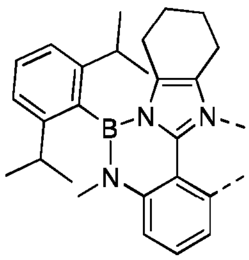
$L_{B467}$ ,
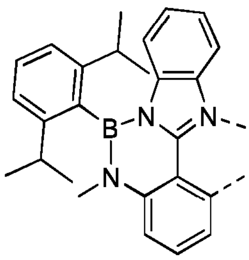
$L_{B468}$ ,
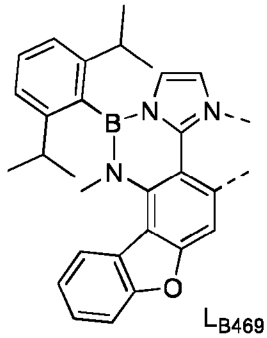
$L_{B469}$ ,

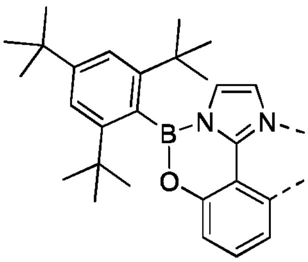
$L_{B470}$ ,
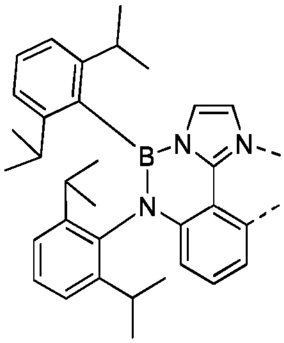
$L_{B471}$ ,
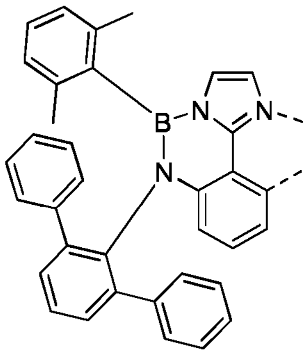
$L_{B472}$ ,
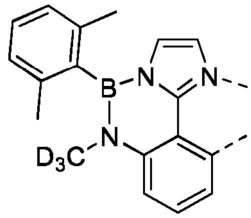
$L_{B473}$ ,

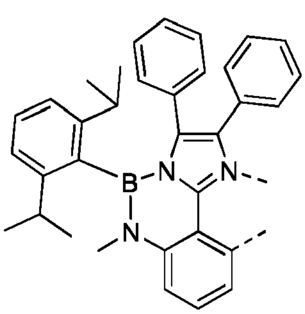
$L_{B474}$ ,
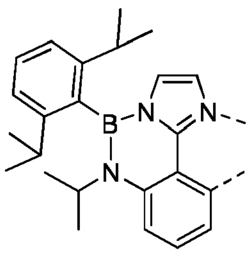
$L_{B475}$ ,
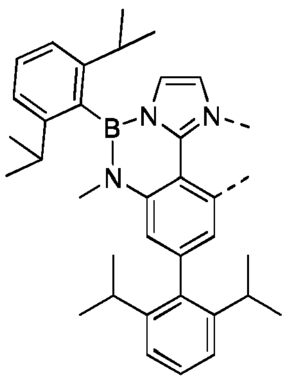
$L_{B476}$ ,
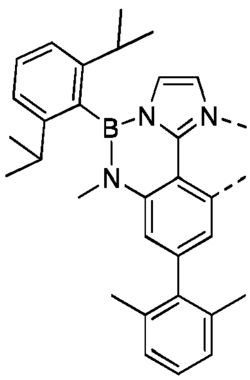
$L_{B477}$ ,

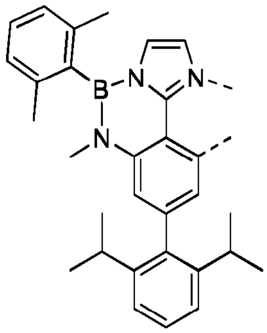
$L_{B478}$ ,
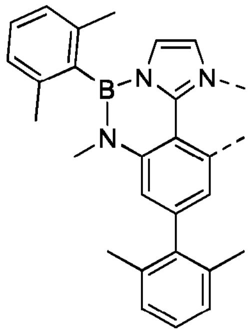
$L_{B479}$ ,
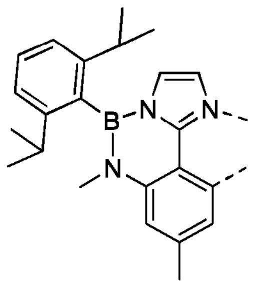
$L_{B480}$ ,
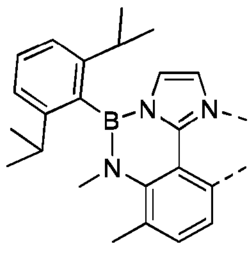
$L_{B481}$ ,

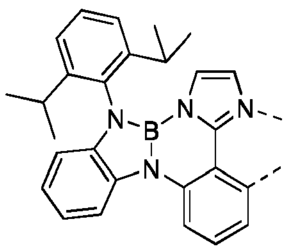
$L_{B482}$ , and
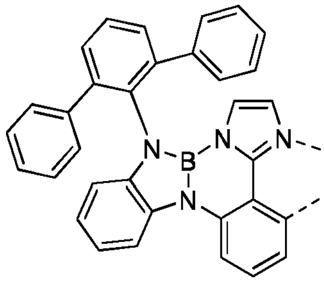
$L_{B483}$ ,
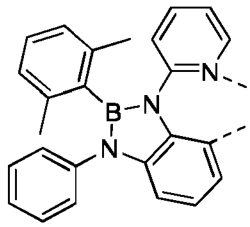
$L_{B484}$ ,

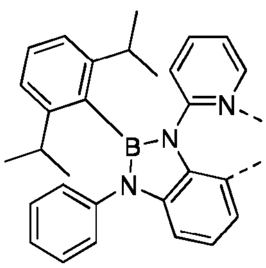
$L_{B485}$ ,
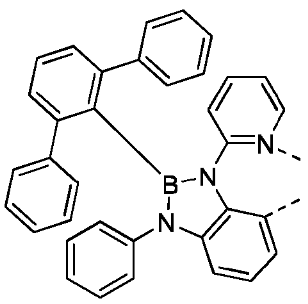
$L_{B486}$ ,
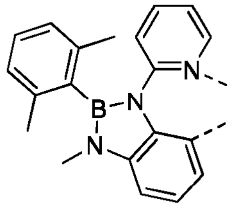
$L_{B487}$ ,
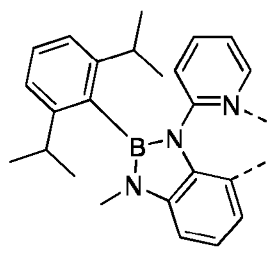
$L_{B488}$ ,

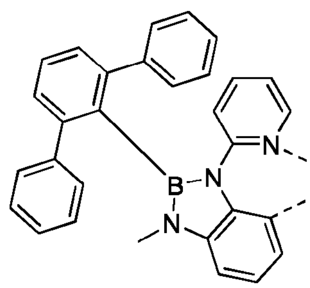
$L_{B489}$ ,
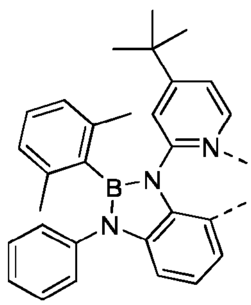
$L_{B490}$ ,
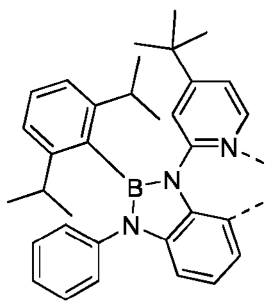
$L_{B491}$ ,

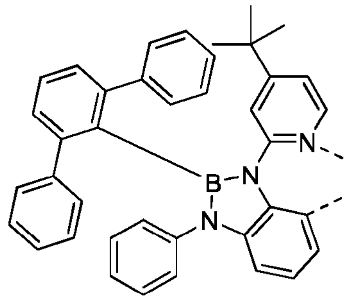

$L_{B492}$ ,

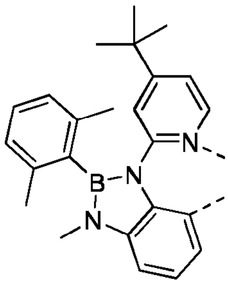

$L_{B493}$ ,

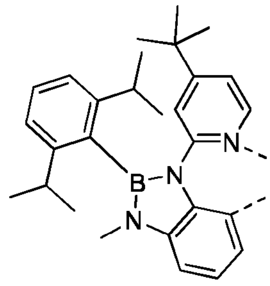

$L_{B494}$ ,

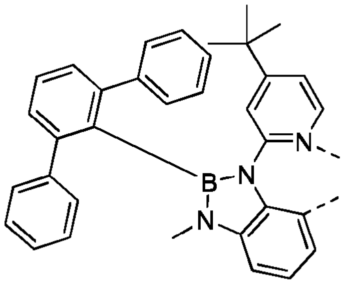

$L_{B495}$ ,

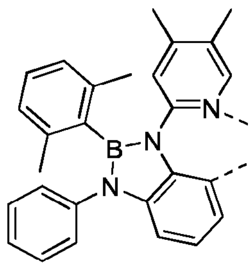

$L_{B496}$ ,

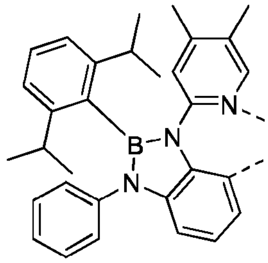

$L_{B497}$ ,

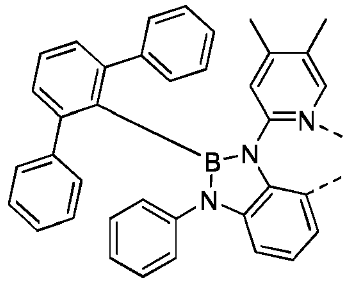

$L_{B498}$ ,

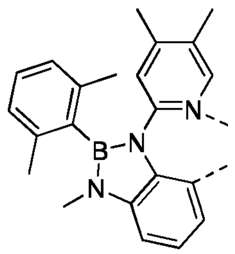

$L_{B499}$ ,

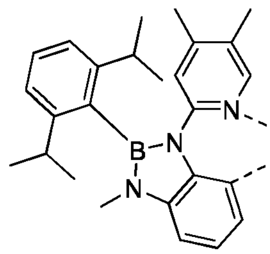

$L_{B500}$ ,

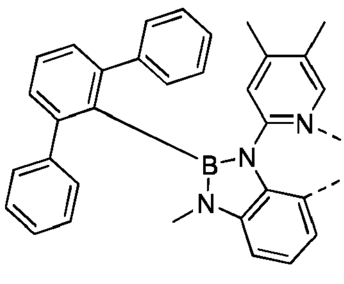

$L_{B501}$ ,

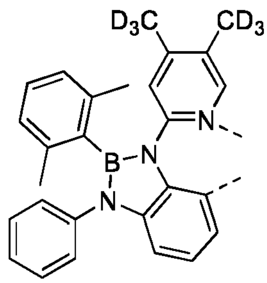

$L_{B502}$ ,

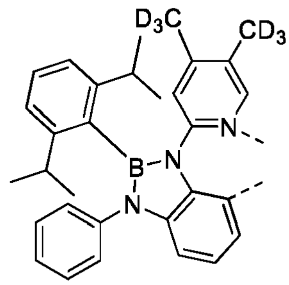

$L_{B503}$ ,

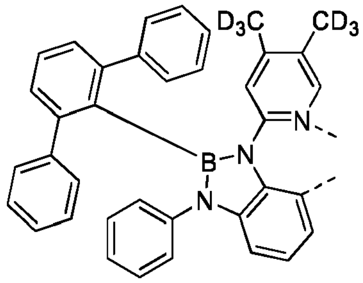
$L_{B504}$ ,
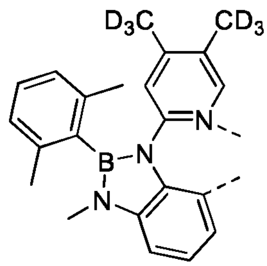
$L_{B505}$ ,
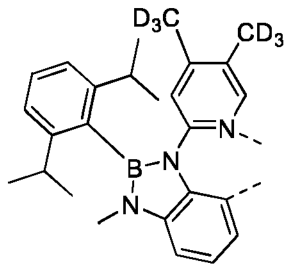
$L_{B506}$ ,

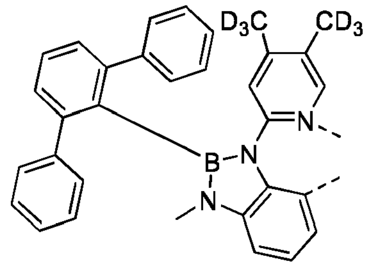
$L_{B507}$ ,
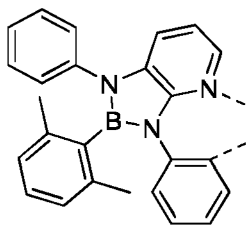
$L_{B508}$ ,
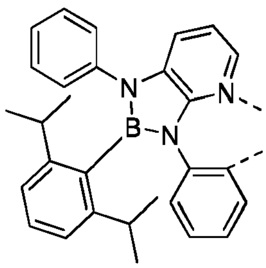
$L_{B509}$ ,

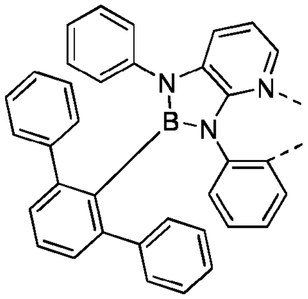
$L_{B510}$ ,
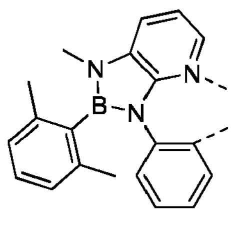
$L_{B511}$ ,
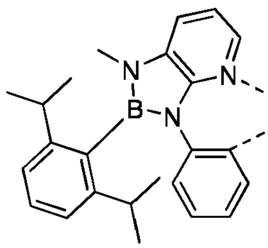
$L_{B512}$ ,
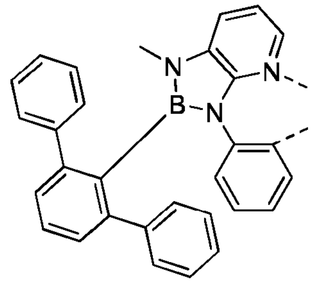
$L_{B513}$ ,

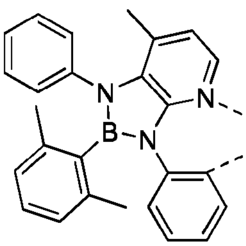
$L_{B514}$ ,
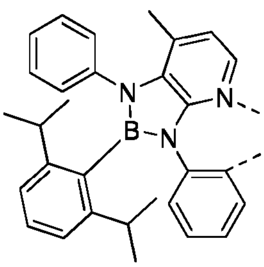
$L_{B515}$ ,
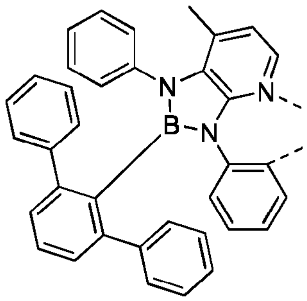
$L_{B516}$ ,
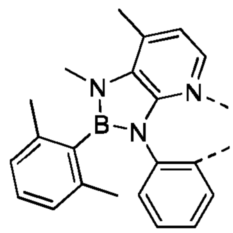
$L_{B517}$ ,

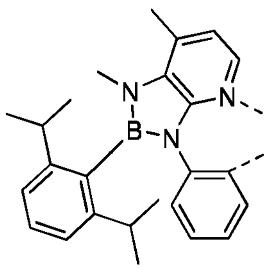

$L_{B518}$ ,

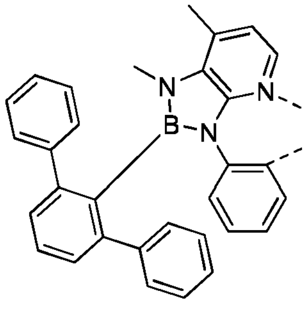

$L_{B519}$ ,

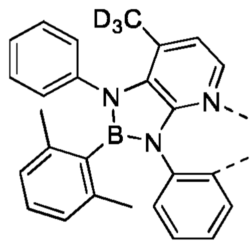

$L_{B520}$ ,

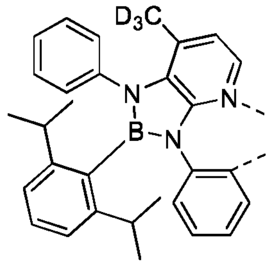

$L_{B521}$ ,

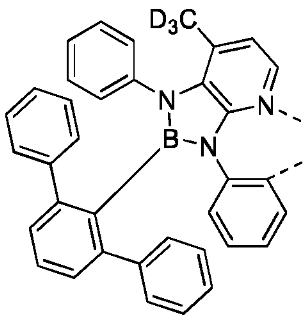

$L_{B522}$ ,

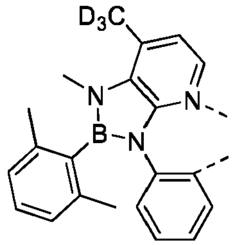

$L_{B523}$ ,

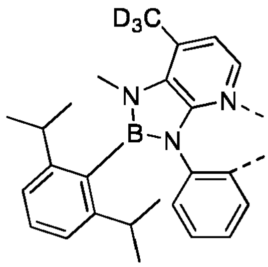

$L_{B524}$ ,

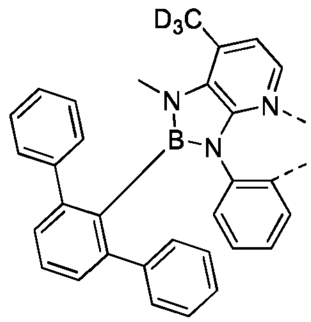

$L_{B525}$ ,

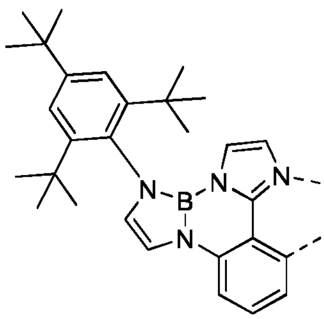

$L_{B526}$ ,

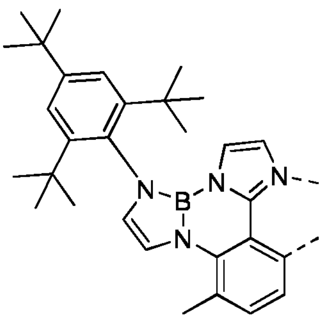

$L_{B527}$ ,

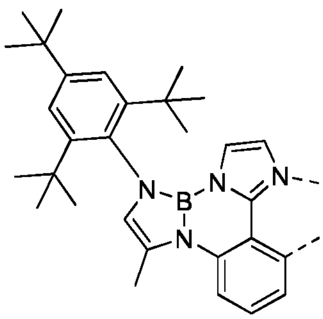

$L_{B528}$ ,

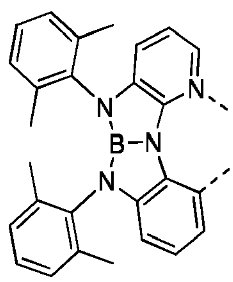

$L_{B529}$ ,

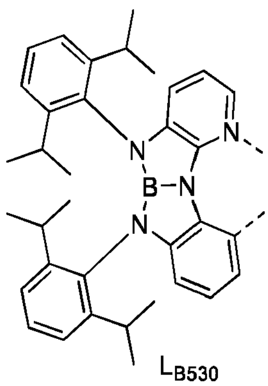

$L_{B530}$ ,

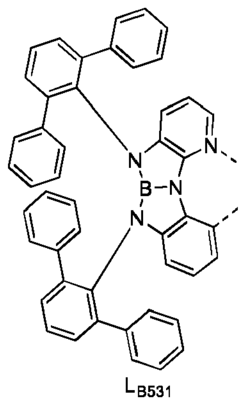

$L_{B531}$ ,

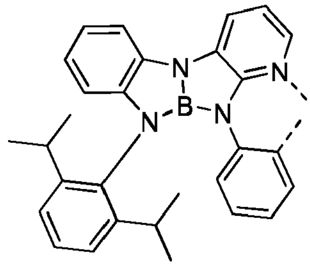

$L_{B532}$ ,

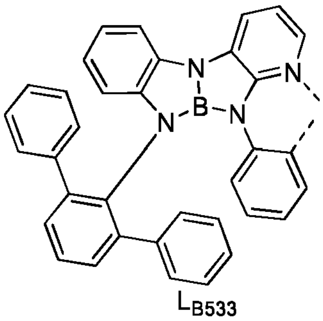

$L_{B533}$ ,

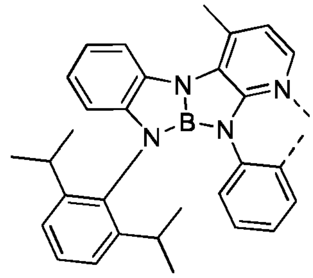

$L_{B534}$ ,

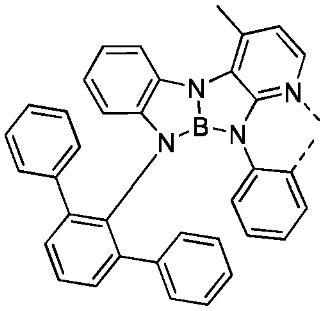

$L_{B535}$ ,

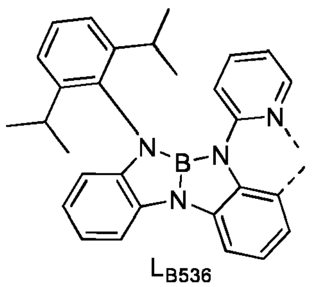

$L_{B536}$ ,

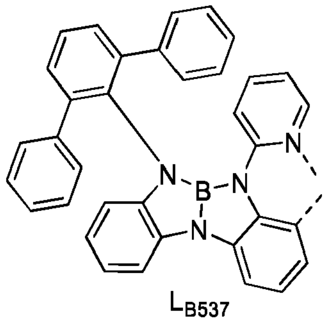

$L_{B537}$ ,

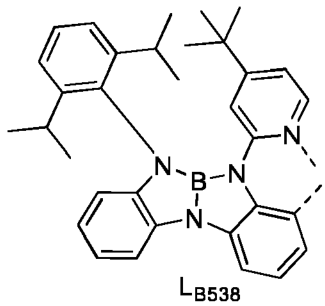

$L_{B538}$ ,

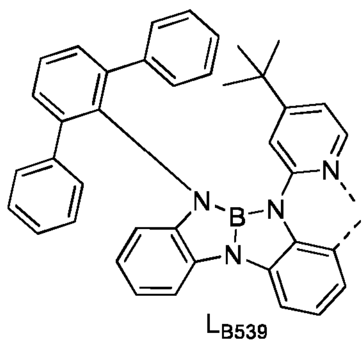

$L_{B539}$ ,

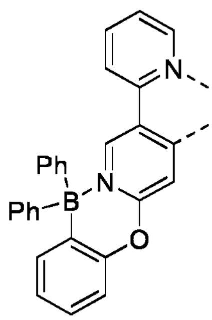

$L_{B540}$ ,

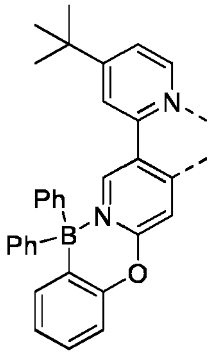

$L_{B541}$ ,

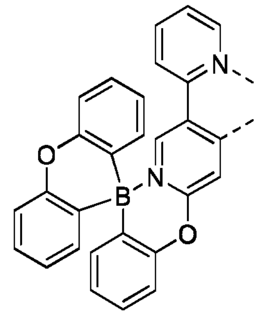

$L_{B542}$ ,

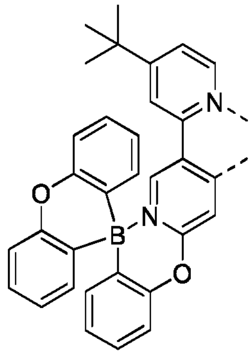

$L_{B543}$ ,

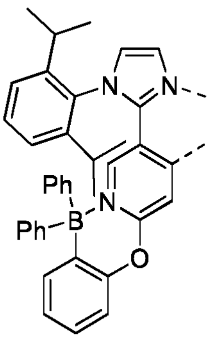

$L_{B544}$ ,

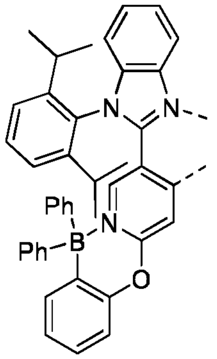

$L_{B545}$ ,

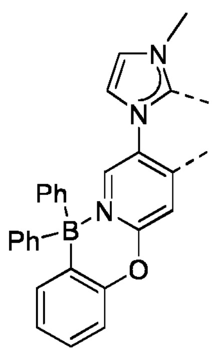

$L_{B546}$ ,

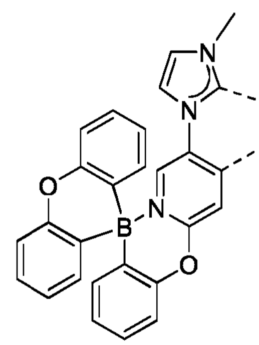

$L_{B547}$ ,

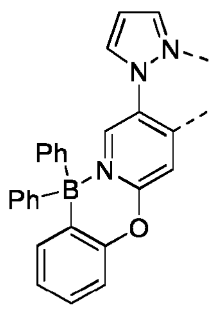
$L_{B548}$ ,
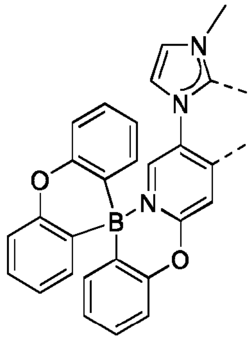
$L_{B549}$ ,
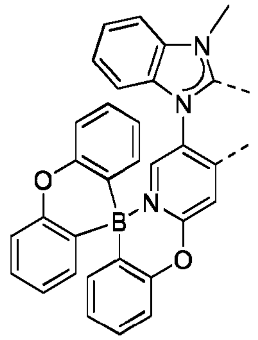
$L_{B550}$ ,
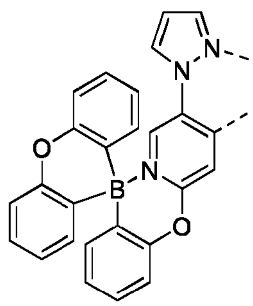
$L_{B551}$ ,

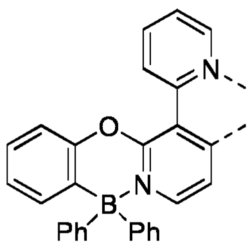
$L_{B552}$ ,
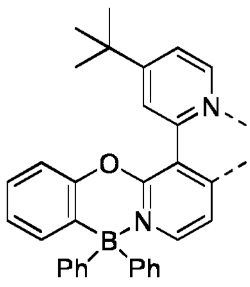
$L_{B553}$ ,
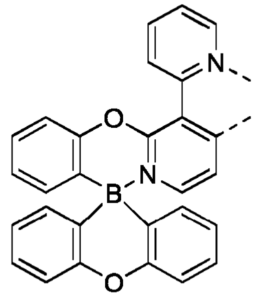
$L_{B554}$ ,
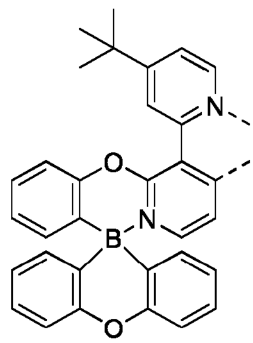
$L_{B555}$ ,

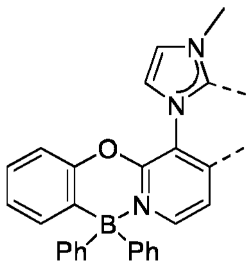
$L_{B556}$ ,
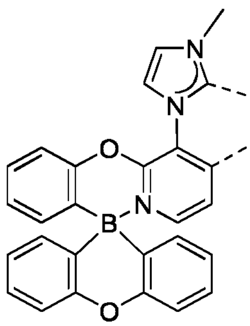
$L_{B557}$ ,
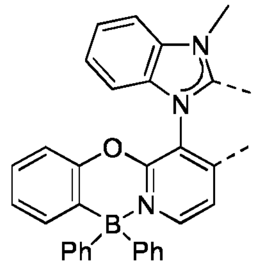
$L_{B558}$ ,
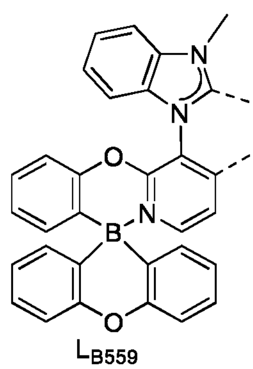
$L_{B559}$ ,

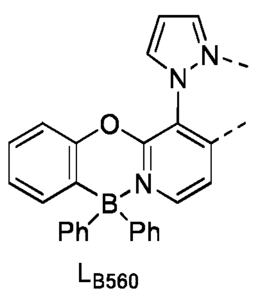
$L_{B560}$ ,
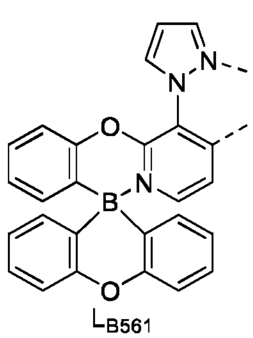
$L_{B561}$ ,
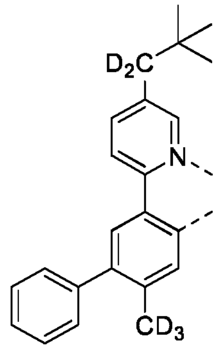
$L_{B562}$ ,
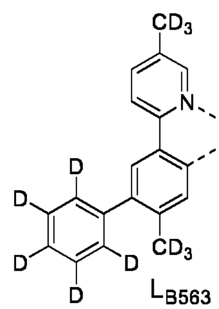
$L_{B563}$ ,
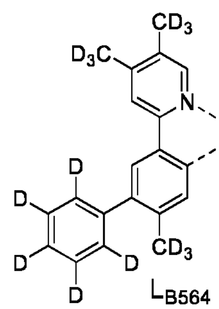
$L_{B564}$ ,

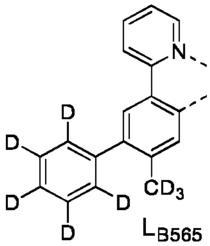
$L_{B565}$,
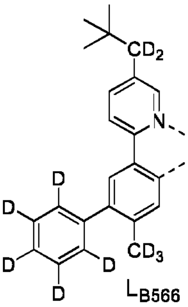
$L_{B566}$,
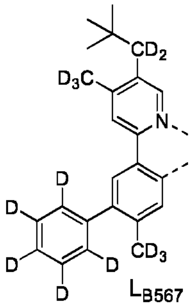
$L_{B567}$,
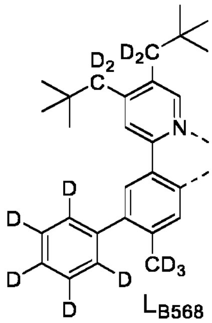
$L_{B568}$,
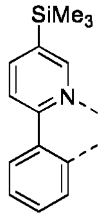
$L_{B569}$,
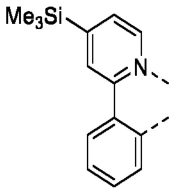
$L_{B570}$,

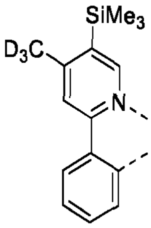
$L_{B571}$,
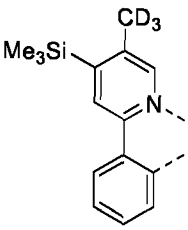
$L_{B572}$,
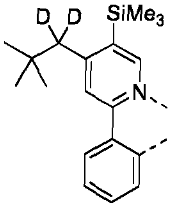
$L_{B573}$,
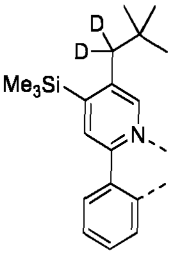
$L_{B574}$,
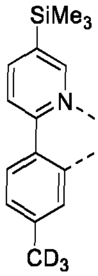
$L_{B575}$,
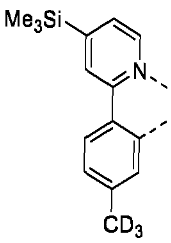
$L_{B576}$,
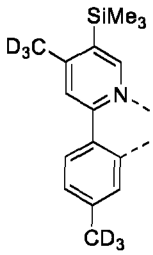
$L_{B577}$,

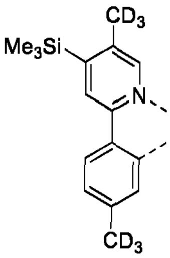
$L_{B578}$,
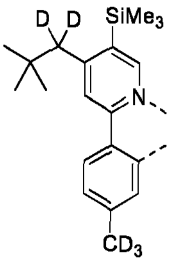
$L_{B579}$,
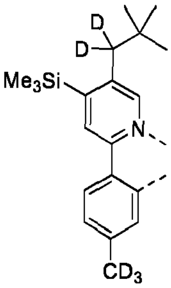
$L_{B580}$,
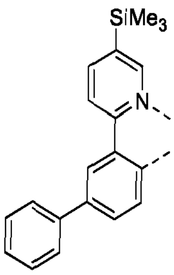
$L_{B581}$,
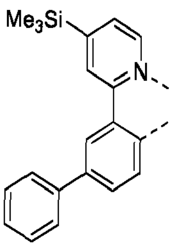
$L_{B582}$,
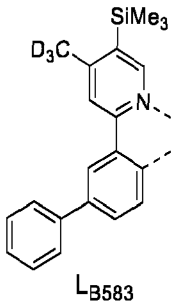
$L_{B583}$,

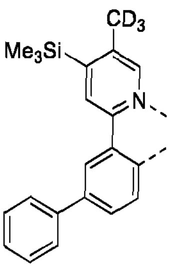
$L_{B584}$,
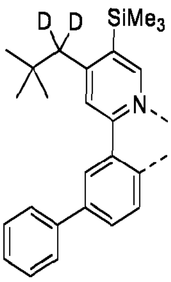
$L_{B585}$,
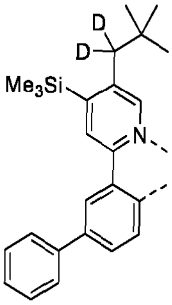
$L_{B586}$,
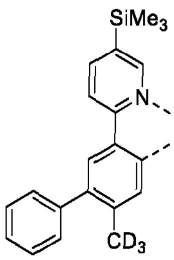
$L_{B587}$,
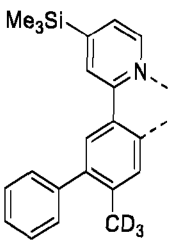
$L_{B588}$,
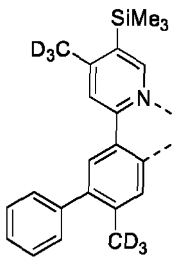
$L_{B589}$,

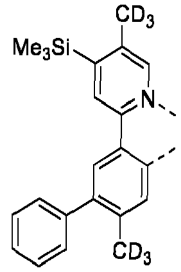
$L_{B590}$ ,
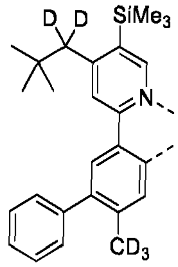
$L_{B591}$ ,
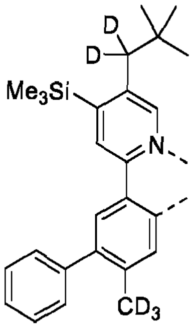
$L_{B592}$ ,
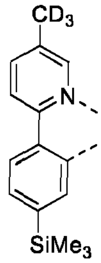
$L_{B593}$ ,
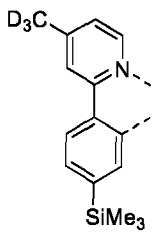
$L_{B594}$ ,
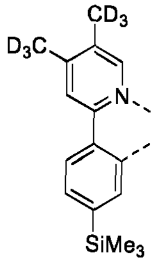
$L_{B595}$ ,
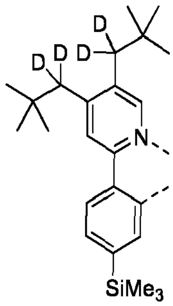
$L_{B596}$ ,

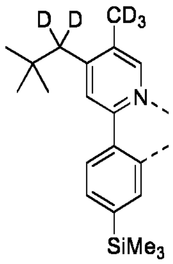
$L_{B597}$ ,
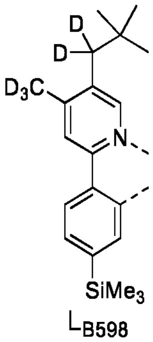
$L_{B598}$ ,
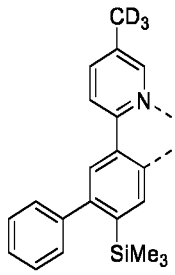
$L_{B599}$ ,
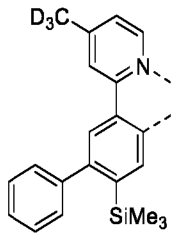
$L_{B600}$ ,
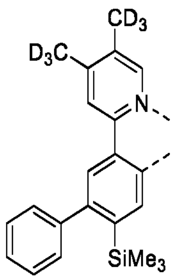
$L_{B601}$ ,
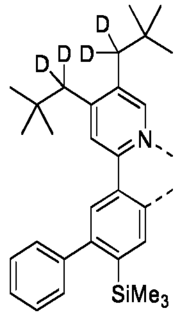
$L_{B602}$ ,

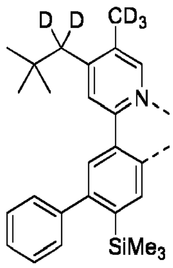
$L_{B603}$ ,
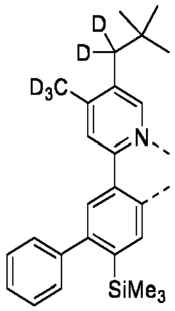
$L_{B604}$ ,
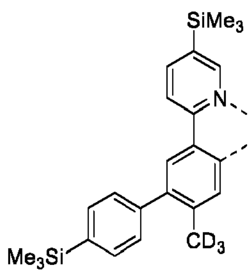
$L_{B605}$ ,
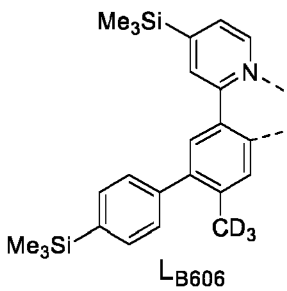
$L_{B606}$ ,
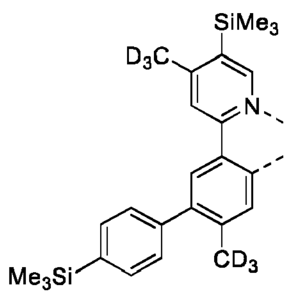
$L_{B607}$ ,

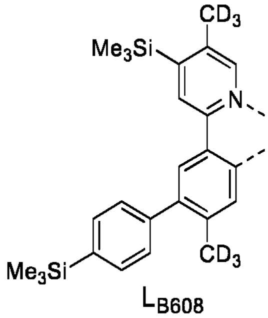
$L_{B608}$ ,
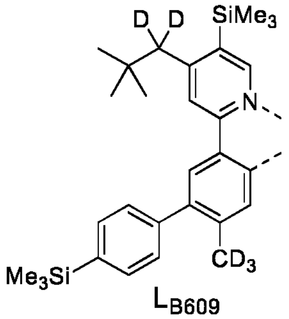
$L_{B609}$ ,
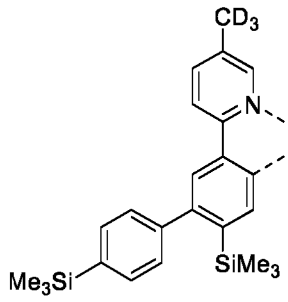
$L_{B610}$ ,
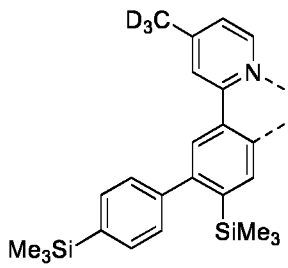
$L_{B611}$ ,

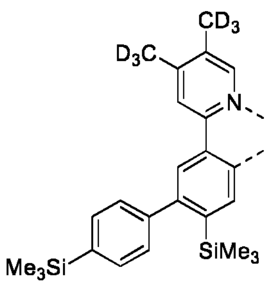
$L_{B612}$ ,
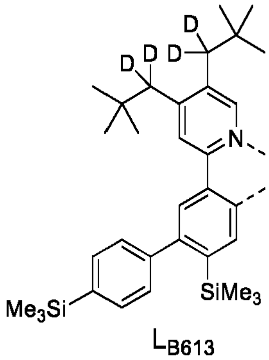
$L_{B613}$ ,
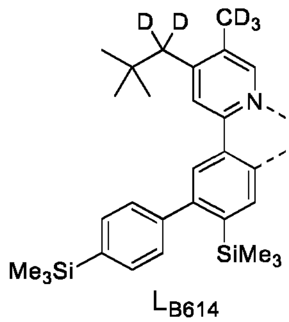
$L_{B614}$ ,
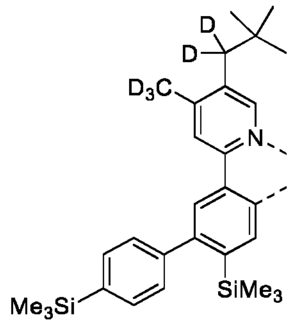
$L_{B615}$ ,

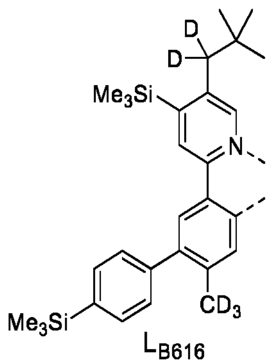
$L_{B616}$ ,
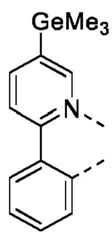
$L_{B617}$ ,
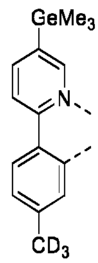
$L_{B618}$ ,
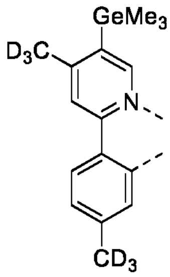
$L_{B619}$
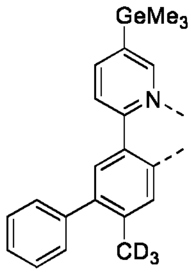
$L_{B622}$ ,
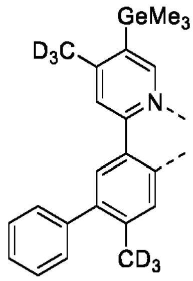
$L_{B621}$ ,

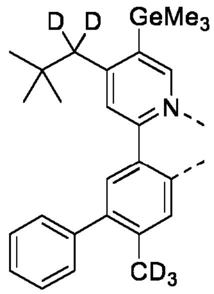
$L_{B622}$ ,
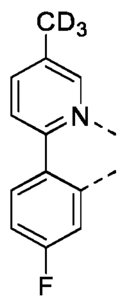
$L_{B623}$ ,
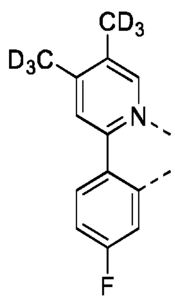
$L_{B624}$ ,
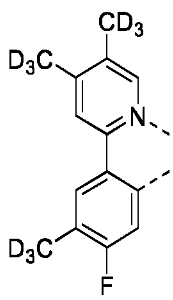
$L_{B625}$ ,
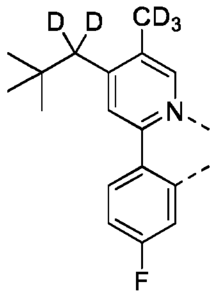
$L_{B626}$ ,
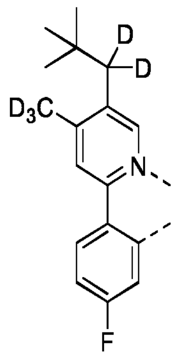
$L_{B627}$ ,

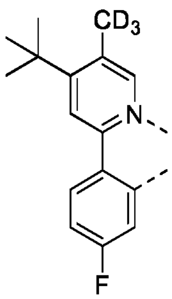
$L_{B628}$ ,
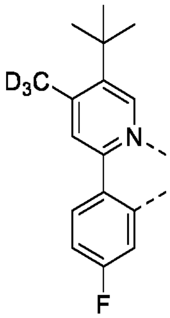
$L_{B629}$ ,
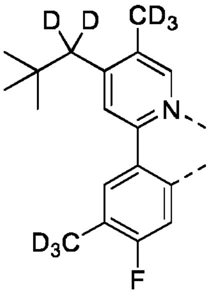
$L_{B630}$ ,
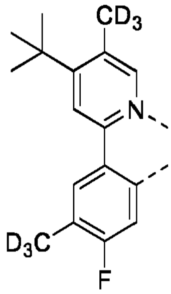
$L_{B631}$ ,
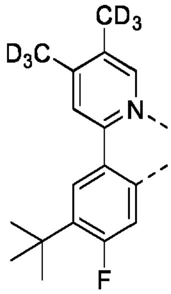
$L_{B632}$ ,
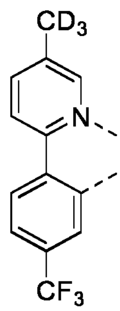
$L_{B633}$ ,

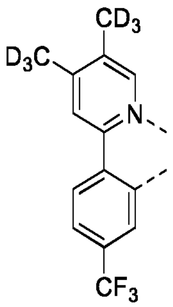
$L_{B634}$ ,
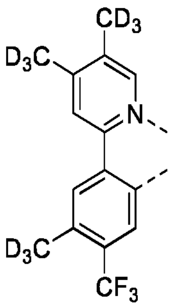
$L_{B635}$ ,
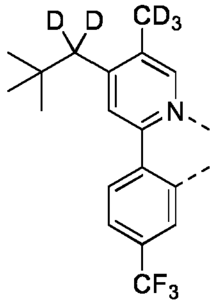
$L_{B636}$ ,
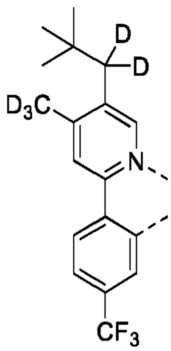
$L_{B637}$ ,
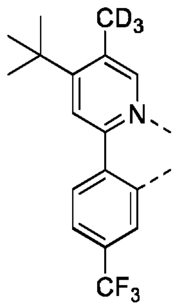
$L_{B638}$ ,
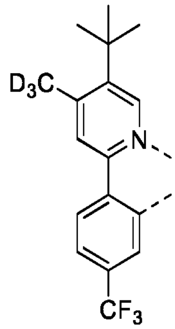
$L_{B639}$ ,

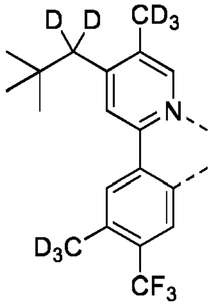
$L_{B640}$ ,
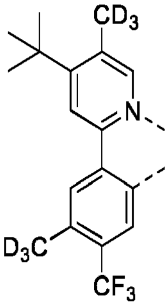
$L_{B641}$ ,
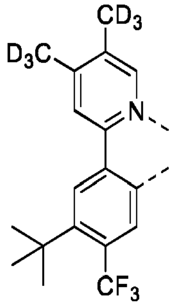
$L_{B642}$ ,
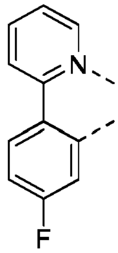
$L_{B643}$ ,
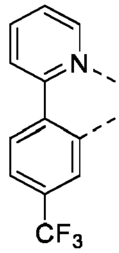
$L_{B644}$ ,
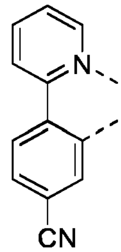
$L_{B645}$ ,
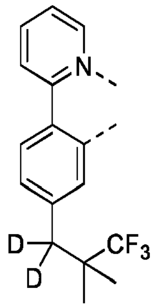
$L_{B646}$ ,

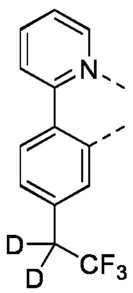
$L_{B647}$ ,
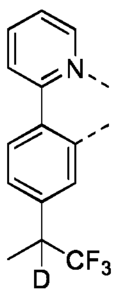
$L_{B648}$ ,
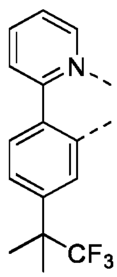
$L_{B649}$ ,
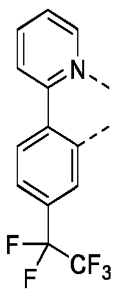
$L_{B650}$ ,
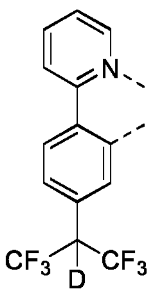
$L_{B651}$ ,
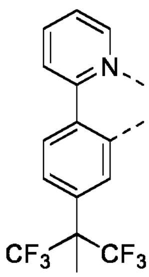
$L_{B652}$ ,
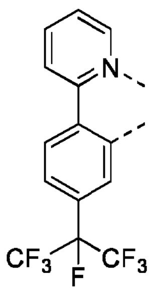
$L_{B653}$ ,
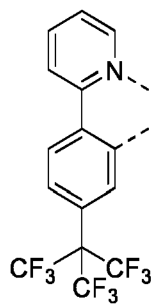
$L_{B654}$ ,

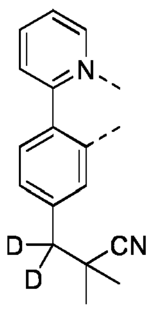
$L_{B655}$ ,
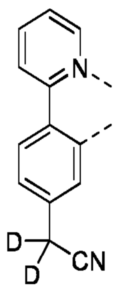
$L_{B656}$ ,
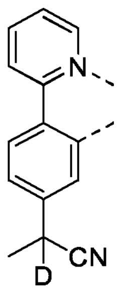
$L_{B657}$ ,
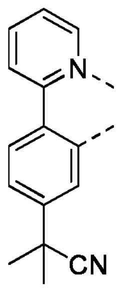
$L_{B658}$ ,
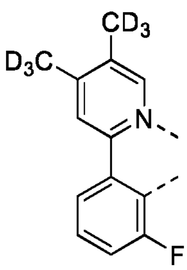
$L_{B659}$ ,
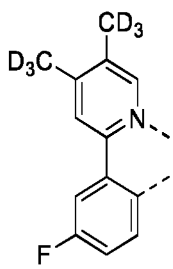
$L_{B660}$ ,
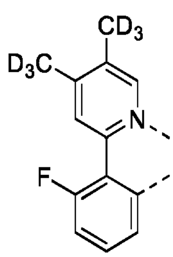
$L_{B661}$ ,

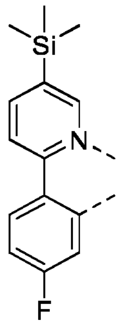
$L_{B662}$ ,
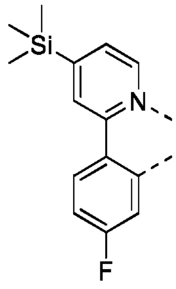
$L_{B663}$ ,
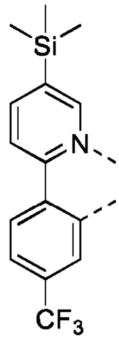
$L_{B664}$ ,
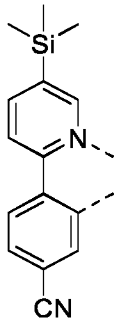
$L_{B665}$ ,
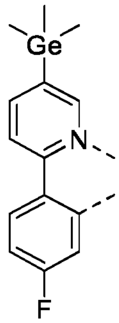
$L_{B666}$ ,
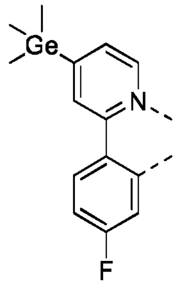
$L_{B667}$ ,
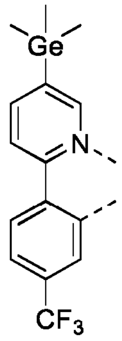
$L_{B668}$ ,
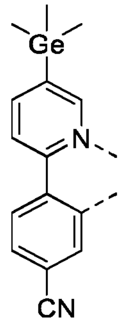
$L_{B669}$ ,

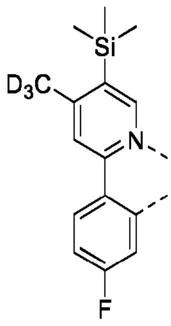
$L_{B670}$ ,
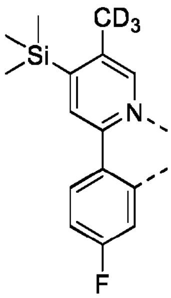
$L_{B671}$ ,
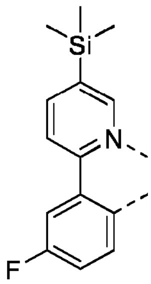
$L_{B672}$ ,
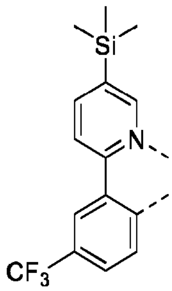
$L_{B673}$ ,
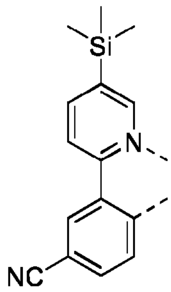
$L_{B674}$ ,
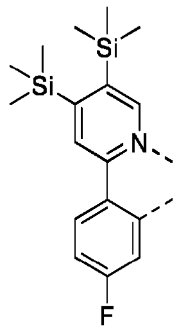
$L_{B675}$ ,

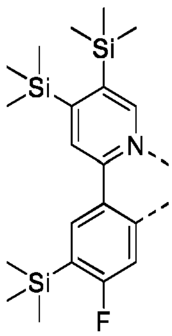
$L_{B676}$ ,
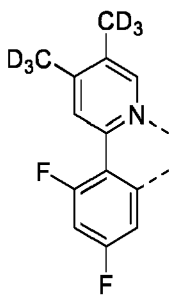
$L_{B677}$ ,
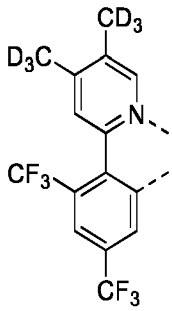
$L_{B678}$ ,
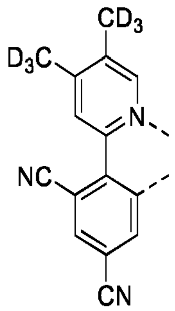
$L_{B679}$ ,
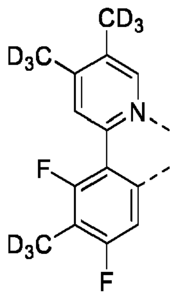
$L_{B680}$ ,
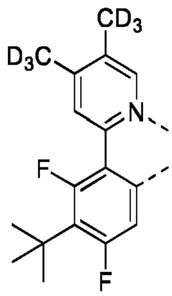
$L_{B681}$ ,

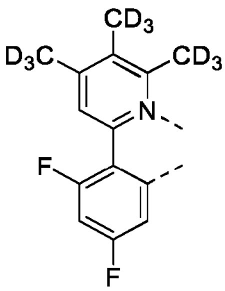
$L_{B682}$ ,
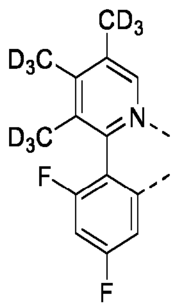
$L_{B683}$ ,
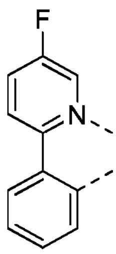
$L_{B684}$ ,
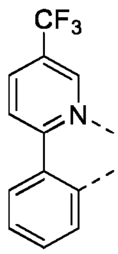
$L_{B685}$ ,
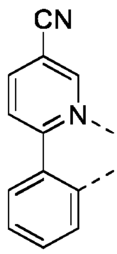
$L_{B686}$ ,
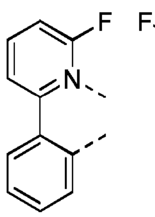
$L_{B687}$ ,
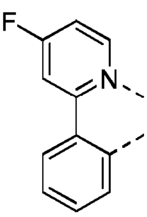
$L_{B688}$ ,

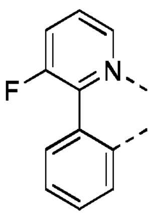
$L_{B689}$ ,
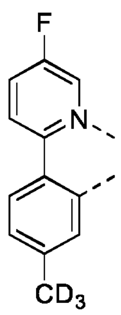
$L_{B690}$ ,
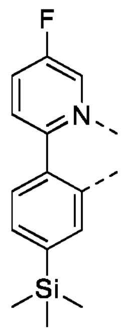
$L_{B691}$ ,
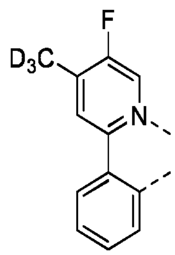
$L_{B692}$ ,
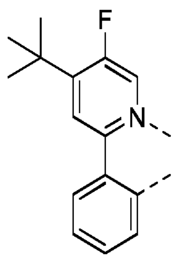
$L_{B693}$ ,
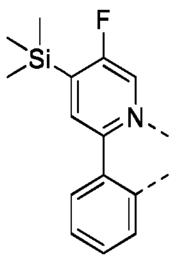
$L_{B694}$ ,
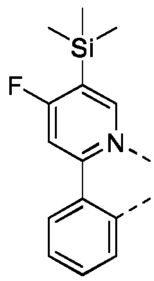
$L_{B695}$ ,

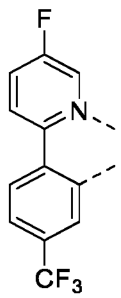
$L_{B696}$ ,
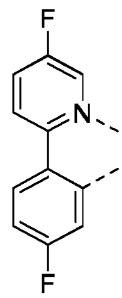
$L_{B697}$ ,
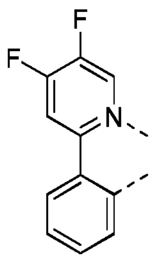
$L_{B698}$ ,
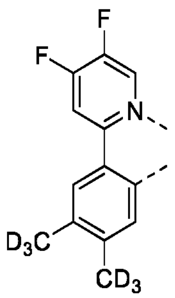
$L_{B699}$ ,
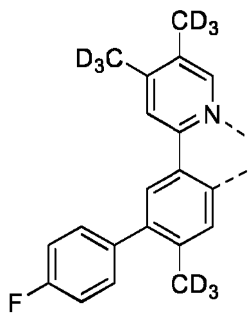
$L_{B700}$ ,
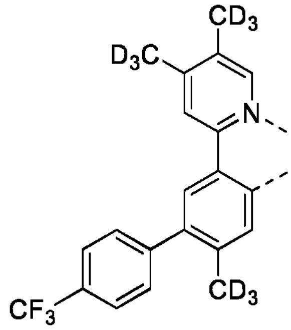
$L_{B701}$ ,

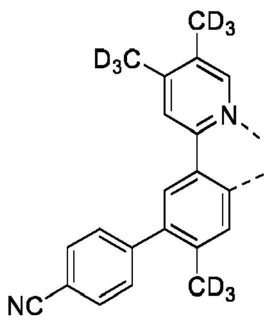
$L_{B702}$ ,
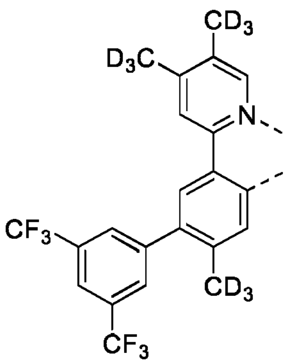
$L_{B703}$ ,
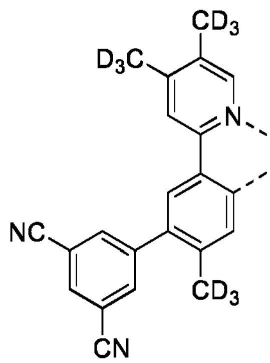
$L_{B704}$ ,
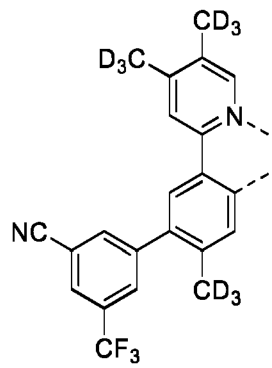
$L_{B705}$ ,

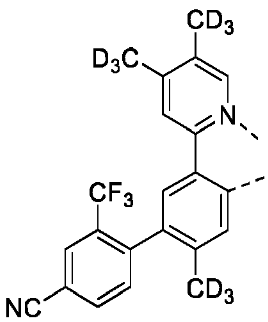
$L_{B706}$ ,
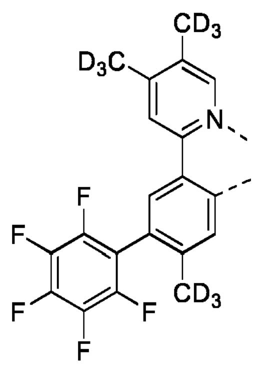
$L_{B707}$ ,
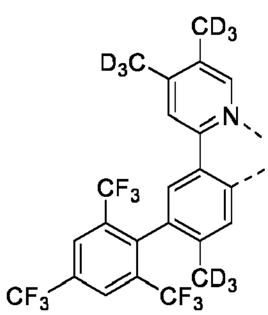
$L_{B708}$ ,
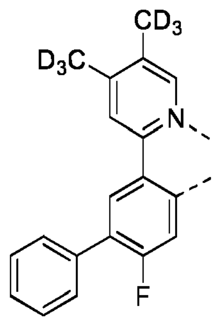
$L_{B709}$ ,

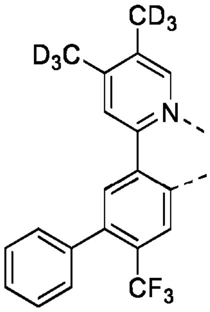
$L_{B710}$ ,
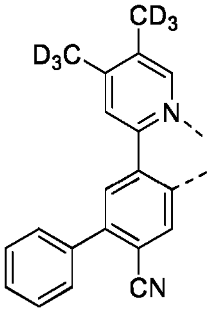
$L_{B711}$ ,
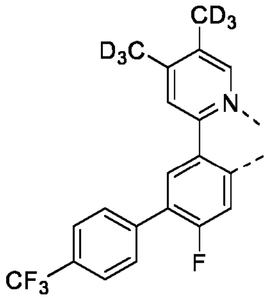
$L_{B712}$ ,
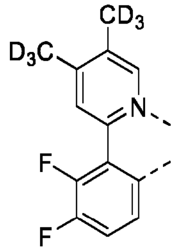
$L_{B713}$ ,
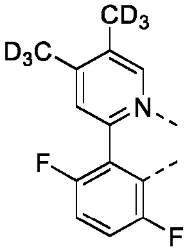
$L_{B714}$ ,

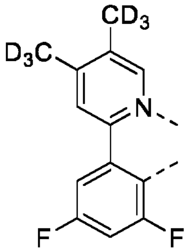
$L_{B715}$ ,
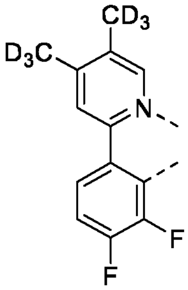
$L_{B716}$ ,
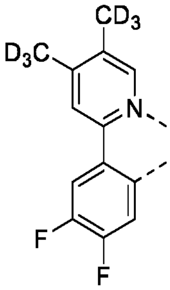
$L_{B717}$ ,
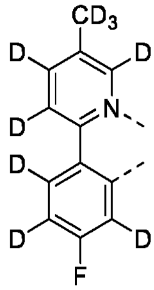
$L_{B718}$ ,
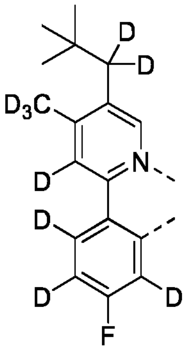
$L_{B719}$ ,
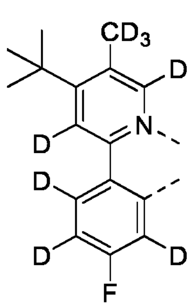
$L_{B720}$ ,

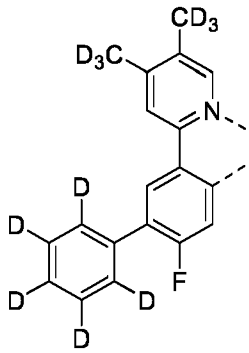
$L_{B721}$ ,
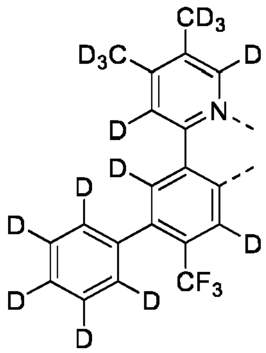
$L_{B722}$ ,
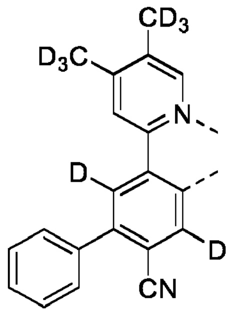
$L_{B723}$ ,
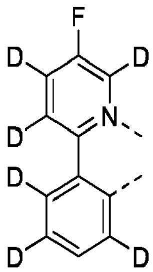
$L_{B724}$ ,
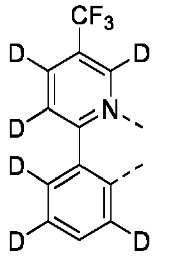
$L_{B725}$ ,

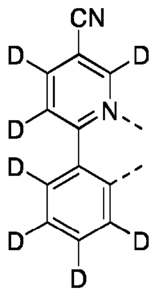
$L_{B726}$ ,
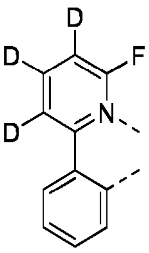
$L_{B727}$ ,
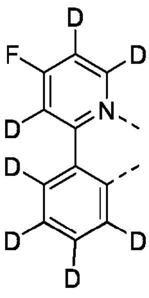
$L_{B728}$ ,
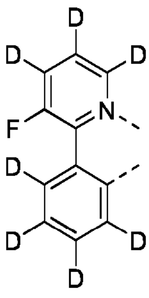
$L_{B729}$ ,
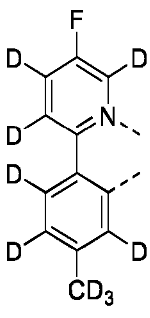
$L_{B730}$ ,
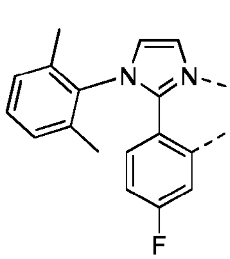
$L_{B731}$ ,

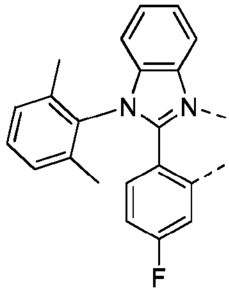
$L_{B732}$ ,
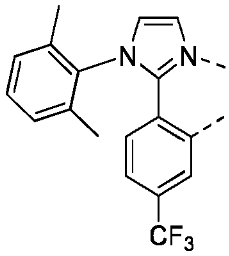
$L_{B733}$ ,
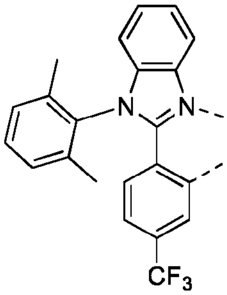
$L_{B734}$ ,
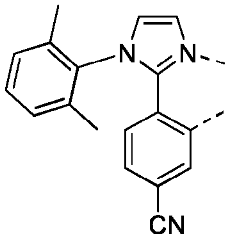
$L_{B735}$ ,
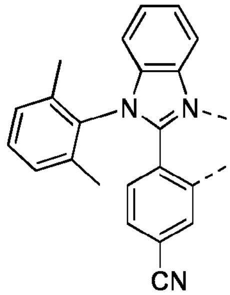
$L_{B736}$

,
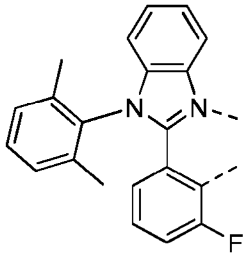
$L_{B737}$ ,
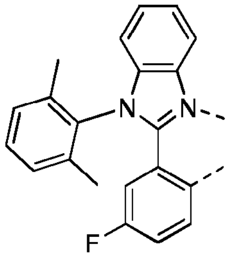
$L_{B738}$ ,
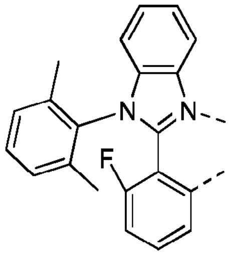
$L_{B739}$ ,
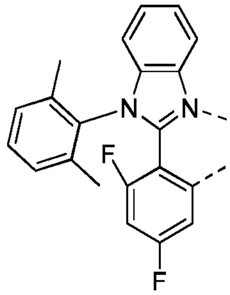
$L_{B740}$ ,

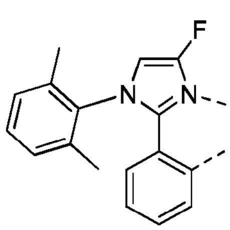
$L_{B741}$ ,
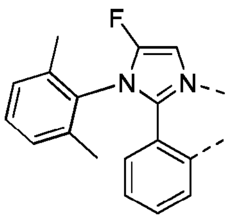
$L_{B742}$ ,
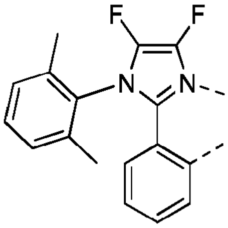
$L_{B743}$ ,
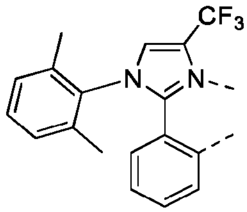
$L_{B744}$ ,

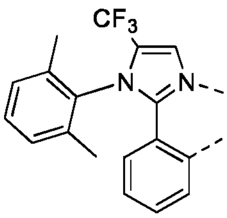
$L_{B745}$ ,
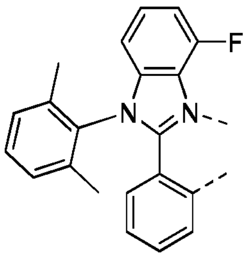
$L_{B746}$ ,
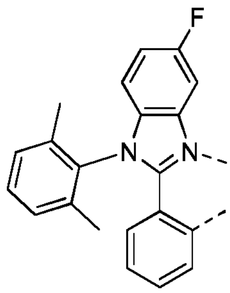
$L_{B747}$ ,
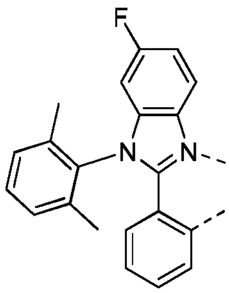
$L_{B748}$ ,

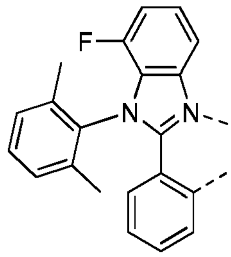
$L_{B749}$,
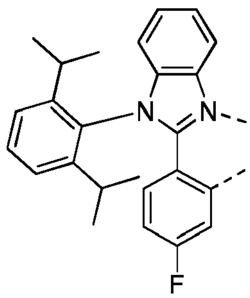
$L_{B750}$,
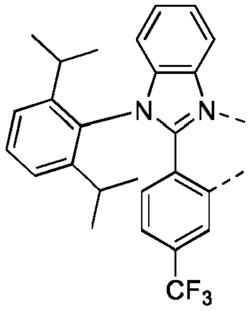
$L_{B751}$,
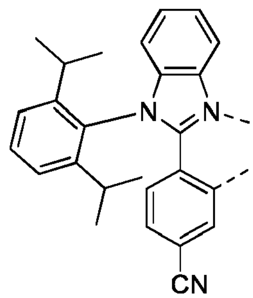
$L_{B752}$,
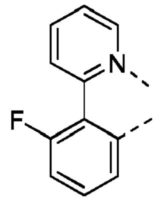
$L_{B753}$,

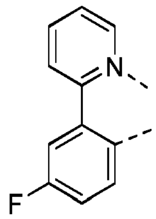
$L_{B754}$,
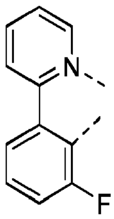
$L_{B755}$,
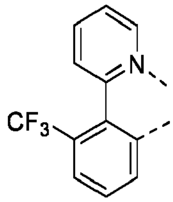
$L_{B756}$,
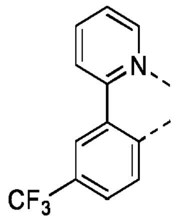
$L_{B757}$,
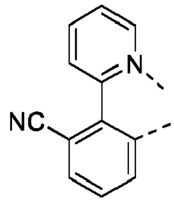
$L_{B758}$,
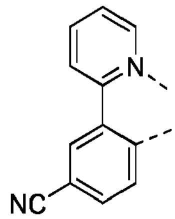
$L_{B759}$,
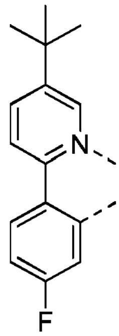
$L_{B760}$,

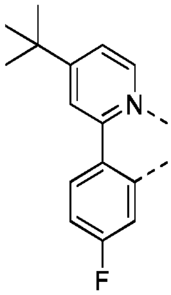
$L_{B761}$,
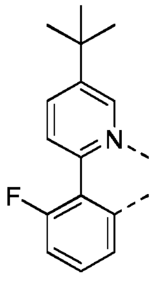
$L_{B762}$,
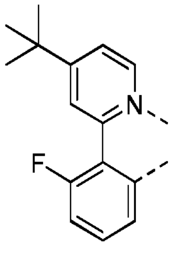
$L_{B763}$,
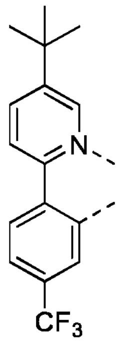
$L_{B764}$,
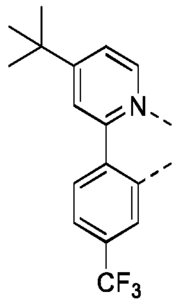
$L_{B765}$,
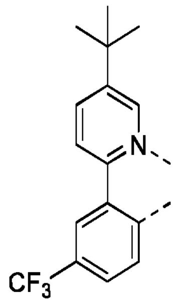
$L_{B766}$,

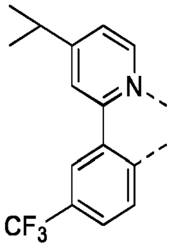
$L_{B767}$,
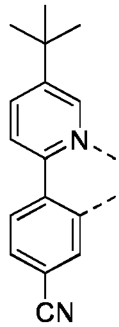
$L_{B768}$,
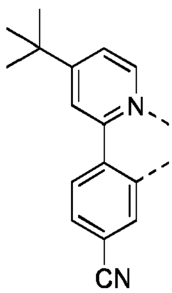
$L_{B769}$,

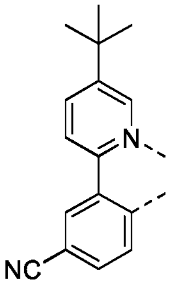
$L_{B770}$ ,
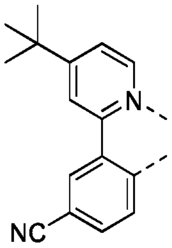
$L_{B771}$ ,
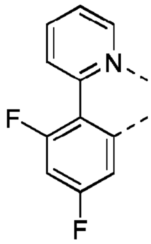
$L_{B772}$ ,
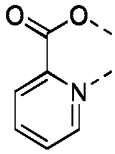
$L_{B773}$ ,
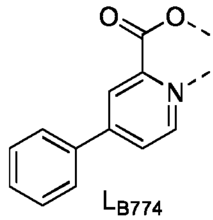
$L_{B774}$ ,
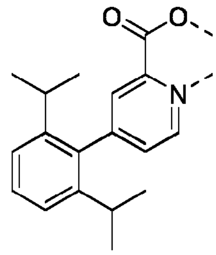
$L_{B775}$ ,

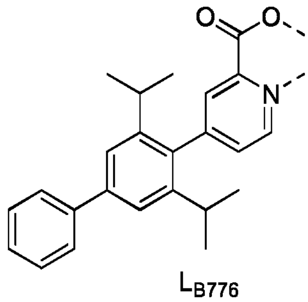
$L_{B776}$ ,
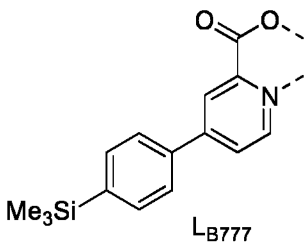
$L_{B777}$ ,
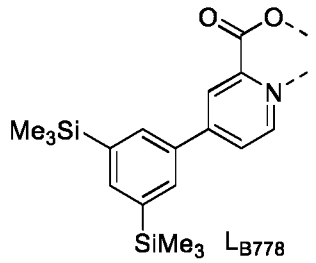
$L_{B778}$ ,

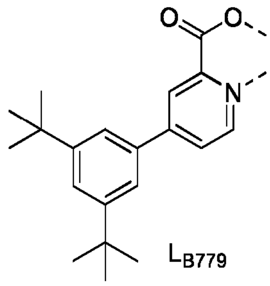
$L_{B779}$ ,
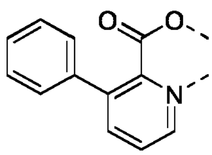
$L_{B780}$ ,
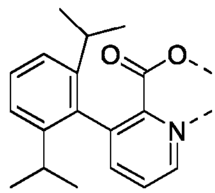
$L_{B781}$ ,
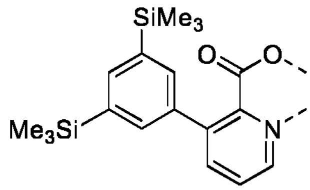
$L_{B782}$ ,

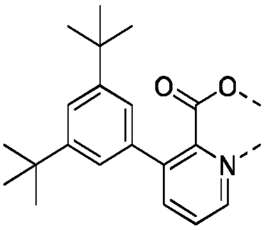
$L_{B783}$ ,
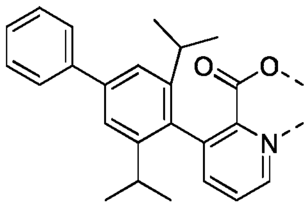
$L_{B784}$ ,
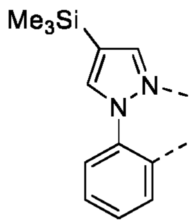
$L_{B785}$ ,
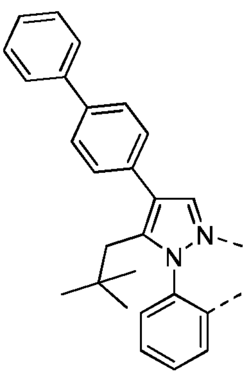
$L_{B786}$ ,

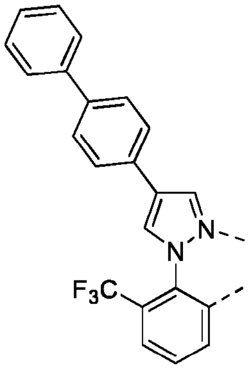
$L_{B787}$ ,
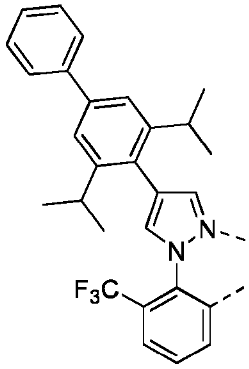
$L_{B788}$ ,
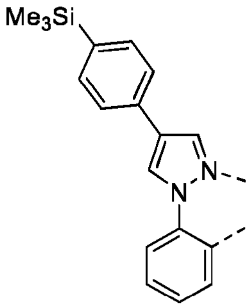
$L_{B789}$ ,
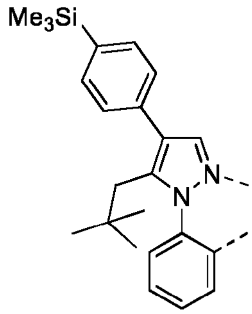
$L_{B790}$ ,

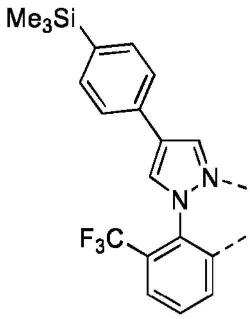
$L_{B791}$ ,
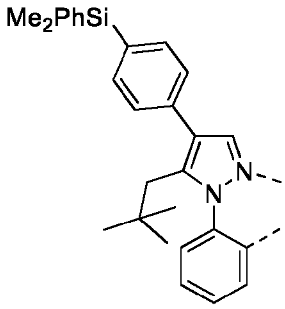
$L_{B792}$ ,
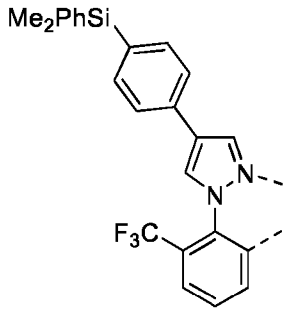
$L_{B793}$ ,
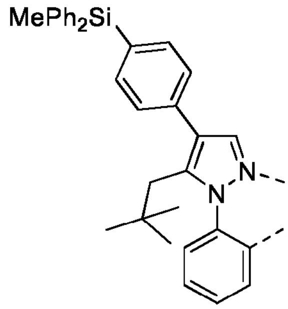
$L_{B794}$ ,

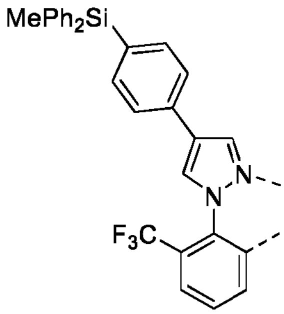
$L_{B795}$ ,
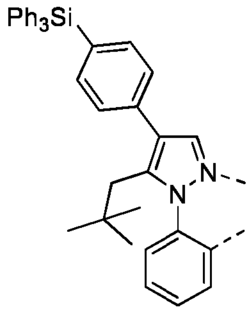
$L_{B796}$ ,
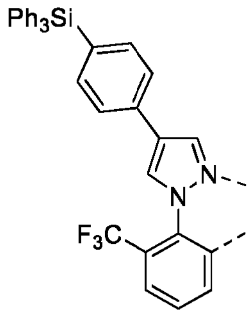
$L_{B797}$ ,
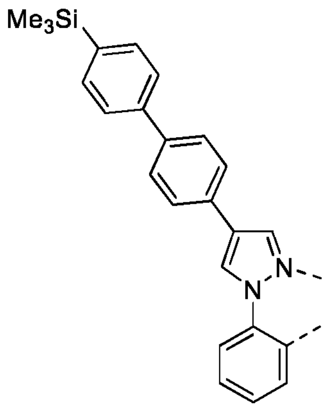
$L_{B798}$ ,

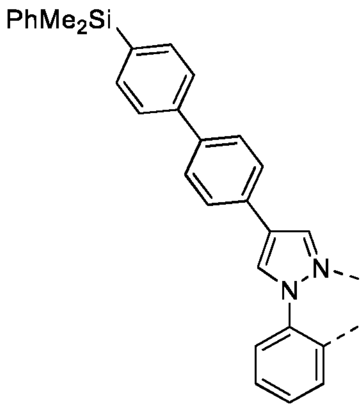

$L_{B799}$ ,

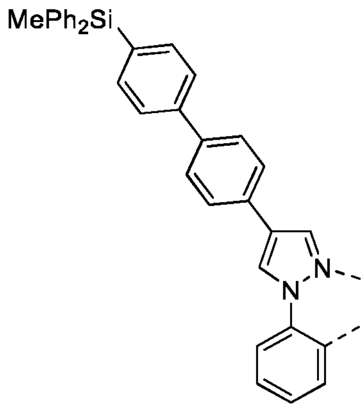

$L_{B800}$ ,

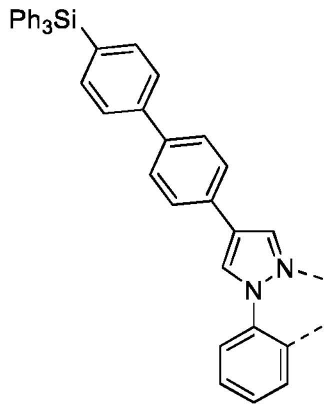

$L_{B801}$ ,

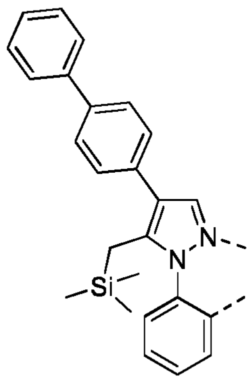

$L_{B802}$ ,

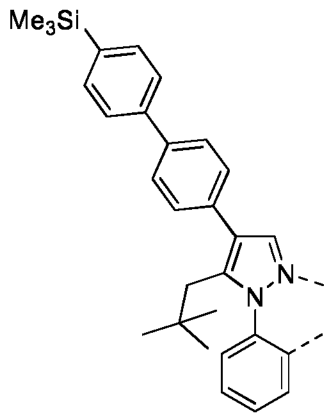

$L_{B803}$ ,

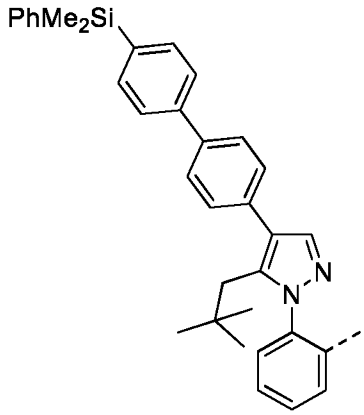

$L_{B804}$ ,

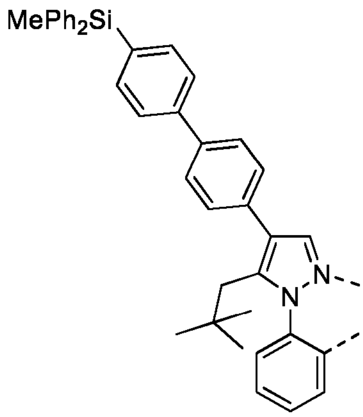

$L_{B805}$ ,

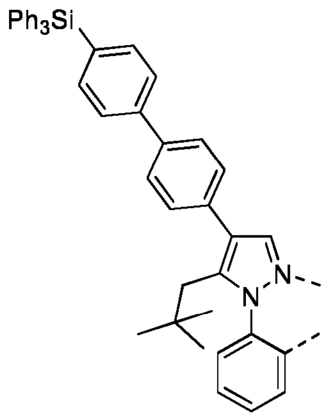

$L_{B806}$ ,

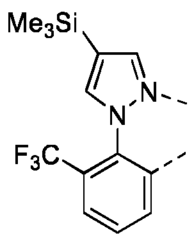

$L_{B807}$ ,

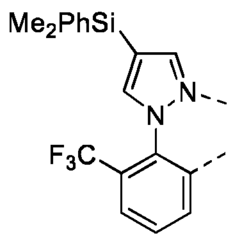

$L_{B808}$ ,

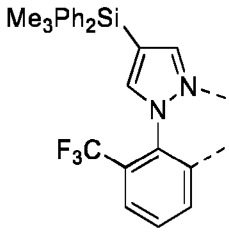

$L_{B809}$ ,

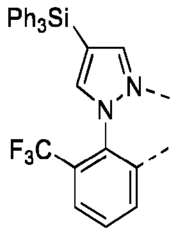

$L_{B810}$ ,

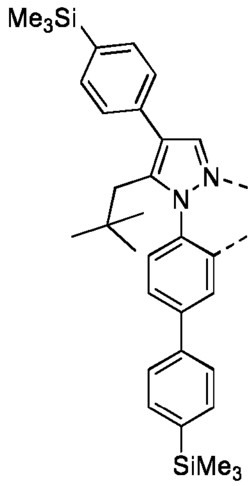

$L_{B811}$ ,

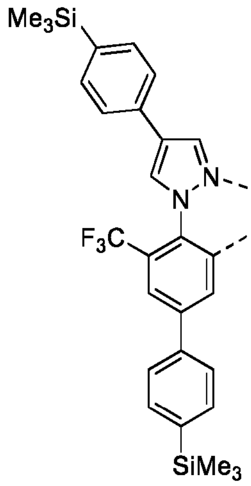

$L_{B812}$ ,

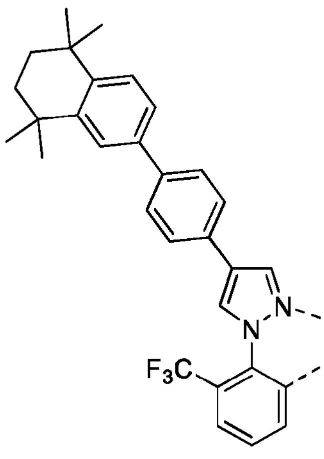

$L_{B813}$ ,

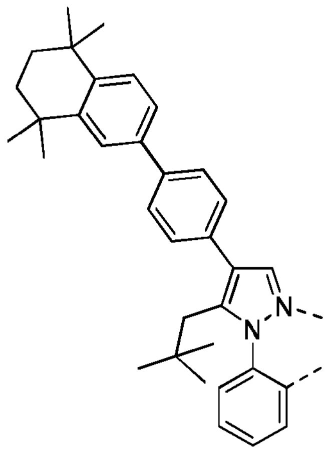

$L_{B814}$ ,

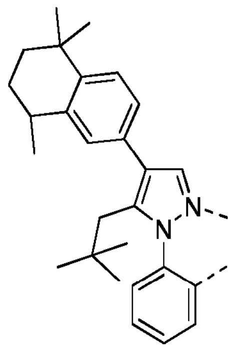

$L_{B815}$ ,

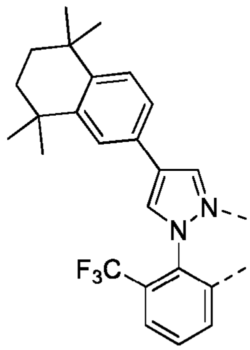

$L_{B816}$ ,

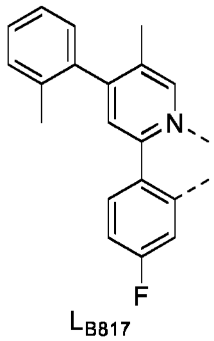

$L_{B817}$ ,

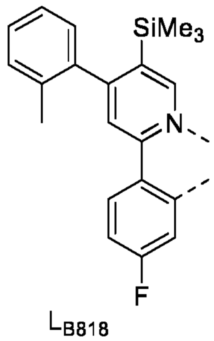

$L_{B818}$ ,

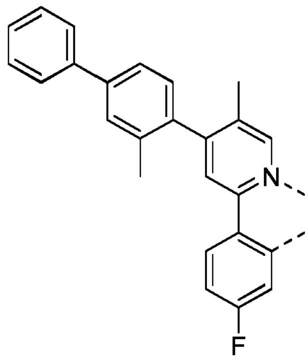

$L_{B8189}$ ,

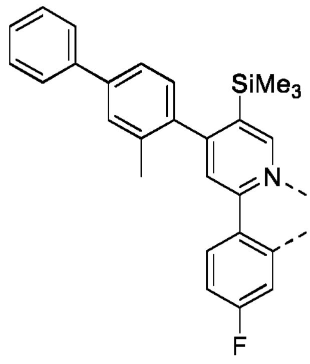

$L_{B820}$ ,

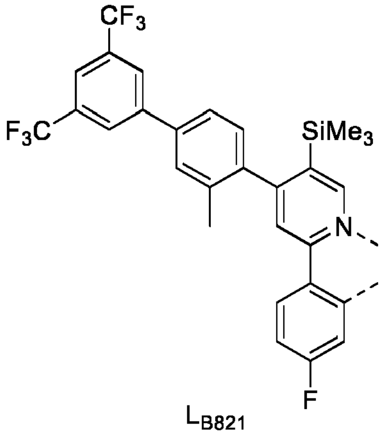
$L_{B821}$ ,
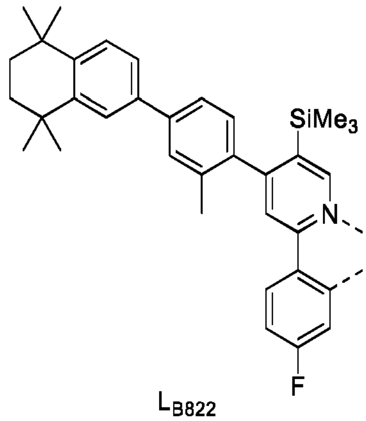
$L_{B822}$ ,
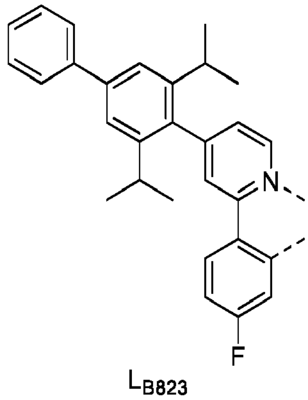
$L_{B823}$ ,

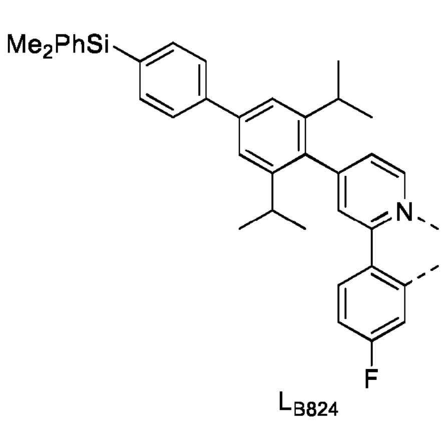
$L_{B824}$ ,
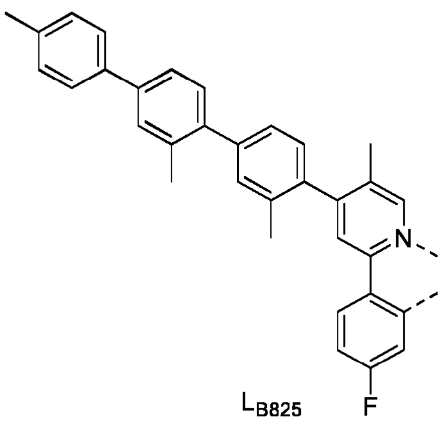
$L_{B825}$ ,

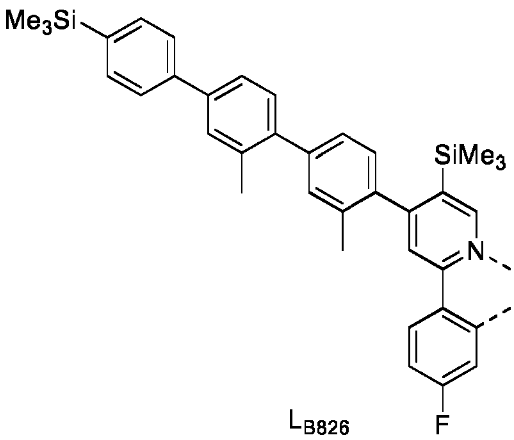
$L_{B826}$ ,
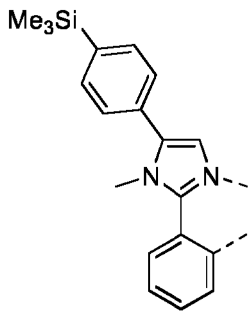
$L_{B827}$ ,
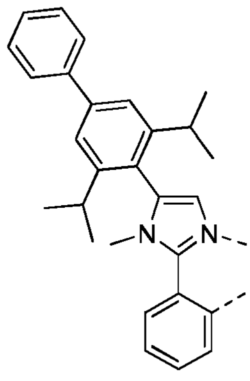
$L_{B828}$ ,

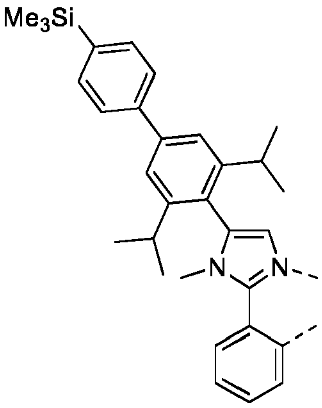
$L_{B829}$ ,
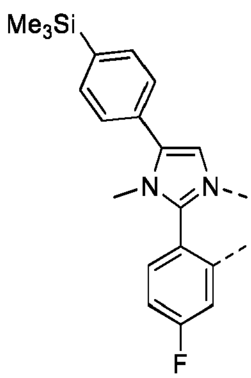
$L_{B830}$ ,
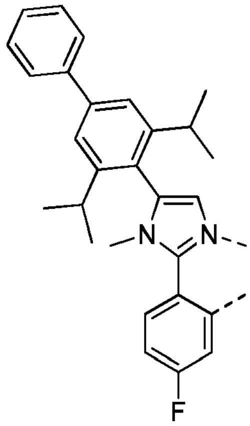
$L_{B831}$ ,
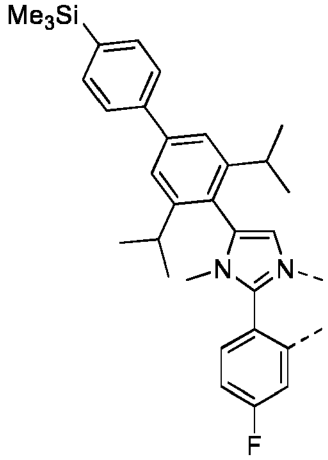
$L_{B832}$ ,

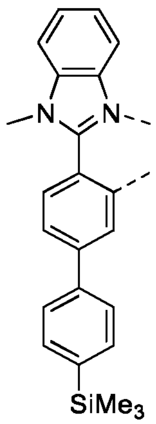
$L_{B833}$ ,
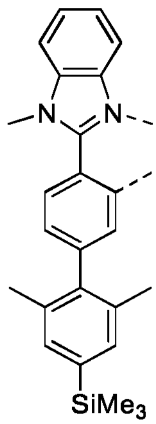
$L_{B834}$ ,
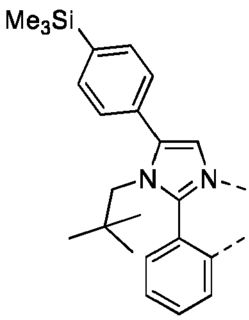
$L_{B835}$ , and
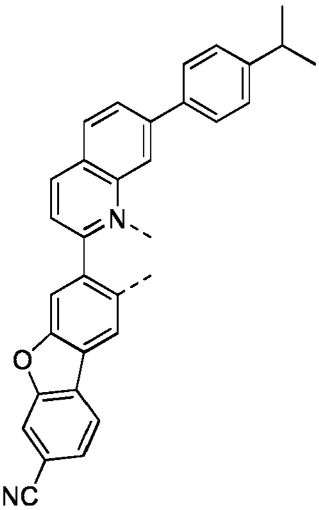
$L_{B836}$ ;

wherein j is an integer from 1 to 1416, and each $L_{Cj\text{-I}}$ has a structure based on formula

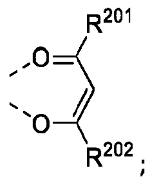
;

and
each $L_{Cj\text{-II}}$ has a structure based on formula

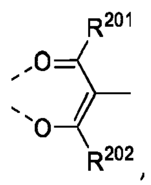
,

wherein for each $L_{Cj}$ in $L_{Cj\text{-I}}$ and $L_{Cj\text{-II}}$, $R^{201}$ and $R^{202}$ are each independently defined in the following LIST 8:

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C1}$ | $R^{D1}$ | $R^{D1}$ | $L_{C193}$ | $R^{D1}$ | $R^{D3}$ | $L_{C385}$ | $R^{D17}$ | $R^{D40}$ | $L_{C577}$ | $R^{D143}$ | $R^{D120}$ |
| $L_{C2}$ | $R^{D2}$ | $R^{D2}$ | $L_{C194}$ | $R^{D1}$ | $R^{D4}$ | $L_{C386}$ | $R^{D17}$ | $R^{D41}$ | $L_{C578}$ | $R^{D143}$ | $R^{D133}$ |
| $L_{C3}$ | $R^{D3}$ | $R^{D3}$ | $L_{C195}$ | $R^{D1}$ | $R^{D5}$ | $L_{C387}$ | $R^{D17}$ | $R^{D42}$ | $L_{C579}$ | $R^{D143}$ | $R^{D134}$ |
| $L_{C4}$ | $R^{D4}$ | $R^{D4}$ | $L_{C196}$ | $R^{D1}$ | $R^{D9}$ | $L_{C388}$ | $R^{D17}$ | $R^{D43}$ | $L_{C580}$ | $R^{D143}$ | $R^{D135}$ |
| $L_{C5}$ | $R^{D5}$ | $R^{D5}$ | $L_{C197}$ | $R^{D1}$ | $R^{D10}$ | $L_{C389}$ | $R^{D17}$ | $R^{D48}$ | $L_{C581}$ | $R^{D143}$ | $R^{D136}$ |
| $L_{C6}$ | $R^{D6}$ | $R^{D6}$ | $L_{C198}$ | $R^{D1}$ | $R^{D17}$ | $L_{C390}$ | $R^{D17}$ | $R^{D49}$ | $L_{C582}$ | $R^{D143}$ | $R^{D144}$ |
| $L_{C7}$ | $R^{D7}$ | $R^{D7}$ | $L_{C199}$ | $R^{D1}$ | $R^{D18}$ | $L_{C391}$ | $R^{D17}$ | $R^{D50}$ | $L_{C583}$ | $R^{D143}$ | $R^{D145}$ |
| $L_{C8}$ | $R^{D8}$ | $R^{D8}$ | $L_{C200}$ | $R^{D1}$ | $R^{D20}$ | $L_{C392}$ | $R^{D17}$ | $R^{D54}$ | $L_{C584}$ | $R^{D143}$ | $R^{D146}$ |
| $L_{C9}$ | $R^{D9}$ | $R^{D9}$ | $L_{C201}$ | $R^{D1}$ | $R^{D22}$ | $L_{C393}$ | $R^{D17}$ | $R^{D55}$ | $L_{C585}$ | $R^{D143}$ | $R^{D147}$ |
| $L_{C10}$ | $R^{D10}$ | $R^{D10}$ | $L_{C202}$ | $R^{D1}$ | $R^{D37}$ | $L_{C394}$ | $R^{D17}$ | $R^{D58}$ | $L_{C586}$ | $R^{D143}$ | $R^{D149}$ |
| $L_{C11}$ | $R^{D11}$ | $R^{D11}$ | $L_{C203}$ | $R^{D1}$ | $R^{D40}$ | $L_{C395}$ | $R^{D17}$ | $R^{D59}$ | $L_{C587}$ | $R^{D143}$ | $R^{D151}$ |
| $L_{C12}$ | $R^{D12}$ | $R^{D12}$ | $L_{C204}$ | $R^{D1}$ | $R^{D41}$ | $L_{C396}$ | $R^{D17}$ | $R^{D78}$ | $L_{C588}$ | $R^{D143}$ | $R^{D154}$ |
| $L_{C13}$ | $R^{D13}$ | $R^{D13}$ | $L_{C205}$ | $R^{D1}$ | $R^{D42}$ | $L_{C397}$ | $R^{D17}$ | $R^{D79}$ | $L_{C589}$ | $R^{D143}$ | $R^{D155}$ |
| $L_{C14}$ | $R^{D14}$ | $R^{D14}$ | $L_{C206}$ | $R^{D1}$ | $R^{D43}$ | $L_{C398}$ | $R^{D17}$ | $R^{D81}$ | $L_{C590}$ | $R^{D143}$ | $R^{D161}$ |
| $L_{C15}$ | $R^{D15}$ | $R^{D15}$ | $L_{C207}$ | $R^{D1}$ | $R^{D48}$ | $L_{C399}$ | $R^{D17}$ | $R^{D87}$ | $L_{C591}$ | $R^{D143}$ | $R^{D175}$ |
| $L_{C16}$ | $R^{D16}$ | $R^{D16}$ | $L_{C208}$ | $R^{D1}$ | $R^{D49}$ | $L_{C400}$ | $R^{D17}$ | $R^{D88}$ | $L_{C592}$ | $R^{D144}$ | $R^{D3}$ |
| $L_{C17}$ | $R^{D17}$ | $R^{D17}$ | $L_{C209}$ | $R^{D1}$ | $R^{D50}$ | $L_{C401}$ | $R^{D17}$ | $R^{D89}$ | $L_{C593}$ | $R^{D144}$ | $R^{D5}$ |
| $L_{C18}$ | $R^{D18}$ | $R^{D18}$ | $L_{C210}$ | $R^{D1}$ | $R^{D54}$ | $L_{C402}$ | $R^{D17}$ | $R^{D93}$ | $L_{C594}$ | $R^{D144}$ | $R^{D17}$ |
| $L_{C19}$ | $R^{D19}$ | $R^{D19}$ | $L_{C211}$ | $R^{D1}$ | $R^{D55}$ | $L_{C403}$ | $R^{D17}$ | $R^{D116}$ | $L_{C595}$ | $R^{D144}$ | $R^{D18}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C20}$ | $R^{D20}$ | $R^{D20}$ | $L_{C212}$ | $R^{D1}$ | $R^{D58}$ | $L_{C404}$ | $R^{D17}$ | $R^{D117}$ | $L_{C596}$ | $R^{D144}$ | $R^{D20}$ |
| $L_{C21}$ | $R^{D21}$ | $R^{D21}$ | $L_{C213}$ | $R^{D1}$ | $R^{D59}$ | $L_{C405}$ | $R^{D17}$ | $R^{D118}$ | $L_{C597}$ | $R^{D144}$ | $R^{D22}$ |
| $L_{C22}$ | $R^{D22}$ | $R^{D22}$ | $L_{C214}$ | $R^{D1}$ | $R^{D78}$ | $L_{C406}$ | $R^{D17}$ | $R^{D119}$ | $L_{C598}$ | $R^{D144}$ | $R^{D37}$ |
| $L_{C23}$ | $R^{D23}$ | $R^{D23}$ | $L_{C215}$ | $R^{D1}$ | $R^{D79}$ | $L_{C407}$ | $R^{D17}$ | $R^{D120}$ | $L_{C599}$ | $R^{D144}$ | $R^{D40}$ |
| $L_{C24}$ | $R^{D24}$ | $R^{D24}$ | $L_{C216}$ | $R^{D1}$ | $R^{D81}$ | $L_{C408}$ | $R^{D17}$ | $R^{D133}$ | $L_{C600}$ | $R^{D144}$ | $R^{D41}$ |
| $L_{C25}$ | $R^{D25}$ | $R^{D25}$ | $L_{C217}$ | $R^{D1}$ | $R^{D87}$ | $L_{C409}$ | $R^{D17}$ | $R^{D134}$ | $L_{C601}$ | $R^{D144}$ | $R^{D42}$ |
| $L_{C26}$ | $R^{D26}$ | $R^{D26}$ | $L_{C218}$ | $R^{D1}$ | $R^{D88}$ | $L_{C410}$ | $R^{D17}$ | $R^{D135}$ | $L_{C602}$ | $R^{D144}$ | $R^{D43}$ |
| $L_{C27}$ | $R^{D27}$ | $R^{D27}$ | $L_{C219}$ | $R^{D1}$ | $R^{D89}$ | $L_{C411}$ | $R^{D17}$ | $R^{D136}$ | $L_{C603}$ | $R^{D144}$ | $R^{D48}$ |
| $L_{C28}$ | $R^{D28}$ | $R^{D28}$ | $L_{C220}$ | $R^{D1}$ | $R^{D93}$ | $L_{C412}$ | $R^{D17}$ | $R^{D143}$ | $L_{C604}$ | $R^{D144}$ | $R^{D49}$ |
| $L_{C29}$ | $R^{D29}$ | $R^{D29}$ | $L_{C221}$ | $R^{D1}$ | $R^{D116}$ | $L_{C413}$ | $R^{D17}$ | $R^{D144}$ | $L_{C605}$ | $R^{D144}$ | $R^{D54}$ |
| $L_{C30}$ | $R^{D30}$ | $R^{D30}$ | $L_{C222}$ | $R^{D1}$ | $R^{D117}$ | $L_{C414}$ | $R^{D17}$ | $R^{D145}$ | $L_{C606}$ | $R^{D144}$ | $R^{D58}$ |
| $L_{C31}$ | $R^{D31}$ | $R^{D31}$ | $L_{C223}$ | $R^{D1}$ | $R^{D118}$ | $L_{C415}$ | $R^{D17}$ | $R^{D146}$ | $L_{C607}$ | $R^{D144}$ | $R^{D59}$ |
| $L_{C32}$ | $R^{D32}$ | $R^{D32}$ | $L_{C224}$ | $R^{D1}$ | $R^{D119}$ | $L_{C416}$ | $R^{D17}$ | $R^{D147}$ | $L_{C608}$ | $R^{D144}$ | $R^{D78}$ |
| $L_{C33}$ | $R^{D33}$ | $R^{D33}$ | $L_{C225}$ | $R^{D1}$ | $R^{D120}$ | $L_{C417}$ | $R^{D17}$ | $R^{D149}$ | $L_{C609}$ | $R^{D144}$ | $R^{D79}$ |
| $L_{C34}$ | $R^{D34}$ | $R^{D34}$ | $L_{C226}$ | $R^{D1}$ | $R^{D133}$ | $L_{C418}$ | $R^{D17}$ | $R^{D151}$ | $L_{C610}$ | $R^{D144}$ | $R^{D81}$ |
| $L_{C35}$ | $R^{D35}$ | $R^{D35}$ | $L_{C227}$ | $R^{D1}$ | $R^{D134}$ | $L_{C419}$ | $R^{D17}$ | $R^{D154}$ | $L_{C611}$ | $R^{D144}$ | $R^{D87}$ |
| $L_{C36}$ | $R^{D36}$ | $R^{D36}$ | $L_{C228}$ | $R^{D1}$ | $R^{D135}$ | $L_{C420}$ | $R^{D17}$ | $R^{D155}$ | $L_{C612}$ | $R^{D144}$ | $R^{D88}$ |
| $L_{C37}$ | $R^{D37}$ | $R^{D37}$ | $L_{C229}$ | $R^{D1}$ | $R^{D136}$ | $L_{C421}$ | $R^{D17}$ | $R^{D161}$ | $L_{C613}$ | $R^{D144}$ | $R^{D89}$ |
| $L_{C38}$ | $R^{D38}$ | $R^{D38}$ | $L_{C230}$ | $R^{D1}$ | $R^{D143}$ | $L_{C422}$ | $R^{D17}$ | $R^{D175}$ | $L_{C614}$ | $R^{D144}$ | $R^{D93}$ |
| $L_{C39}$ | $R^{D39}$ | $R^{D39}$ | $L_{C231}$ | $R^{D1}$ | $R^{D144}$ | $L_{C423}$ | $R^{D50}$ | $R^{D3}$ | $L_{C615}$ | $R^{D144}$ | $R^{D116}$ |
| $L_{C40}$ | $R^{D40}$ | $R^{D40}$ | $L_{C232}$ | $R^{D1}$ | $R^{D145}$ | $L_{C424}$ | $R^{D50}$ | $R^{D5}$ | $L_{C616}$ | $R^{D144}$ | $R^{D117}$ |
| $L_{C41}$ | $R^{D41}$ | $R^{D41}$ | $L_{C233}$ | $R^{D1}$ | $R^{D146}$ | $L_{C425}$ | $R^{D50}$ | $R^{D18}$ | $L_{C617}$ | $R^{D144}$ | $R^{D118}$ |
| $L_{C42}$ | $R^{D42}$ | $R^{D42}$ | $L_{C234}$ | $R^{D1}$ | $R^{D147}$ | $L_{C426}$ | $R^{D50}$ | $R^{D20}$ | $L_{C618}$ | $R^{D144}$ | $R^{D119}$ |
| $L_{C43}$ | $R^{D43}$ | $R^{D43}$ | $L_{C235}$ | $R^{D1}$ | $R^{D149}$ | $L_{C427}$ | $R^{D50}$ | $R^{D22}$ | $L_{C619}$ | $R^{D144}$ | $R^{D120}$ |
| $L_{C44}$ | $R^{D44}$ | $R^{D44}$ | $L_{C236}$ | $R^{D1}$ | $R^{D151}$ | $L_{C428}$ | $R^{D50}$ | $R^{D37}$ | $L_{C620}$ | $R^{D144}$ | $R^{D133}$ |
| $L_{C45}$ | $R^{D45}$ | $R^{D45}$ | $L_{C237}$ | $R^{D1}$ | $R^{D154}$ | $L_{C429}$ | $R^{D50}$ | $R^{D40}$ | $L_{C621}$ | $R^{D144}$ | $R^{D134}$ |
| $L_{C46}$ | $R^{D46}$ | $R^{D46}$ | $L_{C238}$ | $R^{D1}$ | $R^{D155}$ | $L_{C430}$ | $R^{D50}$ | $R^{D41}$ | $L_{C622}$ | $R^{D144}$ | $R^{D135}$ |
| $L_{C47}$ | $R^{D47}$ | $R^{D47}$ | $L_{C239}$ | $R^{D1}$ | $R^{D161}$ | $L_{C431}$ | $R^{D50}$ | $R^{D42}$ | $L_{C623}$ | $R^{D144}$ | $R^{D136}$ |
| $L_{C48}$ | $R^{D48}$ | $R^{D48}$ | $L_{C240}$ | $R^{D1}$ | $R^{D175}$ | $L_{C432}$ | $R^{D50}$ | $R^{D43}$ | $L_{C624}$ | $R^{D144}$ | $R^{D145}$ |
| $L_{C49}$ | $R^{D49}$ | $R^{D49}$ | $L_{C241}$ | $R^{D4}$ | $R^{D3}$ | $L_{C433}$ | $R^{D50}$ | $R^{D48}$ | $L_{C625}$ | $R^{D144}$ | $R^{D146}$ |
| $L_{C50}$ | $R^{D50}$ | $R^{D50}$ | $L_{C242}$ | $R^{D4}$ | $R^{D5}$ | $L_{C434}$ | $R^{D50}$ | $R^{D49}$ | $L_{C626}$ | $R^{D144}$ | $R^{D147}$ |
| $L_{C51}$ | $R^{D51}$ | $R^{D51}$ | $L_{C243}$ | $R^{D4}$ | $R^{D9}$ | $L_{C435}$ | $R^{D50}$ | $R^{D54}$ | $L_{C627}$ | $R^{D144}$ | $R^{D149}$ |
| $L_{C52}$ | $R^{D52}$ | $R^{D52}$ | $L_{C244}$ | $R^{D4}$ | $R^{D10}$ | $L_{C436}$ | $R^{D50}$ | $R^{D55}$ | $L_{C628}$ | $R^{D144}$ | $R^{D151}$ |
| $L_{C53}$ | $R^{D53}$ | $R^{D53}$ | $L_{C245}$ | $R^{D4}$ | $R^{D17}$ | $L_{C437}$ | $R^{D50}$ | $R^{D58}$ | $L_{C629}$ | $R^{D144}$ | $R^{D154}$ |
| $L_{C54}$ | $R^{D54}$ | $R^{D54}$ | $L_{C246}$ | $R^{D4}$ | $R^{D18}$ | $L_{C438}$ | $R^{D50}$ | $R^{D59}$ | $L_{C630}$ | $R^{D144}$ | $R^{D155}$ |
| $L_{C55}$ | $R^{D55}$ | $R^{D55}$ | $L_{C247}$ | $R^{D4}$ | $R^{D20}$ | $L_{C439}$ | $R^{D50}$ | $R^{D78}$ | $L_{C631}$ | $R^{D144}$ | $R^{D161}$ |
| $L_{C56}$ | $R^{D56}$ | $R^{D56}$ | $L_{C248}$ | $R^{D4}$ | $R^{D22}$ | $L_{C440}$ | $R^{D50}$ | $R^{D79}$ | $L_{C632}$ | $R^{D144}$ | $R^{D175}$ |
| $L_{C57}$ | $R^{D57}$ | $R^{D57}$ | $L_{C249}$ | $R^{D4}$ | $R^{D37}$ | $L_{C441}$ | $R^{D50}$ | $R^{D81}$ | $L_{C633}$ | $R^{D145}$ | $R^{D3}$ |
| $L_{C58}$ | $R^{D58}$ | $R^{D58}$ | $L_{C250}$ | $R^{D4}$ | $R^{D40}$ | $L_{C442}$ | $R^{D50}$ | $R^{D87}$ | $L_{C634}$ | $R^{D145}$ | $R^{D5}$ |
| $L_{C59}$ | $R^{D59}$ | $R^{D59}$ | $L_{C251}$ | $R^{D4}$ | $R^{D41}$ | $L_{C443}$ | $R^{D50}$ | $R^{D88}$ | $L_{C635}$ | $R^{D145}$ | $R^{D17}$ |
| $L_{C60}$ | $R^{D60}$ | $R^{D60}$ | $L_{C252}$ | $R^{D4}$ | $R^{D42}$ | $L_{C444}$ | $R^{D50}$ | $R^{D89}$ | $L_{C636}$ | $R^{D145}$ | $R^{D18}$ |
| $L_{C61}$ | $R^{D61}$ | $R^{D61}$ | $L_{C253}$ | $R^{D4}$ | $R^{D43}$ | $L_{C445}$ | $R^{D50}$ | $R^{D93}$ | $L_{C637}$ | $R^{D145}$ | $R^{D20}$ |
| $L_{C62}$ | $R^{D62}$ | $R^{D62}$ | $L_{C254}$ | $R^{D4}$ | $R^{D48}$ | $L_{C446}$ | $R^{D50}$ | $R^{D116}$ | $L_{C638}$ | $R^{D145}$ | $R^{D22}$ |
| $L_{C63}$ | $R^{D63}$ | $R^{D63}$ | $L_{C255}$ | $R^{D4}$ | $R^{D49}$ | $L_{C447}$ | $R^{D50}$ | $R^{D117}$ | $L_{C639}$ | $R^{D145}$ | $R^{D37}$ |
| $L_{C64}$ | $R^{D64}$ | $R^{D64}$ | $L_{C256}$ | $R^{D4}$ | $R^{D50}$ | $L_{C448}$ | $R^{D50}$ | $R^{D118}$ | $L_{C640}$ | $R^{D145}$ | $R^{D40}$ |
| $L_{C65}$ | $R^{D65}$ | $R^{D65}$ | $L_{C257}$ | $R^{D4}$ | $R^{D54}$ | $L_{C449}$ | $R^{D50}$ | $R^{D119}$ | $L_{C641}$ | $R^{D145}$ | $R^{D41}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C66}$ | $R^{D66}$ | $R^{D66}$ | $L_{C258}$ | $R^{D4}$ | $R^{D55}$ | $L_{C450}$ | $R^{D50}$ | $R^{D120}$ | $L_{C642}$ | $R^{D145}$ | $R^{D42}$ |
| $L_{C67}$ | $R^{D67}$ | $R^{D67}$ | $L_{C259}$ | $R^{D4}$ | $R^{D58}$ | $L_{C451}$ | $R^{D50}$ | $R^{D133}$ | $L_{C643}$ | $R^{D145}$ | $R^{D43}$ |
| $L_{C68}$ | $R^{D68}$ | $R^{D68}$ | $L_{C260}$ | $R^{D4}$ | $R^{D59}$ | $L_{C452}$ | $R^{D50}$ | $R^{D134}$ | $L_{C644}$ | $R^{D145}$ | $R^{D48}$ |
| $L_{C69}$ | $R^{D69}$ | $R^{D69}$ | $L_{C261}$ | $R^{D4}$ | $R^{D78}$ | $L_{C453}$ | $R^{D50}$ | $R^{D135}$ | $L_{C645}$ | $R^{D145}$ | $R^{D49}$ |
| $L_{C70}$ | $R^{D70}$ | $R^{D70}$ | $L_{C262}$ | $R^{D4}$ | $R^{D79}$ | $L_{C454}$ | $R^{D50}$ | $R^{D136}$ | $L_{C646}$ | $R^{D145}$ | $R^{D54}$ |
| $L_{C71}$ | $R^{D71}$ | $R^{D71}$ | $L_{C263}$ | $R^{D4}$ | $R^{D81}$ | $L_{C455}$ | $R^{D50}$ | $R^{D143}$ | $L_{C647}$ | $R^{D145}$ | $R^{D58}$ |
| $L_{C72}$ | $R^{D72}$ | $R^{D72}$ | $L_{C264}$ | $R^{D4}$ | $R^{D87}$ | $L_{C456}$ | $R^{D50}$ | $R^{D144}$ | $L_{C648}$ | $R^{D145}$ | $R^{D59}$ |
| $L_{C73}$ | $R^{D73}$ | $R^{D73}$ | $L_{C265}$ | $R^{D4}$ | $R^{D88}$ | $L_{C457}$ | $R^{D50}$ | $R^{D145}$ | $L_{C649}$ | $R^{D145}$ | $R^{D78}$ |
| $L_{C74}$ | $R^{D74}$ | $R^{D74}$ | $L_{C266}$ | $R^{D4}$ | $R^{D89}$ | $L_{C458}$ | $R^{D50}$ | $R^{D146}$ | $L_{C650}$ | $R^{D145}$ | $R^{D79}$ |
| $L_{C75}$ | $R^{D75}$ | $R^{D75}$ | $L_{C267}$ | $R^{D4}$ | $R^{D93}$ | $L_{C459}$ | $R^{D50}$ | $R^{D147}$ | $L_{C651}$ | $R^{D145}$ | $R^{D81}$ |
| $L_{C76}$ | $R^{D76}$ | $R^{D76}$ | $L_{C268}$ | $R^{D4}$ | $R^{D116}$ | $L_{C460}$ | $R^{D50}$ | $R^{D149}$ | $L_{C652}$ | $R^{D145}$ | $R^{D87}$ |
| $L_{C77}$ | $R^{D77}$ | $R^{D77}$ | $L_{C269}$ | $R^{D4}$ | $R^{D117}$ | $L_{C461}$ | $R^{D50}$ | $R^{D151}$ | $L_{C653}$ | $R^{D145}$ | $R^{D88}$ |
| $L_{C78}$ | $R^{D78}$ | $R^{D78}$ | $L_{C270}$ | $R^{D4}$ | $R^{D118}$ | $L_{C462}$ | $R^{D50}$ | $R^{D154}$ | $L_{C654}$ | $R^{D145}$ | $R^{D89}$ |
| $L_{C79}$ | $R^{D79}$ | $R^{D79}$ | $L_{C271}$ | $R^{D4}$ | $R^{D119}$ | $L_{C463}$ | $R^{D50}$ | $R^{D155}$ | $L_{C655}$ | $R^{D145}$ | $R^{D93}$ |
| $L_{C80}$ | $R^{D80}$ | $R^{D80}$ | $L_{C272}$ | $R^{D4}$ | $R^{D120}$ | $L_{C464}$ | $R^{D50}$ | $R^{D161}$ | $L_{C656}$ | $R^{D145}$ | $R^{D116}$ |
| $L_{C81}$ | $R^{D81}$ | $R^{D81}$ | $L_{C273}$ | $R^{D4}$ | $R^{D133}$ | $L_{C465}$ | $R^{D50}$ | $R^{D175}$ | $L_{C657}$ | $R^{D145}$ | $R^{D117}$ |
| $L_{C82}$ | $R^{D82}$ | $R^{D82}$ | $L_{C274}$ | $R^{D4}$ | $R^{D134}$ | $L_{C466}$ | $R^{D55}$ | $R^{D3}$ | $L_{C658}$ | $R^{D145}$ | $R^{D118}$ |
| $L_{C83}$ | $R^{D83}$ | $R^{D83}$ | $L_{C275}$ | $R^{D4}$ | $R^{D135}$ | $L_{C467}$ | $R^{D55}$ | $R^{D5}$ | $L_{C659}$ | $R^{D145}$ | $R^{D119}$ |
| $L_{C84}$ | $R^{D84}$ | $R^{D84}$ | $L_{C276}$ | $R^{D4}$ | $R^{D136}$ | $L_{C468}$ | $R^{D55}$ | $R^{D18}$ | $L_{C660}$ | $R^{D145}$ | $R^{D120}$ |
| $L_{C85}$ | $R^{D85}$ | $R^{D85}$ | $L_{C277}$ | $R^{D4}$ | $R^{D143}$ | $L_{C469}$ | $R^{D55}$ | $R^{D20}$ | $L_{C661}$ | $R^{D145}$ | $R^{D133}$ |
| $L_{C86}$ | $R^{D86}$ | $R^{D86}$ | $L_{C278}$ | $R^{D4}$ | $R^{D144}$ | $L_{C470}$ | $R^{D55}$ | $R^{D22}$ | $L_{C662}$ | $R^{D145}$ | $R^{D134}$ |
| $L_{C87}$ | $R^{D87}$ | $R^{D87}$ | $L_{C279}$ | $R^{D4}$ | $R^{D145}$ | $L_{C471}$ | $R^{D55}$ | $R^{D37}$ | $L_{C663}$ | $R^{D145}$ | $R^{D135}$ |
| $L_{C88}$ | $R^{D88}$ | $R^{D88}$ | $L_{C280}$ | $R^{D4}$ | $R^{D146}$ | $L_{C472}$ | $R^{D55}$ | $R^{D40}$ | $L_{C664}$ | $R^{D145}$ | $R^{D136}$ |
| $L_{C89}$ | $R^{D89}$ | $R^{D89}$ | $L_{C281}$ | $R^{D4}$ | $R^{D147}$ | $L_{C473}$ | $R^{D55}$ | $R^{D41}$ | $L_{C665}$ | $R^{D145}$ | $R^{D146}$ |
| $L_{C90}$ | $R^{D90}$ | $R^{D90}$ | $L_{C282}$ | $R^{D4}$ | $R^{D149}$ | $L_{C474}$ | $R^{D55}$ | $R^{D42}$ | $L_{C666}$ | $R^{D145}$ | $R^{D147}$ |
| $L_{C91}$ | $R^{D91}$ | $R^{D91}$ | $L_{C283}$ | $R^{D4}$ | $R^{D151}$ | $L_{C475}$ | $R^{D55}$ | $R^{D43}$ | $L_{C667}$ | $R^{D145}$ | $R^{D149}$ |
| $L_{C92}$ | $R^{D92}$ | $R^{D92}$ | $L_{C284}$ | $R^{D4}$ | $R^{D154}$ | $L_{C476}$ | $R^{D55}$ | $R^{D48}$ | $L_{C668}$ | $R^{D145}$ | $R^{D151}$ |
| $L_{C93}$ | $R^{D93}$ | $R^{D93}$ | $L_{C285}$ | $R^{D4}$ | $R^{D155}$ | $L_{C477}$ | $R^{D55}$ | $R^{D49}$ | $L_{C669}$ | $R^{D145}$ | $R^{D154}$ |
| $L_{C94}$ | $R^{D94}$ | $R^{D94}$ | $L_{C286}$ | $R^{D4}$ | $R^{D161}$ | $L_{C478}$ | $R^{D55}$ | $R^{D54}$ | $L_{C670}$ | $R^{D145}$ | $R^{D155}$ |
| $L_{C95}$ | $R^{D95}$ | $R^{D95}$ | $L_{C287}$ | $R^{D4}$ | $R^{D175}$ | $L_{C479}$ | $R^{D55}$ | $R^{D58}$ | $L_{C671}$ | $R^{D145}$ | $R^{D161}$ |
| $L_{C96}$ | $R^{D96}$ | $R^{D96}$ | $L_{C288}$ | $R^{D9}$ | $R^{D3}$ | $L_{C480}$ | $R^{D55}$ | $R^{D59}$ | $L_{C672}$ | $R^{D145}$ | $R^{D175}$ |
| $L_{C97}$ | $R^{D97}$ | $R^{D97}$ | $L_{C289}$ | $R^{D9}$ | $R^{D5}$ | $L_{C481}$ | $R^{D55}$ | $R^{D78}$ | $L_{C673}$ | $R^{D146}$ | $R^{D3}$ |
| $L_{C98}$ | $R^{D98}$ | $R^{D98}$ | $L_{C290}$ | $R^{D9}$ | $R^{D10}$ | $L_{C482}$ | $R^{D55}$ | $R^{D79}$ | $L_{C674}$ | $R^{D146}$ | $R^{D5}$ |
| $L_{C99}$ | $R^{D99}$ | $R^{D99}$ | $L_{C291}$ | $R^{D9}$ | $R^{D17}$ | $L_{C483}$ | $R^{D55}$ | $R^{D81}$ | $L_{C675}$ | $R^{D146}$ | $R^{D17}$ |
| $L_{C100}$ | $R^{D100}$ | $R^{D100}$ | $L_{C292}$ | $R^{D9}$ | $R^{D18}$ | $L_{C484}$ | $R^{D55}$ | $R^{D87}$ | $L_{C676}$ | $R^{D146}$ | $R^{D18}$ |
| $L_{C101}$ | $R^{D101}$ | $R^{D101}$ | $L_{C293}$ | $R^{D9}$ | $R^{D20}$ | $L_{C485}$ | $R^{D55}$ | $R^{D88}$ | $L_{C677}$ | $R^{D146}$ | $R^{D20}$ |
| $L_{C102}$ | $R^{D102}$ | $R^{D102}$ | $L_{C294}$ | $R^{D9}$ | $R^{D22}$ | $L_{C486}$ | $R^{D55}$ | $R^{D89}$ | $L_{C678}$ | $R^{D146}$ | $R^{D22}$ |
| $L_{C103}$ | $R^{D103}$ | $R^{D103}$ | $L_{C295}$ | $R^{D9}$ | $R^{D37}$ | $L_{C487}$ | $R^{D55}$ | $R^{D93}$ | $L_{C679}$ | $R^{D146}$ | $R^{D37}$ |
| $L_{C104}$ | $R^{D104}$ | $R^{D104}$ | $L_{C296}$ | $R^{D9}$ | $R^{D40}$ | $L_{C488}$ | $R^{D55}$ | $R^{D116}$ | $L_{C680}$ | $R^{D146}$ | $R^{D40}$ |
| $L_{C105}$ | $R^{D105}$ | $R^{D105}$ | $L_{C297}$ | $R^{D9}$ | $R^{D41}$ | $L_{C489}$ | $R^{D55}$ | $R^{D117}$ | $L_{C681}$ | $R^{D146}$ | $R^{D41}$ |
| $L_{C106}$ | $R^{D106}$ | $R^{D106}$ | $L_{C298}$ | $R^{D9}$ | $R^{D42}$ | $L_{C490}$ | $R^{D55}$ | $R^{D118}$ | $L_{C682}$ | $R^{D146}$ | $R^{D42}$ |
| $L_{C107}$ | $R^{D107}$ | $R^{D107}$ | $L_{C299}$ | $R^{D9}$ | $R^{D43}$ | $L_{C491}$ | $R^{D55}$ | $R^{D119}$ | $L_{C683}$ | $R^{D146}$ | $R^{D43}$ |
| $L_{C108}$ | $R^{D108}$ | $R^{D108}$ | $L_{C300}$ | $R^{D9}$ | $R^{D48}$ | $L_{C492}$ | $R^{D55}$ | $R^{D120}$ | $L_{C684}$ | $R^{D146}$ | $R^{D48}$ |
| $L_{C109}$ | $R^{D109}$ | $R^{D109}$ | $L_{C301}$ | $R^{D9}$ | $R^{D49}$ | $L_{C493}$ | $R^{D55}$ | $R^{D133}$ | $L_{C685}$ | $R^{D146}$ | $R^{D49}$ |
| $L_{C110}$ | $R^{D110}$ | $R^{D110}$ | $L_{C302}$ | $R^{D9}$ | $R^{D50}$ | $L_{C494}$ | $R^{D55}$ | $R^{D134}$ | $L_{C686}$ | $R^{D146}$ | $R^{D54}$ |
| $L_{C111}$ | $R^{D111}$ | $R^{D111}$ | $L_{C303}$ | $R^{D9}$ | $R^{D54}$ | $L_{C495}$ | $R^{D55}$ | $R^{D135}$ | $L_{C687}$ | $R^{D146}$ | $R^{D58}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C112}$ | $R^{D112}$ | $R^{D112}$ | $L_{C304}$ | $R^{D9}$ | $R^{D55}$ | $L_{C496}$ | $R^{D55}$ | $R^{D136}$ | $L_{C688}$ | $R^{D146}$ | $R^{D59}$ |
| $L_{C113}$ | $R^{D113}$ | $R^{D113}$ | $L_{C305}$ | $R^{D9}$ | $R^{D58}$ | $L_{C497}$ | $R^{D55}$ | $R^{D143}$ | $L_{C689}$ | $R^{D146}$ | $R^{D78}$ |
| $L_{C114}$ | $R^{D114}$ | $R^{D114}$ | $L_{C306}$ | $R^{D9}$ | $R^{D59}$ | $L_{C498}$ | $R^{D55}$ | $R^{D144}$ | $L_{C690}$ | $R^{D146}$ | $R^{D79}$ |
| $L_{C115}$ | $R^{D115}$ | $R^{D115}$ | $L_{C307}$ | $R^{D9}$ | $R^{D78}$ | $L_{C499}$ | $R^{D55}$ | $R^{D145}$ | $L_{C691}$ | $R^{D146}$ | $R^{D81}$ |
| $L_{C116}$ | $R^{D116}$ | $R^{D116}$ | $L_{C308}$ | $R^{D9}$ | $R^{D79}$ | $L_{C500}$ | $R^{D55}$ | $R^{D146}$ | $L_{C692}$ | $R^{D146}$ | $R^{D87}$ |
| $L_{C117}$ | $R^{D117}$ | $R^{D117}$ | $L_{C309}$ | $R^{D9}$ | $R^{D81}$ | $L_{C501}$ | $R^{D55}$ | $R^{D147}$ | $L_{C693}$ | $R^{D146}$ | $R^{D88}$ |
| $L_{C118}$ | $R^{D118}$ | $R^{D118}$ | $L_{C310}$ | $R^{D9}$ | $R^{D87}$ | $L_{C502}$ | $R^{D55}$ | $R^{D149}$ | $L_{C694}$ | $R^{D146}$ | $R^{D89}$ |
| $L_{C119}$ | $R^{D119}$ | $R^{D119}$ | $L_{C311}$ | $R^{D9}$ | $R^{D88}$ | $L_{C503}$ | $R^{D55}$ | $R^{D151}$ | $L_{C695}$ | $R^{D146}$ | $R^{D93}$ |
| $L_{C120}$ | $R^{D120}$ | $R^{D120}$ | $L_{C312}$ | $R^{D9}$ | $R^{D89}$ | $L_{C504}$ | $R^{D55}$ | $R^{D154}$ | $L_{C696}$ | $R^{D146}$ | $R^{D117}$ |
| $L_{C121}$ | $R^{D121}$ | $R^{D121}$ | $L_{C313}$ | $R^{D9}$ | $R^{D93}$ | $L_{C505}$ | $R^{D55}$ | $R^{D155}$ | $L_{C697}$ | $R^{D146}$ | $R^{D118}$ |
| $L_{C122}$ | $R^{D122}$ | $R^{D122}$ | $L_{C314}$ | $R^{D9}$ | $R^{D116}$ | $L_{C506}$ | $R^{D55}$ | $R^{D161}$ | $L_{C698}$ | $R^{D146}$ | $R^{D119}$ |
| $L_{C123}$ | $R^{D123}$ | $R^{D123}$ | $L_{C315}$ | $R^{D9}$ | $R^{D117}$ | $L_{C507}$ | $R^{D55}$ | $R^{D175}$ | $L_{C699}$ | $R^{D146}$ | $R^{D120}$ |
| $L_{C124}$ | $R^{D124}$ | $R^{D124}$ | $L_{C316}$ | $R^{D9}$ | $R^{D118}$ | $L_{C508}$ | $R^{D116}$ | $R^{D3}$ | $L_{C700}$ | $R^{D146}$ | $R^{D133}$ |
| $L_{C125}$ | $R^{D125}$ | $R^{D125}$ | $L_{C317}$ | $R^{D9}$ | $R^{D119}$ | $L_{C509}$ | $R^{D116}$ | $R^{D5}$ | $L_{C701}$ | $R^{D146}$ | $R^{D134}$ |
| $L_{C126}$ | $R^{D126}$ | $R^{D126}$ | $L_{C318}$ | $R^{D9}$ | $R^{D120}$ | $L_{C510}$ | $R^{D116}$ | $R^{D17}$ | $L_{C702}$ | $R^{D146}$ | $R^{D135}$ |
| $L_{C127}$ | $R^{D127}$ | $R^{D127}$ | $L_{C319}$ | $R^{D9}$ | $R^{D133}$ | $L_{C511}$ | $R^{D116}$ | $R^{D18}$ | $L_{C703}$ | $R^{D146}$ | $R^{D136}$ |
| $L_{C128}$ | $R^{D128}$ | $R^{D128}$ | $L_{C320}$ | $R^{D9}$ | $R^{D134}$ | $L_{C512}$ | $R^{D116}$ | $R^{D20}$ | $L_{C704}$ | $R^{D146}$ | $R^{D146}$ |
| $L_{C129}$ | $R^{D129}$ | $R^{D129}$ | $L_{C321}$ | $R^{D9}$ | $R^{D135}$ | $L_{C513}$ | $R^{D116}$ | $R^{D22}$ | $L_{C705}$ | $R^{D146}$ | $R^{D147}$ |
| $L_{C130}$ | $R^{D130}$ | $R^{D130}$ | $L_{C322}$ | $R^{D9}$ | $R^{D136}$ | $L_{C514}$ | $R^{D116}$ | $R^{D37}$ | $L_{C706}$ | $R^{D146}$ | $R^{D149}$ |
| $L_{C131}$ | $R^{D131}$ | $R^{D131}$ | $L_{C323}$ | $R^{D9}$ | $R^{D143}$ | $L_{C515}$ | $R^{D116}$ | $R^{D40}$ | $L_{C707}$ | $R^{D146}$ | $R^{D151}$ |
| $L_{C132}$ | $R^{D132}$ | $R^{D132}$ | $L_{C324}$ | $R^{D9}$ | $R^{D144}$ | $L_{C516}$ | $R^{D116}$ | $R^{D41}$ | $L_{C708}$ | $R^{D146}$ | $R^{D154}$ |
| $L_{C133}$ | $R^{D133}$ | $R^{D133}$ | $L_{C325}$ | $R^{D9}$ | $R^{D145}$ | $L_{C517}$ | $R^{D116}$ | $R^{D42}$ | $L_{C709}$ | $R^{D146}$ | $R^{D155}$ |
| $L_{C134}$ | $R^{D134}$ | $R^{D134}$ | $L_{C326}$ | $R^{D9}$ | $R^{D146}$ | $L_{C518}$ | $R^{D116}$ | $R^{D43}$ | $L_{C710}$ | $R^{D146}$ | $R^{D161}$ |
| $L_{C135}$ | $R^{D135}$ | $R^{D135}$ | $L_{C327}$ | $R^{D9}$ | $R^{D147}$ | $L_{C519}$ | $R^{D116}$ | $R^{D48}$ | $L_{C711}$ | $R^{D146}$ | $R^{D175}$ |
| $L_{C136}$ | $R^{D136}$ | $R^{D136}$ | $L_{C328}$ | $R^{D9}$ | $R^{D149}$ | $L_{C520}$ | $R^{D116}$ | $R^{D49}$ | $L_{C712}$ | $R^{D133}$ | $R^{D3}$ |
| $L_{C137}$ | $R^{D137}$ | $R^{D137}$ | $L_{C329}$ | $R^{D9}$ | $R^{D151}$ | $L_{C521}$ | $R^{D116}$ | $R^{D54}$ | $L_{C713}$ | $R^{D133}$ | $R^{D5}$ |
| $L_{C138}$ | $R^{D138}$ | $R^{D138}$ | $L_{C330}$ | $R^{D9}$ | $R^{D154}$ | $L_{C522}$ | $R^{D116}$ | $R^{D58}$ | $L_{C714}$ | $R^{D133}$ | $R^{D3}$ |
| $L_{C139}$ | $R^{D139}$ | $R^{D139}$ | $L_{C331}$ | $R^{D9}$ | $R^{D155}$ | $L_{C523}$ | $R^{D116}$ | $R^{D59}$ | $L_{C715}$ | $R^{D133}$ | $R^{D18}$ |
| $L_{C140}$ | $R^{D140}$ | $R^{D140}$ | $L_{C332}$ | $R^{D9}$ | $R^{D161}$ | $L_{C524}$ | $R^{D116}$ | $R^{D78}$ | $L_{C716}$ | $R^{D133}$ | $R^{D20}$ |
| $L_{C141}$ | $R^{D141}$ | $R^{D141}$ | $L_{C333}$ | $R^{D9}$ | $R^{D175}$ | $L_{C525}$ | $R^{D116}$ | $R^{D79}$ | $L_{C717}$ | $R^{D133}$ | $R^{D22}$ |
| $L_{C142}$ | $R^{D142}$ | $R^{D142}$ | $L_{C334}$ | $R^{D10}$ | $R^{D3}$ | $L_{C526}$ | $R^{D116}$ | $R^{D81}$ | $L_{C718}$ | $R^{D133}$ | $R^{D37}$ |
| $L_{C143}$ | $R^{D143}$ | $R^{D143}$ | $L_{C335}$ | $R^{D10}$ | $R^{D5}$ | $L_{C527}$ | $R^{D116}$ | $R^{D87}$ | $L_{C719}$ | $R^{D133}$ | $R^{D40}$ |
| $L_{C144}$ | $R^{D144}$ | $R^{D144}$ | $L_{C336}$ | $R^{D10}$ | $R^{D17}$ | $L_{C528}$ | $R^{D116}$ | $R^{D88}$ | $L_{C720}$ | $R^{D133}$ | $R^{D41}$ |
| $L_{C145}$ | $R^{D145}$ | $R^{D145}$ | $L_{C337}$ | $R^{D10}$ | $R^{D18}$ | $L_{C529}$ | $R^{D116}$ | $R^{D89}$ | $L_{C721}$ | $R^{D133}$ | $R^{D42}$ |
| $L_{C146}$ | $R^{D146}$ | $R^{D146}$ | $L_{C338}$ | $R^{D10}$ | $R^{D20}$ | $L_{C530}$ | $R^{D116}$ | $R^{D93}$ | $L_{C722}$ | $R^{D133}$ | $R^{D43}$ |
| $L_{C147}$ | $R^{D147}$ | $R^{D147}$ | $L_{C339}$ | $R^{D10}$ | $R^{D22}$ | $L_{C531}$ | $R^{D116}$ | $R^{D117}$ | $L_{C723}$ | $R^{D133}$ | $R^{D48}$ |
| $L_{C148}$ | $R^{D148}$ | $R^{D148}$ | $L_{C340}$ | $R^{D10}$ | $R^{D37}$ | $L_{C532}$ | $R^{D116}$ | $R^{D118}$ | $L_{C724}$ | $R^{D133}$ | $R^{D49}$ |
| $L_{C149}$ | $R^{D149}$ | $R^{D149}$ | $L_{C341}$ | $R^{D10}$ | $R^{D40}$ | $L_{C533}$ | $R^{D116}$ | $R^{D119}$ | $L_{C725}$ | $R^{D133}$ | $R^{D54}$ |
| $L_{C150}$ | $R^{D150}$ | $R^{D150}$ | $L_{C342}$ | $R^{D10}$ | $R^{D41}$ | $L_{C534}$ | $R^{D116}$ | $R^{D120}$ | $L_{C726}$ | $R^{D133}$ | $R^{D58}$ |
| $L_{C151}$ | $R^{D151}$ | $R^{D151}$ | $L_{C343}$ | $R^{D10}$ | $R^{D42}$ | $L_{C535}$ | $R^{D116}$ | $R^{D133}$ | $L_{C727}$ | $R^{D133}$ | $R^{D59}$ |
| $L_{C152}$ | $R^{D152}$ | $R^{D152}$ | $L_{C344}$ | $R^{D10}$ | $R^{D43}$ | $L_{C536}$ | $R^{D116}$ | $R^{D134}$ | $L_{C728}$ | $R^{D133}$ | $R^{D78}$ |
| $L_{C153}$ | $R^{D153}$ | $R^{D153}$ | $L_{C345}$ | $R^{D10}$ | $R^{D48}$ | $L_{C537}$ | $R^{D116}$ | $R^{D135}$ | $L_{C729}$ | $R^{D133}$ | $R^{D79}$ |
| $L_{C154}$ | $R^{D154}$ | $R^{D154}$ | $L_{C346}$ | $R^{D10}$ | $R^{D49}$ | $L_{C538}$ | $R^{D116}$ | $R^{D136}$ | $L_{C730}$ | $R^{D133}$ | $R^{D81}$ |
| $L_{C155}$ | $R^{D155}$ | $R^{D155}$ | $L_{C347}$ | $R^{D10}$ | $R^{D50}$ | $L_{C539}$ | $R^{D116}$ | $R^{D143}$ | $L_{C731}$ | $R^{D133}$ | $R^{D87}$ |
| $L_{C156}$ | $R^{D156}$ | $R^{D156}$ | $L_{C348}$ | $R^{D10}$ | $R^{D54}$ | $L_{C540}$ | $R^{D116}$ | $R^{D144}$ | $L_{C732}$ | $R^{D133}$ | $R^{D88}$ |
| $L_{C157}$ | $R^{D157}$ | $R^{D157}$ | $L_{C349}$ | $R^{D10}$ | $R^{D55}$ | $L_{C541}$ | $R^{D116}$ | $R^{D145}$ | $L_{C733}$ | $R^{D133}$ | $R^{D89}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C158}$ | $R^{D158}$ | $R^{D158}$ | $L_{C350}$ | $R^{D10}$ | $R^{D58}$ | $L_{C542}$ | $R^{D116}$ | $R^{D146}$ | $L_{C734}$ | $R^{D133}$ | $R^{D93}$ |
| $L_{C159}$ | $R^{D159}$ | $R^{D159}$ | $L_{C351}$ | $R^{D10}$ | $R^{D59}$ | $L_{C543}$ | $R^{D116}$ | $R^{D147}$ | $L_{C735}$ | $R^{D133}$ | $R^{D117}$ |
| $L_{C160}$ | $R^{D160}$ | $R^{D160}$ | $L_{C352}$ | $R^{D10}$ | $R^{D78}$ | $L_{C544}$ | $R^{D116}$ | $R^{D149}$ | $L_{C736}$ | $R^{D133}$ | $R^{D118}$ |
| $L_{C161}$ | $R^{D161}$ | $R^{D161}$ | $L_{C353}$ | $R^{D10}$ | $R^{D79}$ | $L_{C545}$ | $R^{D116}$ | $R^{D151}$ | $L_{C737}$ | $R^{D133}$ | $R^{D119}$ |
| $L_{C162}$ | $R^{D162}$ | $R^{D162}$ | $L_{C354}$ | $R^{D10}$ | $R^{D81}$ | $L_{C546}$ | $R^{D116}$ | $R^{D154}$ | $L_{C738}$ | $R^{D133}$ | $R^{D120}$ |
| $L_{C163}$ | $R^{D163}$ | $R^{D163}$ | $L_{C355}$ | $R^{D10}$ | $R^{D87}$ | $L_{C547}$ | $R^{D116}$ | $R^{D155}$ | $L_{C739}$ | $R^{D133}$ | $R^{D133}$ |
| $L_{C164}$ | $R^{D164}$ | $R^{D164}$ | $L_{C356}$ | $R^{D10}$ | $R^{D88}$ | $L_{C548}$ | $R^{D116}$ | $R^{D161}$ | $L_{C740}$ | $R^{D133}$ | $R^{D134}$ |
| $L_{C165}$ | $R^{D165}$ | $R^{D165}$ | $L_{C357}$ | $R^{D10}$ | $R^{D89}$ | $L_{C549}$ | $R^{D116}$ | $R^{D175}$ | $L_{C741}$ | $R^{D133}$ | $R^{D135}$ |
| $L_{C166}$ | $R^{D166}$ | $R^{D166}$ | $L_{C358}$ | $R^{D10}$ | $R^{D93}$ | $L_{C550}$ | $R^{D143}$ | $R^{D3}$ | $L_{C742}$ | $R^{D133}$ | $R^{D136}$ |
| $L_{C167}$ | $R^{D167}$ | $R^{D167}$ | $L_{C359}$ | $R^{D10}$ | $R^{D116}$ | $L_{C551}$ | $R^{D143}$ | $R^{D5}$ | $L_{C743}$ | $R^{D133}$ | $R^{D146}$ |
| $L_{C168}$ | $R^{D168}$ | $R^{D168}$ | $L_{C360}$ | $R^{D10}$ | $R^{D117}$ | $L_{C552}$ | $R^{D143}$ | $R^{D17}$ | $L_{C744}$ | $R^{D133}$ | $R^{D147}$ |
| $L_{C169}$ | $R^{D169}$ | $R^{D169}$ | $L_{C361}$ | $R^{D10}$ | $R^{D118}$ | $L_{C553}$ | $R^{D143}$ | $R^{D18}$ | $L_{C745}$ | $R^{D133}$ | $R^{D149}$ |
| $L_{C170}$ | $R^{D170}$ | $R^{D170}$ | $L_{C362}$ | $R^{D10}$ | $R^{D119}$ | $L_{C554}$ | $R^{D143}$ | $R^{D20}$ | $L_{C746}$ | $R^{D133}$ | $R^{D151}$ |
| $L_{C171}$ | $R^{D171}$ | $R^{D171}$ | $L_{C363}$ | $R^{D10}$ | $R^{D120}$ | $L_{C555}$ | $R^{D143}$ | $R^{D22}$ | $L_{C747}$ | $R^{D133}$ | $R^{D154}$ |
| $L_{C172}$ | $R^{D172}$ | $R^{D172}$ | $L_{C364}$ | $R^{D10}$ | $R^{D133}$ | $L_{C556}$ | $R^{D143}$ | $R^{D37}$ | $L_{C748}$ | $R^{D133}$ | $R^{D155}$ |
| $L_{C173}$ | $R^{D173}$ | $R^{D173}$ | $L_{C365}$ | $R^{D10}$ | $R^{D134}$ | $L_{C557}$ | $R^{D143}$ | $R^{D40}$ | $L_{C749}$ | $R^{D133}$ | $R^{D161}$ |
| $L_{C174}$ | $R^{D174}$ | $R^{D174}$ | $L_{C366}$ | $R^{D10}$ | $R^{D135}$ | $L_{C558}$ | $R^{D143}$ | $R^{D41}$ | $L_{C750}$ | $R^{D133}$ | $R^{D175}$ |
| $L_{C175}$ | $R^{D175}$ | $R^{D175}$ | $L_{C367}$ | $R^{D10}$ | $R^{D136}$ | $L_{C559}$ | $R^{D143}$ | $R^{D42}$ | $L_{C751}$ | $R^{D175}$ | $R^{D3}$ |
| $L_{C176}$ | $R^{D176}$ | $R^{D176}$ | $L_{C368}$ | $R^{D10}$ | $R^{D143}$ | $L_{C560}$ | $R^{D143}$ | $R^{D43}$ | $L_{C752}$ | $R^{D175}$ | $R^{D5}$ |
| $L_{C177}$ | $R^{D177}$ | $R^{D177}$ | $L_{C369}$ | $R^{D10}$ | $R^{D144}$ | $L_{C561}$ | $R^{D143}$ | $R^{D48}$ | $L_{C753}$ | $R^{D175}$ | $R^{D18}$ |
| $L_{C178}$ | $R^{D178}$ | $R^{D178}$ | $L_{C370}$ | $R^{D10}$ | $R^{D145}$ | $L_{C562}$ | $R^{D143}$ | $R^{D49}$ | $L_{C754}$ | $R^{D175}$ | $R^{D20}$ |
| $L_{C179}$ | $R^{D179}$ | $R^{D179}$ | $L_{C371}$ | $R^{D10}$ | $R^{D146}$ | $L_{C563}$ | $R^{D143}$ | $R^{D54}$ | $L_{C755}$ | $R^{D175}$ | $R^{D22}$ |
| $L_{C180}$ | $R^{D180}$ | $R^{D180}$ | $L_{C372}$ | $R^{D10}$ | $R^{D147}$ | $L_{C564}$ | $R^{D143}$ | $R^{D58}$ | $L_{C756}$ | $R^{D175}$ | $R^{D37}$ |
| $L_{C181}$ | $R^{D181}$ | $R^{D181}$ | $L_{C373}$ | $R^{D10}$ | $R^{D149}$ | $L_{C565}$ | $R^{D143}$ | $R^{D59}$ | $L_{C757}$ | $R^{D175}$ | $R^{D40}$ |
| $L_{C182}$ | $R^{D182}$ | $R^{D182}$ | $L_{C374}$ | $R^{D10}$ | $R^{D151}$ | $L_{C566}$ | $R^{D143}$ | $R^{D78}$ | $L_{C758}$ | $R^{D175}$ | $R^{D41}$ |
| $L_{C183}$ | $R^{D183}$ | $R^{D183}$ | $L_{C375}$ | $R^{D10}$ | $R^{D154}$ | $L_{C567}$ | $R^{D143}$ | $R^{D79}$ | $L_{C759}$ | $R^{D175}$ | $R^{D42}$ |
| $L_{C184}$ | $R^{D184}$ | $R^{D184}$ | $L_{C376}$ | $R^{D10}$ | $R^{D155}$ | $L_{C568}$ | $R^{D143}$ | $R^{D81}$ | $L_{C760}$ | $R^{D175}$ | $R^{D43}$ |
| $L_{C185}$ | $R^{D185}$ | $R^{D185}$ | $L_{C377}$ | $R^{D10}$ | $R^{D161}$ | $L_{C569}$ | $R^{D143}$ | $R^{D87}$ | $L_{C761}$ | $R^{D175}$ | $R^{D48}$ |
| $L_{C186}$ | $R^{D186}$ | $R^{D186}$ | $L_{C378}$ | $R^{D10}$ | $R^{D175}$ | $L_{C570}$ | $R^{D143}$ | $R^{D88}$ | $L_{C762}$ | $R^{D175}$ | $R^{D49}$ |
| $L_{C187}$ | $R^{D187}$ | $R^{D187}$ | $L_{C379}$ | $R^{D17}$ | $R^{D3}$ | $L_{C571}$ | $R^{D143}$ | $R^{D89}$ | $L_{C763}$ | $R^{D175}$ | $R^{D54}$ |
| $L_{C188}$ | $R^{D188}$ | $R^{D188}$ | $L_{C380}$ | $R^{D17}$ | $R^{D5}$ | $L_{C572}$ | $R^{D143}$ | $R^{D93}$ | $L_{C764}$ | $R^{D175}$ | $R^{D58}$ |
| $L_{C189}$ | $R^{D189}$ | $R^{D189}$ | $L_{C381}$ | $R^{D17}$ | $R^{D18}$ | $L_{C573}$ | $R^{D143}$ | $R^{D116}$ | $L_{C765}$ | $R^{D175}$ | $R^{D59}$ |
| $L_{C190}$ | $R^{D190}$ | $R^{D190}$ | $L_{C382}$ | $R^{D17}$ | $R^{D20}$ | $L_{C574}$ | $R^{D143}$ | $R^{D117}$ | $L_{C766}$ | $R^{D175}$ | $R^{D78}$ |
| $L_{C191}$ | $R^{D191}$ | $R^{D191}$ | $L_{C383}$ | $R^{D17}$ | $R^{D22}$ | $L_{C575}$ | $R^{D143}$ | $R^{D118}$ | $L_{C767}$ | $R^{D175}$ | $R^{D79}$ |
| $L_{C192}$ | $R^{D192}$ | $R^{D192}$ | $L_{C384}$ | $R^{D17}$ | $R^{D37}$ | $L_{C576}$ | $R^{D143}$ | $R^{D119}$ | $L_{C768}$ | $R^{D175}$ | $R^{D81}$ |
| $L_{C769}$ | $R^{D193}$ | $R^{D193}$ | $L_{C877}$ | $R^{D1}$ | $R^{D193}$ | $L_{C985}$ | $R^{D4}$ | $R^{D193}$ | $L_{C1093}$ | $R^{D9}$ | $R^{D193}$ |
| $L_{C770}$ | $R^{D194}$ | $R^{D194}$ | $L_{C878}$ | $R^{D1}$ | $R^{D194}$ | $L_{C986}$ | $R^{D4}$ | $R^{D194}$ | $L_{C1094}$ | $R^{D9}$ | $R^{D194}$ |
| $L_{C771}$ | $R^{D195}$ | $R^{D195}$ | $L_{C879}$ | $R^{D1}$ | $R^{D195}$ | $L_{C987}$ | $R^{D4}$ | $R^{D195}$ | $L_{C1095}$ | $R^{D9}$ | $R^{D195}$ |
| $L_{C772}$ | $R^{D196}$ | $R^{D196}$ | $L_{C880}$ | $R^{D1}$ | $R^{D196}$ | $L_{C988}$ | $R^{D4}$ | $R^{D196}$ | $L_{C1096}$ | $R^{D9}$ | $R^{D196}$ |
| $L_{C773}$ | $R^{D197}$ | $R^{D197}$ | $L_{C881}$ | $R^{D1}$ | $R^{D197}$ | $L_{C989}$ | $R^{D4}$ | $R^{D197}$ | $L_{C1097}$ | $R^{D9}$ | $R^{D197}$ |
| $L_{C774}$ | $R^{D198}$ | $R^{D198}$ | $L_{C882}$ | $R^{D1}$ | $R^{D198}$ | $L_{C990}$ | $R^{D4}$ | $R^{D198}$ | $L_{C1098}$ | $R^{D9}$ | $R^{D198}$ |
| $L_{C775}$ | $R^{D199}$ | $R^{D199}$ | $L_{C883}$ | $R^{D1}$ | $R^{D199}$ | $L_{C991}$ | $R^{D4}$ | $R^{D199}$ | $L_{C1099}$ | $R^{D9}$ | $R^{D199}$ |
| $L_{C776}$ | $R^{D200}$ | $R^{D200}$ | $L_{C884}$ | $R^{D1}$ | $R^{D200}$ | $L_{C992}$ | $R^{D4}$ | $R^{D200}$ | $L_{C1100}$ | $R^{D9}$ | $R^{D200}$ |
| $L_{C777}$ | $R^{D201}$ | $R^{D201}$ | $L_{C885}$ | $R^{D1}$ | $R^{D201}$ | $L_{C993}$ | $R^{D4}$ | $R^{D201}$ | $L_{C1101}$ | $R^{D9}$ | $R^{D201}$ |
| $L_{C778}$ | $R^{D202}$ | $R^{D202}$ | $L_{C886}$ | $R^{D1}$ | $R^{D202}$ | $L_{C994}$ | $R^{D4}$ | $R^{D202}$ | $L_{C1102}$ | $R^{D9}$ | $R^{D202}$ |
| $L_{C779}$ | $R^{D203}$ | $R^{D203}$ | $L_{C887}$ | $R^{D1}$ | $R^{D203}$ | $L_{C995}$ | $R^{D4}$ | $R^{D203}$ | $L_{C1103}$ | $R^{D9}$ | $R^{D203}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C780}$ | $R^{D204}$ | $R^{D204}$ | $L_{C888}$ | $R^{D1}$ | $R^{D204}$ | $L_{C996}$ | $R^{D4}$ | $R^{D204}$ | $L_{C1104}$ | $R^{D9}$ | $R^{D204}$ |
| $L_{C781}$ | $R^{D205}$ | $R^{D205}$ | $L_{C889}$ | $R^{D1}$ | $R^{D205}$ | $L_{C997}$ | $R^{D4}$ | $R^{D205}$ | $L_{C1105}$ | $R^{D9}$ | $R^{D205}$ |
| $L_{C782}$ | $R^{D206}$ | $R^{D206}$ | $L_{C890}$ | $R^{D1}$ | $R^{D206}$ | $L_{C998}$ | $R^{D4}$ | $R^{D206}$ | $L_{C1106}$ | $R^{D9}$ | $R^{D206}$ |
| $L_{C783}$ | $R^{D207}$ | $R^{D207}$ | $L_{C891}$ | $R^{D1}$ | $R^{D207}$ | $L_{C999}$ | $R^{D4}$ | $R^{D207}$ | $L_{C1107}$ | $R^{D9}$ | $R^{D207}$ |
| $L_{C784}$ | $R^{D208}$ | $R^{D208}$ | $L_{C892}$ | $R^{D1}$ | $R^{D208}$ | $L_{C1000}$ | $R^{D4}$ | $R^{D208}$ | $L_{C1108}$ | $R^{D9}$ | $R^{D208}$ |
| $L_{C785}$ | $R^{D209}$ | $R^{D209}$ | $L_{C893}$ | $R^{D1}$ | $R^{D209}$ | $L_{C1001}$ | $R^{D4}$ | $R^{D209}$ | $L_{C1109}$ | $R^{D9}$ | $R^{D209}$ |
| $L_{C786}$ | $R^{D210}$ | $R^{D210}$ | $L_{C894}$ | $R^{D1}$ | $R^{D210}$ | $L_{C1002}$ | $R^{D4}$ | $R^{D210}$ | $L_{C1110}$ | $R^{D9}$ | $R^{D210}$ |
| $L_{C787}$ | $R^{D211}$ | $R^{D211}$ | $L_{C895}$ | $R^{D1}$ | $R^{D211}$ | $L_{C1003}$ | $R^{D4}$ | $R^{D211}$ | $L_{C1111}$ | $R^{D9}$ | $R^{D211}$ |
| $L_{C788}$ | $R^{D212}$ | $R^{D212}$ | $L_{C896}$ | $R^{D1}$ | $R^{D212}$ | $L_{C1004}$ | $R^{D4}$ | $R^{D212}$ | $L_{C1112}$ | $R^{D9}$ | $R^{D212}$ |
| $L_{C789}$ | $R^{D213}$ | $R^{D213}$ | $L_{C897}$ | $R^{D1}$ | $R^{D213}$ | $L_{C1005}$ | $R^{D4}$ | $R^{D213}$ | $L_{C1113}$ | $R^{D9}$ | $R^{D213}$ |
| $L_{C790}$ | $R^{D214}$ | $R^{D214}$ | $L_{C898}$ | $R^{D1}$ | $R^{D214}$ | $L_{C1006}$ | $R^{D4}$ | $R^{D214}$ | $L_{C1114}$ | $R^{D9}$ | $R^{D214}$ |
| $L_{C791}$ | $R^{D215}$ | $R^{D215}$ | $L_{C899}$ | $R^{D1}$ | $R^{D215}$ | $L_{C1007}$ | $R^{D4}$ | $R^{D215}$ | $L_{C1115}$ | $R^{D9}$ | $R^{D215}$ |
| $L_{C792}$ | $R^{D216}$ | $R^{D216}$ | $L_{C900}$ | $R^{D1}$ | $R^{D216}$ | $L_{C1008}$ | $R^{D4}$ | $R^{D216}$ | $L_{C1116}$ | $R^{D9}$ | $R^{D216}$ |
| $L_{C793}$ | $R^{D217}$ | $R^{D217}$ | $L_{C901}$ | $R^{D1}$ | $R^{D217}$ | $L_{C1009}$ | $R^{D4}$ | $R^{D217}$ | $L_{C1117}$ | $R^{D9}$ | $R^{D217}$ |
| $L_{C794}$ | $R^{D218}$ | $R^{D218}$ | $L_{C902}$ | $R^{D1}$ | $R^{D218}$ | $L_{C1010}$ | $R^{D4}$ | $R^{D218}$ | $L_{C1118}$ | $R^{D9}$ | $R^{D218}$ |
| $L_{C795}$ | $R^{D219}$ | $R^{D219}$ | $L_{C903}$ | $R^{D1}$ | $R^{D219}$ | $L_{C1011}$ | $R^{D4}$ | $R^{D219}$ | $L_{C1119}$ | $R^{D9}$ | $R^{D219}$ |
| $L_{C796}$ | $R^{D220}$ | $R^{D220}$ | $L_{C904}$ | $R^{D1}$ | $R^{D220}$ | $L_{C1012}$ | $R^{D4}$ | $R^{D220}$ | $L_{C1120}$ | $R^{D9}$ | $R^{D220}$ |
| $L_{C797}$ | $R^{D221}$ | $R^{D221}$ | $L_{C905}$ | $R^{D1}$ | $R^{D221}$ | $L_{C1013}$ | $R^{D4}$ | $R^{D221}$ | $L_{C1121}$ | $R^{D9}$ | $R^{D221}$ |
| $L_{C798}$ | $R^{D222}$ | $R^{D222}$ | $L_{C906}$ | $R^{D1}$ | $R^{D222}$ | $L_{C1014}$ | $R^{D4}$ | $R^{D222}$ | $L_{C1122}$ | $R^{D9}$ | $R^{D222}$ |
| $L_{C799}$ | $R^{D223}$ | $R^{D223}$ | $L_{C907}$ | $R^{D1}$ | $R^{D223}$ | $L_{C1015}$ | $R^{D4}$ | $R^{D223}$ | $L_{C1123}$ | $R^{D9}$ | $R^{D223}$ |
| $L_{C800}$ | $R^{D224}$ | $R^{D224}$ | $L_{C908}$ | $R^{D1}$ | $R^{D224}$ | $L_{C1016}$ | $R^{D4}$ | $R^{D224}$ | $L_{C1124}$ | $R^{D9}$ | $R^{D224}$ |
| $L_{C801}$ | $R^{D225}$ | $R^{D225}$ | $L_{C909}$ | $R^{D1}$ | $R^{D225}$ | $L_{C1017}$ | $R^{D4}$ | $R^{D225}$ | $L_{C1125}$ | $R^{D9}$ | $R^{D225}$ |
| $L_{C802}$ | $R^{D226}$ | $R^{D226}$ | $L_{C910}$ | $R^{D1}$ | $R^{D226}$ | $L_{C1018}$ | $R^{D4}$ | $R^{D226}$ | $L_{C1126}$ | $R^{D9}$ | $R^{D226}$ |
| $L_{C803}$ | $R^{D227}$ | $R^{D227}$ | $L_{C911}$ | $R^{D1}$ | $R^{D227}$ | $L_{C1019}$ | $R^{D4}$ | $R^{D227}$ | $L_{C1127}$ | $R^{D9}$ | $R^{D227}$ |
| $L_{C804}$ | $R^{D228}$ | $R^{D228}$ | $L_{C912}$ | $R^{D1}$ | $R^{D228}$ | $L_{C1020}$ | $R^{D4}$ | $R^{D228}$ | $L_{C1128}$ | $R^{D9}$ | $R^{D228}$ |
| $L_{C805}$ | $R^{D229}$ | $R^{D229}$ | $L_{C913}$ | $R^{D1}$ | $R^{D229}$ | $L_{C1021}$ | $R^{D4}$ | $R^{D229}$ | $L_{C1129}$ | $R^{D9}$ | $R^{D229}$ |
| $L_{C806}$ | $R^{D230}$ | $R^{D230}$ | $L_{C914}$ | $R^{D1}$ | $R^{D230}$ | $L_{C1022}$ | $R^{D4}$ | $R^{D230}$ | $L_{C1130}$ | $R^{D9}$ | $R^{D230}$ |
| $L_{C807}$ | $R^{D231}$ | $R^{D231}$ | $L_{C915}$ | $R^{D1}$ | $R^{D231}$ | $L_{C1023}$ | $R^{D4}$ | $R^{D231}$ | $L_{C1131}$ | $R^{D9}$ | $R^{D231}$ |
| $L_{C808}$ | $R^{D232}$ | $R^{D232}$ | $L_{C916}$ | $R^{D1}$ | $R^{D232}$ | $L_{C1024}$ | $R^{D4}$ | $R^{D232}$ | $L_{C1132}$ | $R^{D9}$ | $R^{D232}$ |
| $L_{C809}$ | $R^{D233}$ | $R^{D233}$ | $L_{C917}$ | $R^{D1}$ | $R^{D233}$ | $L_{C1025}$ | $R^{D4}$ | $R^{D233}$ | $L_{C1133}$ | $R^{D9}$ | $R^{D233}$ |
| $L_{C810}$ | $R^{D234}$ | $R^{D234}$ | $L_{C918}$ | $R^{D1}$ | $R^{D234}$ | $L_{C1026}$ | $R^{D4}$ | $R^{D234}$ | $L_{C1134}$ | $R^{D9}$ | $R^{D234}$ |
| $L_{C811}$ | $R^{D235}$ | $R^{D235}$ | $L_{C919}$ | $R^{D1}$ | $R^{D235}$ | $L_{C1027}$ | $R^{D4}$ | $R^{D235}$ | $L_{C1135}$ | $R^{D9}$ | $R^{D235}$ |
| $L_{C812}$ | $R^{D236}$ | $R^{D236}$ | $L_{C920}$ | $R^{D1}$ | $R^{D236}$ | $L_{C1028}$ | $R^{D4}$ | $R^{D236}$ | $L_{C1136}$ | $R^{D9}$ | $R^{D236}$ |
| $L_{C813}$ | $R^{D237}$ | $R^{D237}$ | $L_{C921}$ | $R^{D1}$ | $R^{D237}$ | $L_{C1029}$ | $R^{D4}$ | $R^{D237}$ | $L_{C1137}$ | $R^{D9}$ | $R^{D237}$ |
| $L_{C814}$ | $R^{D238}$ | $R^{D238}$ | $L_{C922}$ | $R^{D1}$ | $R^{D238}$ | $L_{C1030}$ | $R^{D4}$ | $R^{D238}$ | $L_{C1138}$ | $R^{D9}$ | $R^{D238}$ |
| $L_{C815}$ | $R^{D239}$ | $R^{D239}$ | $L_{C923}$ | $R^{D1}$ | $R^{D239}$ | $L_{C1031}$ | $R^{D4}$ | $R^{D239}$ | $L_{C1139}$ | $R^{D9}$ | $R^{D239}$ |
| $L_{C816}$ | $R^{D240}$ | $R^{D240}$ | $L_{C924}$ | $R^{D1}$ | $R^{D240}$ | $L_{C1032}$ | $R^{D4}$ | $R^{D240}$ | $L_{C1140}$ | $R^{D9}$ | $R^{D240}$ |
| $L_{C817}$ | $R^{D241}$ | $R^{D241}$ | $L_{C925}$ | $R^{D1}$ | $R^{D241}$ | $L_{C1033}$ | $R^{D4}$ | $R^{D241}$ | $L_{C1141}$ | $R^{D9}$ | $R^{D241}$ |
| $L_{C818}$ | $R^{D242}$ | $R^{D242}$ | $L_{C926}$ | $R^{D1}$ | $R^{D242}$ | $L_{C1034}$ | $R^{D4}$ | $R^{D242}$ | $L_{C1142}$ | $R^{D9}$ | $R^{D242}$ |
| $L_{C819}$ | $R^{D243}$ | $R^{D243}$ | $L_{C927}$ | $R^{D1}$ | $R^{D243}$ | $L_{C1035}$ | $R^{D4}$ | $R^{D243}$ | $L_{C1143}$ | $R^{D9}$ | $R^{D243}$ |
| $L_{C820}$ | $R^{D244}$ | $R^{D244}$ | $L_{C928}$ | $R^{D1}$ | $R^{D244}$ | $L_{C1036}$ | $R^{D4}$ | $R^{D244}$ | $L_{C1144}$ | $R^{D9}$ | $R^{D244}$ |
| $L_{C821}$ | $R^{D245}$ | $R^{D245}$ | $L_{C929}$ | $R^{D1}$ | $R^{D245}$ | $L_{C1037}$ | $R^{D4}$ | $R^{D245}$ | $L_{C1145}$ | $R^{D9}$ | $R^{D245}$ |
| $L_{C822}$ | $R^{D246}$ | $R^{D246}$ | $L_{C930}$ | $R^{D1}$ | $R^{D246}$ | $L_{C1038}$ | $R^{D4}$ | $R^{D246}$ | $L_{C1146}$ | $R^{D9}$ | $R^{D246}$ |
| $L_{C823}$ | $R^{D17}$ | $R^{D193}$ | $L_{C931}$ | $R^{D50}$ | $R^{D193}$ | $L_{C1039}$ | $R^{D145}$ | $R^{D193}$ | $L_{C1147}$ | $R^{D168}$ | $R^{D193}$ |
| $L_{C824}$ | $R^{D17}$ | $R^{D194}$ | $L_{C932}$ | $R^{D50}$ | $R^{D194}$ | $L_{C1040}$ | $R^{D145}$ | $R^{D194}$ | $L_{C1148}$ | $R^{D168}$ | $R^{D194}$ |
| $L_{C825}$ | $R^{D17}$ | $R^{D195}$ | $L_{C933}$ | $R^{D50}$ | $R^{D195}$ | $L_{C1041}$ | $R^{D145}$ | $R^{D195}$ | $L_{C1149}$ | $R^{D168}$ | $R^{D195}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C826}$ | $R^{D17}$ | $R^{D196}$ | $L_{C934}$ | $R^{D50}$ | $R^{D196}$ | $L_{C1042}$ | $R^{D145}$ | $R^{D196}$ | $L_{C1150}$ | $R^{D168}$ | $R^{D196}$ |
| $L_{C827}$ | $R^{D17}$ | $R^{D197}$ | $L_{C935}$ | $R^{D50}$ | $R^{D197}$ | $L_{C1043}$ | $R^{D145}$ | $R^{D197}$ | $L_{C1151}$ | $R^{D168}$ | $R^{D197}$ |
| $L_{C828}$ | $R^{D17}$ | $R^{D198}$ | $L_{C936}$ | $R^{D50}$ | $R^{D198}$ | $L_{C1044}$ | $R^{D145}$ | $R^{D198}$ | $L_{C1152}$ | $R^{D168}$ | $R^{D198}$ |
| $L_{C829}$ | $R^{D17}$ | $R^{D199}$ | $L_{C937}$ | $R^{D50}$ | $R^{D199}$ | $L_{C1045}$ | $R^{D145}$ | $R^{D199}$ | $L_{C1153}$ | $R^{D168}$ | $R^{D199}$ |
| $L_{C830}$ | $R^{D17}$ | $R^{D200}$ | $L_{C938}$ | $R^{D50}$ | $R^{D200}$ | $L_{C1046}$ | $R^{D145}$ | $R^{D200}$ | $L_{C1154}$ | $R^{D168}$ | $R^{D200}$ |
| $L_{C831}$ | $R^{D17}$ | $R^{D201}$ | $L_{C939}$ | $R^{D50}$ | $R^{D201}$ | $L_{C1047}$ | $R^{D145}$ | $R^{D201}$ | $L_{C1155}$ | $R^{D168}$ | $R^{D201}$ |
| $L_{C832}$ | $R^{D17}$ | $R^{D202}$ | $L_{C940}$ | $R^{D50}$ | $R^{D202}$ | $L_{C1048}$ | $R^{D145}$ | $R^{D202}$ | $L_{C1156}$ | $R^{D168}$ | $R^{D202}$ |
| $L_{C833}$ | $R^{D17}$ | $R^{D203}$ | $L_{C941}$ | $R^{D50}$ | $R^{D203}$ | $L_{C1049}$ | $R^{D145}$ | $R^{D203}$ | $L_{C1157}$ | $R^{D168}$ | $R^{D203}$ |
| $L_{C834}$ | $R^{D17}$ | $R^{D204}$ | $L_{C942}$ | $R^{D50}$ | $R^{D204}$ | $L_{C1050}$ | $R^{D145}$ | $R^{D204}$ | $L_{C1158}$ | $R^{D168}$ | $R^{D204}$ |
| $L_{C835}$ | $R^{D17}$ | $R^{D205}$ | $L_{C943}$ | $R^{D50}$ | $R^{D205}$ | $L_{C1051}$ | $R^{D145}$ | $R^{D205}$ | $L_{C1159}$ | $R^{D168}$ | $R^{D205}$ |
| $L_{C836}$ | $R^{D17}$ | $R^{D206}$ | $L_{C944}$ | $R^{D50}$ | $R^{D206}$ | $L_{C1052}$ | $R^{D145}$ | $R^{D206}$ | $L_{C1160}$ | $R^{D168}$ | $R^{D206}$ |
| $L_{C837}$ | $R^{D17}$ | $R^{D207}$ | $L_{C945}$ | $R^{D50}$ | $R^{D207}$ | $L_{C1053}$ | $R^{D145}$ | $R^{D207}$ | $L_{C1161}$ | $R^{D168}$ | $R^{D207}$ |
| $L_{C838}$ | $R^{D17}$ | $R^{D208}$ | $L_{C946}$ | $R^{D50}$ | $R^{D208}$ | $L_{C1054}$ | $R^{D145}$ | $R^{D208}$ | $L_{C1162}$ | $R^{D168}$ | $R^{D208}$ |
| $L_{C839}$ | $R^{D17}$ | $R^{D209}$ | $L_{C947}$ | $R^{D50}$ | $R^{D209}$ | $L_{C1055}$ | $R^{D145}$ | $R^{D209}$ | $L_{C1163}$ | $R^{D168}$ | $R^{D209}$ |
| $L_{C840}$ | $R^{D17}$ | $R^{D210}$ | $L_{C948}$ | $R^{D50}$ | $R^{D210}$ | $L_{C1056}$ | $R^{D145}$ | $R^{D210}$ | $L_{C1164}$ | $R^{D168}$ | $R^{D210}$ |
| $L_{C841}$ | $R^{D17}$ | $R^{D211}$ | $L_{C949}$ | $R^{D50}$ | $R^{D211}$ | $L_{C1057}$ | $R^{D145}$ | $R^{D211}$ | $L_{C1165}$ | $R^{D168}$ | $R^{D211}$ |
| $L_{C842}$ | $R^{D17}$ | $R^{D212}$ | $L_{C950}$ | $R^{D50}$ | $R^{D212}$ | $L_{C1058}$ | $R^{D145}$ | $R^{D212}$ | $L_{C1166}$ | $R^{D168}$ | $R^{D212}$ |
| $L_{C843}$ | $R^{D17}$ | $R^{D213}$ | $L_{C951}$ | $R^{D50}$ | $R^{D213}$ | $L_{C1059}$ | $R^{D145}$ | $R^{D213}$ | $L_{C1167}$ | $R^{D168}$ | $R^{D213}$ |
| $L_{C844}$ | $R^{D17}$ | $R^{D214}$ | $L_{C952}$ | $R^{D50}$ | $R^{D214}$ | $L_{C1060}$ | $R^{D145}$ | $R^{D214}$ | $L_{C1168}$ | $R^{D168}$ | $R^{D214}$ |
| $L_{C845}$ | $R^{D17}$ | $R^{D215}$ | $L_{C953}$ | $R^{D50}$ | $R^{D215}$ | $L_{C1061}$ | $R^{D145}$ | $R^{D215}$ | $L_{C1169}$ | $R^{D168}$ | $R^{D215}$ |
| $L_{C846}$ | $R^{D17}$ | $R^{D216}$ | $L_{C954}$ | $R^{D50}$ | $R^{D216}$ | $L_{C1062}$ | $R^{D145}$ | $R^{D216}$ | $L_{C1170}$ | $R^{D168}$ | $R^{D216}$ |
| $L_{C847}$ | $R^{D17}$ | $R^{D217}$ | $L_{C955}$ | $R^{D50}$ | $R^{D217}$ | $L_{C1063}$ | $R^{D145}$ | $R^{D217}$ | $L_{C1171}$ | $R^{D168}$ | $R^{D217}$ |
| $L_{C848}$ | $R^{D17}$ | $R^{D218}$ | $L_{C956}$ | $R^{D50}$ | $R^{D218}$ | $L_{C1064}$ | $R^{D145}$ | $R^{D218}$ | $L_{C1172}$ | $R^{D168}$ | $R^{D218}$ |
| $L_{C849}$ | $R^{D17}$ | $R^{D219}$ | $L_{C957}$ | $R^{D50}$ | $R^{D219}$ | $L_{C1065}$ | $R^{D145}$ | $R^{D219}$ | $L_{C1173}$ | $R^{D168}$ | $R^{D219}$ |
| $L_{C850}$ | $R^{D17}$ | $R^{D220}$ | $L_{C958}$ | $R^{D50}$ | $R^{D220}$ | $L_{C1066}$ | $R^{D145}$ | $R^{D220}$ | $L_{C1174}$ | $R^{D168}$ | $R^{D220}$ |
| $L_{C851}$ | $R^{D17}$ | $R^{D221}$ | $L_{C959}$ | $R^{D50}$ | $R^{D221}$ | $L_{C1067}$ | $R^{D145}$ | $R^{D221}$ | $L_{C1175}$ | $R^{D168}$ | $R^{D221}$ |
| $L_{C852}$ | $R^{D17}$ | $R^{D222}$ | $L_{C960}$ | $R^{D50}$ | $R^{D222}$ | $L_{C1068}$ | $R^{D145}$ | $R^{D222}$ | $L_{C1176}$ | $R^{D168}$ | $R^{D222}$ |
| $L_{C853}$ | $R^{D17}$ | $R^{D223}$ | $L_{C961}$ | $R^{D50}$ | $R^{D223}$ | $L_{C1069}$ | $R^{D145}$ | $R^{D223}$ | $L_{C1177}$ | $R^{D168}$ | $R^{D223}$ |
| $L_{C854}$ | $R^{D17}$ | $R^{D224}$ | $L_{C962}$ | $R^{D50}$ | $R^{D224}$ | $L_{C1070}$ | $R^{D145}$ | $R^{D224}$ | $L_{C1178}$ | $R^{D168}$ | $R^{D224}$ |
| $L_{C855}$ | $R^{D17}$ | $R^{D225}$ | $L_{C963}$ | $R^{D50}$ | $R^{D225}$ | $L_{C1071}$ | $R^{D145}$ | $R^{D225}$ | $L_{C1179}$ | $R^{D168}$ | $R^{D225}$ |
| $L_{C856}$ | $R^{D17}$ | $R^{D226}$ | $L_{C964}$ | $R^{D50}$ | $R^{D226}$ | $L_{C1072}$ | $R^{D145}$ | $R^{D226}$ | $L_{C1180}$ | $R^{D168}$ | $R^{D226}$ |
| $L_{C857}$ | $R^{D17}$ | $R^{D227}$ | $L_{C965}$ | $R^{D50}$ | $R^{D227}$ | $L_{C1073}$ | $R^{D145}$ | $R^{D227}$ | $L_{C1181}$ | $R^{D168}$ | $R^{D227}$ |
| $L_{C858}$ | $R^{D17}$ | $R^{D228}$ | $L_{C966}$ | $R^{D50}$ | $R^{D228}$ | $L_{C1074}$ | $R^{D145}$ | $R^{D228}$ | $L_{C1182}$ | $R^{D168}$ | $R^{D228}$ |
| $L_{C859}$ | $R^{D17}$ | $R^{D229}$ | $L_{C967}$ | $R^{D50}$ | $R^{D229}$ | $L_{C1075}$ | $R^{D145}$ | $R^{D229}$ | $L_{C1183}$ | $R^{D168}$ | $R^{D229}$ |
| $L_{C860}$ | $R^{D17}$ | $R^{D230}$ | $L_{C968}$ | $R^{D50}$ | $R^{D230}$ | $L_{C1076}$ | $R^{D145}$ | $R^{D230}$ | $L_{C1184}$ | $R^{D168}$ | $R^{D230}$ |
| $L_{C861}$ | $R^{D17}$ | $R^{D231}$ | $L_{C969}$ | $R^{D50}$ | $R^{D231}$ | $L_{C1077}$ | $R^{D145}$ | $R^{D231}$ | $L_{C1185}$ | $R^{D168}$ | $R^{D231}$ |
| $L_{C862}$ | $R^{D17}$ | $R^{D232}$ | $L_{C970}$ | $R^{D50}$ | $R^{D232}$ | $L_{C1078}$ | $R^{D145}$ | $R^{D232}$ | $L_{C1186}$ | $R^{D168}$ | $R^{D232}$ |
| $L_{C863}$ | $R^{D17}$ | $R^{D233}$ | $L_{C971}$ | $R^{D50}$ | $R^{D233}$ | $L_{C1079}$ | $R^{D145}$ | $R^{D233}$ | $L_{C1187}$ | $R^{D168}$ | $R^{D233}$ |
| $L_{C864}$ | $R^{D17}$ | $R^{D234}$ | $L_{C972}$ | $R^{D50}$ | $R^{D234}$ | $L_{C1080}$ | $R^{D145}$ | $R^{D234}$ | $L_{C1188}$ | $R^{D168}$ | $R^{D234}$ |
| $L_{C865}$ | $R^{D17}$ | $R^{D235}$ | $L_{C973}$ | $R^{D50}$ | $R^{D235}$ | $L_{C1081}$ | $R^{D145}$ | $R^{D235}$ | $L_{C1189}$ | $R^{D168}$ | $R^{D235}$ |
| $L_{C866}$ | $R^{D17}$ | $R^{D236}$ | $L_{C974}$ | $R^{D50}$ | $R^{D236}$ | $L_{C1082}$ | $R^{D145}$ | $R^{D236}$ | $L_{C1190}$ | $R^{D168}$ | $R^{D236}$ |
| $L_{C867}$ | $R^{D17}$ | $R^{D237}$ | $L_{C975}$ | $R^{D50}$ | $R^{D237}$ | $L_{C1083}$ | $R^{D145}$ | $R^{D237}$ | $L_{C1191}$ | $R^{D168}$ | $R^{D237}$ |
| $L_{C868}$ | $R^{D17}$ | $R^{D238}$ | $L_{C976}$ | $R^{D50}$ | $R^{D238}$ | $L_{C1084}$ | $R^{D145}$ | $R^{D238}$ | $L_{C1192}$ | $R^{D168}$ | $R^{D238}$ |
| $L_{C869}$ | $R^{D17}$ | $R^{D239}$ | $L_{C977}$ | $R^{D50}$ | $R^{D239}$ | $L_{C1085}$ | $R^{D145}$ | $R^{D239}$ | $L_{C1193}$ | $R^{D168}$ | $R^{D239}$ |
| $L_{C870}$ | $R^{D17}$ | $R^{D240}$ | $L_{C978}$ | $R^{D50}$ | $R^{D240}$ | $L_{C1086}$ | $R^{D145}$ | $R^{D240}$ | $L_{C1194}$ | $R^{D168}$ | $R^{D240}$ |
| $L_{C871}$ | $R^{D17}$ | $R^{D241}$ | $L_{C979}$ | $R^{D50}$ | $R^{D241}$ | $L_{C1087}$ | $R^{D145}$ | $R^{D241}$ | $L_{C1195}$ | $R^{D168}$ | $R^{D241}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C872}$ | $R^{D17}$ | $R^{D242}$ | $L_{C980}$ | $R^{D50}$ | $R^{D242}$ | $L_{C1088}$ | $R^{D145}$ | $R^{D242}$ | $L_{C1196}$ | $R^{D168}$ | $R^{D242}$ |
| $L_{C873}$ | $R^{D17}$ | $R^{D243}$ | $L_{C981}$ | $R^{D50}$ | $R^{D243}$ | $L_{C1089}$ | $R^{D145}$ | $R^{D243}$ | $L_{C1197}$ | $R^{D168}$ | $R^{D243}$ |
| $L_{C874}$ | $R^{D17}$ | $R^{D244}$ | $L_{C982}$ | $R^{D50}$ | $R^{D244}$ | $L_{C1090}$ | $R^{D145}$ | $R^{D244}$ | $L_{C1198}$ | $R^{D168}$ | $R^{D244}$ |
| $L_{C875}$ | $R^{D17}$ | $R^{D245}$ | $L_{C983}$ | $R^{D50}$ | $R^{D245}$ | $L_{C1091}$ | $R^{D145}$ | $R^{D245}$ | $L_{C1199}$ | $R^{D168}$ | $R^{D245}$ |
| $L_{C876}$ | $R^{D17}$ | $R^{D246}$ | $L_{C984}$ | $R^{D50}$ | $R^{D246}$ | $L_{C1092}$ | $R^{D145}$ | $R^{D246}$ | $L_{C1200}$ | $R^{D168}$ | $R^{D246}$ |
| $L_{C1201}$ | $R^{D10}$ | $R^{D193}$ | $L_{C1255}$ | $R^{D55}$ | $R^{D193}$ | $L_{C1309}$ | $R^{D37}$ | $R^{D193}$ | $L_{C1363}$ | $R^{D143}$ | $R^{D193}$ |
| $L_{C1202}$ | $R^{D10}$ | $R^{D194}$ | $L_{C1256}$ | $R^{D55}$ | $R^{D194}$ | $L_{C1310}$ | $R^{D37}$ | $R^{D194}$ | $L_{C1364}$ | $R^{D143}$ | $R^{D194}$ |
| $L_{C1203}$ | $R^{D10}$ | $R^{D195}$ | $L_{C1257}$ | $R^{D55}$ | $R^{D195}$ | $L_{C1311}$ | $R^{D37}$ | $R^{D195}$ | $L_{C1365}$ | $R^{D143}$ | $R^{D195}$ |
| $L_{C1204}$ | $R^{D10}$ | $R^{D196}$ | $L_{C1258}$ | $R^{D55}$ | $R^{D196}$ | $L_{C1312}$ | $R^{D37}$ | $R^{D196}$ | $L_{C1366}$ | $R^{D143}$ | $R^{D196}$ |
| $L_{C1205}$ | $R^{D10}$ | $R^{D197}$ | $L_{C1259}$ | $R^{D55}$ | $R^{D197}$ | $L_{C1313}$ | $R^{D37}$ | $R^{D197}$ | $L_{C1367}$ | $R^{D143}$ | $R^{D197}$ |
| $L_{C1206}$ | $R^{D10}$ | $R^{D198}$ | $L_{C1260}$ | $R^{D55}$ | $R^{D198}$ | $L_{C1314}$ | $R^{D37}$ | $R^{D198}$ | $L_{C1368}$ | $R^{D143}$ | $R^{D198}$ |
| $L_{C1207}$ | $R^{D10}$ | $R^{D199}$ | $L_{C1261}$ | $R^{D55}$ | $R^{D199}$ | $L_{C1315}$ | $R^{D37}$ | $R^{D199}$ | $L_{C1369}$ | $R^{D143}$ | $R^{D199}$ |
| $L_{C1208}$ | $R^{D10}$ | $R^{D200}$ | $L_{C1262}$ | $R^{D55}$ | $R^{D200}$ | $L_{C1316}$ | $R^{D37}$ | $R^{D200}$ | $L_{C1370}$ | $R^{D143}$ | $R^{D200}$ |
| $L_{C1209}$ | $R^{D10}$ | $R^{D201}$ | $L_{C1263}$ | $R^{D55}$ | $R^{D201}$ | $L_{C1317}$ | $R^{D37}$ | $R^{D201}$ | $L_{C1371}$ | $R^{D143}$ | $R^{D201}$ |
| $L_{C1210}$ | $R^{D10}$ | $R^{D202}$ | $L_{C1264}$ | $R^{D55}$ | $R^{D202}$ | $L_{C1318}$ | $R^{D37}$ | $R^{D202}$ | $L_{C1372}$ | $R^{D143}$ | $R^{D202}$ |
| $L_{C1211}$ | $R^{D10}$ | $R^{D203}$ | $L_{C1265}$ | $R^{D55}$ | $R^{D203}$ | $L_{C1319}$ | $R^{D37}$ | $R^{D203}$ | $L_{C1373}$ | $R^{D143}$ | $R^{D203}$ |
| $L_{C1212}$ | $R^{D10}$ | $R^{D204}$ | $L_{C1266}$ | $R^{D55}$ | $R^{D204}$ | $L_{C1320}$ | $R^{D37}$ | $R^{D204}$ | $L_{C1374}$ | $R^{D143}$ | $R^{D204}$ |
| $L_{C1213}$ | $R^{D10}$ | $R^{D205}$ | $L_{C1267}$ | $R^{D55}$ | $R^{D205}$ | $L_{C1321}$ | $R^{D37}$ | $R^{D205}$ | $L_{C1375}$ | $R^{D143}$ | $R^{D205}$ |
| $L_{C1214}$ | $R^{D10}$ | $R^{D206}$ | $L_{C1268}$ | $R^{D55}$ | $R^{D206}$ | $L_{C1322}$ | $R^{D37}$ | $R^{D206}$ | $L_{C1376}$ | $R^{D143}$ | $R^{D206}$ |
| $L_{C1215}$ | $R^{D10}$ | $R^{D207}$ | $L_{C1269}$ | $R^{D55}$ | $R^{D207}$ | $L_{C1323}$ | $R^{D37}$ | $R^{D207}$ | $L_{C1377}$ | $R^{D143}$ | $R^{D207}$ |
| $L_{C1216}$ | $R^{D10}$ | $R^{D208}$ | $L_{C1270}$ | $R^{D55}$ | $R^{D208}$ | $L_{C1324}$ | $R^{D37}$ | $R^{D208}$ | $L_{C1378}$ | $R^{D143}$ | $R^{D208}$ |
| $L_{C1217}$ | $R^{D10}$ | $R^{D209}$ | $L_{C1271}$ | $R^{D55}$ | $R^{D209}$ | $L_{C1325}$ | $R^{D37}$ | $R^{D209}$ | $L_{C1379}$ | $R^{D143}$ | $R^{D209}$ |
| $L_{C1218}$ | $R^{D10}$ | $R^{D210}$ | $L_{C1272}$ | $R^{D55}$ | $R^{D210}$ | $L_{C1326}$ | $R^{D37}$ | $R^{D210}$ | $L_{C1380}$ | $R^{D143}$ | $R^{D210}$ |
| $L_{C1219}$ | $R^{D10}$ | $R^{D211}$ | $L_{C1273}$ | $R^{D55}$ | $R^{D211}$ | $L_{C1327}$ | $R^{D37}$ | $R^{D211}$ | $L_{C1381}$ | $R^{D143}$ | $R^{D211}$ |
| $L_{C1220}$ | $R^{D10}$ | $R^{D212}$ | $L_{C1274}$ | $R^{D55}$ | $R^{D212}$ | $L_{C1328}$ | $R^{D37}$ | $R^{D212}$ | $L_{C1382}$ | $R^{D143}$ | $R^{D212}$ |
| $L_{C1221}$ | $R^{D10}$ | $R^{D213}$ | $L_{C1275}$ | $R^{D55}$ | $R^{D213}$ | $L_{C1329}$ | $R^{D37}$ | $R^{D213}$ | $L_{C1383}$ | $R^{D143}$ | $R^{D213}$ |
| $L_{C1222}$ | $R^{D10}$ | $R^{D214}$ | $L_{C1276}$ | $R^{D55}$ | $R^{D214}$ | $L_{C1330}$ | $R^{D37}$ | $R^{D214}$ | $L_{C1384}$ | $R^{D143}$ | $R^{D214}$ |
| $L_{C1223}$ | $R^{D10}$ | $R^{D215}$ | $L_{C1277}$ | $R^{D55}$ | $R^{D215}$ | $L_{C1331}$ | $R^{D37}$ | $R^{D215}$ | $L_{C1385}$ | $R^{D143}$ | $R^{D215}$ |
| $L_{C1224}$ | $R^{D10}$ | $R^{D216}$ | $L_{C1278}$ | $R^{D55}$ | $R^{D216}$ | $L_{C1332}$ | $R^{D37}$ | $R^{D216}$ | $L_{C1386}$ | $R^{D143}$ | $R^{D216}$ |
| $L_{C1225}$ | $R^{D10}$ | $R^{D217}$ | $L_{C1279}$ | $R^{D55}$ | $R^{D217}$ | $L_{C1333}$ | $R^{D37}$ | $R^{D217}$ | $L_{C1387}$ | $R^{D143}$ | $R^{D217}$ |
| $L_{C1226}$ | $R^{D10}$ | $R^{D218}$ | $L_{C1280}$ | $R^{D55}$ | $R^{D218}$ | $L_{C1334}$ | $R^{D37}$ | $R^{D218}$ | $L_{C1388}$ | $R^{D143}$ | $R^{D218}$ |
| $L_{C1227}$ | $R^{D10}$ | $R^{D219}$ | $L_{C1281}$ | $R^{D55}$ | $R^{D219}$ | $L_{C1335}$ | $R^{D37}$ | $R^{D219}$ | $L_{C1389}$ | $R^{D143}$ | $R^{D219}$ |
| $L_{C1228}$ | $R^{D10}$ | $R^{D220}$ | $L_{C1282}$ | $R^{D55}$ | $R^{D220}$ | $L_{C1336}$ | $R^{D37}$ | $R^{D220}$ | $L_{C1390}$ | $R^{D143}$ | $R^{D220}$ |
| $L_{C1229}$ | $R^{D10}$ | $R^{D221}$ | $L_{C1283}$ | $R^{D55}$ | $R^{D221}$ | $L_{C1337}$ | $R^{D37}$ | $R^{D221}$ | $L_{C1391}$ | $R^{D143}$ | $R^{D221}$ |
| $L_{C1230}$ | $R^{D10}$ | $R^{D222}$ | $L_{C1284}$ | $R^{D55}$ | $R^{D222}$ | $L_{C1338}$ | $R^{D37}$ | $R^{D222}$ | $L_{C1392}$ | $R^{D143}$ | $R^{D222}$ |
| $L_{C1231}$ | $R^{D10}$ | $R^{D223}$ | $L_{C1285}$ | $R^{D55}$ | $R^{D223}$ | $L_{C1339}$ | $R^{D37}$ | $R^{D223}$ | $L_{C1393}$ | $R^{D143}$ | $R^{D223}$ |
| $L_{C1232}$ | $R^{D10}$ | $R^{D224}$ | $L_{C1286}$ | $R^{D55}$ | $R^{D224}$ | $L_{C1340}$ | $R^{D37}$ | $R^{D224}$ | $L_{C1394}$ | $R^{D143}$ | $R^{D224}$ |
| $L_{C1233}$ | $R^{D10}$ | $R^{D225}$ | $L_{C1287}$ | $R^{D55}$ | $R^{D225}$ | $L_{C1341}$ | $R^{D37}$ | $R^{D225}$ | $L_{C1395}$ | $R^{D143}$ | $R^{D225}$ |
| $L_{C1234}$ | $R^{D10}$ | $R^{D226}$ | $L_{C1288}$ | $R^{D55}$ | $R^{D226}$ | $L_{C1342}$ | $R^{D37}$ | $R^{D226}$ | $L_{C1396}$ | $R^{D143}$ | $R^{D226}$ |
| $L_{C1235}$ | $R^{D10}$ | $R^{D227}$ | $L_{C1289}$ | $R^{D55}$ | $R^{D227}$ | $L_{C1343}$ | $R^{D37}$ | $R^{D227}$ | $L_{C1397}$ | $R^{D143}$ | $R^{D227}$ |
| $L_{C1236}$ | $R^{D10}$ | $R^{D228}$ | $L_{C1290}$ | $R^{D55}$ | $R^{D228}$ | $L_{C1344}$ | $R^{D37}$ | $R^{D228}$ | $L_{C1398}$ | $R^{D143}$ | $R^{D228}$ |
| $L_{C1237}$ | $R^{D10}$ | $R^{D229}$ | $L_{C1291}$ | $R^{D55}$ | $R^{D229}$ | $L_{C1345}$ | $R^{D37}$ | $R^{D229}$ | $L_{C1399}$ | $R^{D143}$ | $R^{D229}$ |
| $L_{C1238}$ | $R^{D10}$ | $R^{D230}$ | $L_{C1292}$ | $R^{D55}$ | $R^{D230}$ | $L_{C1346}$ | $R^{D37}$ | $R^{D230}$ | $L_{C1400}$ | $R^{D143}$ | $R^{D230}$ |
| $L_{C1239}$ | $R^{D10}$ | $R^{D231}$ | $L_{C1293}$ | $R^{D55}$ | $R^{D231}$ | $L_{C1347}$ | $R^{D37}$ | $R^{D231}$ | $L_{C1401}$ | $R^{D143}$ | $R^{D231}$ |
| $L_{C1240}$ | $R^{D10}$ | $R^{D232}$ | $L_{C1294}$ | $R^{D55}$ | $R^{D232}$ | $L_{C1348}$ | $R^{D37}$ | $R^{D232}$ | $L_{C1402}$ | $R^{D143}$ | $R^{D232}$ |
| $L_{C1241}$ | $R^{D10}$ | $R^{D233}$ | $L_{C1295}$ | $R^{D55}$ | $R^{D233}$ | $L_{C1349}$ | $R^{D37}$ | $R^{D233}$ | $L_{C1403}$ | $R^{D143}$ | $R^{D233}$ |

| $L_{Cj}$ | $R^{201}$ | $R^{202}$ | $L_{Cj}$ | $R^{201}$ | $R^{202}$ | $L_{Cj}$ | $R^{201}$ | $R^{202}$ | $L_{Cj}$ | $R^{201}$ | $R^{202}$ |
|---|---|---|---|---|---|---|---|---|---|---|---|
| $L_{C1242}$ | $R^{D10}$ | $R^{D234}$ | $L_{C1296}$ | $R^{D55}$ | $R^{D234}$ | $L_{C1350}$ | $R^{D37}$ | $R^{D234}$ | $L_{C1404}$ | $R^{D143}$ | $R^{D234}$ |
| $L_{C1243}$ | $R^{D10}$ | $R^{D235}$ | $L_{C1297}$ | $R^{D55}$ | $R^{D235}$ | $L_{C1351}$ | $R^{D37}$ | $R^{D235}$ | $L_{C1405}$ | $R^{D143}$ | $R^{D235}$ |
| $L_{C1244}$ | $R^{D10}$ | $R^{D236}$ | $L_{C1298}$ | $R^{D55}$ | $R^{D236}$ | $L_{C1352}$ | $R^{D37}$ | $R^{D236}$ | $L_{C1406}$ | $R^{D143}$ | $R^{D236}$ |
| $L_{C1245}$ | $R^{D10}$ | $R^{D237}$ | $L_{C1299}$ | $R^{D55}$ | $R^{D237}$ | $L_{C1353}$ | $R^{D37}$ | $R^{D237}$ | $L_{C1407}$ | $R^{D143}$ | $R^{D237}$ |
| $L_{C1246}$ | $R^{D10}$ | $R^{D238}$ | $L_{C1300}$ | $R^{D55}$ | $R^{D238}$ | $L_{C1354}$ | $R^{D37}$ | $R^{D238}$ | $L_{C1408}$ | $R^{D143}$ | $R^{D238}$ |
| $L_{C1247}$ | $R^{D10}$ | $R^{D239}$ | $L_{C1301}$ | $R^{D55}$ | $R^{D239}$ | $L_{C1355}$ | $R^{D37}$ | $R^{D239}$ | $L_{C1409}$ | $R^{D143}$ | $R^{D239}$ |
| $L_{C1248}$ | $R^{D10}$ | $R^{D240}$ | $L_{C1302}$ | $R^{D55}$ | $R^{D240}$ | $L_{C1356}$ | $R^{D37}$ | $R^{D240}$ | $L_{C1410}$ | $R^{D143}$ | $R^{D240}$ |
| $L_{C1249}$ | $R^{D10}$ | $R^{D241}$ | $L_{C1303}$ | $R^{D55}$ | $R^{D241}$ | $L_{C1357}$ | $R^{D37}$ | $R^{D241}$ | $L_{C1411}$ | $R^{D143}$ | $R^{D241}$ |
| $L_{C1250}$ | $R^{D10}$ | $R^{D242}$ | $L_{C1304}$ | $R^{D55}$ | $R^{D242}$ | $L_{C1358}$ | $R^{D37}$ | $R^{D242}$ | $L_{C1412}$ | $R^{D143}$ | $R^{D242}$ |
| $L_{C1251}$ | $R^{D10}$ | $R^{D243}$ | $L_{C1305}$ | $R^{D55}$ | $R^{D243}$ | $L_{C1359}$ | $R^{D37}$ | $R^{D243}$ | $L_{C1413}$ | $R^{D143}$ | $R^{D243}$ |
| $L_{C1252}$ | $R^{D10}$ | $R^{D244}$ | $L_{C1306}$ | $R^{D55}$ | $R^{D244}$ | $L_{C1360}$ | $R^{D37}$ | $R^{D244}$ | $L_{C1414}$ | $R^{D143}$ | $R^{D244}$ |
| $L_{C1253}$ | $R^{D10}$ | $R^{D245}$ | $L_{C1307}$ | $R^{D55}$ | $R^{D245}$ | $L_{C1361}$ | $R^{D37}$ | $R^{D245}$ | $L_{C1415}$ | $R^{D143}$ | $R^{D245}$ |
| $L_{C1254}$ | $R^{D10}$ | $R^{D246}$ | $L_{C1308}$ | $R^{D55}$ | $R^{D246}$ | $L_{C1362}$ | $R^{D37}$ | $R^{D246}$ | $L_{C1416}$ | $R^{D143}$ | $R^{D246}$ |

wherein $R^{D1}$ to $R^{D246}$ have the structures defined in the following LIST 9:

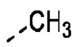 $R^{D1}$, 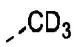 $R^{D2}$, 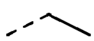 $R^{D3}$,

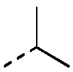 $R^{D4}$, 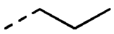 $R^{D5}$, 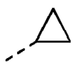 $R^{D6}$, 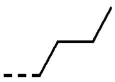 $R^{D7}$, 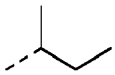 $R^{D8}$, 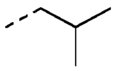 $R^{D9}$, 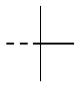 $R^{D10}$, 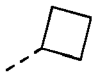 $R^{D11}$, 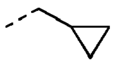 $R^{D12}$, 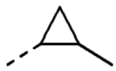 $R^{D13}$,

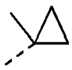 $R^{D14}$, 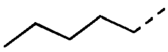 $R^{D15}$, 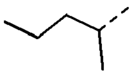 $R^{D16}$, 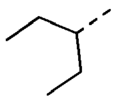 $R^{D17}$, 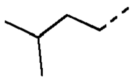 $R^{D18}$, 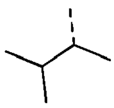 $R^{D19}$, 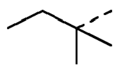 $R^{D20}$, 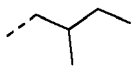 $R^{D21}$,

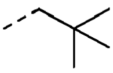 $R^{D22}$, 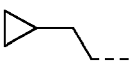 $R^{D23}$, 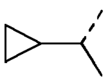 $R^{D24}$, 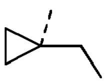 $R^{D25}$, 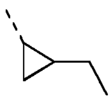 $R^{D26}$, 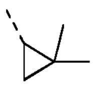 $R^{D27}$, 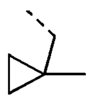 $R^{D28}$, 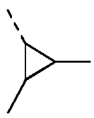 $R^{D29}$, 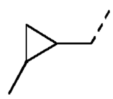 $R^{D30}$,

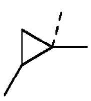 $R^{D31}$, 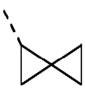 $R^{D32}$, 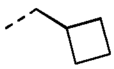 $R^{D33}$, 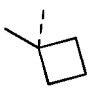 $R^{D34}$, 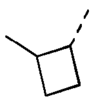 $R^{D35}$, 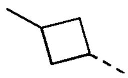 $R^{D36}$, 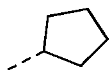 $R^{D37}$, 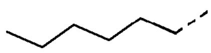 $R^{D38}$,

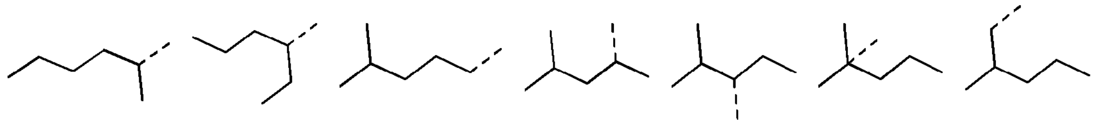

$R^{D39}$, $R^{D40}$, $R^{D41}$, $R^{D42}$, $R^{D43}$, $R^{D44}$, $R^{D45}$,

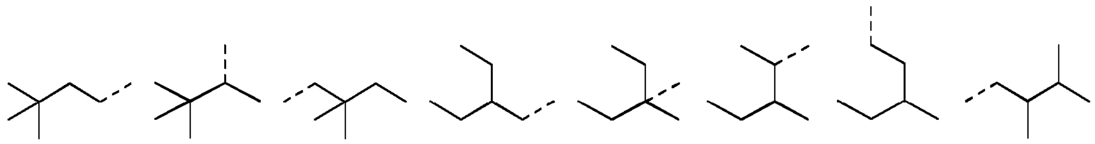

$R^{D46}$, $R^{D47}$, $R^{D48}$, $R^{D49}$, $R^{D50}$, $R^{D51}$, $R^{D52}$, $R^{D53}$,

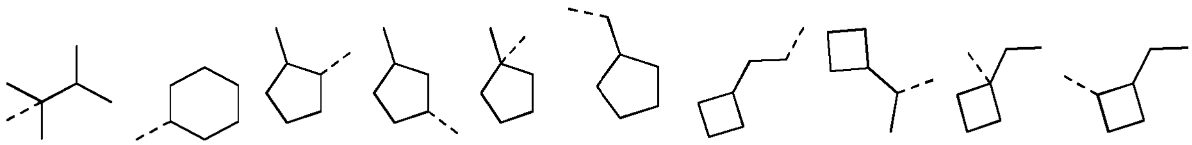

$R^{D54}$, $R^{D55}$, $R^{D56}$, $R^{D57}$, $R^{D58}$, $R^{D59}$, $R^{D60}$, $R^{D61}$, $R^{D62}$, $R^{D63}$,

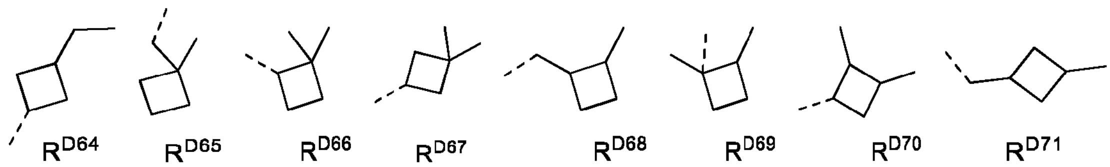

$R^{D64}$, $R^{D65}$, $R^{D66}$, $R^{D67}$, $R^{D68}$, $R^{D69}$, $R^{D70}$, $R^{D71}$,

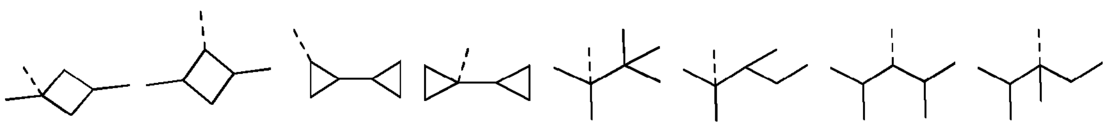

$R^{D72}$, $R^{D73}$, $R^{D74}$, $R^{D75}$, $R^{D76}$, $R^{D77}$, $R^{D78}$, $R^{D79}$,

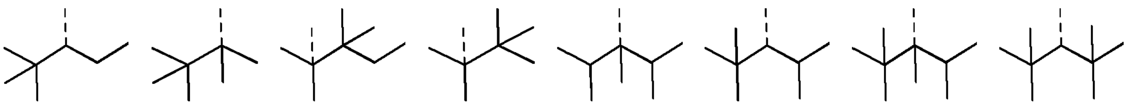

$R^{D80}$, $R^{D81}$, $R^{D82}$, $R^{D83}$, $R^{D84}$, $R^{D85}$, $R^{D86}$, $R^{D87}$,

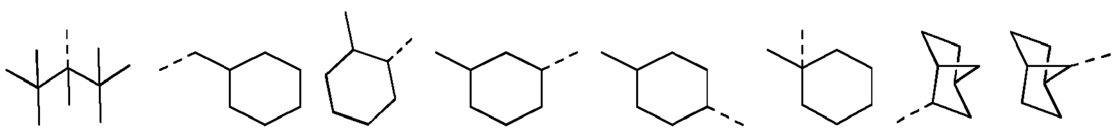

$R^{D88}$, $R^{D89}$, $R^{D90}$, $R^{D91}$, $R^{D92}$, $R^{D93}$, $R^{D94}$, $R^{D95}$,

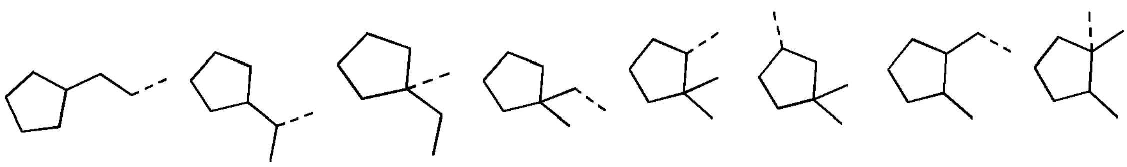

$R^{D96}$, $R^{D97}$, $R^{D98}$, $R^{D99}$, $R^{D100}$, $R^{D101}$, $R^{D102}$, $R^{D103}$,

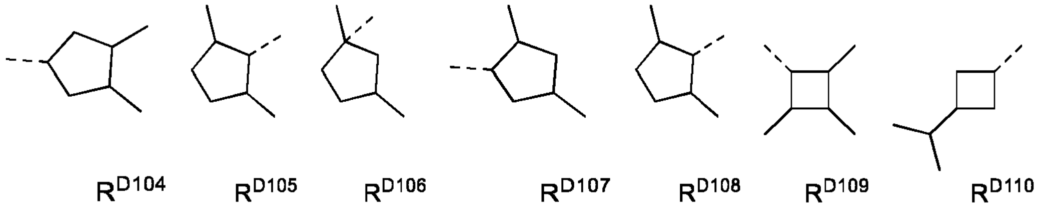

$R^{D104}$, $R^{D105}$, $R^{D106}$, $R^{D107}$, $R^{D108}$, $R^{D109}$, $R^{D110}$,

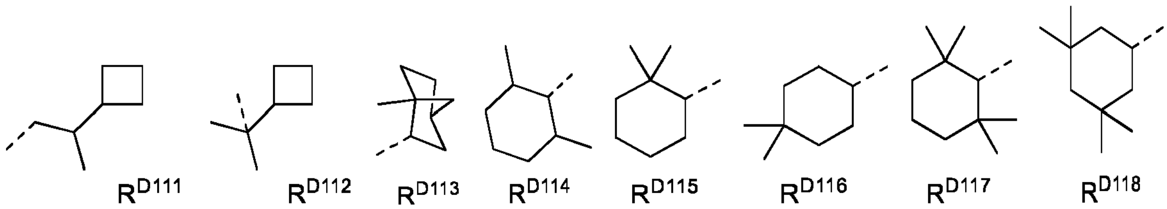

$R^{D111}$, $R^{D112}$, $R^{D113}$, $R^{D114}$, $R^{D115}$, $R^{D116}$, $R^{D117}$, $R^{D118}$,

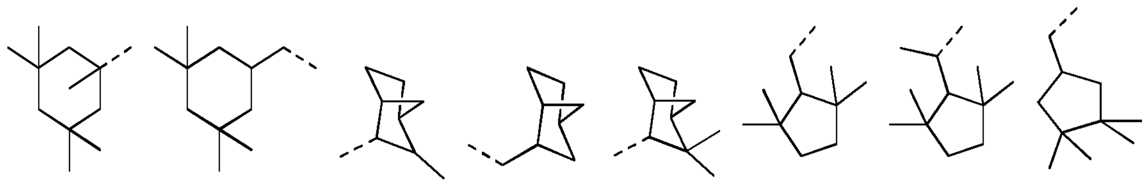

$R^{D119}$, $R^{D120}$, $R^{D121}$, $R^{D122}$, $R^{D123}$, $R^{D124}$, $R^{D125}$, $R^{D126}$,

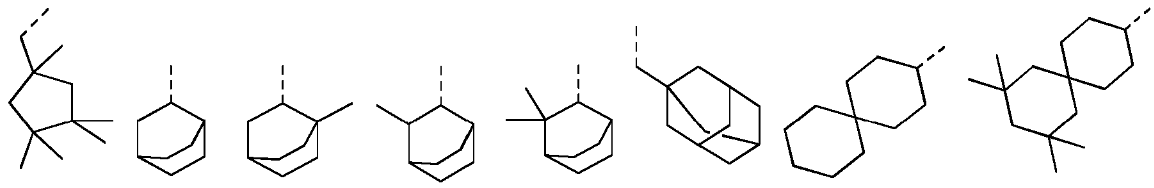

$R^{D127}$, $R^{D128}$, $R^{D129}$, $R^{D130}$, $R^{D131}$, $R^{D132}$, $R^{D133}$, $R^{D134}$,

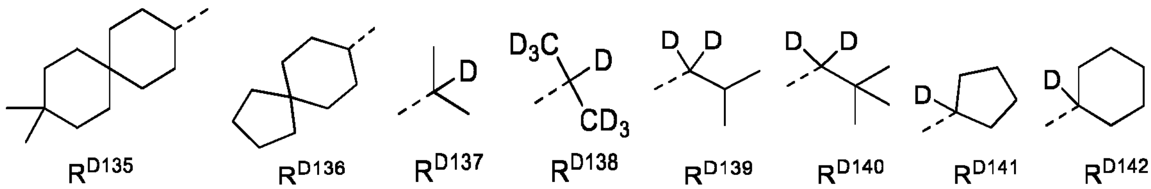

$R^{D135}$, $R^{D136}$, $R^{D137}$, $R^{D138}$, $R^{D139}$, $R^{D140}$, $R^{D141}$, $R^{D142}$,

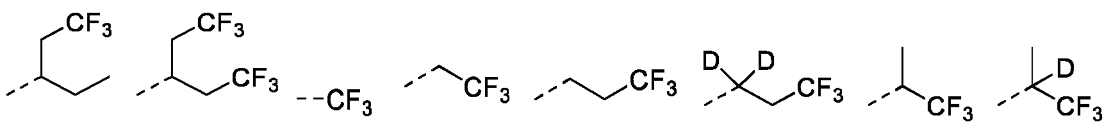

$R^{D143}$, $R^{D144}$, $R^{D145}$, $R^{D146}$, $R^{D147}$, $R^{D148}$, $R^{D149}$, $R^{D150}$,

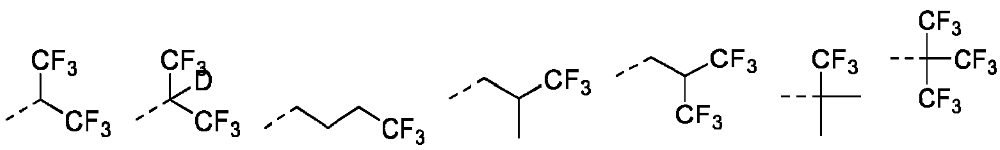

$R^{D151}$, $R^{D152}$, $R^{D153}$, $R^{D154}$, $R^{D155}$, $R^{D156}$, $R^{D157}$,

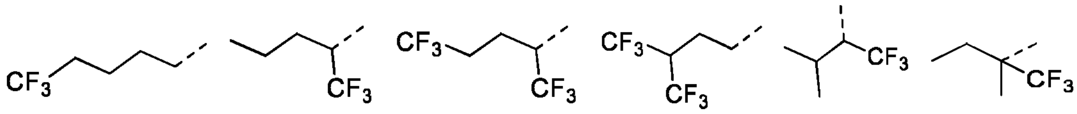

$R^{D158}$, $R^{D159}$, $R^{D160}$, $R^{D161}$, $R^{D162}$, $R^{D163}$,

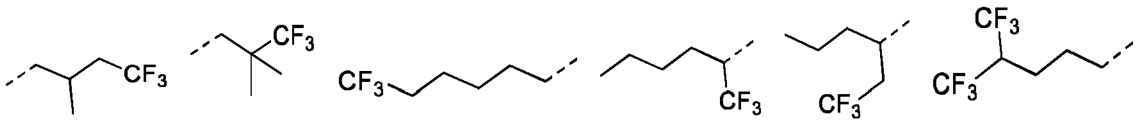

$R^{D164}$, $R^{D165}$, $R^{D166}$, $R^{D167}$, $R^{D168}$, $R^{D169}$,

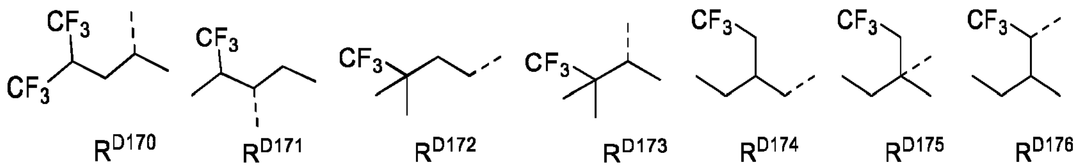

$R^{D170}$, $R^{D171}$, $R^{D172}$, $R^{D173}$, $R^{D174}$, $R^{D175}$, $R^{D176}$,

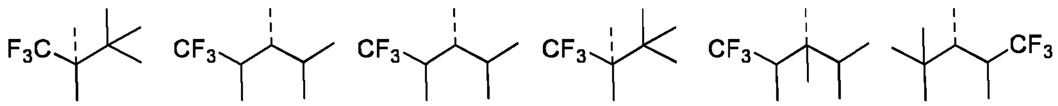

$R^{D177}$, $R^{D178}$, $R^{D179}$, $R^{D180}$, $R^{D181}$, $R^{D182}$,

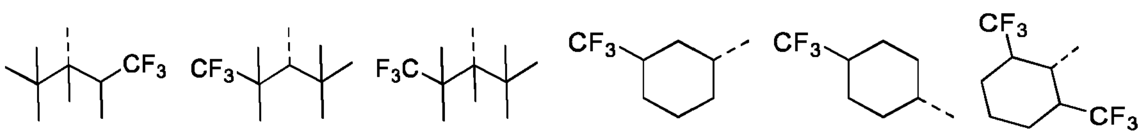

$R^{D183}$, $R^{D184}$, $R^{D185}$, $R^{D186}$, $R^{D187}$, $R^{D188}$,

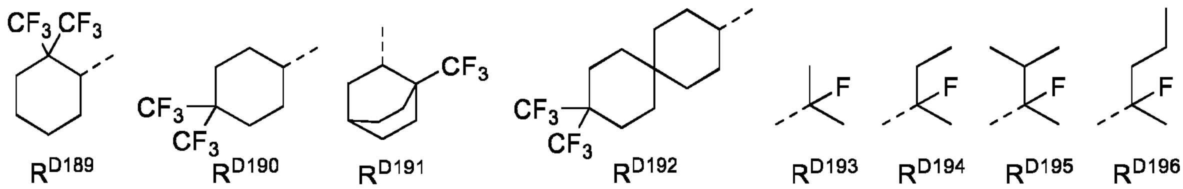

$R^{D189}$, $R^{D190}$, $R^{D191}$, $R^{D192}$, $R^{D193}$, $R^{D194}$, $R^{D195}$, $R^{D196}$,

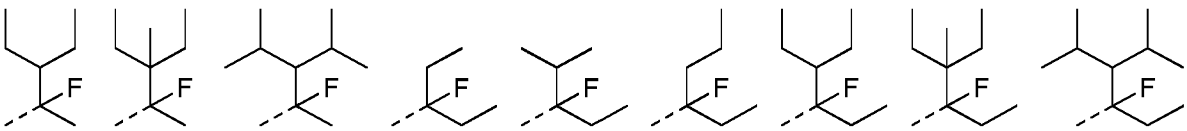

$R^{D197}$, $R^{D198}$, $R^{D199}$, $R^{D200}$, $R^{D201}$, $R^{D202}$, $R^{D203}$, $R^{D204}$, $R^{D205}$,

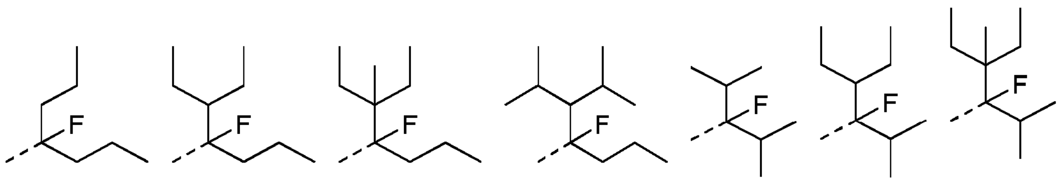

$R^{D206}$, $R^{D207}$, $R^{D208}$, $R^{D209}$, $R^{D210}$, $R^{D211}$, $R^{D212}$,

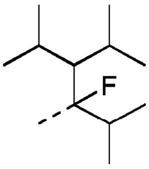
$R^{D213}$,
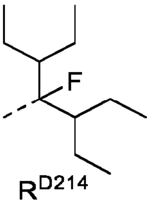
$R^{D214}$,
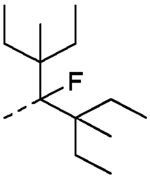
$R^{D215}$,
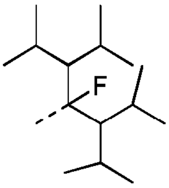
$R^{D216}$,
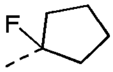
$R^{D217}$,
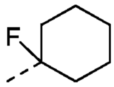
$R^{D218}$,
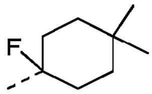
$R^{D219}$,

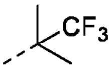
$R^{D220}$,
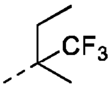
$R^{D221}$,
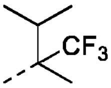
$R^{D222}$,
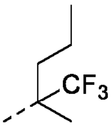
$R^{D223}$,
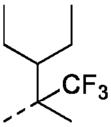
$R^{D224}$,
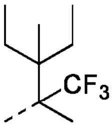
$R^{D225}$,
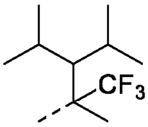
$R^{D226}$,
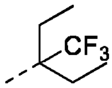
$R^{D227}$,
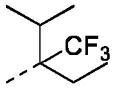
$R^{D228}$,

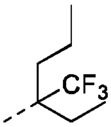
$R^{D229}$,
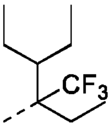
$R^{D230}$,
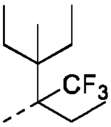
$R^{D231}$,
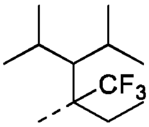
$R^{D232}$,
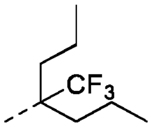
$R^{D233}$,
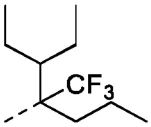
$R^{D234}$,
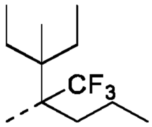
$R^{D235}$,

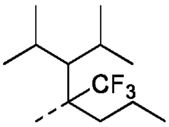
$R^{D236}$,
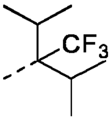
$R^{D237}$,
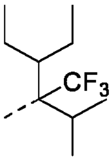
$R^{D238}$,
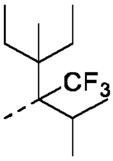
$R^{D239}$,
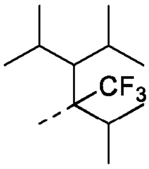
$R^{D240}$,
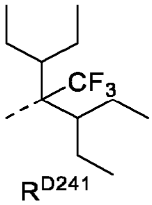
$R^{D241}$,
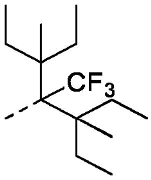
$R^{D242}$,

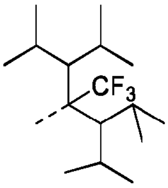
$R^{D243}$,
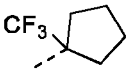
$R^{D244}$,
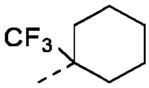
$R^{D245}$, and
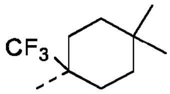
$R^{D246}$.

The compound of the present disclosure can be selected from the group consisting of: wherein the compound is selected from the group consisting of:

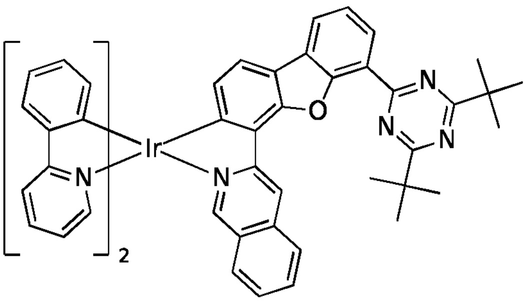

,

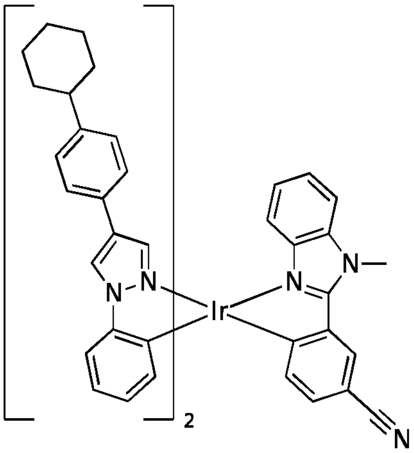

,

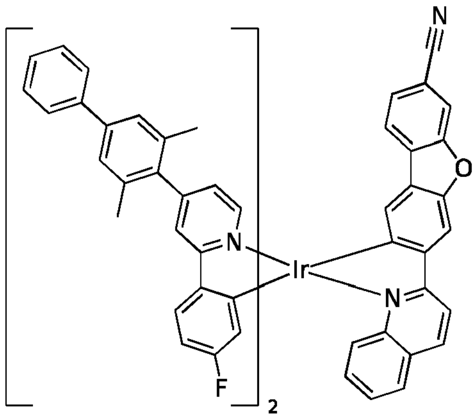

,

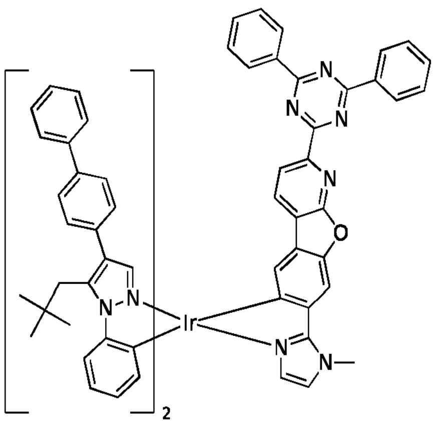

,

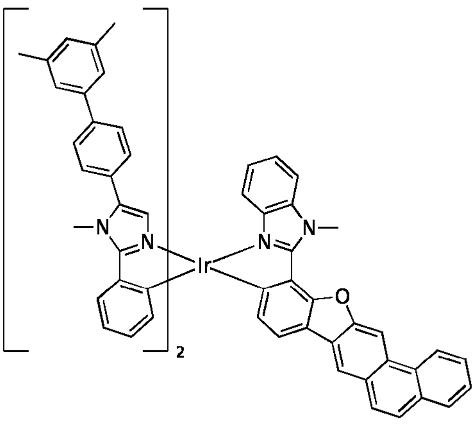

,

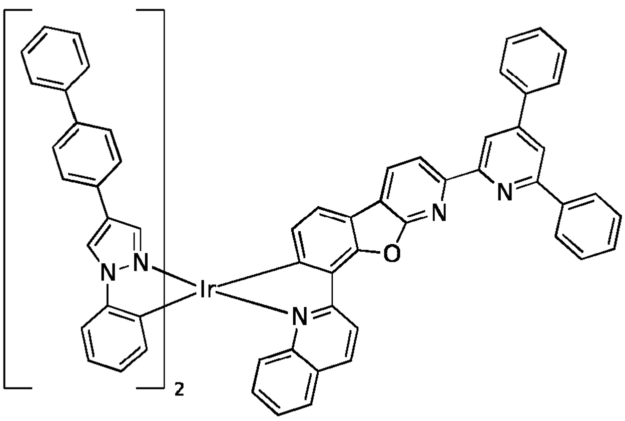

,

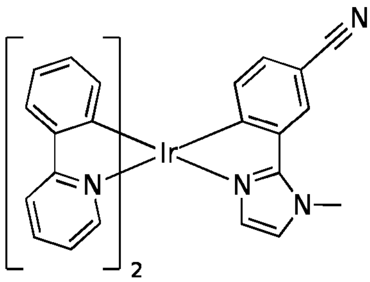,

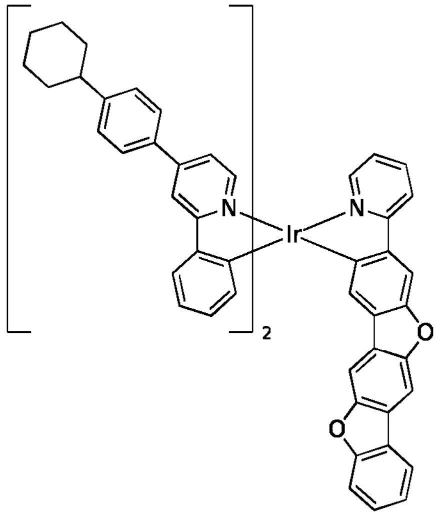,

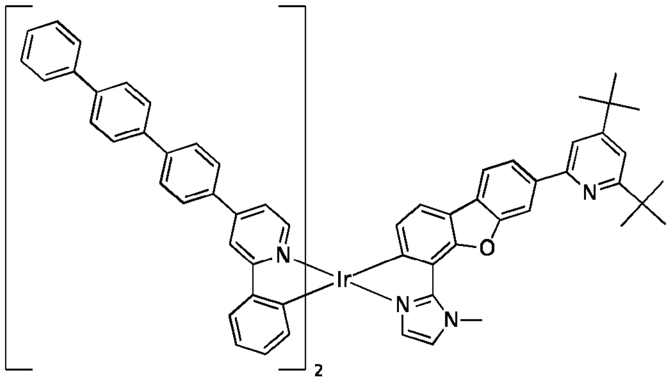,

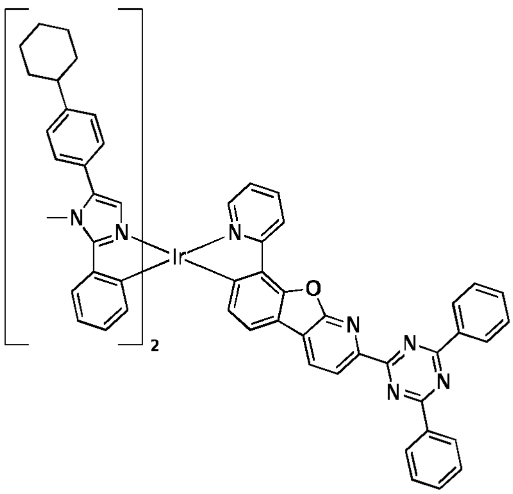,

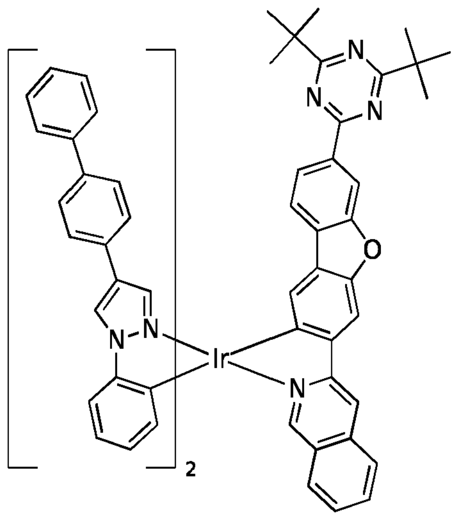,

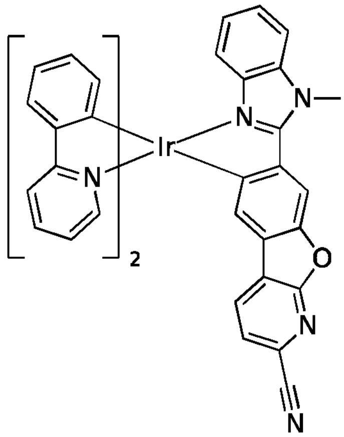
,
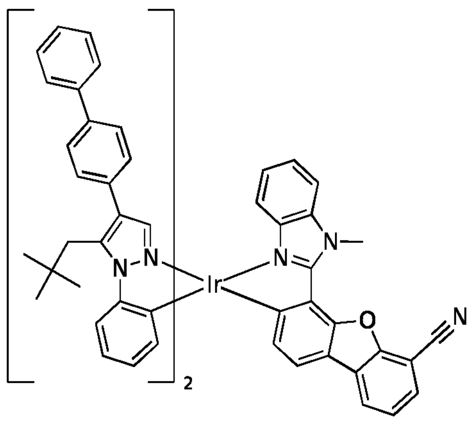
,
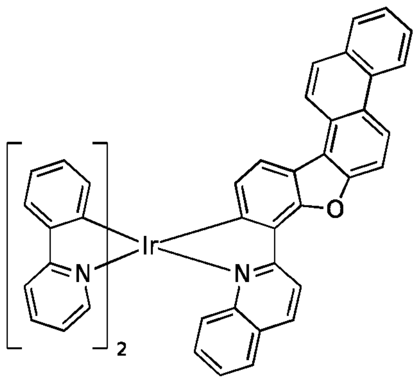
,
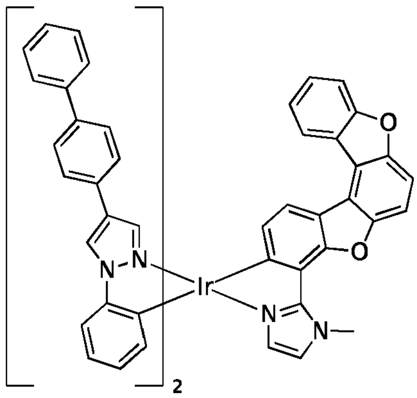
,
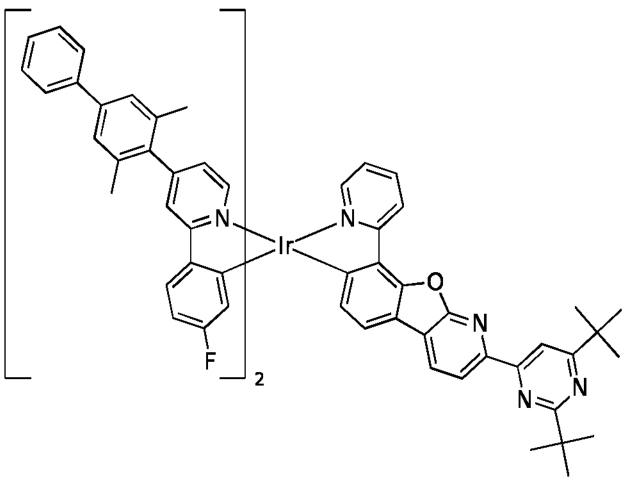
,
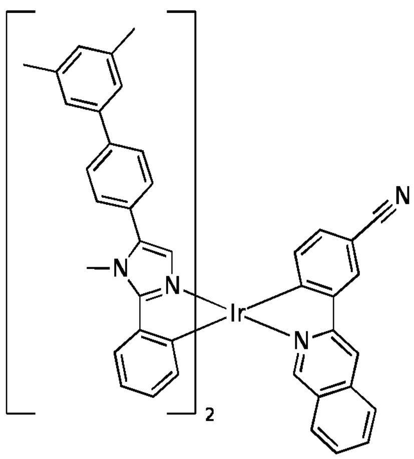
,

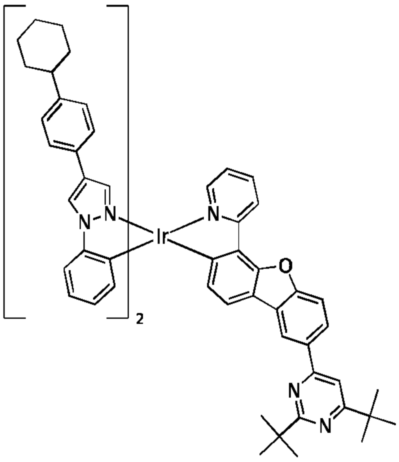

,

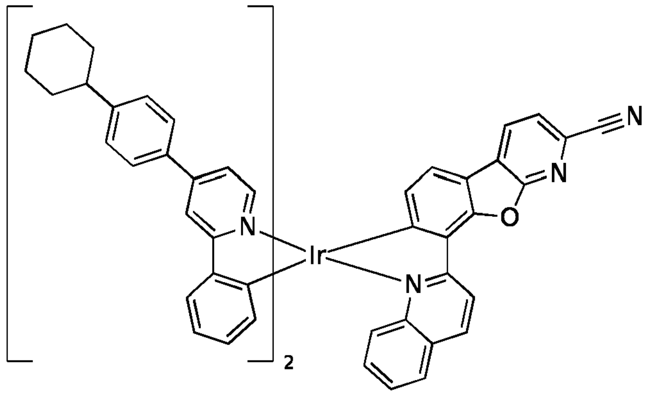

,

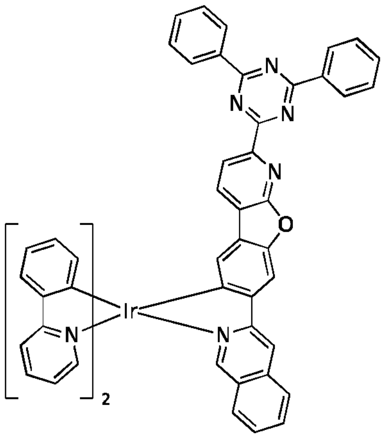

,

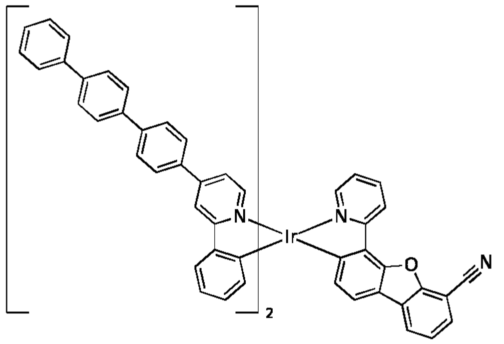

,

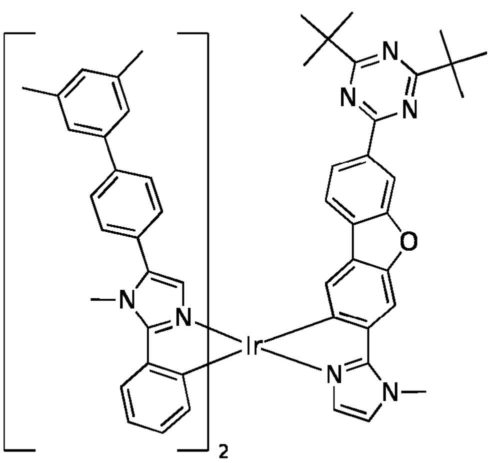

,

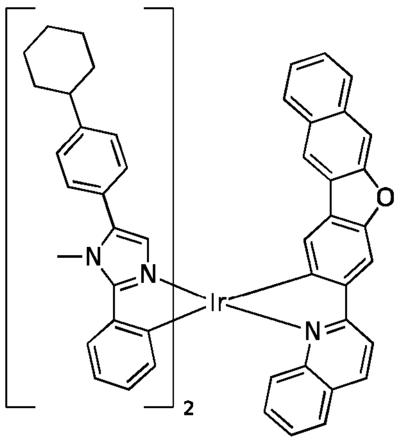

,

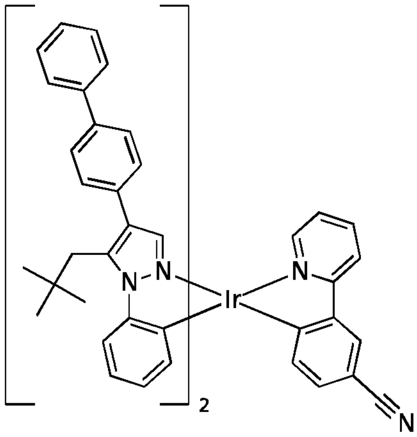,

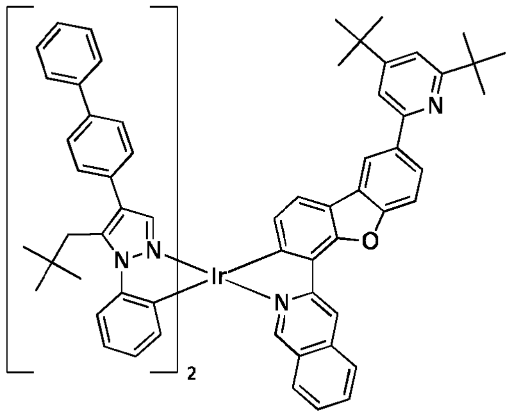,

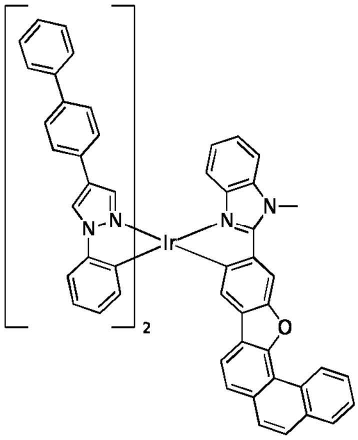,

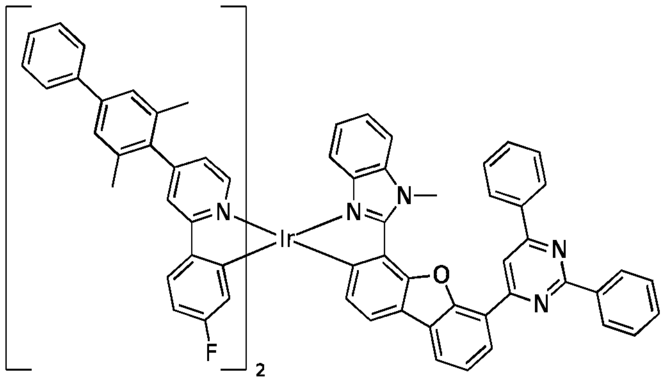,

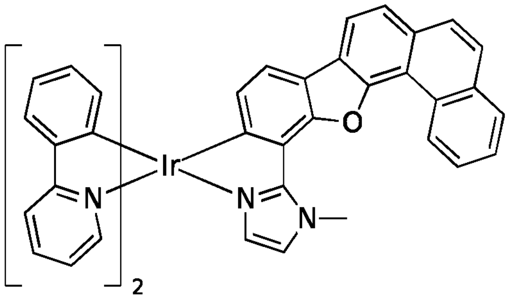

,

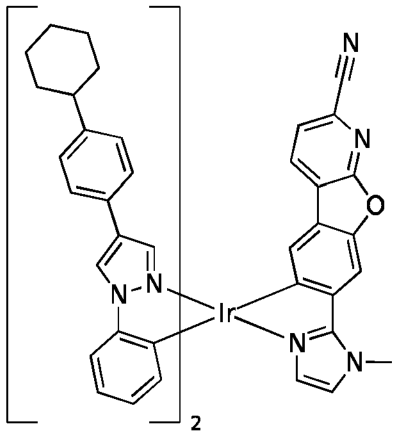

,

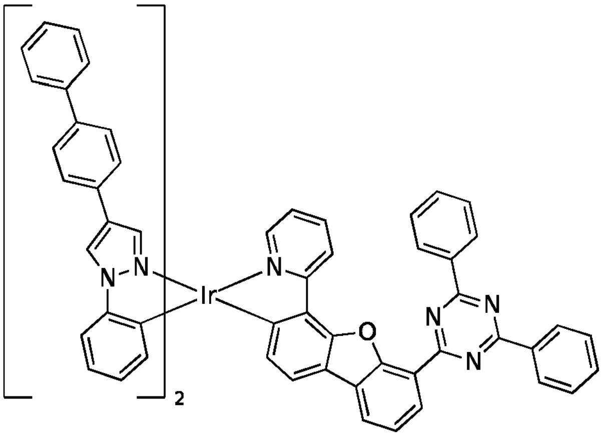

,

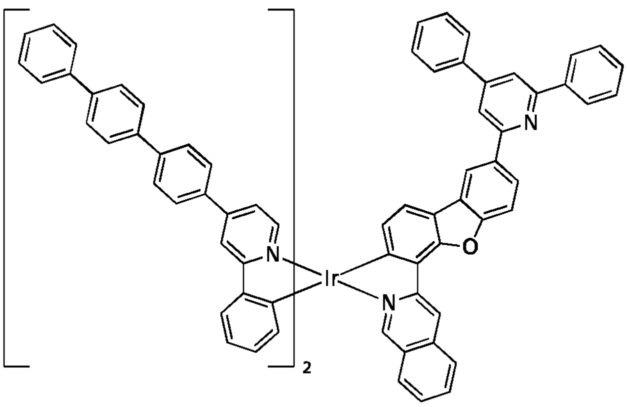

,

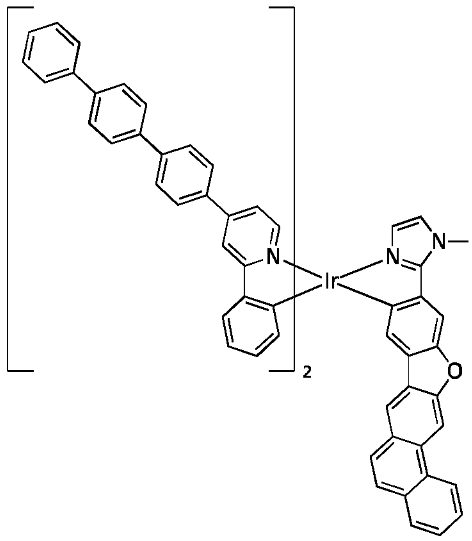

,

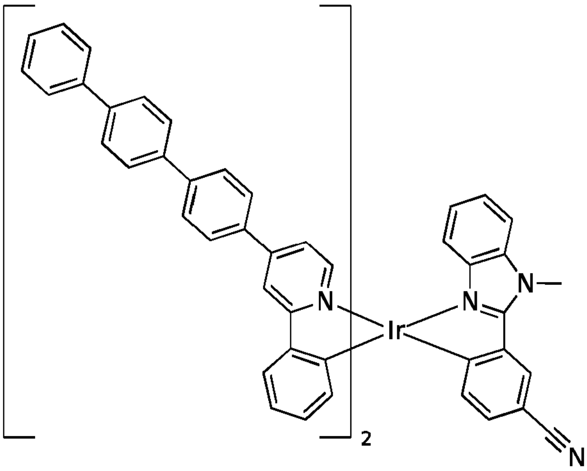,

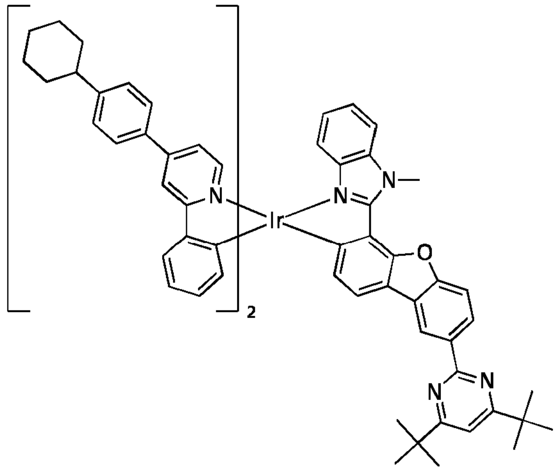,

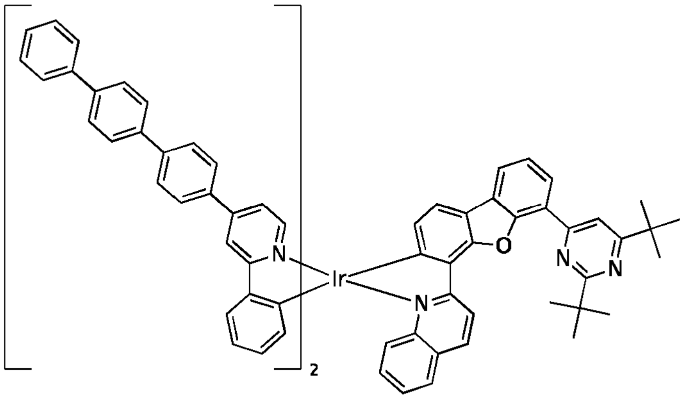,

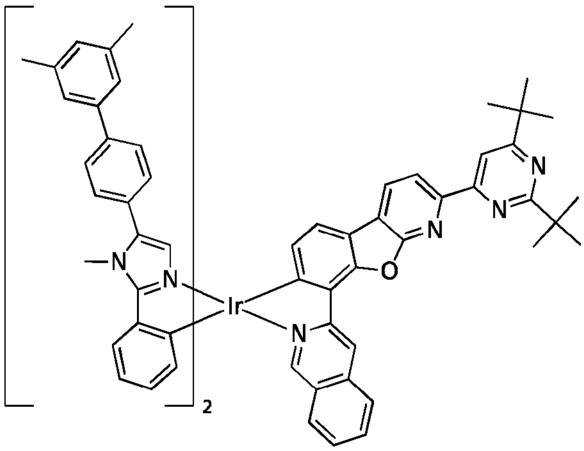,

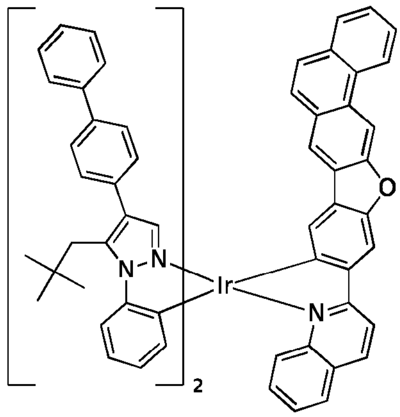,

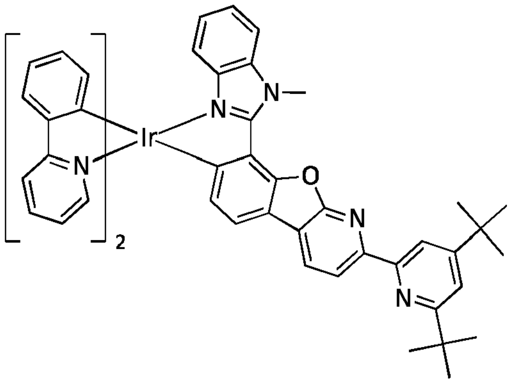

,

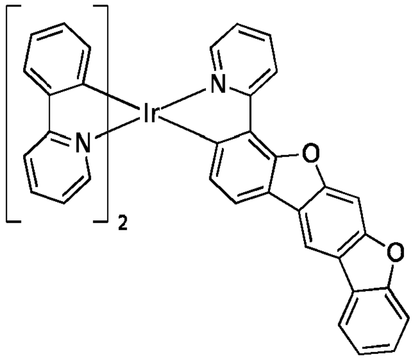

,

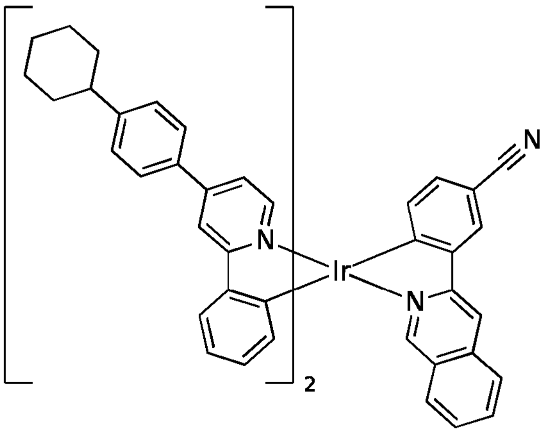

,

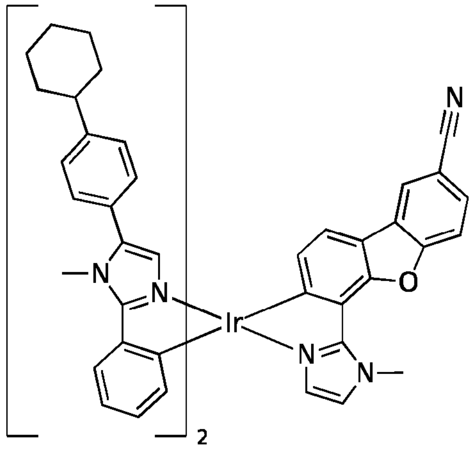

,

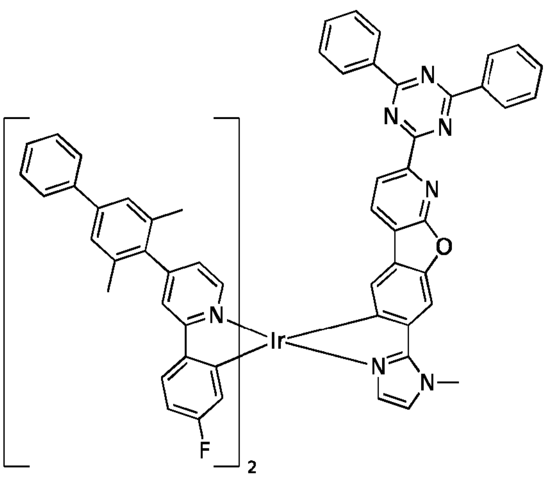

,

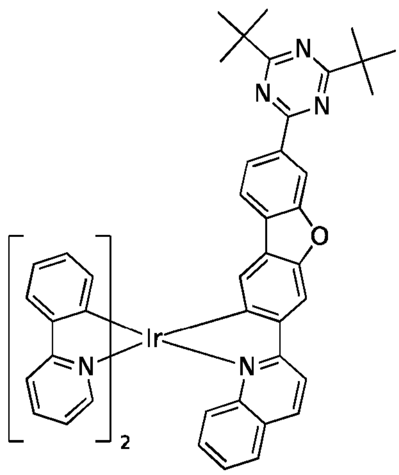

,

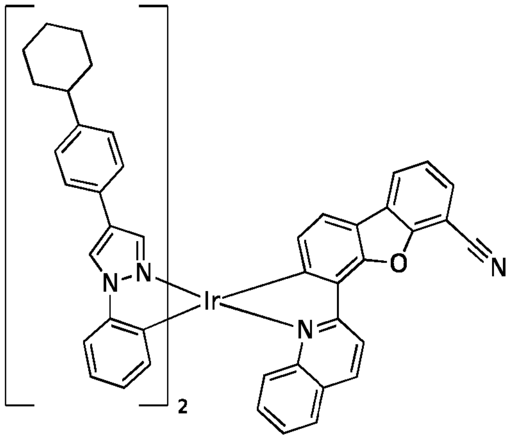
,
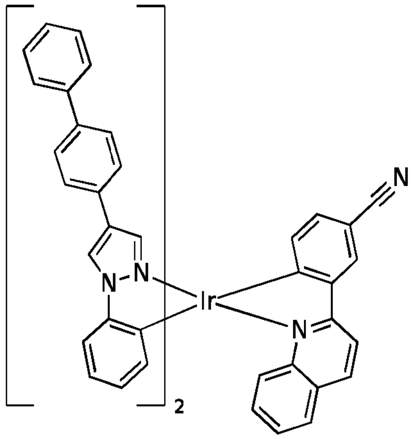
,
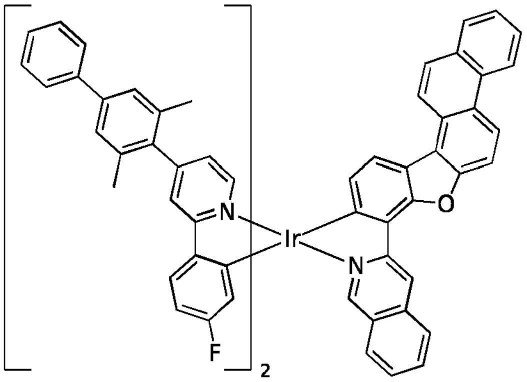
,
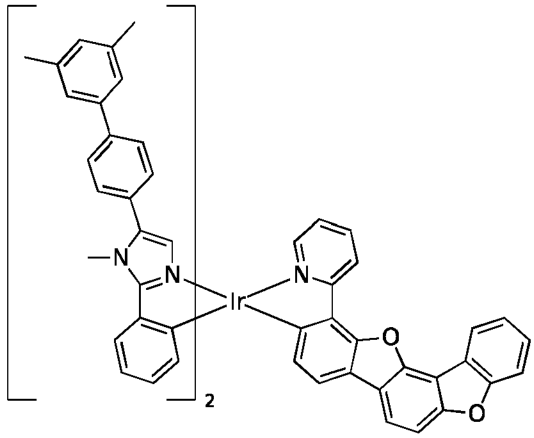
,
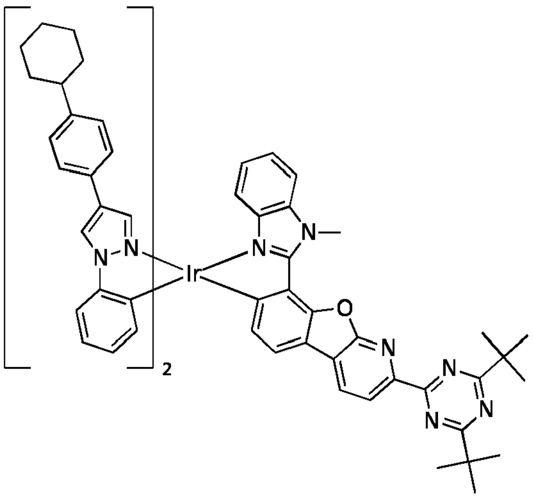
,
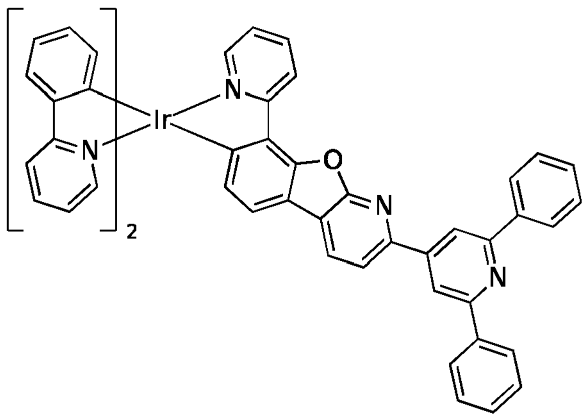
,

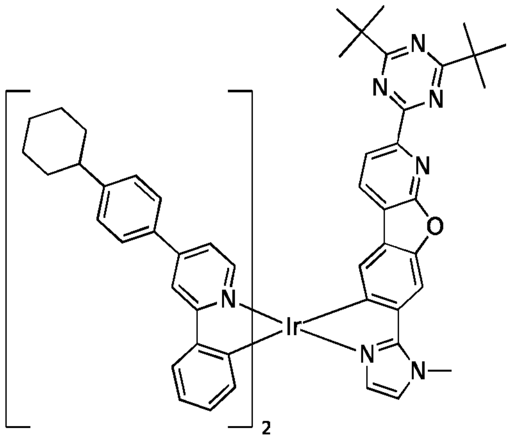

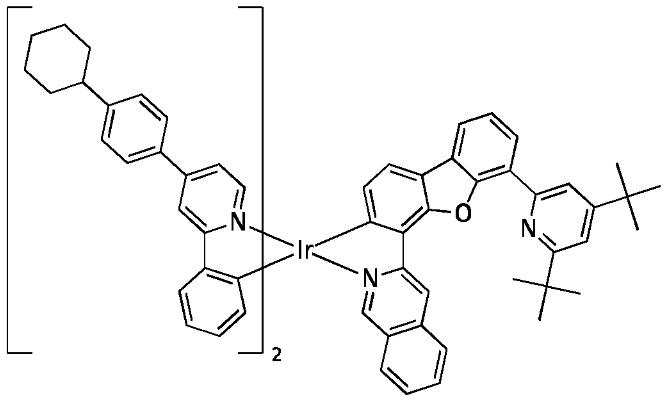

,

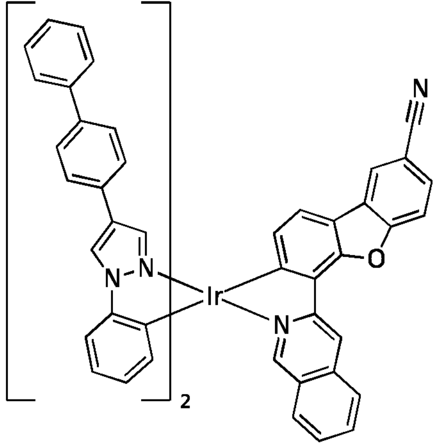

,

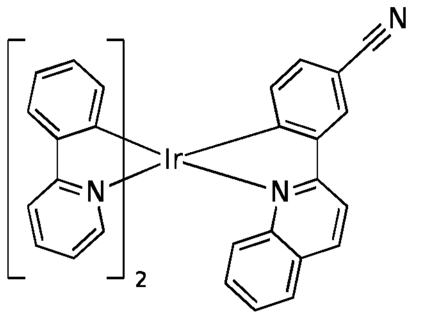

,

,

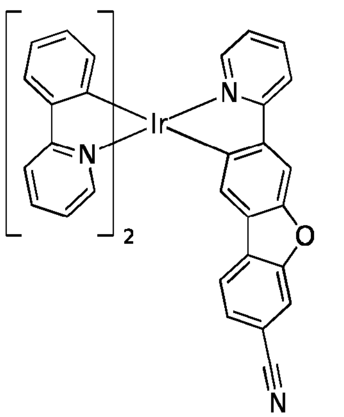

,

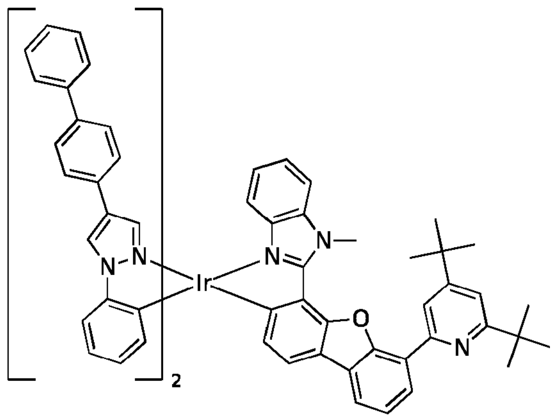

,

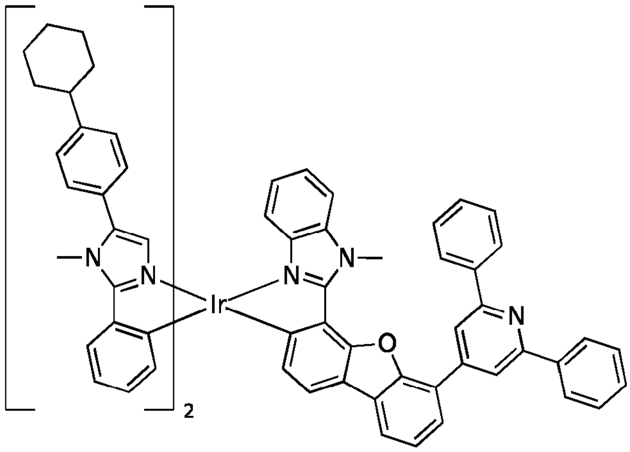

,

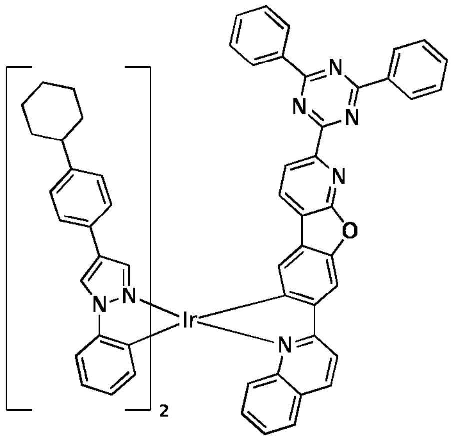

,

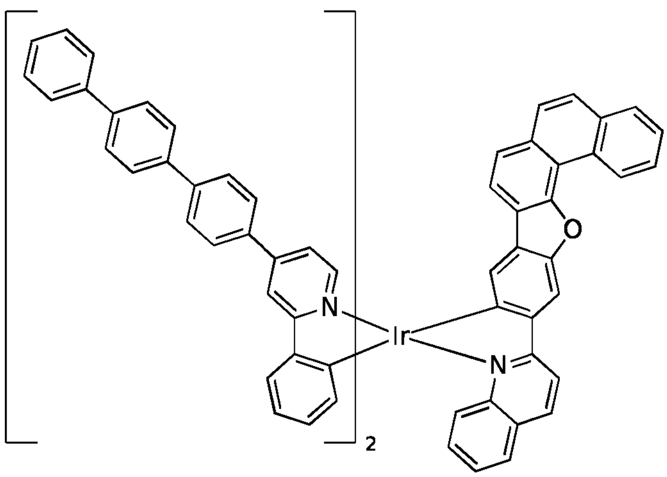

,

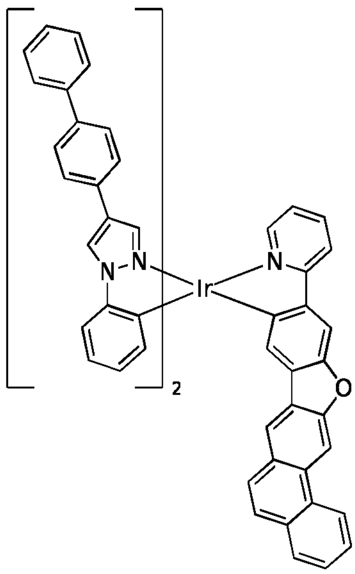

,

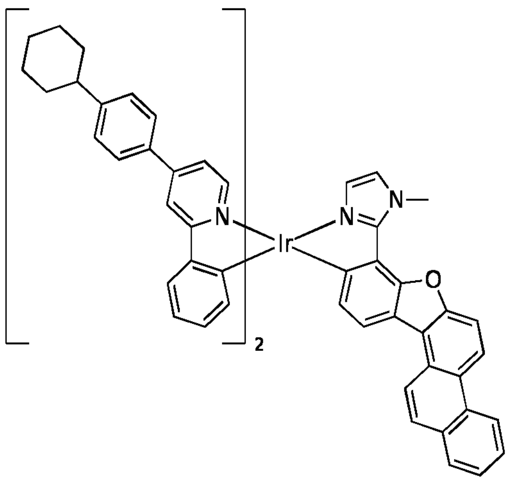

,

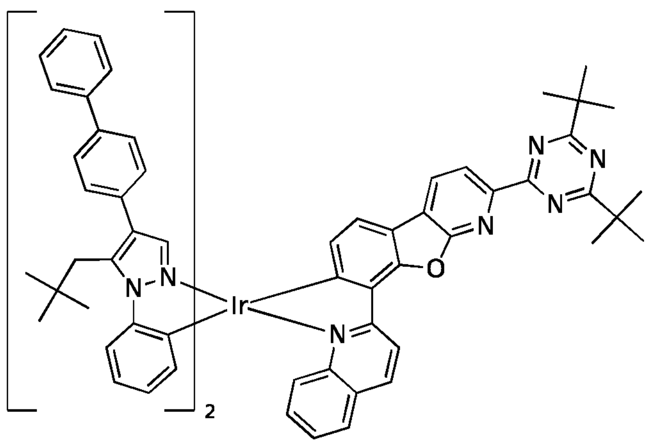

,

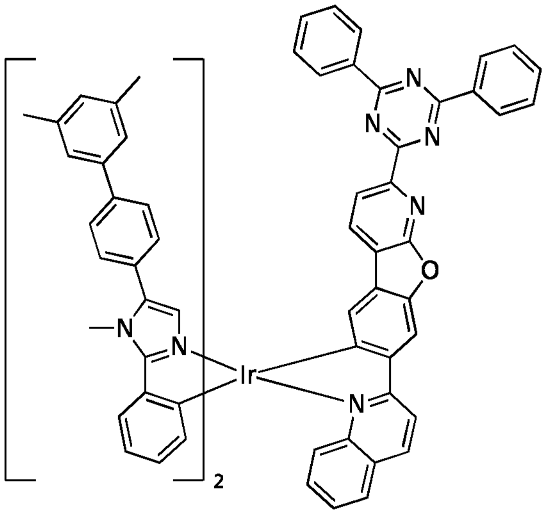
,
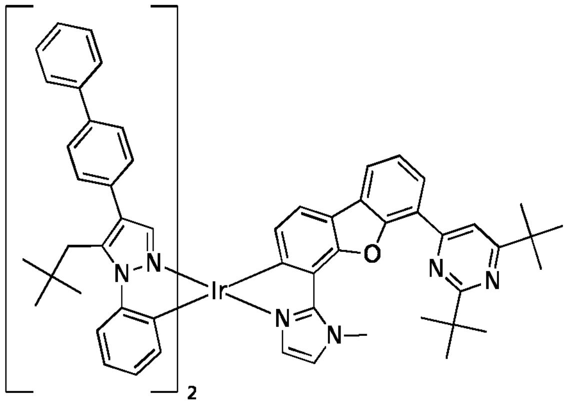
,
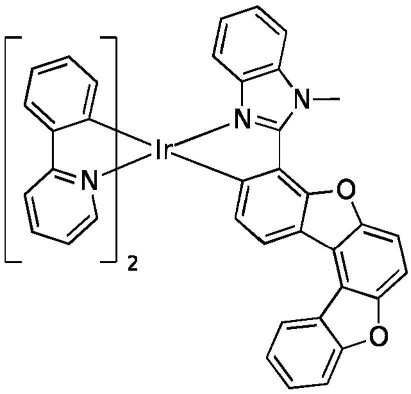
,
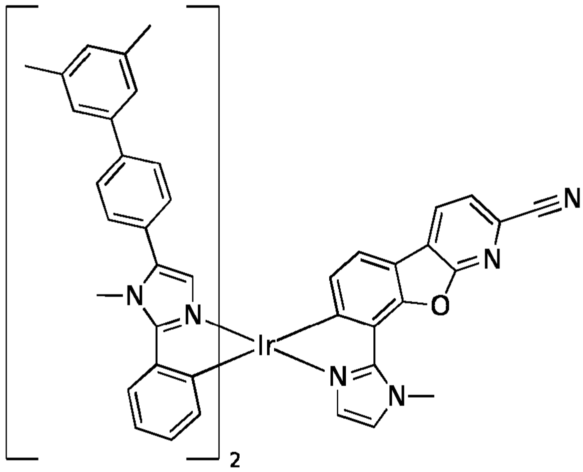
,
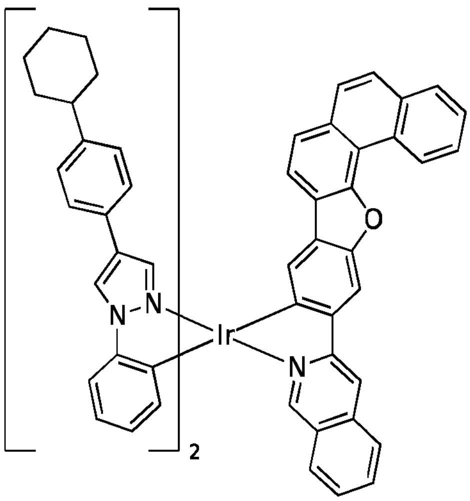
,
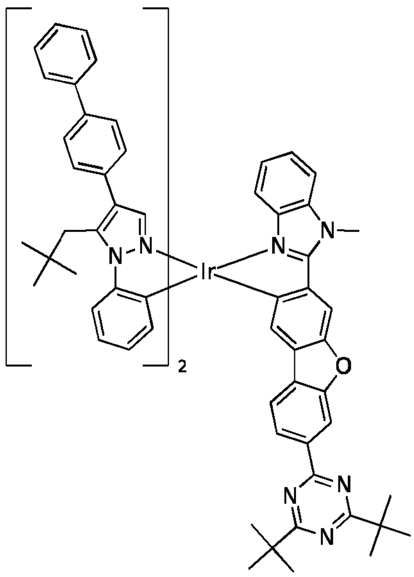
,

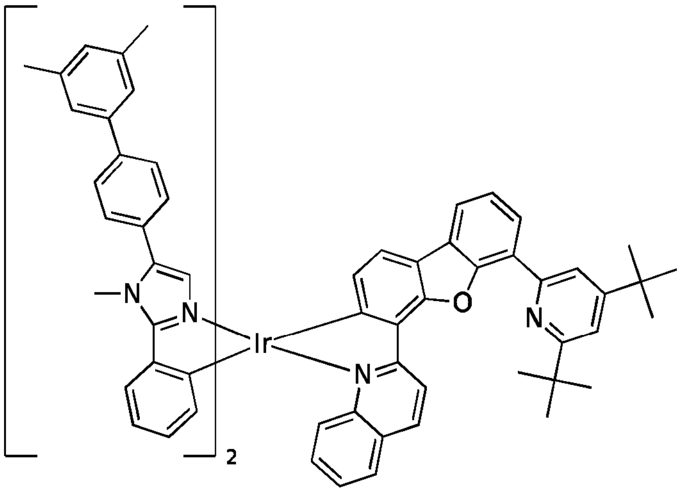

,

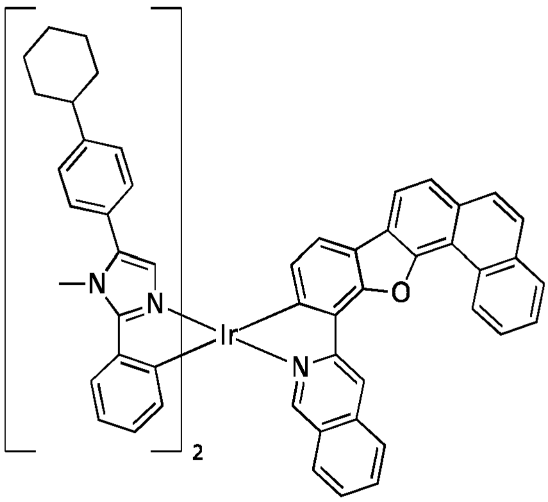

,

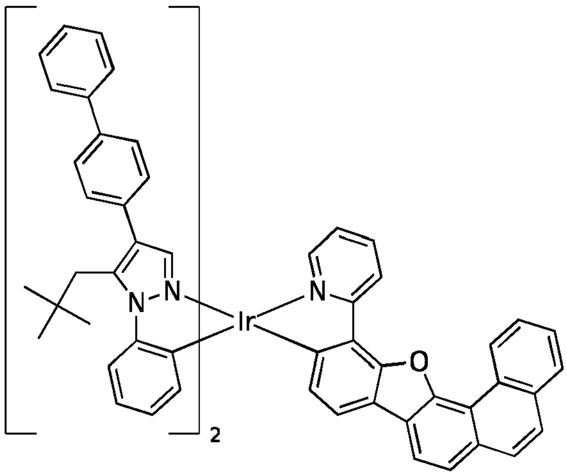

,

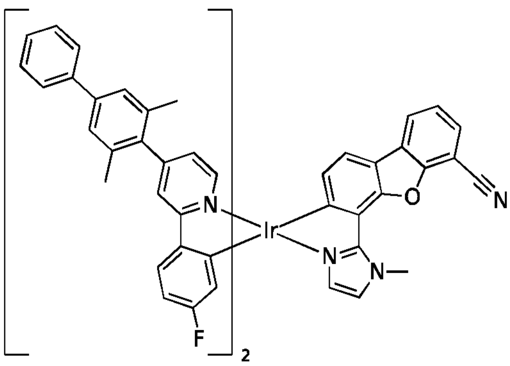

,

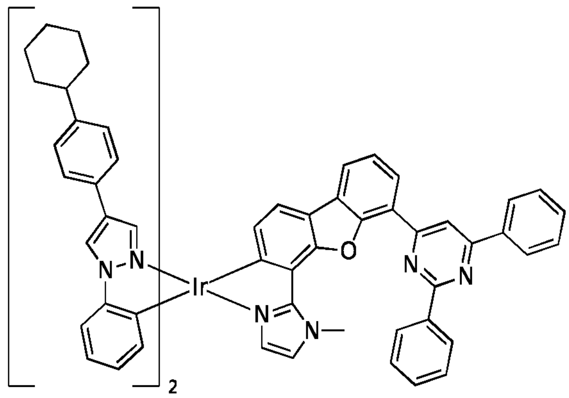

,

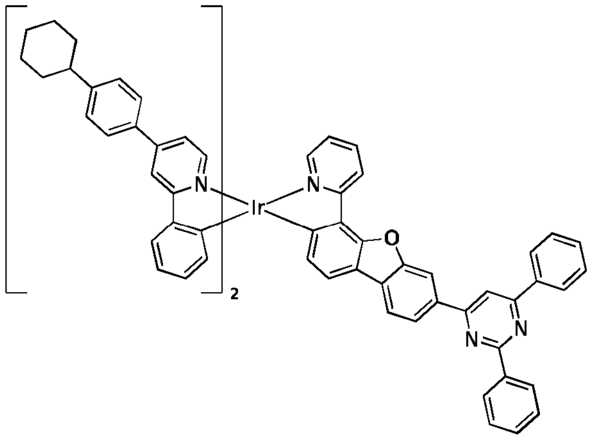

,

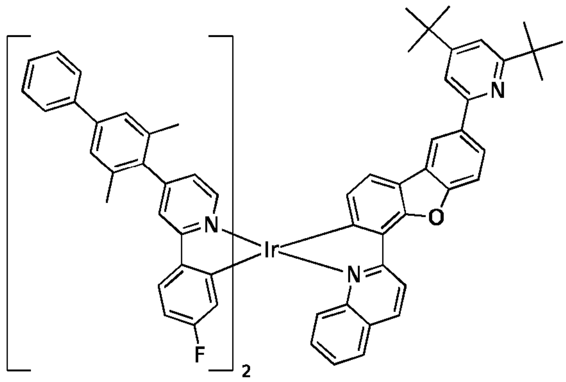

,

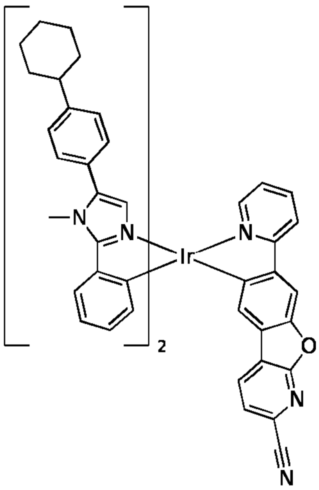

,

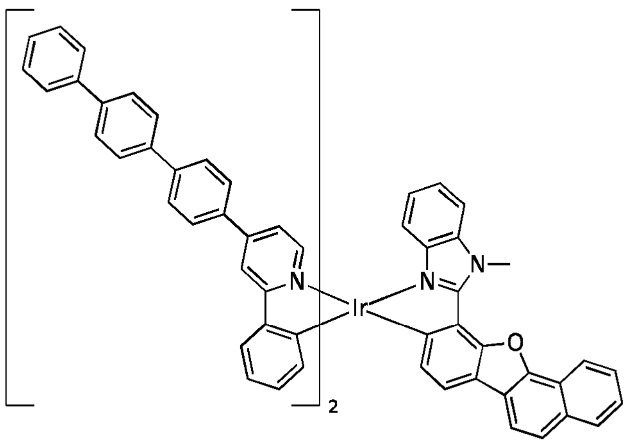

,

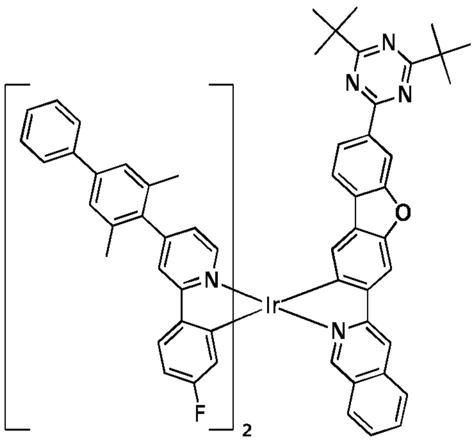

,

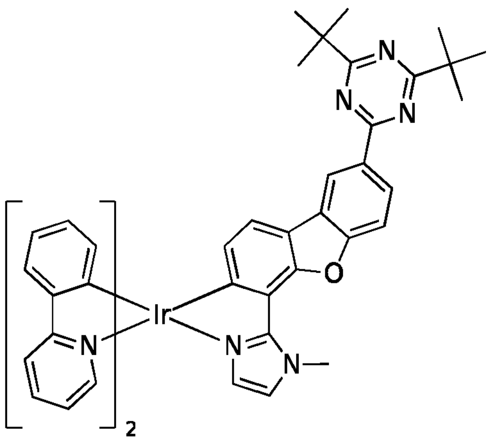

,

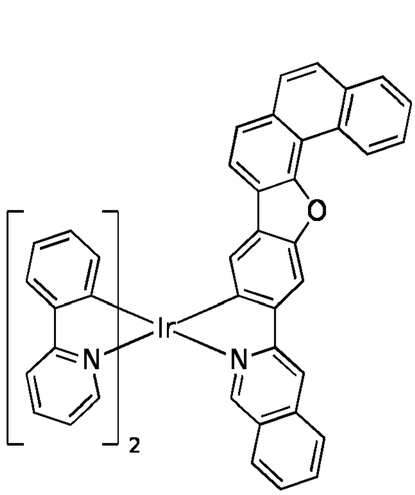

,

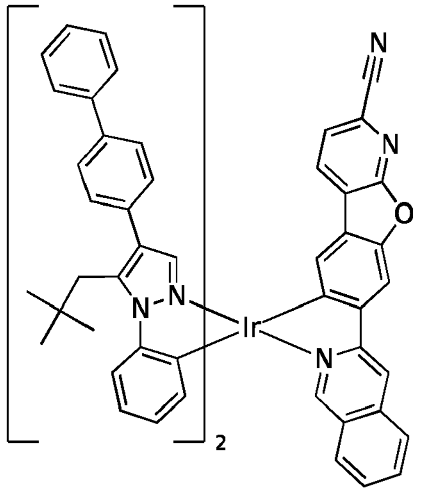

,

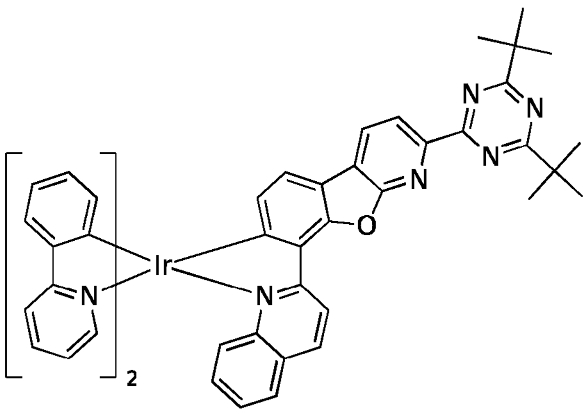

,

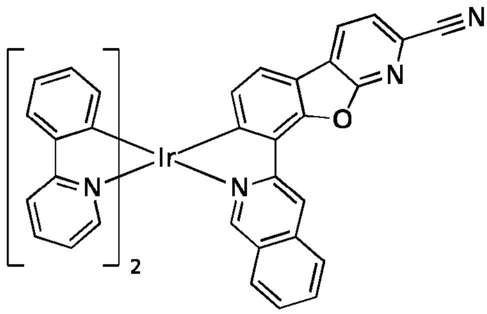

,

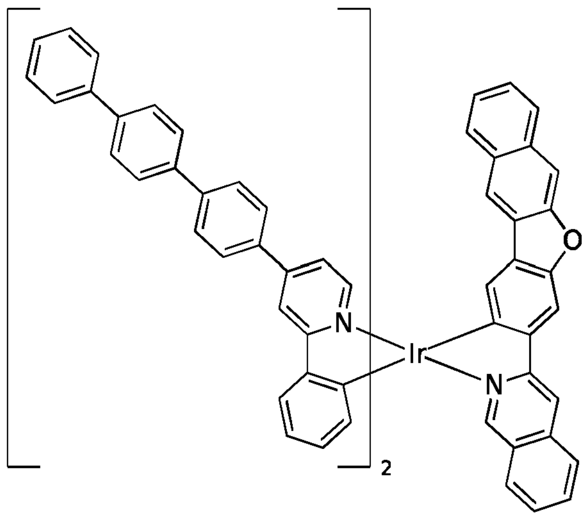

,

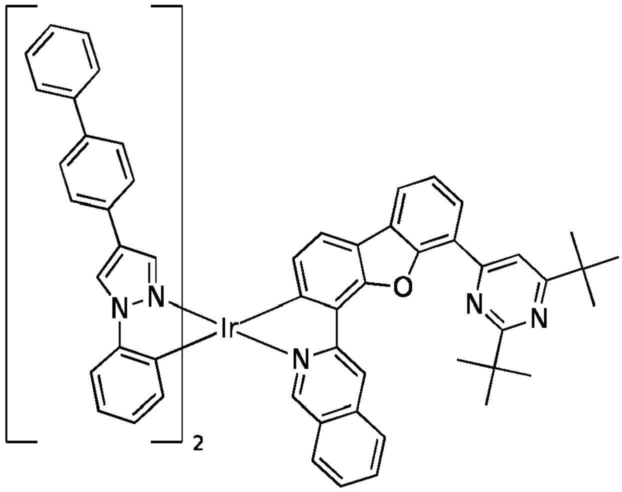

,

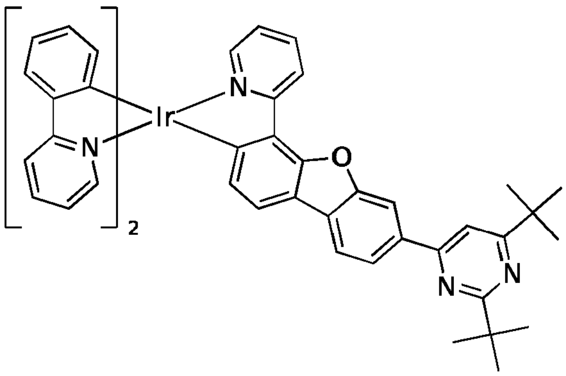

,

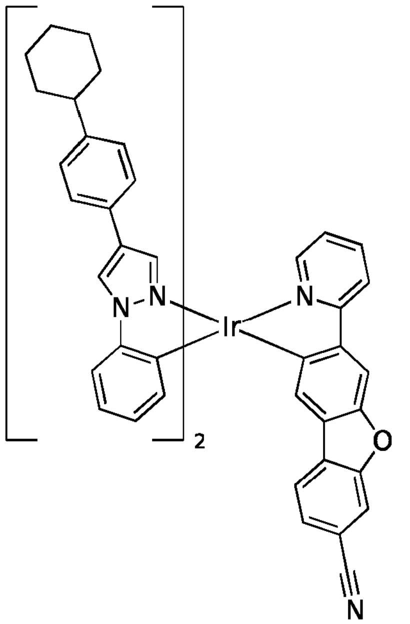

,

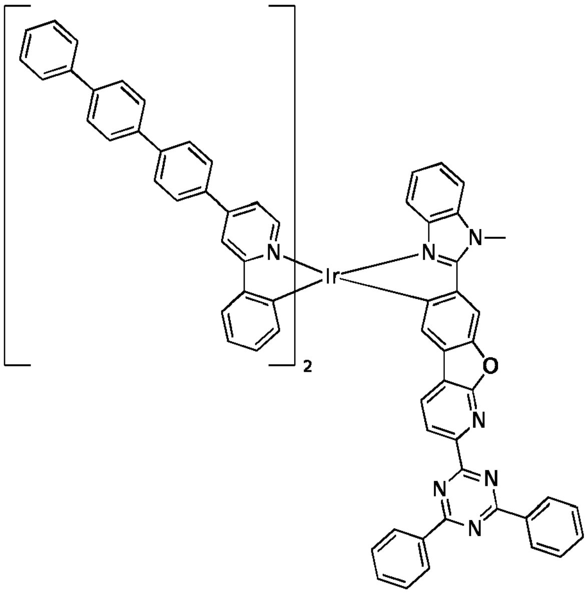

,

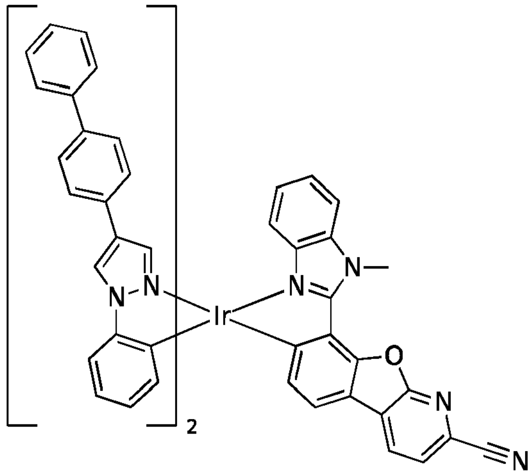

,

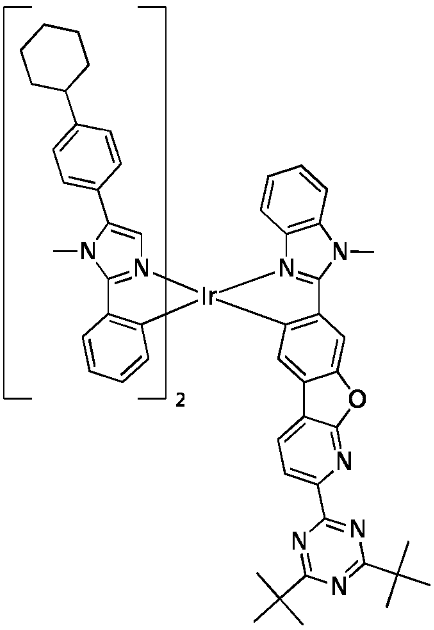

,

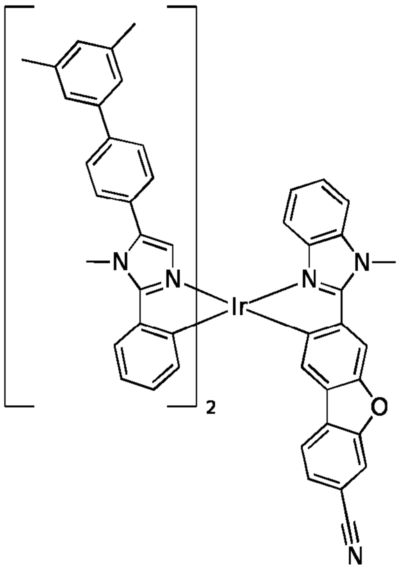

,

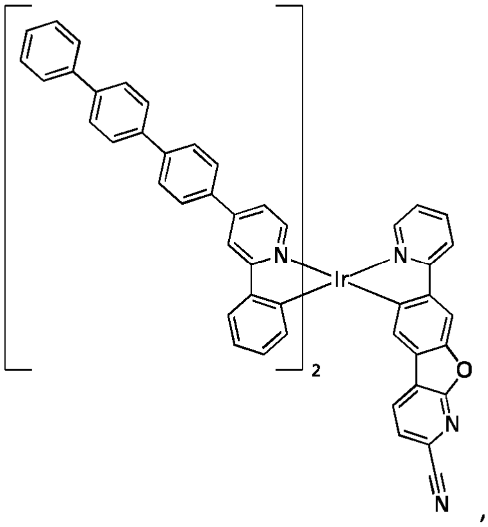

,

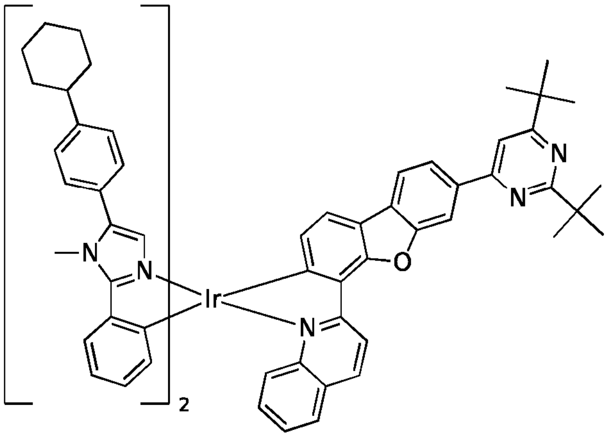

,

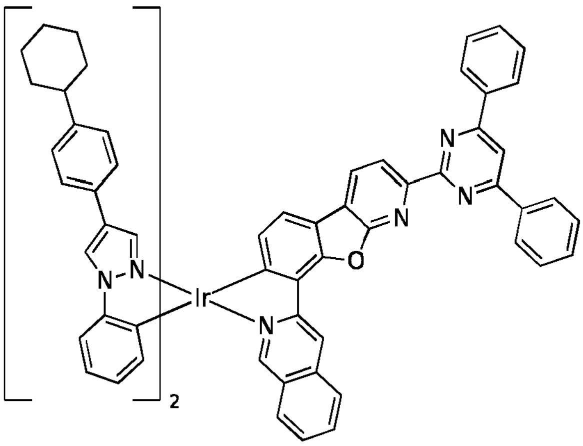

,

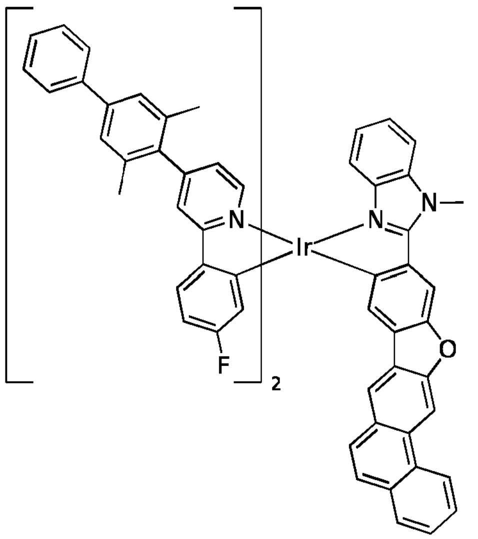

,

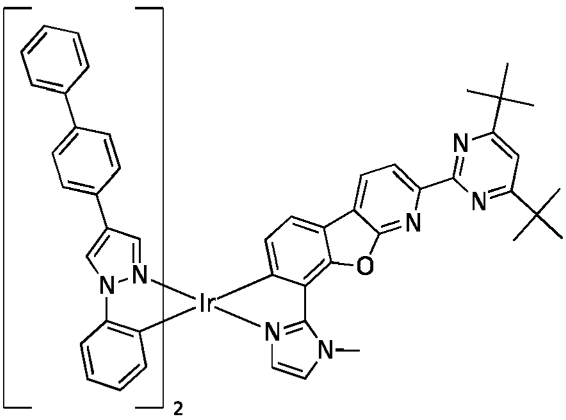

,

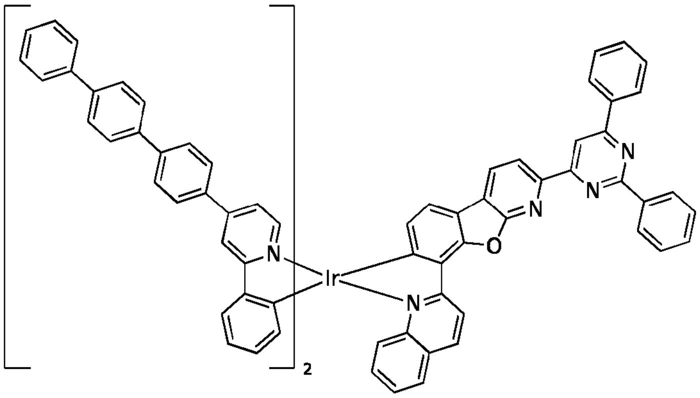

,

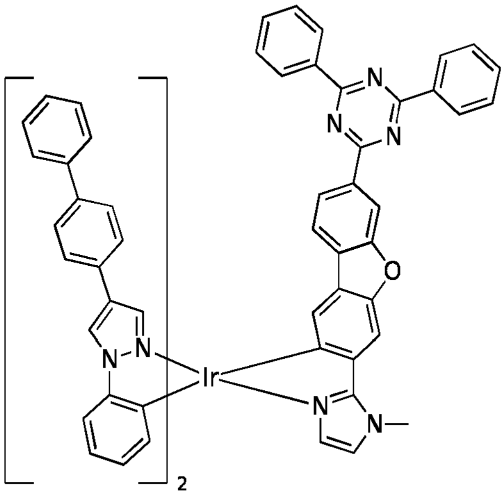

,

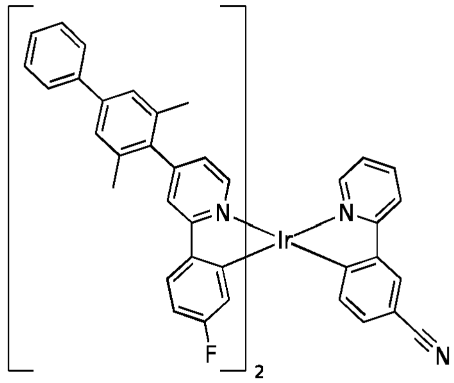

,

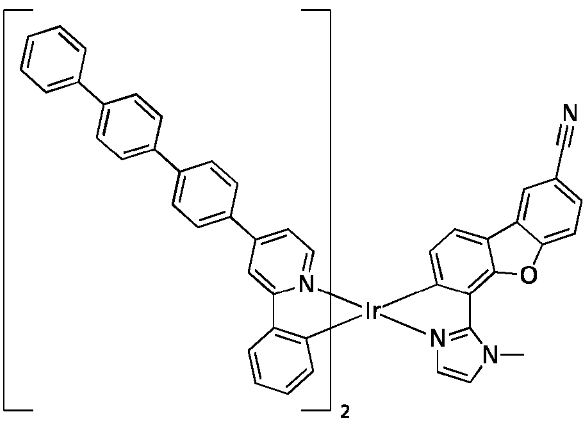

,

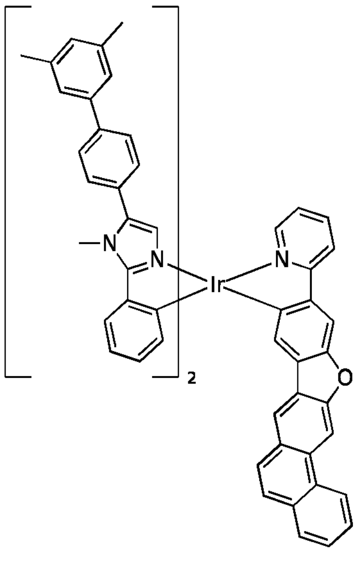

,

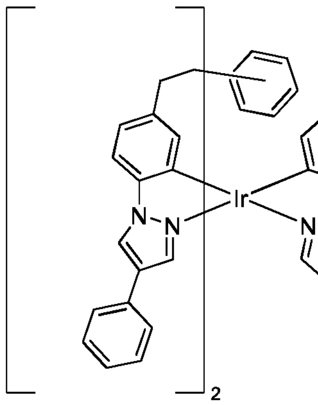
,
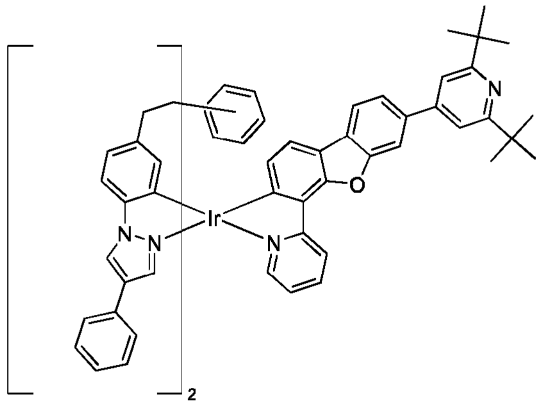
,
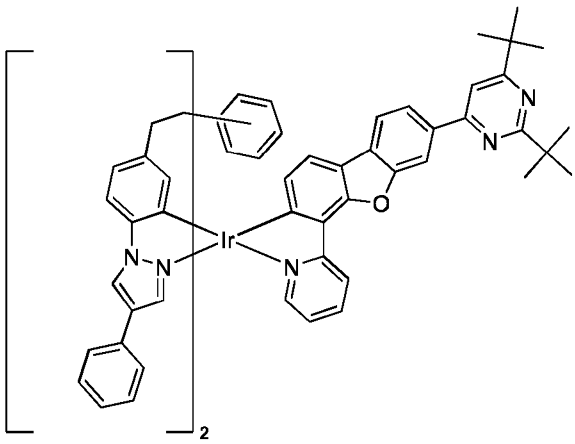
,
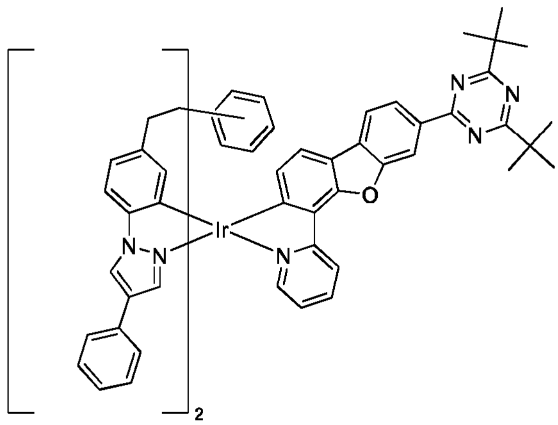
,
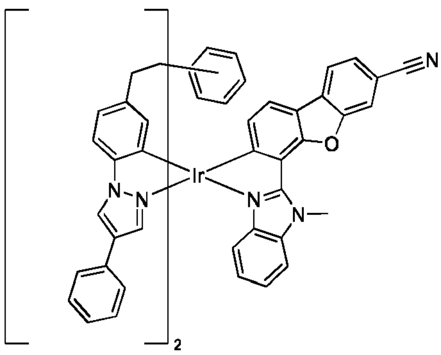
,
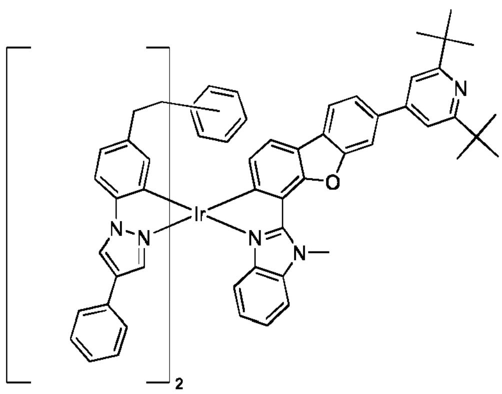
,
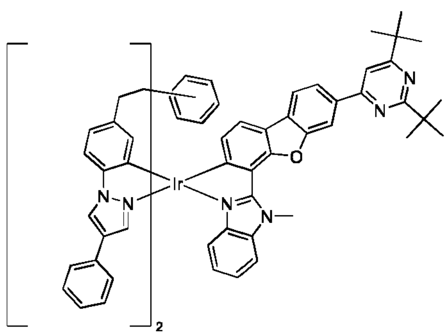
, and
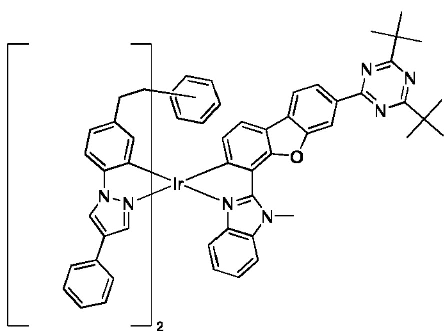
.

In some embodiments, the compound having a first ligand $L_A$ of Formula I described herein can be at least 30% deuterated, at least 40% deuterated, at least 50% deuterated, at least 60% deuterated, at least 70% deuterated, at least

80% deuterated, at least 90% deuterated, at least 95% deuterated, at least 99% deuterated, or 100% deuterated. As used herein, percent deuteration has its ordinary meaning and includes the percent of possible hydrogen atoms (*e.g.*, positions that are hydrogen or deuterium) that are replaced by deuterium atoms.

In some embodiments, the ligand $L_A$ is the first emissive ligand of the compound. In some embodiments, the ligands $L_B$ and/or $L_C$ are ancillary ligands.

As used herein, an ancillary ligand is the ligand with a higher free ligand $T_1$ energy. The free ligand $T_1$ energy can be determined by a computational procedure, using density functional theory (DFT) modelling. For example, the DFT calculations can be performed with B3LYP functional in LACVP* basis set. In a first step, geometry optimizations of the complex are performed, while constraining the triplet spin density on each ligand. In a second step, the geometries are reoptimized without imposing the constraint. The spin density should still be localized on the respective ligand. The ligand on which the spin density is localized in the lowest energy structure is considered the emitting ligand. That ligand is considered the primary emitting ligand if the energy difference to the second-ranked ligand is greater than 0.1 eV or 0.20 eV, or 0.30 eV.

Effective Length of a Ligand:
In some embodiments of the first aspect, each of the first emissive ligand and the ancillary ligands has an effective length, and the effective length of the first emissive ligand is at least 3 Å greater than the effective length of the second ligand.

In some embodiments, the ligand $L_A$ of Formula I has a ligand axis defined as the axis that runs through the bond between ring A and ring B of the ligand.

In addition, each ligand $L_A$ has a ligand center defined as the midpoint of the bond that connects ring A and ring B. In addition, each ligand has a ligand bisecting line defined as the infinite line that passes through the metal to the ligand center.

In addition, each ligand $L_A$ has a length vector defined for each atom in the ligand. Each length vector connects the associated atom to the ligand center. In addition, each ligand $L_A$ has values L1 and L2, where L1 is the highest value obtained among the products (magnitude of a length vector) * (the cosine of the angle formed by the length vector and the ligand axis) on the ring A side of the ligand bisecting line, and L2 is the highest value obtained among the products (magnitude of a length vector) * (the cosine of the angle formed by the length vector and the ligand axis) on the ring B side of the ligand bisecting line. In these and subsequent calculations, including when a moiety can rotate around an axis, the measurements are made with the molecule in the conformation with the lowest total energy as given by the geometry optimization in the ground state, performed using DFT in the CEP-31G basis set and B3LYP functional.

The effective length of a ligand is measured as the sum of L1 and L2 of that ligand. Examples of each of these values are shown using the chemical structure shown in FIG. 4. The calculated values of L1 and L2 for the example iridium complex in FIG. 4 are shown below in Table 1.

Table 1.

| | Length Vector Magnitude (Å) | Angle β between the Length Vector and the Ligand Axis (degrees) | Product ((Length) * (Cosine of the Angle β)) | Effective Length L1 + L2 (Å) |
|---|---|---|---|---|
| Ancillary Ligand | 8.3 | 20 | 7.8 (L1) | 12.4 |
| | 4.6 | 0 | 4.6 (L2) | |
| Emissive Ligand | 4.7 | 5 | 4.7 (L1) | 9.4 |
| | 4.7 | 2 | 4.7 (L2) | |

The transition dipole moments (TDM) can be calculated by performing TD-DFT calculations with Spin-Orbit ZORA Hamiltonian, using B3LYP functional, and DYALL-V2Z_ZORA-J-PT-SEG basis set.

In some embodiments, the first ligand has an effective length that is at least 5 Å greater than that of the second ligand. In some embodiments, the first ligand has an effective length that is at least 8 Å greater than that of the second ligand.

In some embodiments, the first ligand has at least 5 more non-hydrogen atoms than the second ligand. In some embodiments, the first ligand has at least 10 more non-hydrogen atoms than the second ligand. In some embodiments, the first ligand has at least 12 more non-hydrogen atoms than the second ligand.

In some embodiments, the first ligand has a molecular weight at least 100 amu greater than the molecular weight of the second ligand. In some embodiments, the first ligand has a molecular weight at least 150 amu greater than the molecular weight of the second ligand. In some embodiments, the first ligand has a molecular weight at least 200 amu greater than the molecular weight of the second ligand.

In some embodiments, the first ligand has at least 3 more aliphatic methylene carbons (*e.g.*, $CH_2$) than the

second ligand. In some embodiments, the first ligand has at least 5 more aliphatic methylene carbons than the second ligand. In some embodiments, the first ligand has at least 8 more aliphatic methylene carbons than the second ligand.

In some embodiments, the compound comprises a tetradentate ligand formed from one of the first ligand and a second ligand, or from the first ligand joined with a second ligand. In some embodiments, the first ligand and the second ligand are joined to form a tetradentate ligand.

In some embodiments, a difference in the number of R* moieties between the first ligand and the second ligand in the compound is at least two. In some embodiments of the first aspect, a difference in the number of R* moieties between the first ligand and the second ligand is at least three. In some embodiments of the first aspect, a difference in the number of R* moieties between the first ligand and the second ligand is at least four.

In some embodiments, the first ligand comprises at least two more R* moieties than the second ligand in the compound. In some embodiments, the second ligand comprises at least two more R* moieties than the first emissive ligand.

As used herein, each R* moiety is independently a substituent selected from the group consisting of halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some embodiments, each R* moiety is independently selected from the group consisting of halogen, $CF_3$, CN, F, C=O, and $OR^w$, where each $R^w$ is independently selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof.

In some embodiments, wherein the metal M has an atomic weight greater than 40. In some such embodiments, the metal M is selected from the group consisting of Ir, Rh, Re, Ru, Os, Pt, Pd, Ag, Au, and Cu. In some such embodiments, the metal M is Ir or Pt. In some such embodiments, the metal M is Pt.

In some embodiments, the metal complex compound further comprises a third ligand.

In some embodiments, the first ligand and the third ligand are the same. In some embodiments, the second ligand and the third ligand are the same.

In some embodiments, the first ligand and the third ligand are the same ancillary ligands, and the second ligand is an emitting ligand. In some embodiments, the first ligand and the third ligand are different ancillary ligands, and the second ligand is an emitting ligand. In some embodiments, the second ligand and the third ligand are the same emitting ligands, and the first ligand is an ancillary ligand.

In some embodiments of the second aspect, the second vector $\mathbf{F_2}$ forms an angle greater than 45 degrees with $\mathbf{F_1}$.

Where more than one pair of atoms meets the requirements for the first bound vector $\mathbf{M_1}$, the pair forming the longest first bound vector that meets the other requirements is selected. Where more than one pair of atoms meets the requirements for the second bound vector $\mathbf{M_2}$, the pair forming the longest second bound vector that meets the other requirements is selected.

In some embodiments, the complex compound has a first free vector $\mathbf{F_1}$, represented by a first bound vector $\mathbf{M_1}$ that connects any two atoms in the compound and passes within 1 Å of the metal, and has a length greater than 18 **Å;** wherein the compound has a second free vector $\mathbf{F_2}$, represented by a second bound vector $\mathbf{M_2}$ that connects any two atoms in the compound and has a length greater than 18 Å; and wherein the angle between the emissive transition dipole moment vector and the cross product of vectors $\mathbf{F_1}$ and $\mathbf{F_2}$ is less than 45 degrees.

In some embodiments, the atoms forming the second bound vector $\mathbf{M_2}$ are in the same ligand and the atoms forming the first bound vector $\mathbf{M_1}$ are in different ligands. In some embodiments, the atoms forming the second bound vector $\mathbf{M_2}$ are in a different ligand that either of the atoms forming the first bound vector $\mathbf{M_1}$.

In some embodiments, the second vector $\mathbf{F_2}$ forms an angle greater than 45 degrees with $\mathbf{F_1}$.

In some embodiments of the second aspect, the second vector $\mathbf{F_2}$ is the longest vector that connects any two atoms in the molecule and forms an angle greater than 60 degrees with $\mathbf{F_1}$.

In some embodiments of the second aspect, the lengths of $\mathbf{F_1}$ and $\mathbf{F_2}$ are both greater than 20 Å. In some embodiments of the second aspect, the lengths of $F_1$ and $\mathbf{F_2}$ are both greater than 22 Å.

In some embodiments, the angle between the emissive transition dipole moment vector and the cross product of vectors $\mathbf{F_1}$ and $\mathbf{F_2}$ is less than 30 degrees. In some embodiments, the angle between the emissive transition dipole moment vector and the cross product of vectors $\mathbf{F_1}$ and $\mathbf{F_2}$ is less than 20 degrees.

In some embodiments, the compound has a plane **P** defined by free vectors $\mathbf{F_1}$ and $\mathbf{F_2}$, represented by corresponding bound vectors $\mathbf{M_1}$ and $\mathbf{M_2}$, and the plane **P** is parallel to $\mathbf{M_1}$ and $\mathbf{M_2}$ and passes through the metal M; and a sum of the perpendicular distance from the plane **P** to an atom farthest above the plane **P,** and the perpendicular distance from the plane **P** to an atom farthest below the plane **P,** is less than 14 A. In some such embodiments, a sum of the perpendicular distance from the plane **P to** an atom farthest above the plane **P,** and the perpendicular distance from the

plane P to an atom farthest below the plane **P,** is less than 12 Å. In some such embodiments, a sum of the perpendicular distance from the plane **P** to an atom farthest above the plane **P,** and the perpendicular distance from the plane P to an atom farthest below the plane **P,** is less than 10 Å.

The perpendicular distance from the plane **P** was calculated using the standard formula for distance of a point from a plane:

$$distance = \frac{|ax_0 + by_0 + cz_0 + d|}{\sqrt{a^2 + b^2 + c^2}}$$

where a, b, c are components of the plane normal vector, $x_0$, $y_0$, $z_0$ are the coordinates of the atom, and d is the constant of the plane equation that ensures that the plane passes through the metal atom.

In some embodiments, the metal coordination complex compounds described herein can be at least 10% deuterated, at least 20% deuterated, at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (*e.g.*, positions that are hydrogen or deuterium) that are replaced by deuterium atoms.

**C. The OLEDs and the Devices of the Present Disclosure**

In another aspect, the present disclosure also provides an OLED device comprising a first organic layer that contains a compound as disclosed in the above compounds section of the present disclosure.

In some embodiments, the OLED comprises: an anode; a cathode; and an organic layer disposed between the anode and the cathode, where the organic layer comprises a metal coordination complex compound as described herein.

In some embodiments, the organic layer may be an emissive layer and the compound as described herein may be an emissive dopant or a non-emissive dopant.

In some embodiments, the organic layer is at least 10% deuterated. In some embodiments, at least one compound is at least 10% deuterated. In some embodiments, each compound in the organic layer is at least 10% deuterated.

In some embodiments, the organic layer is at least 50% deuterated. In some embodiments, at least one compound is at least 50% deuterated. In some embodiments, each compound in the organic layer is at least 50% deuterated.

In some embodiments, the organic layer is at least 90% deuterated. In some embodiments, at least one compound is at least 90% deuterated. In some embodiments, each compound in the organic layer is at least 90% deuterated.

In some embodiments, the organic layer may further comprise a host, wherein the host comprises a triphenylene containing benzo-fused thiophene or benzo-fused furan, wherein any substituent in the host is an unfused substituent independently selected from the group consisting of $C_nH_{2n+1}$, $OC_nH_{2n+1}$, $OAr_1$, $N(C_nH_{2n+1})_2$, $N(Ar_1)(Ar_2)$, $CH=CH-C_nH_{2n+1}$, $C\equiv CC_nH_{2n+1}$, $Ar_1$, $Ar_1-Ar_2$, $C_nH_{2n}-Ar_1$, or no substitution, wherein n is an integer from 1 to 10; and wherein $Ar_1$ and $Ar_2$ are independently selected from the group consisting of benzene, biphenyl, naphthalene, triphenylene, carbazole, and heteroaromatic analogs thereof.

In some embodiments, the organic layer may further comprise a host, wherein host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the host may be selected from the HOST Group 1 consisting of:

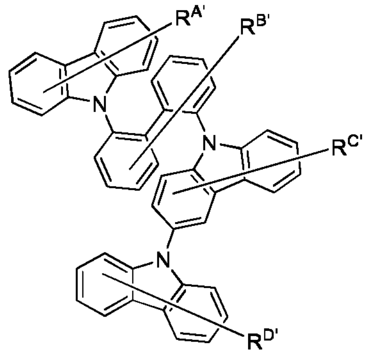
,
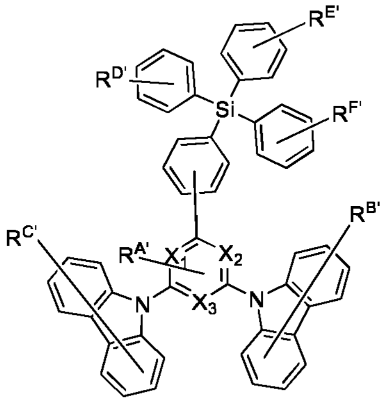
,
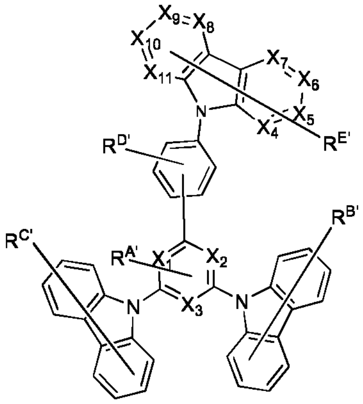
,

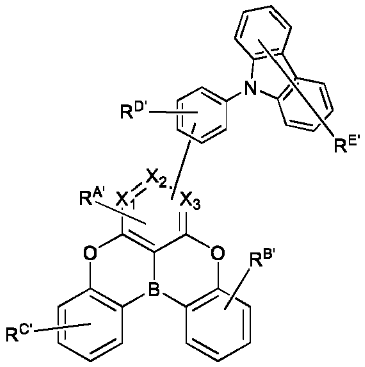
,
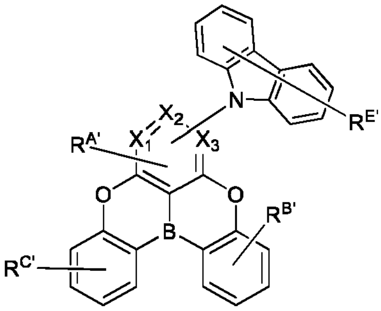
,
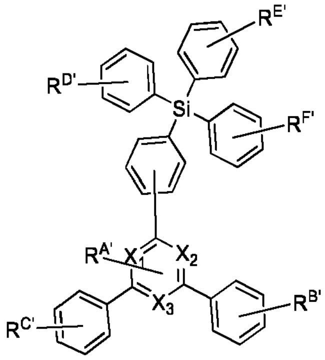
,

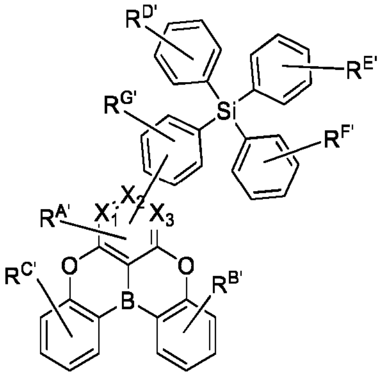
,
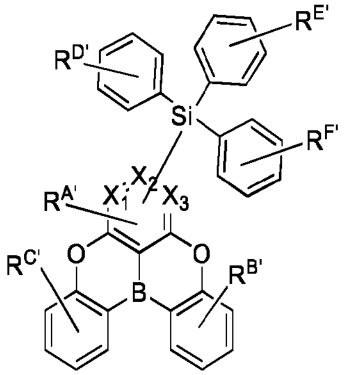
,
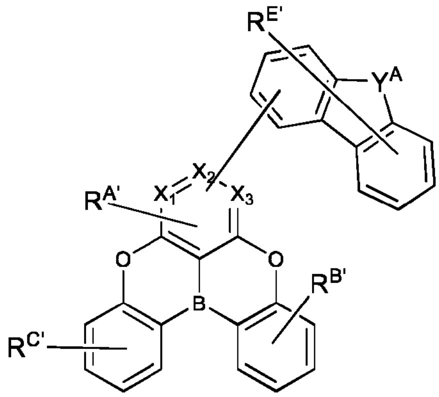
,

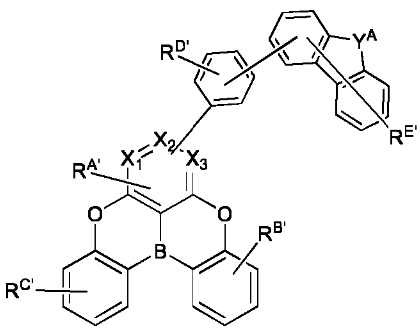
,
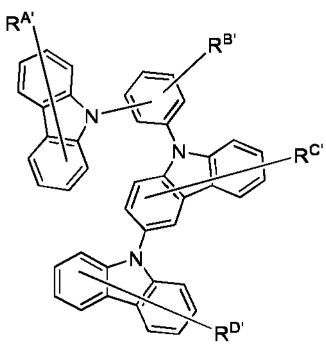
,

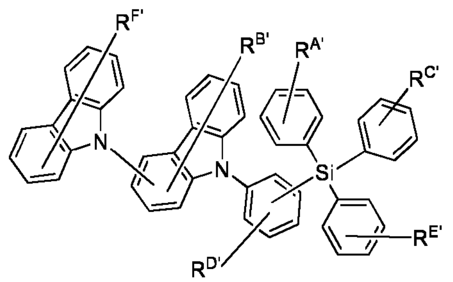

,

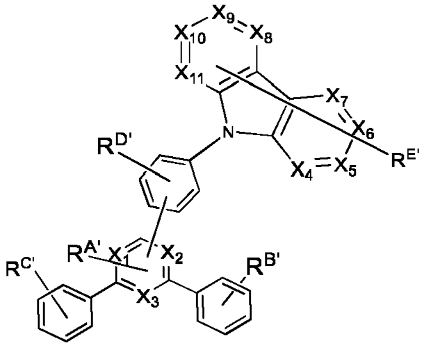

,

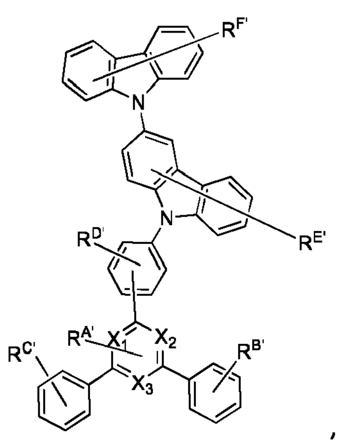

,

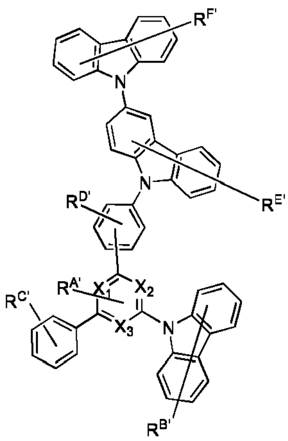

,

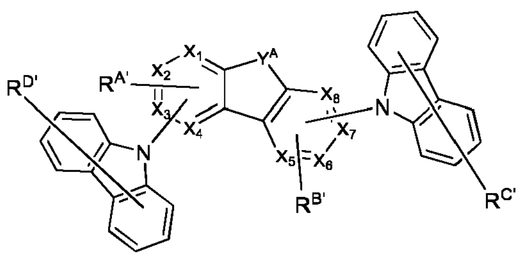

,

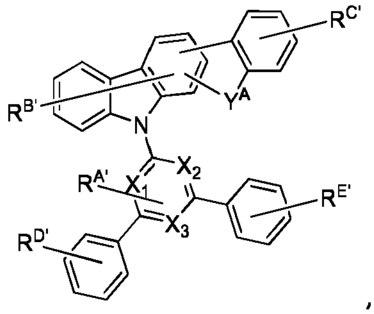

,

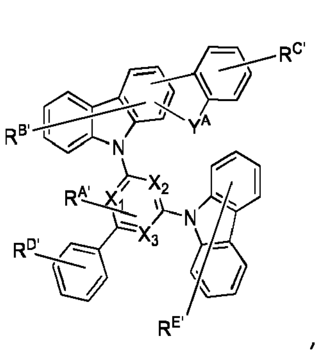

,

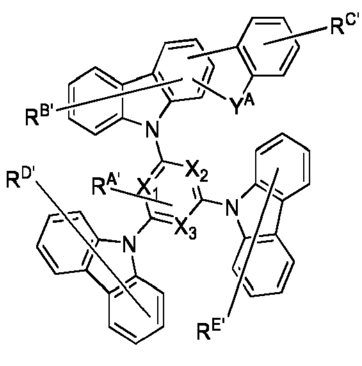

,

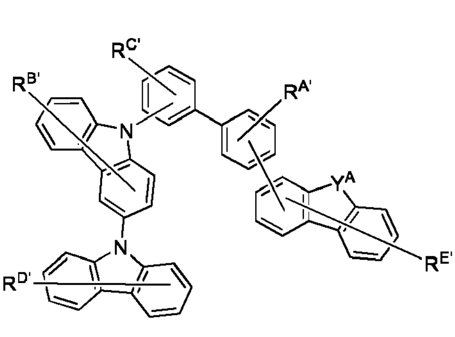

,

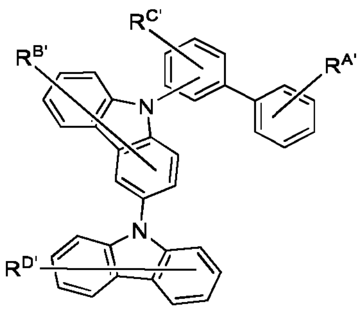 , 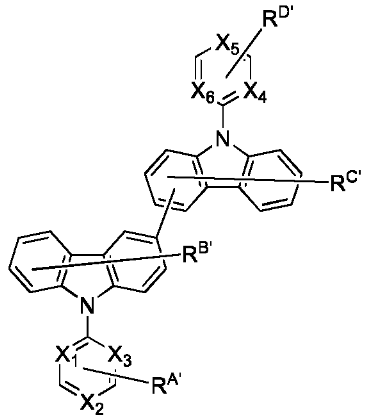 , 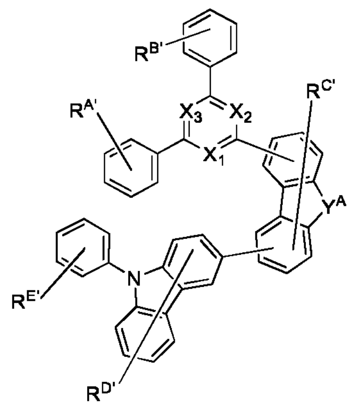 ,

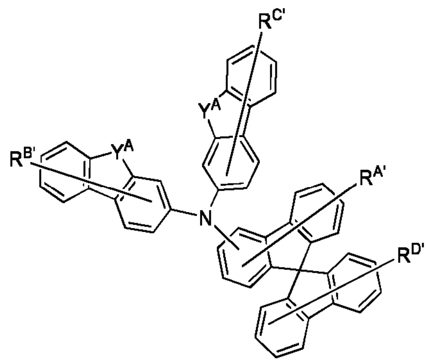 , 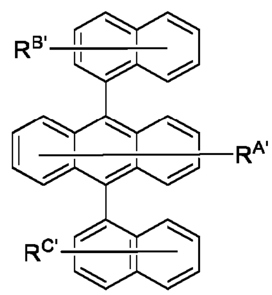 , 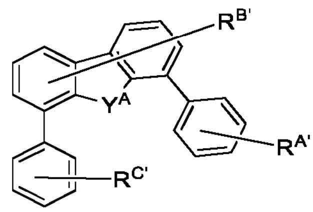 ,

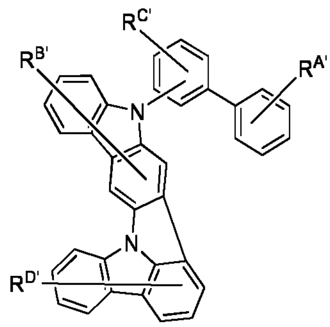 , 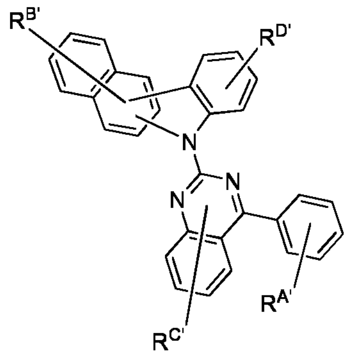 , 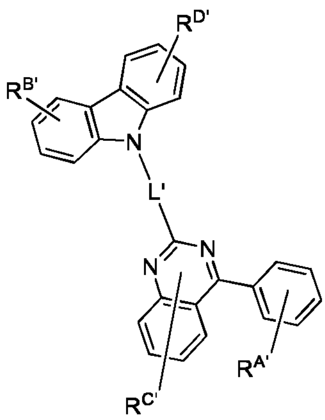 ,

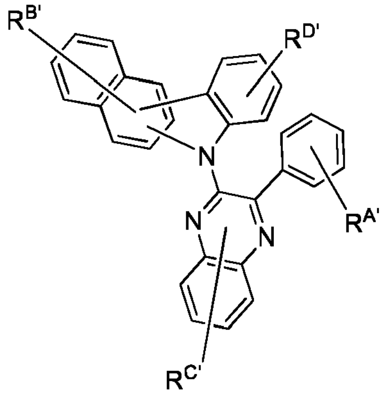 , 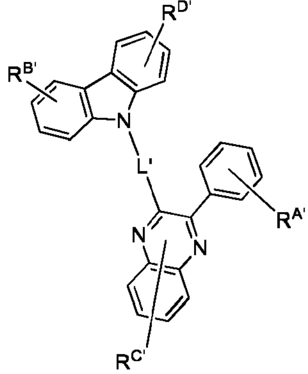 , 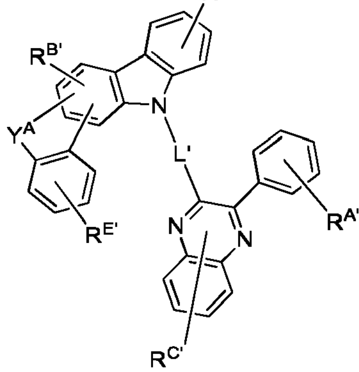 ,

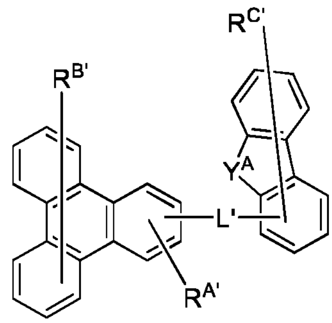,
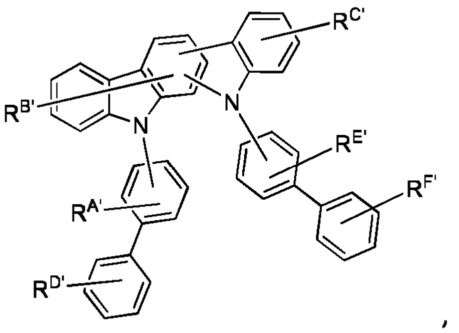,

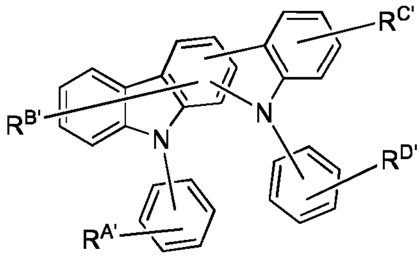,
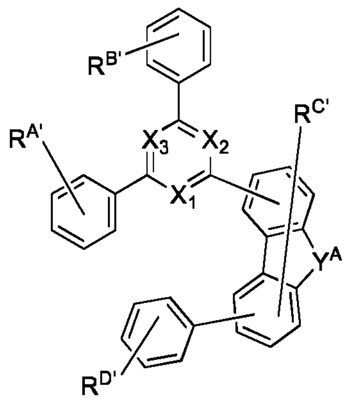,
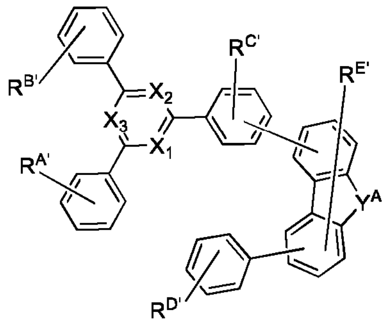,

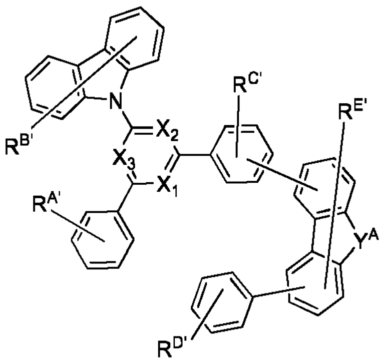,
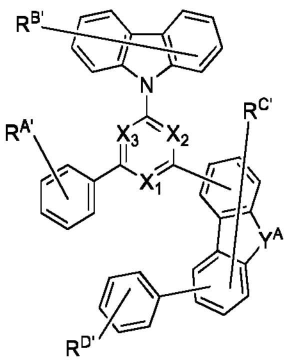,

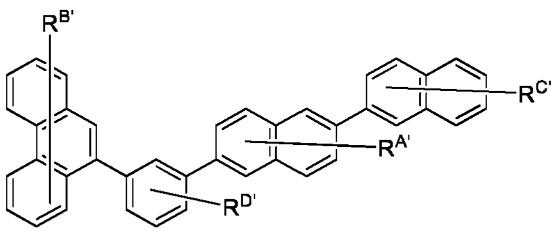,
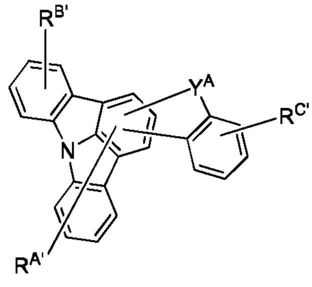,
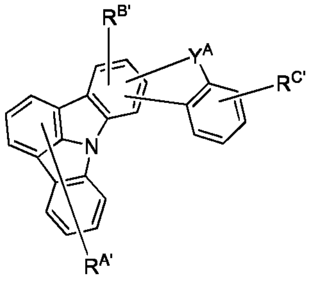

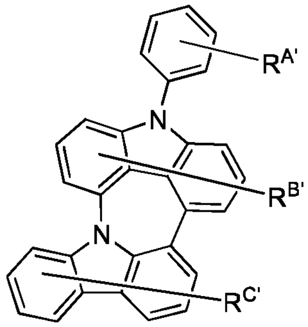
,
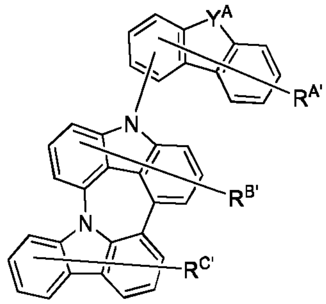
,
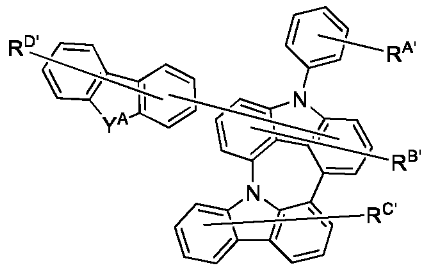
,
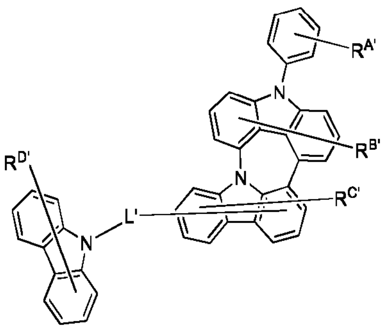
,
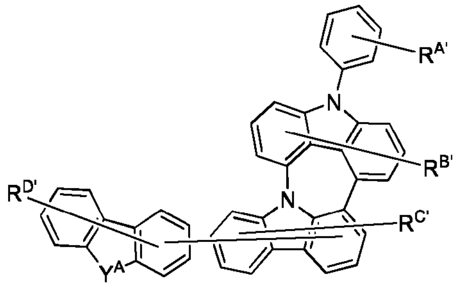
,
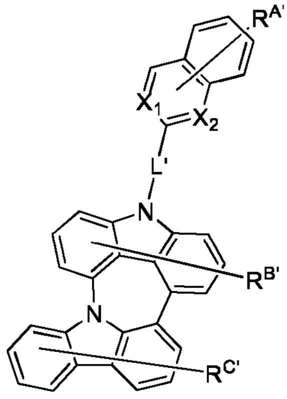
,
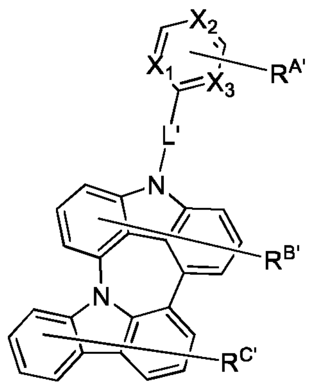
,
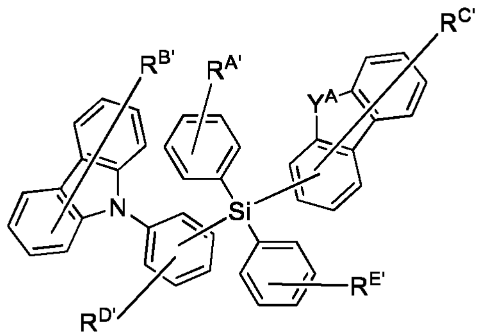
,
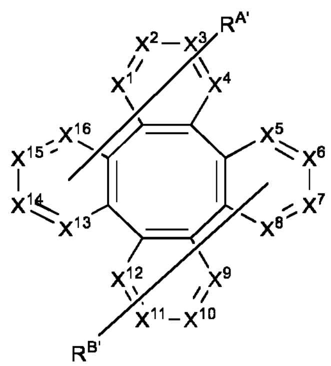
,
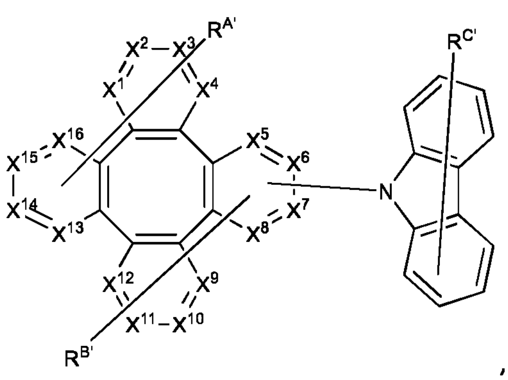
,
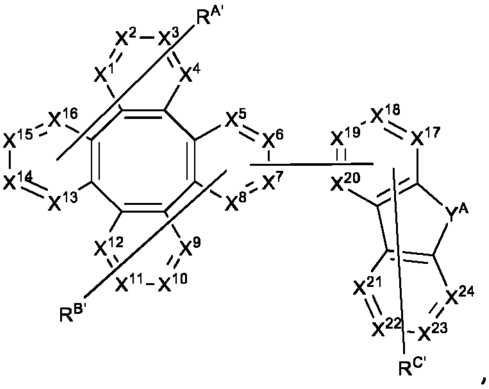
,

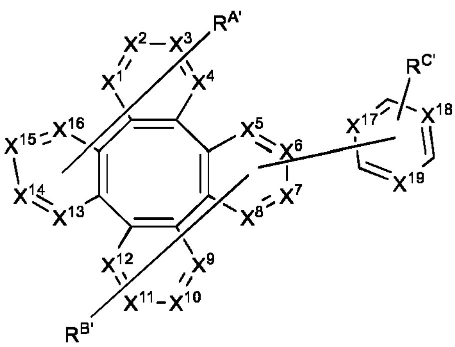
,
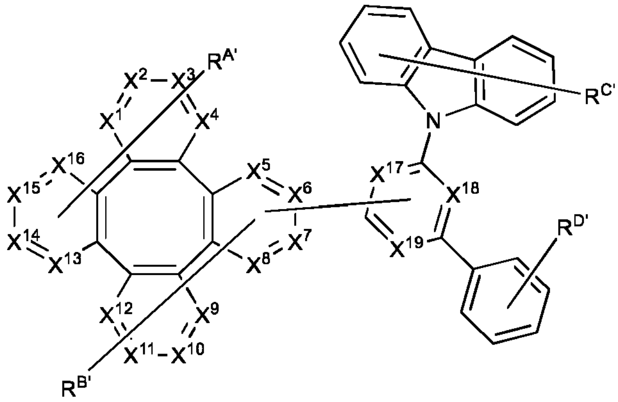
,

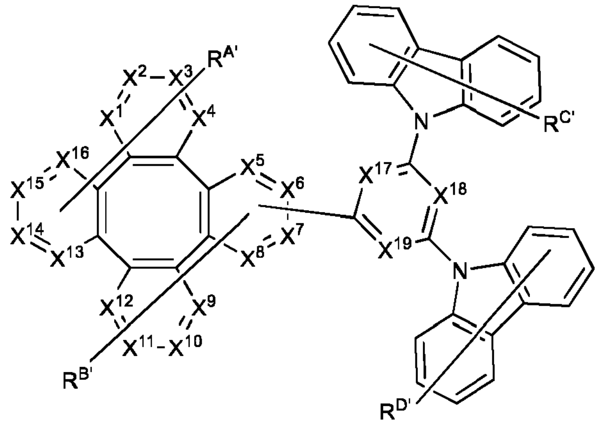
,
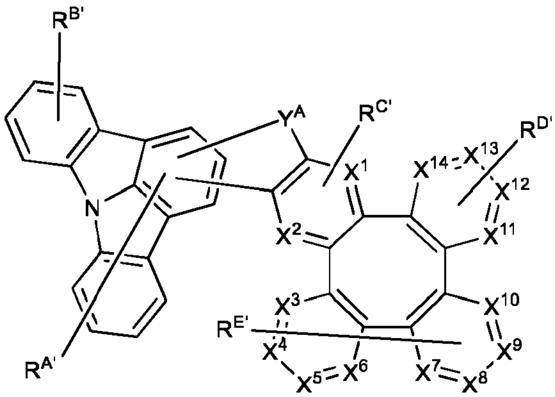
,

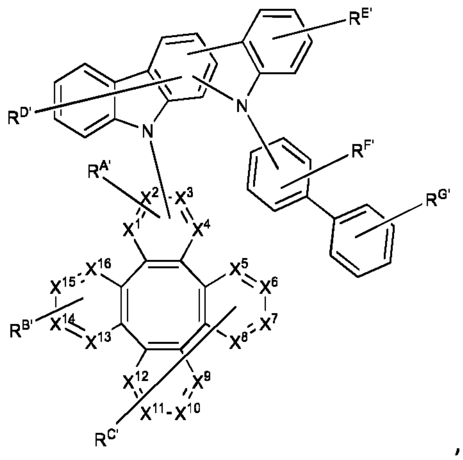
,
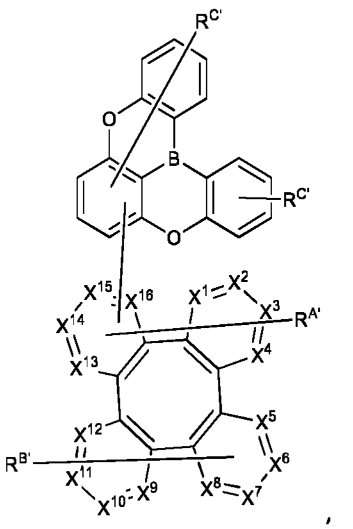
,

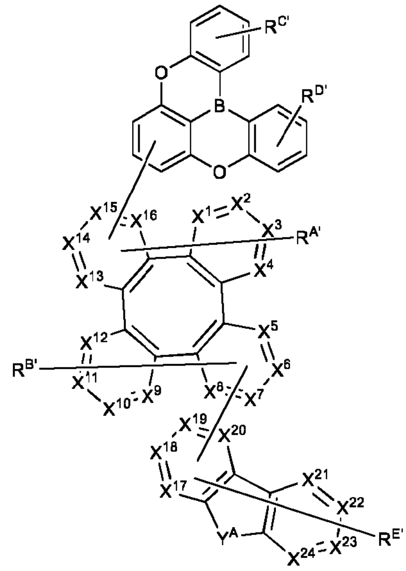
,
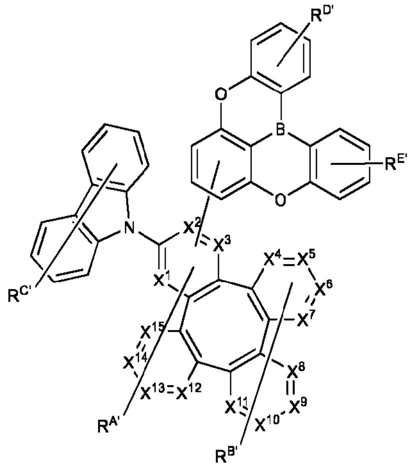
,

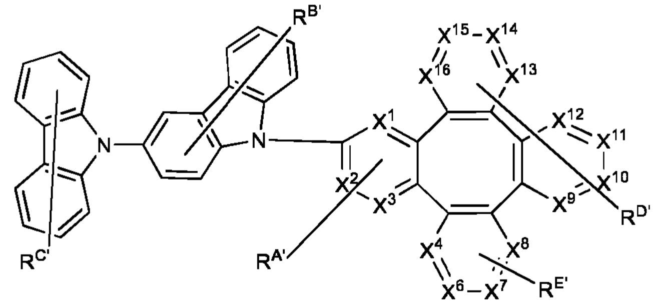
,

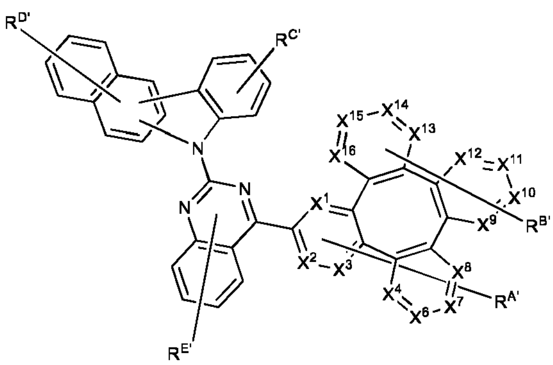
,
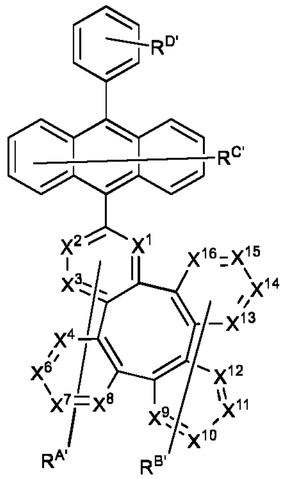
,

and

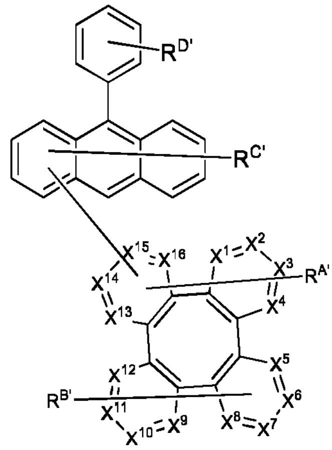

,

wherein:

- each of $X^1$ to $X^{24}$ is independently C or N;
- L' is a direct bond or an organic linker;
- each $Y^A$ is independently selected from the group consisting of absent a bond, O, S, Se, CRR', SiRR', GeRR', NR, BR, BRR';
- each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;
- each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof;
- two adjacent of $R^{A'}$, $R^{B'}$, $R^{C'}$, $R^{D'}$, $R^{E'}$, $R^{F'}$, and $R^{G'}$ are optionally joined or fused to form a ring.

In some embodiments, the host may be selected from the HOST Group 2 consisting of:

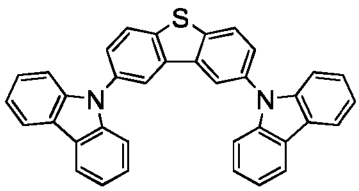

,

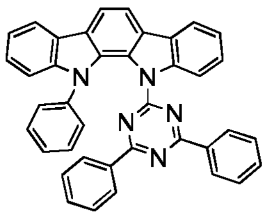

,

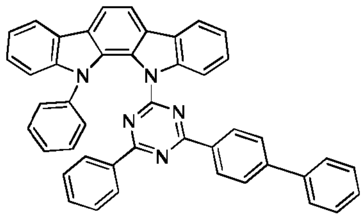

,

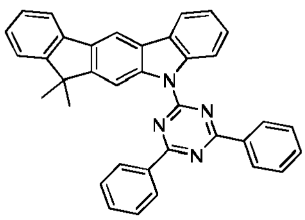

,

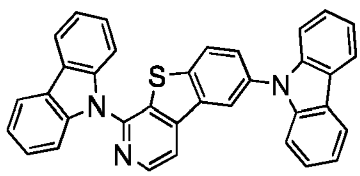

,

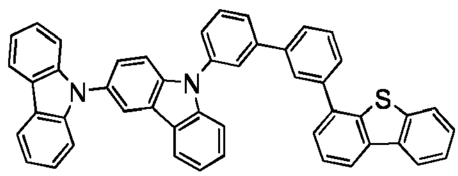

,

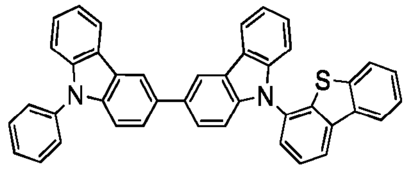 , 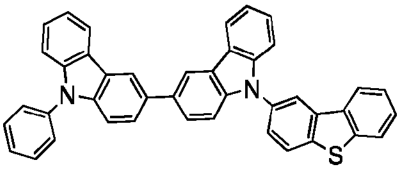 , 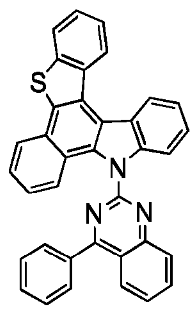 ,

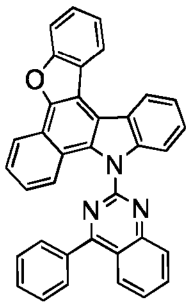 , 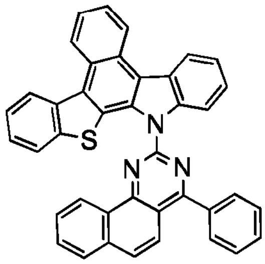 , 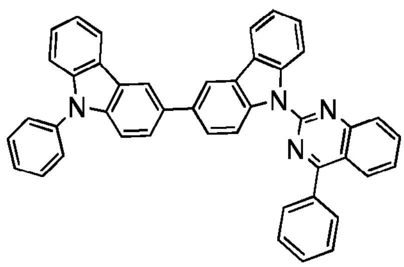 ,

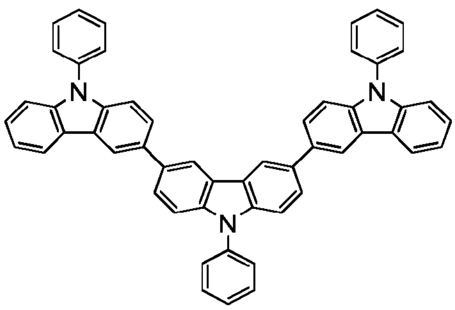 , 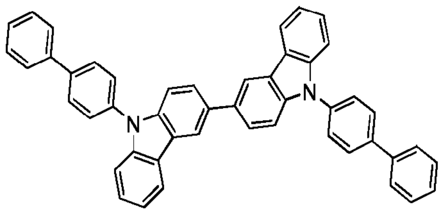 ,

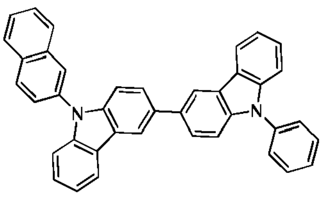 , 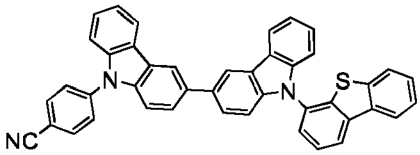 , 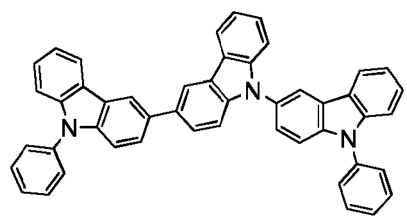 ,

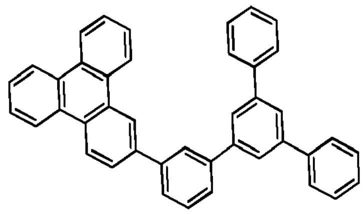 , 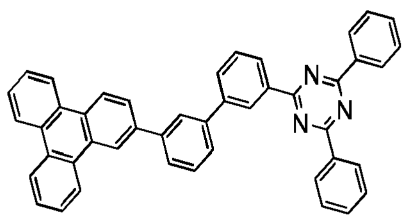 , 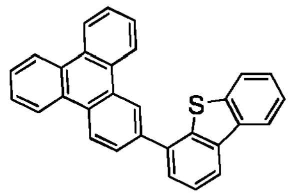 ,

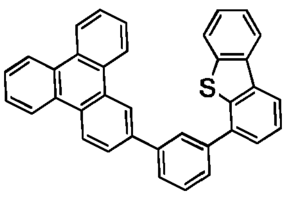 , 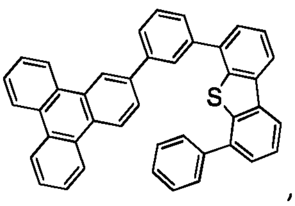 , 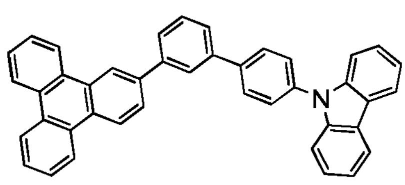 ,

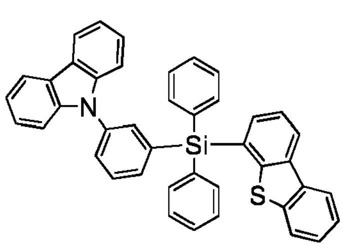 , 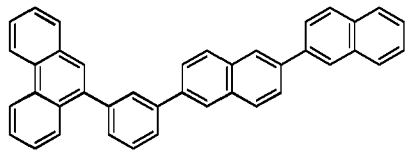 , 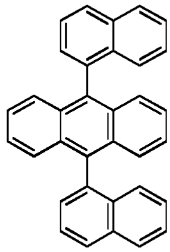 ,

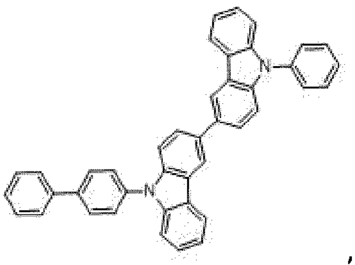 , 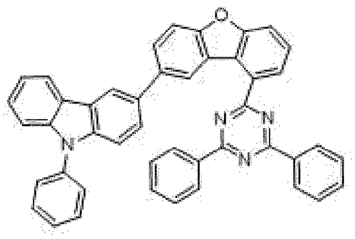 , 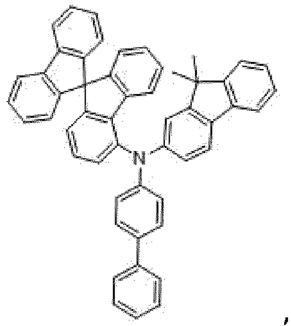 , 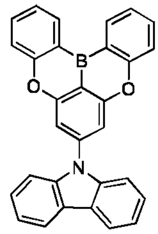 ,

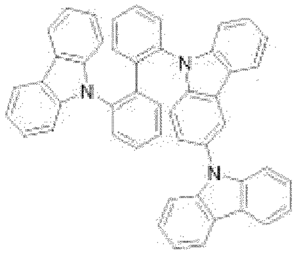 , 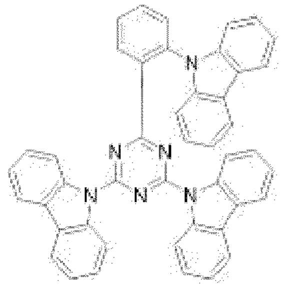 , 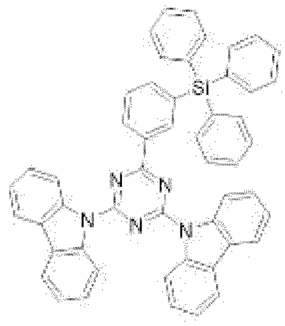 ,

and combinations thereof.

In some embodiments, the organic layer may further comprise a host, wherein the host comprises a metal complex.

In some embodiments, the compound as described herein may be a sensitizer; wherein the device may further comprise an acceptor; and wherein the acceptor may be selected from the group consisting of fluorescent emitter, delayed fluorescence emitter, and combination thereof.

In yet another aspect, the OLED of the present disclosure may also comprise an emissive region containing a compound as disclosed in the above compounds section of the present disclosure.

In some embodiments, the emissive region can comprise a metal coordination complex compound as described herein.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more

intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission lineshape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a plurality of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In yet another aspect, the present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

In some embodiments, the consumer product comprises an OLED having an anode; a cathode; and an organic layer disposed between the anode and the cathode, wherein the organic layer can comprise a metal coordination complex compound as described herein.

In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745, which are incorporated herein by reference in their entirety.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in U.S. Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with $F_4$-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to

30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence; *see, e.g.,* U.S. Application No. 15/700,352, which is hereby incorporated by reference in its entirety), triplet-triplet annihilation, or combinations of these processes. In some embodiments, the emissive dopant can be a racemic mixture, or can be enriched in one enantiomer. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the compound can be used as a phosphorescent sensitizer in an OLED where one or multiple layers in the OLED contains an acceptor in the form of one or more fluorescent and/or delayed fluorescence emitters. In some embodiments, the compound can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

According to another aspect, a formulation comprising the compound described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In yet another aspect of the present disclosure, a formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a greater chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

**D. Combination of the Compounds of the Present Disclosure with Other Materials**

The materials described herein as useful for a particular layer in an organic light emitting device may be used in

combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

**a) Conductivity Dopants:**

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

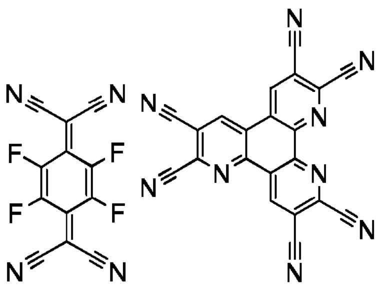 ,

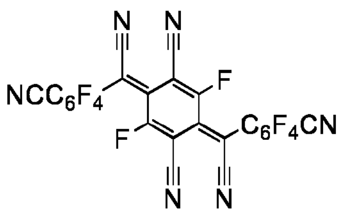 ,

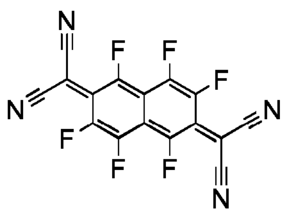 ,

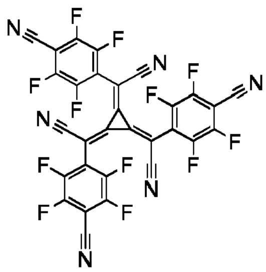 ,

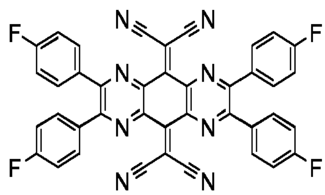 ,

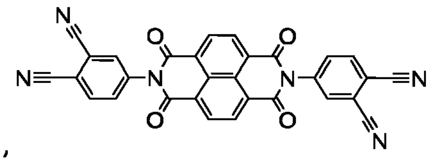 ,

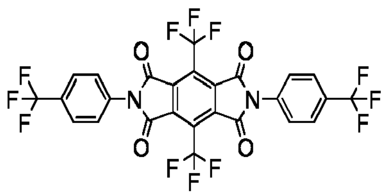 ,

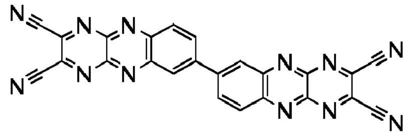 ,

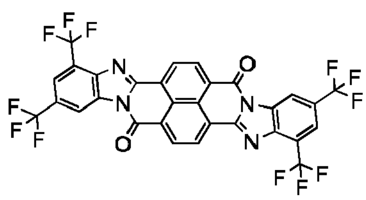 ,

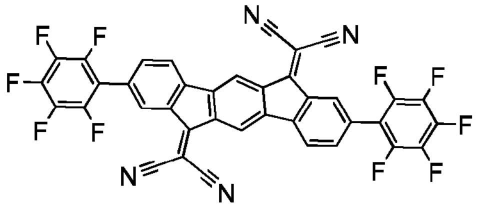, 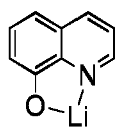, 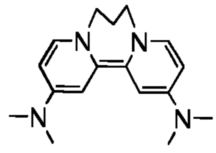 and 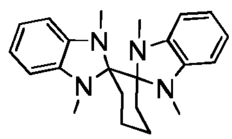.

**b) HIL/HTL:**

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as $MoO_x$; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

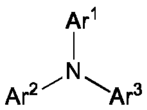, 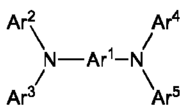, 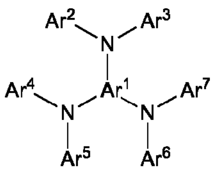, 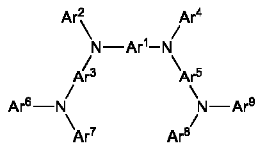, and 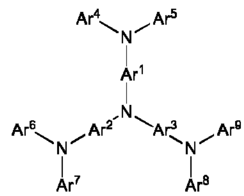

.

Each of $Ar^1$ to $Ar^9$ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, $Ar^1$ to $Ar^9$ is independently selected from the group consisting of:

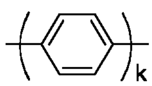, 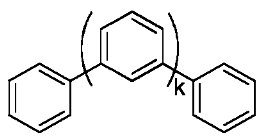, 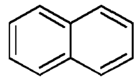, 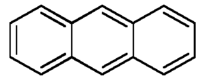,

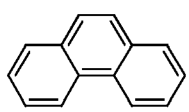, 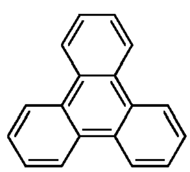, 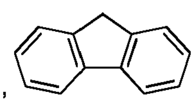, and 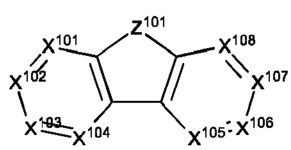,

wherein k is an integer from 1 to 20; $X^{101}$ to $X^{108}$ is C (including CH) or N; $Z^{101}$ is $NAr^1$, O, or 5; $Ar^1$ has the same group defined above.

Examples of metal complexes used in HIL or HTL include, but are not limited to the following general formula:

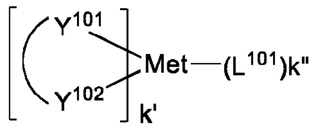

wherein Met is a metal, which can have an atomic weight greater than 40; ($Y^{101}$-$Y^{102}$) is a bidentate ligand, $Y^{101}$ and $Y^{102}$ are independently selected from C, N, O, P, and 5; $L^{101}$ is an ancillary ligand; k' is an integer value from 1 to the maximum number of ligands that may be attached to the metal; and k'+k" is the maximum number of ligands that may be attached to the metal.

In one aspect, ($Y^{101}$-$Y^{102}$) is a 2-phenylpyridine derivative. In another aspect, ($Y^{101}$-$Y^{102}$) is a carbene ligand. In another aspect, Met is selected from Ir, Pt, Os, and Zn. In a further aspect, the metal complex has a smallest oxidation potential in solution vs. $Fc^+/Fc$ couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

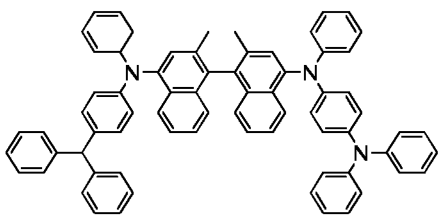,
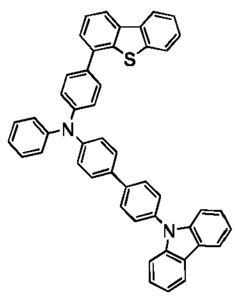,
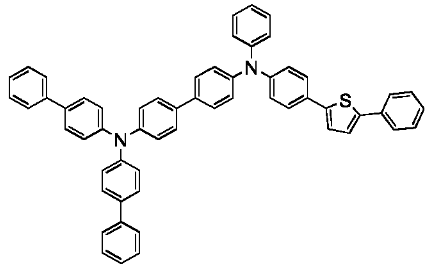,

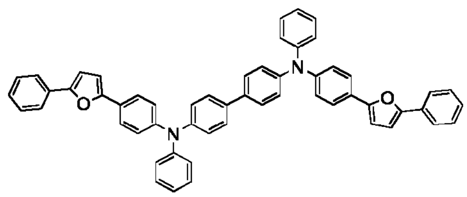,
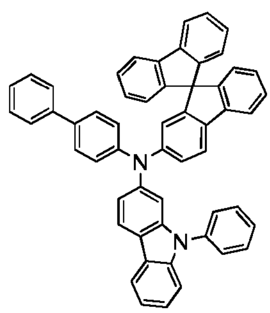,
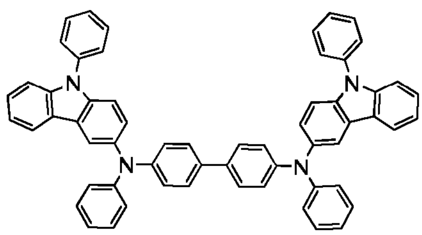,

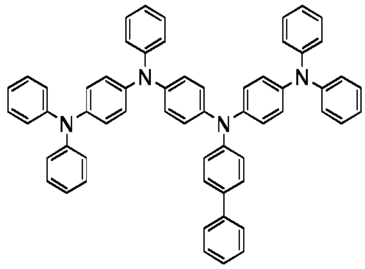,
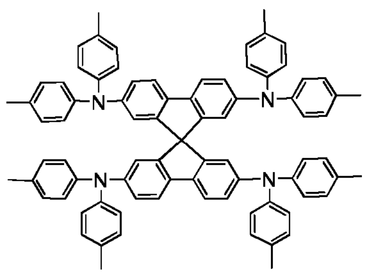,

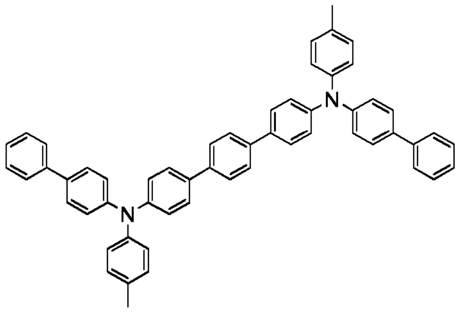,
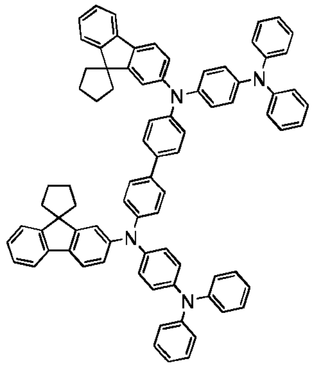,

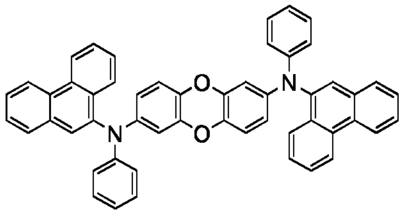,
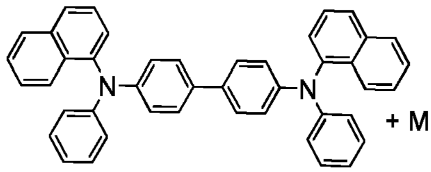 + $MoO_x$,

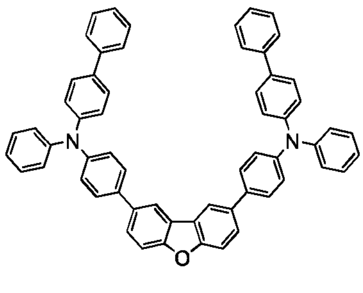,
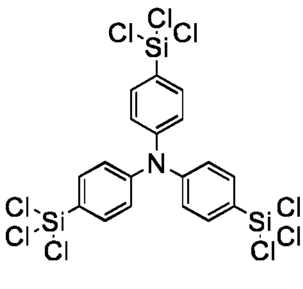,

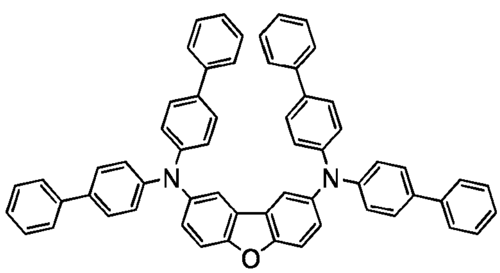,
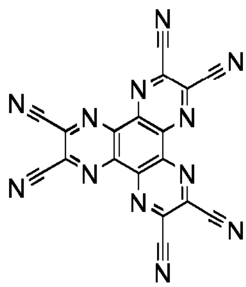,

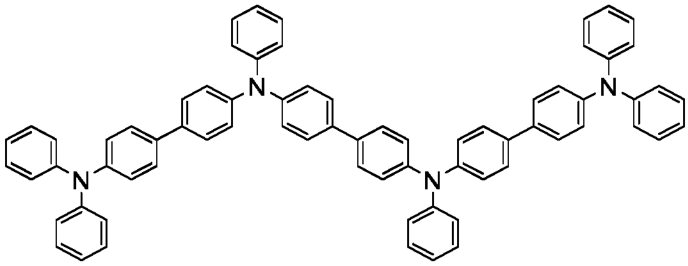 , 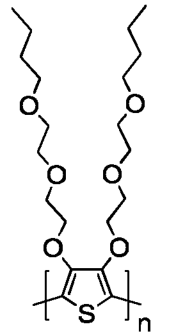 ,

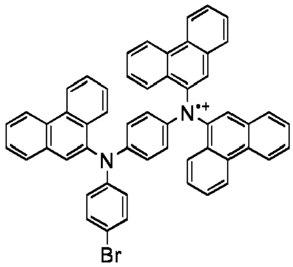 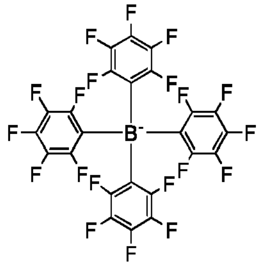 , 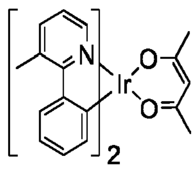 , 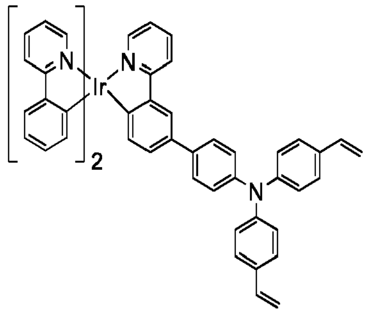 ,

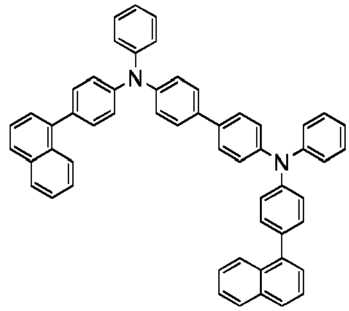 , 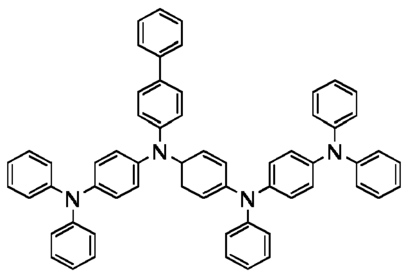 , 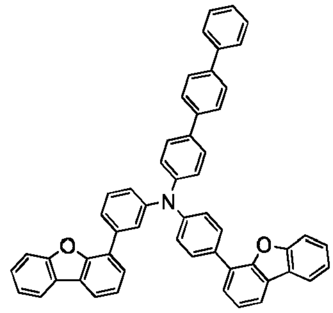 ,

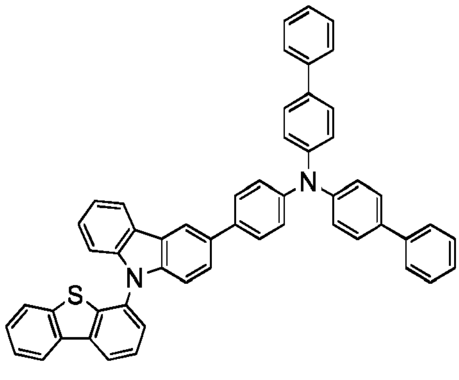 , 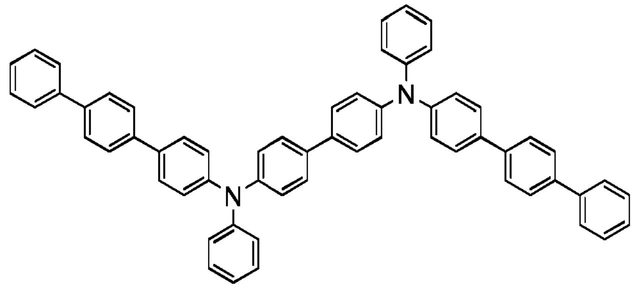 ,

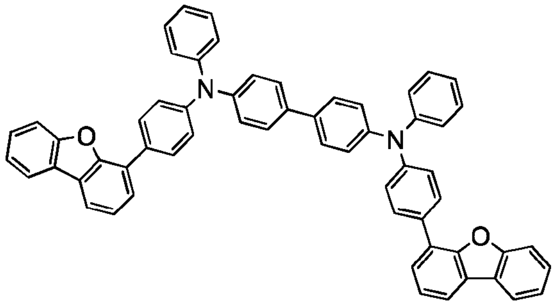,
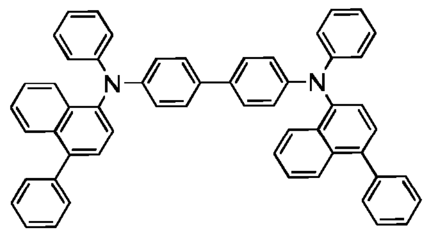,

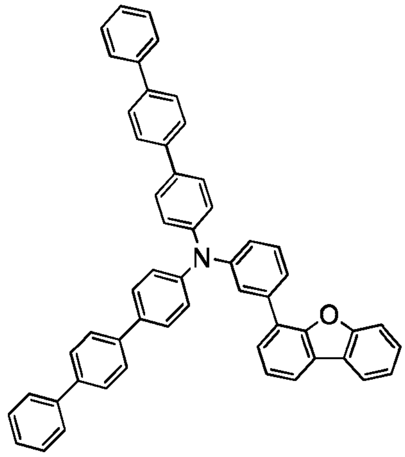,
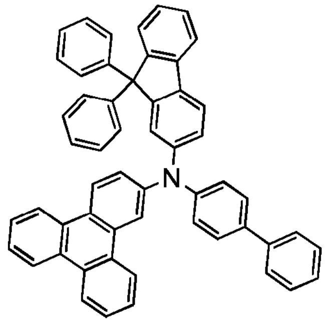,

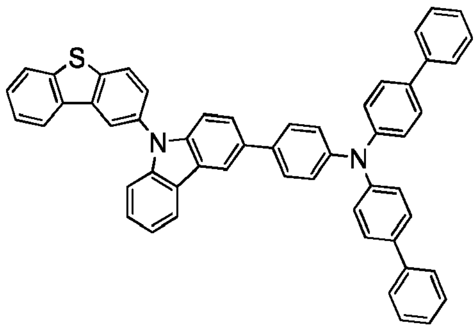,
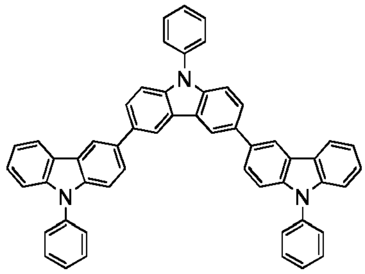,
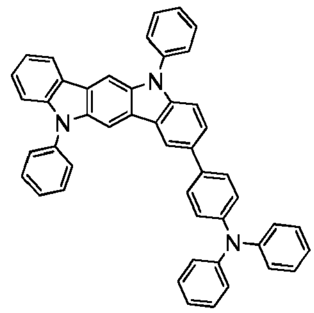,

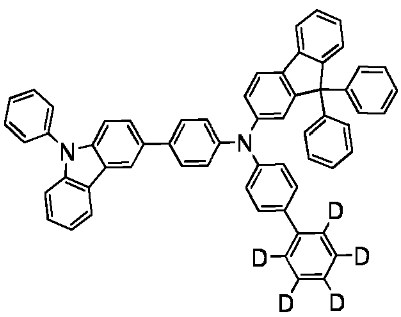,
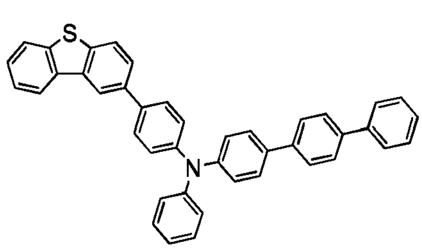,

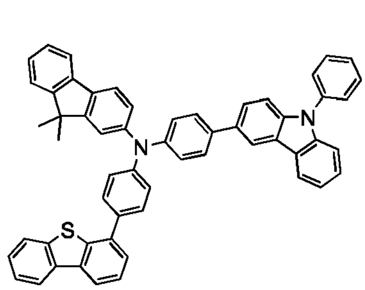,
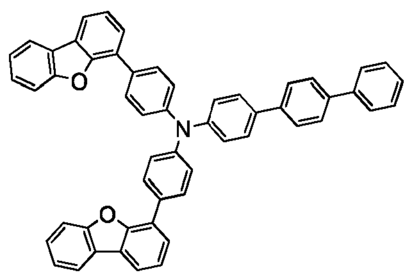,
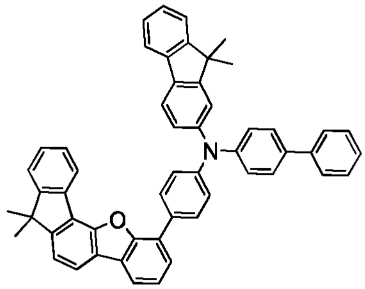,

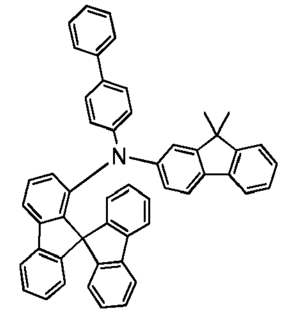,
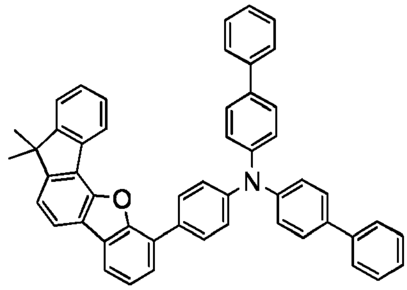,
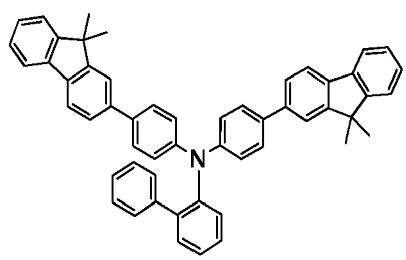,

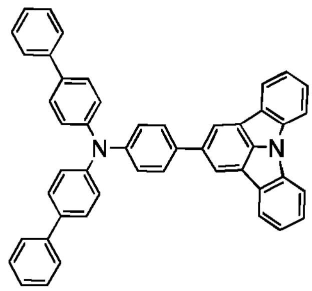,
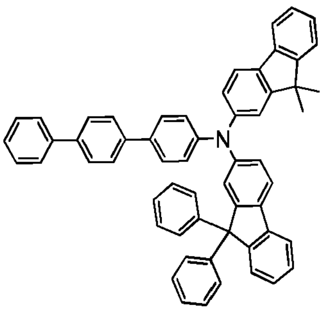,
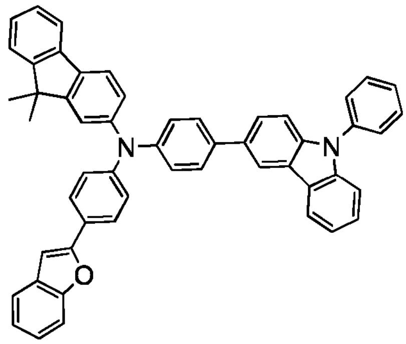,

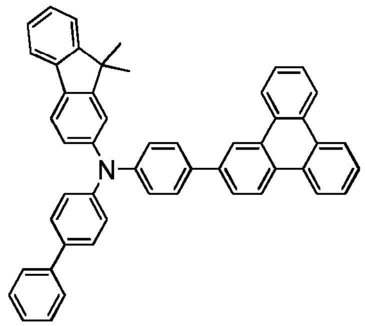,
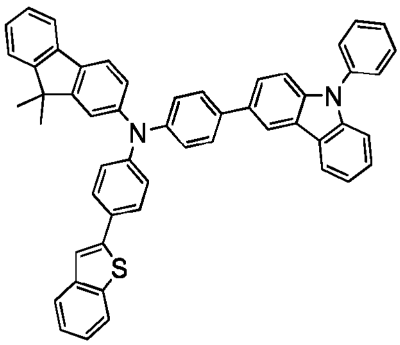,
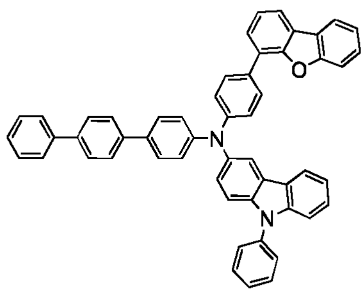,

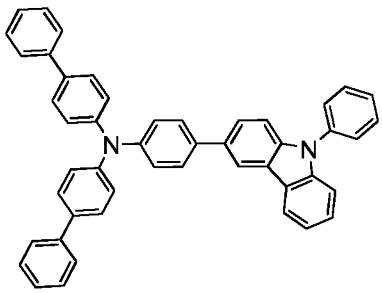,
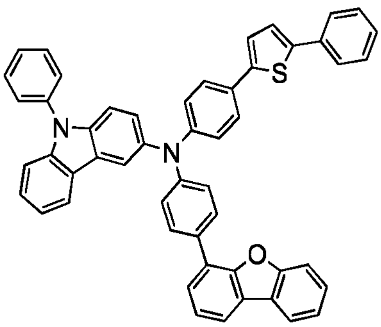,
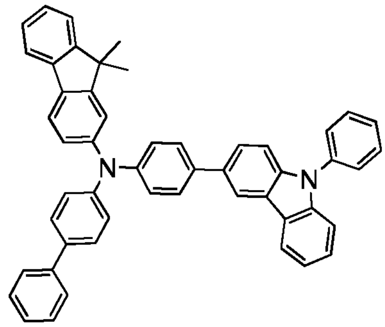,

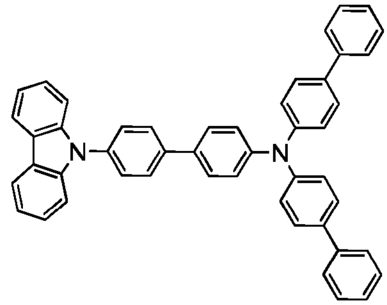,
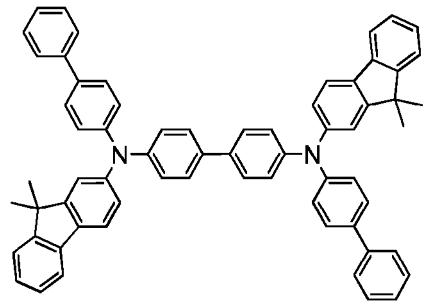,

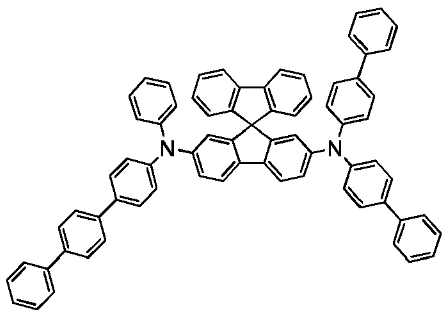,
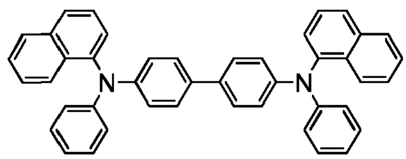,

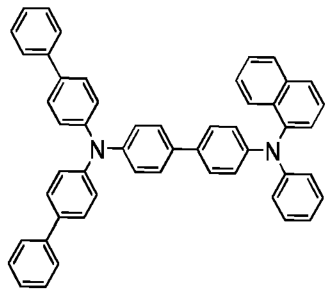,
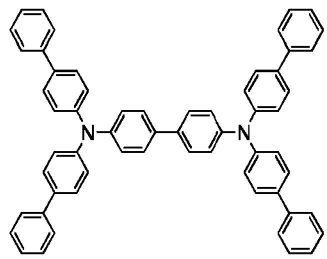,
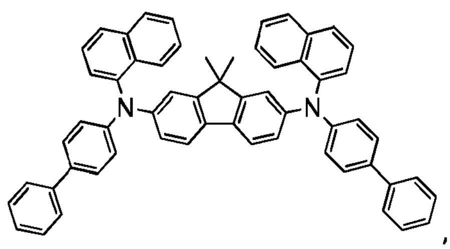,

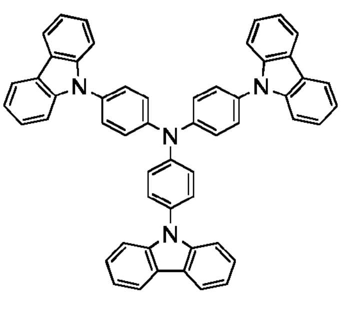,
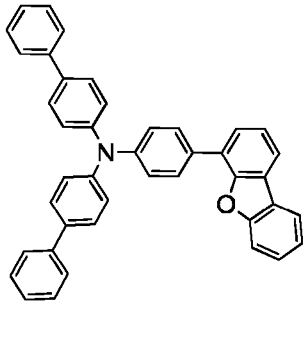,
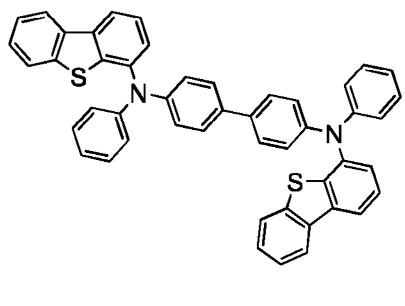,

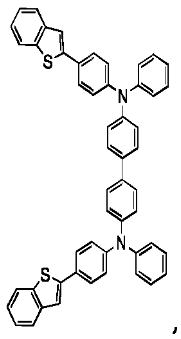

and

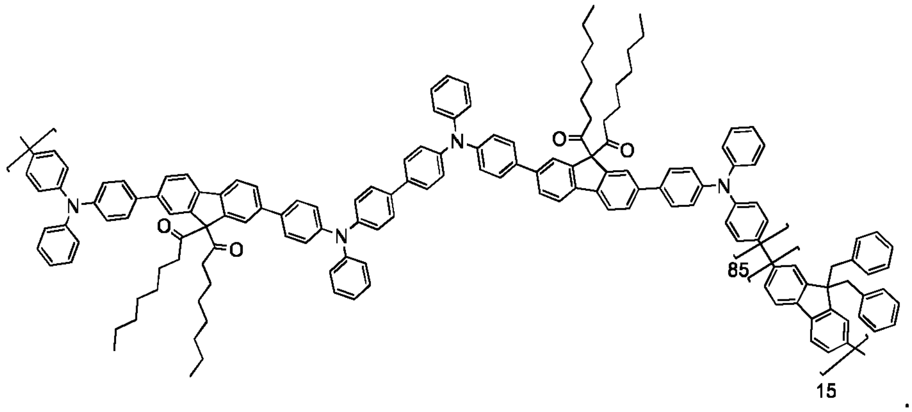

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is greater than that of the dopant. Any host material may be used with any dopant so long as the triplet criteria is satisfied.

Examples of metal complexes used as host are preferred to have the following general formula:

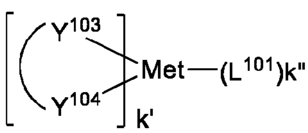

wherein Met is a metal; ($Y^{103}$-$Y^{104}$) is a bidentate ligand, $Y^{103}$ and $Y^{104}$ are independently selected from C, N, O, P, and S; $L^{101}$ is an another ligand; k' is an integer value from 1 to the maximum number of ligands that may be attached to the metal; and k'+k" is the maximum number of ligands that may be attached to the metal.

In one aspect, the metal complexes are:

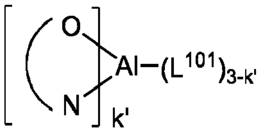 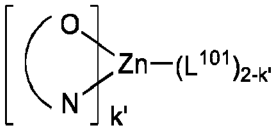

wherein (O-N) is a bidentate ligand, having metal coordinated to atoms O and N.

In another aspect, Met is selected from Ir and Pt. In a further aspect, ($Y^{103}$-$Y^{104}$) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule:

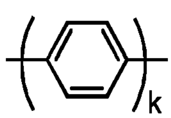, 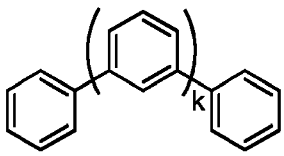, 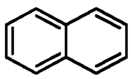, 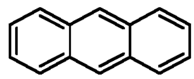, 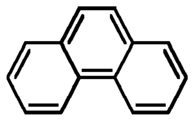,

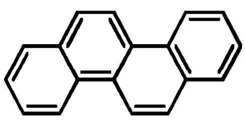, 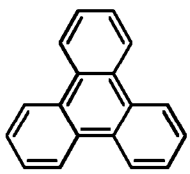, 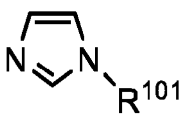, 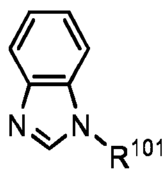, 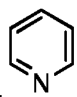, 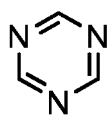,

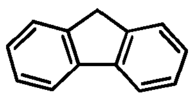,

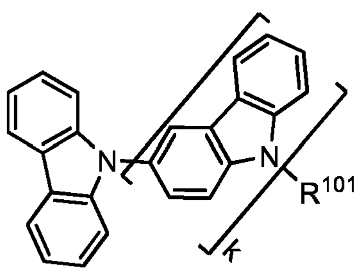, 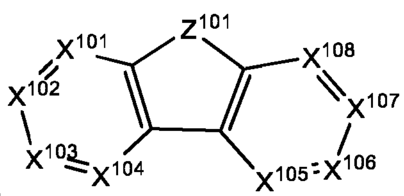, 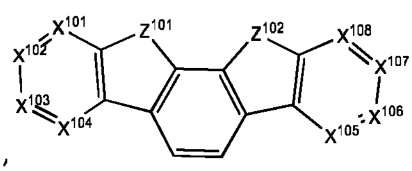,

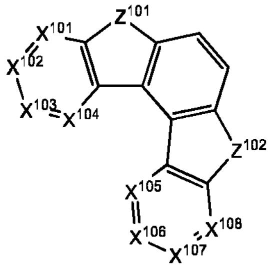,
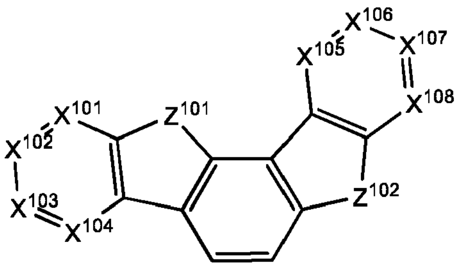,

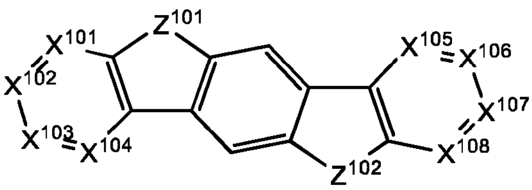, and
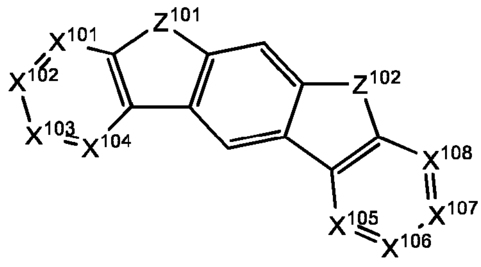,

wherein $R^{101}$ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. $X^{101}$ to $X^{108}$ are independently selected from C (including CH) or N. $Z^{101}$ and $Z^{102}$ are independently selected from $NR^{101}$, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

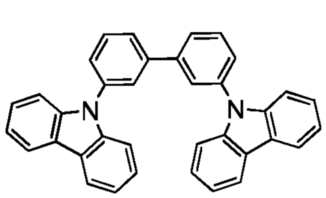,
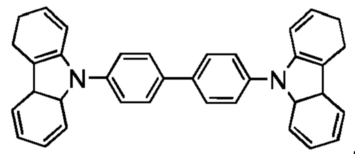,
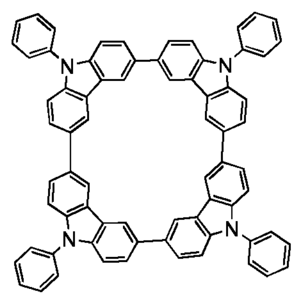,

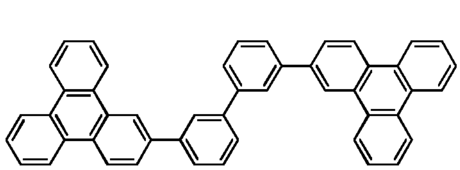,
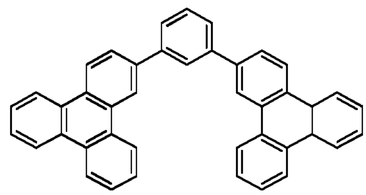,

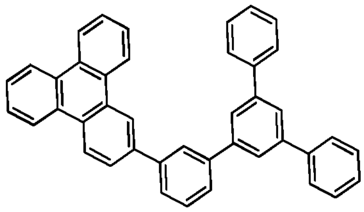,
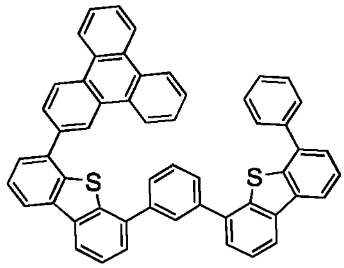,
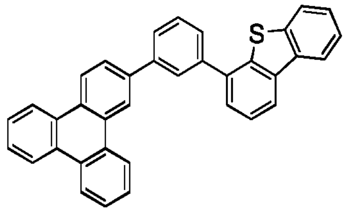,

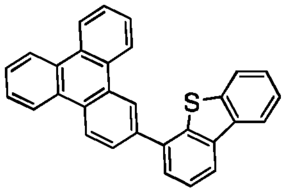,
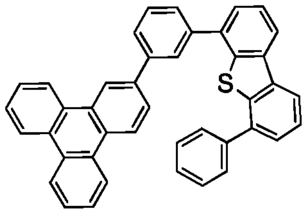,
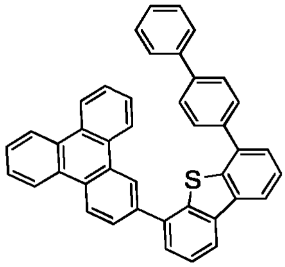,

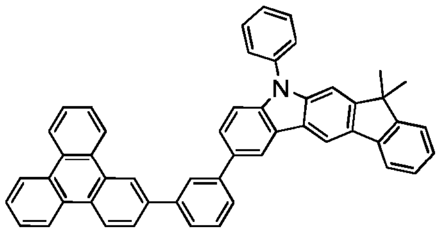,
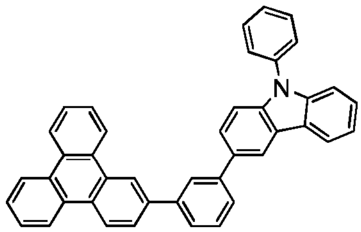,
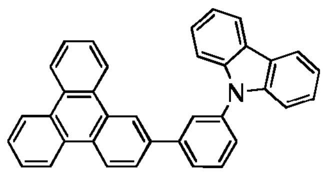,

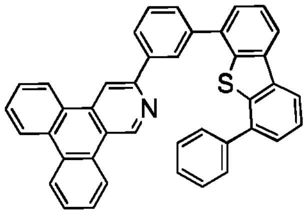,
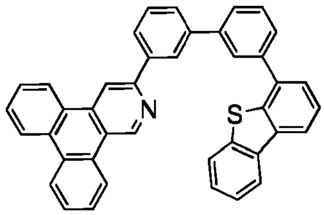,
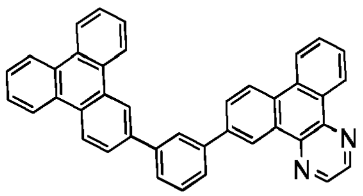,

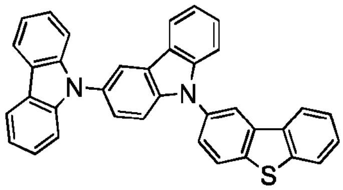,
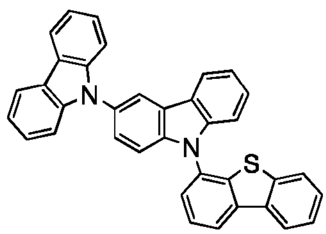,
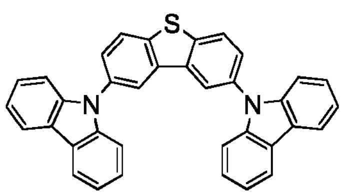,

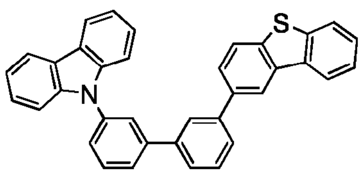,
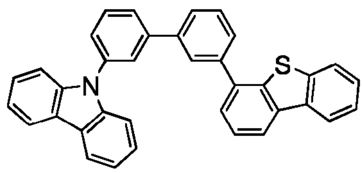,

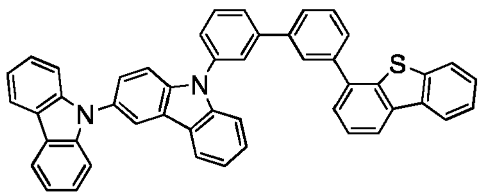
,
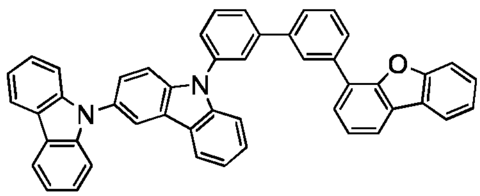
,
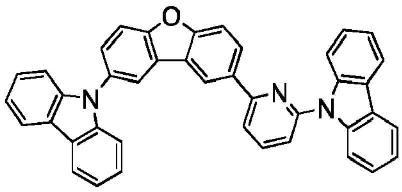
,
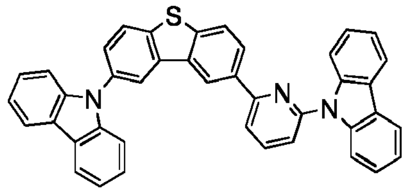
,
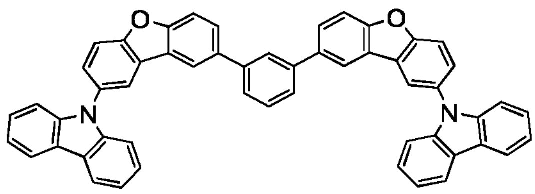
,
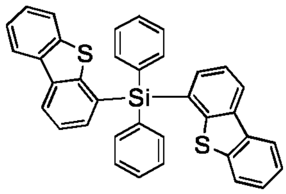
,
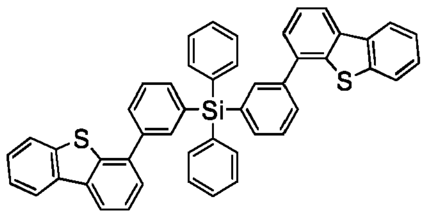
,
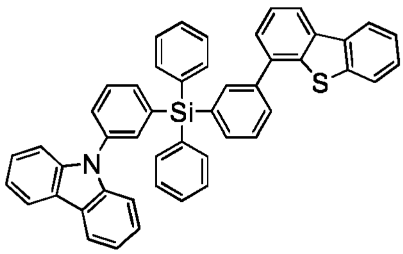
,
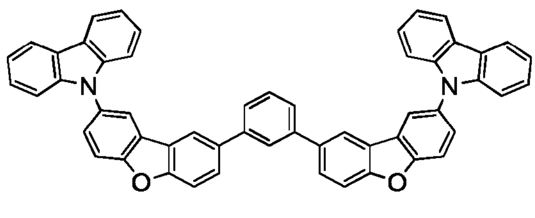
,
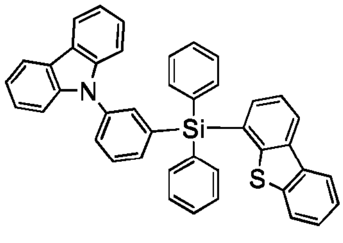
,
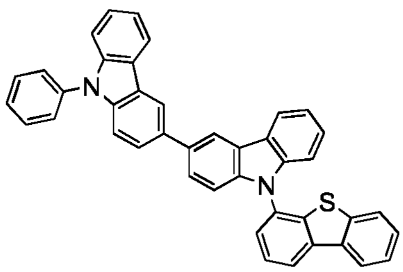
,
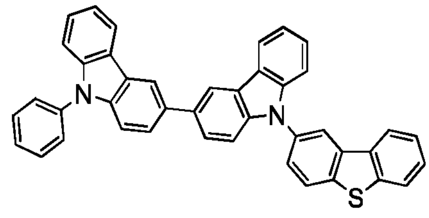
,

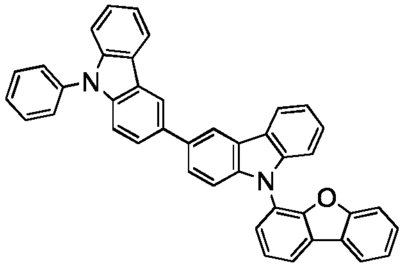,
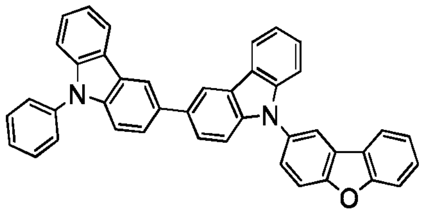,
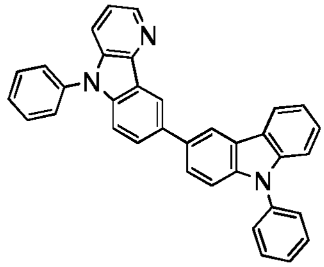,

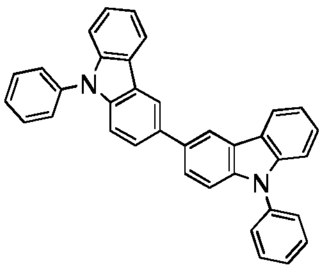,
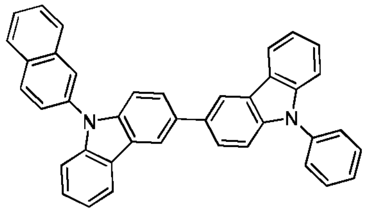,
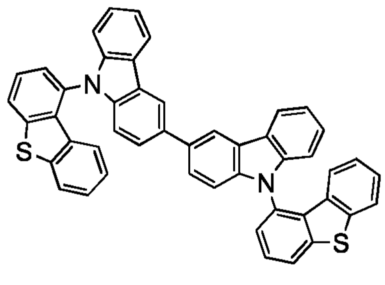,

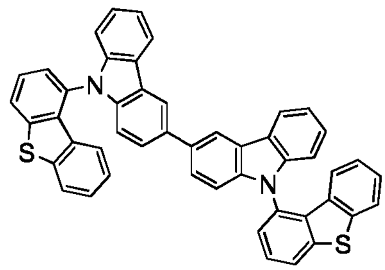,
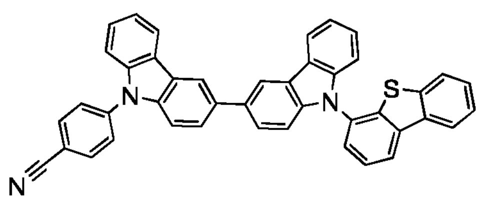,

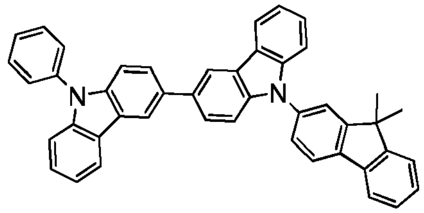,
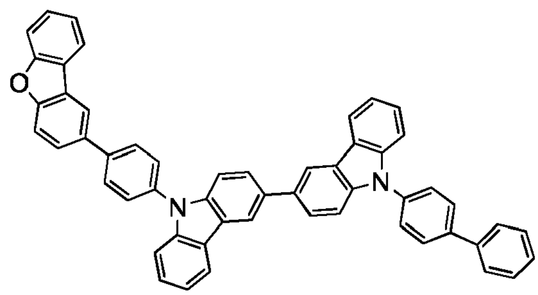,

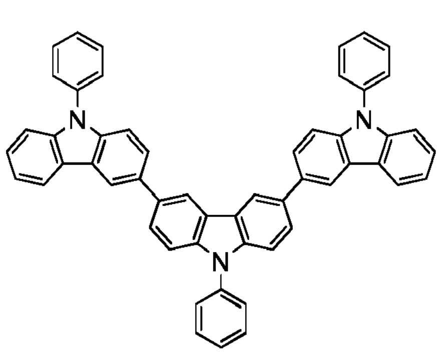,
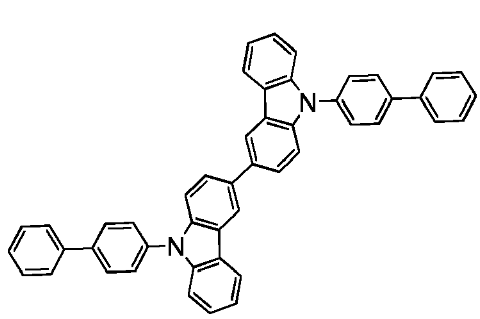,

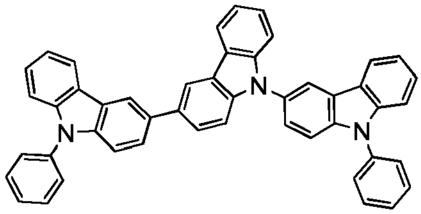,
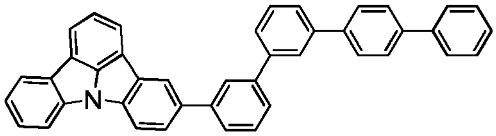,

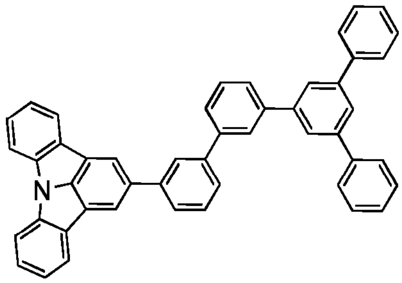,
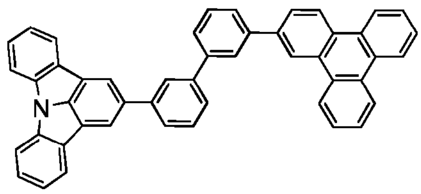,

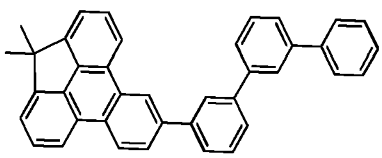,
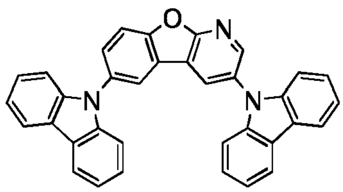,
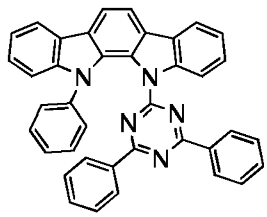,

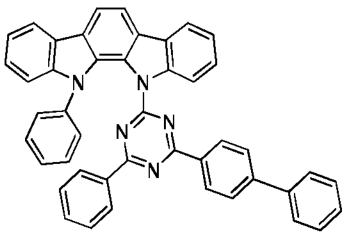,
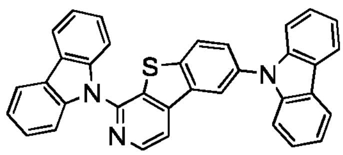,
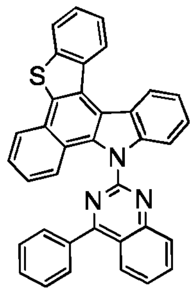,
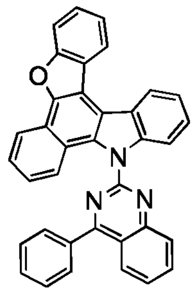,

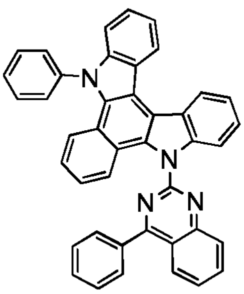,
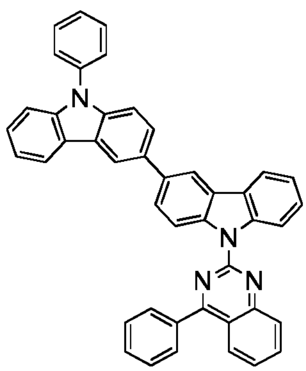,
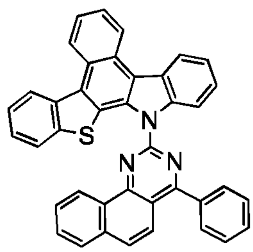,
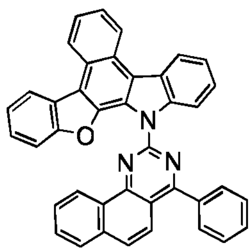,

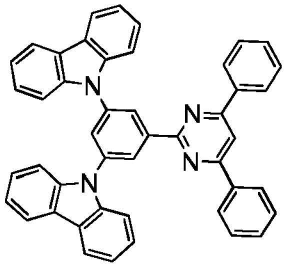,
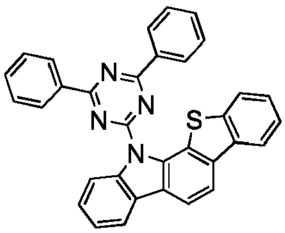,
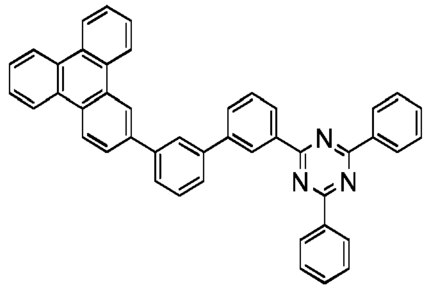,

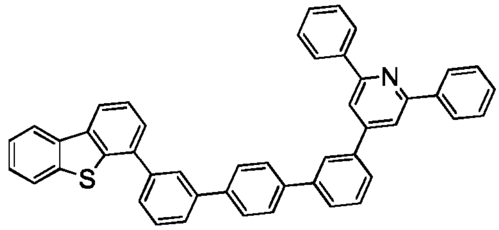,
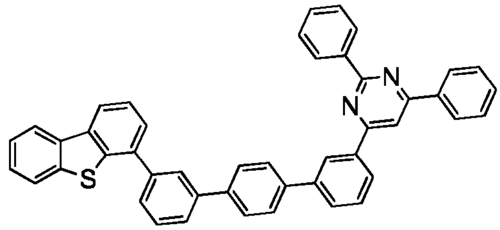,

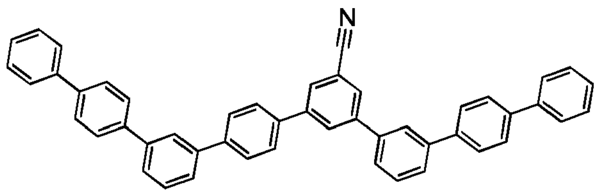,
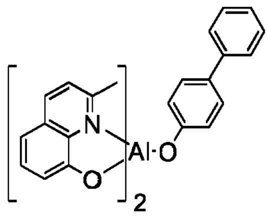,

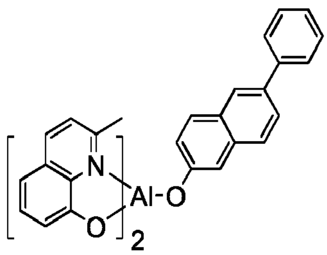,
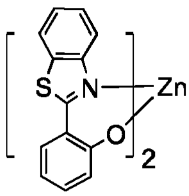,
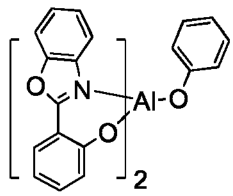,
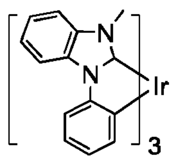,

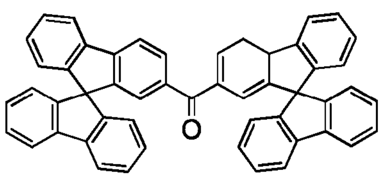,
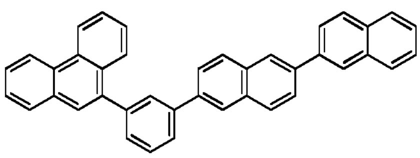,

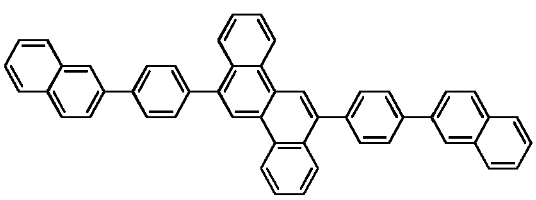, and
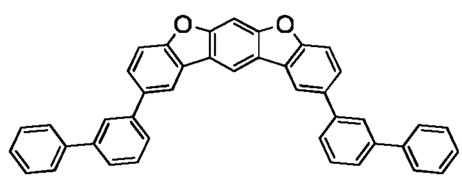.

**e) Additional Emitters:**

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to,

compounds which can produce emissions via phosphorescence, fluorescence, thermally activated delayed fluorescence, i.e., TADF (also referred to as E-type delayed fluorescence), triplet-triplet annihilation, or combinations of these processes. Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, U506916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

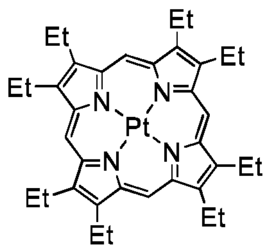 , 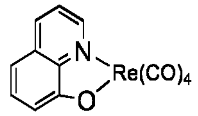 , 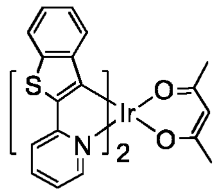 , 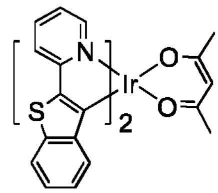 ,

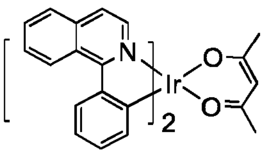 , 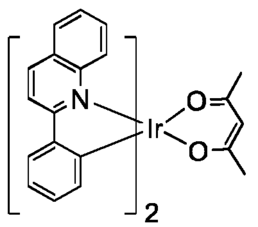 , 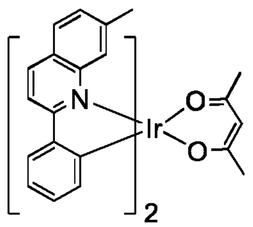 , 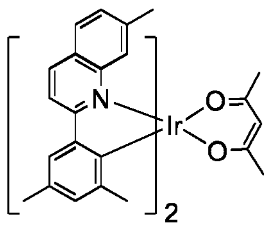 ,

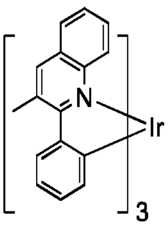 , 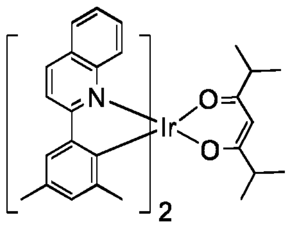 , 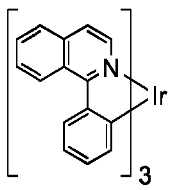 , 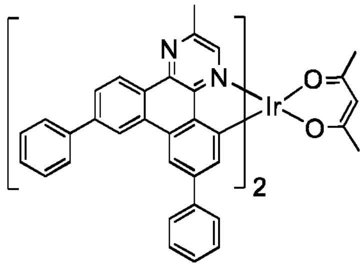 ,

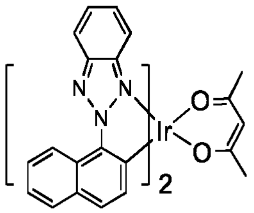, 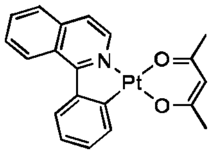, 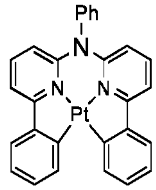, 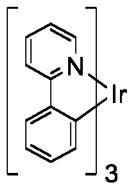, 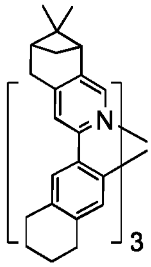, 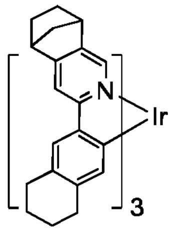

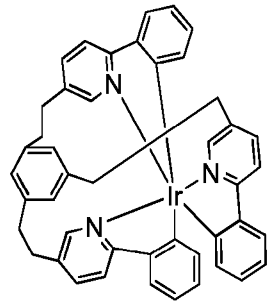, 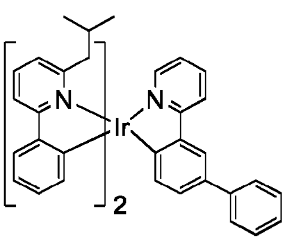, 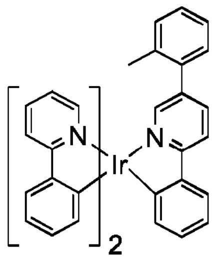, 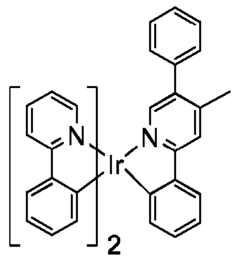,

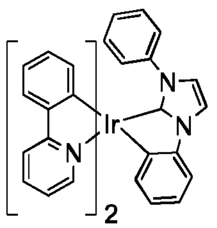, 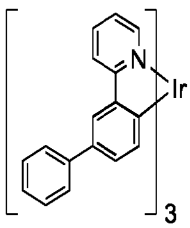, 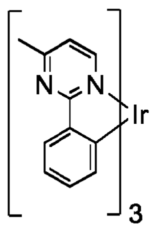, 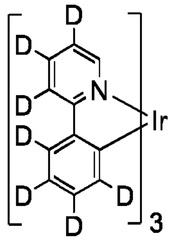, 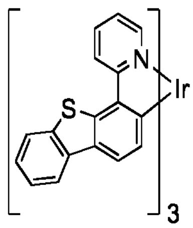,

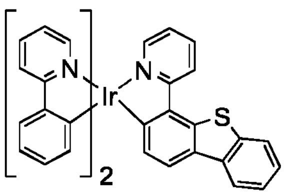, 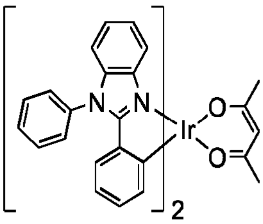, 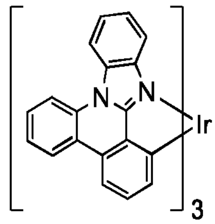, 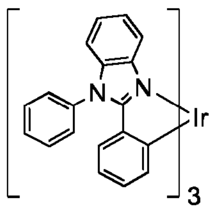,

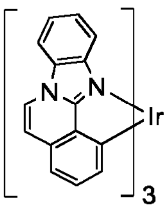, 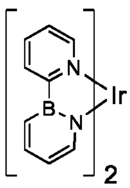, 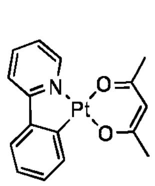, 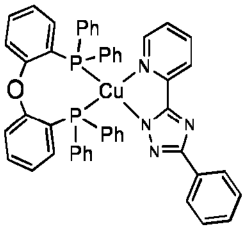, 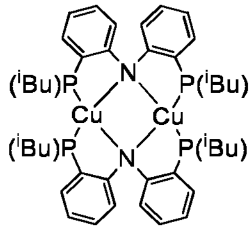,

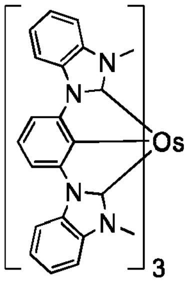, 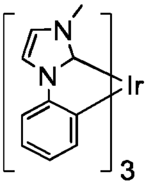, 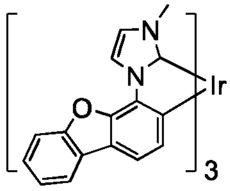, 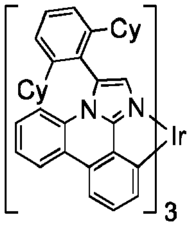, 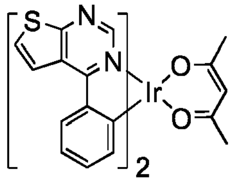,

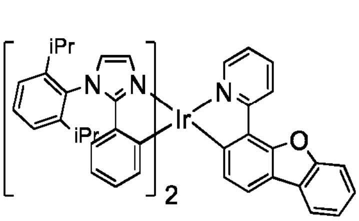, 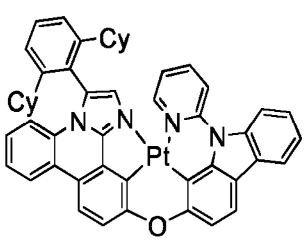, 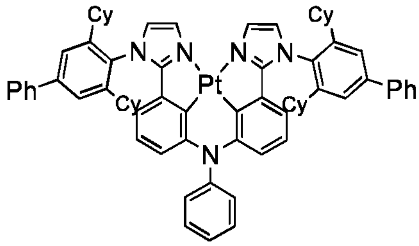,

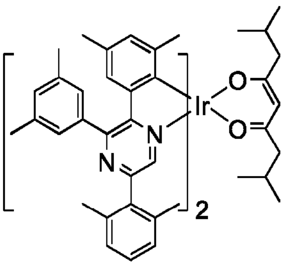, 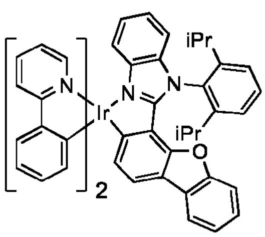, 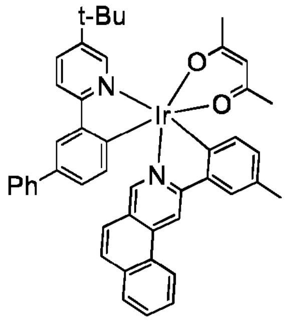, 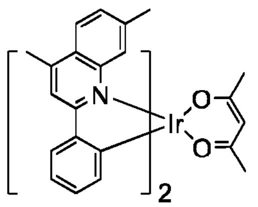,

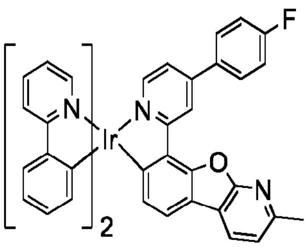, 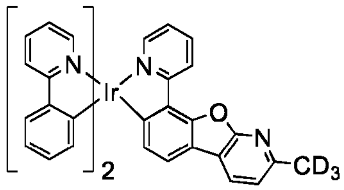, 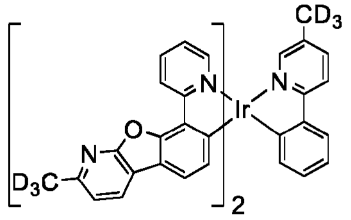,

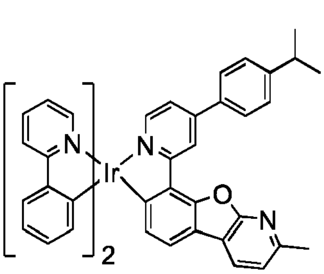, 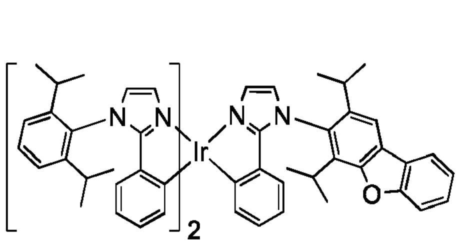, 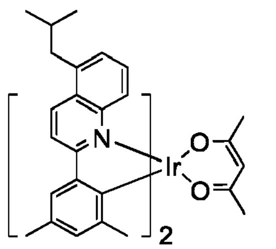,

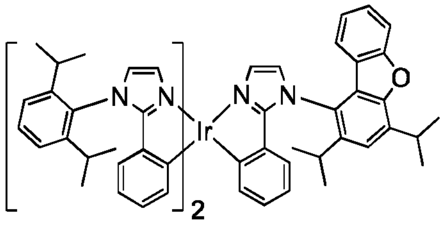 , 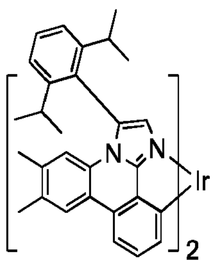 , 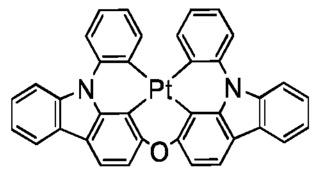 ,

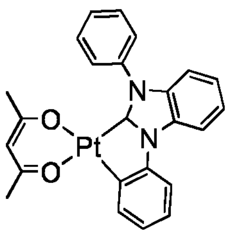 , 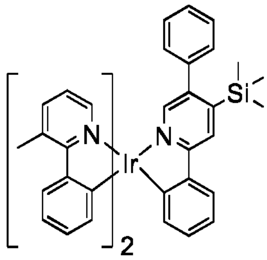 , 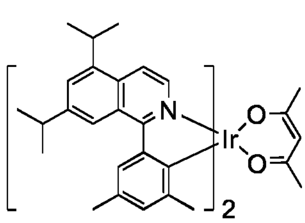 , 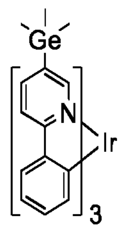 ,

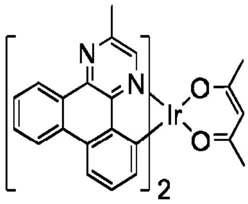 , 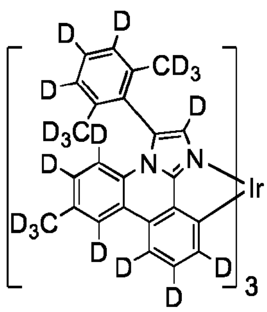 , 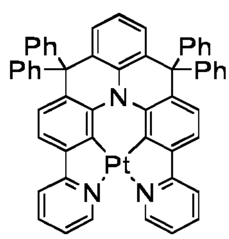 , 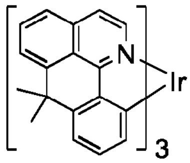 ,

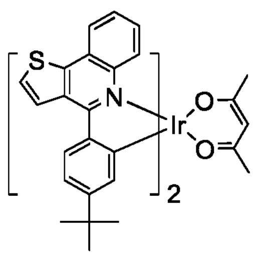 , 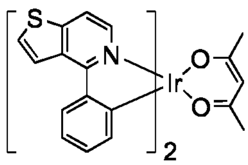 , 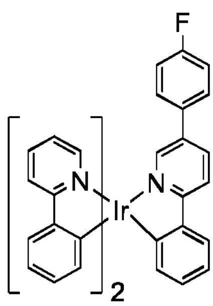 , 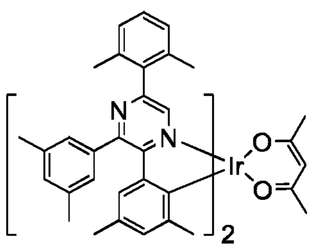 ,

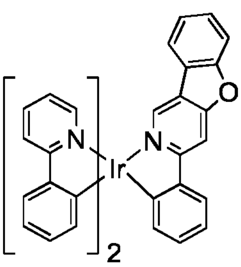 , 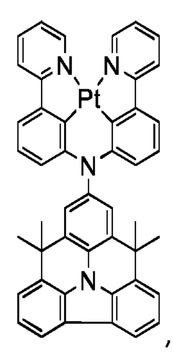 , 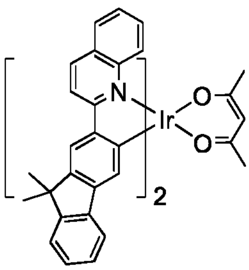 , 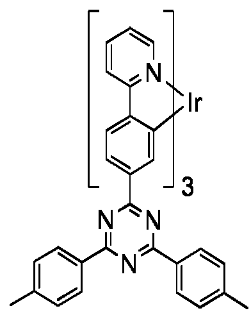 ,

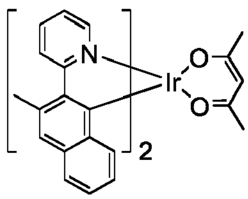,
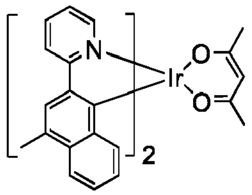,
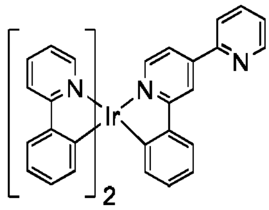,
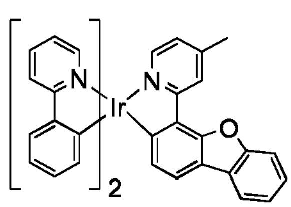,

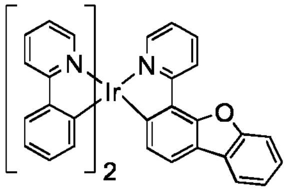,
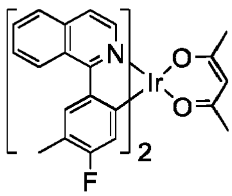,
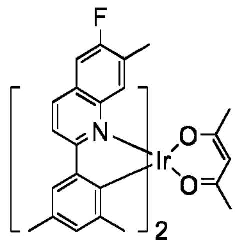,
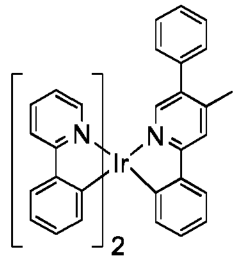,

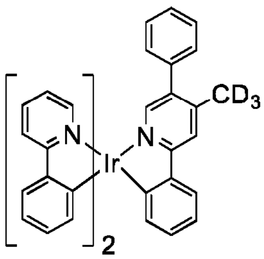,
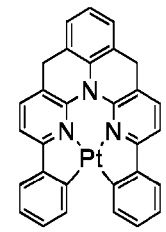,
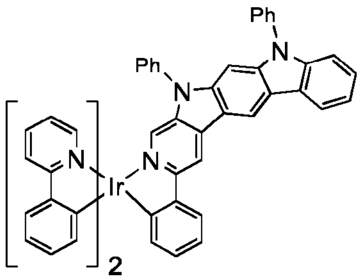,
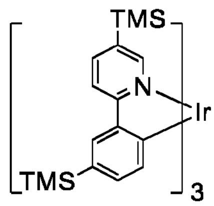,

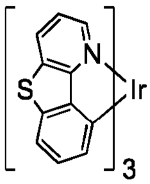,
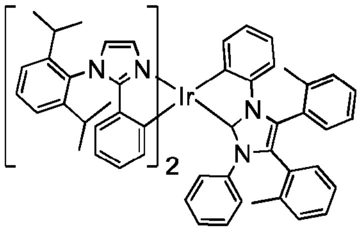,
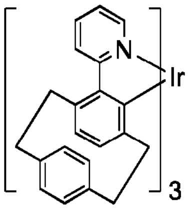,
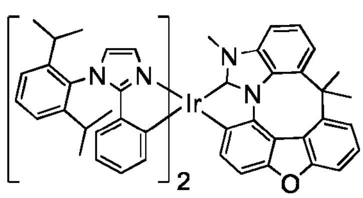,

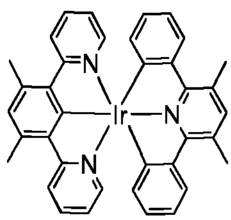,
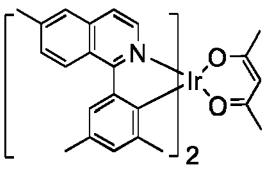,
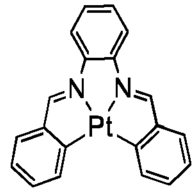,
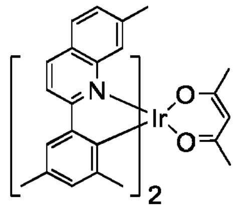,

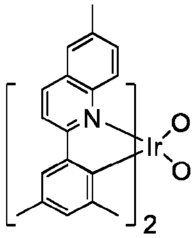,
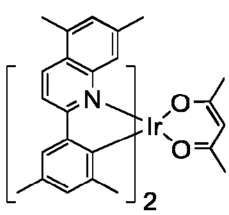,
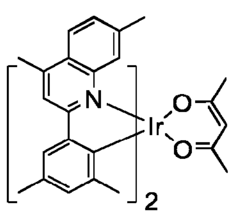,
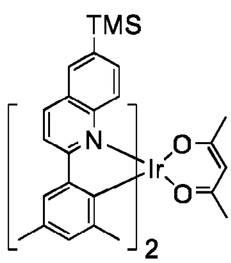,

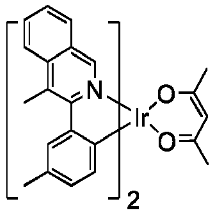 , 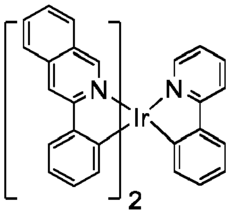 , 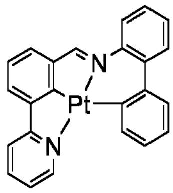 , 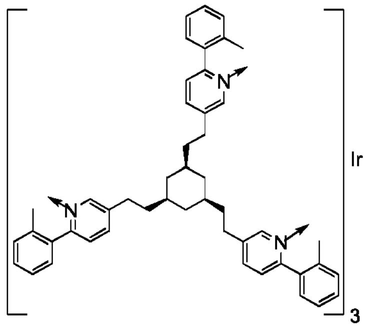 ,

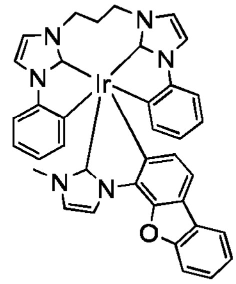 , 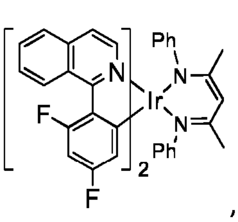 , 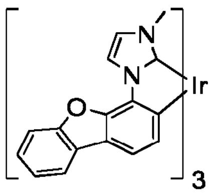 , 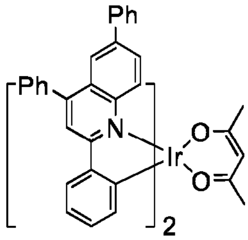 , 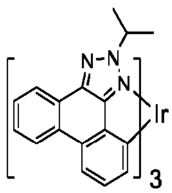 ,

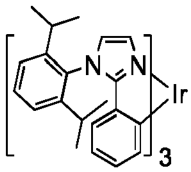 , 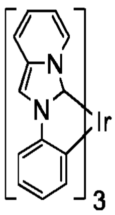 , 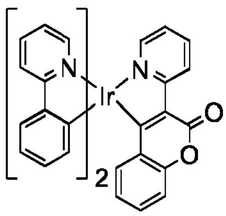 , 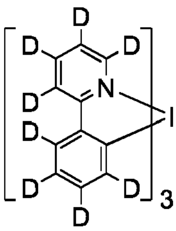 , 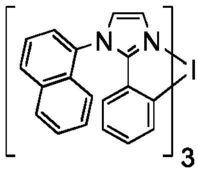 ,

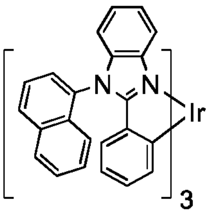 , 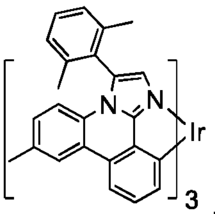 , 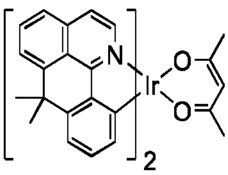 , 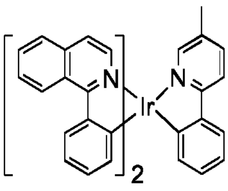 , 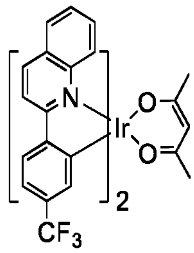 ,

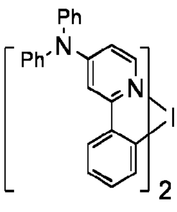 , and 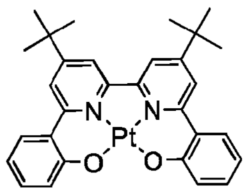 .

**f) HBL:**

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL

interface.

In one aspect, compound used in HBL contains the same molecule or the same functional groups used as host described above.

In another aspect, compound used in HBL contains at least one of the following groups in the molecule:

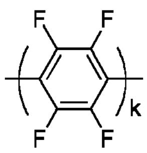 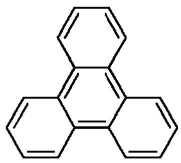 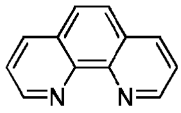 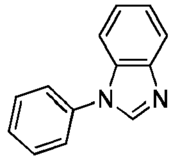 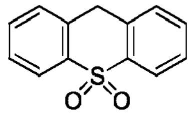 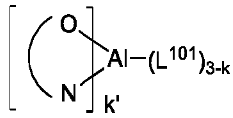

wherein k is an integer from 1 to 20; $L^{101}$ is another ligand, k' is an integer from 1 to 3.

**g) ETL:**

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule:

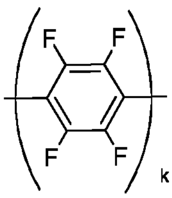 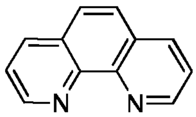 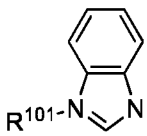 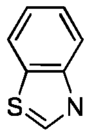 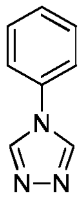 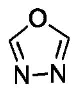 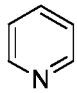 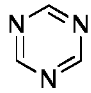

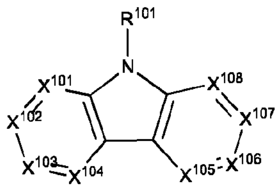 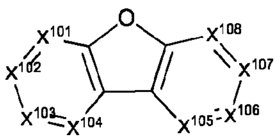 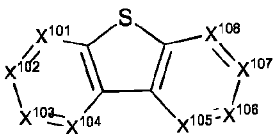 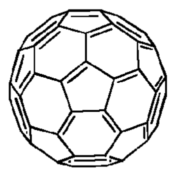 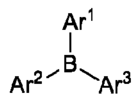

wherein $R^{101}$ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. $Ar^1$ to $Ar^3$ has the similar definition as Ar's mentioned above. k is an integer from 1 to 20. $X^{101}$ to $X^{108}$ is selected from C (including CH) or N.

In another aspect, the metal complexes used in ETL contains, but not limit to the following general formula:

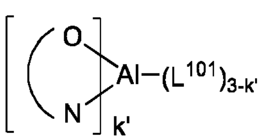 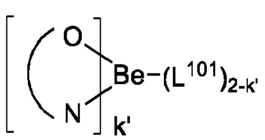 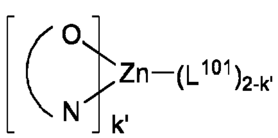 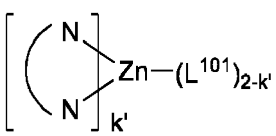

wherein (O-N) or (N-N) is a bidentate ligand, having metal coordinated to atoms O, N or N, N; $L^{101}$ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956,

WO2007111263, WO2009148269, WO2010067894, WO2010072300, WO2011074770, WO2011105373, WO2013079217, WO2013145667, WO2013180376, WO2014104499, WO2014104535,

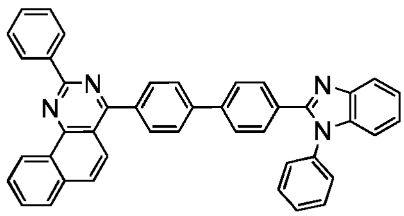
,
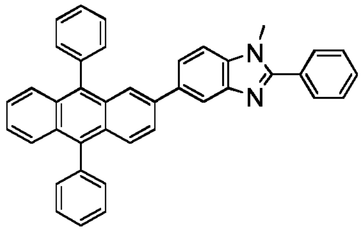
,
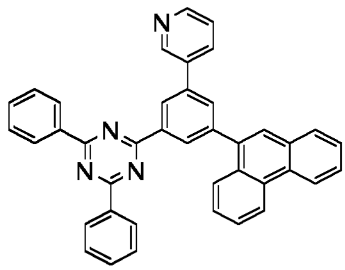
,

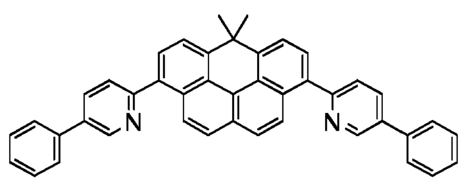
,
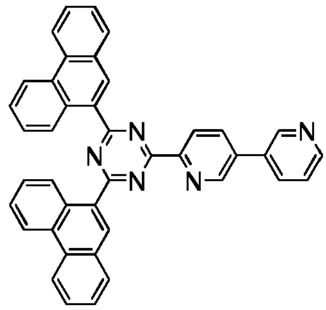
,
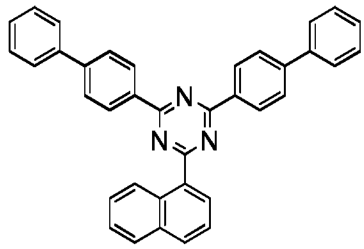
,

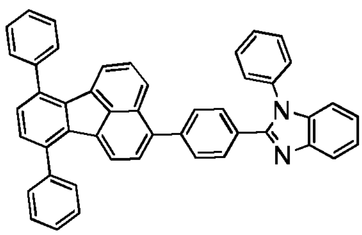
,
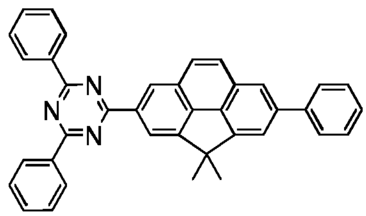
,
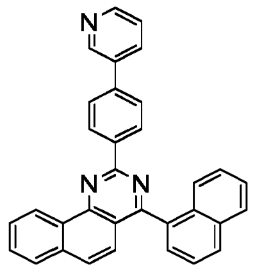
,

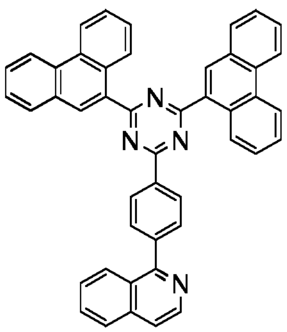
,
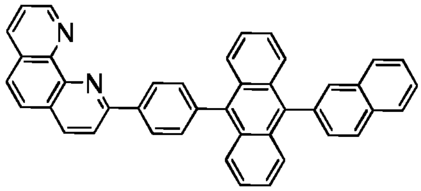
,
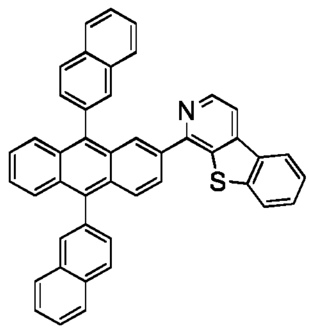
,

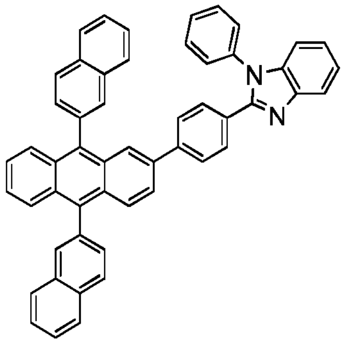
,
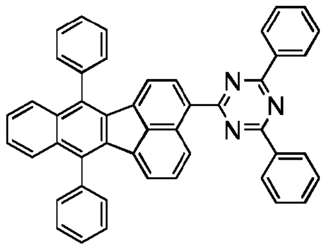
,
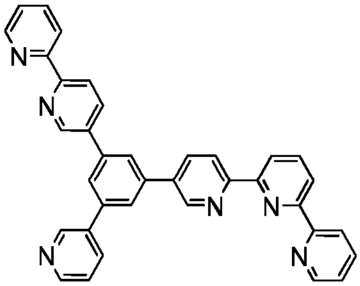
,

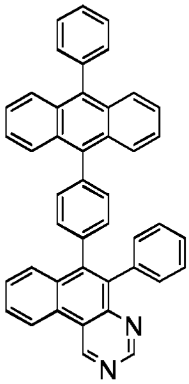
,
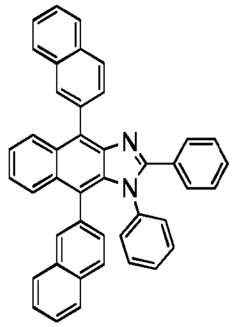
,
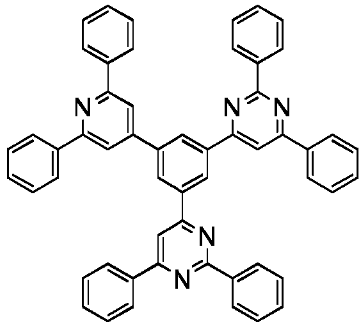
,
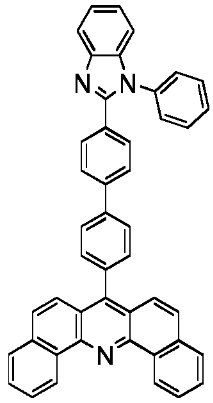
,

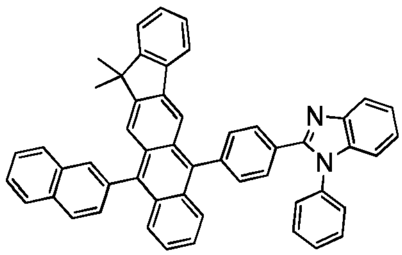
,
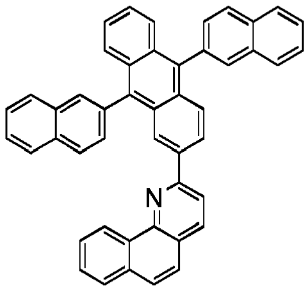
,
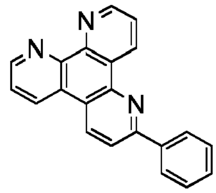
,

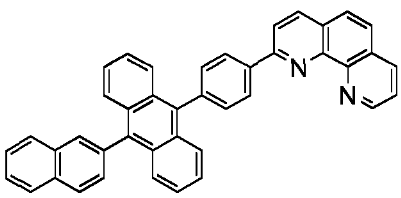
,
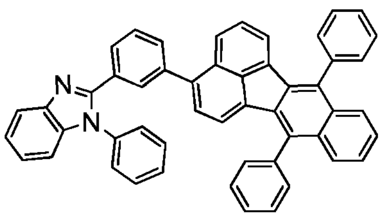
,

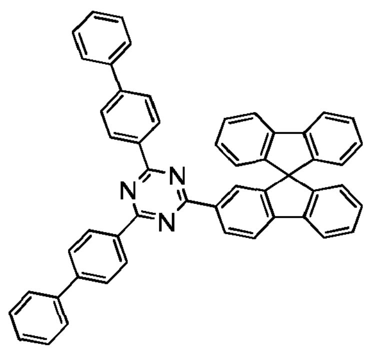
,

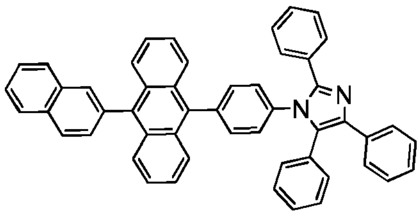,
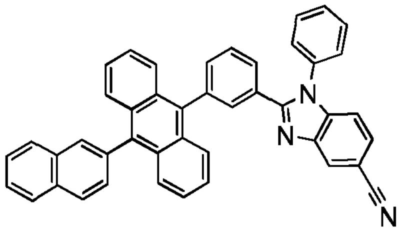,
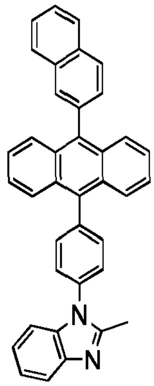,
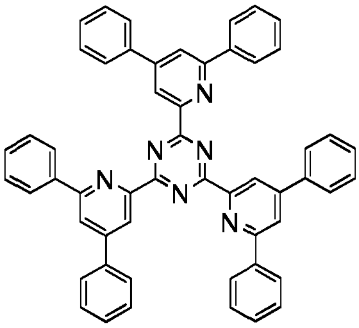,
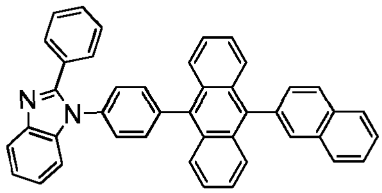,
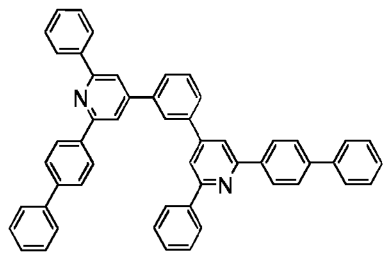,
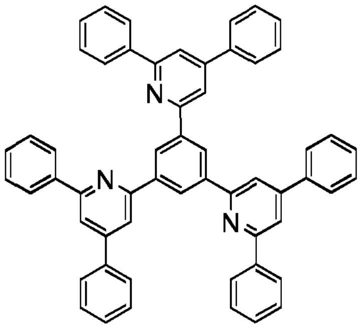,
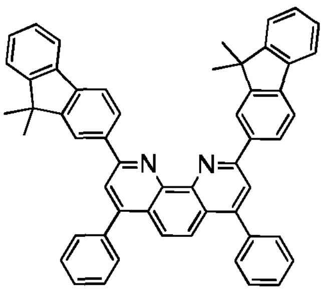, and
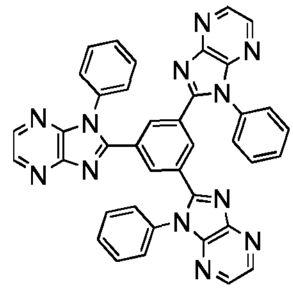.

**h) Charge generation layer (CGL)**

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

## E. Experimental Data

In order to determine VDR, films for angle dependent photoluminescence were fabricated by vacuum thermal evaporation of 50Å of an optional layer of H2 followed by 400Å of H1 or H3 doped with 3-5% of the emitter on UV-ozone pretreated glass substrates. The polarized angle dependent photoluminescence is then measured using a Fluxim Phelos system with a 340 nm or 405 nm excitation source and fit with Setfos software yielding the VDR. The Phelos spectral intensity versus angle is obtained by integrating the wavelength regime over a range which excludes the excitation source scatter.

The fit routine within Setfos is as follows. The optical stack is set up identical to the experiment with a 0.7 mm glass substrate into which the emission is measured, a 40 nm EML film with the emitter, and air as the last later. The emitter distribution is set as exponential with a position at the top air-EML interface and a width of 50 nm. The integrated p-polarized and s-polarized spectral intensities vs. angle are used as the input targets for the Setfos fit/optimization routine. The fit parameters of the optimization are the: emitter orientation (VDR), emission intensity, and EML refractive index. The resulting VDR from this fit is the reported value where VDR = vertical dipole ratio (0.33 is random, anything less than 0.33 is net horizontally aligned).

Table 6

| **Emitter, %** | **Host** | **Underlayer (if any)** | **VDR** |
|---|---|---|---|
| E1 | H1, 5% | | 0.43 |
| E2 | H1, 5% | | 0.42 |
| E3 | H3, 3% | H2 | 0.46 |
| E4 | H1, 5% | | 0.50 |
| E5 | H1, 5% | | 0.44 |
| E6 | H1, 5% | | 0.46 |
| E7 | H1, 5% | | 0.41 |
| E8 | H1, 5% | | 0.53 |
| E9 | H1, 5% | | 0.46 |
| E10 | H3, 3% | H2 | 0.55 |
| E11 | H3, 3% | H2 | 0.52 |
| E12 | H1, 5% | | 0.57 |
| E13 | H1, 5% | | 0.50 |
| E14 | H1, 5% | | 0.48 |
| E15 | H1, 5% | | 0.51 |
| E16 | H1, 5% | | 0.56 |
| E17 | H1, 5% | | 0.60 |
| E18 | H1, 5% | | 0.65 |
| E19 | H1, 5% | | 0.61 |
| E20 | H1, 5% | | 0.50 |
| E21 | H1, 5% | | 0.58 |
| E22 | H1, 5% | | 0.43 |
| E23 | H1, 5% | | 0.43 |
| E24 | H1, 5% | | 0.52 |
| E25 | H1, 5% | | 0.55 |
| E26 | H1, 5% | | 0.52 |
| E27 | H1, 5% | | 0.64 |
| E28 | H1, 5% | | 0.43 |

(continued)

| Emitter, % | Host | Underlayer (if any) | VDR |
|---|---|---|---|
| E29 | H1, 5% | | 0.52 |
| E30 | H1, 5% | | 0.50 |
| E31 | H1, 5% | | 0.48 |
| E32 | H1, 5% | | 0.47 |
| E33 | H1, 5% | | 0.54 |
| E34 | H1, 5% | | 0.52 |
| E35 | H1, 5% | | 0.62 |
| E36 | H1, 5% | | 0.64 |
| E37 | H1, 5% | | 0.53 |
| E38 | H1, 5% | | 0.64 |
| E39 | H1, 5% | | 0.74 |
| E40 | H1, 5% | | 0.47 |
| E41 | H1, 5% | | 0.65 |
| E42 | H1, 5% | | 0.67 |
| E43 | H1, 5% | | 0.56 |
| $Ir(ppy)_3$ (CE) | H1, 5% | | 0.32 |

Where the structures for E1-43 and H1-3 are as follows:

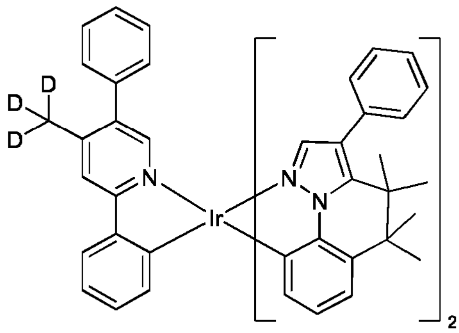

E1,

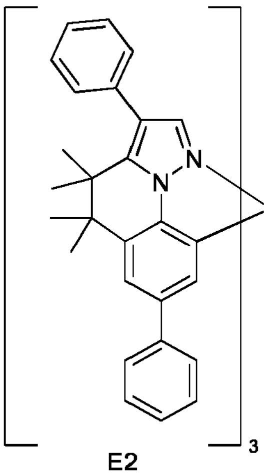

E2,

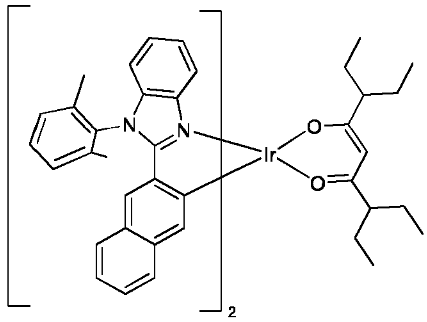

E3,

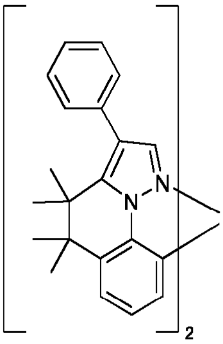

E4 ,

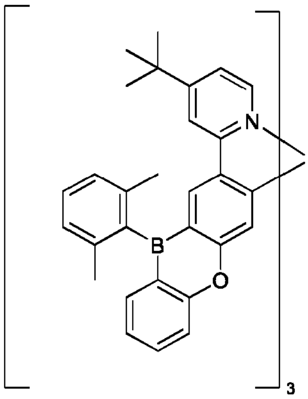

E5 ,

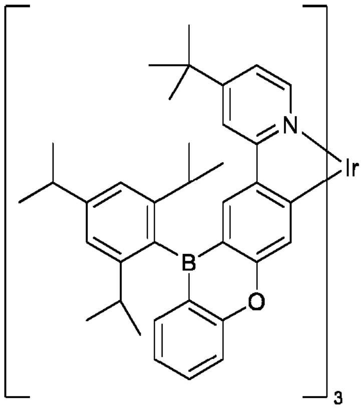

E6 ,

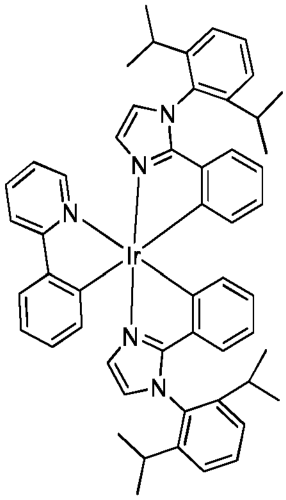

E7 ,

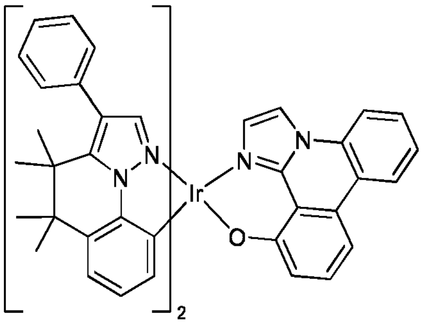

E8 ,

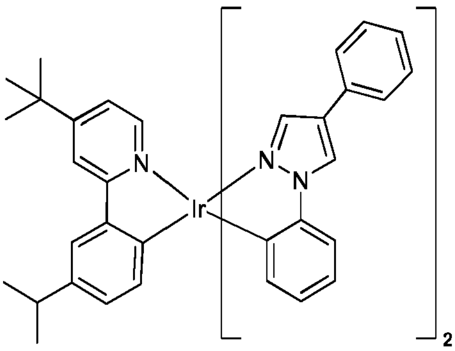

E9 ,

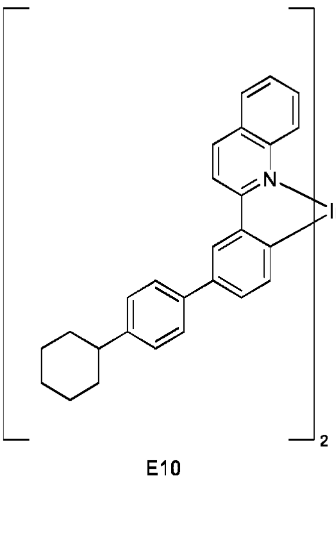

E10 ,

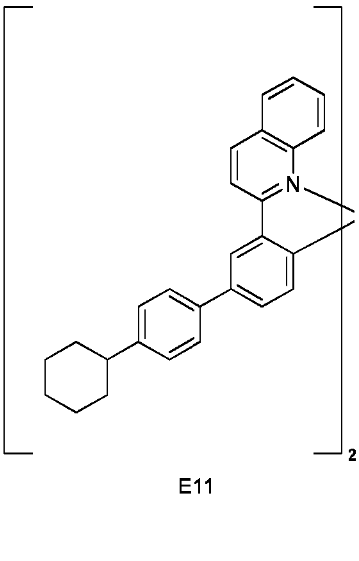

E11 ,

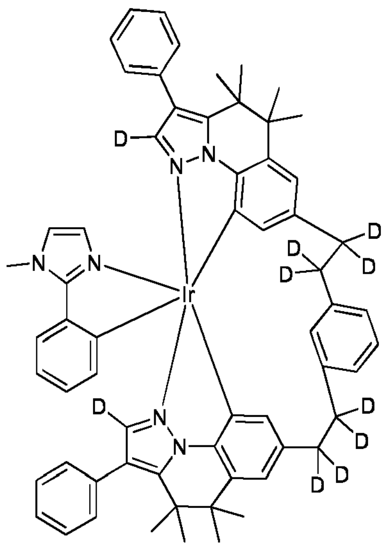

E12 ,

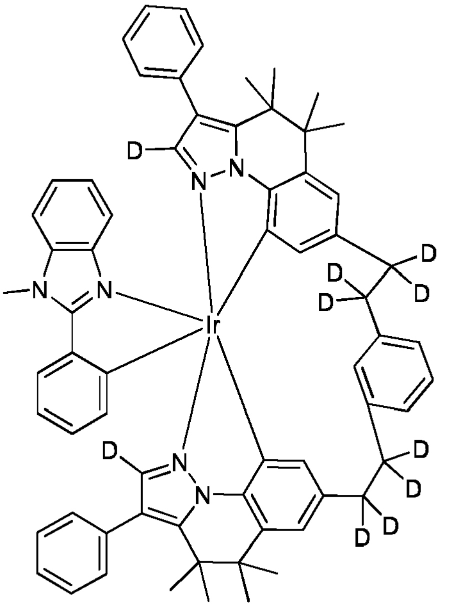

E13 ,

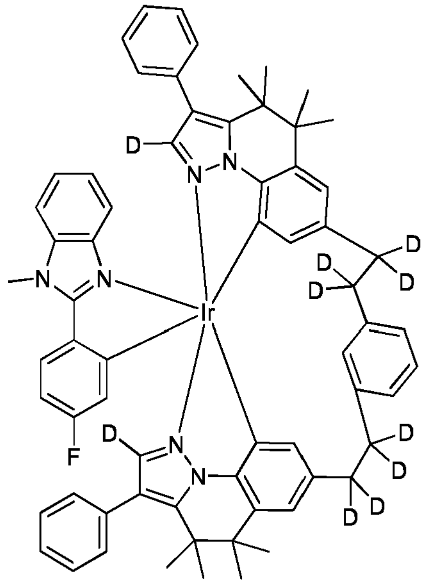

E14 ,

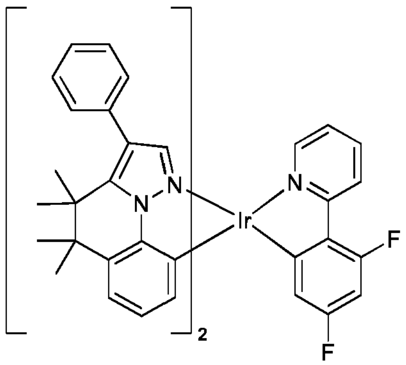

E15 ,

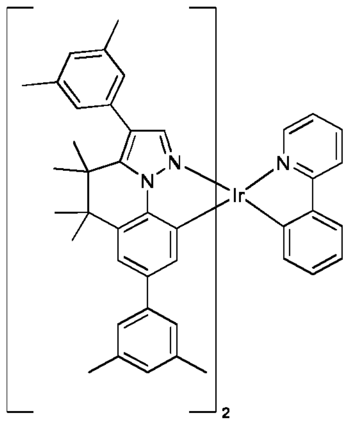

E16

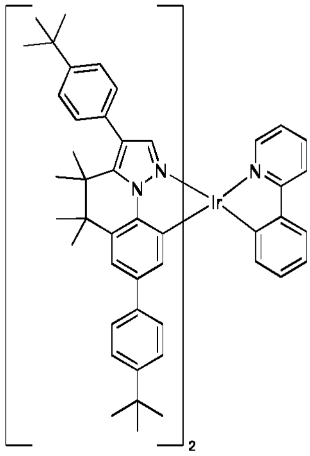

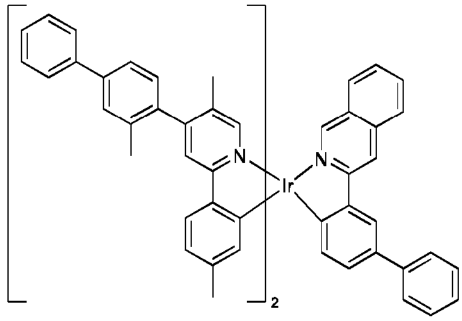

, E17 , E18 ,

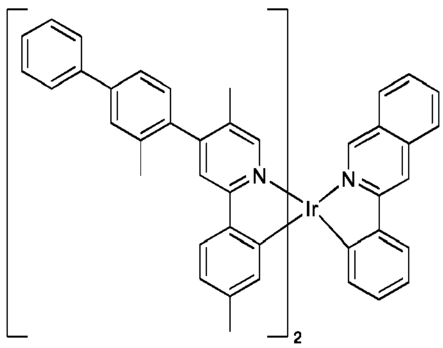

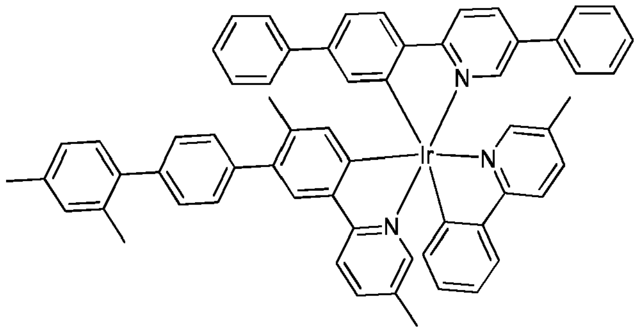

E19 , E20 ,

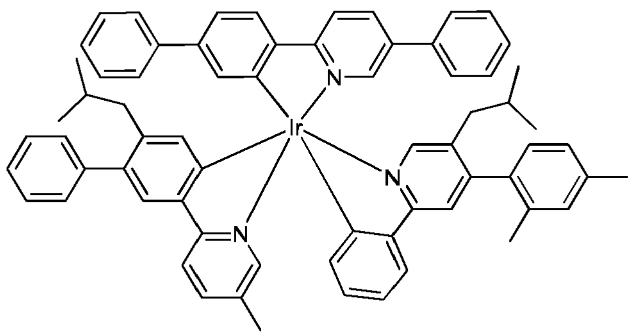

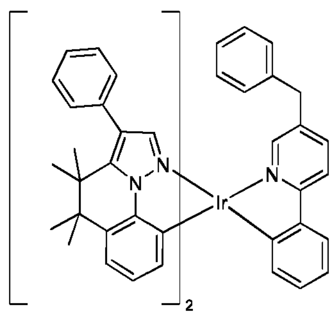

E21 , E22 ,

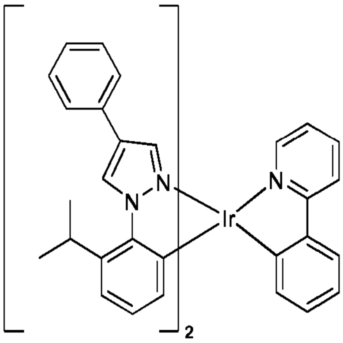

E23 ,

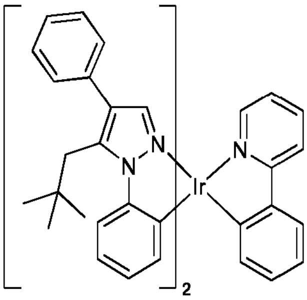

E24 ,

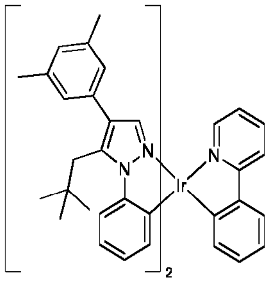

E25 ,

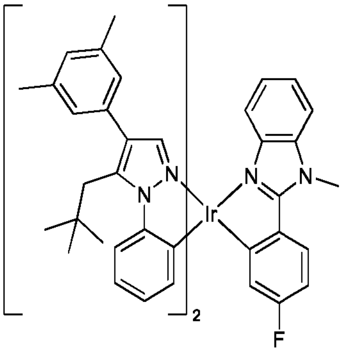

E26 ,

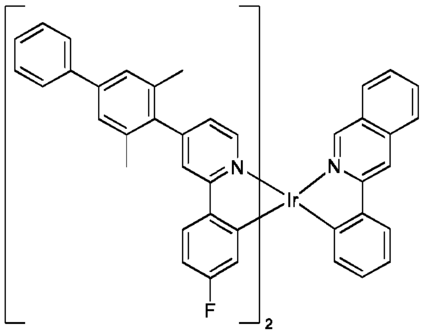

E27 ,

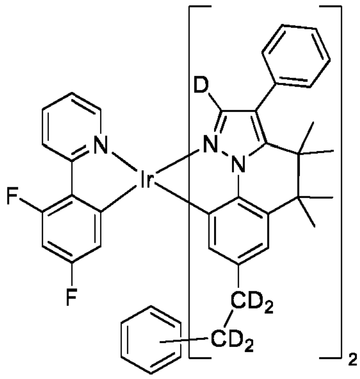

E28

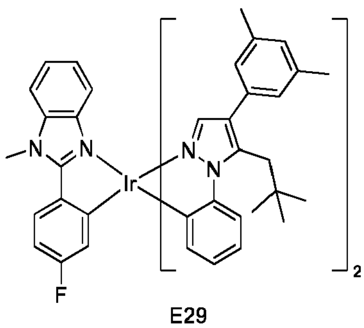

E29

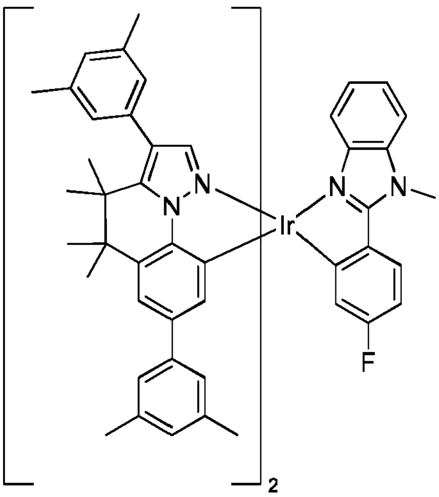

E30

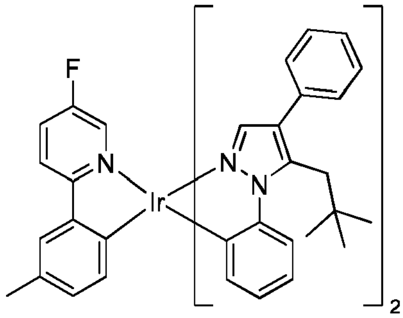

E31

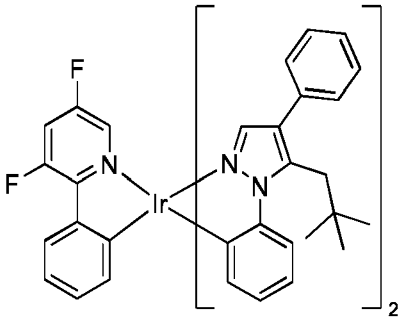

E32

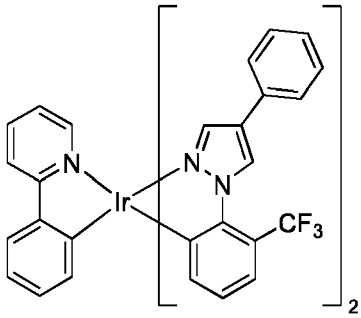

E33

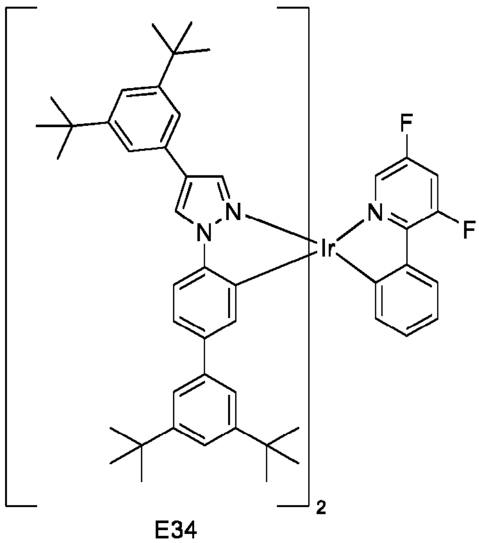

E34

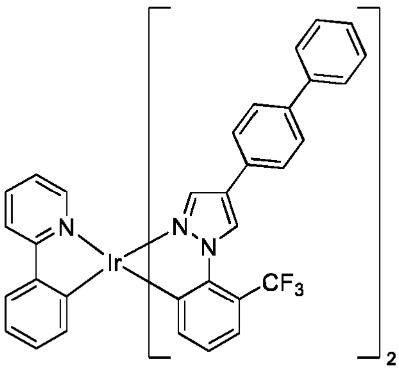

E35

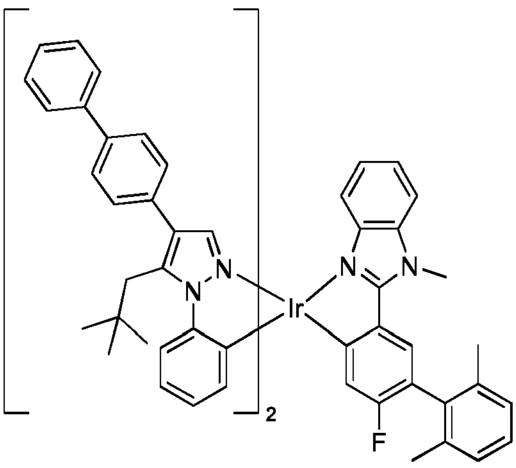

E36

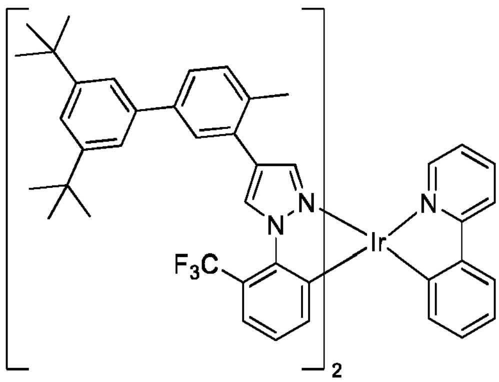

E37

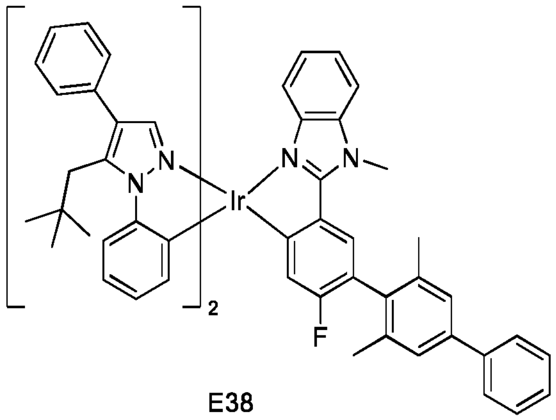

E38

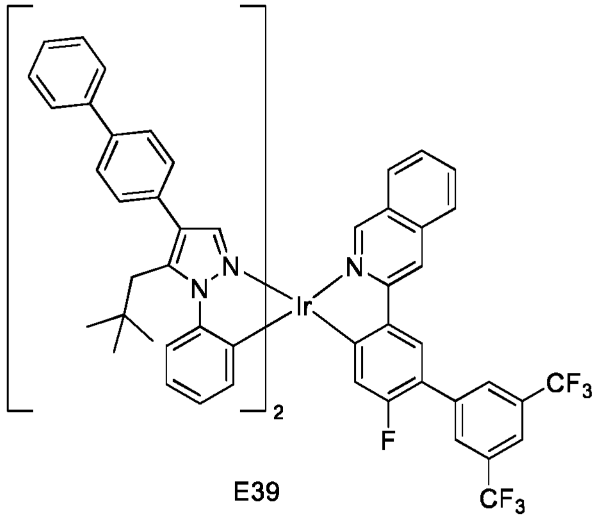

E39

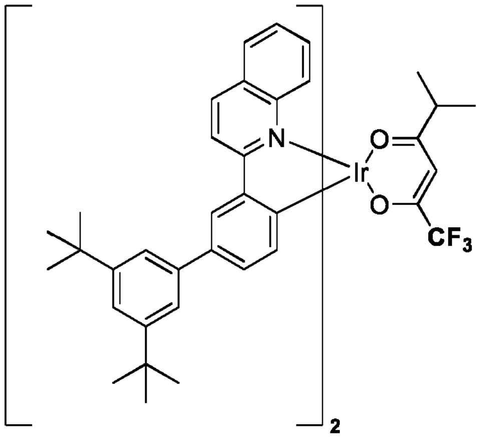

E40

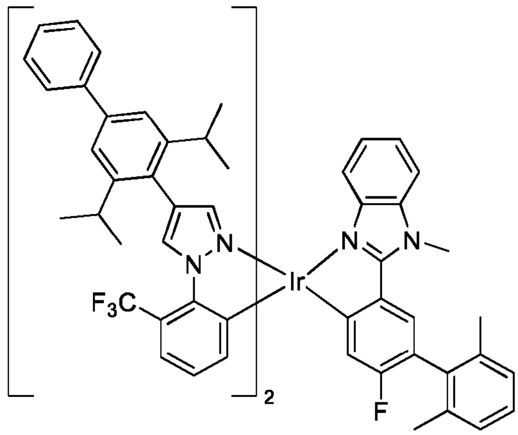

E41

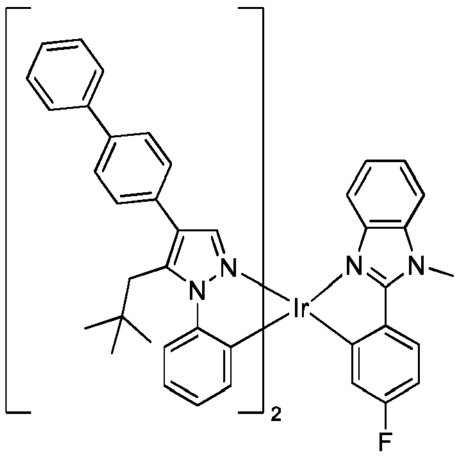

E42

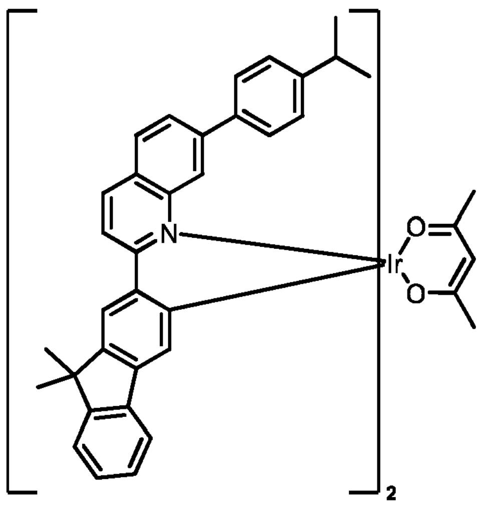

E43

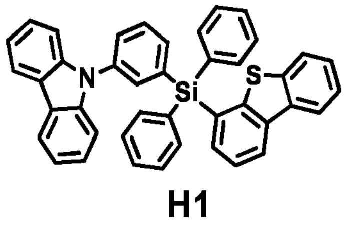
H1,

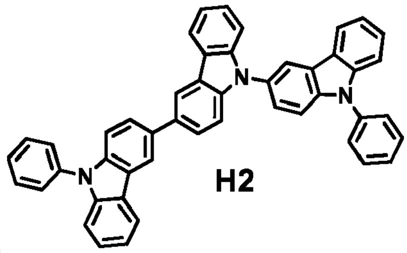
H2,

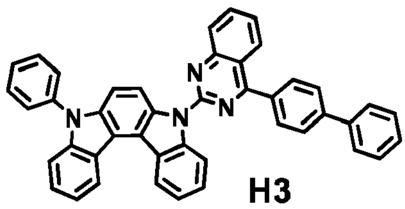
H3.

These experimental VDR results in Table 6 are representative of the criteria claimed herein to achieve >0.33 VDR complexes, as compared to the comparative example (CE) listed in the table.

**Synthetic Examples**

Synthesis of 5-fluoro-2-(m-tolyl)pyridine:

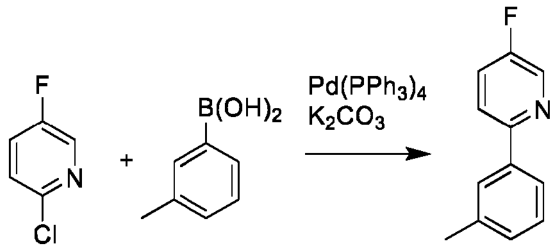


2-chloro-5-fluoropyridine (3.90 g, 3.000 mL, 1 Eq, 29.7 mmol), m-tolylboronic acid (6.05 g, 1.5 Eq, 44.5 mmol), $Pd(PPh_3)_4$ (1.71 g, 0.05 Eq, 1.48 mmol), and potassium carbonate (8.20 g, 2 Eq, 59.3 mmol) were combined in dioxane (75.00 mL) and water (25.00 mL) and heated at reflux for 16 hours. The mixture was diluted with water and brine and extracted with EtOAc. After drying and condensing under vacuum the mixture was purified by column chromatography to yield the product as a colorless oil, 5.15 g (93%).

Synthesis of 5-neopentyl-1-phenyl-1H-pyrazole:

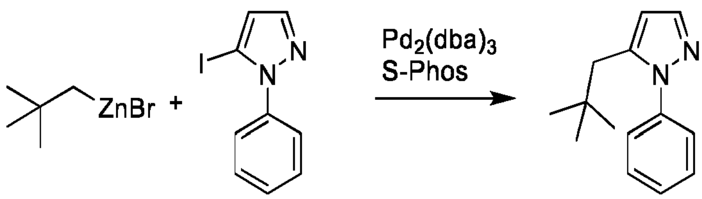


5-iodo-1-phenyl-1H-pyrazole (5.000 g, 1 Eq, 18.51 mmol), S-Phos (608.0 mg, 0.08 Eq, 1.481 mmol), and $Pd_2(dba)_3$ were combined in THF (50.00 mL) under nitrogen and neopentylzinc(II) bromide solution in THF (6.010 g, 55.54 mL, 0.500 molar, 1.5 Eq, 27.77 mmol) was added. The pale yellow solution was refluxed for 16 hours and quenched with water and brine. Extraction with EtOAc followed by drying an purification by column chromatography yielded the product as white solids after additional trituration in heptanes, yielding 1.77g (45%).

Synthesis of 4-bromo-5-neopentyl-1-phenyl-1H-pyrazole:

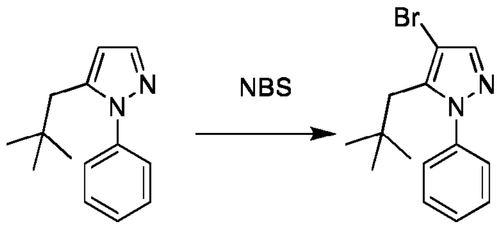


A solution of 5-neopentyl-1-phenyl-1H-pyrazole (5.700 g, 1 Eq, 26.60 mmol) in MeCN (150.00 mL) was cooled in an ice/water bath and solid 1-bromopyrrolidine-2,5-dione (4.970 g, 1.05 Eq, 27.93 mmol) was added and the solution as allowed to warm to room temperature over 16 hours. The reaction mixture was condensed under vacuum and purified by column chromatography to yield the solid as a colorless oil that slowly solidifies, 6.21 g (80%).

**Synthesis of 5-neopentyl-1,4-diphenyl-1H-pyrazole:**

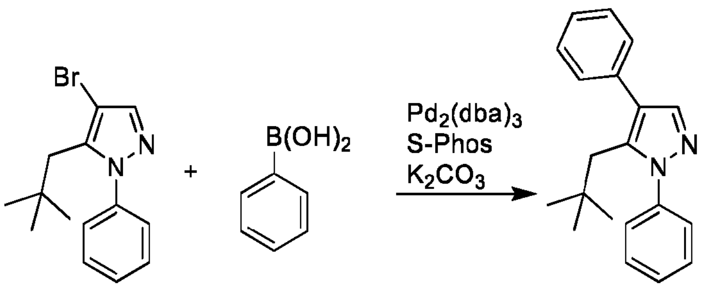


A solution of 4-bromo-5-neopentyl-1-phenyl-1H-pyrazole (3.250 g, 1 Eq, 11.08 mmol), phenylboronic acid (3.379 g, 2.5 Eq, 27.71 mmol), and phenylboronic acid (6.127 g, 4 Eq, 44.34 mmol) in dioxane (50.00 mL) and water (25.00 mL) was sparged with nitrogen for 10 minutes. $Pd_2(dba)_3$ (203.0 mg, 0.02 Eq, 221.7 μmol) and S-Phos (364.0 mg, 0.08 Eq, 886.7 μmol) were added and the reaction mixture was heated at reflux for 16 hours. The reaction was diluted with water and extracted with EtOAc and the organic phase was reduced under vacuum. Purification by column chromatography yielded the product as a white solid, 3.03 g, (94%).

Synthesis of iridium dimer:

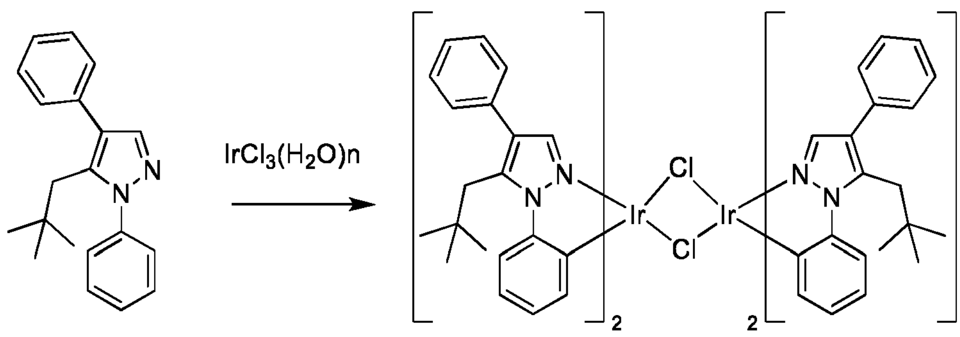


A suspension of 5-neopentyl-1,4-diphenyl-1H-pyrazole (1.871 g, 4.6 Eq, 6.441 mmol) and iridium(III) chloride hydrate (1.038 g, 2 Eq, 2.801 mmol) in 2-ethoxyethanol (30.00 mL) and water (10.00 mL) was sparged with nitrogen for 15 minutes and then heated at reflux for 16 hours. The mixture was cooled to room temperature and MeOH was added. Filtration and washing with more MeOH yielded the dimer as an off-white solid, 2.27 g (quant.).

Synthesis of iridium solvento triflate:

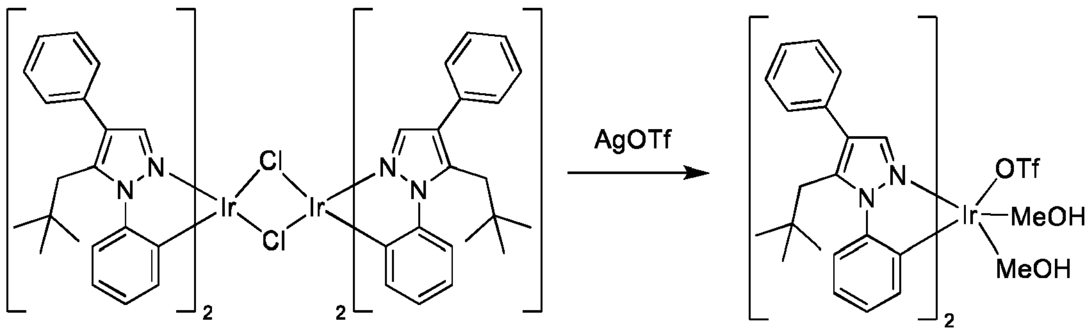


Iridium dimer (4.000 g, 0.5 Eq, 2.480 mmol) was suspended in DCM (105.0 mL) and a solution of oxo((trifluoromethyl)sulfonyl)silver (1.306 g, 1.025 Eq, 5.084 mmol) in MeOH (15.00 mL) was added. The reaction mixture was stirred at room temperature 16 hours covered in foil. Filtration through celite followed by condensing under vacuum yielded the iridium solvent triflate salt as a beige foam in quantitative yield.

Synthesis of E31:

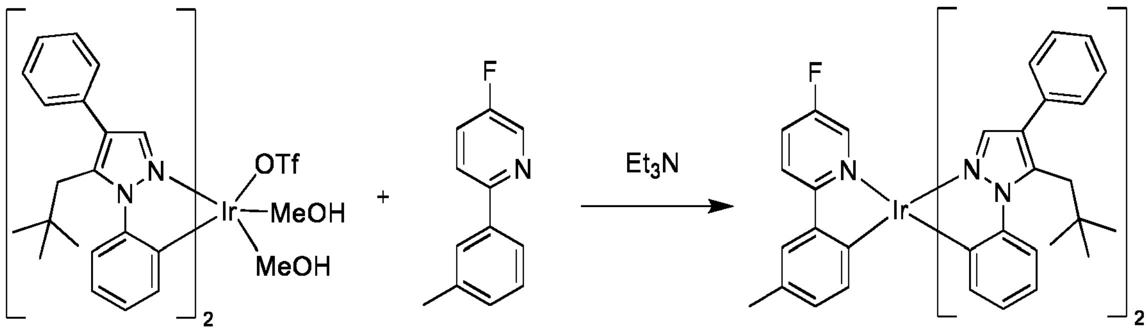


A solution of iridium solvento triflate (0.600 g, 1 Eq, 652 μmol) and 5-fluoro-2-(m-tolyl)pyridine (0.230 g, 1.88 Eq, 1.23 mmol) in acetone (20.00 mL) was sparged with nitrogen for 10 minutes, followed by the addition of triethylamine (132 mg, 182 pL, 2 Eq, 1.30 mmol). The mixture was heated at reflux for 16 hour and then condensed under vacuum. The residue was dissolved in 200 mL THF and sparged with nitrogen followed by irradiation with 405 nm light for 2 hours. The solution was condensed under vacuum again and purified by column chromatography to yield E31, 0.40 g (64%).

## Claims

1. A metal coordination complex compound that is capable of functioning as an emitter in an organic light emitting device (OLED) at room temperature; wherein

   the compound comprises a first emissive ligand that is coordinated to the metal;
   the compound has a vertical dipole ratio (VDR) > 0.33; and
   at least one of the following is true:

   (1) the first emissive ligand has a spin density population is > 60%;
   (2) the first emissive ligand has a natural transition orbital (NTO) particle population is > 50%;
   (3) the first emissive ligand has a ligand-centered character (LC) is > 30%;
   (4) the firstemissive ligand has a complex ligand-to-ligand charge transfer (LLCT) is < 40%; and
   (5) the first emissive ligand has an M/T ratio is > 0.42.

2. The compound of claim 1, wherein the compound has a VDR > 0.35; and/or wherein the first emissive ligand has a spin density population > 70%; and/or wherein the first emissive ligand has an NTO particle population > 60%; and/or wherein the first emissive ligand has a LC > 40%; and/or wherein the first emissive ligand has a complex LLCT < 30%; and/or wherein the first emissive ligand has an M/T ratio > 0.44; and/or

wherein the first emissive ligand comprises a polycyclic fused ring system coordinating to the metal.

**3.** The compound of claim 1, wherein the compound further comprises a second ligand that is coordinated to the metal; and/or

wherein each of the first emissive ligand and the second ligand has an effective length, and wherein the effective length of the first emissive ligand is at least 3 Å greater than that of the second ligand; and/or
wherein the first emissive ligand has at least 5 more non-hydrogen atoms than the second ligand; and/or
wherein the first emissive ligand has a molecular weight that is at least 100 amu greater than the molecular weight of the second ligand; and/or
wherein the first emissive ligand has at least 3 more aliphatic methylene carbons than the second ligand.

**4.** The compound of claim 1, wherein the compound further comprises a second ligand that is coordinated to the metal;

wherein the compound has a first free vector $\mathbf{F}_1$, represented by a bound vector $\mathbf{M_1}$ that connects any two atoms in the compound and passes within 2**Å** of the metal, and the length of the bound vector $\mathbf{M_1}$ is greater than 18 **Å;**
wherein the compound has a second free vector $\mathbf{F_2}$**,** represented by a bound vector $\mathbf{M_2}$ that connects any two atoms in the compound;
wherein the length of the bound vector $\mathbf{M_2}$ is greater than 18 **Å;** and
wherein the compound has a transition dipole moment vector and an angle between the transition dipole moment vector and the cross product of vectors $\mathbf{F_1}$ and $\mathbf{F_2}$ is less than 45 degrees.

**5.** The compound of claim 1, wherein the compound further comprises a second ligand that is coordinated to the metal;

wherein the compound has two metal-dative bonds in a trans configuration;
wherein the compound has a first vector $\mathbf{W_1}$ formed between any atom on the periphery of the compound and the metal;
wherein the compound has a second vector $\mathbf{W_2}$ formed between any other atom on the periphery of the compound and the metal; wherein each magnitude of $\mathbf{W_1}$ and $\mathbf{W_2}$ is greater than 9.5 Å; and
wherein the compound has an emissive transition dipole moment vector and an angle between the emissive transition dipole moment vector and the cross product of vectors $\mathbf{W_1}$ and $\mathbf{W_2}$ is less than 45 degrees.

**6.** The compound of claim 1, wherein the compound has a formula of $M(L_A)_p(L_B)_q(L_C)_r$ wherein $L_B$ and $L_C$ are each a bidentate ligand; and wherein p is 1, 2, or 3; q is 0, 1, or 2; r is 0, 1, or 2; and p+q+r is the oxidation state of the metal M.

**7.** The compound of claim 6, wherein the compound has a formula selected from the group consisting of $Ir(L_A)_3$, $Ir(L_A)(L_B)_2$, $Ir(L_A)_2(L_B)$, $Ir(L_A)_2(L_C)$, and $Ir(L_A)(L_B)(L_C)$; and wherein $L_A$, $L_B$, and $L_C$ are different from each other.

**8.** The compound of claim 7, wherein the ligand $L_A$ is selected from the group consisting of:

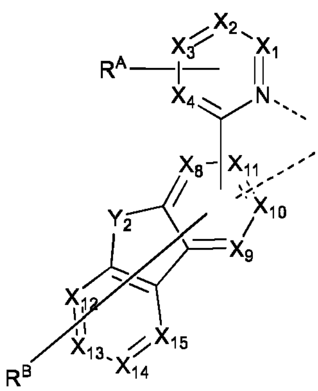
,
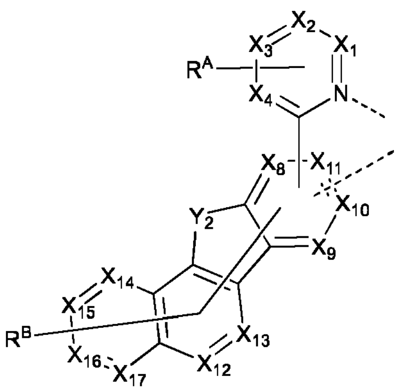
,
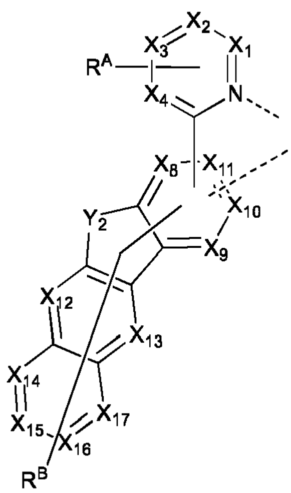
,

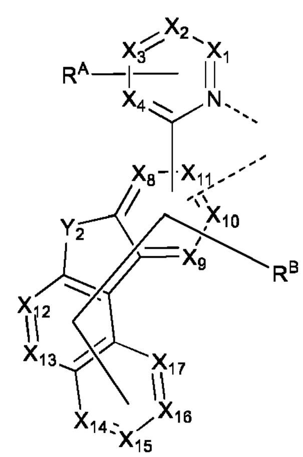,

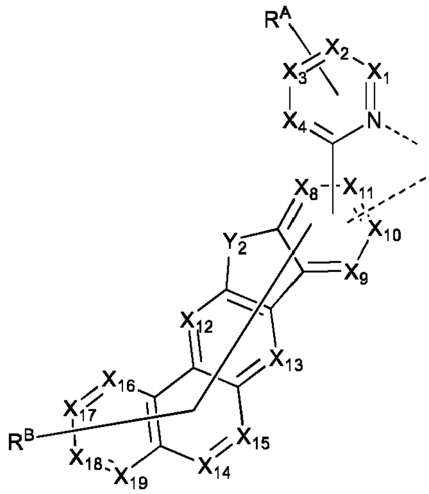,

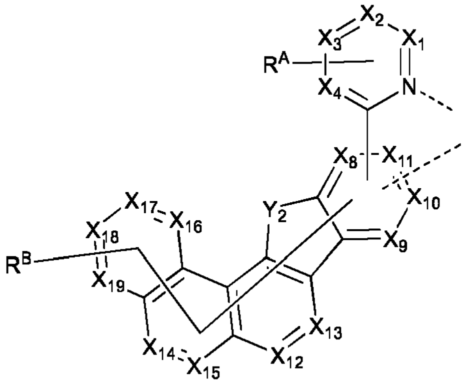,

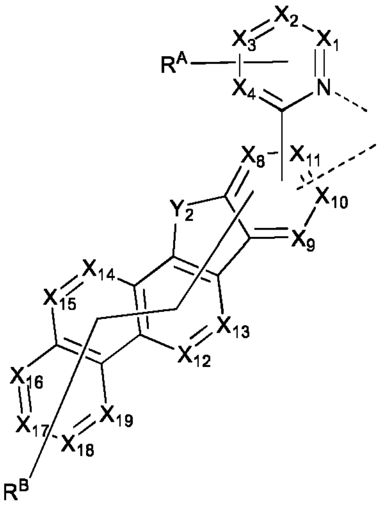,

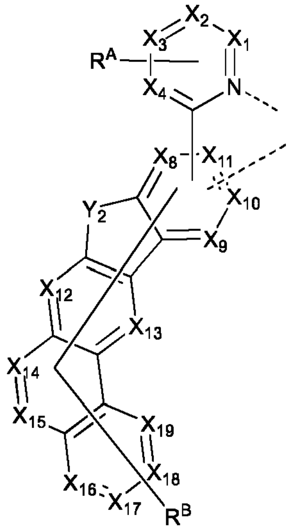,

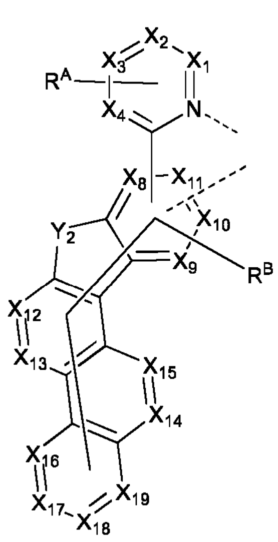,

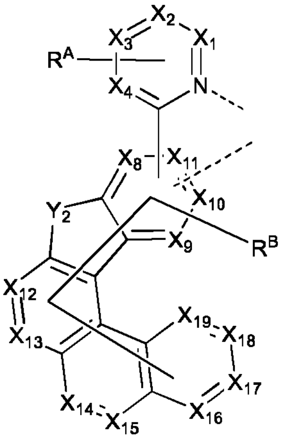,

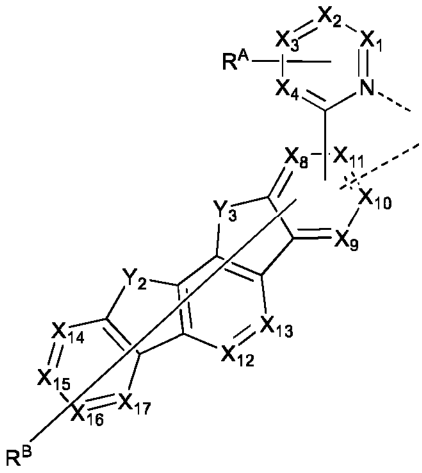,

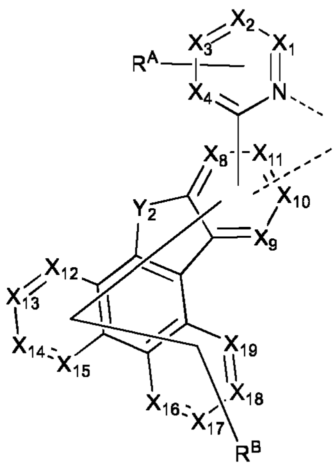
,
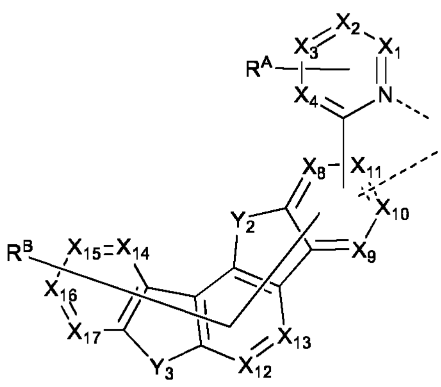
,
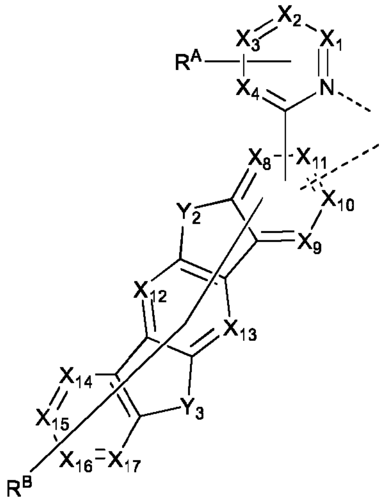
,

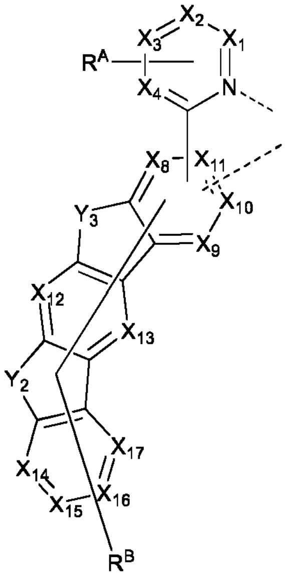
,
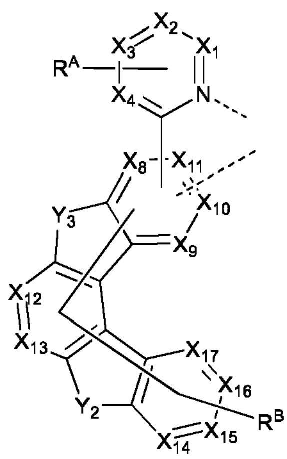
,
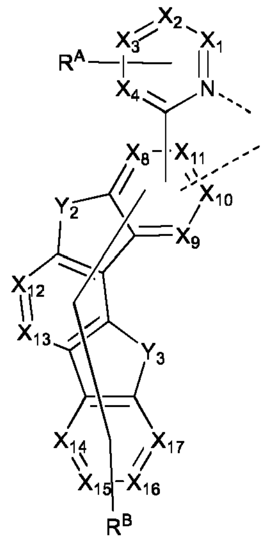
,
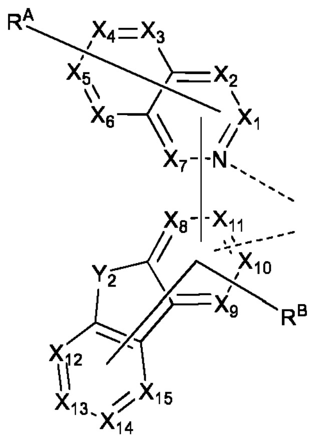
,

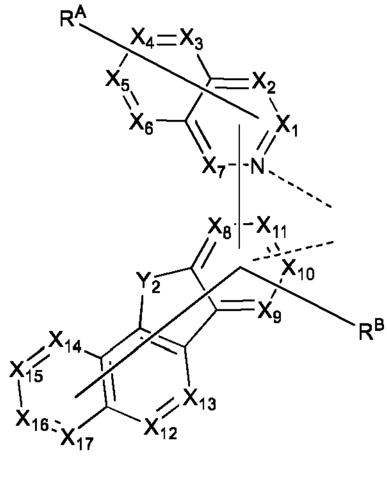
,
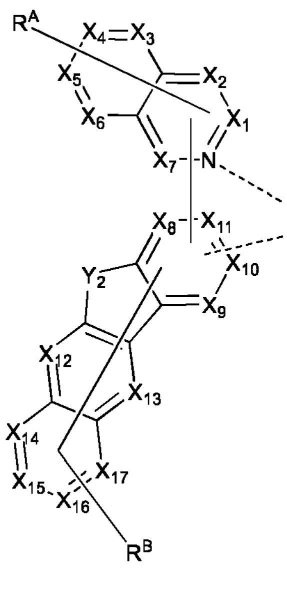
,
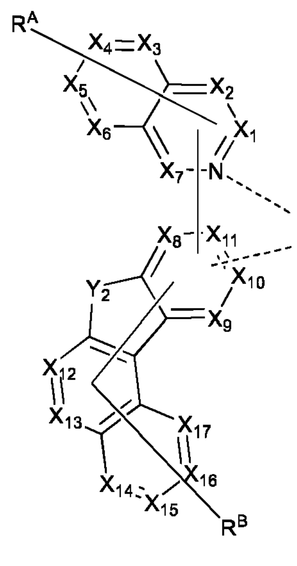
,

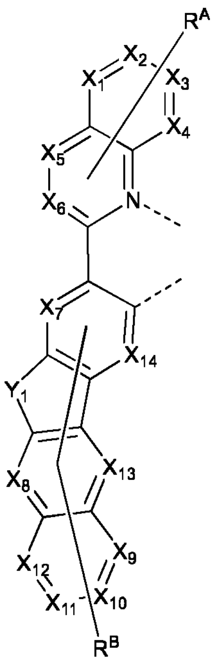
,
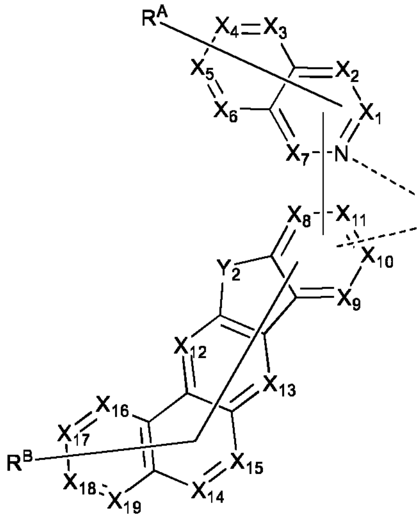
,
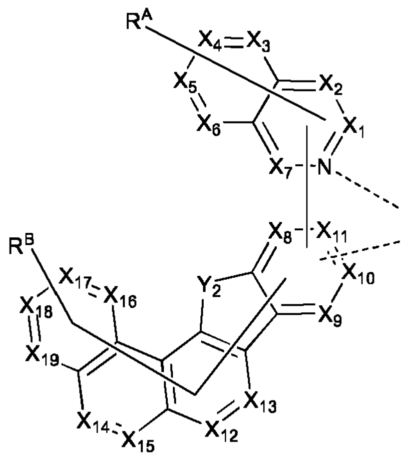
,
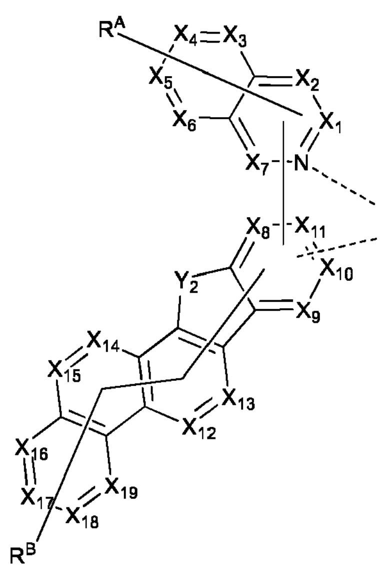
,
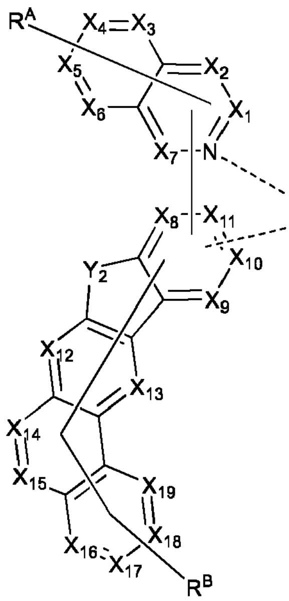
,
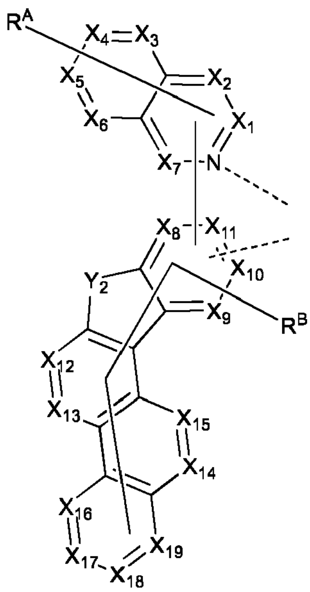
,

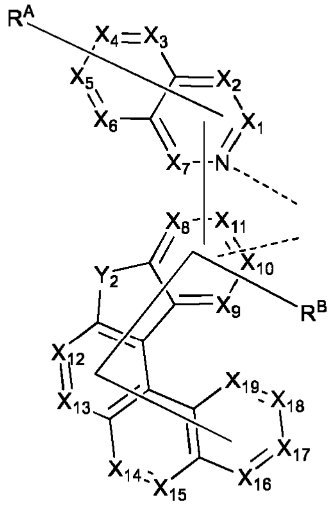,
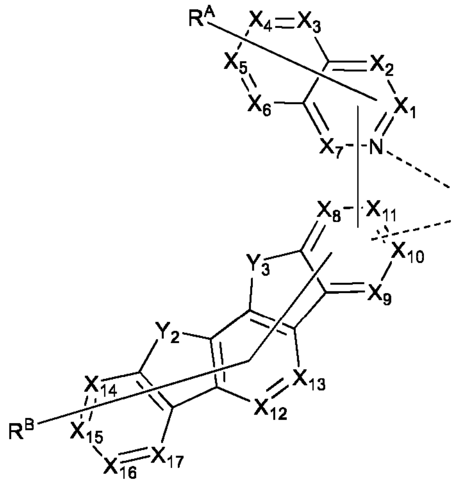,
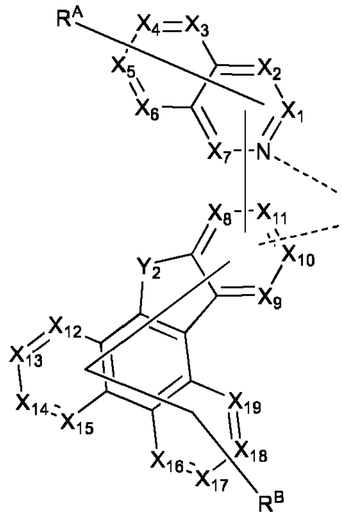,

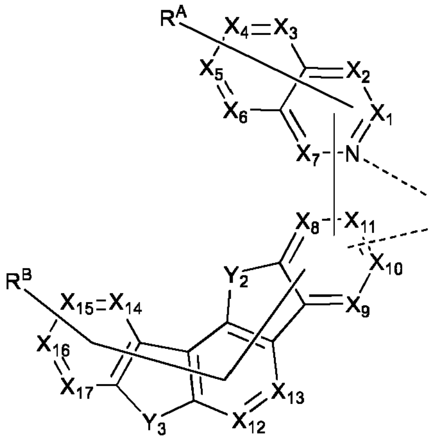,
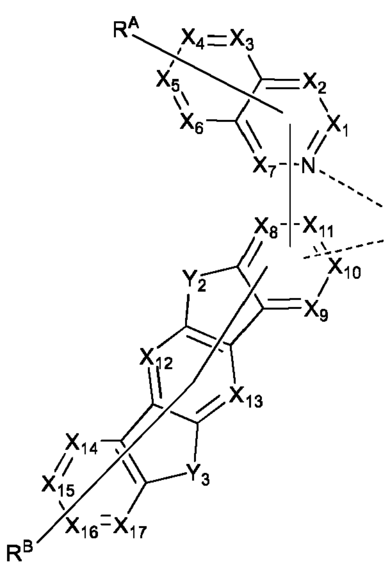,
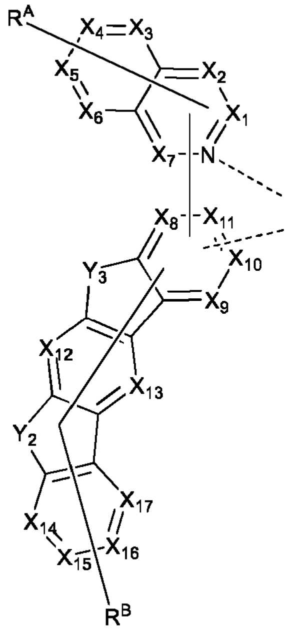,

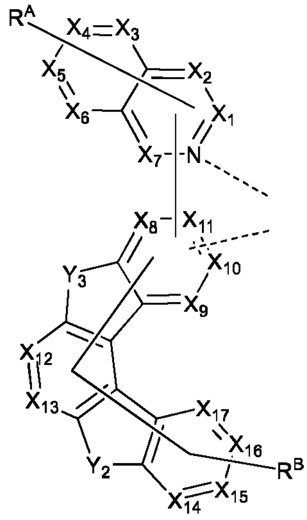,
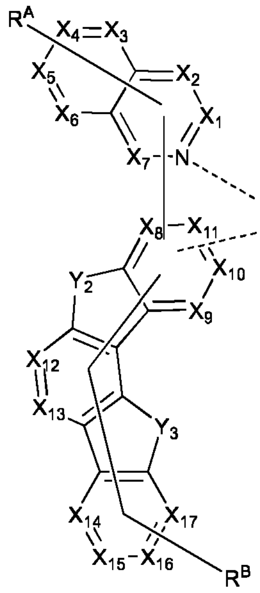,
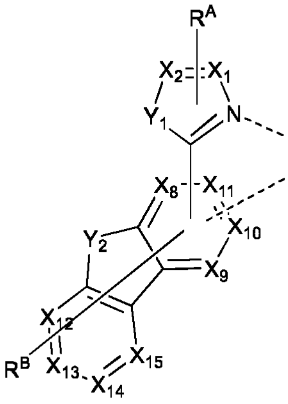,

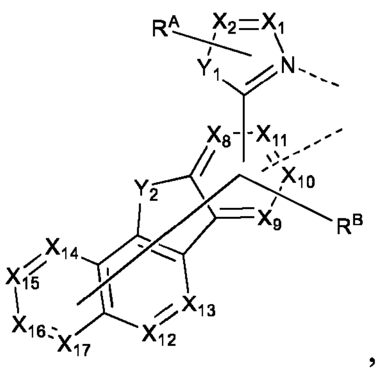,
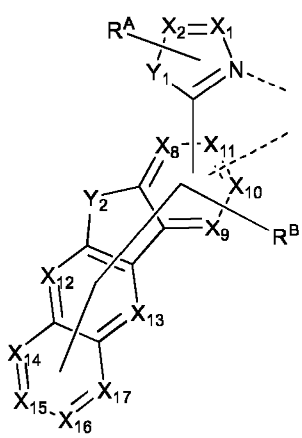,
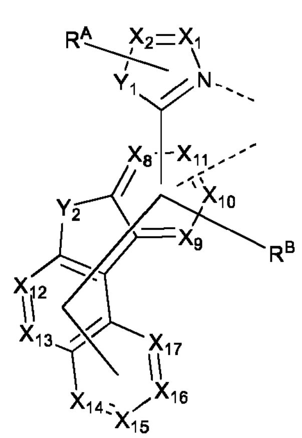,

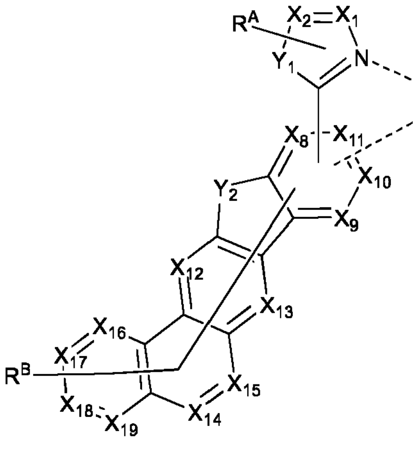,
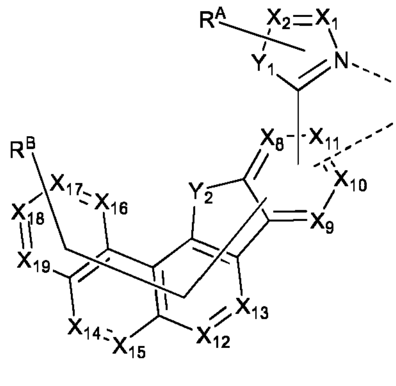,

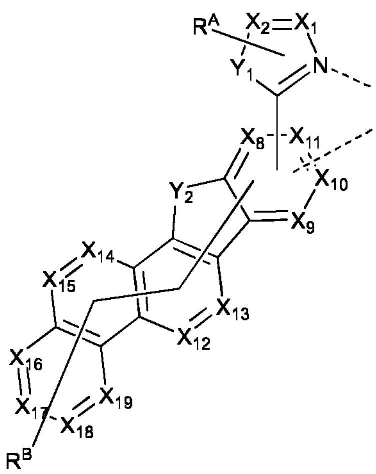
,
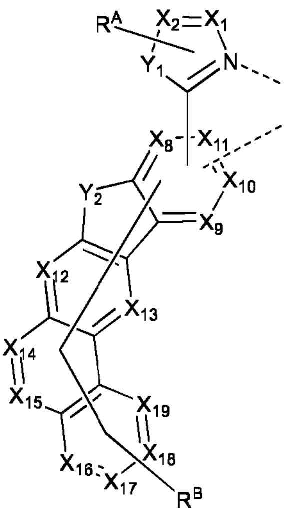
,
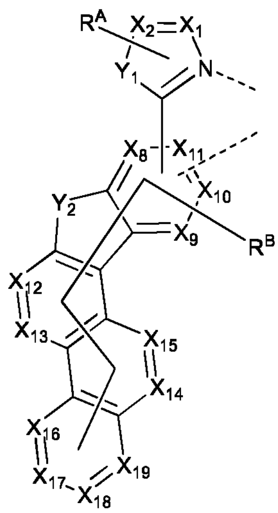
,
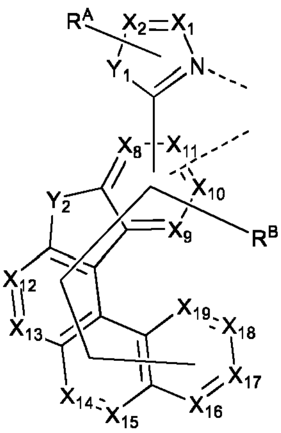
,
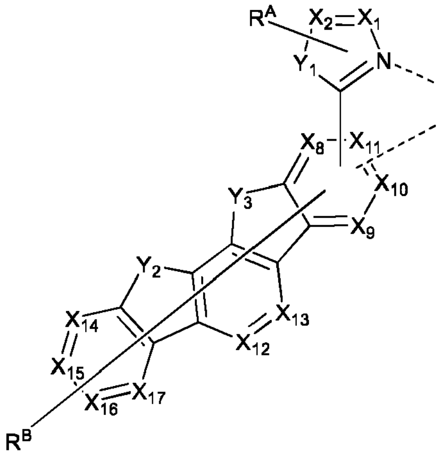
,
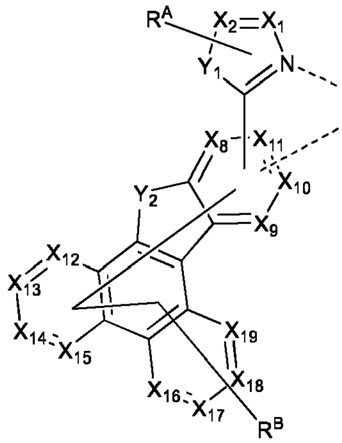
,
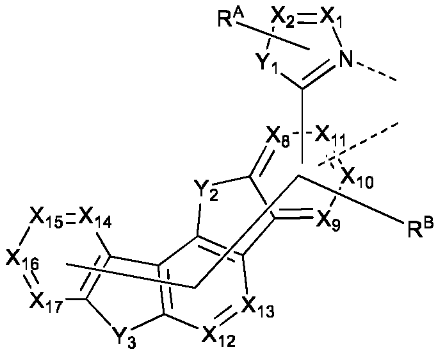
,
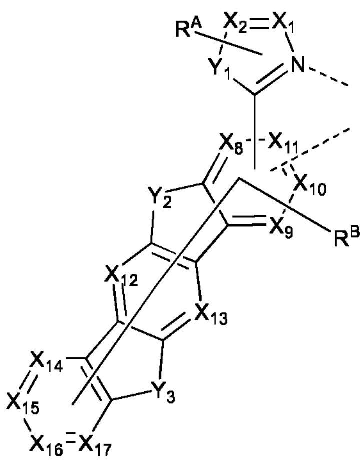
,
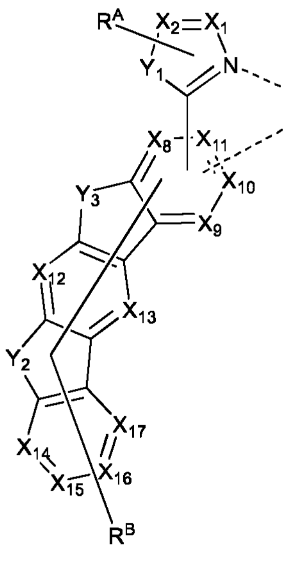
,

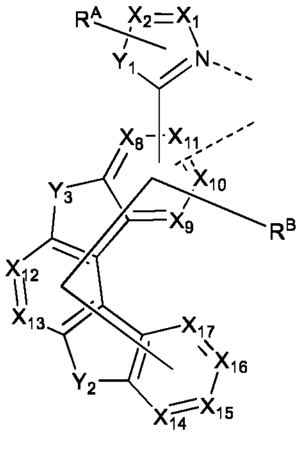, 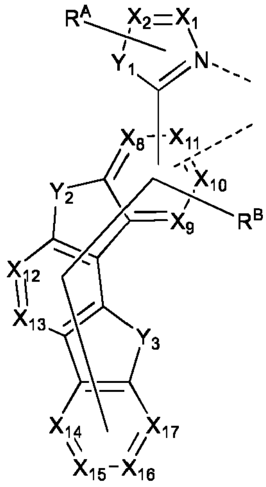, 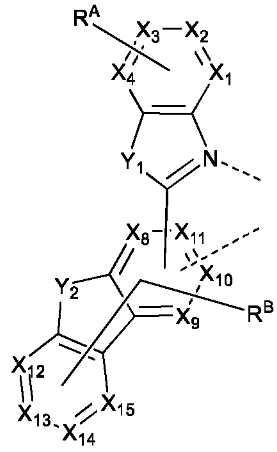,

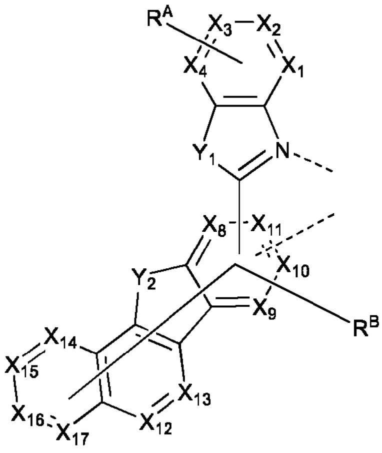, 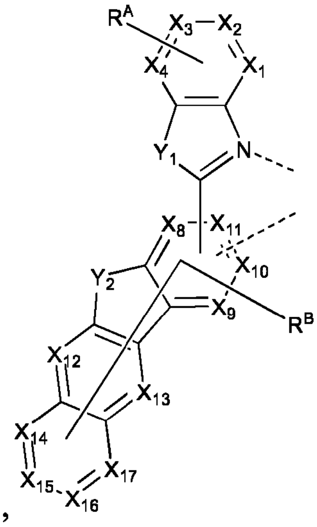, 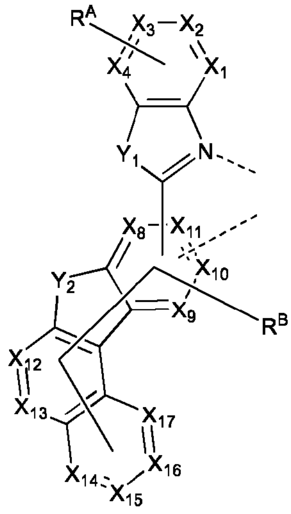,

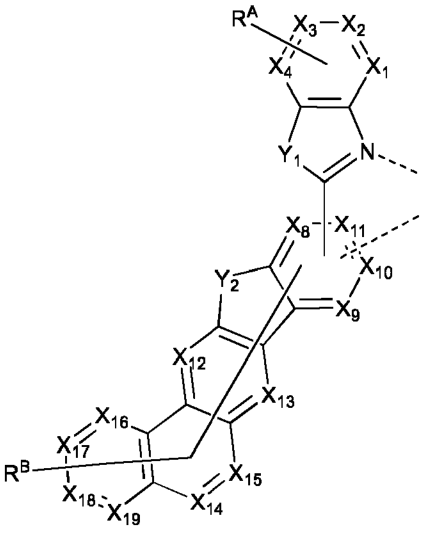, 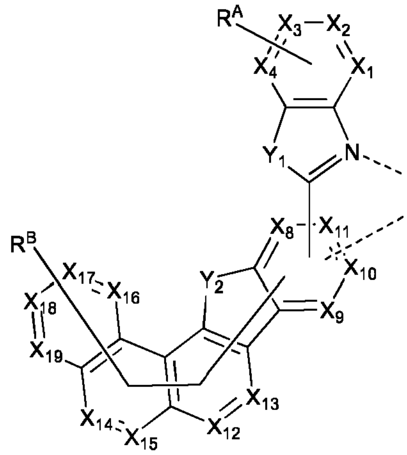,

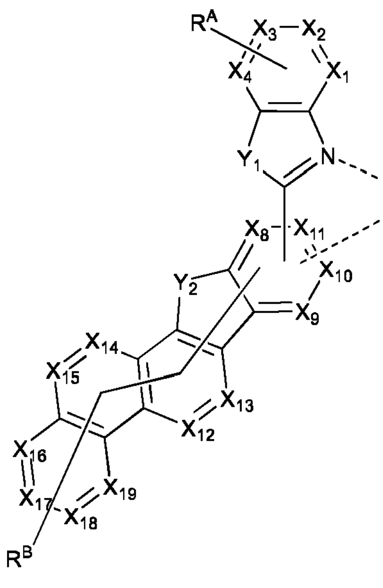,
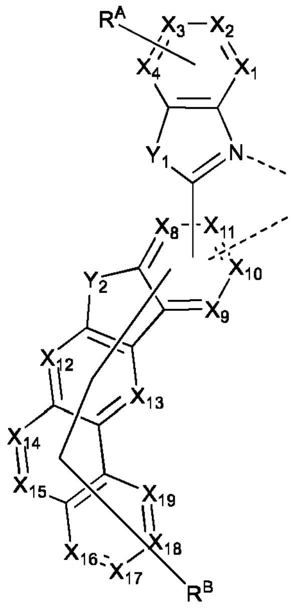,
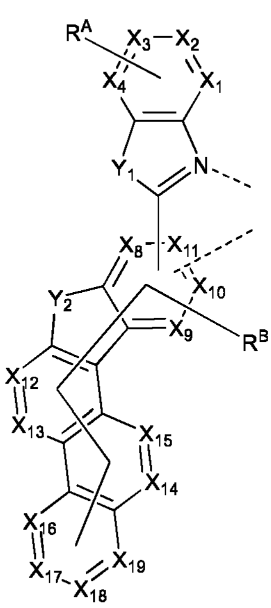,

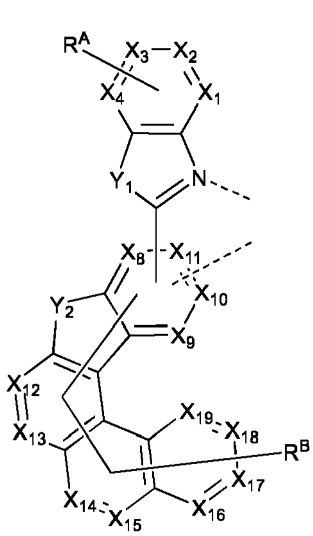,
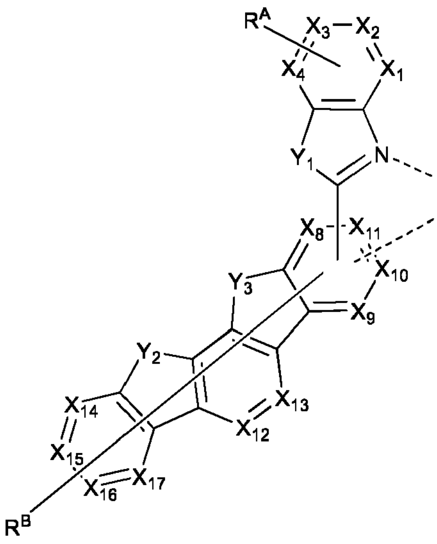,
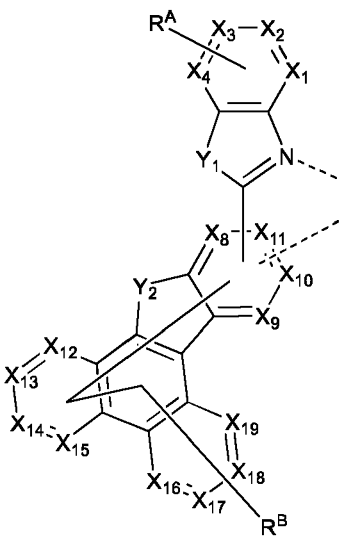,

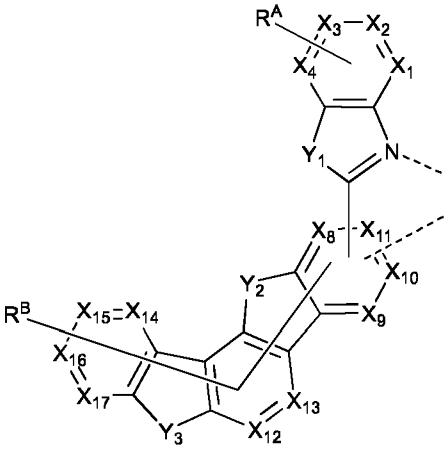, 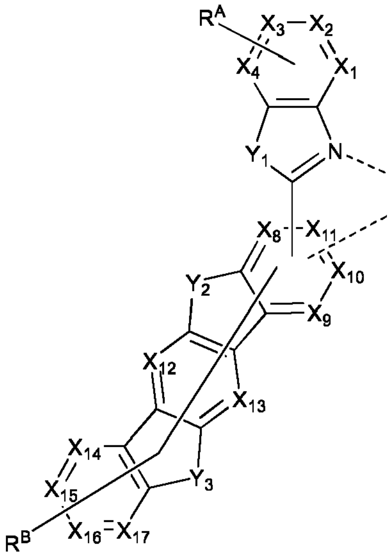, 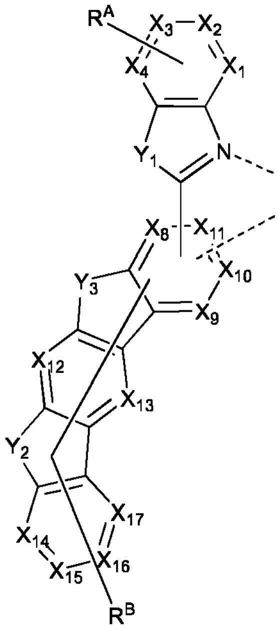,

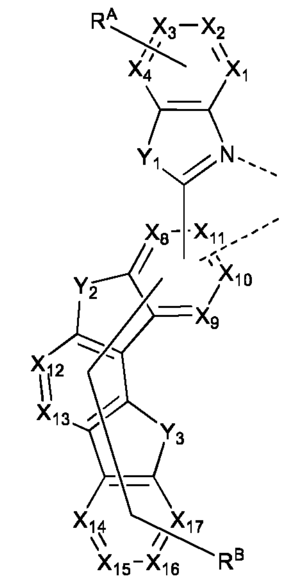, 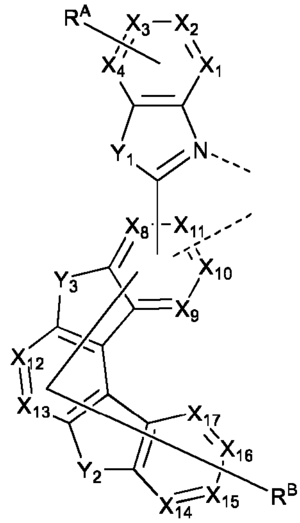, 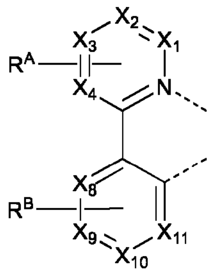, 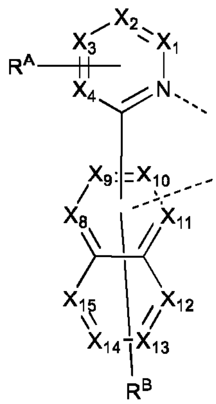,

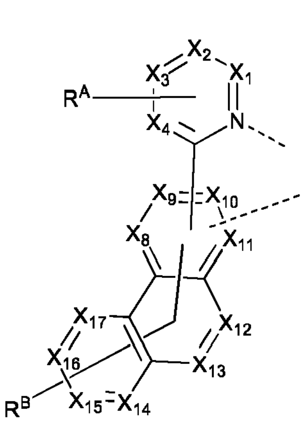, 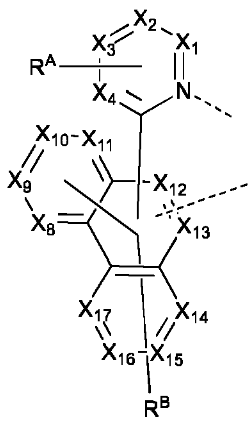, 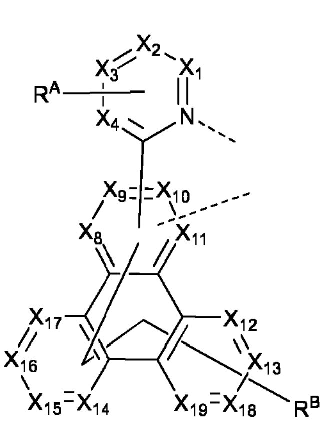,

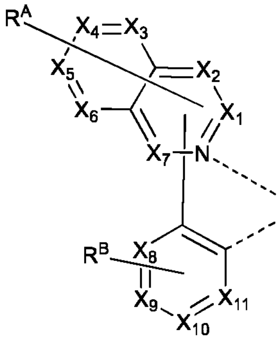, 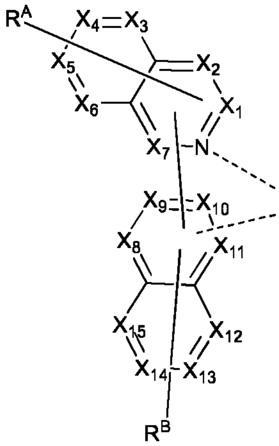, 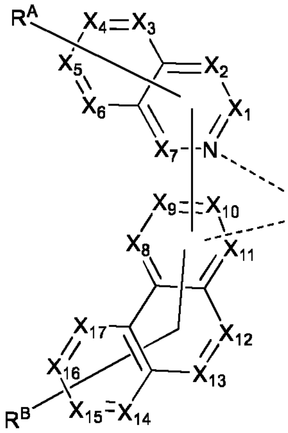, 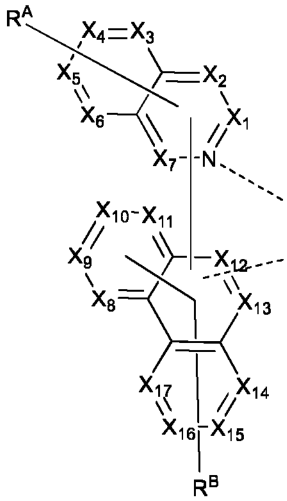,

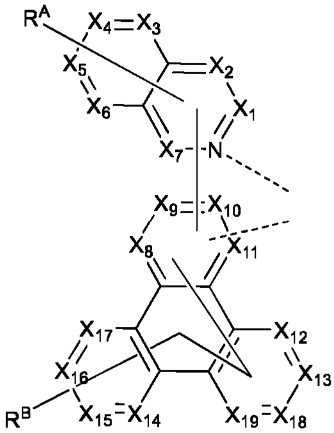, 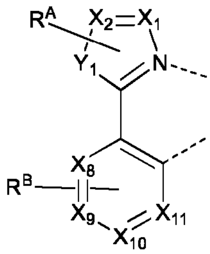, 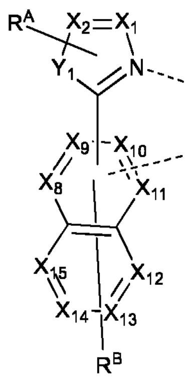, 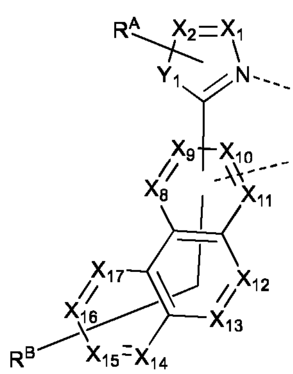,

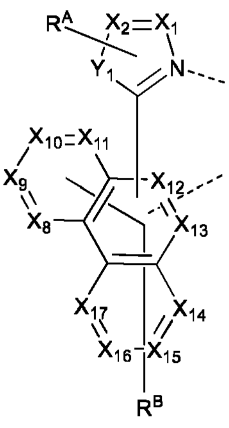, 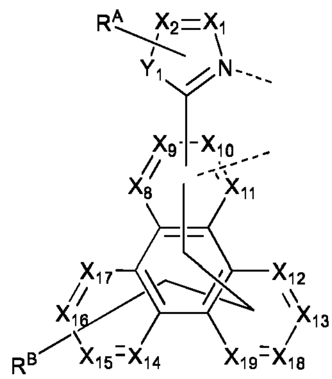, 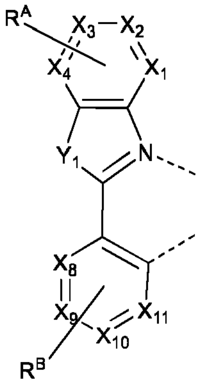, 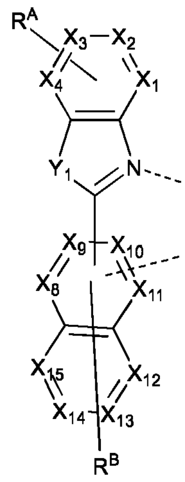,

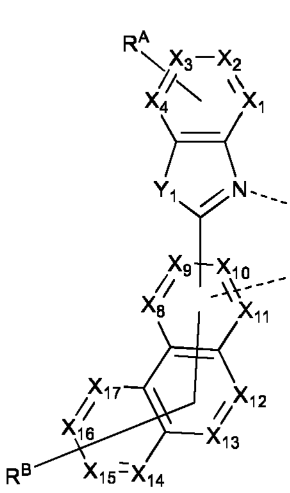 , 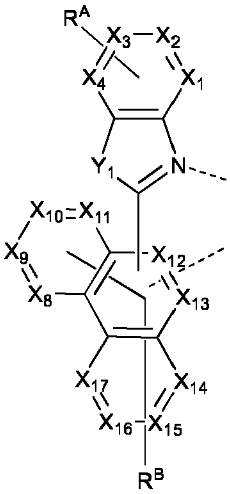 , and 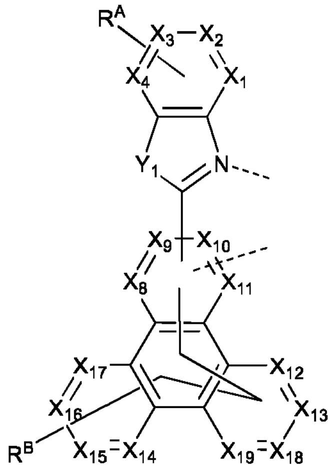 ;

wherein $X_1$ to $X_{19}$ are each independently C or N;
wherein each $R^A$, and $R^B$ independently represent from mono to the maximum possible number of substitutions, or no substitution;
wherein each $R^A$, $R^B$, $R_e$, and $R_f$ is independently a hydrogen or a substituent selected from the group consisting of the General Substituents as defined herein; and
wherein each of $Y_1$, $Y_2$, and $Y_3$ is independently selected from the group consisting of $BR_e$, $NR_e$, $PR_e$, O, S, Se, C=O, S=O, $SO_2$, $CR_eR_f$, $SiR_eR_f$, and $GeR_eR_f$; and
any two substituents can be joined or fused to form a ring.

**9.** The compound of claim 6, wherein the ligand $L_A$ is selected from $L_{Ai}$, wherein i is an integer from 1 to 335; and each $L_{Ai}$ is defined below:

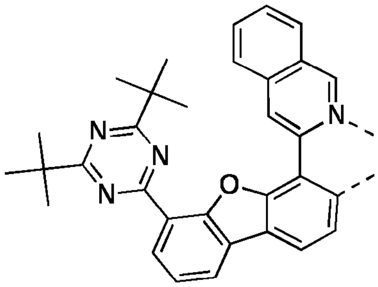

$L_{A1}$ ,

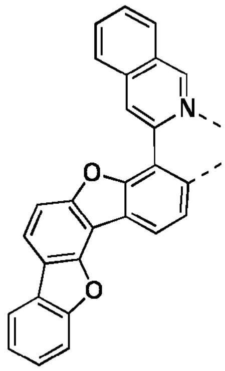

$L_{A2}$ ,

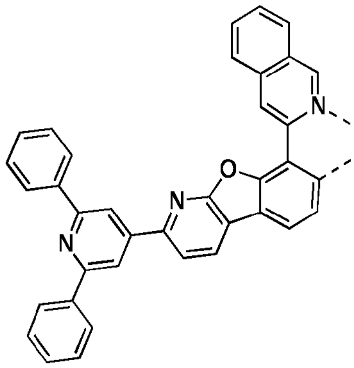

$L_{A3}$ ,

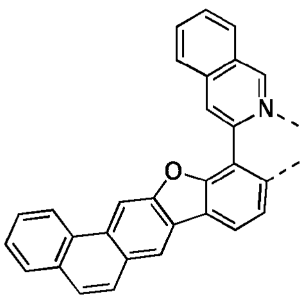

$L_{A4}$ ,

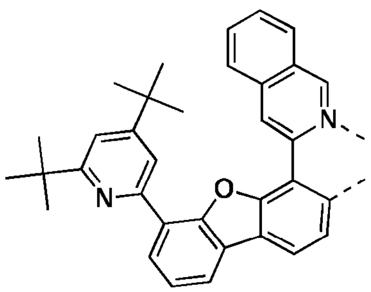

$L_{A5}$ ,

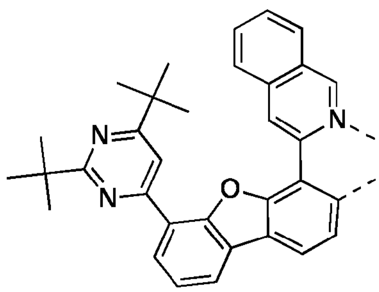

$L_{A6}$ ,

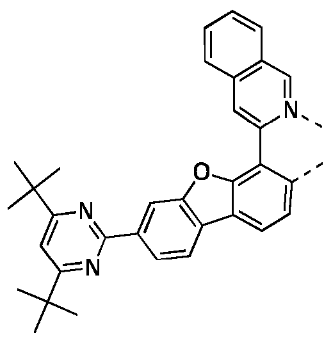
$L_{A7}$

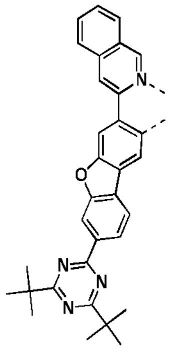
, $L_{A8}$

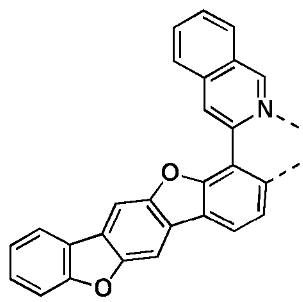
, $L_{A9}$

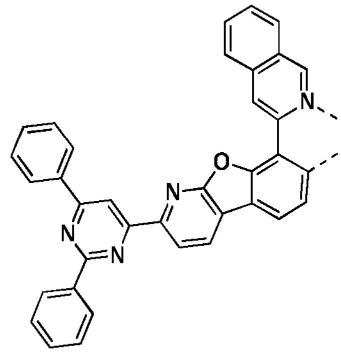
, $L_{A10}$

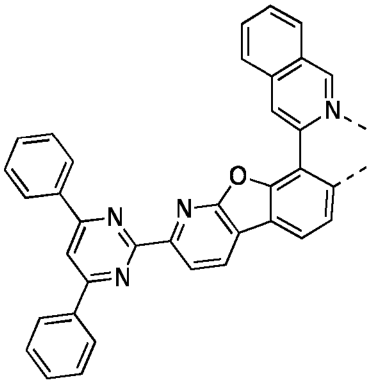
, $L_{A11}$

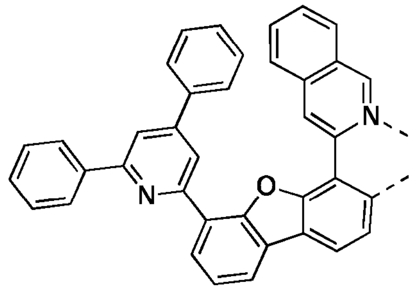
, $L_{A12}$

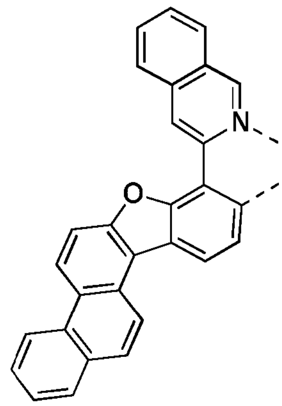
, $L_{A13}$

,

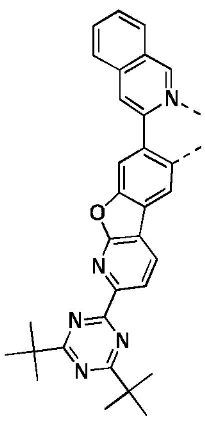
$L_{A14}$

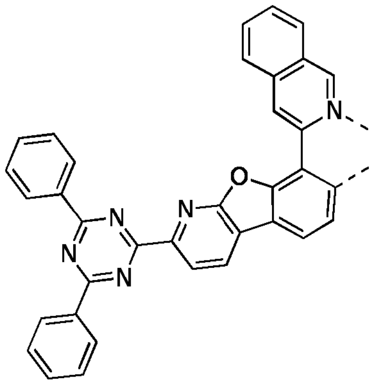
, $L_{A15}$

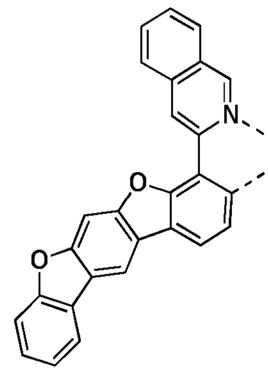
, $L_{A16}$

,

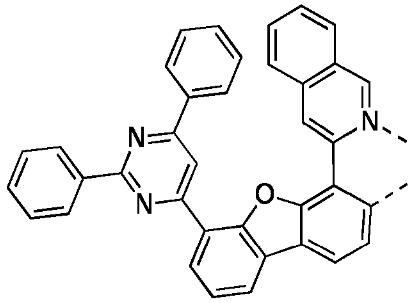

$L_{A17}$ ,

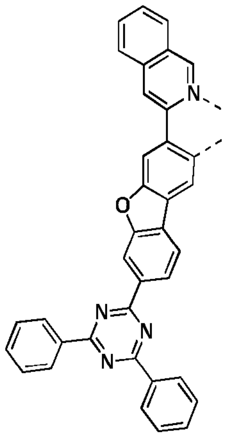

$L_{A18}$ ,

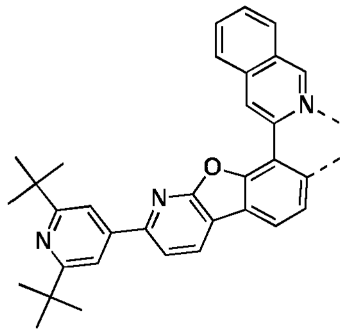

$L_{A19}$ ,

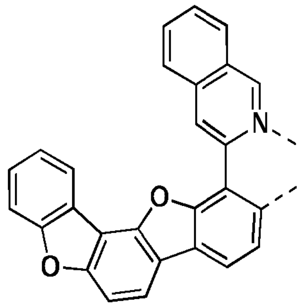

$L_{A20}$ ,

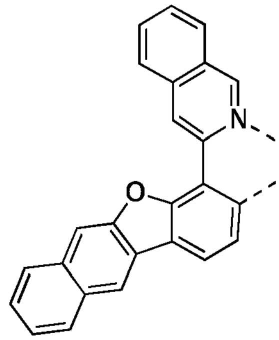

$L_{A21}$ ,

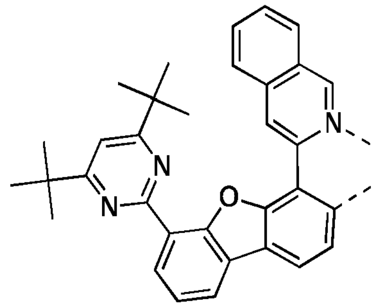

$L_{A22}$ ,

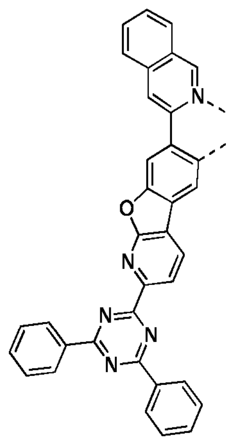

$L_{A23}$ ,

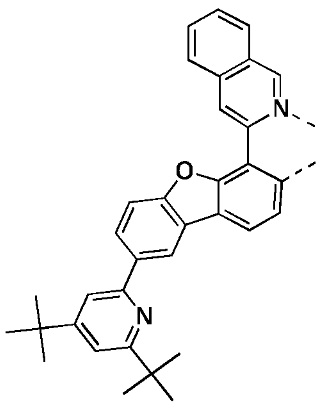

$L_{A24}$ ,

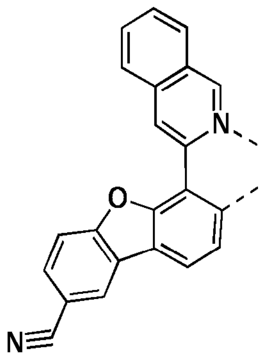

$L_{A25}$ ,

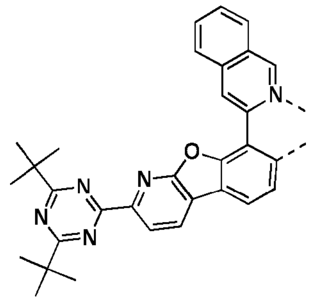

$L_{A26}$ ,

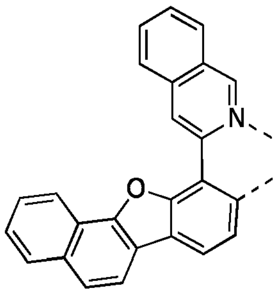

$L_{A27}$ ,

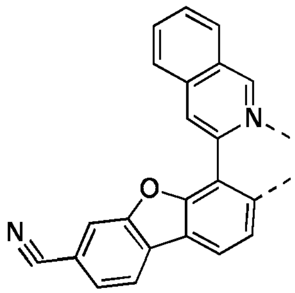

$L_{A28}$ ,

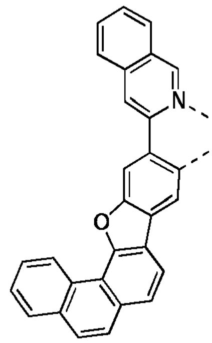

$L_{A29}$ ,

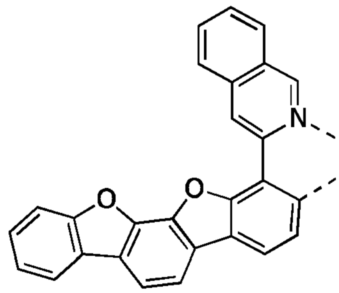

$L_{A30}$

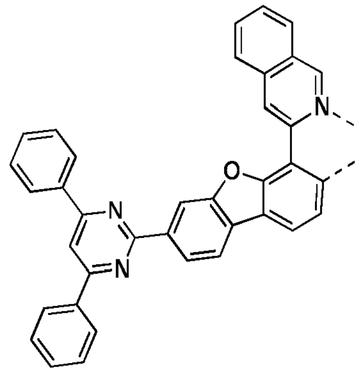

, $L_{A31}$

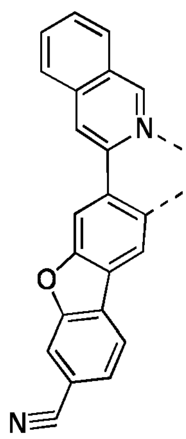

, $L_{A32}$

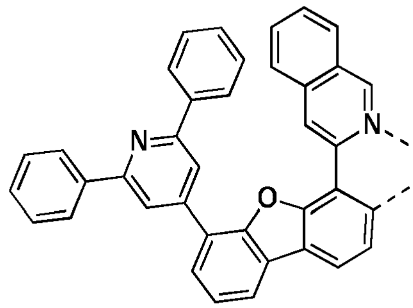

, $L_{A33}$ ,

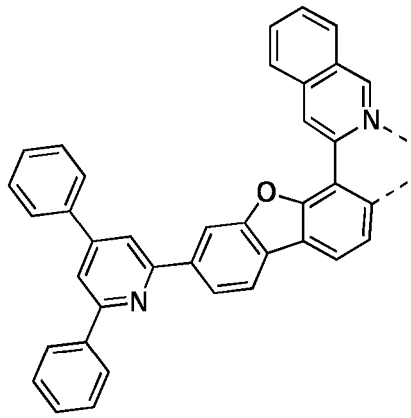

$L_{A34}$ ,

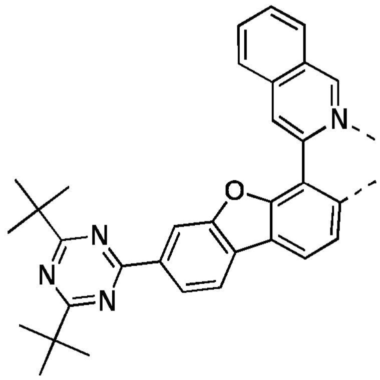

$L_{A35}$ ,

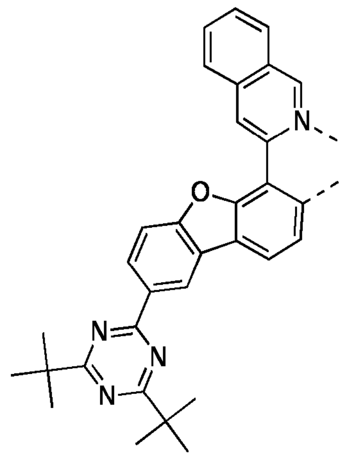

$L_{A36}$ ,

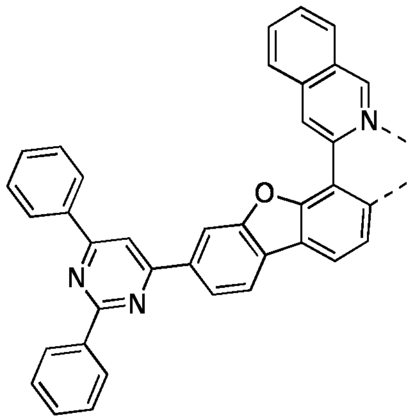
$L_{A37}$

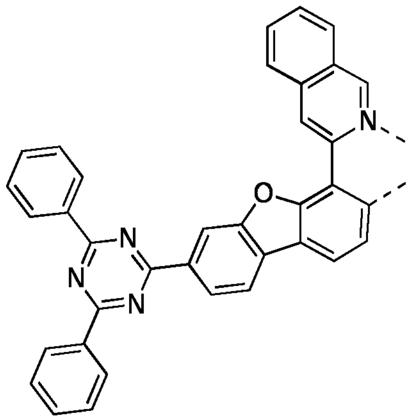
, $L_{A38}$

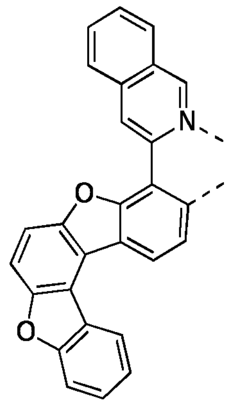
, $L_{A39}$ ,

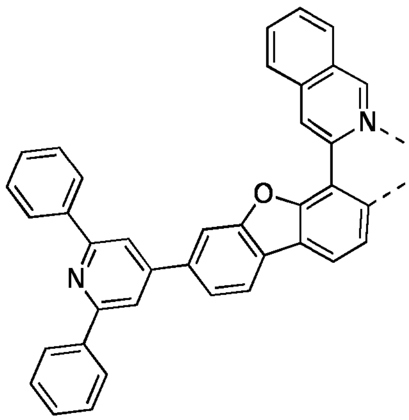
$L_{A40}$

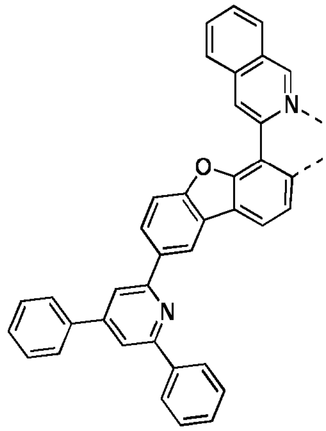
, $L_{A41}$ ,

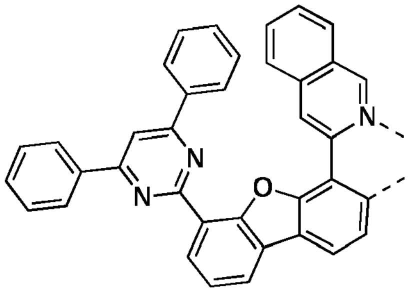
$L_{A42}$

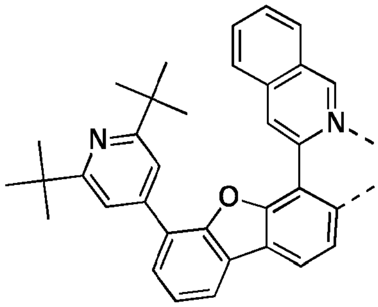
, $L_{A43}$

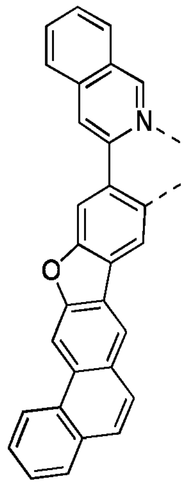
, $L_{A44}$

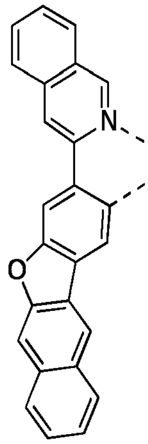
, $L_{A45}$

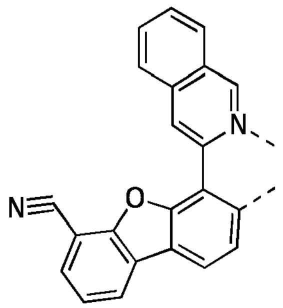

, $L_{A46}$

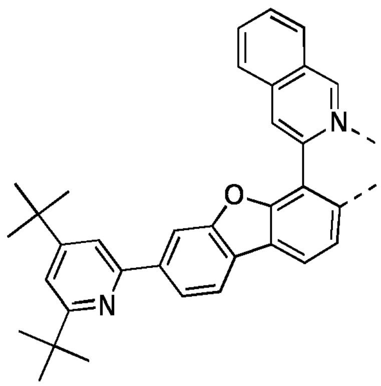

, $L_{A47}$

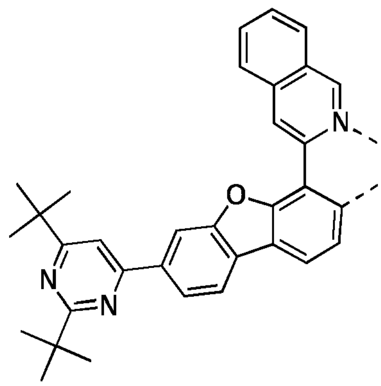

, $L_{A48}$ ,

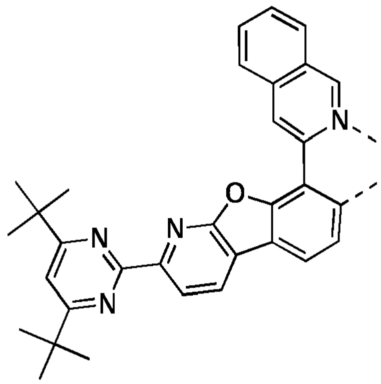

$L_{A49}$

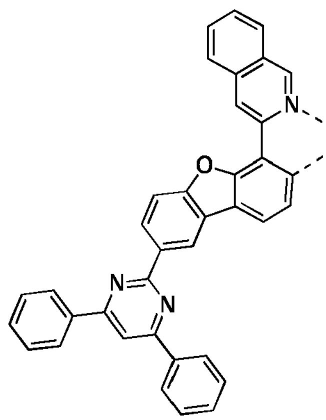

, $L_{A50}$

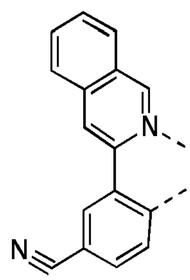

, $L_{A51}$ ,

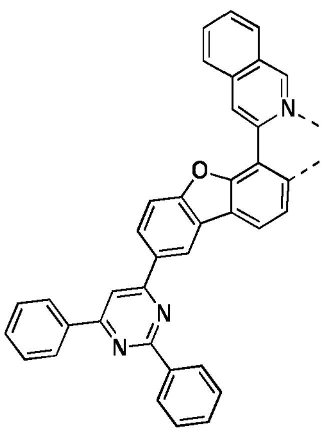

$L_{A52}$

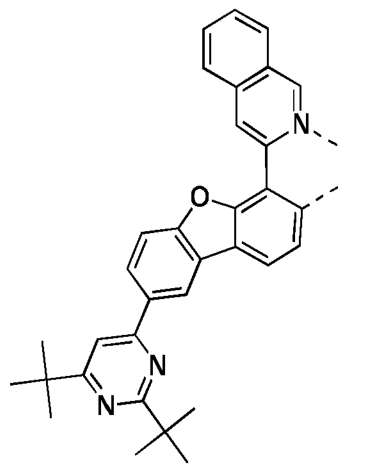

, $L_{A53}$

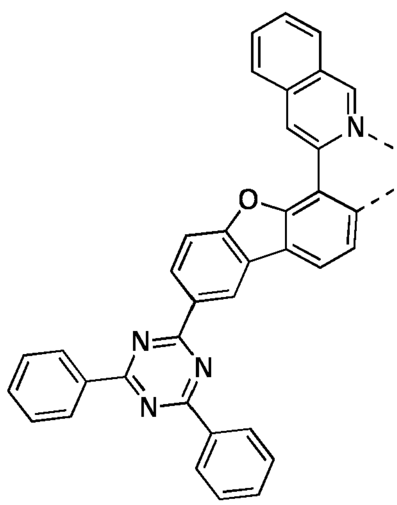

, $L_{A54}$ ,

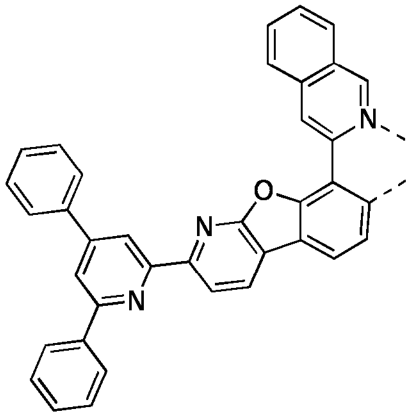

$L_{A55}$ ,

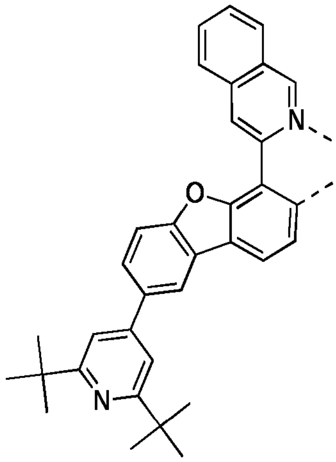

$L_{A56}$ ,

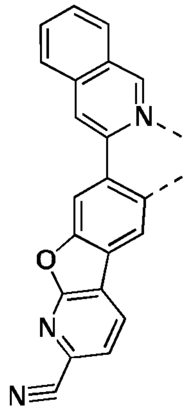

$L_{A57}$ ,

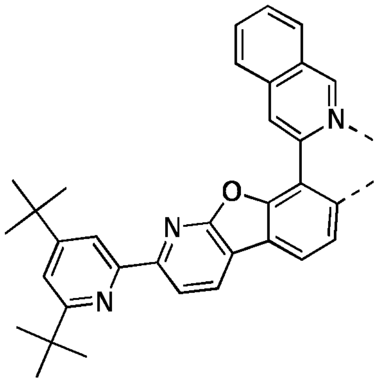

$L_{A58}$ ,

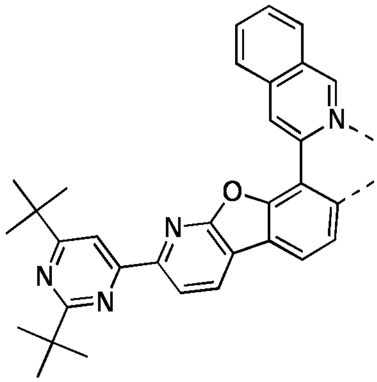

$L_{A59}$ ,

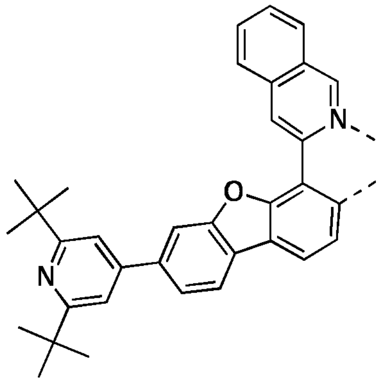

$L_{A60}$ ,

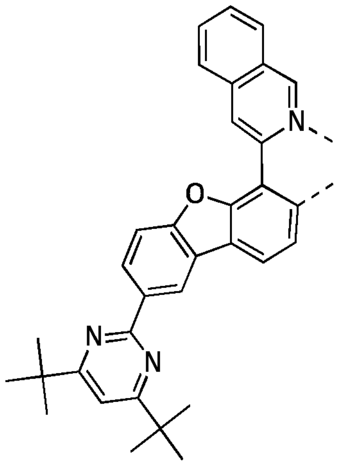

$L_{A61}$ ,

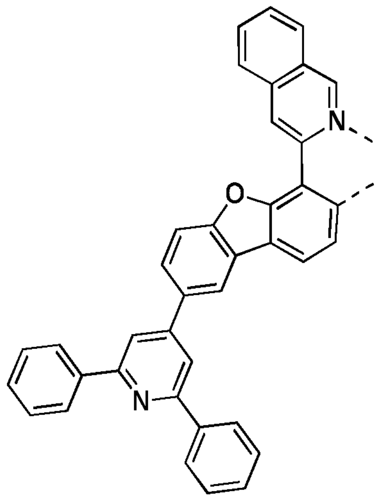

$L_{A62}$ ,

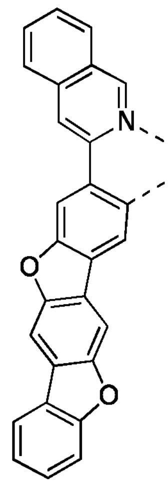

$L_{A63}$ ,

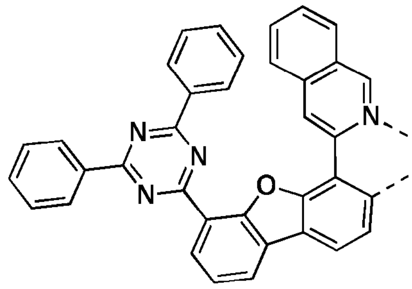

$L_{A64}$ ,

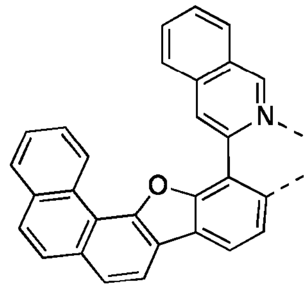

$L_{A65}$ ,

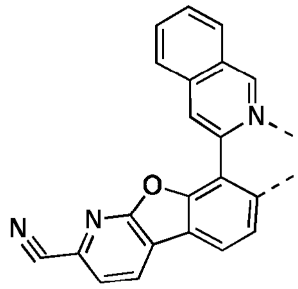

$L_{A66}$ ,

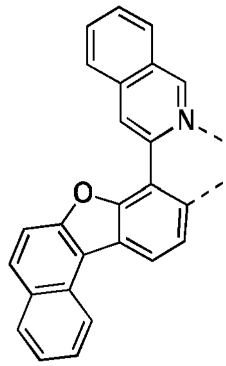

$L_{A67}$ ,

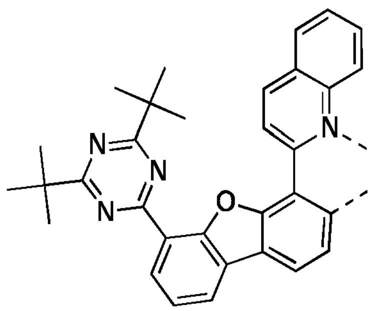

$L_{A68}$ ,

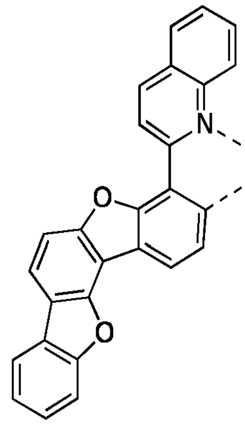

$L_{A69}$ ,

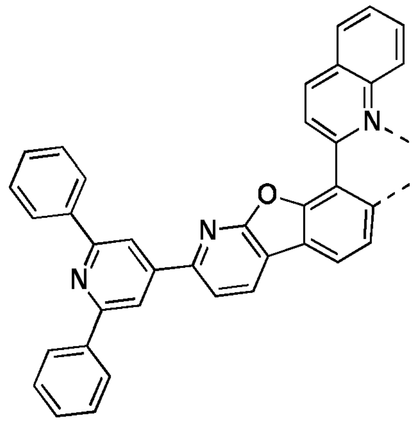

$L_{A70}$ ,

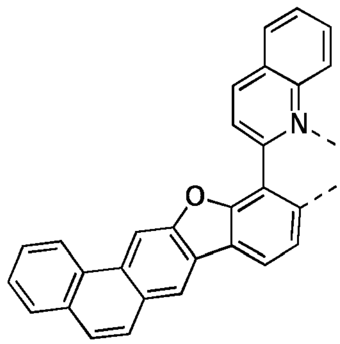

$L_{A71}$ ,

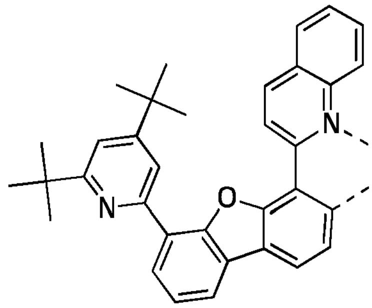

$L_{A72}$ ,

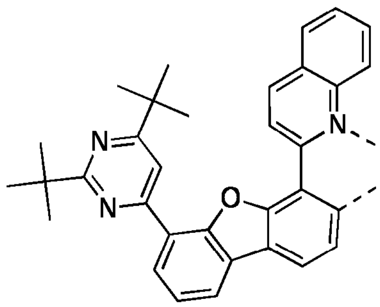

$L_{A73}$ ,

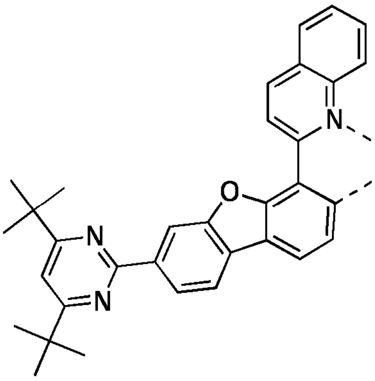

$L_{A74}$ ,

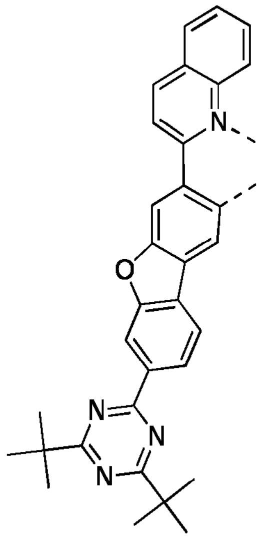

$L_{A75}$ ,

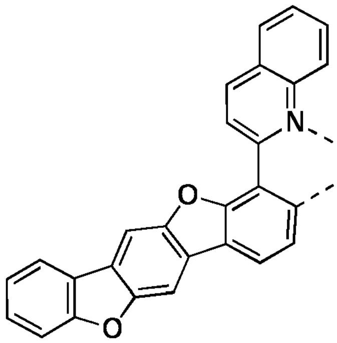

$L_{A76}$ ,

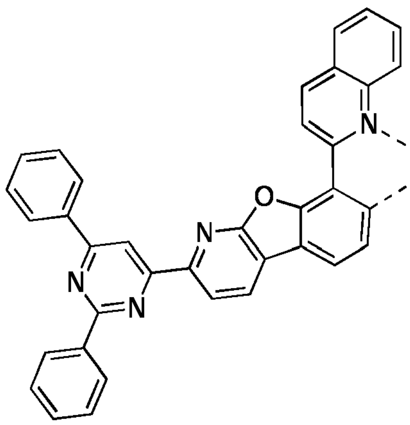

$L_{A77}$ ,

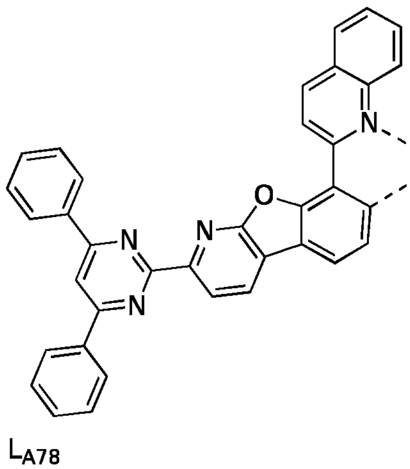

$L_{A78}$ ,

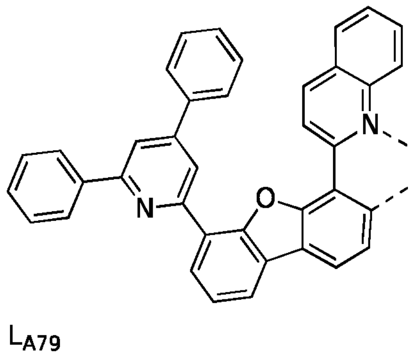

$L_{A79}$ ,

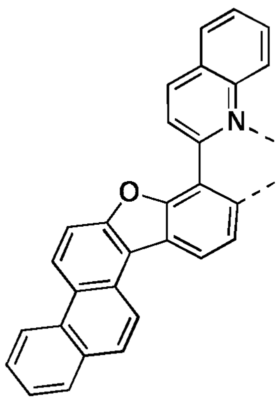

$L_{A80}$ ,

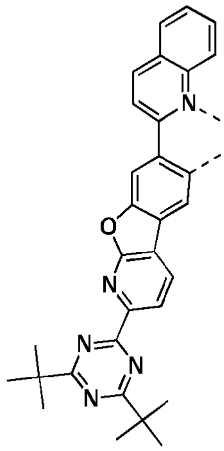

$L_{A81}$ ,

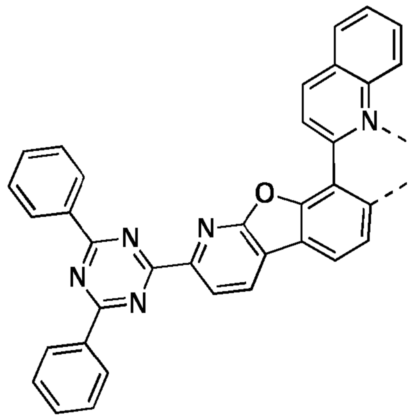

$L_{A82}$ ,

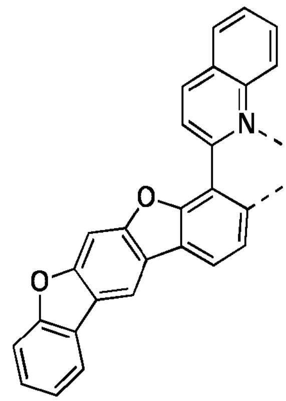

$L_{A83}$ ,

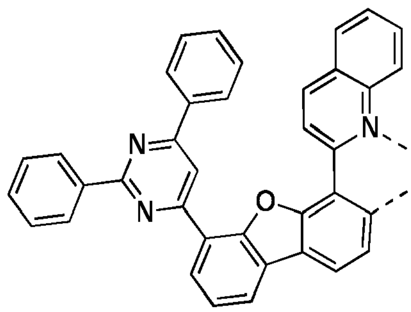

$L_{A84}$ ,

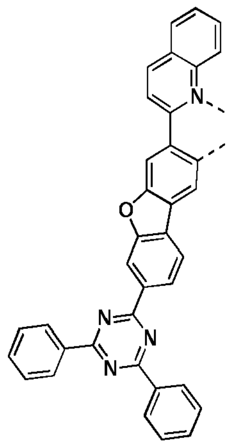

$L_{A85}$ ,

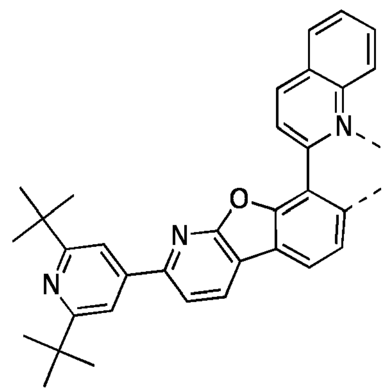

$L_{A86}$ ,

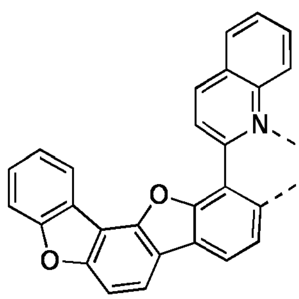

$L_{A87}$ ,

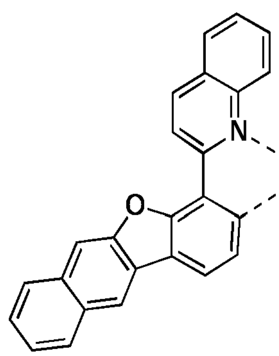

$L_{A88}$ ,

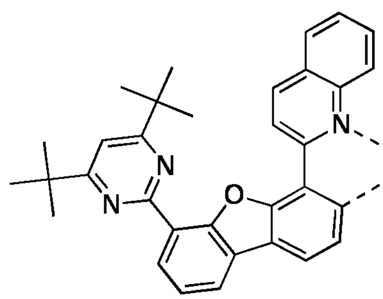

$L_{A89}$ ,

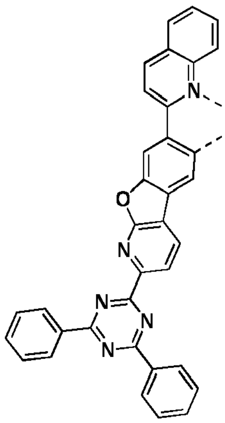

$L_{A90}$ ,

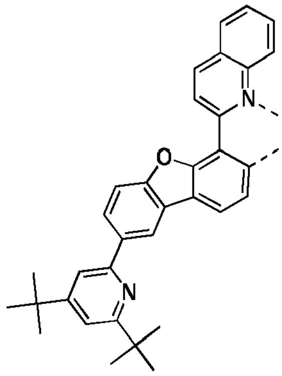

$L_{A91}$ ,

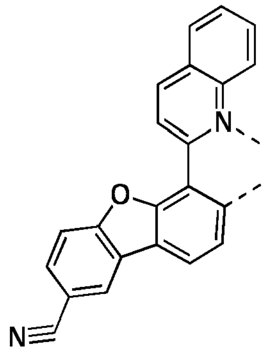

$L_{A92}$ ,

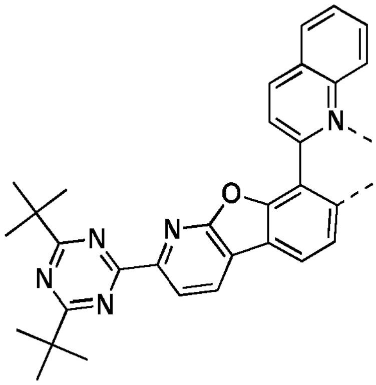

$L_{A93}$ ,

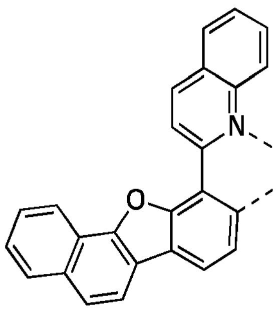

$L_{A94}$ ,

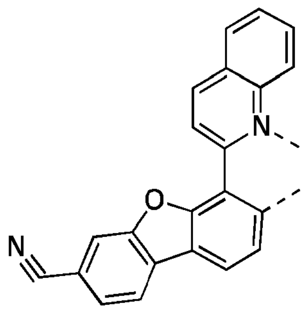

$L_{A95}$ ,

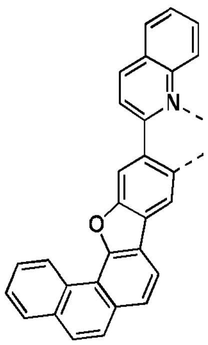

$L_{A96}$ ,

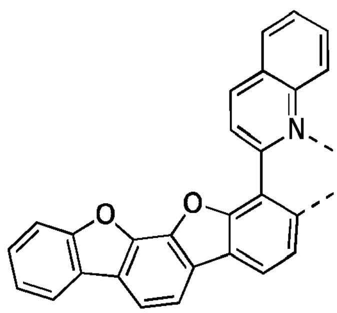

$L_{A97}$ ,

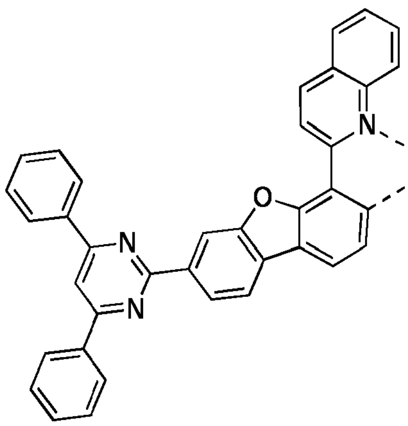

$L_{A98}$ ,

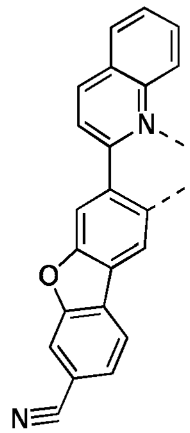
$L_{A99}$ , 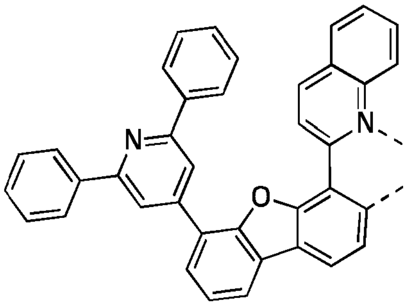
$L_{A100}$ , 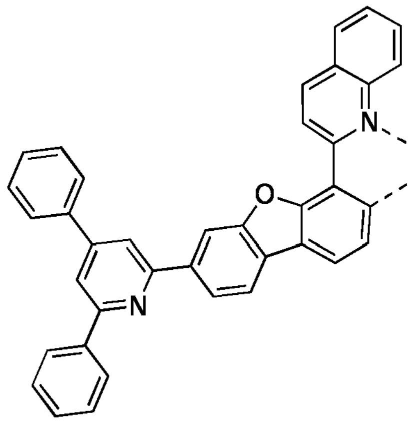
$L_{A101}$ ,

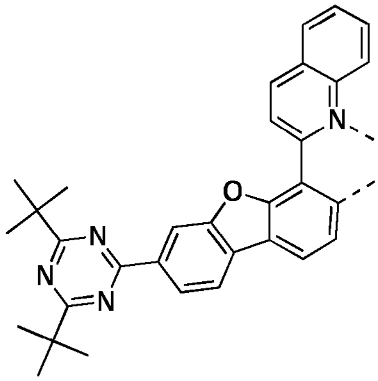
$L_{A102}$ , 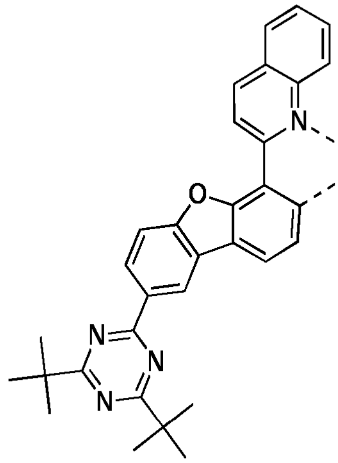
$L_{A103}$ , 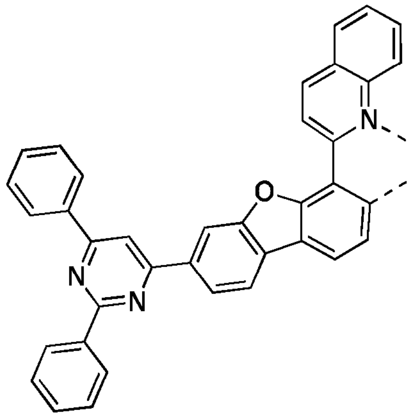
$L_{A104}$ ,

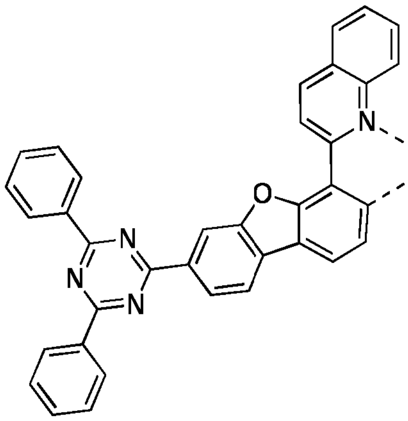
$L_{A105}$ , 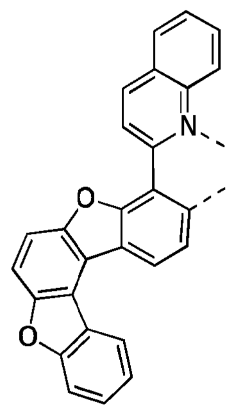
$L_{A106}$ , 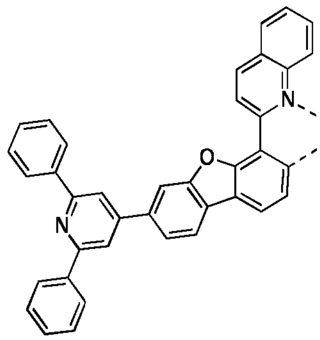
$L_{A107}$ ,

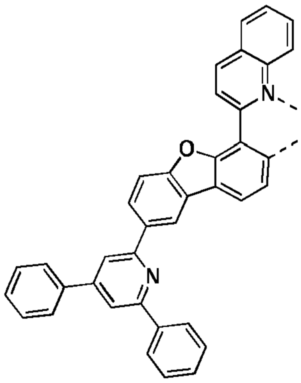
$L_{A108}$ ,

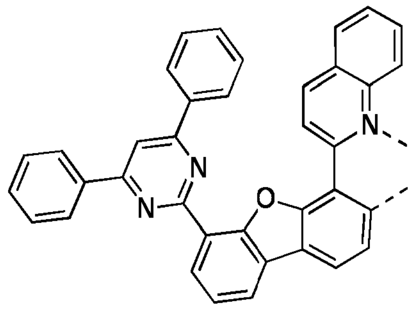
$L_{A109}$ ,

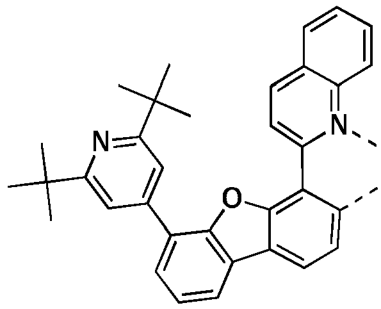
$L_{A110}$ ,

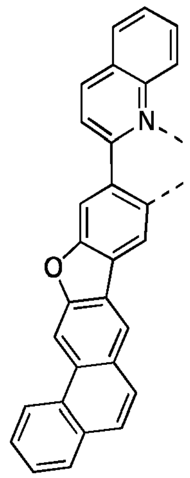
$L_{A111}$ ,

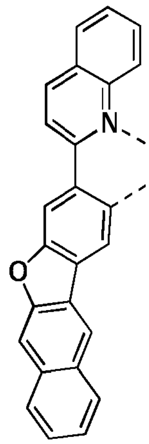
$L_{A112}$ ,

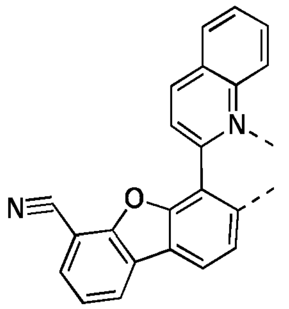
$L_{A113}$ ,

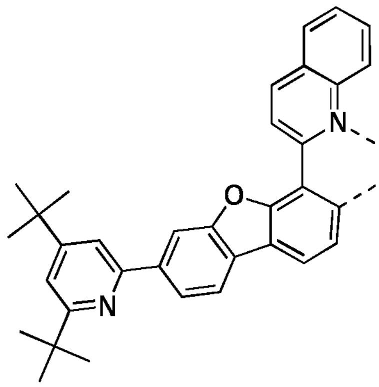
$L_{A114}$ ,

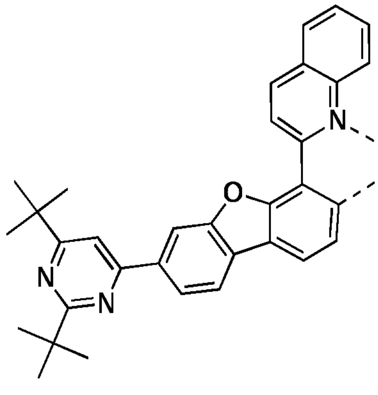
$L_{A115}$ ,

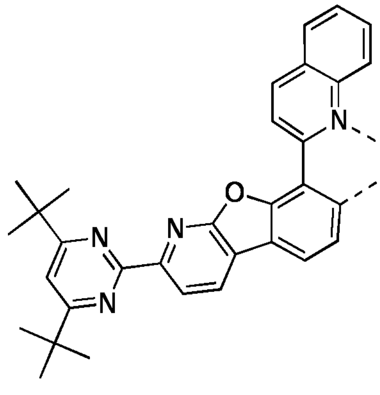
$L_{A116}$ ,

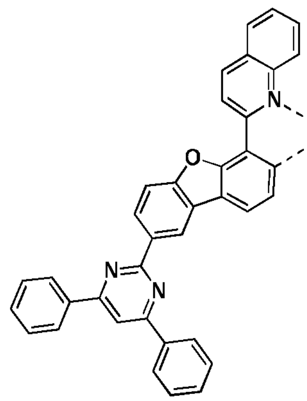
$L_{A117}$ ,

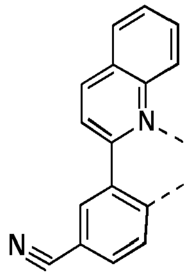

$L_{A118}$ ,

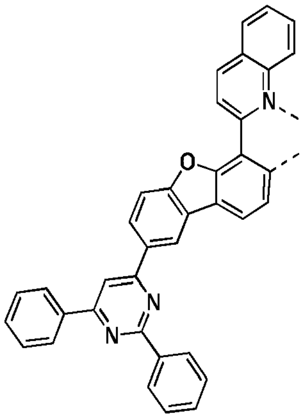

$L_{A119}$ ,

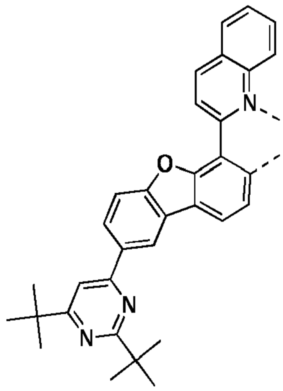

$L_{A120}$ ,

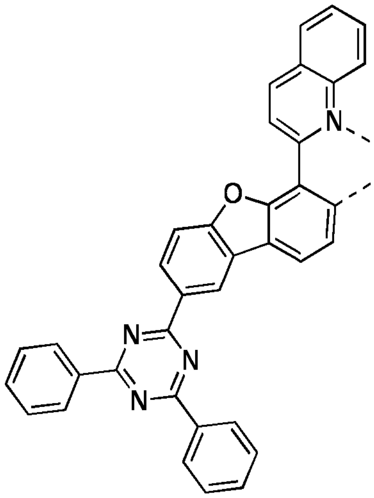

$L_{A121}$ ,

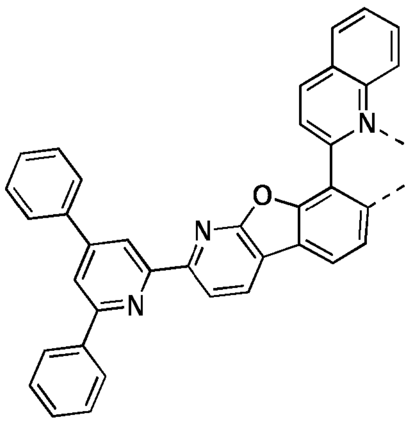

$L_{A122}$ ,

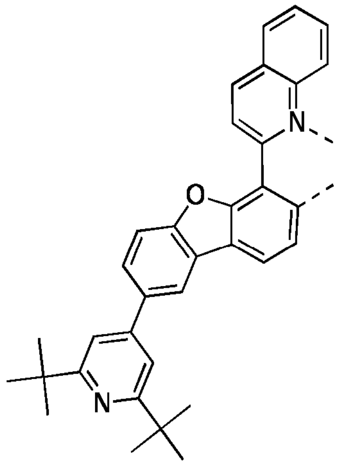

$L_{A123}$ ,

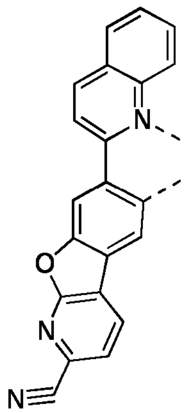

$L_{A124}$ ,

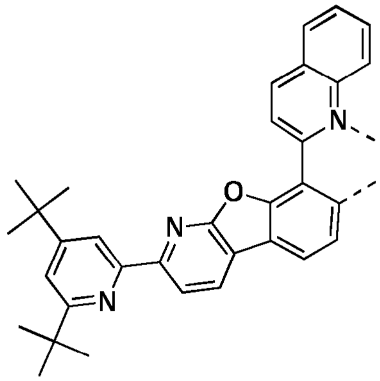

$L_{A125}$ ,

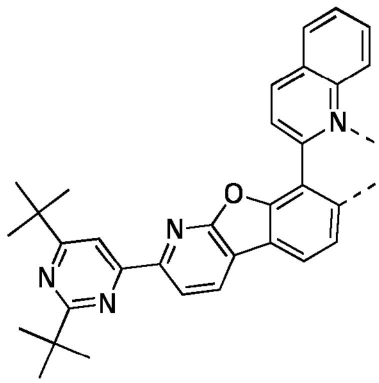

$L_{A126}$ ,

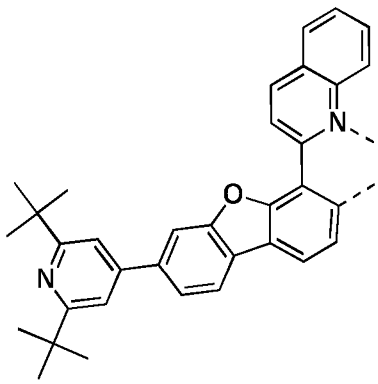

$L_{A127}$ ,

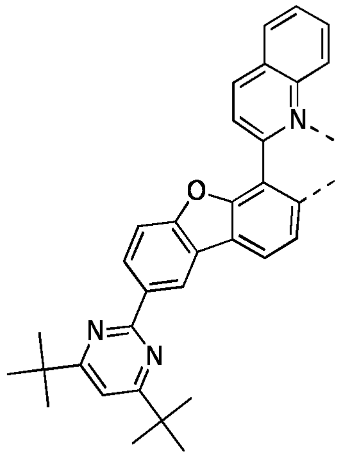

$L_{A128}$ ,

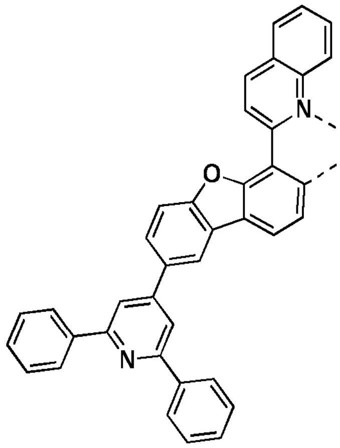

$L_{A129}$ ,

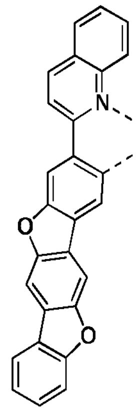

$L_{A130}$ ,

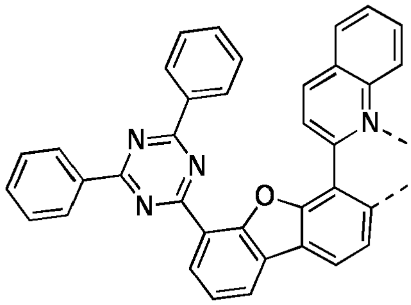

$L_{A131}$ ,

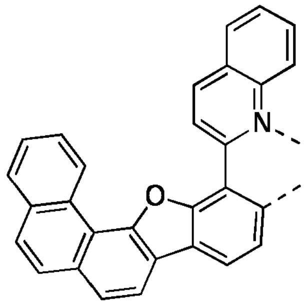

$L_{A132}$ ,

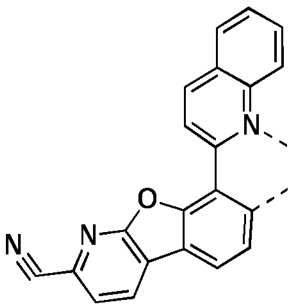

$L_{A133}$ ,

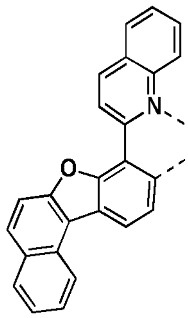

$L_{A134}$ ,

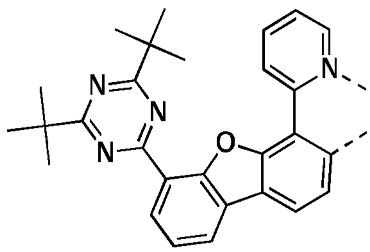

$L_{A135}$ ,

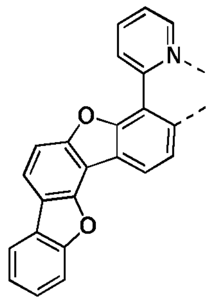

$L_{A136}$ ,

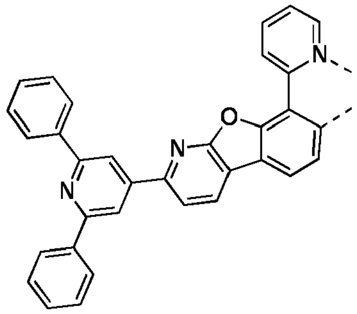

$L_{A137}$ ,

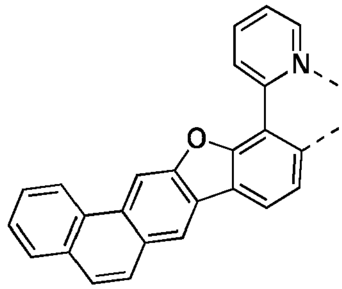

$L_{A138}$ ,

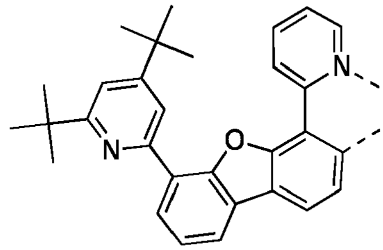

$L_{A139}$ ,

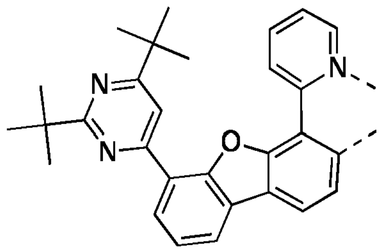

$L_{A140}$ ,

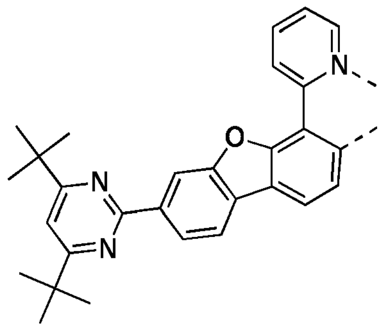

$L_{A141}$ ,

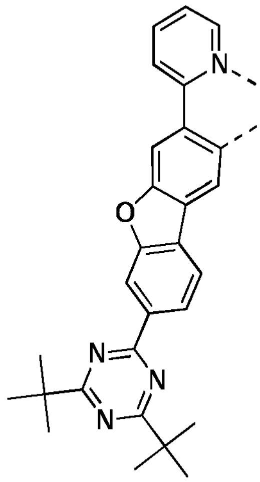

$L_{A142}$ ,

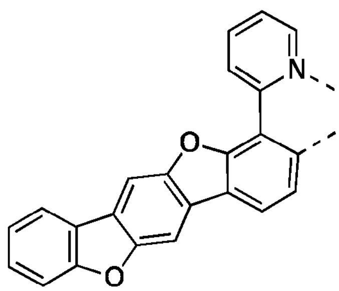

$L_{A143}$ ,

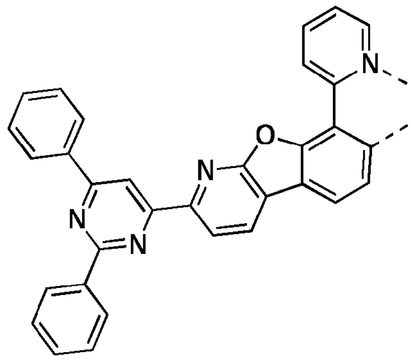

$L_{A144}$ ,

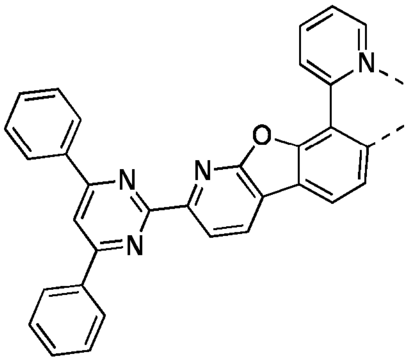
$L_{A145}$ ,
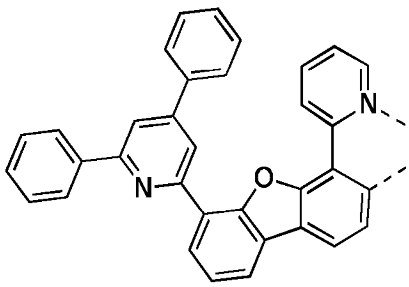
$L_{A146}$ ,
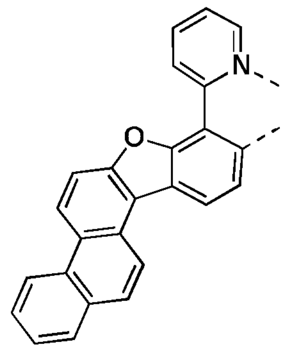
$L_{A147}$ ,

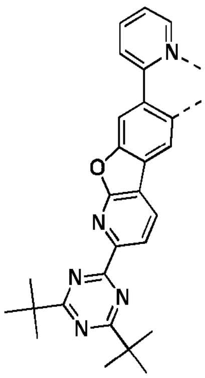
$L_{A148}$ ,
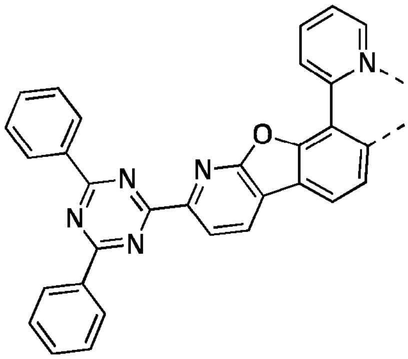
$L_{A149}$ ,
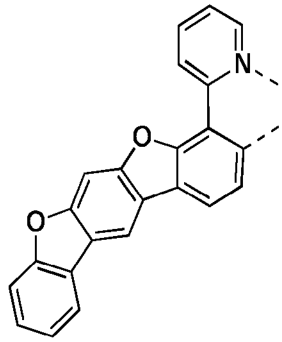
$L_{A150}$ ,

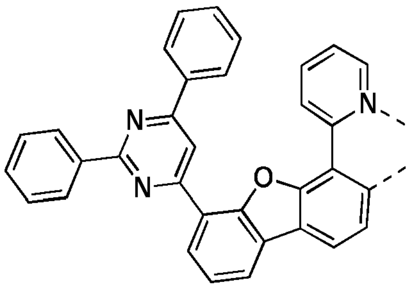
$L_{A151}$ ,
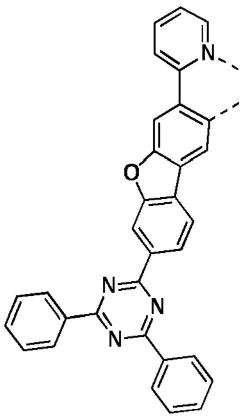
$L_{A152}$ ,
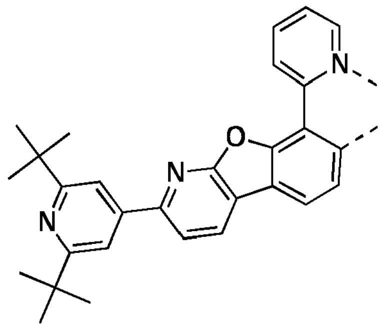
$L_{A153}$ ,

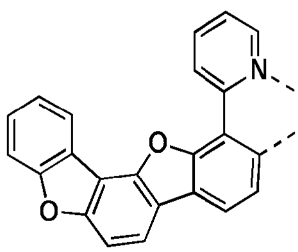
$L_{A154}$ ,
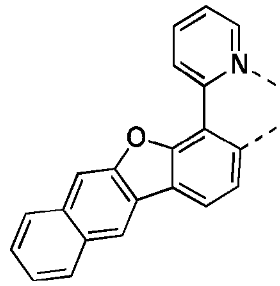
$L_{A155}$ ,
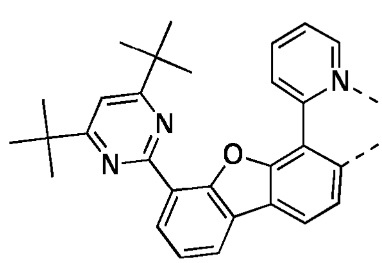
$L_{A156}$ ,

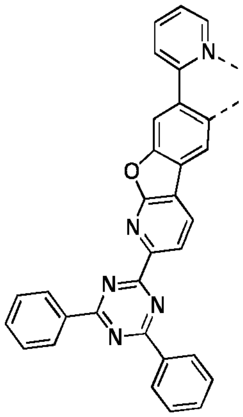
$L_{A157}$ ,
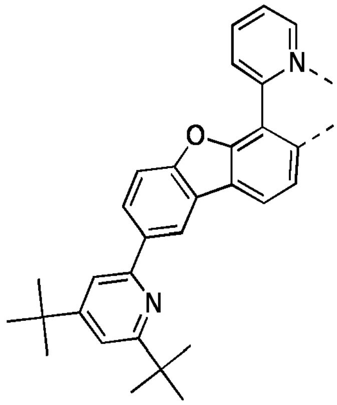
$L_{A158}$ ,
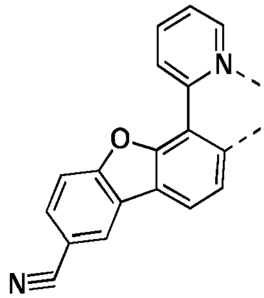
$L_{A159}$ ,

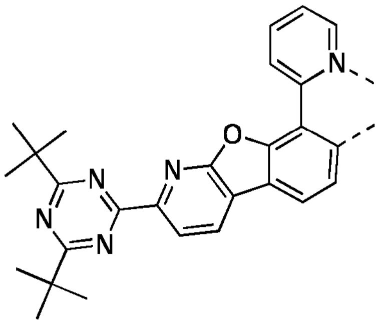
$L_{A160}$ ,
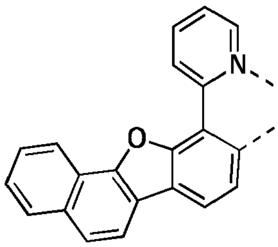
$L_{A161}$ ,
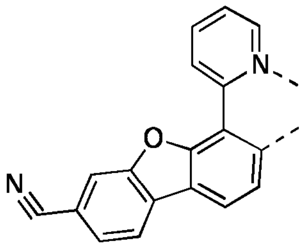
$L_{A162}$ ,

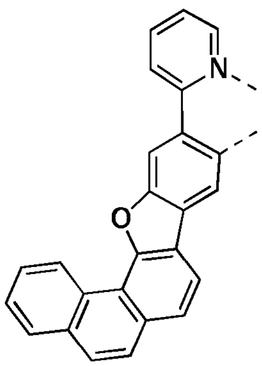
$L_{A163}$ ,
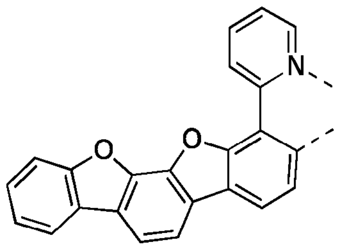
$L_{A164}$ ,
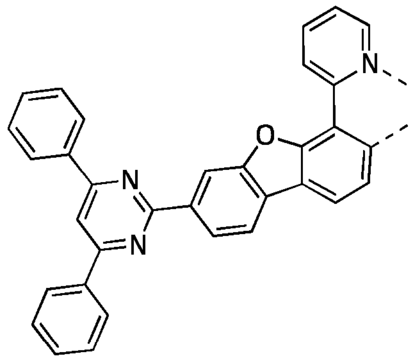
$L_{A165}$ ,

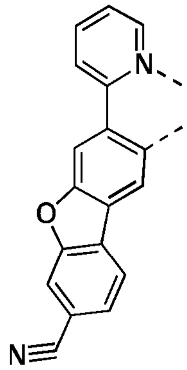
$L_{A166}$ ,
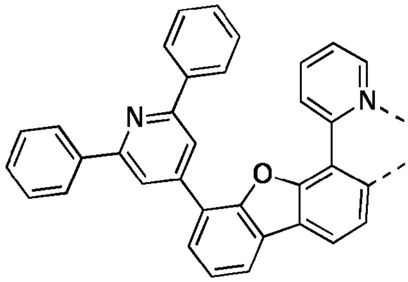
$L_{A167}$ ,
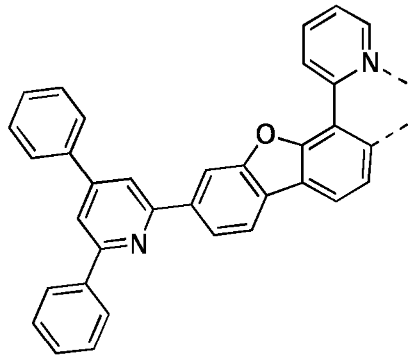
$L_{A168}$ ,

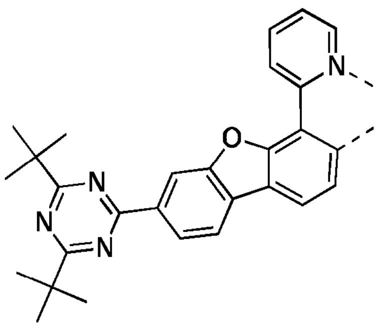
$L_{A169}$ ,
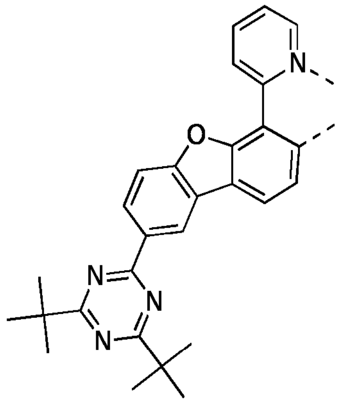
$L_{A170}$ ,
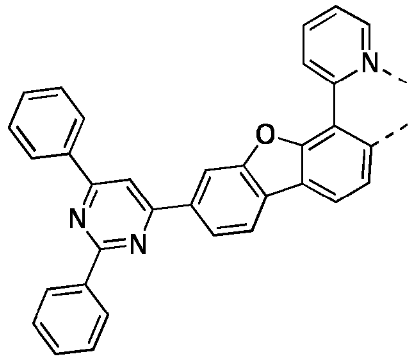
$L_{A171}$ ,

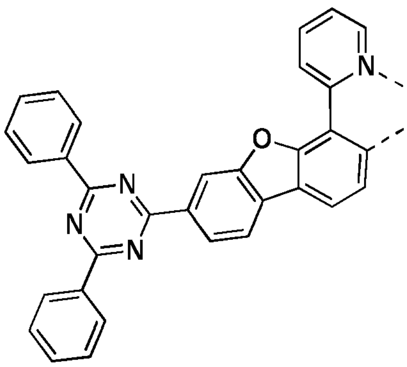
$L_{A172}$ ,
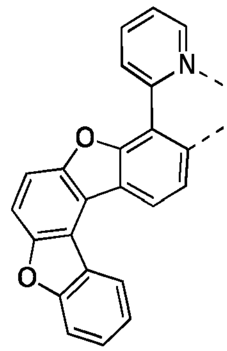
$L_{A173}$ ,
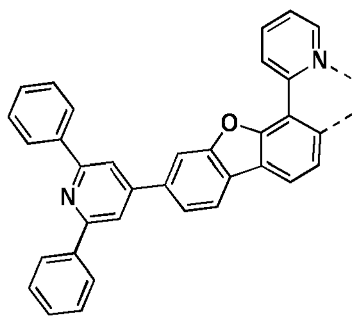
$L_{A174}$ ,

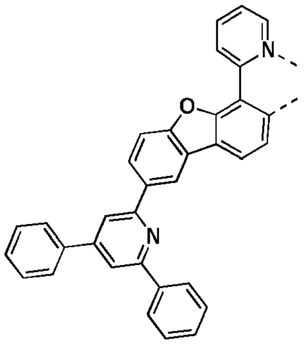

$L_{A175}$ , 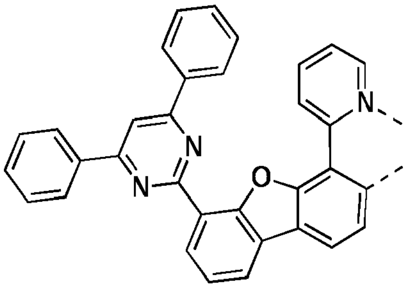

$L_{A176}$ , 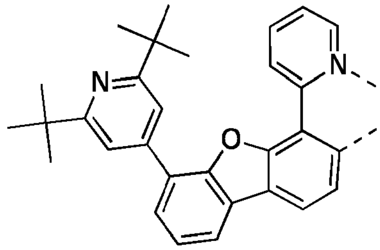

$L_{A177}$ ,

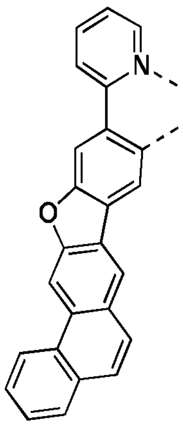

$L_{A178}$ , 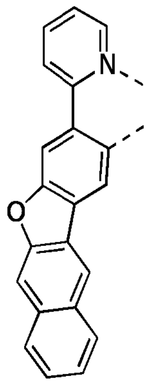

$L_{A179}$ , 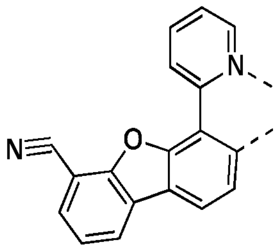

$L_{A180}$ , 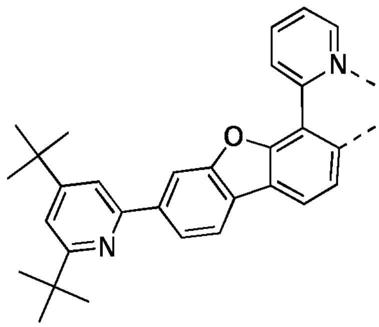

$L_{A181}$ ,

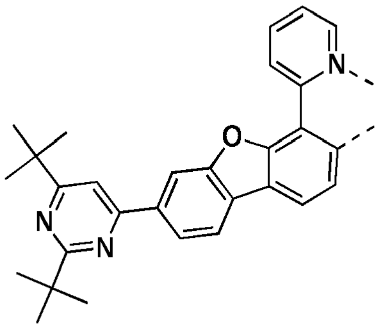

$L_{A182}$ , 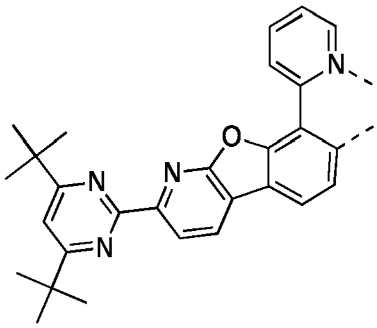

$L_{A183}$ , 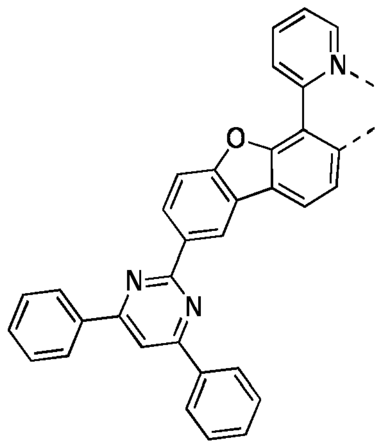

$L_{A184}$ ,

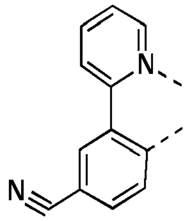

$L_{A185}$ ,

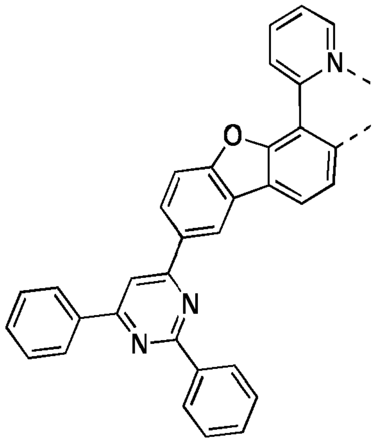

$L_{A186}$ ,

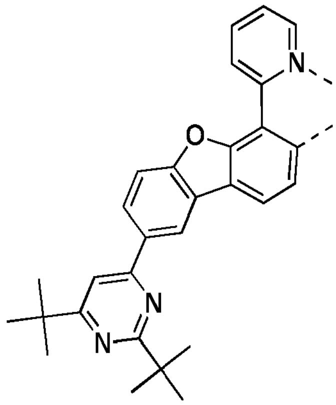

$L_{A187}$ ,

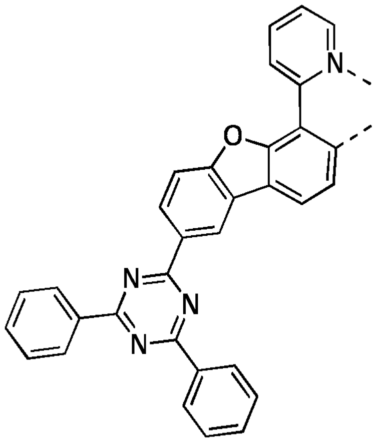

$L_{A188}$ ,

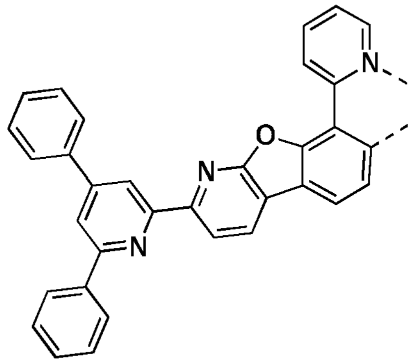

$L_{A189}$ ,

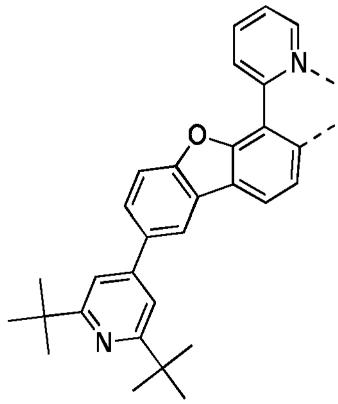

$L_{A190}$ ,

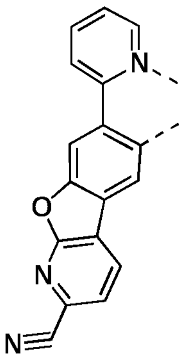

$L_{A191}$ ,

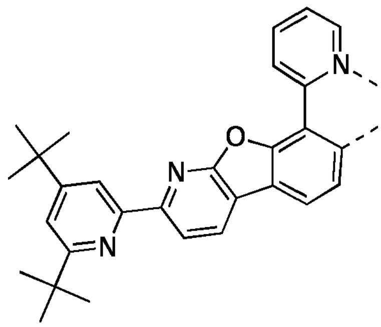

$L_{A192}$ ,

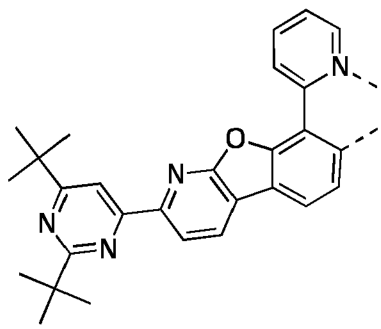

$L_{A193}$ ,

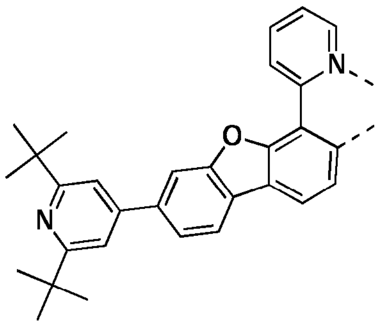

$L_{A194}$ , 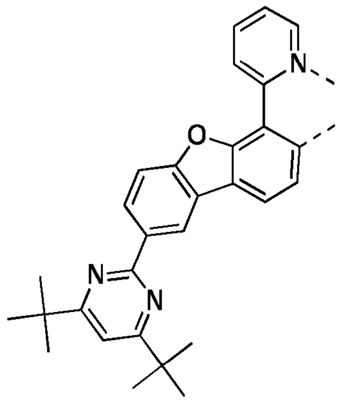

$L_{A195}$ , 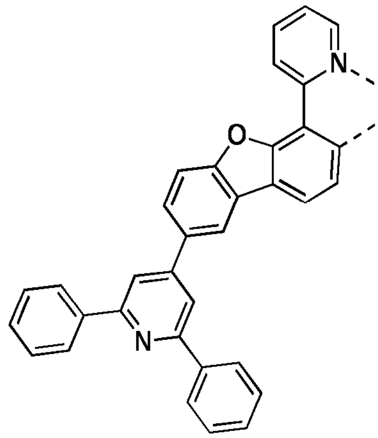

$L_{A196}$ ,

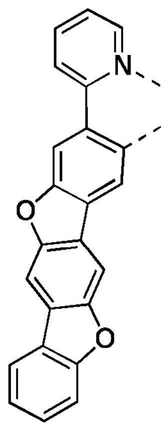

$L_{A197}$ , 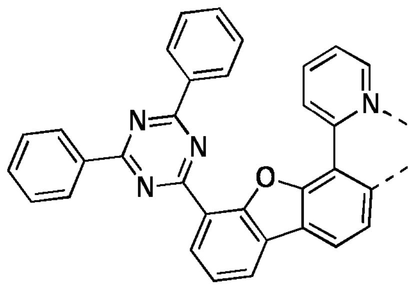

$L_{A198}$ , 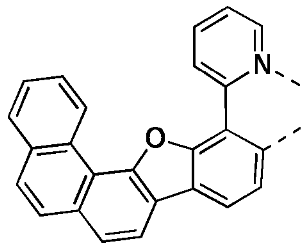

$L_{A199}$ ,

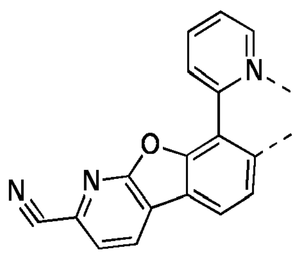

$L_{A200}$ , 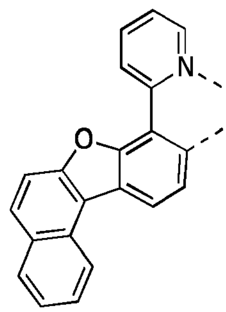

$L_{A201}$ , 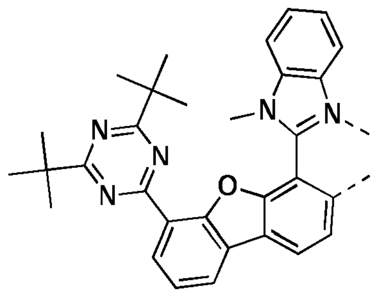

$L_{A202}$ ,

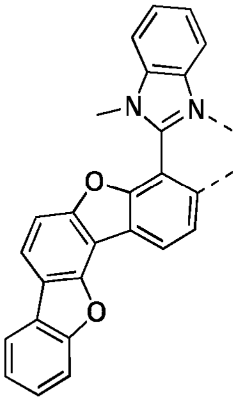

$L_{A203}$ ,

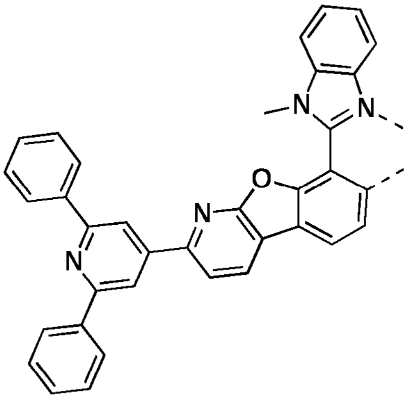

$L_{A204}$ ,

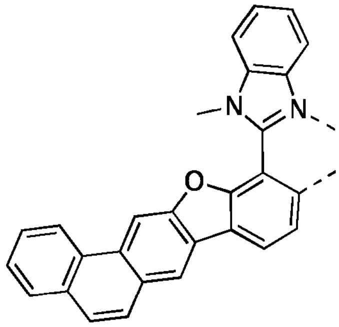

$L_{A205}$ ,

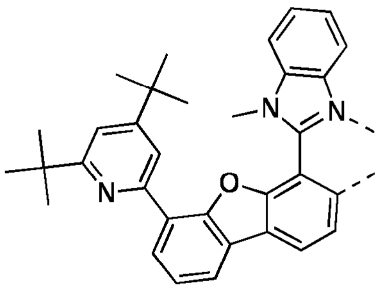

$L_{A206}$ ,

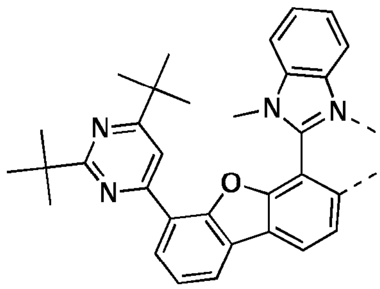

$L_{A207}$ ,

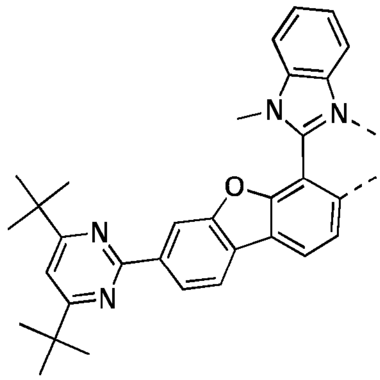

$L_{A208}$ ,

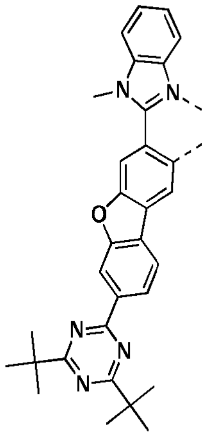

$L_{A209}$ ,

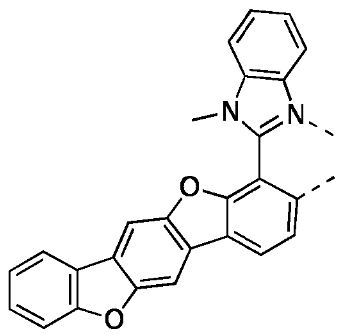

$L_{A210}$ ,

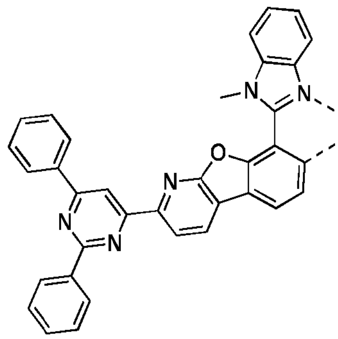

$L_{A211}$ ,

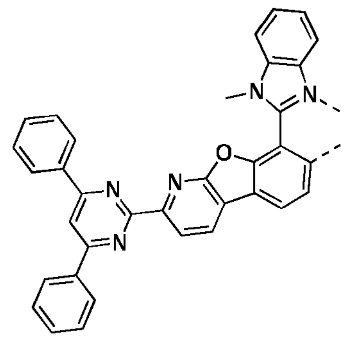
$L_{A212}$ ,

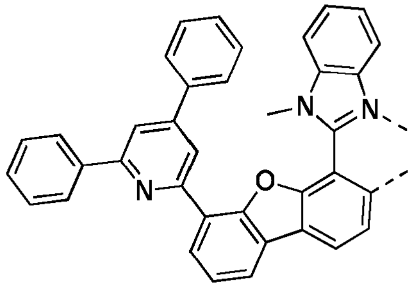
$L_{A213}$ ,

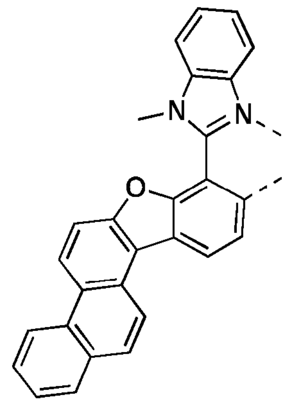
$L_{A214}$ ,

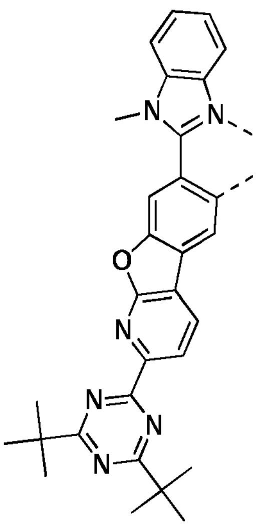
$L_{A215}$ ,

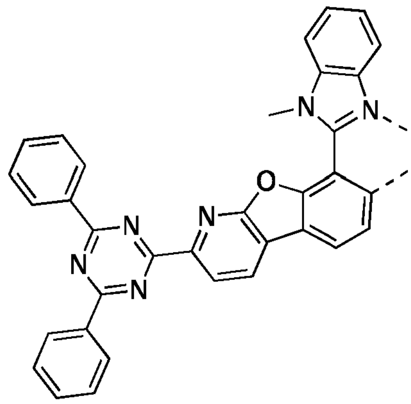
$L_{A216}$ ,

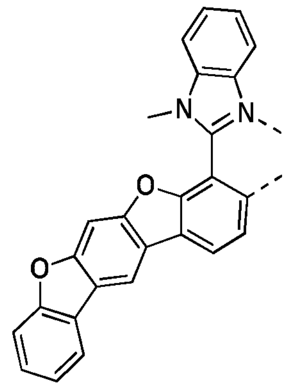
$L_{A217}$ ,

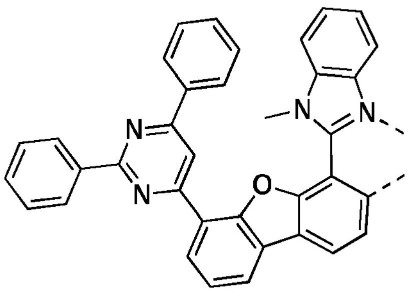
$L_{A218}$ ,

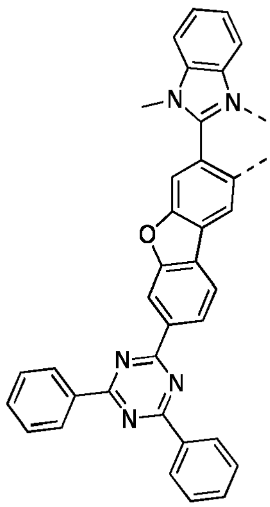
$L_{A219}$ ,

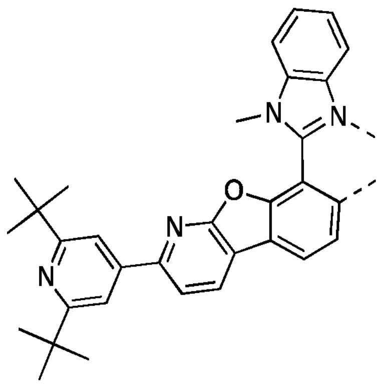
$L_{A220}$ ,

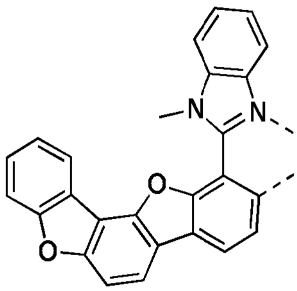
$L_{A221}$ ,
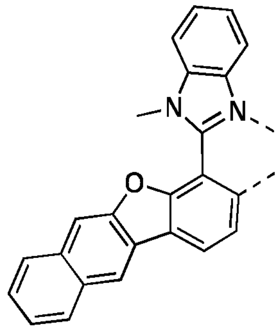
$L_{A222}$ ,
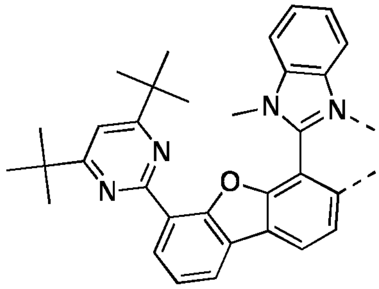
$L_{A223}$ ,

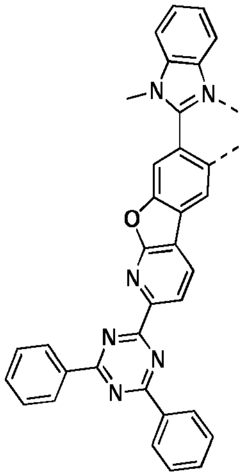
$L_{A224}$ ,
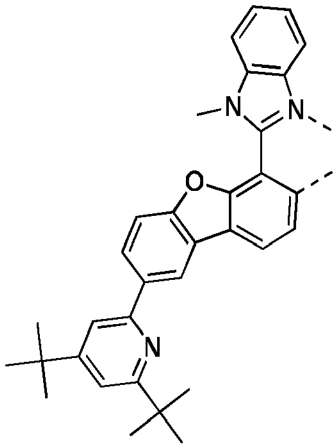
$L_{A225}$ ,
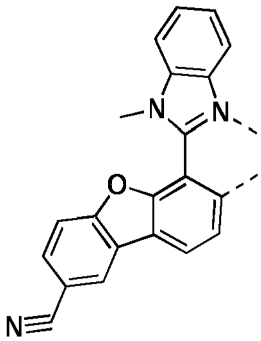
$L_{A226}$ ,

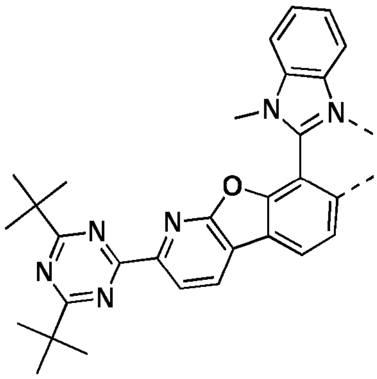
$L_{A227}$ ,
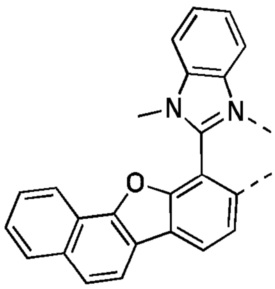
$L_{A228}$ ,
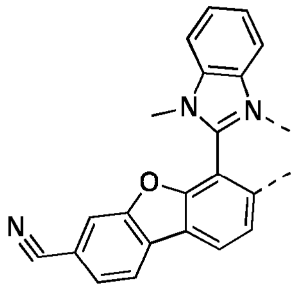
$L_{A229}$ ,

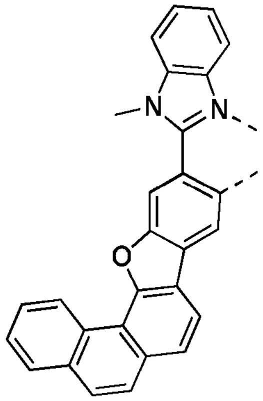

$L_{A230}$ ,

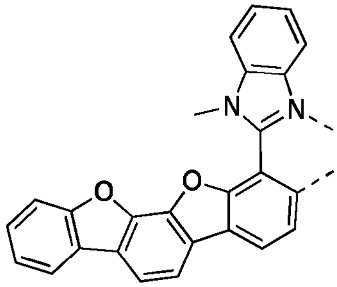

$L_{A231}$ ,

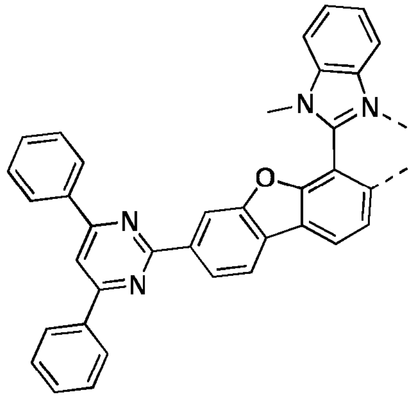

$L_{A232}$ ,

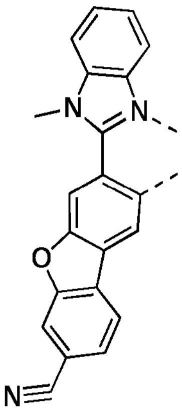

$L_{A233}$ ,

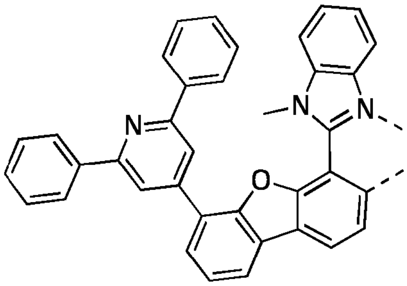

$L_{A234}$ ,

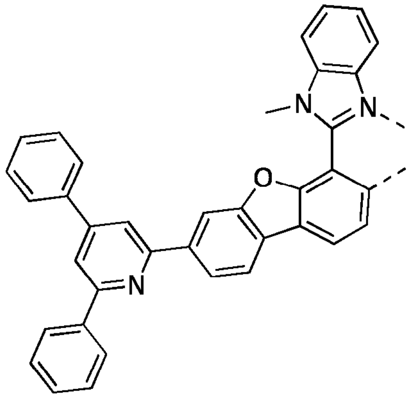

$L_{A235}$ ,

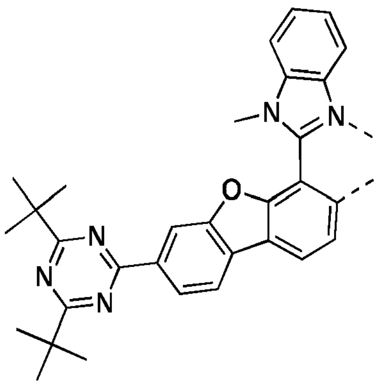

$L_{A236}$ ,

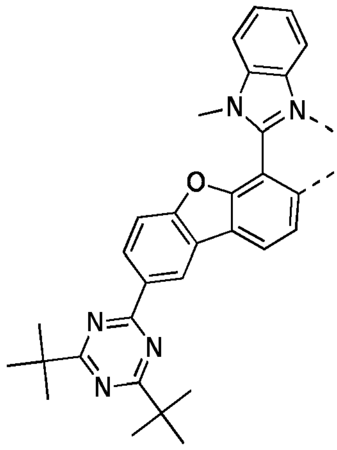

$L_{A237}$ ,

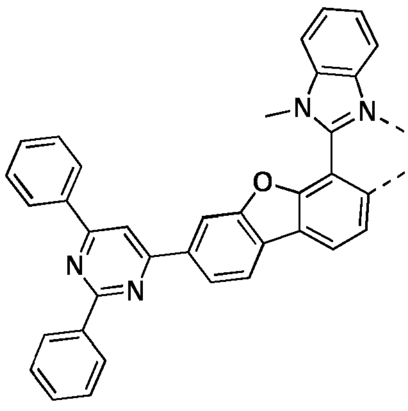

$L_{A238}$ ,

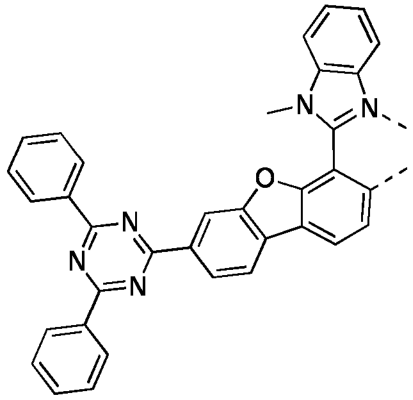

$L_{A239}$ ,

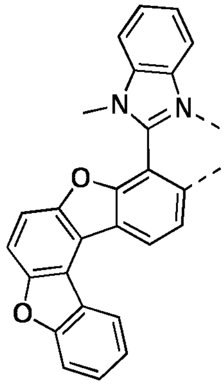

$L_{A240}$ ,

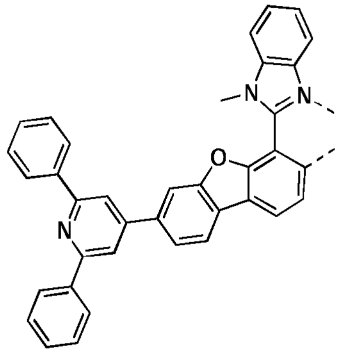

$L_{A241}$ ,

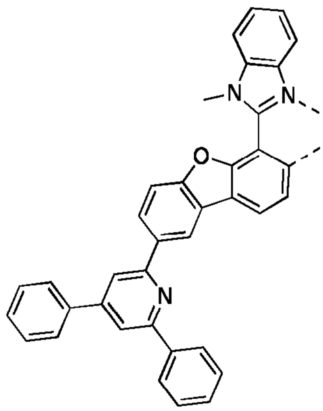

$L_{A242}$ ,

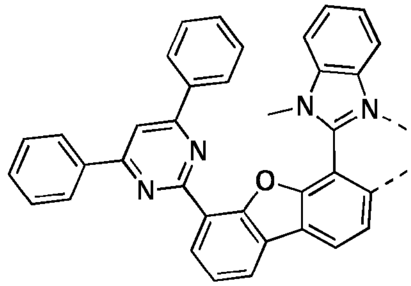

$L_{A243}$ ,

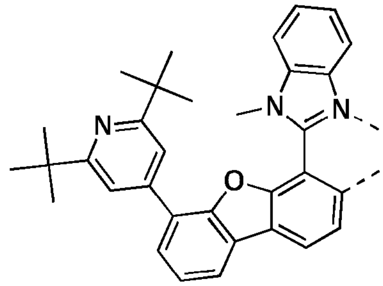

$L_{A244}$ ,

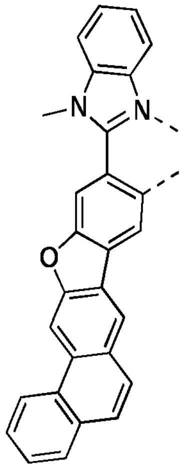

$L_{A245}$ ,

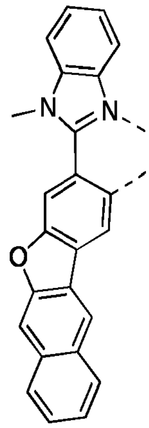

$L_{A246}$ ,

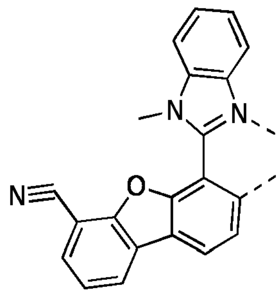

$L_{A247}$ ,

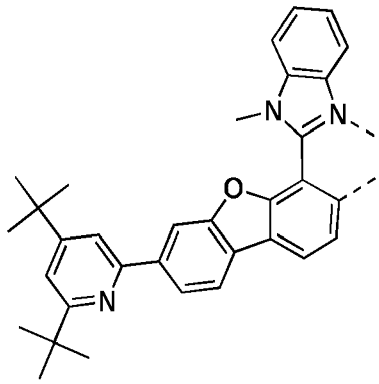

$L_{A248}$ ,

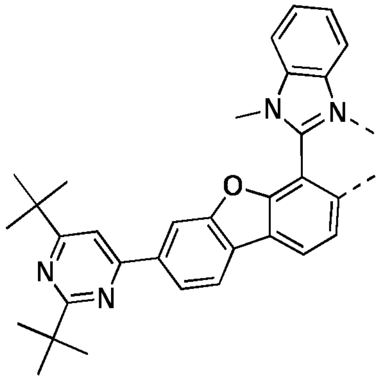
$L_{A249}$ ,
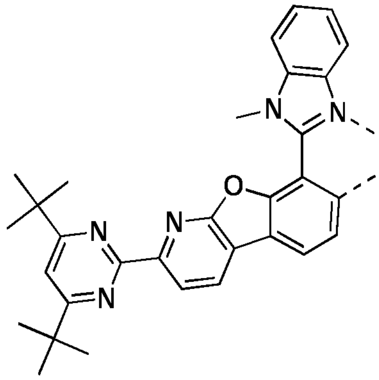
$L_{A250}$ ,
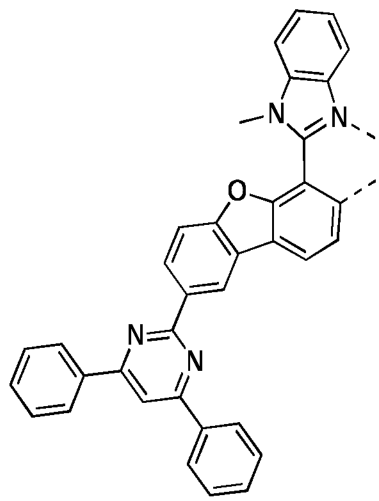
$L_{A251}$ ,

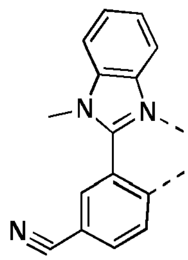
$L_{A252}$ ,
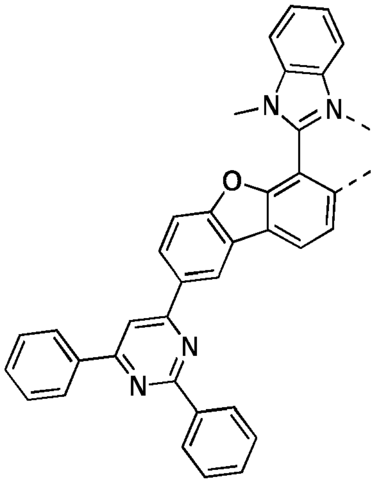
$L_{A253}$ ,
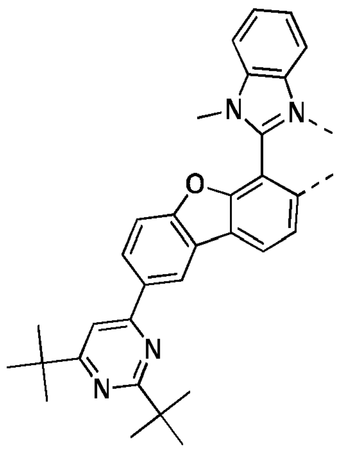
$L_{A254}$ ,

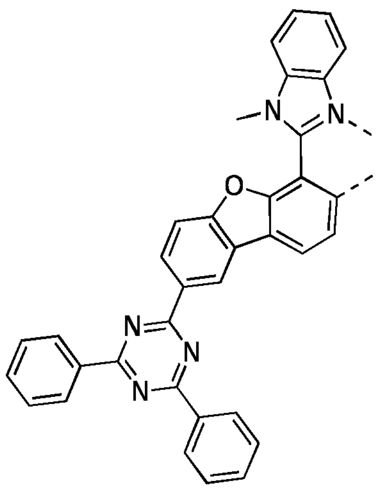
$L_{A255}$ ,
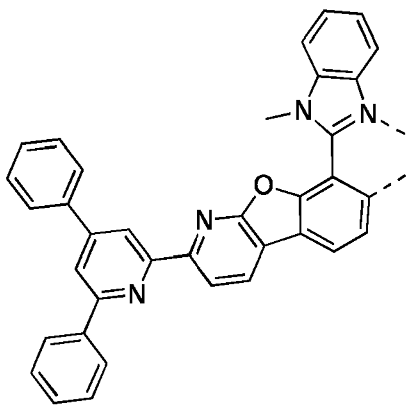
$L_{A256}$ ,
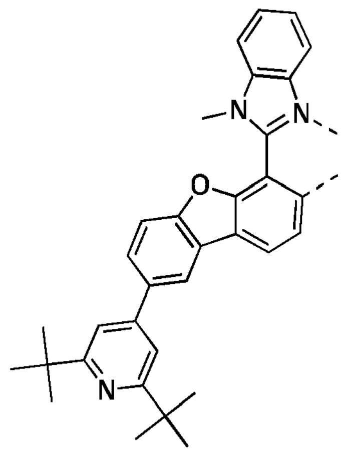
$L_{A257}$ ,

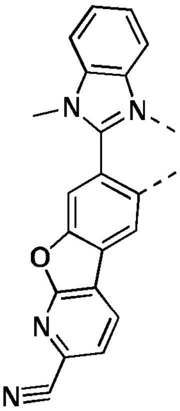
$L_{A258}$ ,
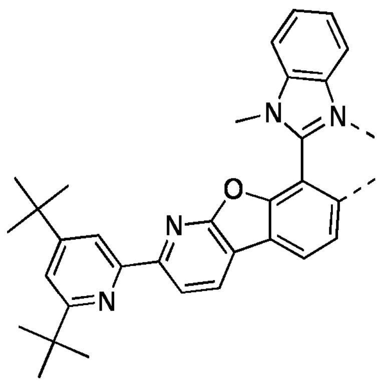
$L_{A259}$ ,
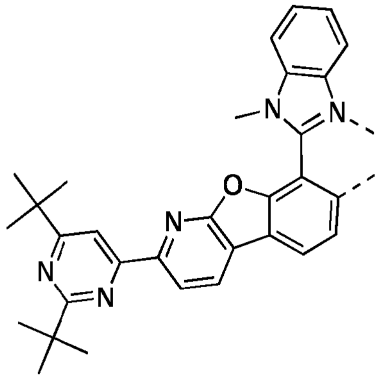
$L_{A260}$ ,

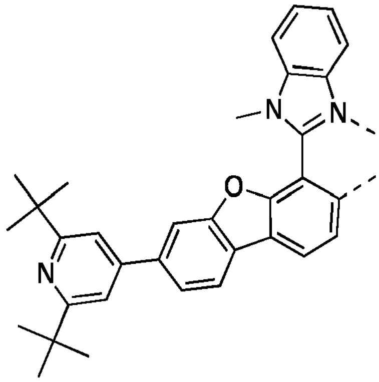
$L_{A261}$ ,
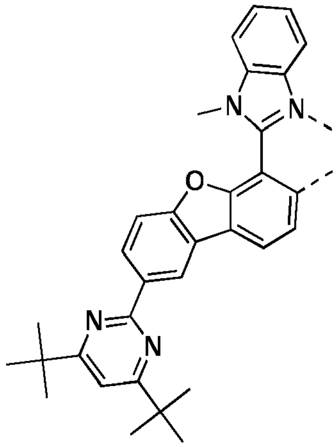
$L_{A262}$ ,
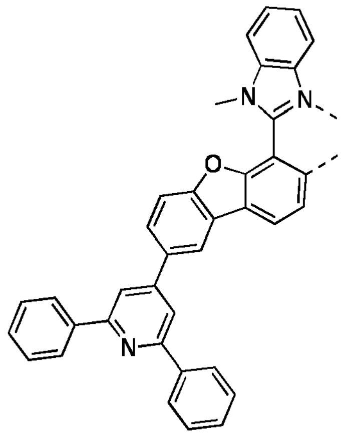
$L_{A263}$ ,

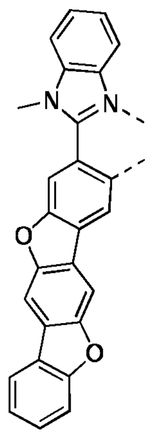
$L_{A264}$ ,
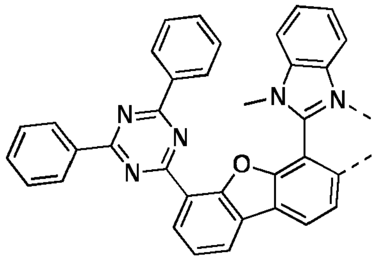
$L_{A265}$ ,
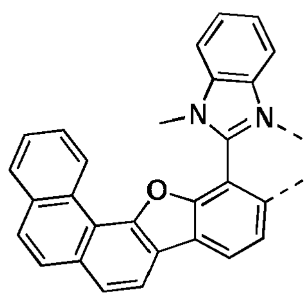
$L_{A266}$ ,
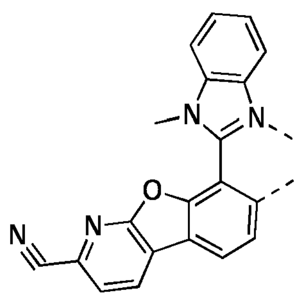
$L_{A267}$

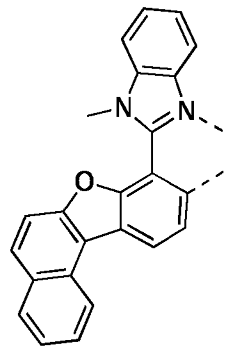

, $L_{A268}$

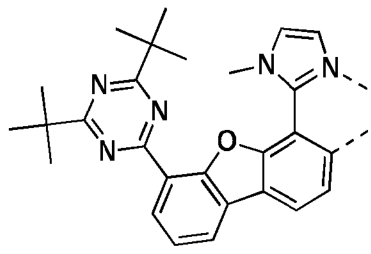

, $L_{A269}$

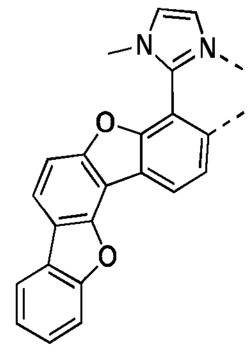

, $L_{A270}$ ,

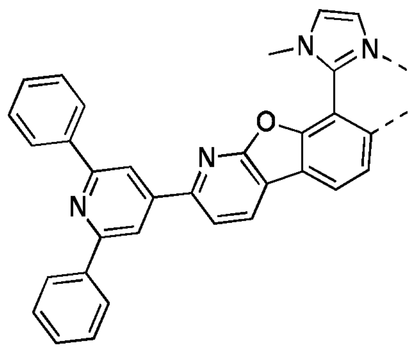

$L_{A271}$

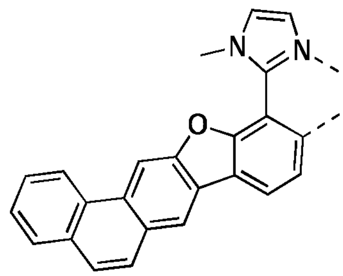

, $L_{A272}$

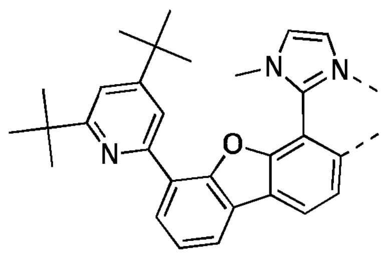

, $L_{A273}$ ,

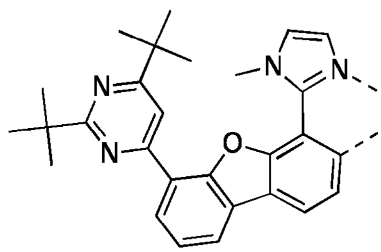

$L_{A274}$

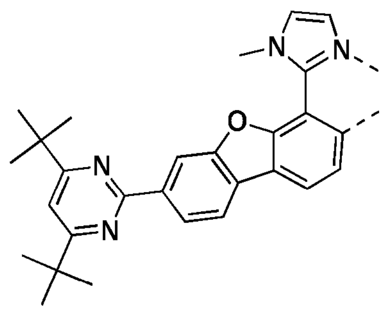

, $L_{A275}$

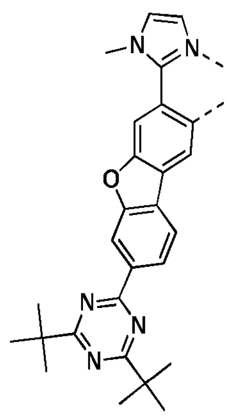

, $L_{A276}$ ,

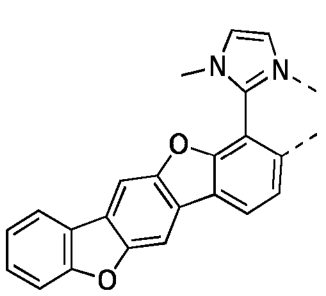

$L_{A277}$ ,

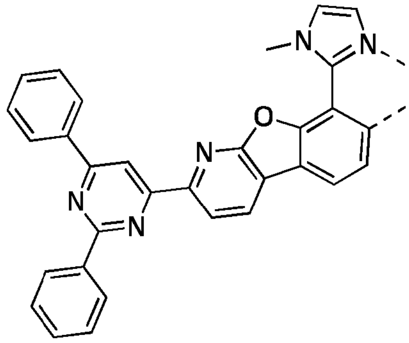

$L_{A278}$ ,

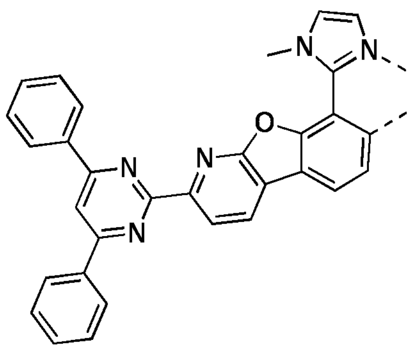

$L_{A279}$ ,

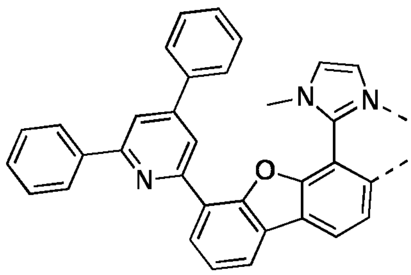

$L_{A280}$ ,

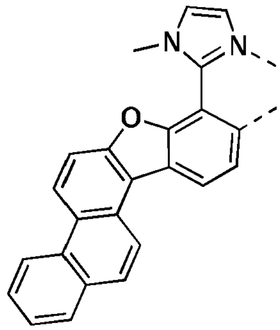

$L_{A281}$ ,

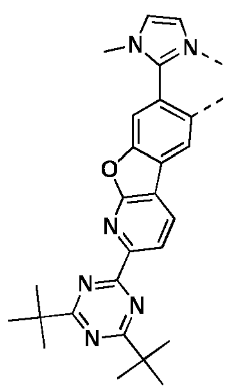

$L_{A282}$ ,

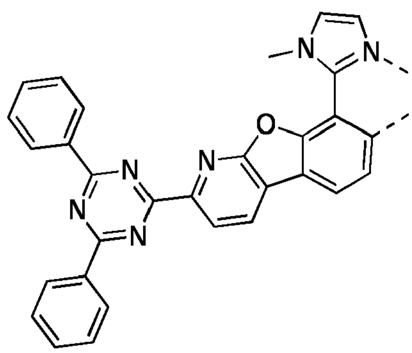

$L_{A283}$ ,

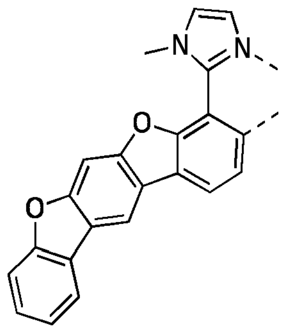

$L_{A284}$ ,

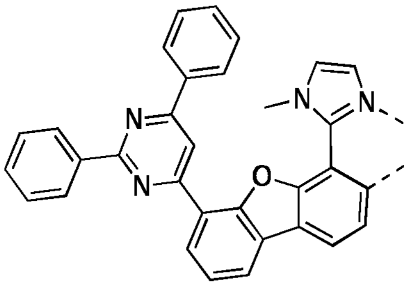

$L_{A285}$ ,

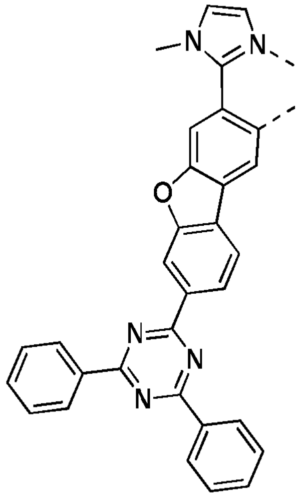

$L_{A286}$ ,

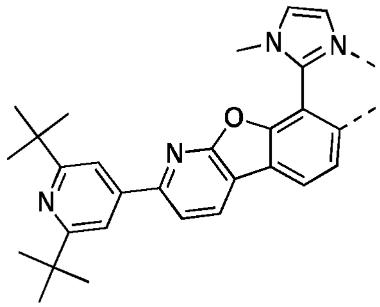

$L_{A287}$ ,

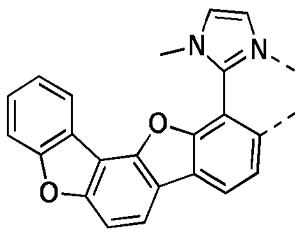

$L_{A288}$ ,

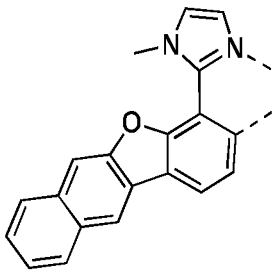

$L_{A289}$ ,

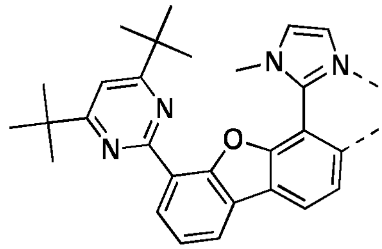

$L_{A290}$ ,

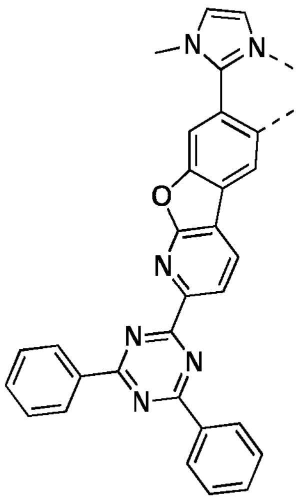

$L_{A291}$ ,

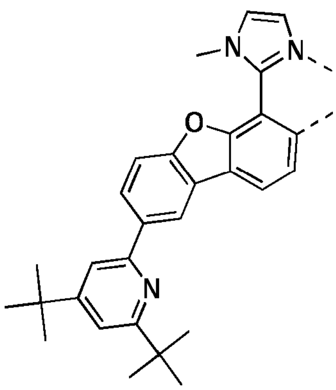

$L_{A292}$ ,

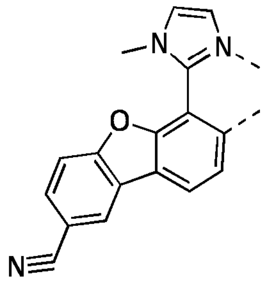

$L_{A293}$ ,

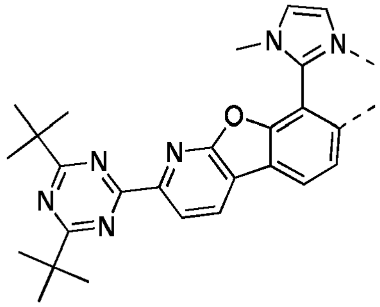
$L_{A294}$ ,

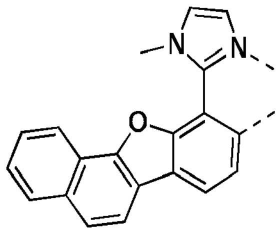
$L_{A295}$ ,

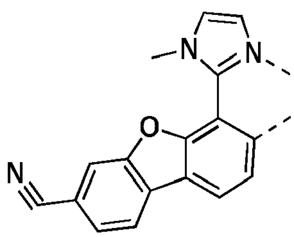
$L_{A296}$ ,

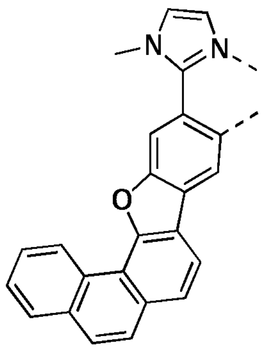
$L_{A297}$ ,

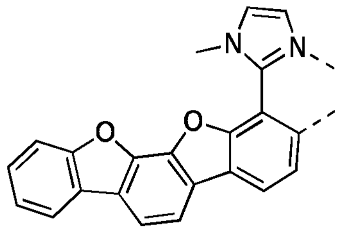
$L_{A298}$ ,

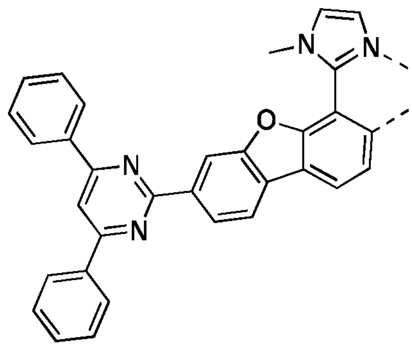
$L_{A299}$ ,

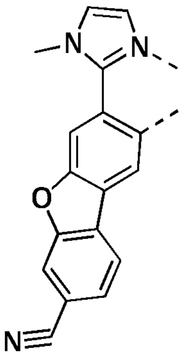
$L_{A300}$ ,

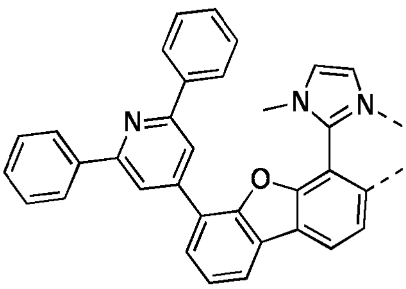
$L_{A301}$ ,

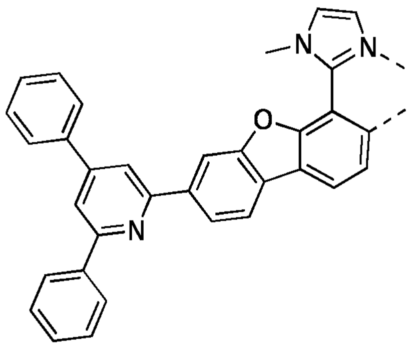
$L_{A302}$ ,

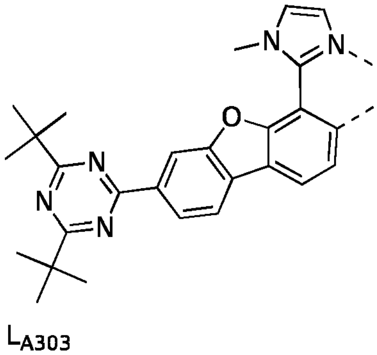
$L_{A303}$ ,

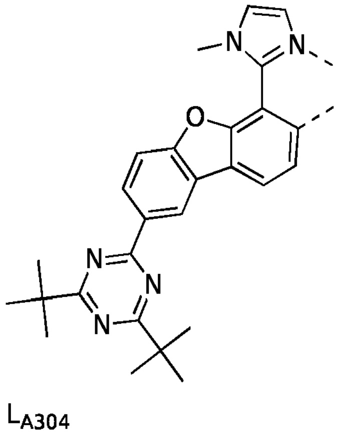
$L_{A304}$ ,

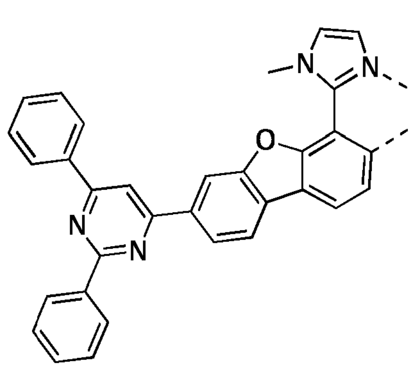
$L_{A305}$ ,

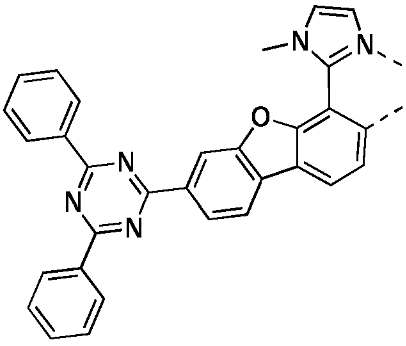

$L_{A306}$ , 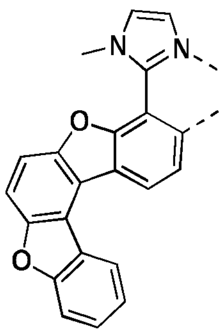

$L_{A307}$ , 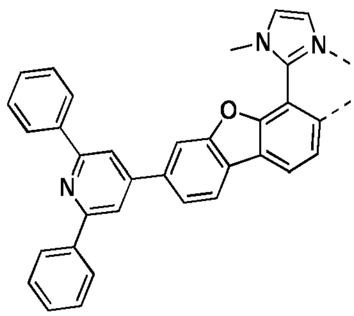

$L_{A308}$ ,

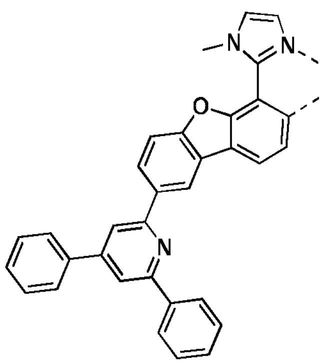

$L_{A309}$ , 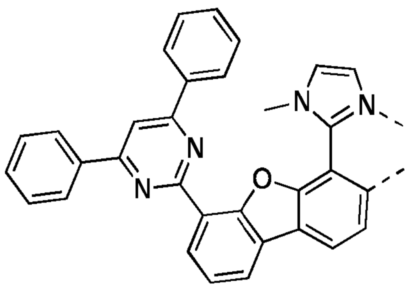

$L_{A310}$ , 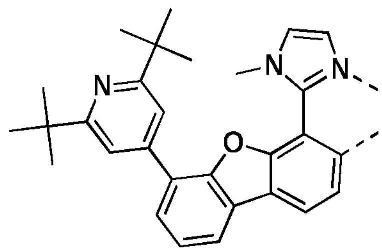

$L_{A311}$ ,

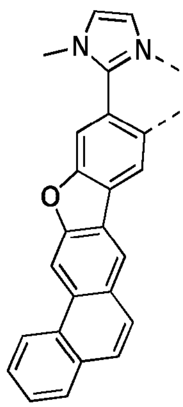

$L_{A312}$ , 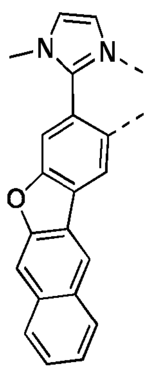

$L_{A313}$ , 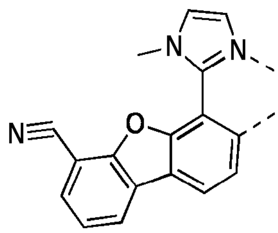

$L_{A314}$ , 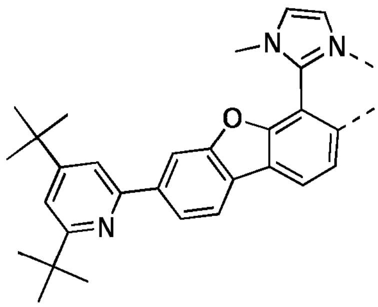

$L_{A315}$ ,

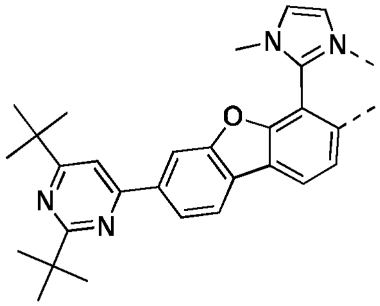

$L_{A316}$ ,

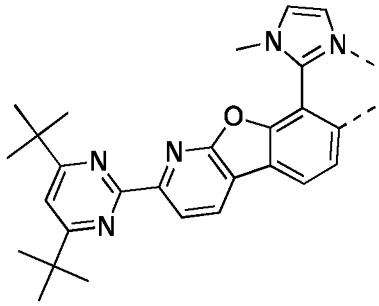

$L_{A317}$ ,

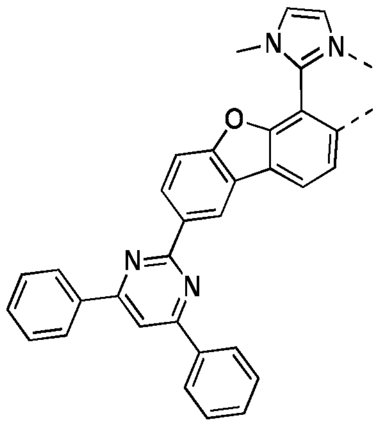

$L_{A318}$ ,

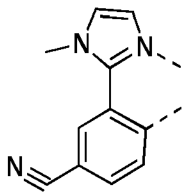

$L_{A319}$ ,

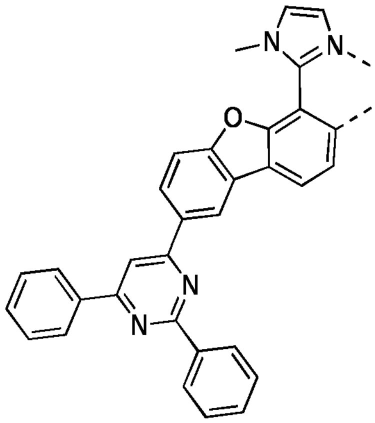

$L_{A320}$ ,

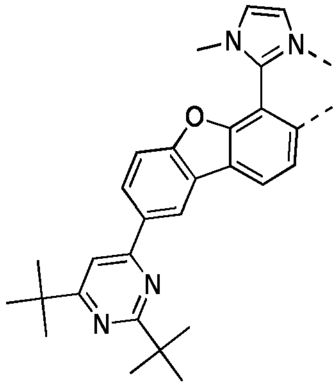

$L_{A321}$ ,

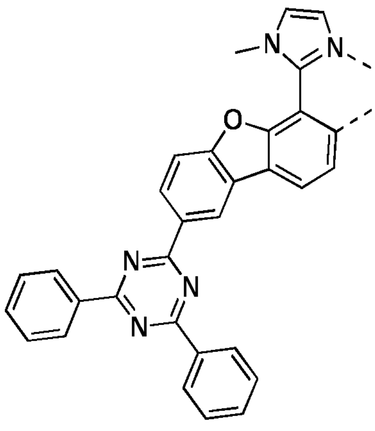

$L_{A322}$ ,

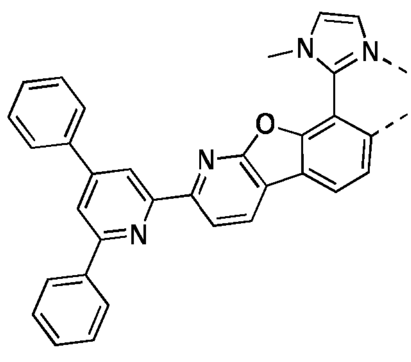

$L_{A323}$ ,

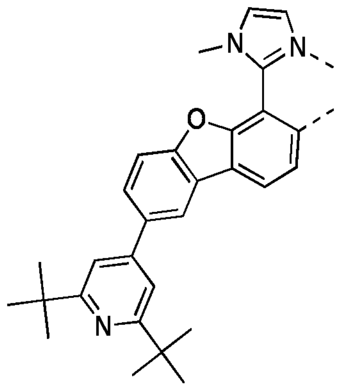

$L_{A324}$ ,

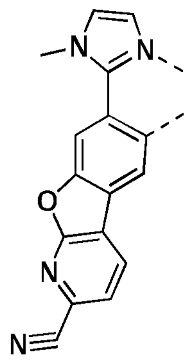

$L_{A325}$ , 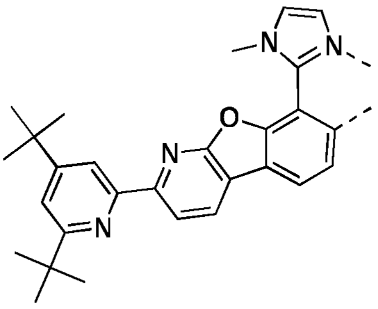

$L_{A326}$ , 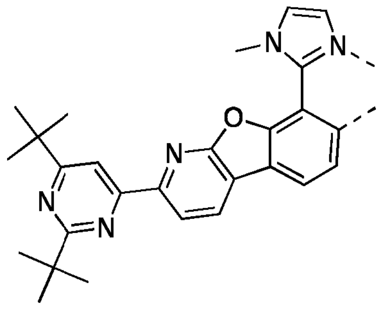

$L_{A327}$ ,

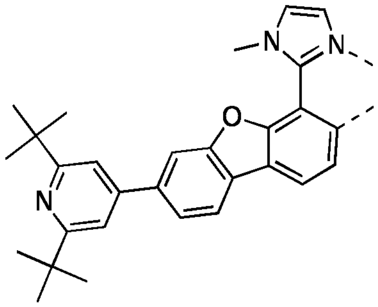

$L_{A328}$ , 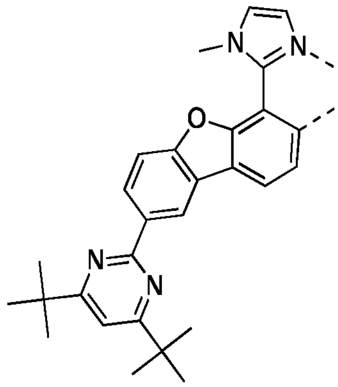

$L_{A329}$ , 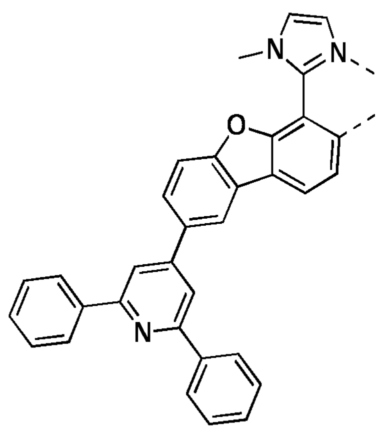

$L_{A330}$ ,

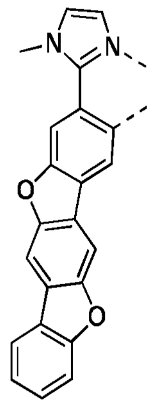

$L_{A331}$ , 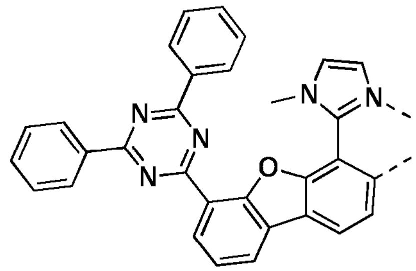

$L_{A332}$ , 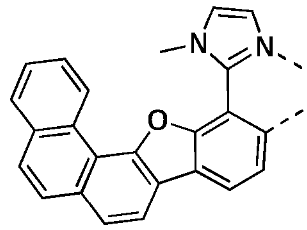

$L_{A333}$ ,

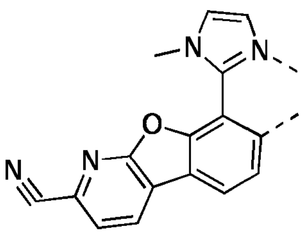

$L_{A334}$

, and

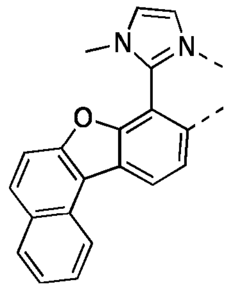

$L_{A335}$

.

**10.** The compound of claim 6, wherein $L_B$ and $L_C$ are each independently selected from the group consisting of:

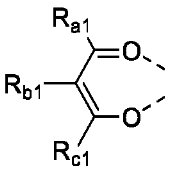

,

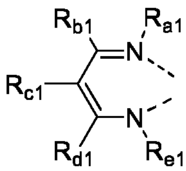

,

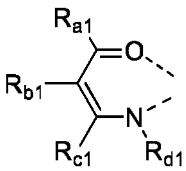

,

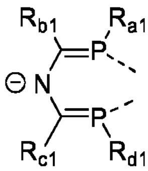

,

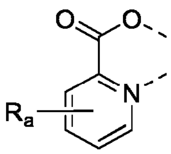

,

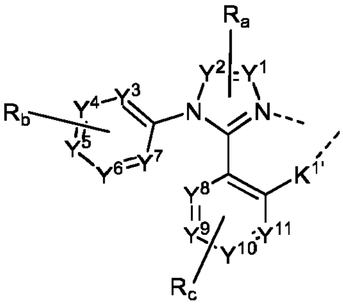

,

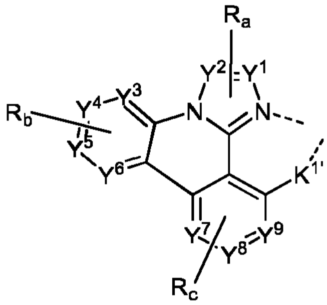

,

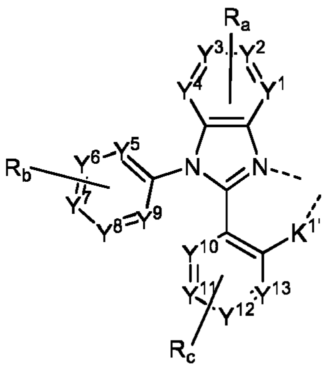

,

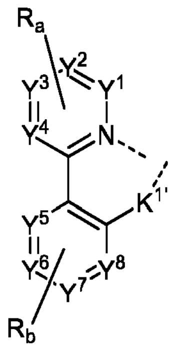

,

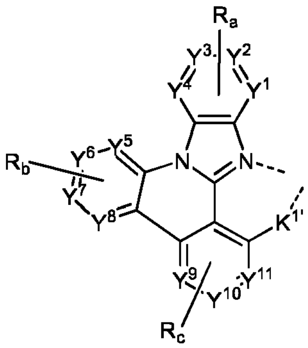

,

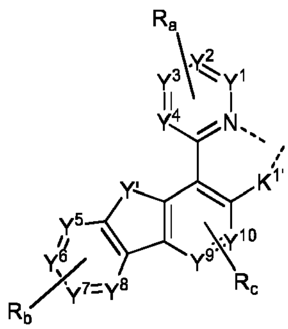

,

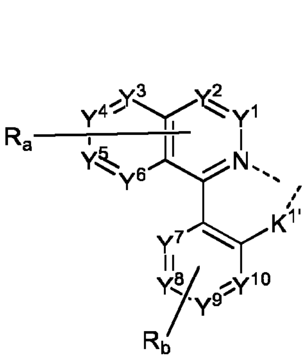

,

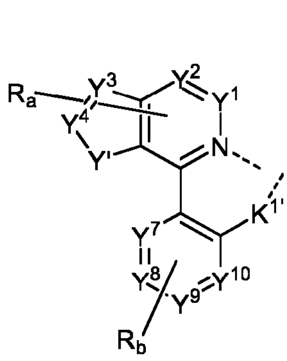

,

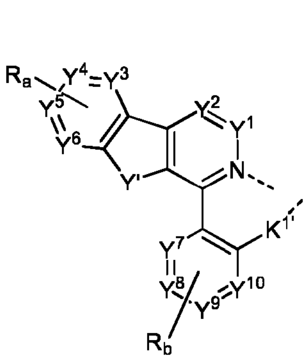

,

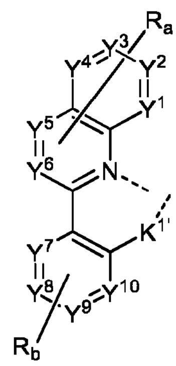

,

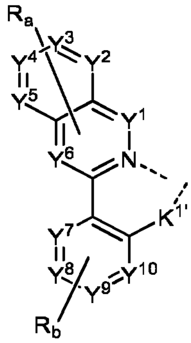,
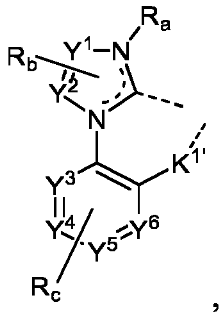,
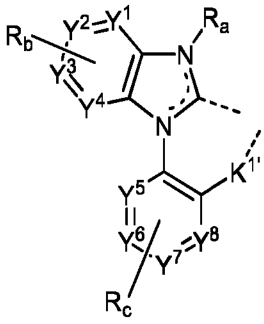,
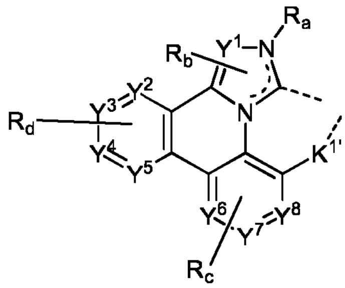,

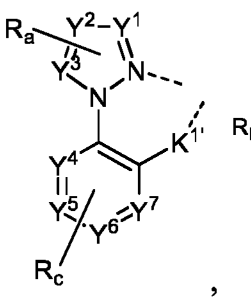,
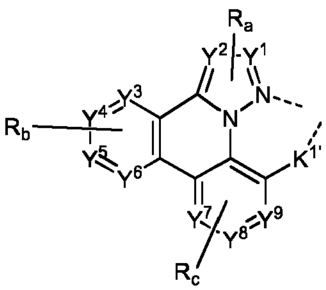,
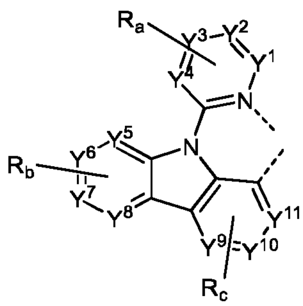,

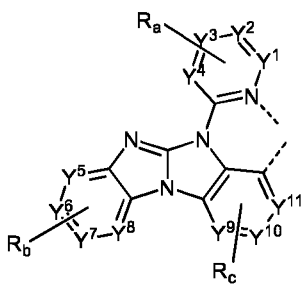,
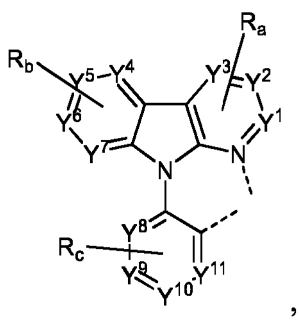,
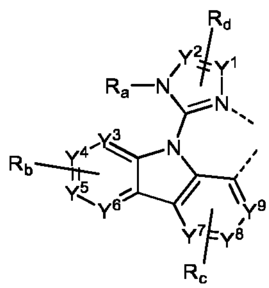,

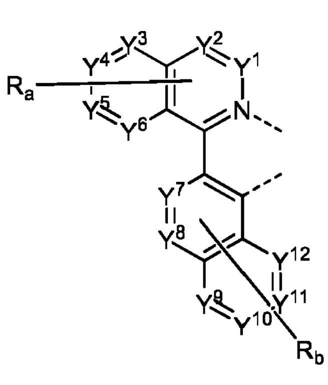,
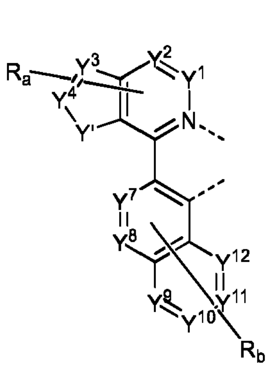,
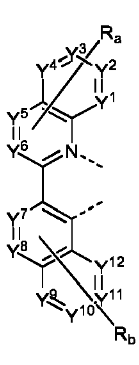,
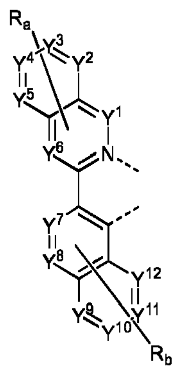,

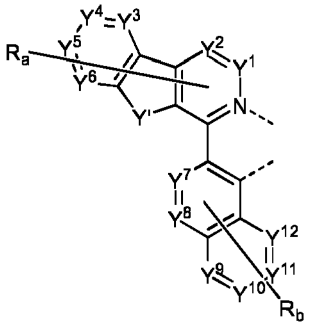,
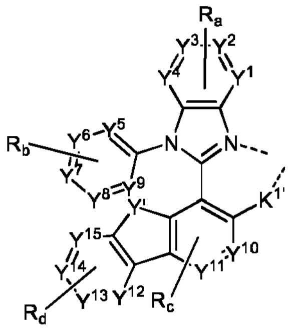,
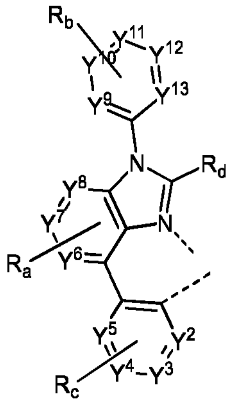,
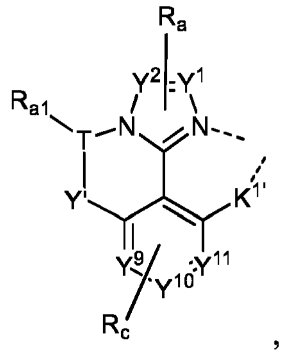,

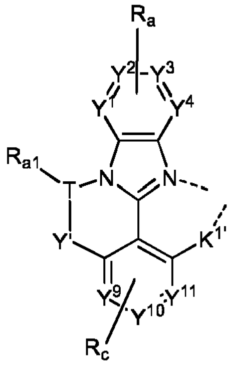,
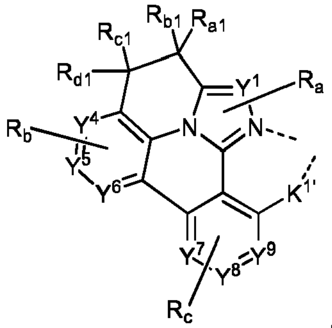,
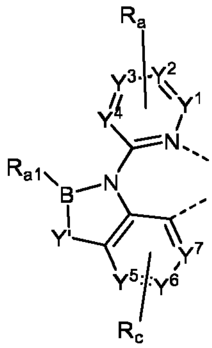,
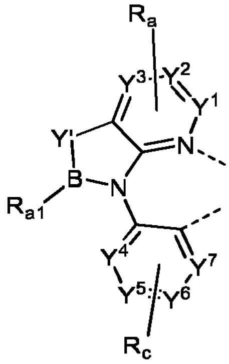,

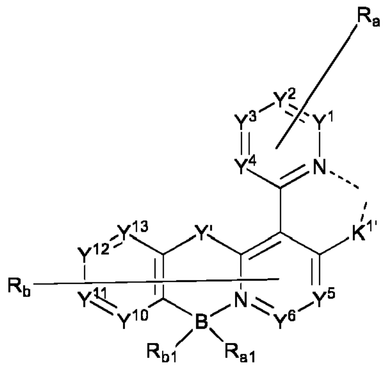, and
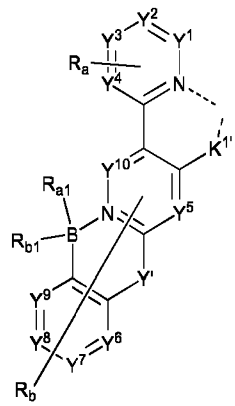,

wherein:

T is selected from the group consisting of B, Al, Ga, and In;

$K^{1'}$ is selected from the group consisting of a single bond, O, S, $NR_e$, $PR_e$, $BR_e$, $CR_eR_f$, and $SiR_eR_f$;

each of $Y^1$ to $Y^{13}$ is independently selected from the group consisting of C and N;

Y' is selected from the group consisting of $BR_e$, $BR_eR_f$, $NR_e$, $PR_e$, $P(O)R_e$, O, S, Se, C=O, C=S, C=Se, $C{=}NR_e$, $C{=}CR_eR_f$, S=O, $SO_2$, $CR_eR_f$, $SiR_eR_f$, and $GeR_eR_f$;

$R_e$ and $R_f$ can be fused or joined to form a ring;

each $R_a$, $R_b$, $R_c$, and $R_d$ independently represents from mono to the maximum allowed number of substitutions, or no substitution;

each of $R_{a1}$, $R_{b1}$, $R_{c1}$, $R_{d1}$, $R_{e1}$, $R_a$, $R_b$, $R_c$, $R_a$, $R_e$, and $R_f$ is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl,
carboxylic acid, ester, nitrile, isonitrile, sulfanyl, selenyl, sulfinyl, sulfonyl, phosphino, and combinations thereof; and

any two substituents of $R_{a1}$, $R_{b1}$, $R_{c1}$, $R_{d1}$, $R_a$, $R_b$, $R_c$, and $R_d$ can be fused or joined to form a ring or form a

multidentate ligand.

**11.** The compound of claim 7, wherein $L_A$ is selected from $L_{Ai}$, wherein i is an integer from 1 to 335; and $L_B$ is selected from $L_{Bk}$, wherein k is an integer from 1 to 836, wherein:

when the compound has formula $Ir(L_{Ai})_3$, the compound is selected from the group consisting of $Ir(L_{A1})_3$ to $Ir(L_{A335})_3$;
when the compound has formula $Ir(L_{Ai})(L_{Bk})_2$, the compound is selected from the group consisting of $Ir(L_{A1})(L_{B1})_2$ to $Ir(L_{A335})(L_{B836})_2$;
when the compound has formula $Ir(L_{Ai})_2(L_{Bk})$, the compound is selected from the group consisting of $Ir(L_{A1})_2(L_{B1})$ to $Ir(L_{A335})_2(L_{B836})$;
when the compound has formula $Ir(L_{Ai})_2(L_{Cj-I})$, the compound is selected from the group consisting of $Ir(L_{A1})_2(L_{C1-I})$ to $Ir(L_{A335})_2(L_{C1416-I})$; and
when the compound has formula $Ir(L_{Ai})_2(L_{Cj-II})$, the compound is selected from the group consisting of $Ir(L_{A1})_2(L_{C1-II})$ to $Ir(L_{A335})_2(L_{C1416-II})$;
wherein each $L_{Bk}$ has the structure defined as follows:

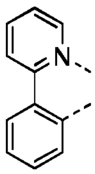
$L_{B1}$ ,
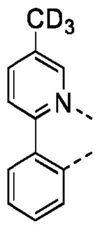
$L_{B2}$ ,
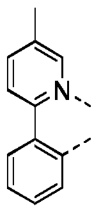
$L_{B3}$ ,
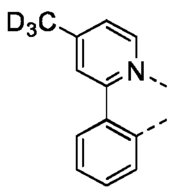
$L_{B4}$ ,
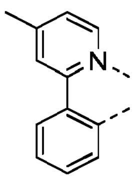
$L_{B5}$ ,
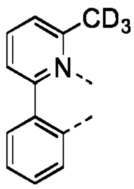
$L_{B6}$ ,
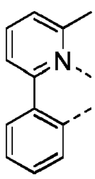
$L_{B7}$ ,
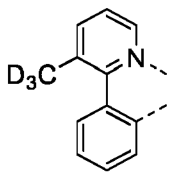
$L_{B8}$ ,
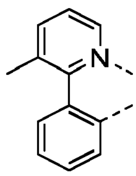
$L_{B9}$ ,
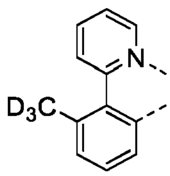
$L_{B10}$ ,
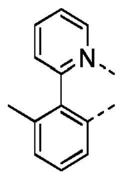
$L_{B11}$ ,
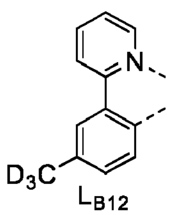
$L_{B12}$ ,
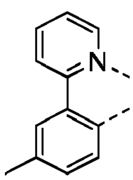
$L_{B13}$ ,
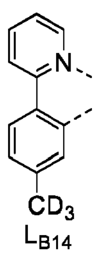
$L_{B14}$ ,
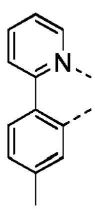
$L_{B15}$ ,
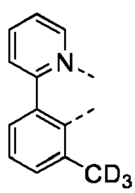
$L_{B16}$ ,
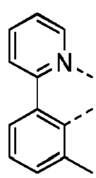
$L_{B17}$ ,
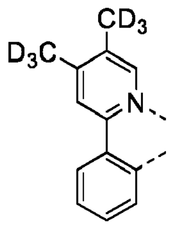
$L_{B18}$ ,
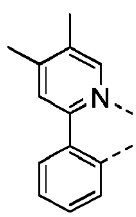
$L_{B19}$ ,
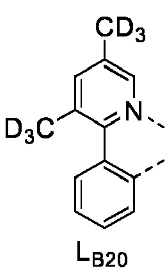
$L_{B20}$ ,
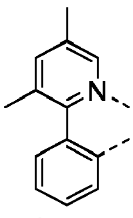
$L_{B21}$ ,
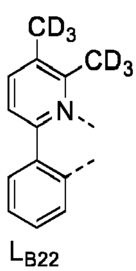
$L_{B22}$ ,
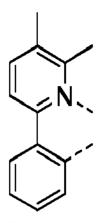
$L_{B23}$ ,
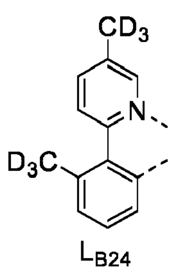
$L_{B24}$ ,
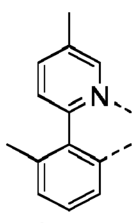
$L_{B25}$ ,
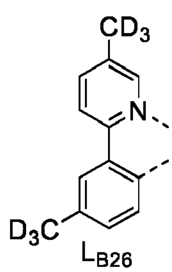
$L_{B26}$ ,

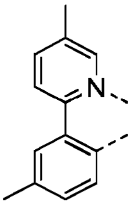 $L_{B27}$ , 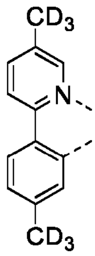 $L_{B28}$ , 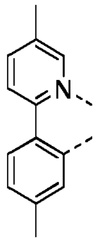 $L_{B29}$ , 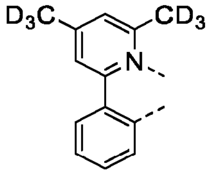 $L_{B30}$ , 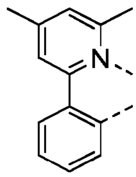 $L_{B31}$ , 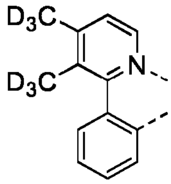 $L_{B32}$ , 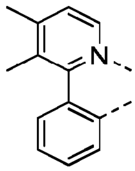 $L_{B33}$ ,

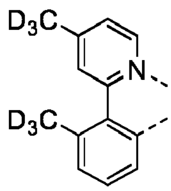 $L_{B34}$ , 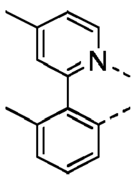 $L_{B35}$ , 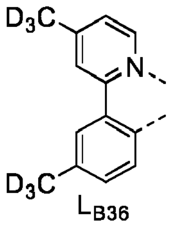 $L_{B36}$ , 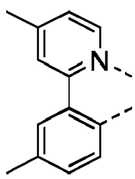 $L_{B37}$ , 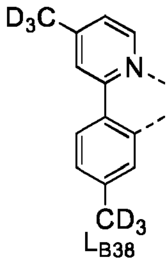 $L_{B38}$ , 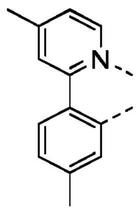 $L_{B39}$ ,

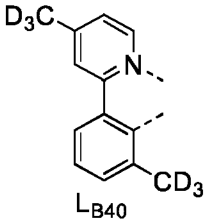 $L_{B40}$ , 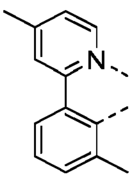 $L_{B41}$ , 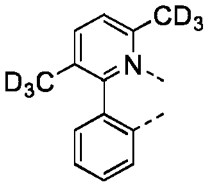 $L_{B42}$ , 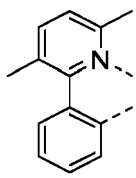 $L_{B43}$ , 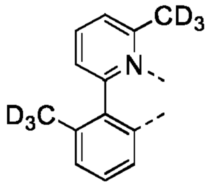 $L_{B44}$ , 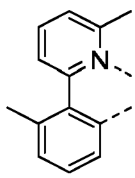 $L_{B45}$ ,

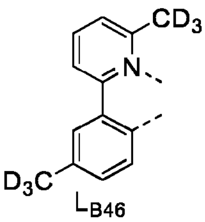 $L_{B46}$ , 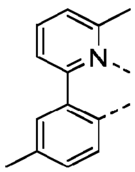 $L_{B47}$ , 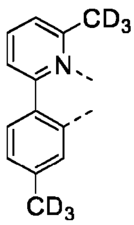 $L_{B48}$ , 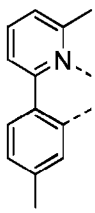 $L_{B49}$ , 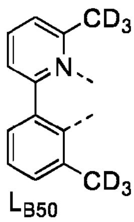 $L_{B50}$ , 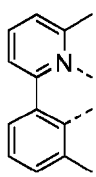 $L_{B51}$ , 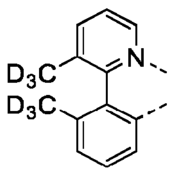 $L_{B52}$ ,

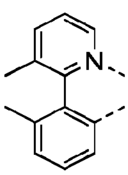 $L_{B53}$ , 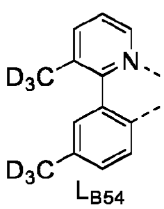 $L_{B54}$ , 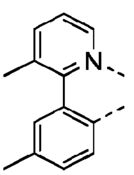 $L_{B55}$ , 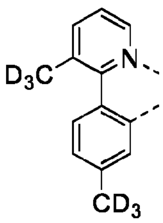 $L_{B56}$ , 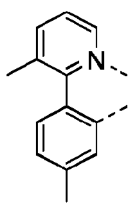 $L_{B57}$ , 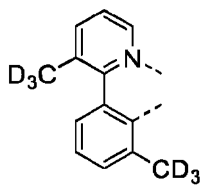 $L_{B58}$ , 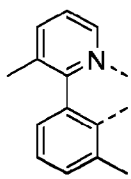 $L_{B59}$

, 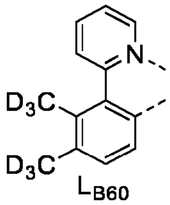 $L_{B60}$ , 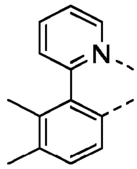 $L_{B61}$ , 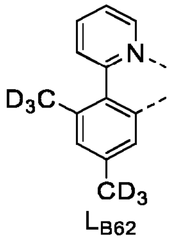 $L_{B62}$ , 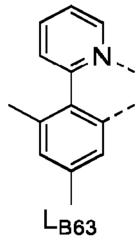 $L_{B63}$ , 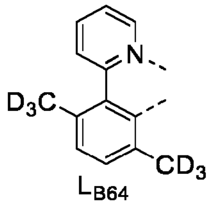 $L_{B64}$ , 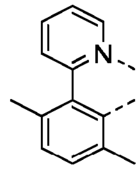 $L_{B65}$ ,

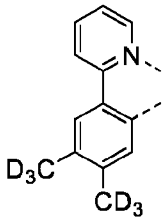 $L_{B66}$ , 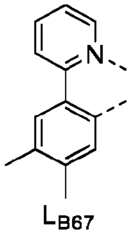 $L_{B67}$ , 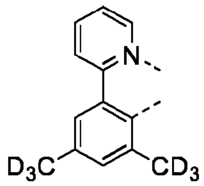 $L_{B68}$ , 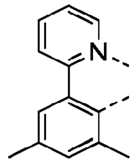 $L_{B69}$ , 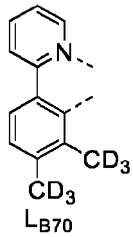 $L_{B70}$ , 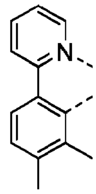 $L_{B71}$ , 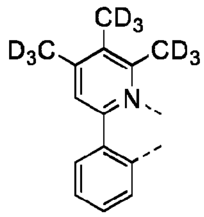 $L_{B72}$

, 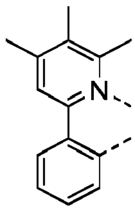 $L_{B73}$ , 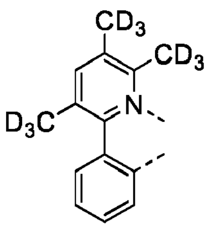 $L_{B74}$ , 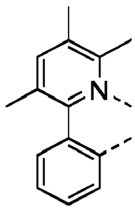 $L_{B75}$ , 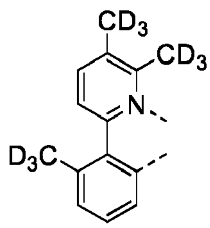 $L_{B76}$ , 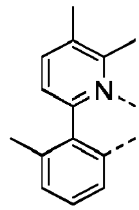 $L_{B77}$ , 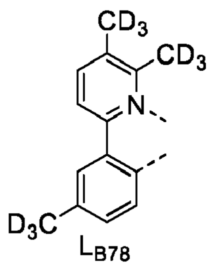 $L_{B78}$ ,

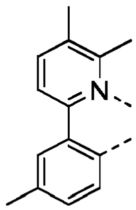 $L_{B79}$ , 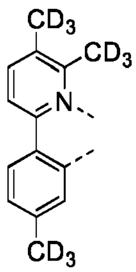 $L_{B80}$ , 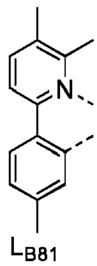 $L_{B81}$ , 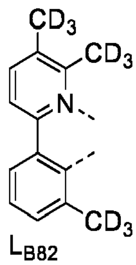 $L_{B82}$ , 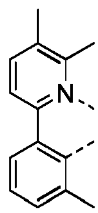 $L_{B83}$ , 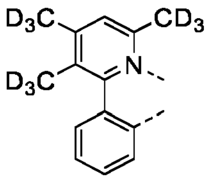 $L_{B84}$ , 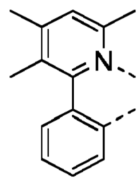 $L_{B85}$ ,

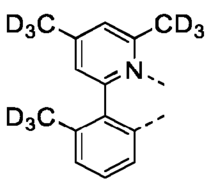 $L_{B86}$ , 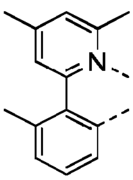 $L_{B87}$ , 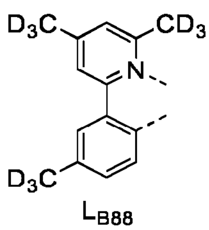 $L_{B88}$ , 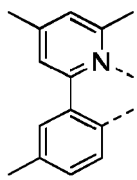 $L_{B89}$ , 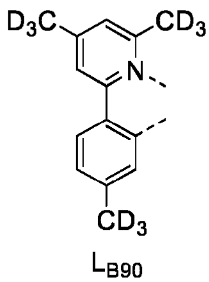 $L_{B90}$ , 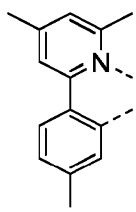 $L_{B91}$ ,

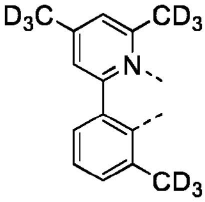
$L_{B92}$ ,
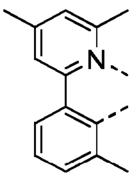
$L_{B93}$ ,
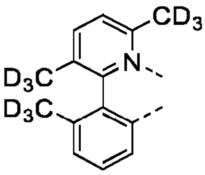
$L_{B94}$ ,
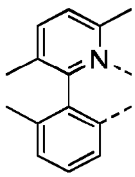
$L_{B95}$ ,
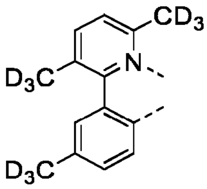
$L_{B96}$ ,
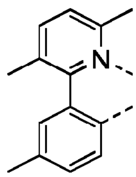
$L_{B97}$ ,

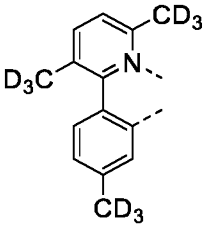
$L_{B98}$ ,
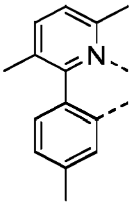
$L_{B99}$ ,
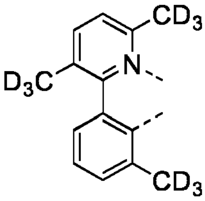
$L_{B100}$ ,
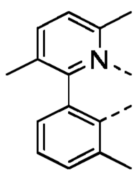
$L_{B101}$ ,
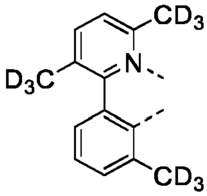
$L_{B102}$ ,
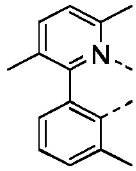
$L_{B103}$ ,

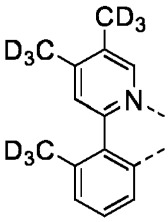
$L_{B104}$ ,
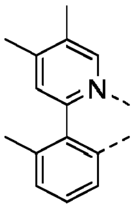
$L_{B105}$ ,
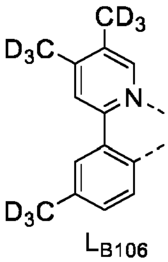
$L_{B106}$ ,
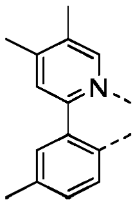
$L_{B107}$ ,
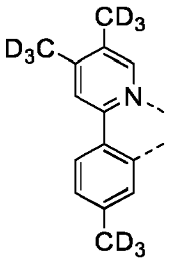
$L_{B108}$ ,
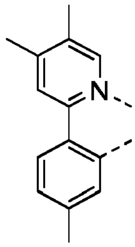
$L_{B109}$ ,

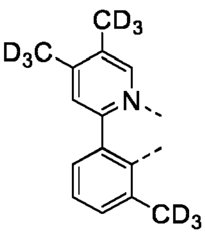
$L_{B110}$ ,
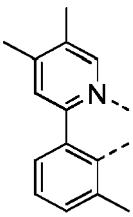
$L_{B111}$ ,
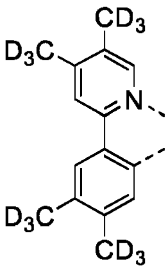
$L_{B112}$ ,
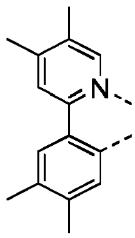
$L_{B113}$ ,
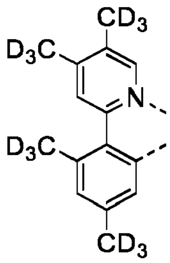
$L_{B114}$ ,
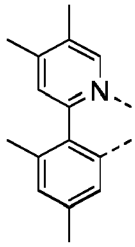
$L_{B115}$ ,

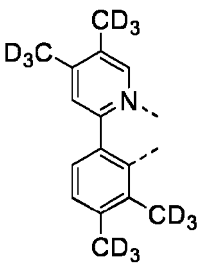
$L_{B116}$ ,
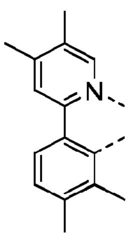
$L_{B117}$ ,
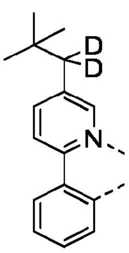
$L_{B118}$ ,
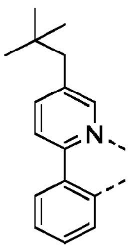
$L_{B119}$ ,
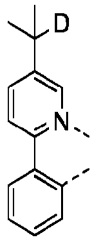
$L_{B120}$ ,
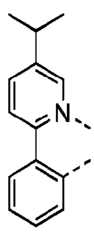
$L_{B121}$ ,
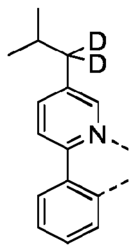
$L_{B122}$ ,
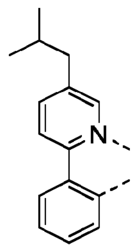
$L_{B123}$

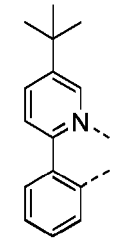
, $L_{B124}$ ,
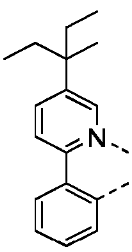
$L_{B125}$ ,
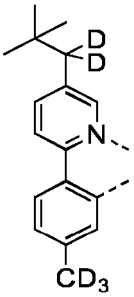
$L_{B126}$ ,
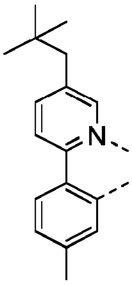
$L_{B127}$ ,
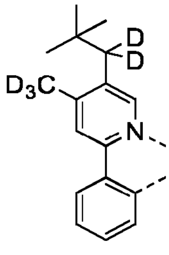
$L_{B128}$ ,
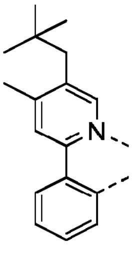
$L_{B129}$ ,
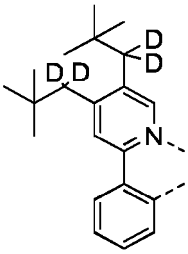
$L_{B130}$ ,

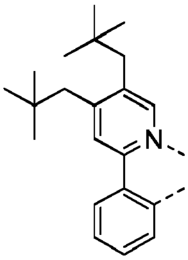
$L_{B131}$ ,
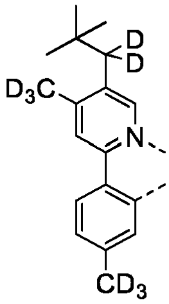
$L_{B132}$ ,
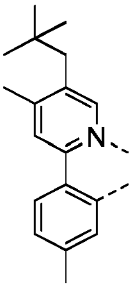
$L_{B133}$ ,
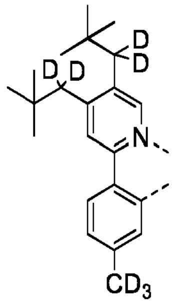
$L_{B134}$ ,
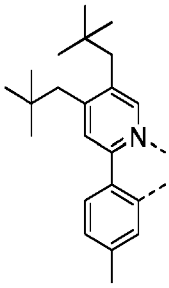
$L_{B135}$ ,
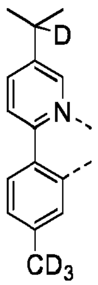
$L_{B136}$ ,
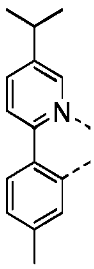
$L_{B137}$ ,

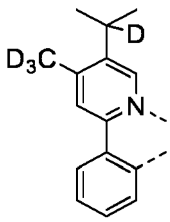
$L_{B138}$ ,
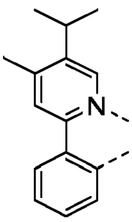
$L_{B139}$ ,
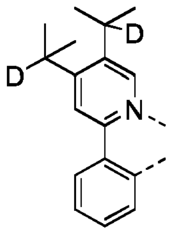
$L_{B140}$ ,
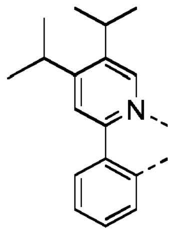
$L_{B141}$ ,
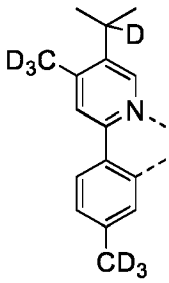
$L_{B142}$ ,
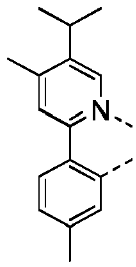
$L_{B143}$ ,

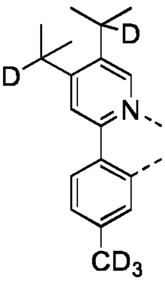
$L_{B144}$ ,
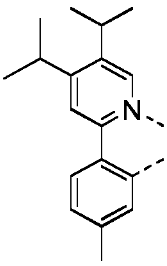
$L_{B145}$ ,
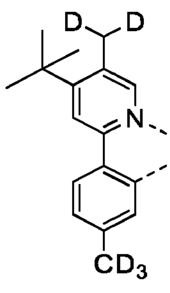
$L_{B146}$ ,
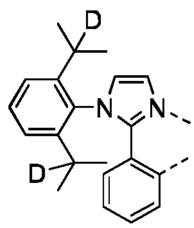
$L_{B147}$ ,
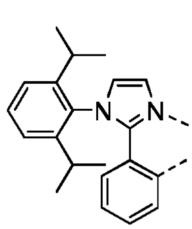
$L_{B148}$ ,

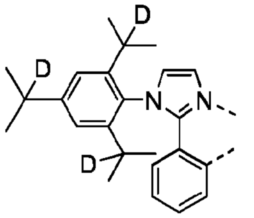 $L_{B149}$ , 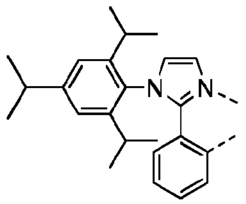 $L_{B150}$ , 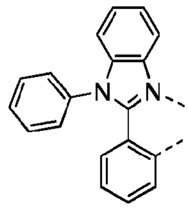 $L_{B151}$ , 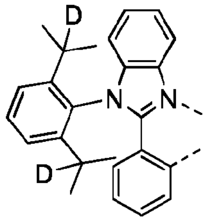 $L_{B152}$ , 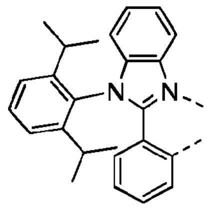 $L_{B153}$ ,

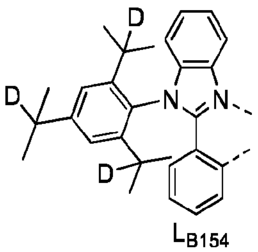 $L_{B154}$ , 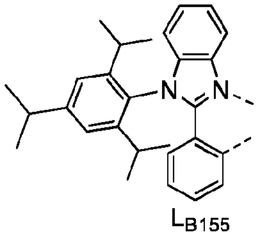 $L_{B155}$ , 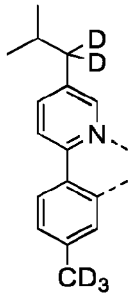 $L_{B156}$ , 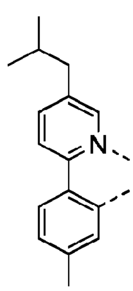 $L_{B157}$ , 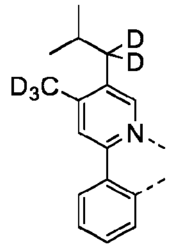 $L_{B158}$ , 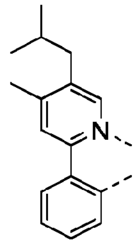 $L_{B159}$

, 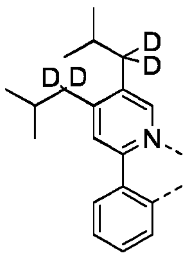 $L_{B160}$ , 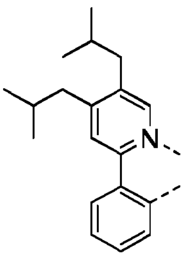 $L_{B161}$ , 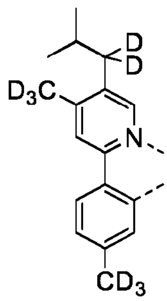 $L_{B162}$ , 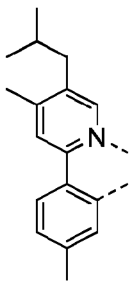 $L_{B163}$ , 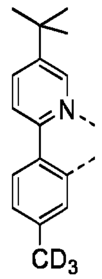 $L_{B164}$ , 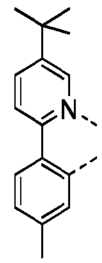 $L_{B165}$ , 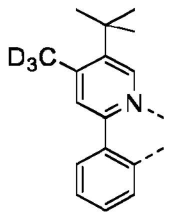 $L_{B166}$ ,

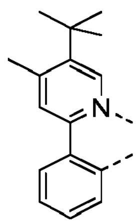 $L_{B167}$ , 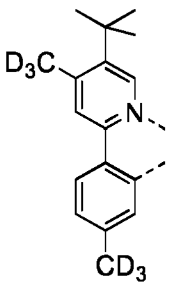 $L_{B168}$ , 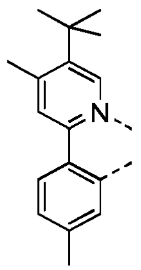 $L_{B169}$ , 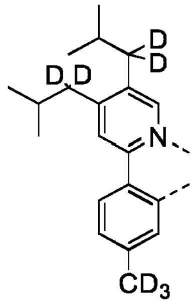 $L_{B170}$ , 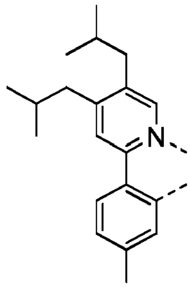 $L_{B171}$ , 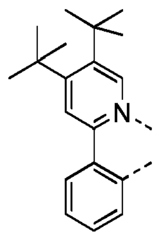 $L_{B172}$ ,

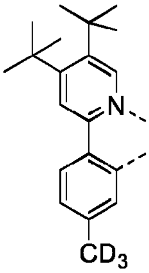
$L_{B173}$ ,
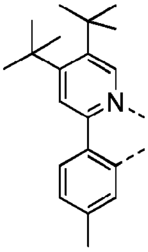
$L_{B174}$ ,
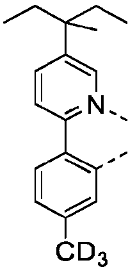
$L_{B175}$ ,
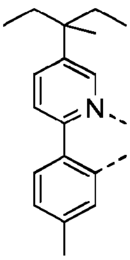
$L_{B176}$ ,
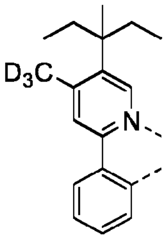
$L_{B177}$ ,
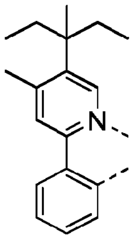
$L_{B178}$ ,
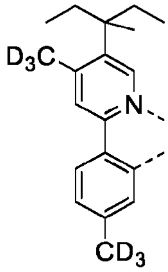
$L_{B179}$ ,

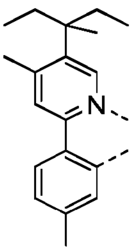
$L_{B180}$ ,
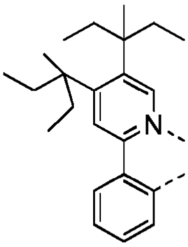
$L_{B181}$ ,
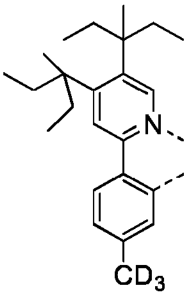
$L_{B182}$ ,
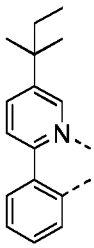
$L_{B183}$ ,
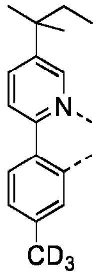
$L_{B184}$ ,
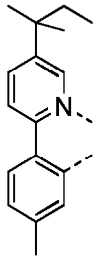
$L_{B185}$ ,
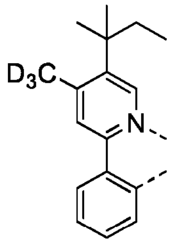
$L_{B186}$ ,

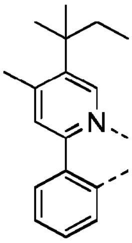
$L_{B187}$ ,
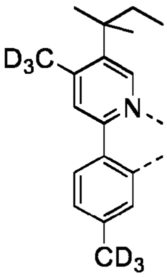
$L_{B188}$ ,
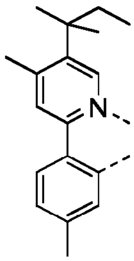
$L_{B189}$ ,
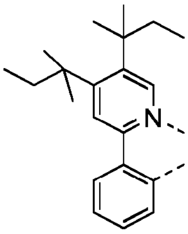
$L_{B190}$ ,
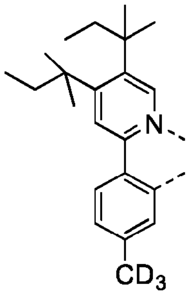
$L_{B191}$ ,
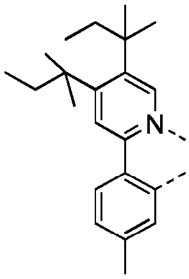
$L_{B192}$ ,

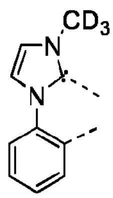
$L_{B193}$ ,
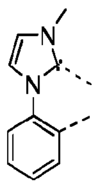
$L_{B194}$ ,
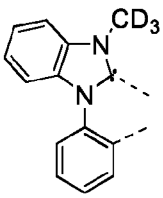
$L_{B195}$ ,
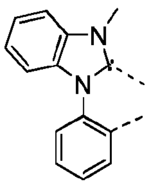
$L_{B196}$ ,
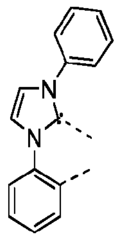
$L_{B197}$ ,
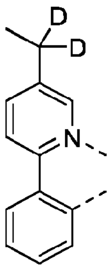
$L_{B198}$ ,
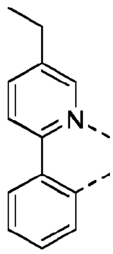
$L_{B199}$ ,
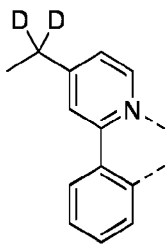
$L_{B200}$ ,

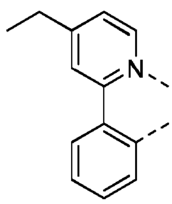 $L_{B201}$, 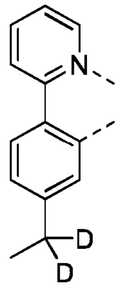 $L_{B202}$, 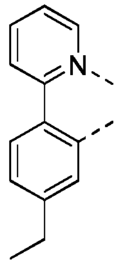 $L_{B203}$, 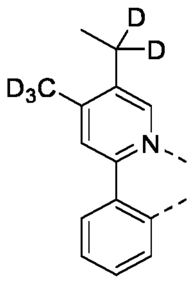 $L_{B204}$, 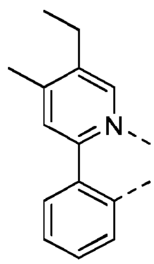 $L_{B205}$, 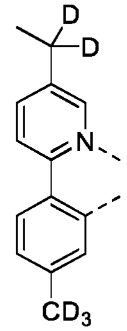 $L_{B206}$, 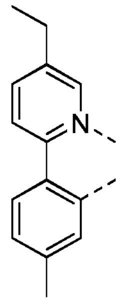 $L_{B207}$,

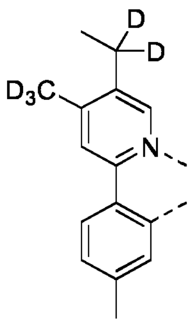 $L_{B208}$, 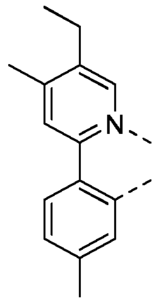 $L_{B209}$, 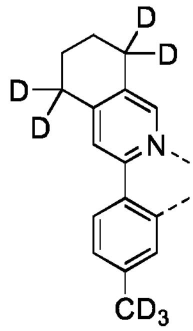 $L_{B210}$, 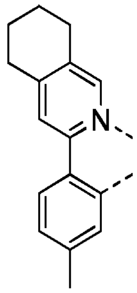 $L_{B211}$, 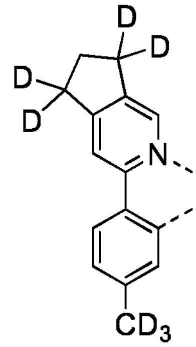 $L_{B212}$, 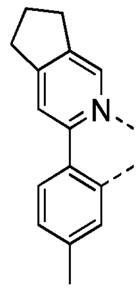 $L_{B213}$,

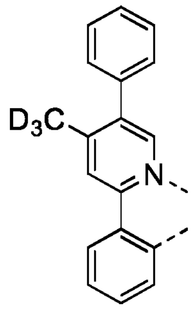 $L_{B214}$, 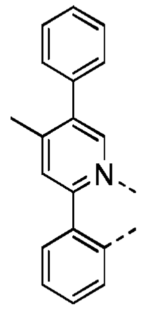 $L_{B215}$, 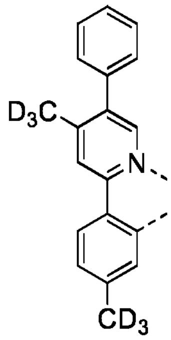 $L_{B216}$, 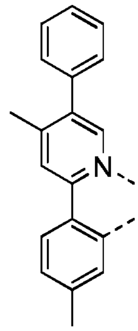 $L_{B217}$, 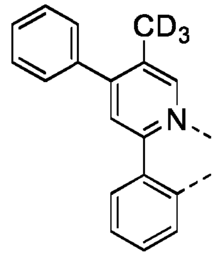 $L_{B218}$, 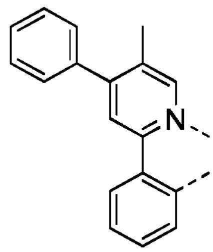 $L_{B219}$,

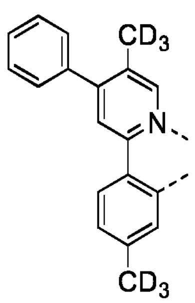 $L_{B220}$, 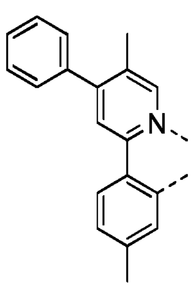 $L_{B221}$, 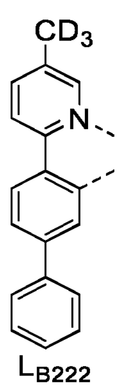 $L_{B222}$, 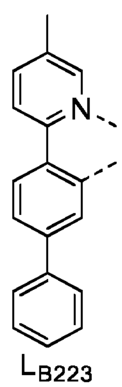 $L_{B223}$, 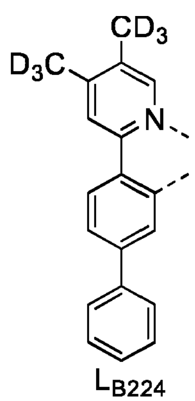 $L_{B224}$, 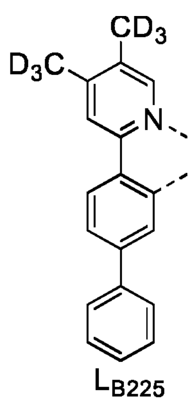 $L_{B225}$,

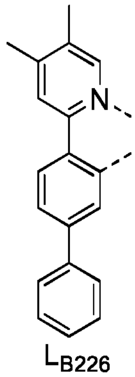
$L_{B226}$ ,
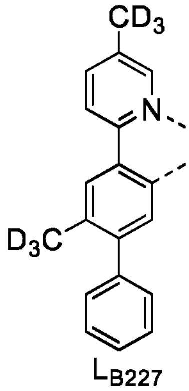
$L_{B227}$ ,
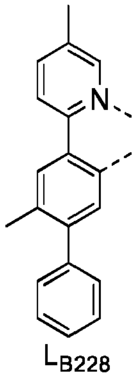
$L_{B228}$ ,
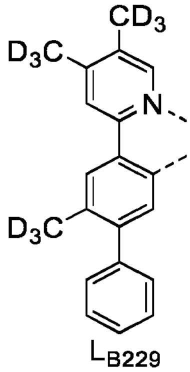
$L_{B229}$ ,
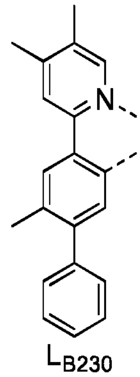
$L_{B230}$ ,
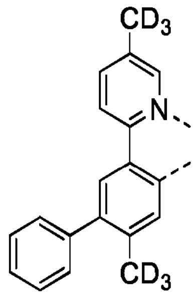
$L_{B231}$ ,

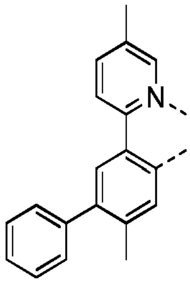
$L_{B232}$ ,
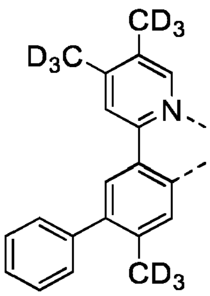
$L_{B233}$ ,
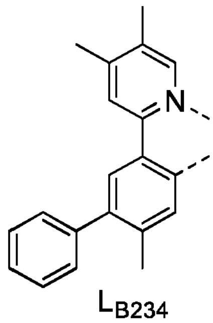
$L_{B234}$ ,
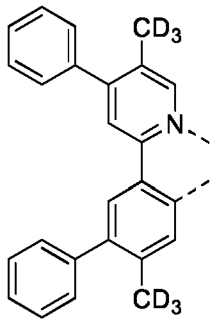
$L_{B235}$ ,
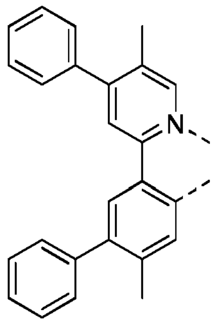
$L_{B236}$ ,

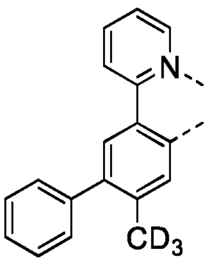
$L_{B237}$ ,
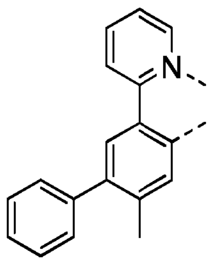
$L_{B238}$ ,
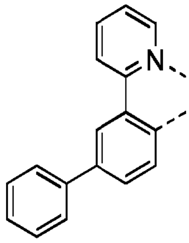
$L_{B239}$ ,
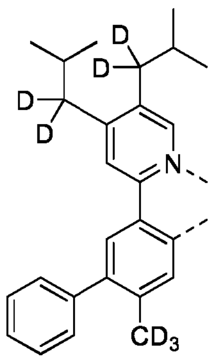
$L_{B240}$ ,
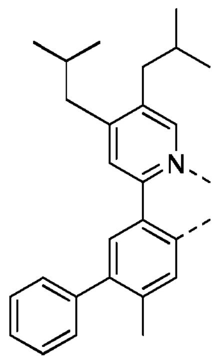
$L_{B241}$ ,

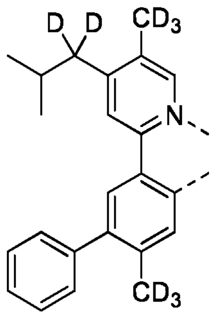
$L_{B242}$ ,
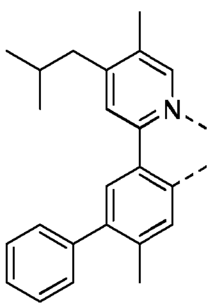
$L_{B243}$ ,
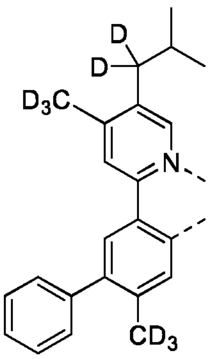
$L_{B244}$ ,
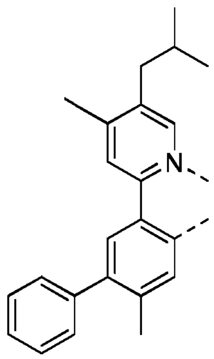
$L_{B245}$ ,
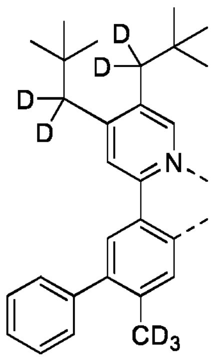
$L_{B246}$ ,

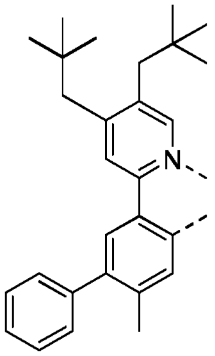
$L_{B247}$ ,
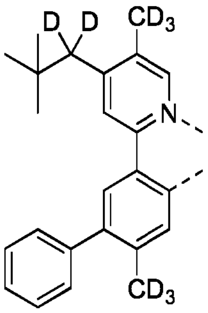
$L_{B248}$ ,
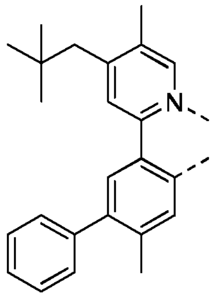
$L_{B249}$ ,
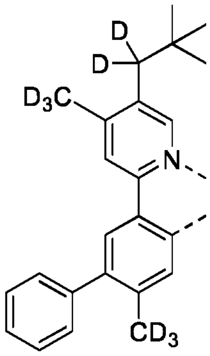
$L_{B250}$ ,
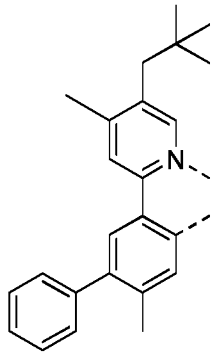
$L_{B251}$ ,

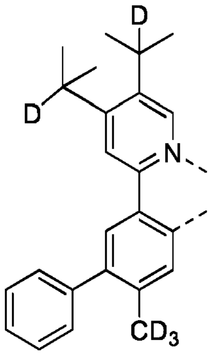
$L_{B252}$ ,
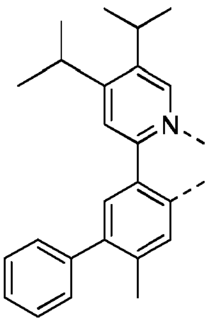
$L_{B253}$ ,
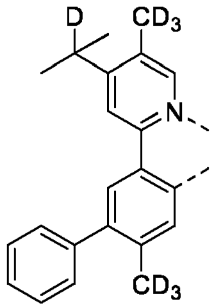
$L_{B254}$ ,
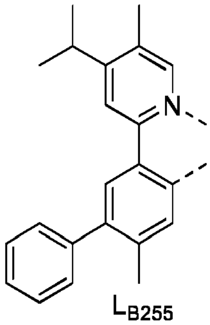
$L_{B255}$ ,
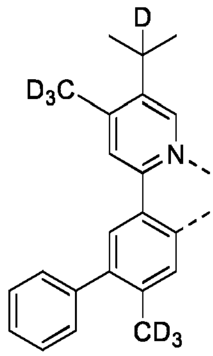
$L_{B256}$ ,

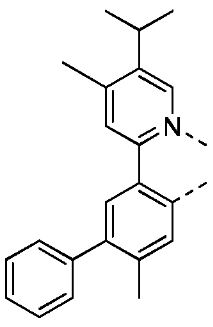
$L_{B257}$ ,
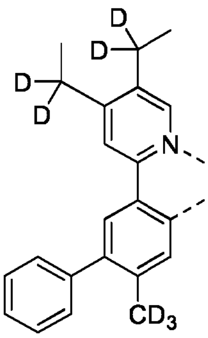
$L_{B258}$ ,
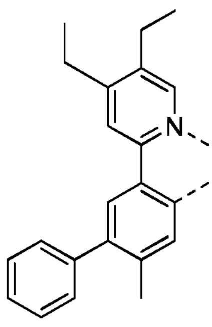
$L_{B259}$ ,
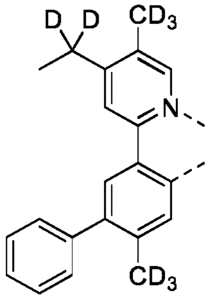
$L_{B260}$ ,
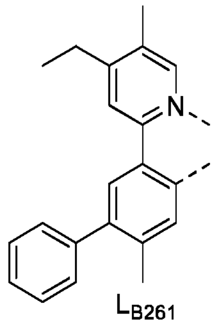
$L_{B261}$ ,

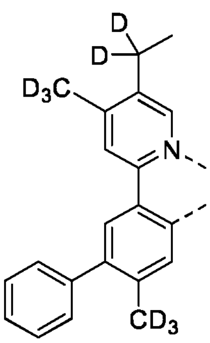
$L_{B262}$ ,
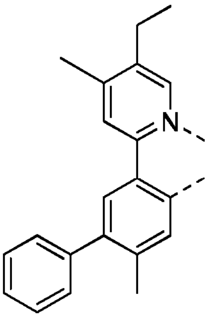
$L_{B263}$ ,
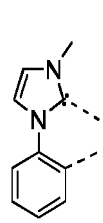
$L_{B264}$ ,
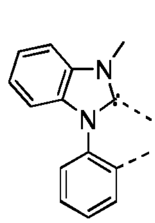
$L_{B265}$ ,
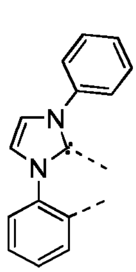
$L_{B266}$ ,
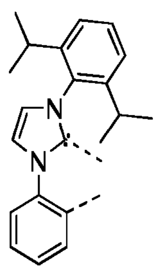
$L_{B267}$ ,

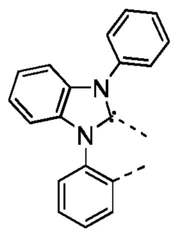
$L_{B268}$ ,
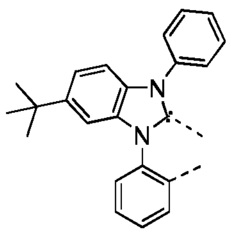
$L_{B269}$ ,
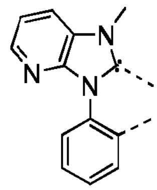
$L_{B270}$ ,
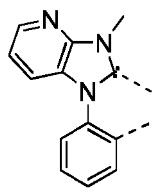
$L_{B271}$ ,
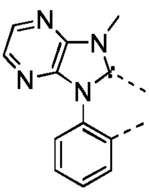
$L_{B272}$ ,
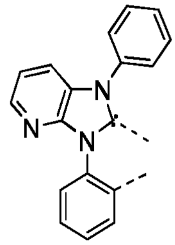
$L_{B273}$ ,

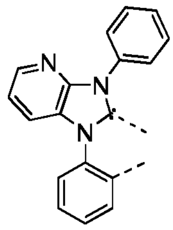
$L_{B274}$ ,
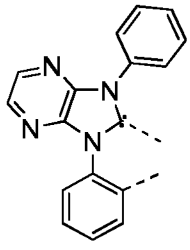
$L_{B275}$ ,
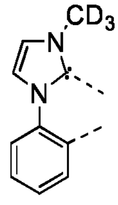
$L_{B276}$ ,
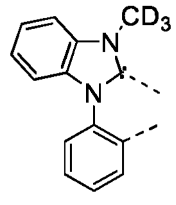
$L_{B277}$ ,
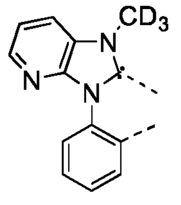
$L_{B278}$ ,
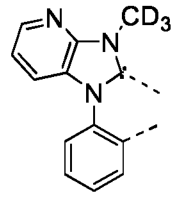
$L_{B279}$ ,

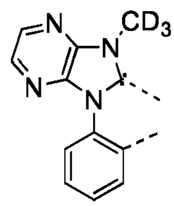
$L_{B280}$ ,
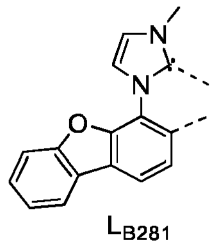
$L_{B281}$ ,
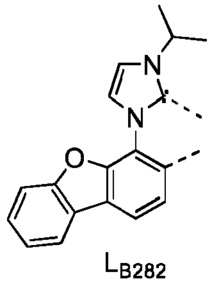
$L_{B282}$ ,
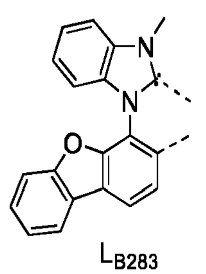
$L_{B283}$ ,
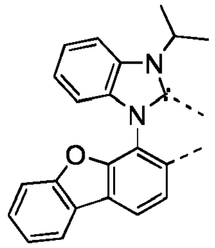
$L_{B284}$ ,

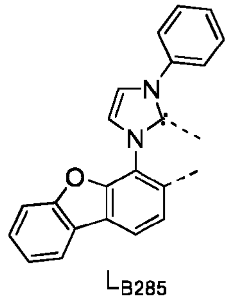
$L_{B285}$ ,
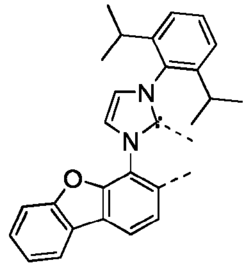
$L_{B286}$ ,
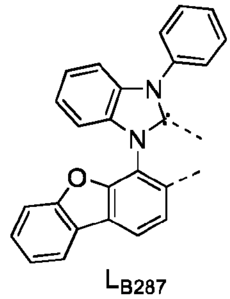
$L_{B287}$ ,
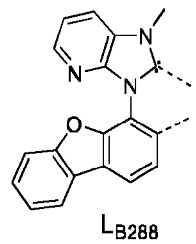
$L_{B288}$ ,
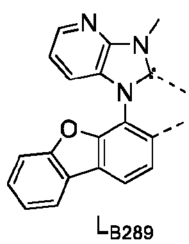
$L_{B289}$ ,

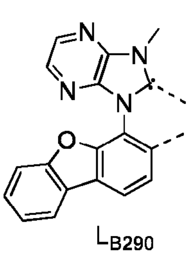
$L_{B290}$ ,
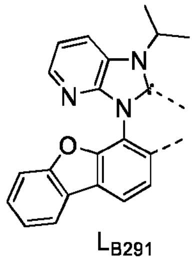
$L_{B291}$ ,
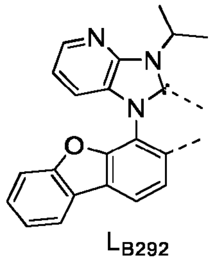
$L_{B292}$ ,
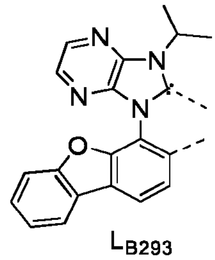
$L_{B293}$ ,
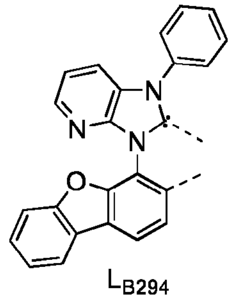
$L_{B294}$ ,

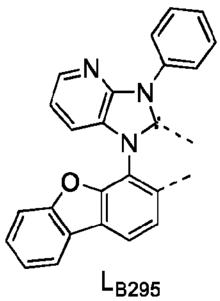
$L_{B295}$ ,
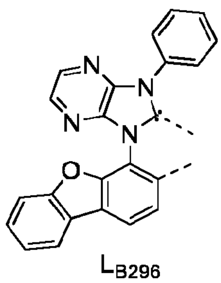
$L_{B296}$ ,
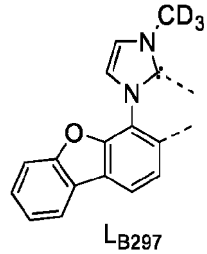
$L_{B297}$ ,
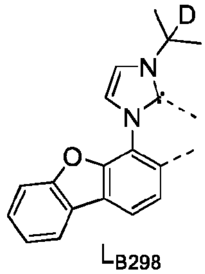
$L_{B298}$ ,
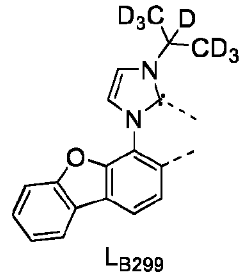
$L_{B299}$

, 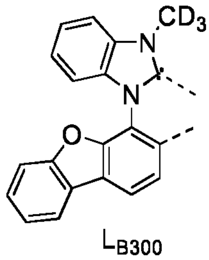
$L_{B300}$ ,
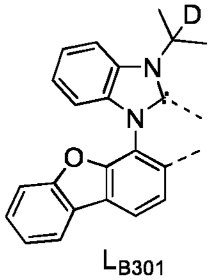
$L_{B301}$ ,
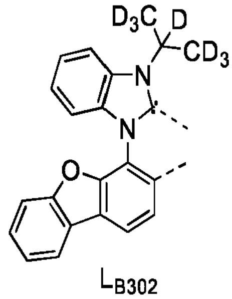
$L_{B302}$ ,
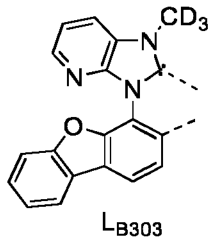
$L_{B303}$ ,
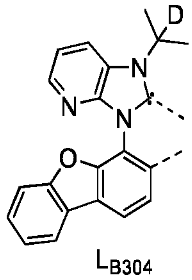
$L_{B304}$ ,

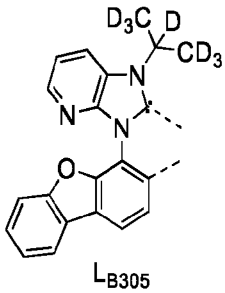
$L_{B305}$ ,
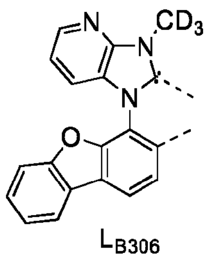
$L_{B306}$ ,
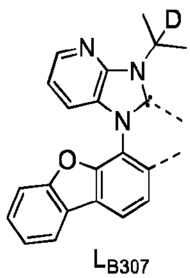
$L_{B307}$ ,
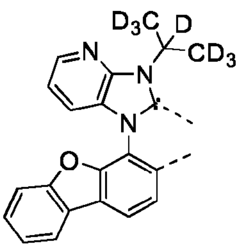
$L_{B308}$ ,
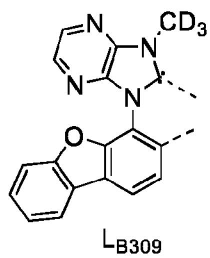
$L_{B309}$ ,

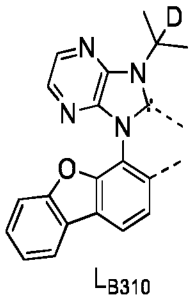
$L_{B310}$ ,
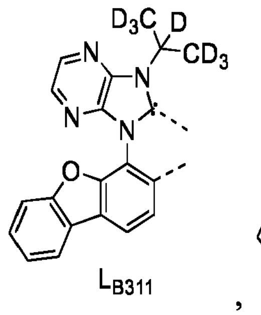
$L_{B311}$ ,
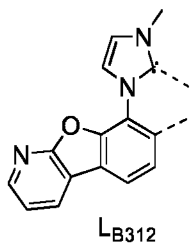
$L_{B312}$ ,
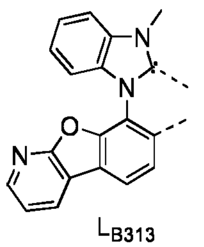
$L_{B313}$ ,
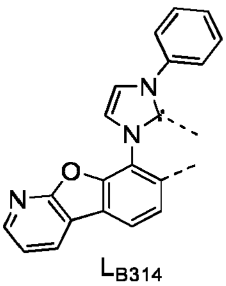
$L_{B314}$ ,

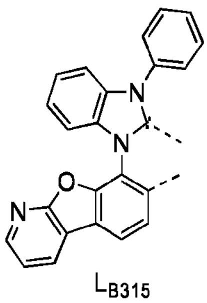
$L_{B315}$ ,
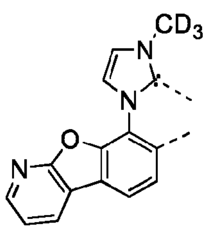
$L_{B316}$ ,
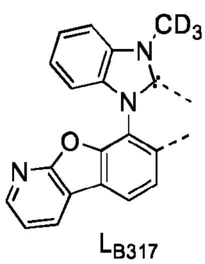
$L_{B317}$ ,
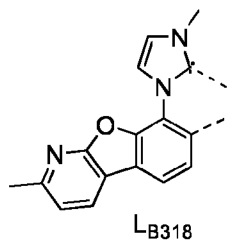
$L_{B318}$ ,
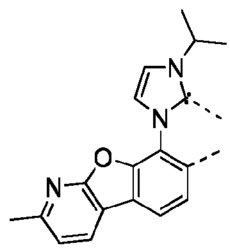
$L_{B319}$ ,

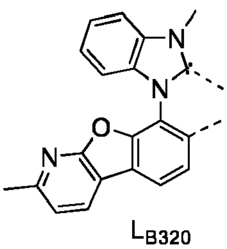
$L_{B320}$,
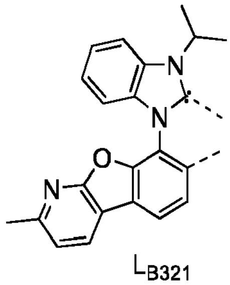
$L_{B321}$,
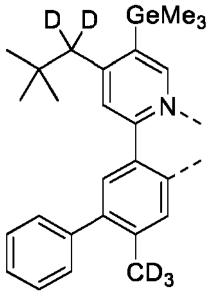
$L_{B322}$,
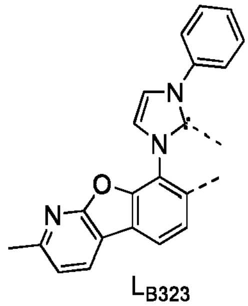
$L_{B323}$,

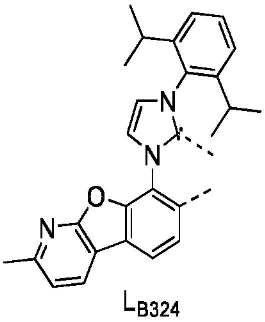
$L_{B324}$,
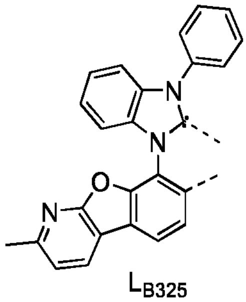
$L_{B325}$,
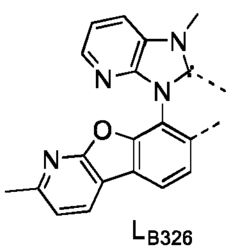
$L_{B326}$,
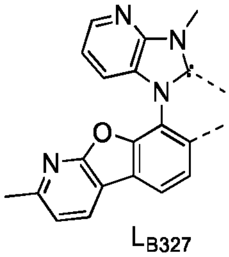
$L_{B327}$,

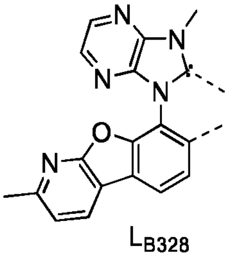
$L_{B328}$,
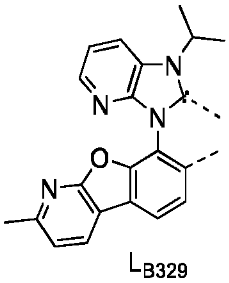
$L_{B329}$,
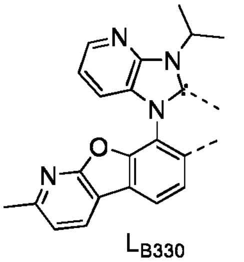
$L_{B330}$,
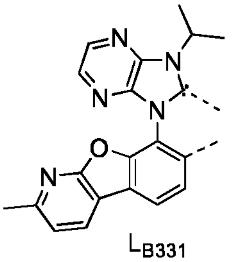
$L_{B331}$,

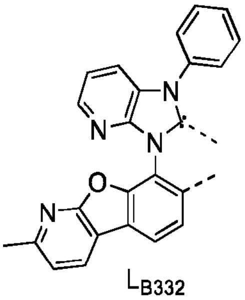
$L_{B332}$,
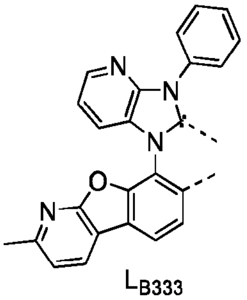
$L_{B333}$,
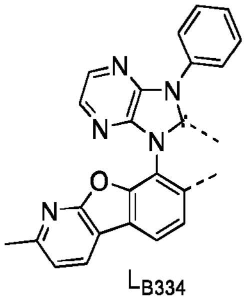
$L_{B334}$,
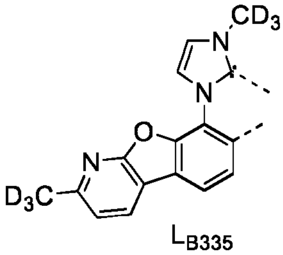
$L_{B335}$,

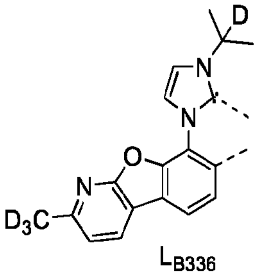
$L_{B336}$,
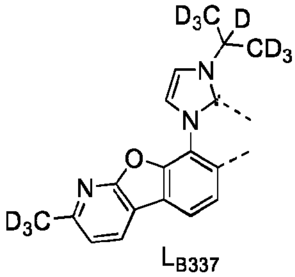
$L_{B337}$,
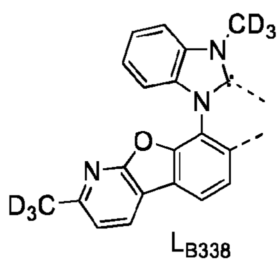
$L_{B338}$,
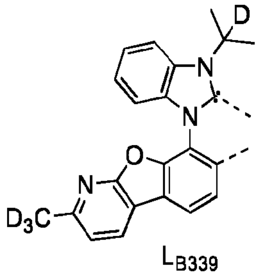
$L_{B339}$,

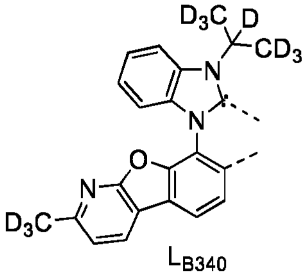
$L_{B340}$,
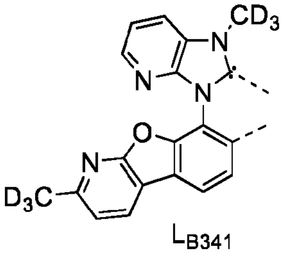
$L_{B341}$,
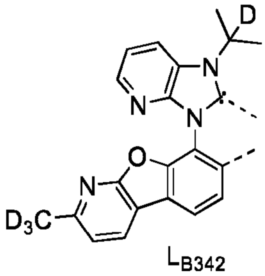
$L_{B342}$,
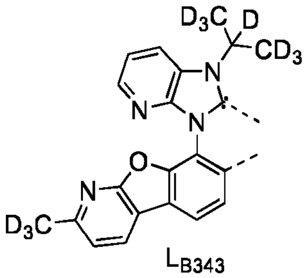
$L_{B343}$,
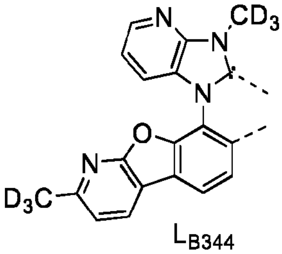
$L_{B344}$,
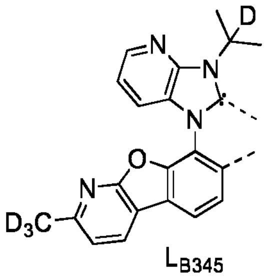
$L_{B345}$,
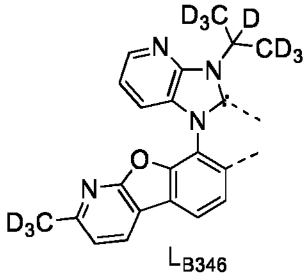
$L_{B346}$,
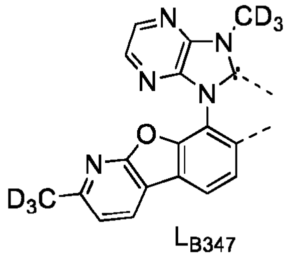
$L_{B347}$,
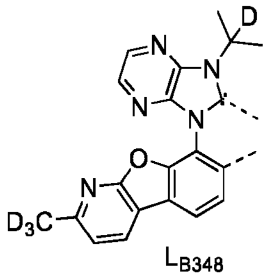
$L_{B348}$,
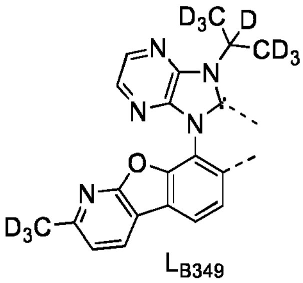
$L_{B349}$,
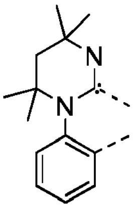
$L_{B350}$,
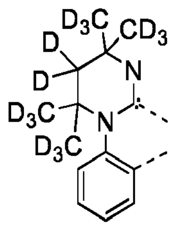
$L_{B351}$,
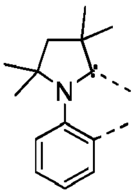
$L_{B352}$,
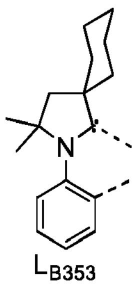
$L_{B353}$,
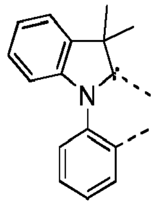
$L_{B354}$,
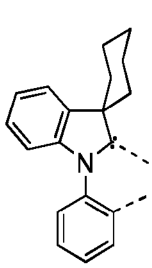
$L_{B355}$,
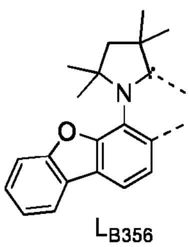
$L_{B356}$,
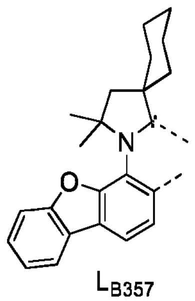
$L_{B357}$,
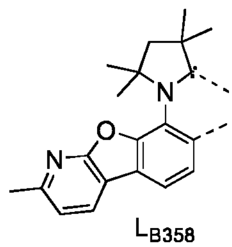
$L_{B358}$,
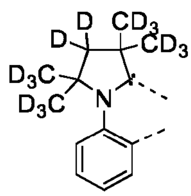
$L_{B359}$,

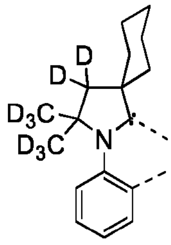 $L_{B360}$, 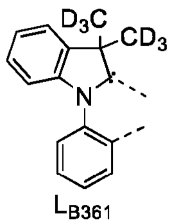 $L_{B361}$, 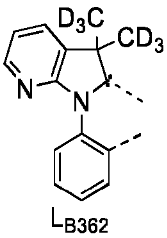 $L_{B362}$, 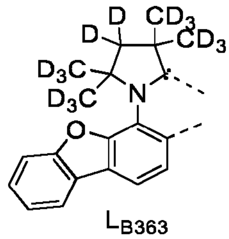 $L_{B363}$, 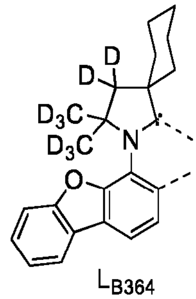 $L_{B364}$,

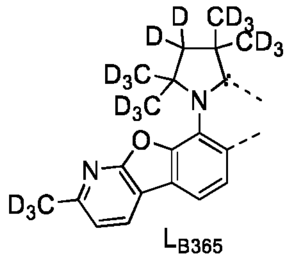 $L_{B365}$, 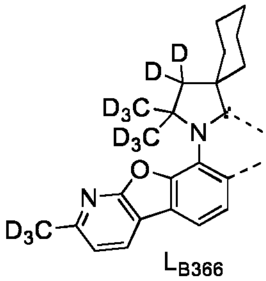 $L_{B366}$, 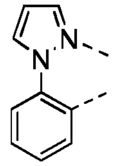 $L_{B367}$, 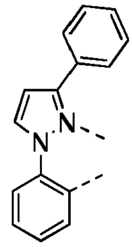 $L_{B368}$, 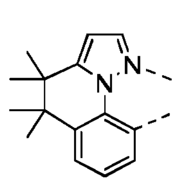 $L_{B369}$,

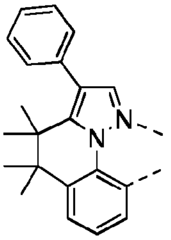 $L_{B370}$, 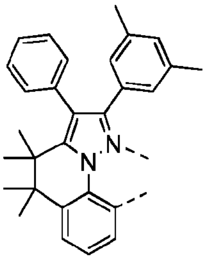 $L_{B371}$, 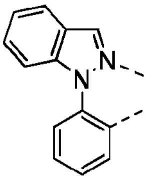 $L_{B372}$, 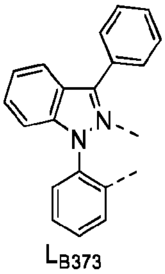 $L_{B373}$, 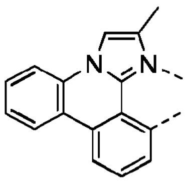 $L_{B374}$, 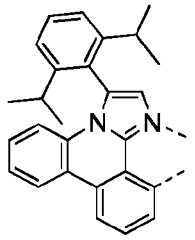 $L_{B375}$,

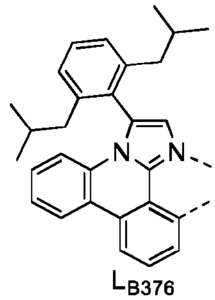 $L_{B376}$, 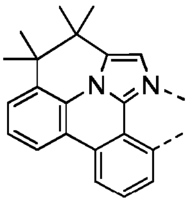 $L_{B377}$, 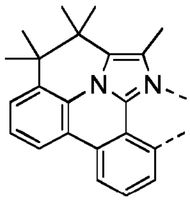 $L_{B378}$, 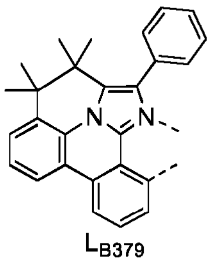 $L_{B379}$, 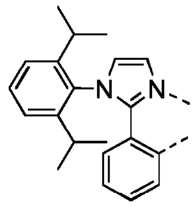 $L_{B380}$,

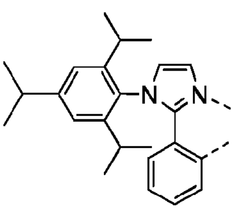 $L_{B381}$, 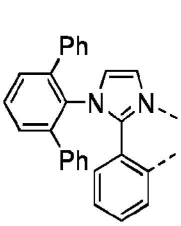 $L_{B382}$, 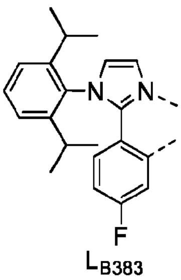 $L_{B383}$, 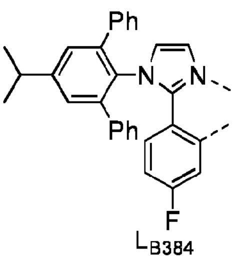 $L_{B384}$, 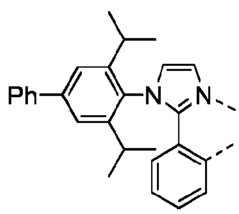 $L_{B385}$,

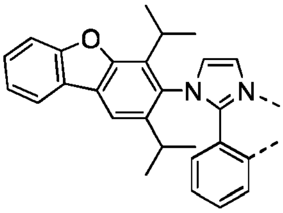
$L_{B386}$ ,
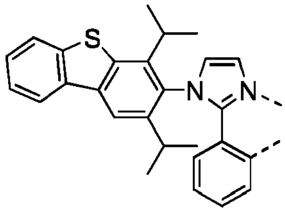
$L_{B387}$ ,
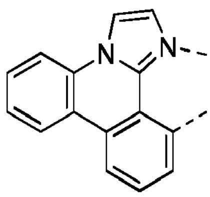
$L_{B388}$ ,
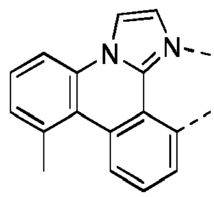
$L_{B389}$ ,

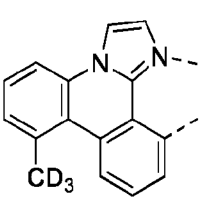
$L_{B390}$ ,
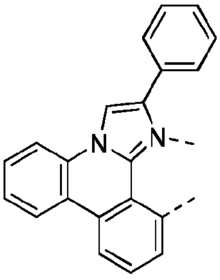
$L_{B391}$ ,
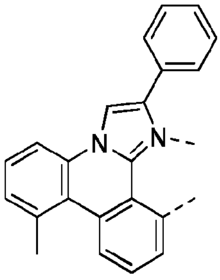
$L_{B392}$ ,
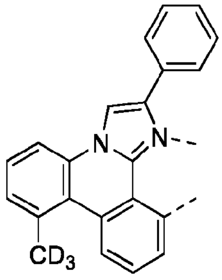
$L_{B393}$ ,
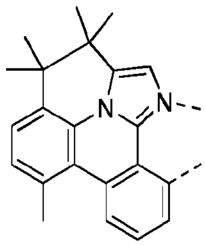
$L_{B394}$ ,

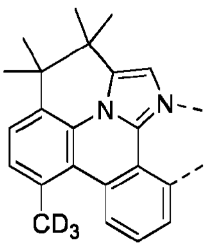
$L_{B395}$ ,
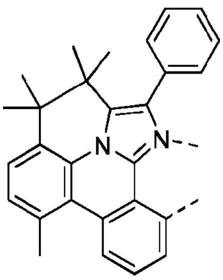
$L_{B396}$ ,
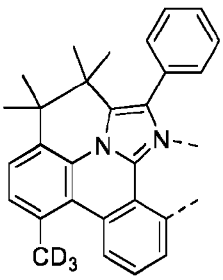
$L_{B397}$ ,
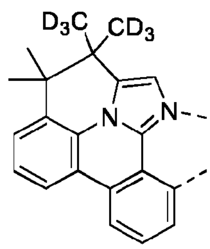
$L_{B398}$ ,
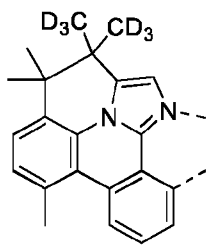
$L_{B399}$ ,

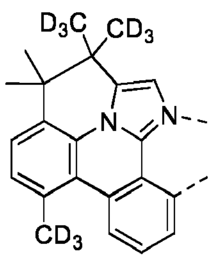
$L_{B400}$ ,
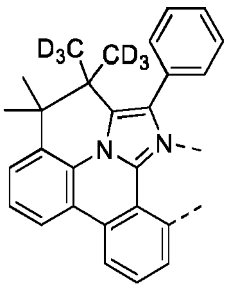
$L_{B401}$ ,
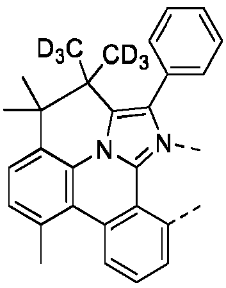
$L_{B402}$ ,
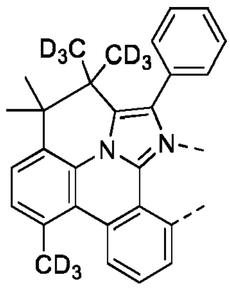
$L_{B403}$ ,

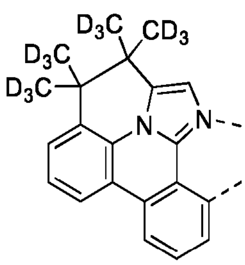
$L_{B404}$ ,
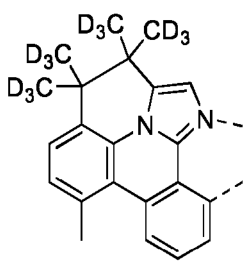
$L_{B405}$ ,
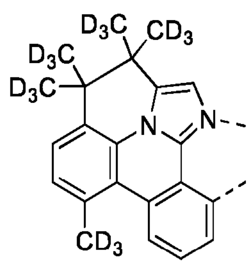
$L_{B406}$ ,
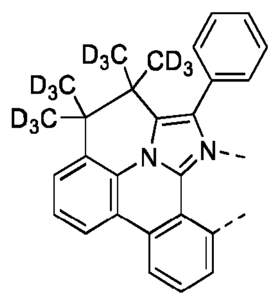
$L_{B407}$ ,

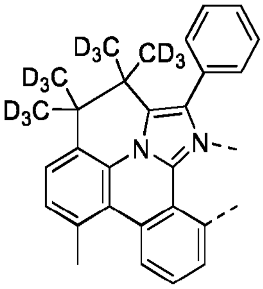
$L_{B408}$ ,
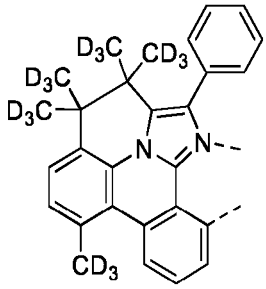
$L_{B409}$ ,
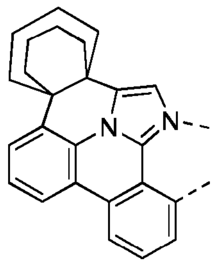
$L_{B410}$ ,
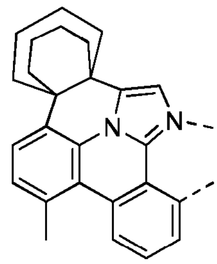
$L_{B411}$ ,
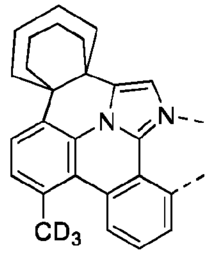
$L_{B412}$ ,
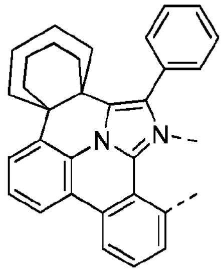
$L_{B413}$ ,
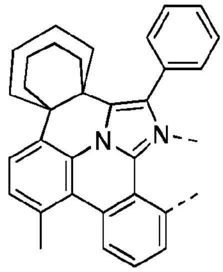
$L_{B414}$ ,
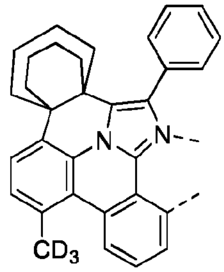
$L_{B415}$ ,
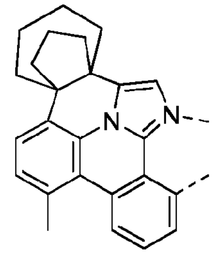
$L_{B416}$ ,
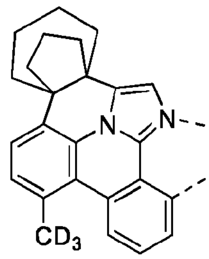
$L_{B417}$ ,
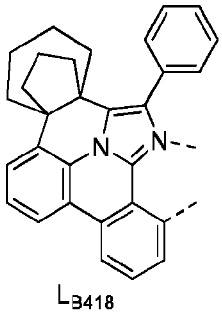
$L_{B418}$ ,
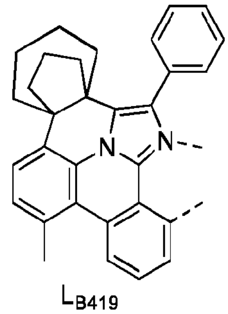
$L_{B419}$ ,
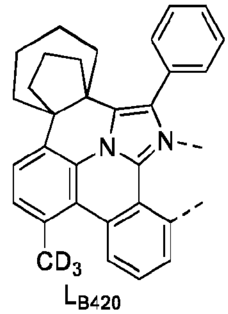
$L_{B420}$ ,
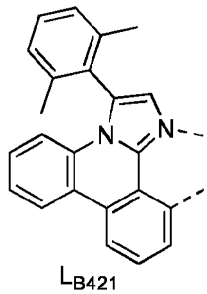
$L_{B421}$ ,
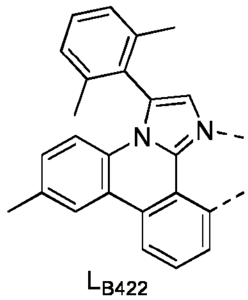
$L_{B422}$ ,
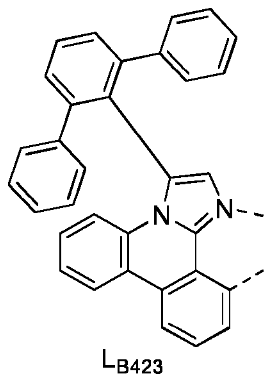
$L_{B423}$ ,
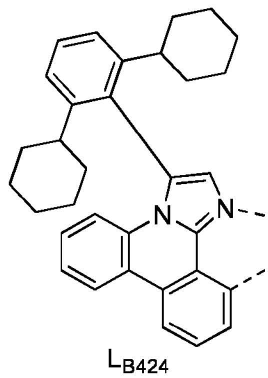
$L_{B424}$ ,
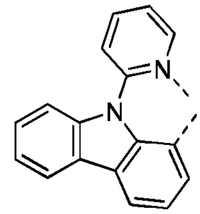
$L_{B425}$ ,

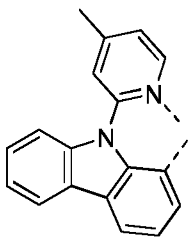
$L_{B426}$ ,
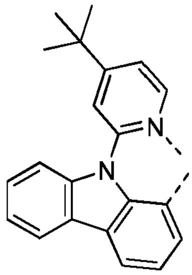
$L_{B427}$ ,
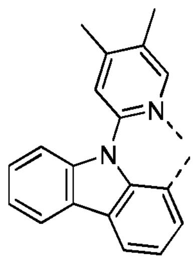
$L_{B428}$ ,
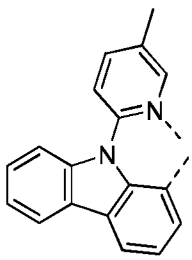
$L_{B429}$ ,
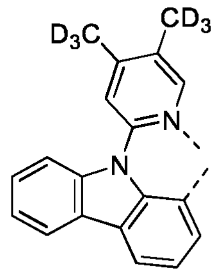
$L_{B430}$ ,

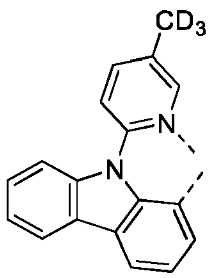
$L_{B431}$ ,
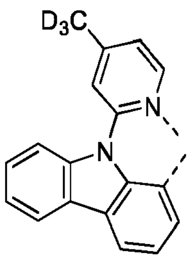
$L_{B432}$ ,
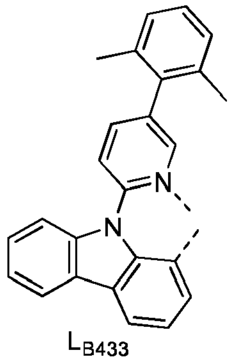
$L_{B433}$ ,
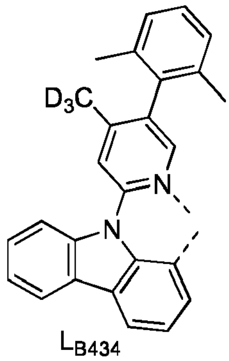
$L_{B434}$ ,
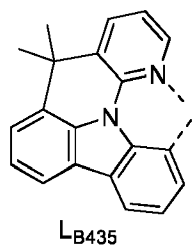
$L_{B435}$ ,

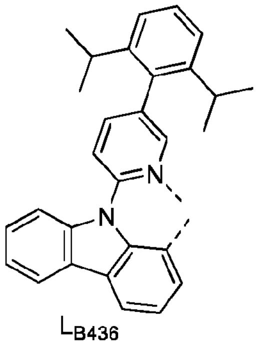
$L_{B436}$ ,
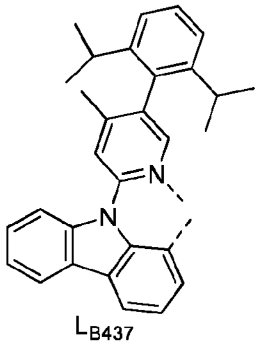
$L_{B437}$ ,
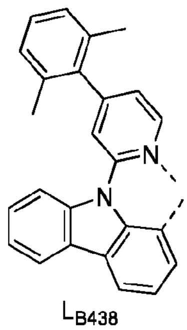
$L_{B438}$ ,
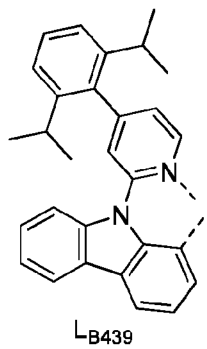
$L_{B439}$ ,
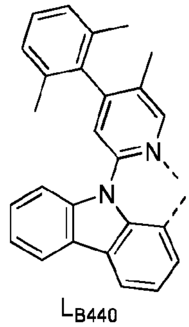
$L_{B440}$

,
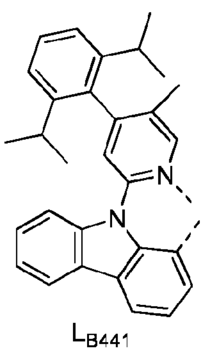
$L_{B441}$ ,
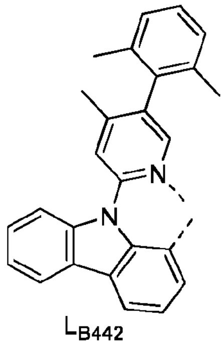
$L_{B442}$ ,
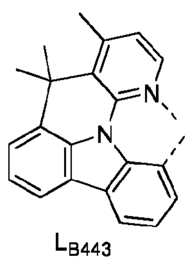
$L_{B443}$ ,
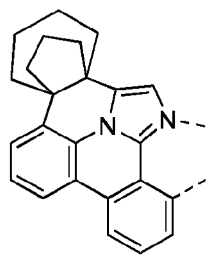
$L_{B444}$ ,
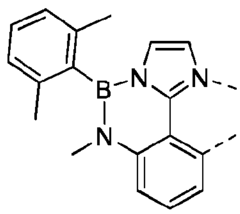
$L_{B445}$ ,

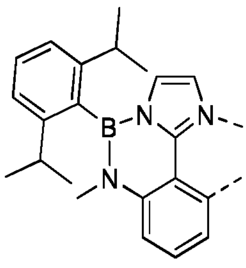
$L_{B446}$ ,
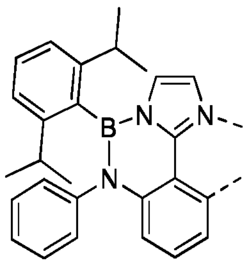
$L_{B447}$ ,
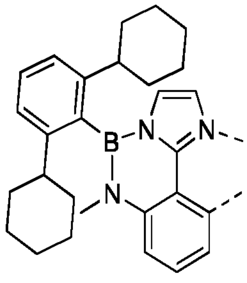
$L_{B448}$ ,
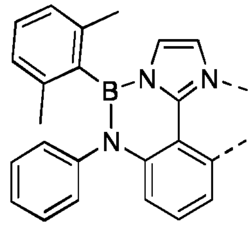
$L_{B449}$ ,

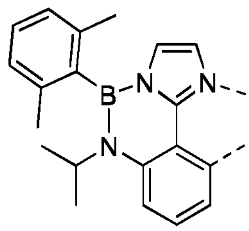
$L_{B450}$ ,
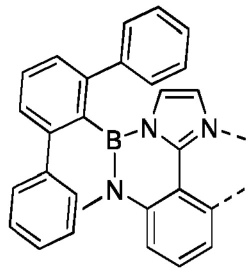
$L_{B451}$ ,
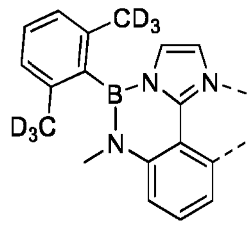
$L_{B452}$ ,
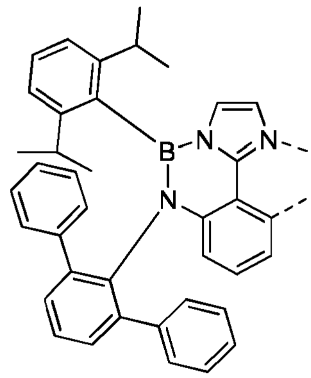
$L_{B453}$ ,

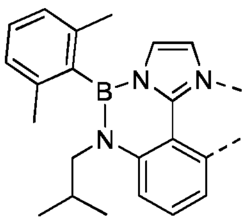
$L_{B454}$ ,
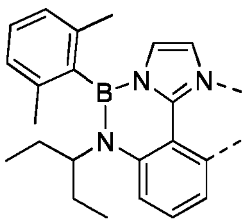
$L_{B455}$ ,
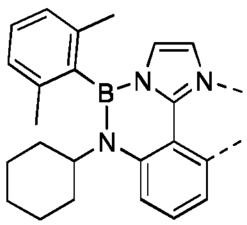
$L_{B456}$ ,
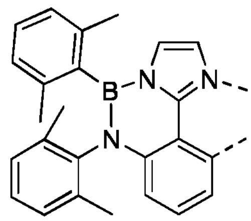
$L_{B457}$ ,

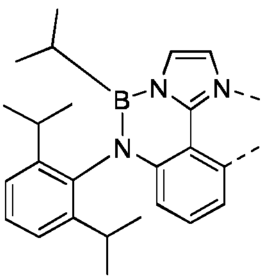
$L_{B458}$ ,
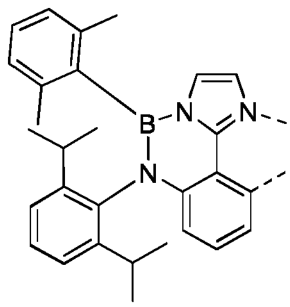
$L_{B459}$ ,
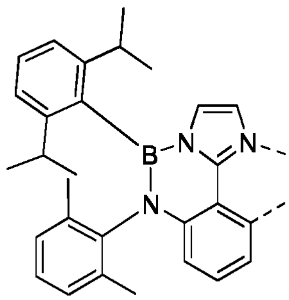
$L_{B460}$ ,

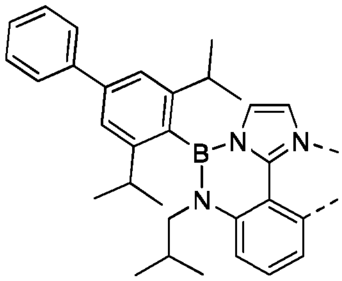

$L_{B461}$ ,

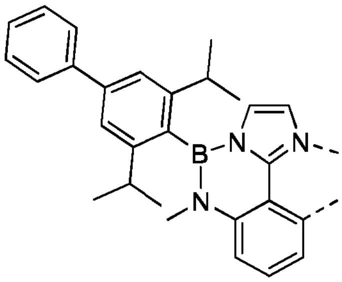

$L_{B462}$ ,

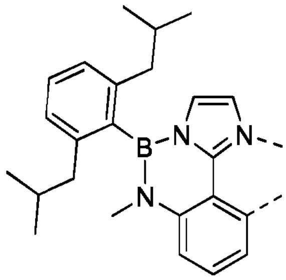

$L_{B463}$ ,

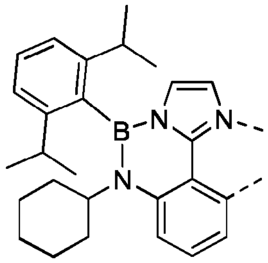

$L_{B464}$ ,

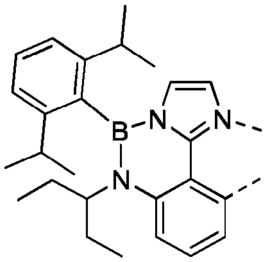

$L_{B465}$ ,

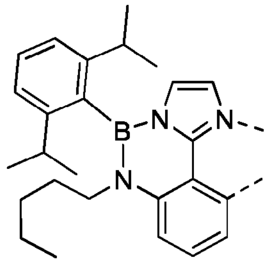

$L_{B466}$ ,

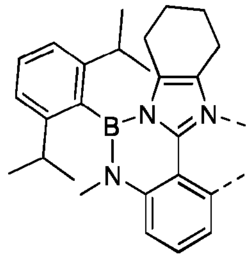

$L_{B467}$ ,

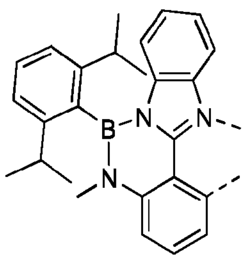

$L_{B468}$ ,

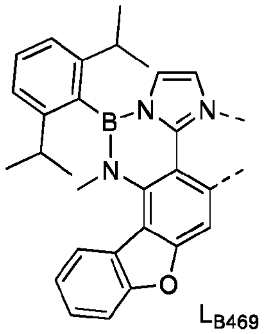

$L_{B469}$ ,

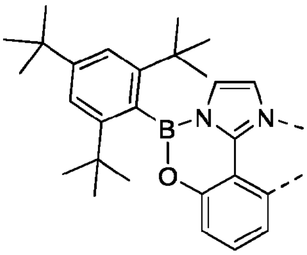

$L_{B470}$ ,

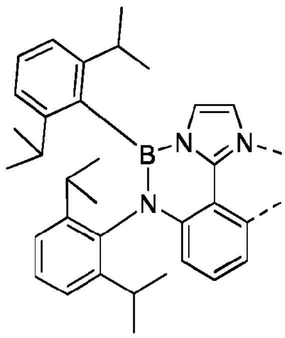

$L_{B471}$ ,

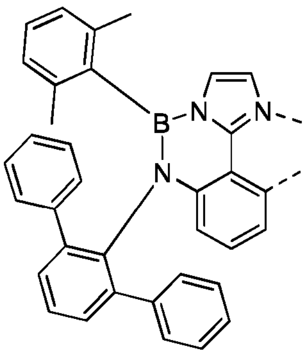

$L_{B472}$ ,

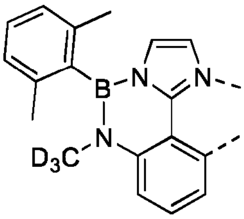

$L_{B473}$ ,

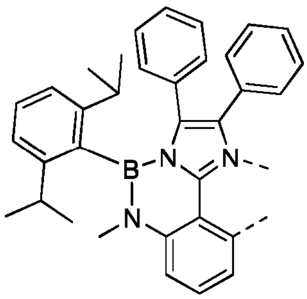

$L_{B474}$ ,

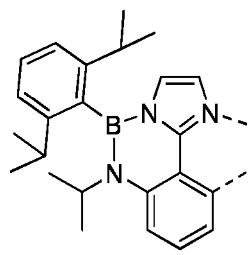

$L_{B475}$ ,

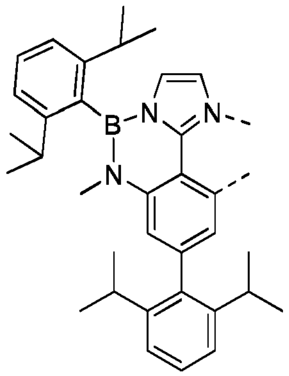

$L_{B476}$ ,

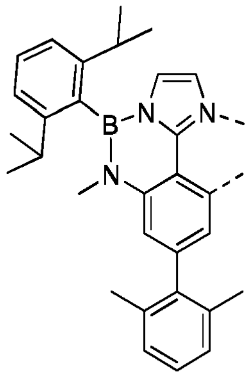

$L_{B477}$ ,

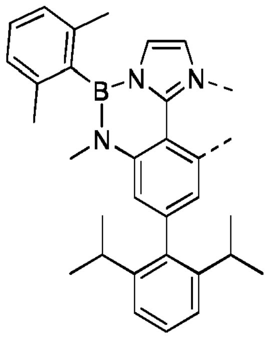

$L_{B478}$ ,

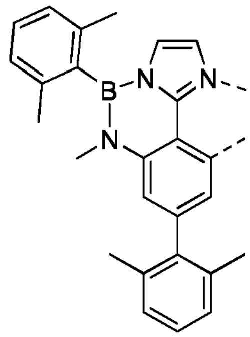

$L_{B479}$ ,

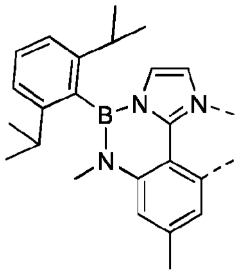

$L_{B480}$ ,

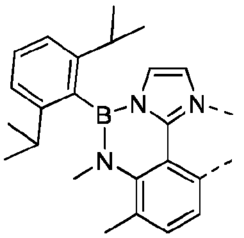

$L_{B481}$ ,

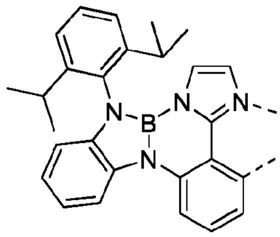

$L_{B482}$ , and

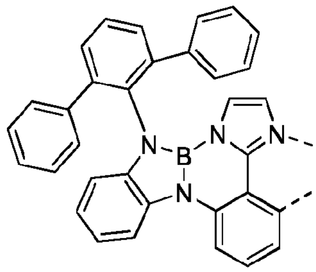

$L_{B483}$ ,

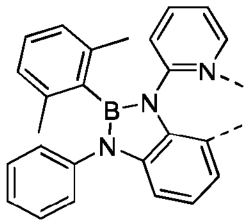

$L_{B484}$ ,

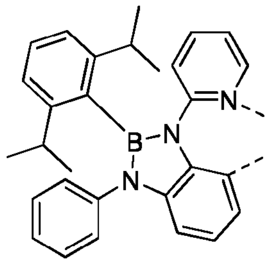

$L_{B485}$ ,

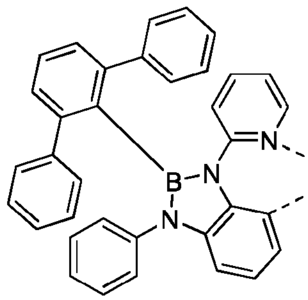

$L_{B486}$ ,

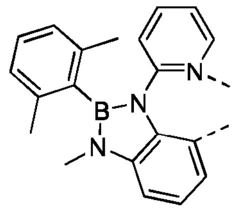

$L_{B487}$ ,

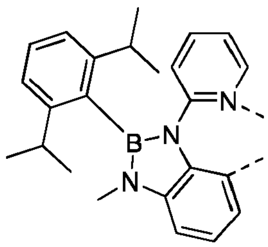

$L_{B488}$ ,

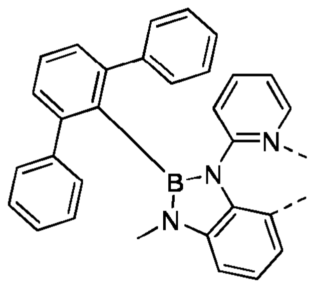

$L_{B489}$ ,

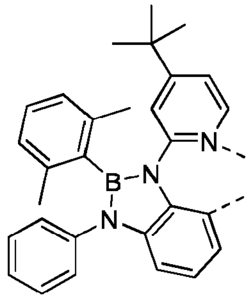

$L_{B490}$ ,

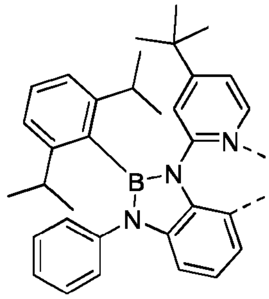

$L_{B491}$ ,

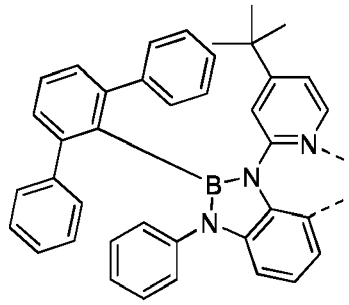

$L_{B492}$ ,

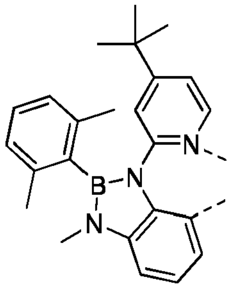

$L_{B493}$ ,

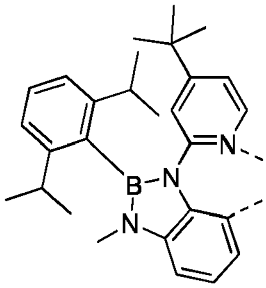

$L_{B494}$ ,

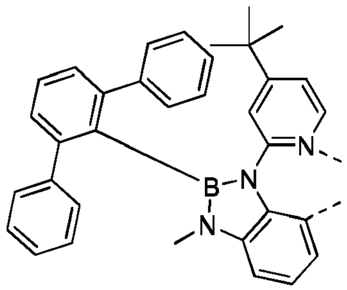

$L_{B495}$ ,

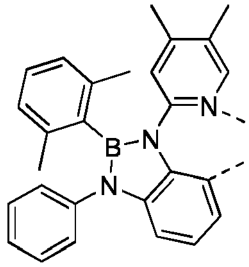

$L_{B496}$ ,

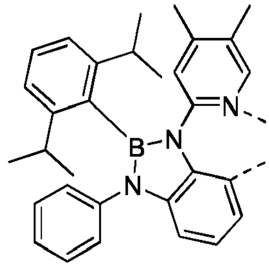

$L_{B497}$ ,

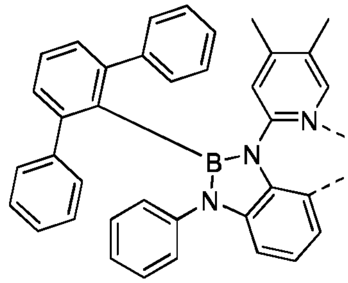

$L_{B498}$ ,

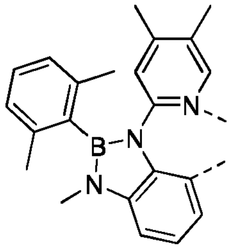

$L_{B499}$ ,

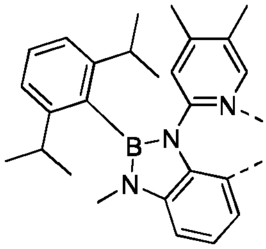

$L_{B500}$ ,

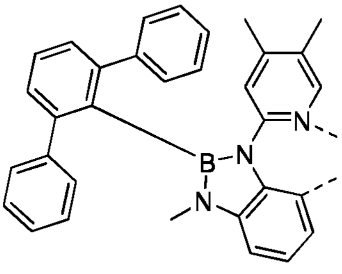

$L_{B501}$ ,

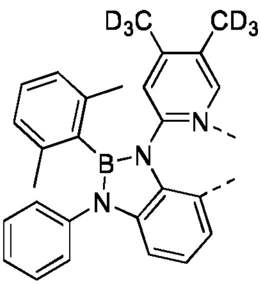

$L_{B502}$ ,

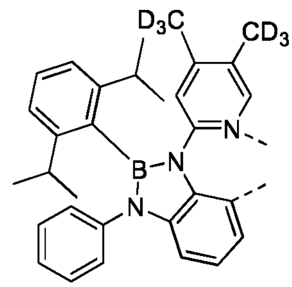

$L_{B503}$ ,

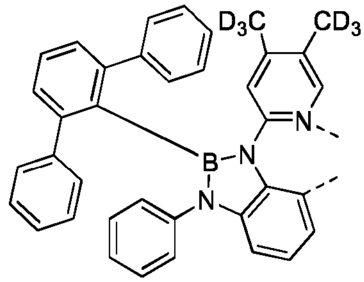
$L_{B504}$ ,
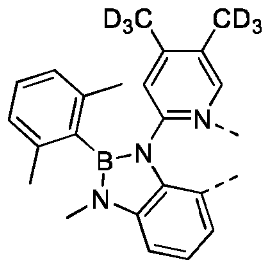
$L_{B505}$ ,
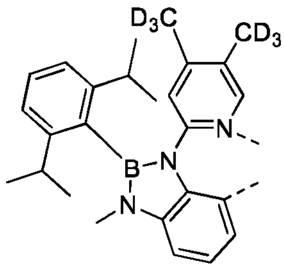
$L_{B506}$ ,

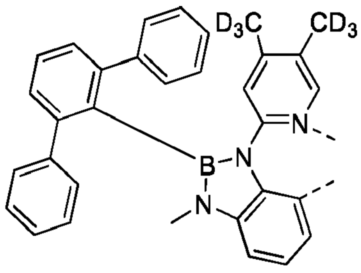
$L_{B507}$ ,
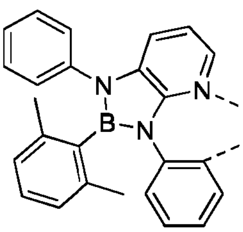
$L_{B508}$ ,
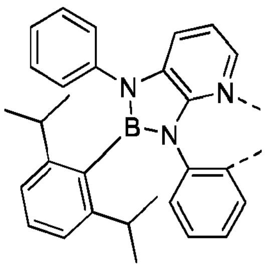
$L_{B509}$ ,

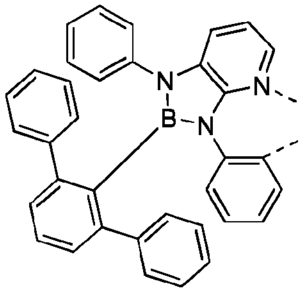
$L_{B510}$ ,
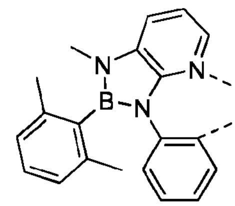
$L_{B511}$ ,
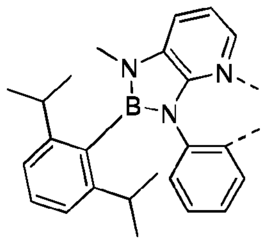
$L_{B512}$ ,
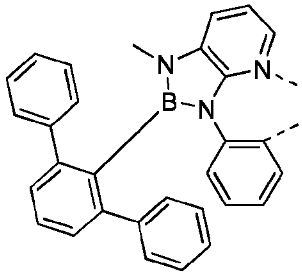
$L_{B513}$ ,

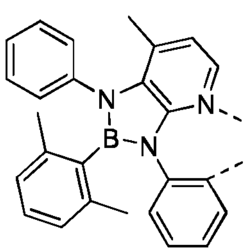
$L_{B514}$ ,
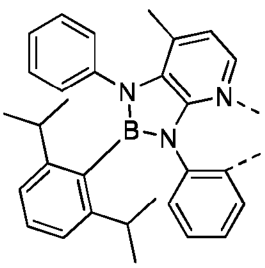
$L_{B515}$ ,
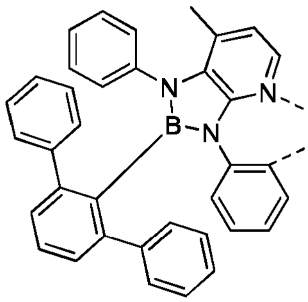
$L_{B516}$ ,
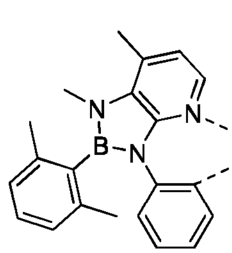
$L_{B517}$ ,

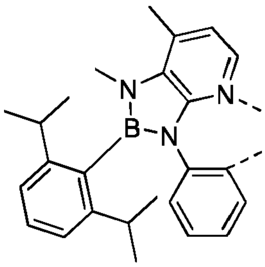
$L_{B518}$ ,
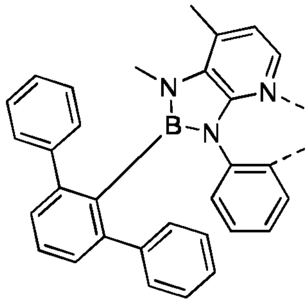
$L_{B519}$ ,
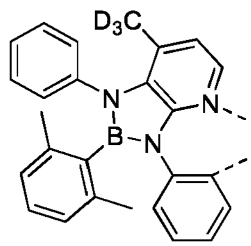
$L_{B520}$ ,
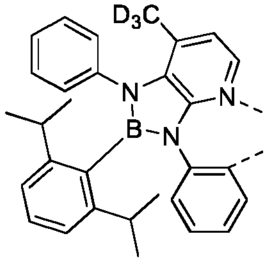
$L_{B521}$ ,

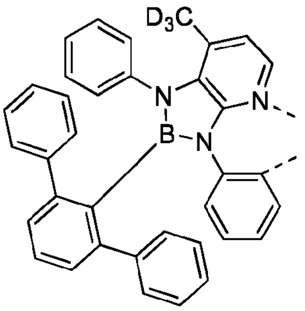
$L_{B522}$ ,
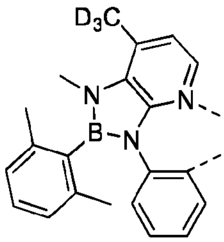
$L_{B523}$ ,
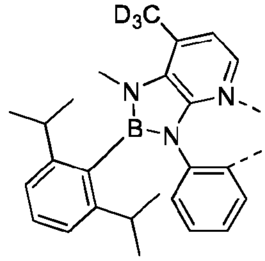
$L_{B524}$ ,
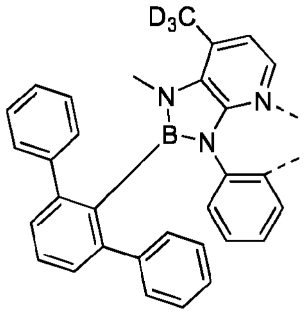
$L_{B525}$ ,

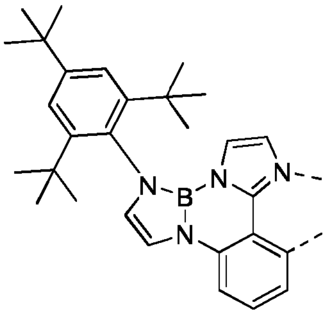
$L_{B526}$ ,
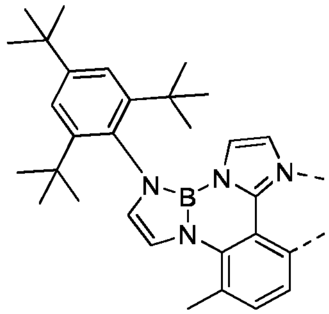
$L_{B527}$ ,
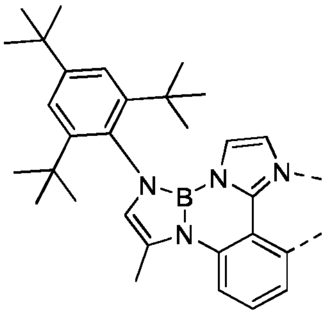
$L_{B528}$ ,

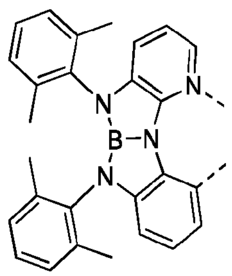
$L_{B529}$ ,
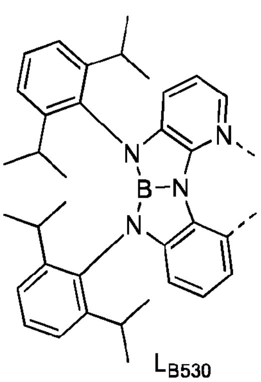
$L_{B530}$ ,
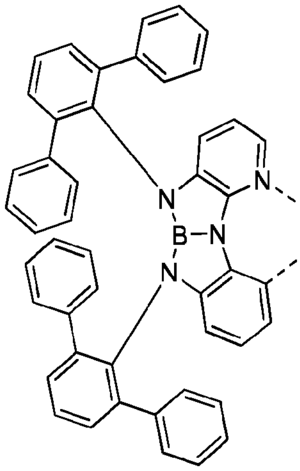
$L_{B531}$ ,
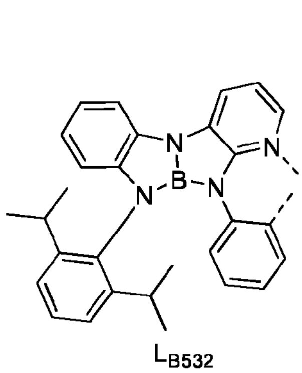
$L_{B532}$ ,

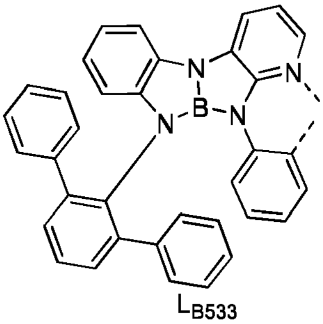

$L_{B533}$ ,

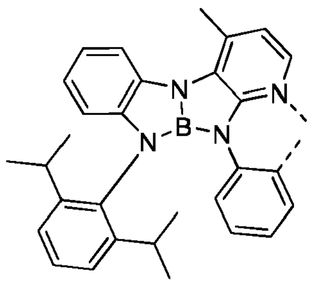

$L_{B534}$ ,

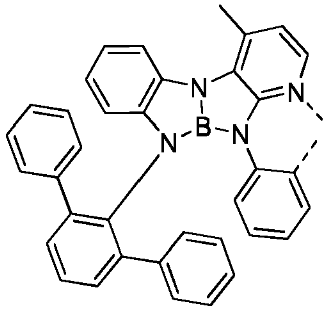

$L_{B535}$ ,

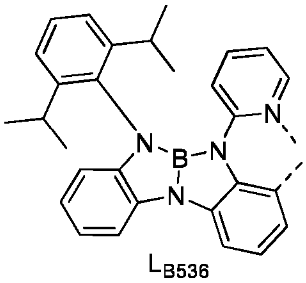

$L_{B536}$ ,

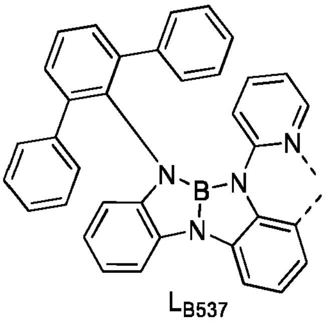

$L_{B537}$ ,

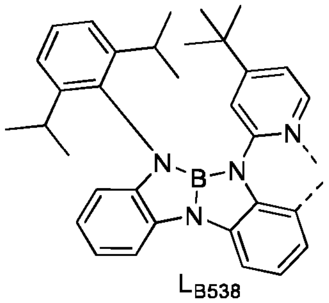

$L_{B538}$ ,

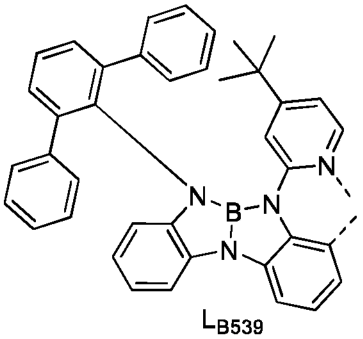

$L_{B539}$ ,

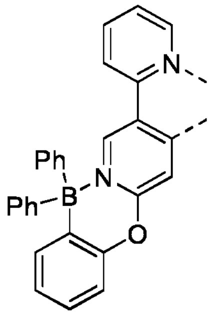

$L_{B540}$ ,

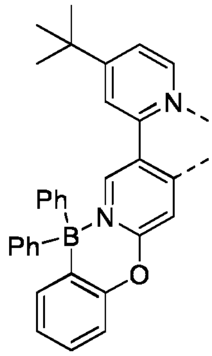

$L_{B541}$ ,

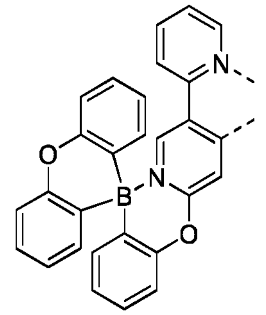

$L_{B542}$ ,

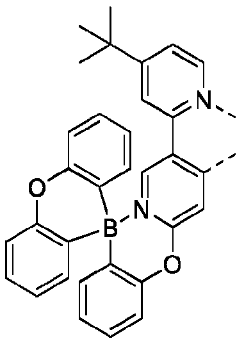

$L_{B543}$ ,

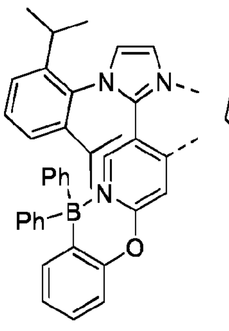

$L_{B544}$ ,

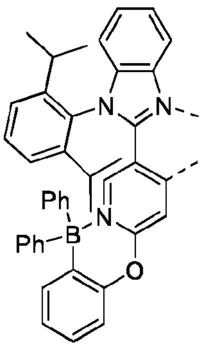

$L_{B545}$ ,

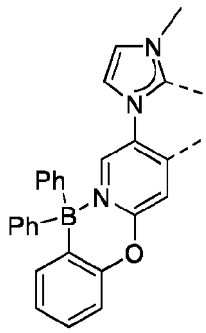

$L_{B546}$ ,

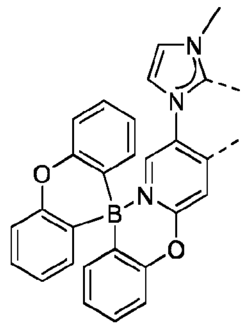

$L_{B547}$

, 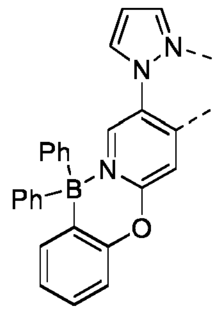 $L_{B548}$ , 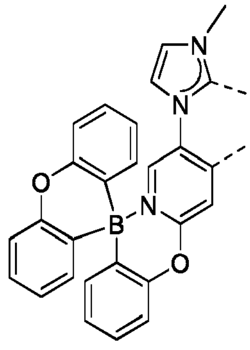 $L_{B549}$ , 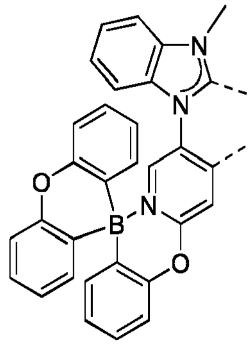 $L_{B550}$ , 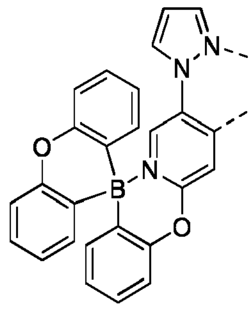 $L_{B551}$ ,

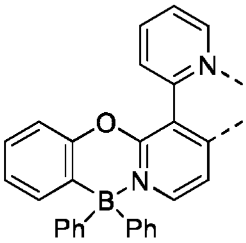 $L_{B552}$ , 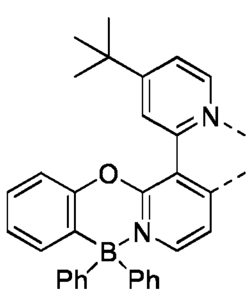 $L_{B553}$ , 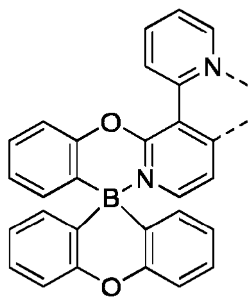 $L_{B554}$ , 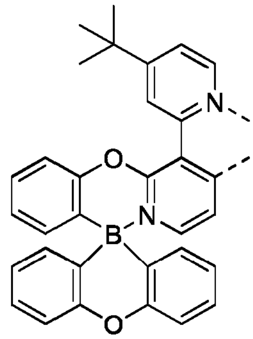 $L_{B555}$ ,

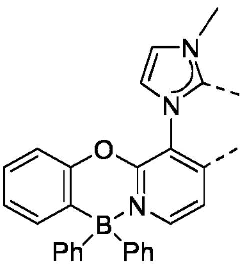 $L_{B556}$ , 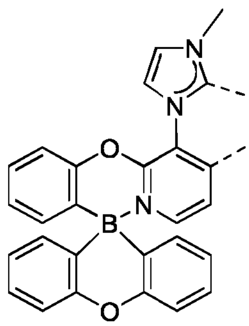 $L_{B557}$ , 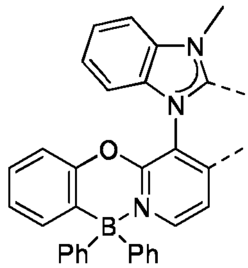 $L_{B558}$ , 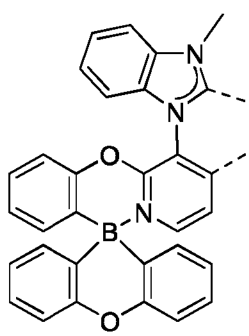 $L_{B559}$ ,

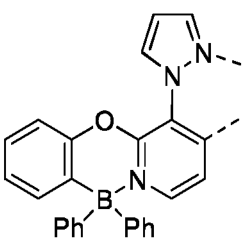 $L_{B560}$ , 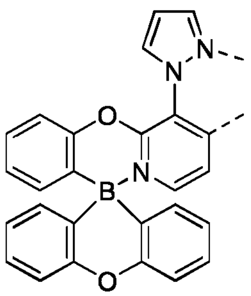 $L_{B561}$ , 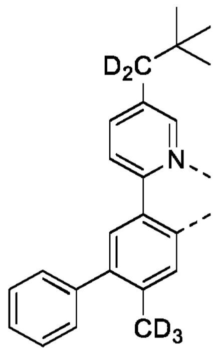 $L_{B562}$ , 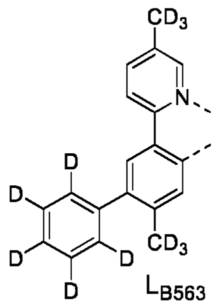 $L_{B563}$ ,

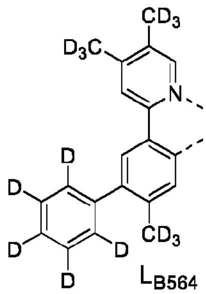 $L_{B564}$, 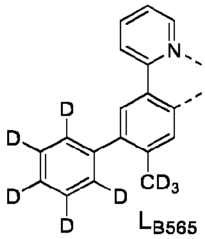 $L_{B565}$, 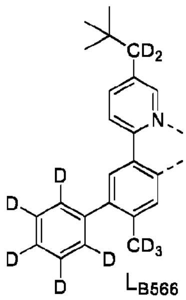 $L_{B566}$, 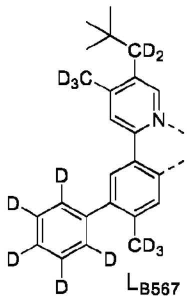 $L_{B567}$, 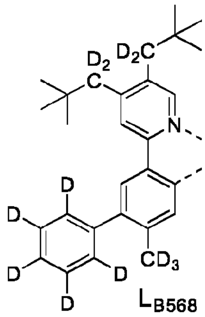 $L_{B568}$, 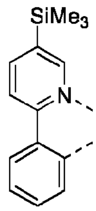 $L_{B569}$

, 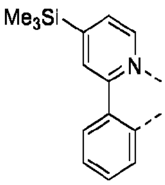 $L_{B570}$, 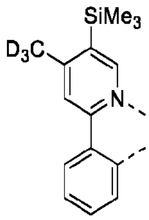 $L_{B571}$, 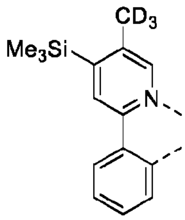 $L_{B572}$, 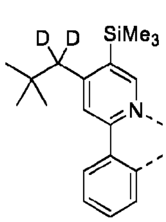 $L_{B573}$, 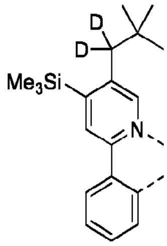 $L_{B574}$, 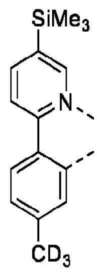 $L_{B575}$, 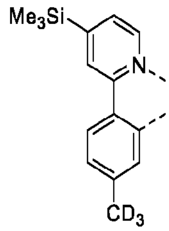 $L_{B576}$,

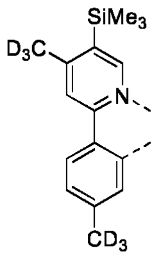 $L_{B577}$, 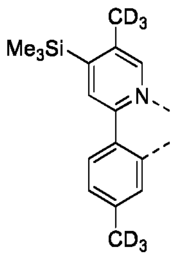 $L_{B578}$, 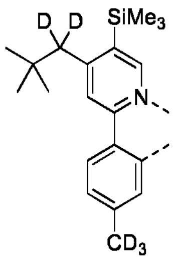 $L_{B579}$, 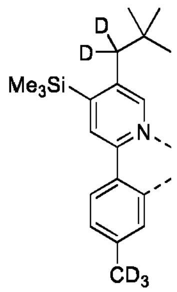 $L_{B580}$, 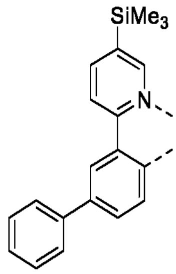 $L_{B581}$, 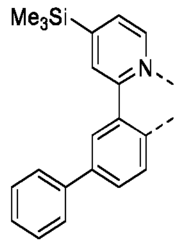 $L_{B582}$,

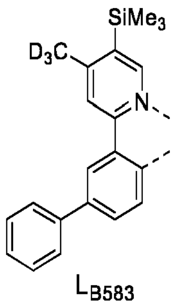 $L_{B583}$, 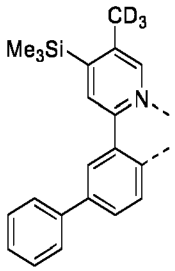 $L_{B584}$, 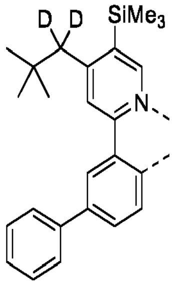 $L_{B585}$, 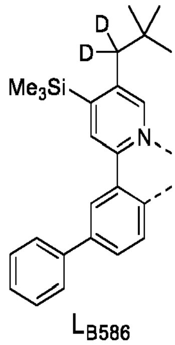 $L_{B586}$, 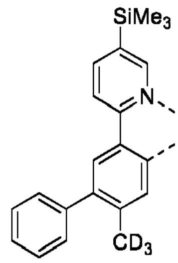 $L_{B587}$, 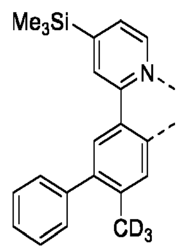 $L_{B588}$,

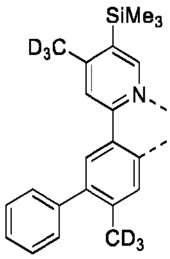
$L_{B589}$ ,
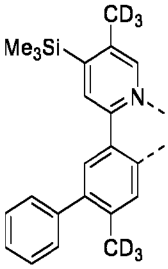
$L_{B590}$ ,
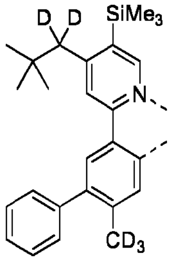
$L_{B591}$ ,
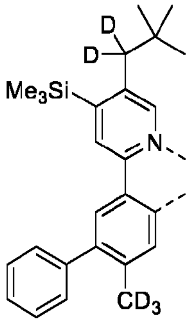
$L_{B592}$ ,
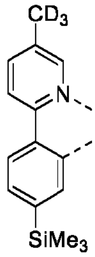
$L_{B593}$ ,
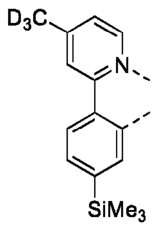
$L_{B594}$ ,
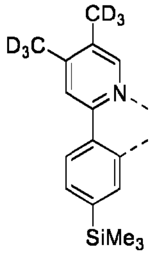
$L_{B595}$ ,

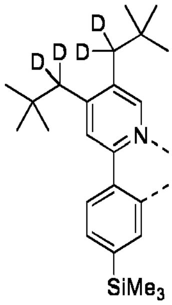
$L_{B596}$ ,
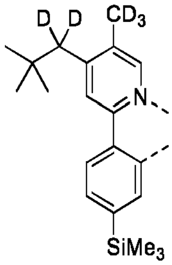
$L_{B597}$ ,
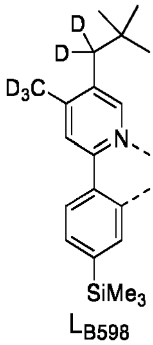
$L_{B598}$ ,
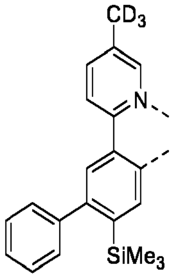
$L_{B599}$ ,
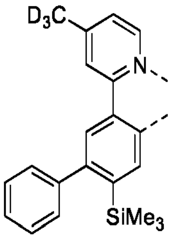
$L_{B600}$ ,
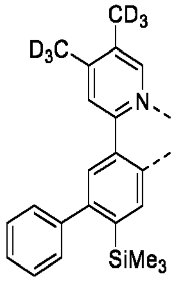
$L_{B601}$ ,

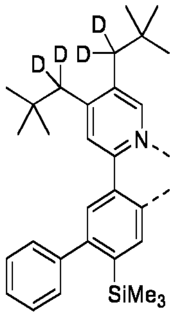
$L_{B602}$ ,
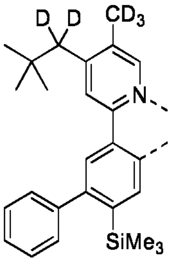
$L_{B603}$ ,
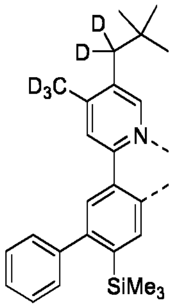
$L_{B604}$ ,
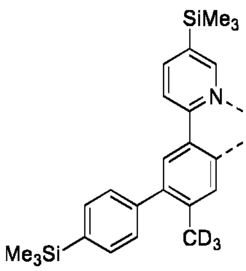
$L_{B605}$ ,
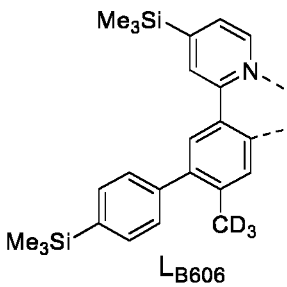
$L_{B606}$ ,

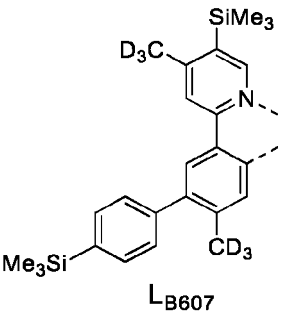
$L_{B607}$ ,
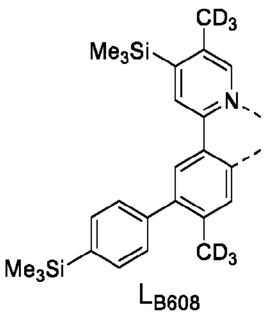
$L_{B608}$ ,
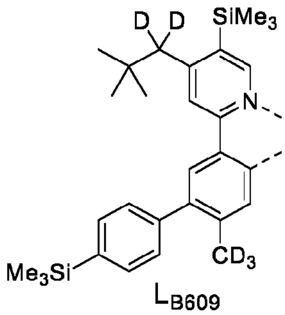
$L_{B609}$ ,
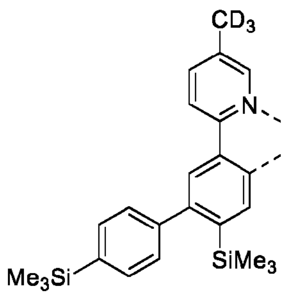
$L_{B610}$ ,

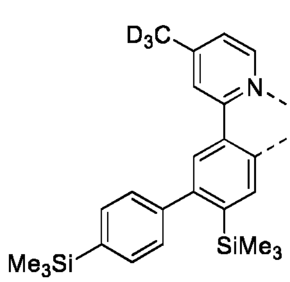
$L_{B611}$ ,
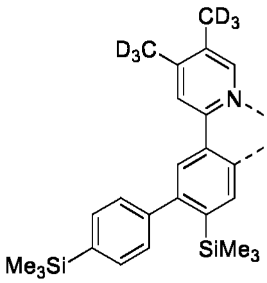
$L_{B612}$ ,
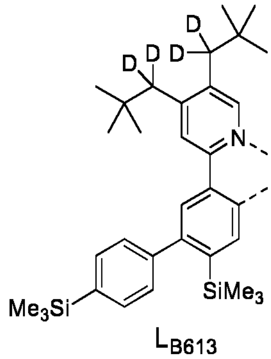
$L_{B613}$ ,
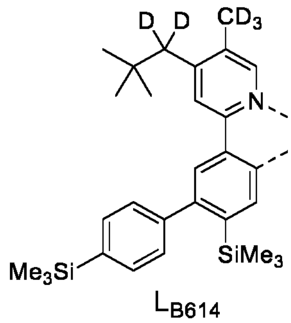
$L_{B614}$ ,

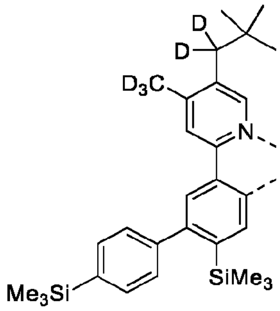
$L_{B615}$ ,
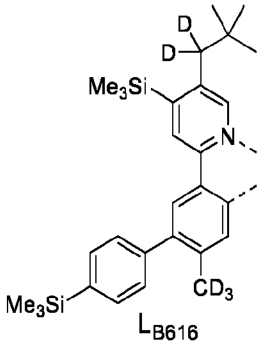
$L_{B616}$ ,
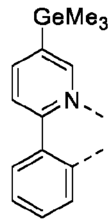
$L_{B617}$ ,
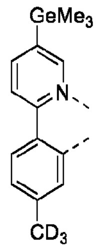
$L_{B618}$ ,
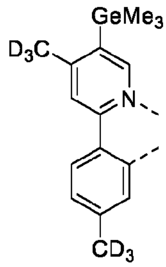
$L_{B619}$
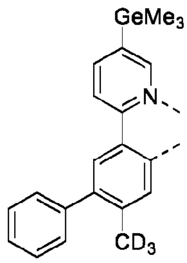
$L_{B622}$ ,

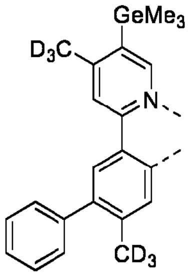
$L_{B621}$ ,
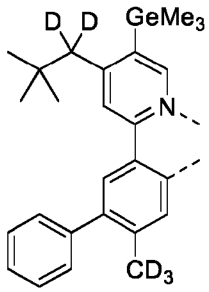
$L_{B622}$ ,
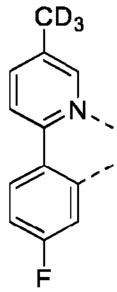
$L_{B623}$ ,
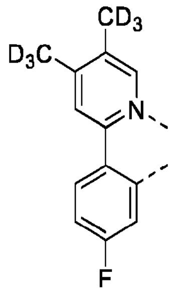
$L_{B624}$ ,
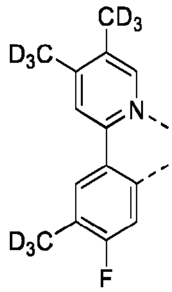
$L_{B625}$ ,
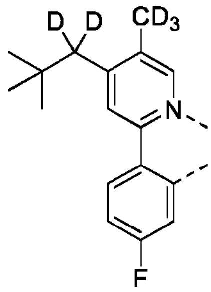
$L_{B626}$ ,

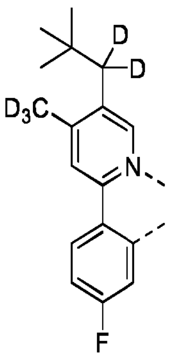
$L_{B627}$ ,
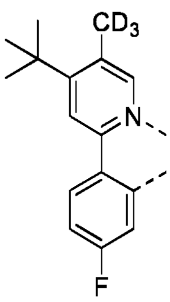
$L_{B628}$ ,
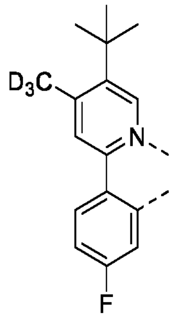
$L_{B629}$ ,
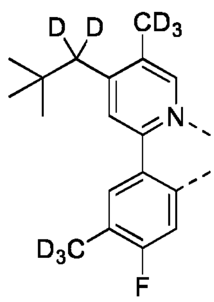
$L_{B630}$ ,
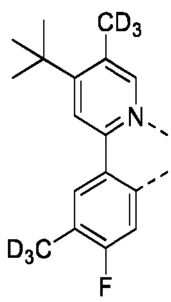
$L_{B631}$ ,
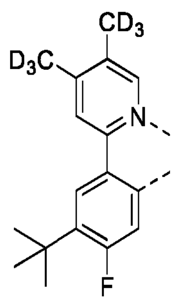
$L_{B632}$ ,

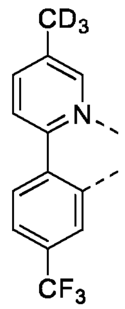 $L_{B633}$ , 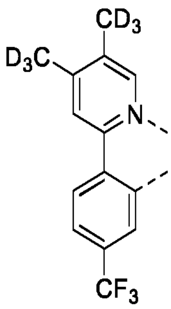 $L_{B634}$ , 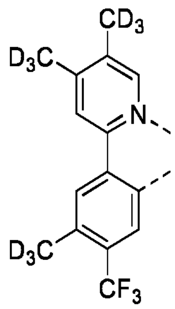 $L_{B635}$ , 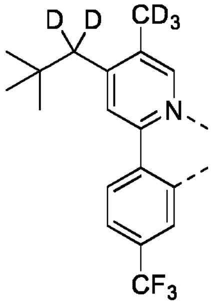 $L_{B636}$ , 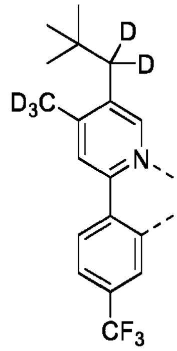 $L_{B637}$ , 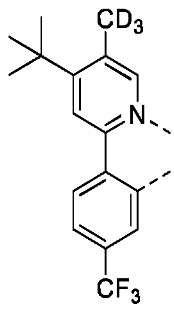 $L_{B638}$ ,

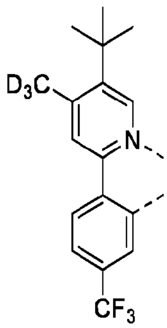 $L_{B639}$ , 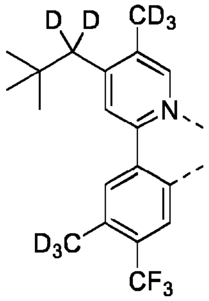 $L_{B640}$ , 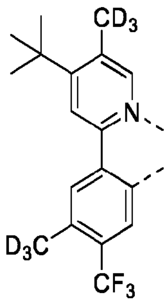 $L_{B641}$ , 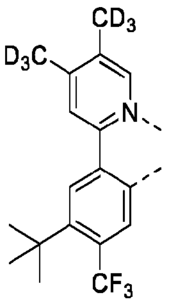 $L_{B642}$ , 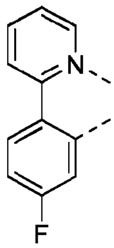 $L_{B643}$ , 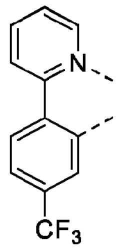 $L_{B644}$ , 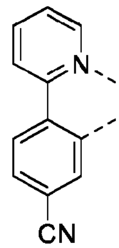 $L_{B645}$ ,

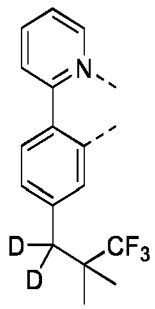 $L_{B646}$ , 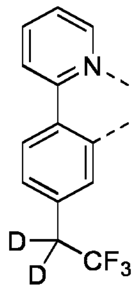 $L_{B647}$ , 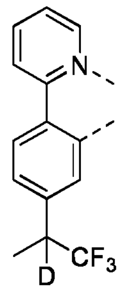 $L_{B648}$ , 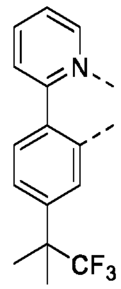 $L_{B649}$ , 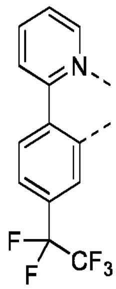 $L_{B650}$ , 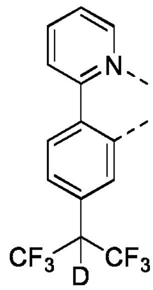 $L_{B651}$ , 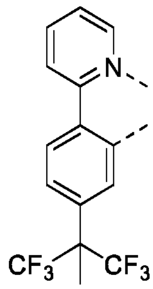 $L_{B652}$ ,

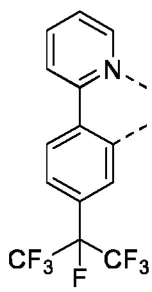 $L_{B653}$ , 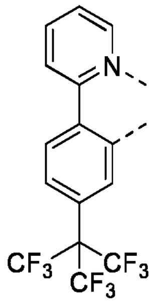 $L_{B654}$ , 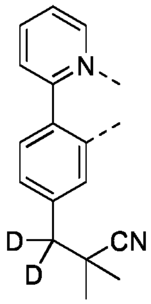 $L_{B655}$ , 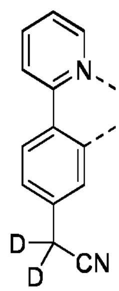 $L_{B656}$ , 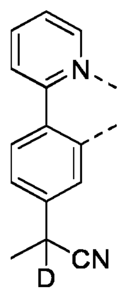 $L_{B657}$ , 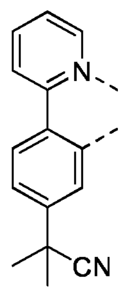 $L_{B658}$ , 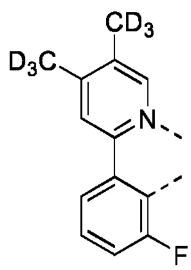 $L_{B659}$ ,

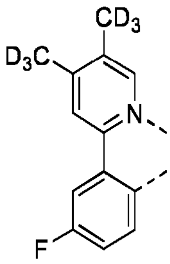 $L_{B660}$, 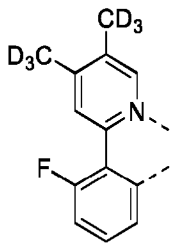 $L_{B661}$, 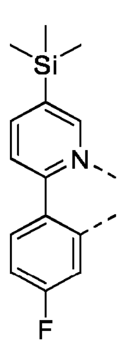 $L_{B662}$, 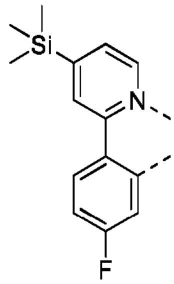 $L_{B663}$, 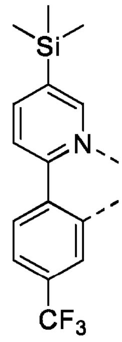 $L_{B664}$, 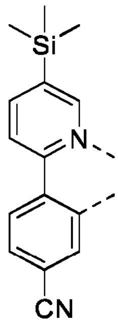 $L_{B665}$, 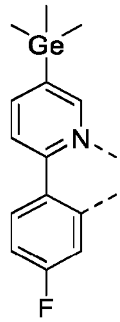 $L_{B666}$,

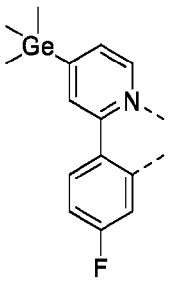 $L_{B667}$, 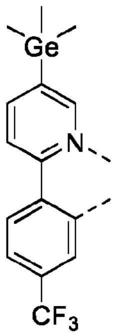 $L_{B668}$, 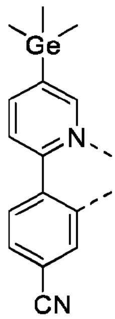 $L_{B669}$, 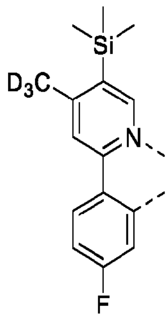 $L_{B670}$, 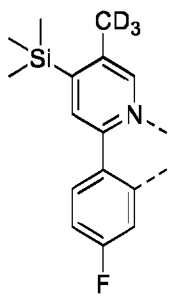 $L_{B671}$, 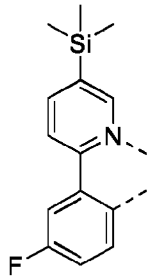 $L_{B672}$, 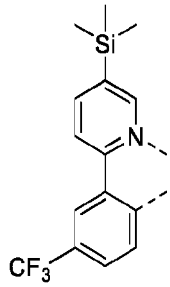 $L_{B673}$,

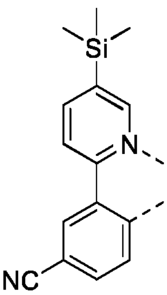 $L_{B674}$, 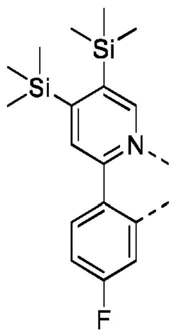 $L_{B675}$, 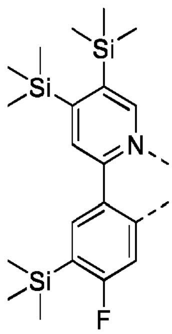 $L_{B676}$, 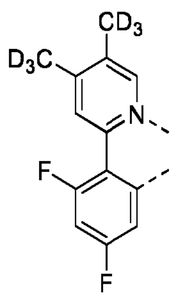 $L_{B677}$, 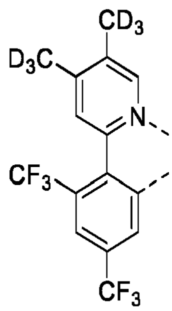 $L_{B678}$, 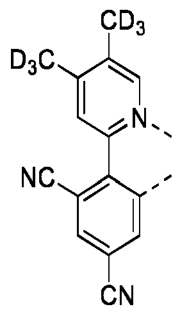 $L_{B679}$,

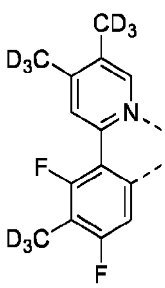 $L_{B680}$, 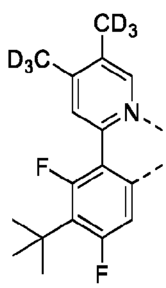 $L_{B681}$, 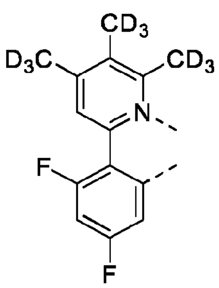 $L_{B682}$, 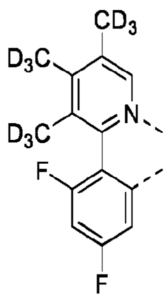 $L_{B683}$, 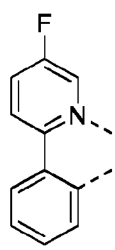 $L_{B684}$, 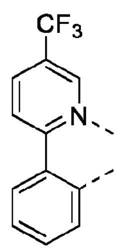 $L_{B685}$, 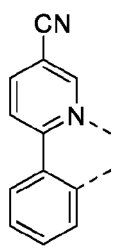 $L_{B686}$,

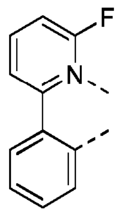 $L_{B687}$ , 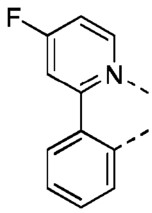 $L_{B688}$ , 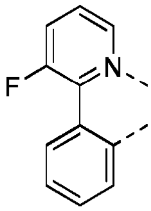 $L_{B689}$ , 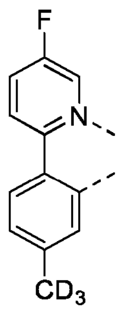 $L_{B690}$ , 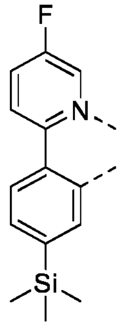 $L_{B691}$ , 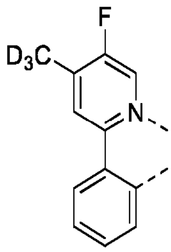 $L_{B692}$ , 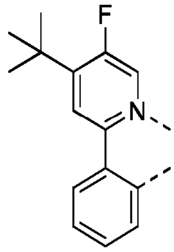 $L_{B693}$ ,

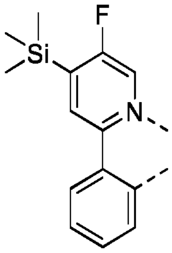 $L_{B694}$ , 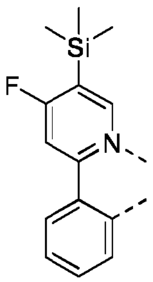 $L_{B695}$ , 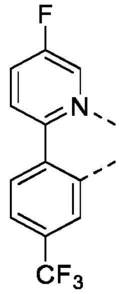 $L_{B696}$ , 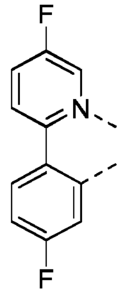 $L_{B697}$ , 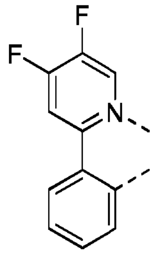 $L_{B698}$ , 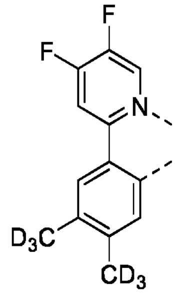 $L_{B699}$ ,

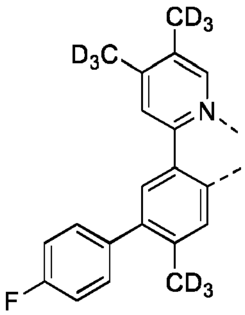 $L_{B700}$ , 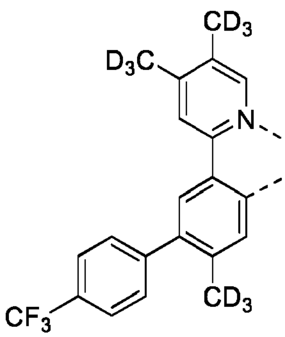 $L_{B701}$ , 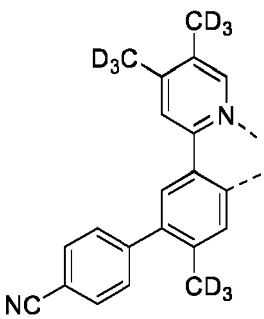 $L_{B702}$ , 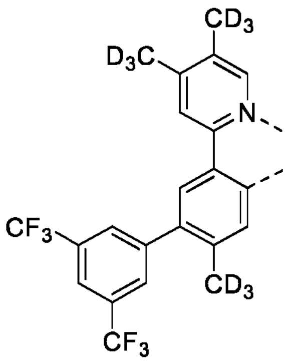 $L_{B703}$ ,

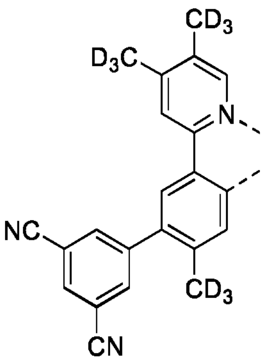 $L_{B704}$ , 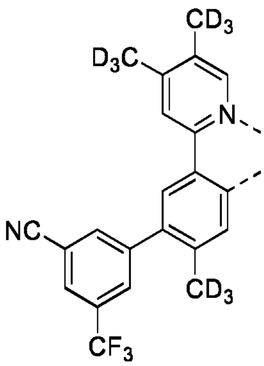 $L_{B705}$ , 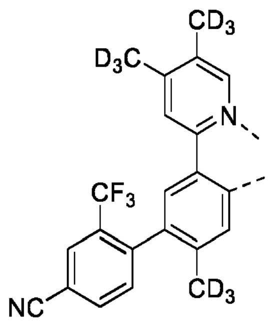 $L_{B706}$ , 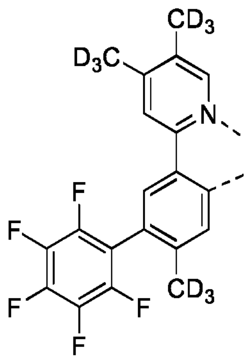 $L_{B707}$ ,

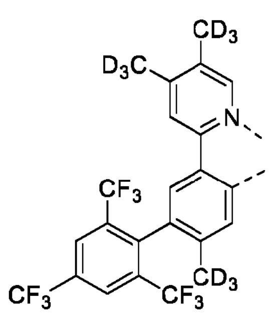
$L_{B708}$ ,
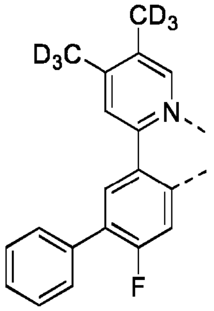
$L_{B709}$ ,
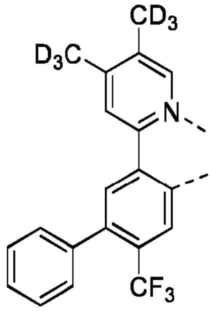
$L_{B710}$ ,
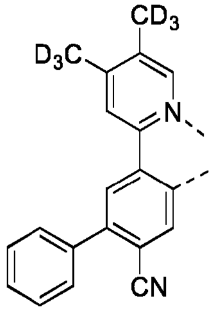
$L_{B711}$ ,

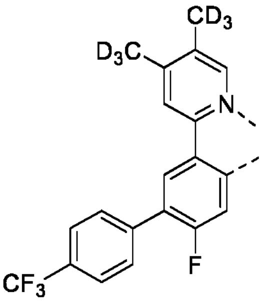
$L_{B712}$ ,
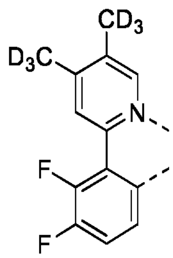
$L_{B713}$ ,
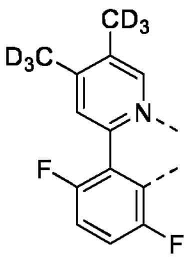
$L_{B714}$ ,
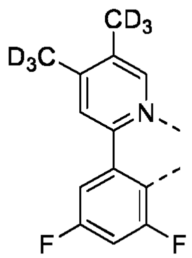
$L_{B715}$ ,
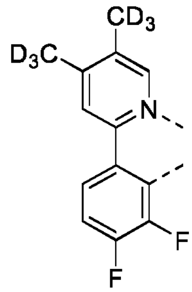
$L_{B716}$ ,

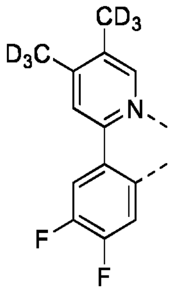
$L_{B717}$ ,
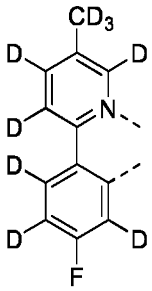
$L_{B718}$ ,
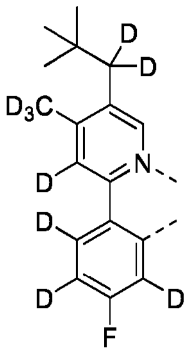
$L_{B719}$ ,
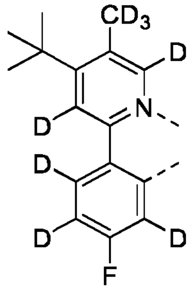
$L_{B720}$ ,
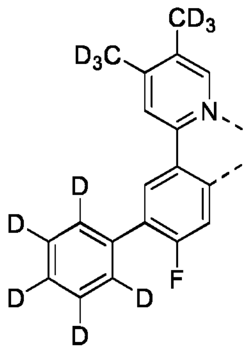
$L_{B721}$ ,

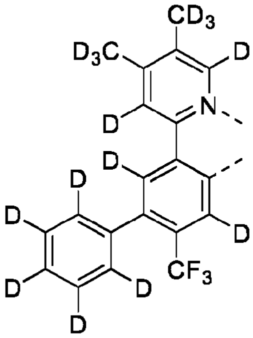
$L_{B722}$ ,
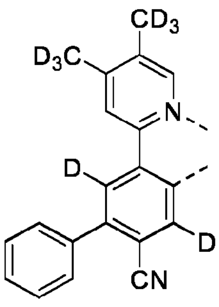
$L_{B723}$ ,
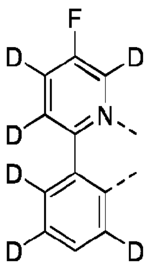
$L_{B724}$ ,
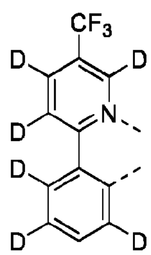
$L_{B725}$ ,
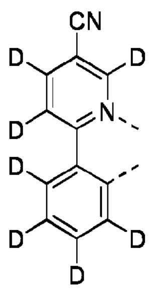
$L_{B726}$ ,
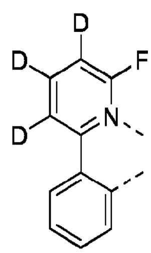
$L_{B727}$ ,

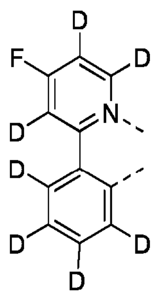
$L_{B728}$ ,
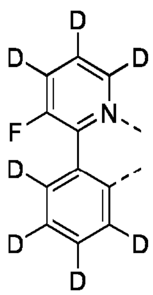
$L_{B729}$ ,
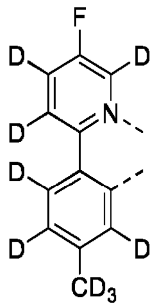
$L_{B730}$ ,
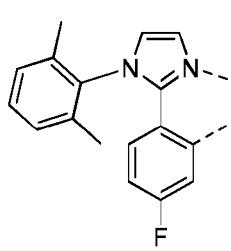
$L_{B731}$ ,
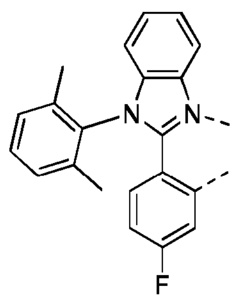
$L_{B732}$ ,

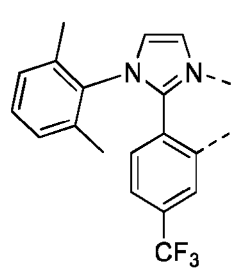
$L_{B733}$ ,
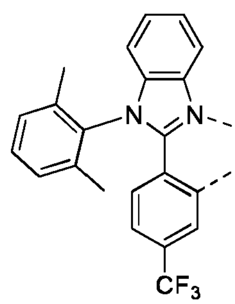
$L_{B734}$ ,
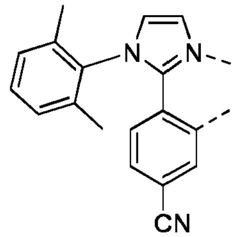
$L_{B735}$ ,
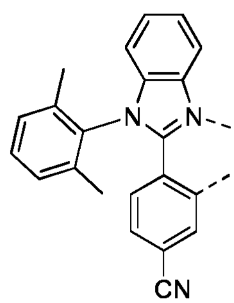
$L_{B736}$ ,

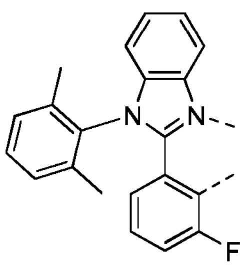
$L_{B737}$ ,
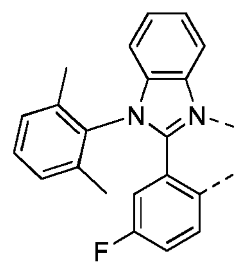
$L_{B738}$ ,
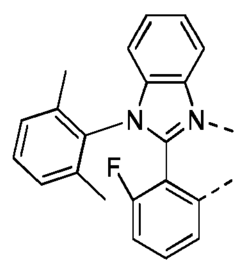
$L_{B739}$ ,
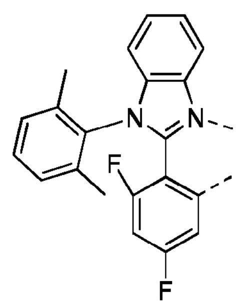
$L_{B740}$ ,

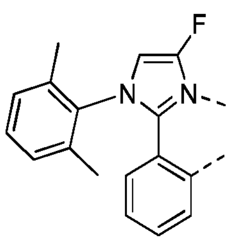
$L_{B741}$ ,
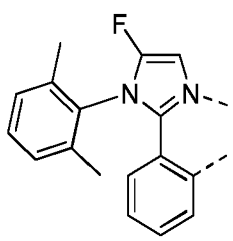
$L_{B742}$ ,
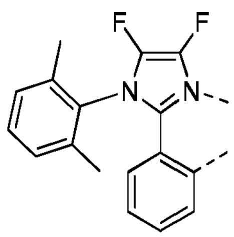
$L_{B743}$ ,
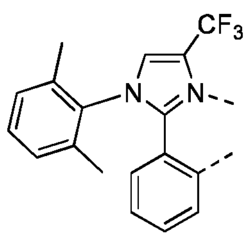
$L_{B744}$ ,

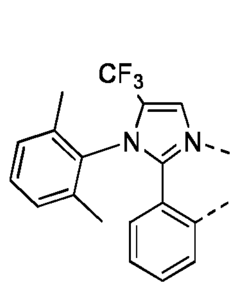
$L_{B745}$ ,
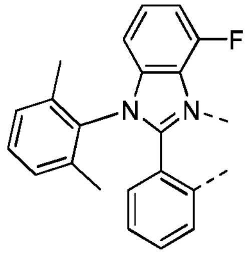
$L_{B746}$ ,
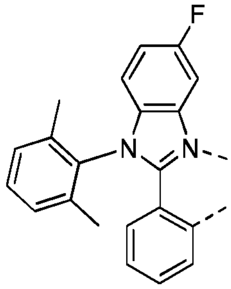
$L_{B747}$ ,
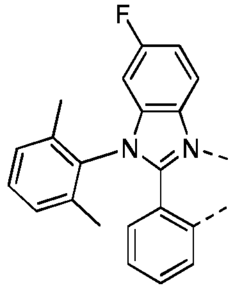
$L_{B748}$ ,

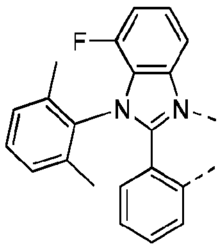
$L_{B749}$ ,
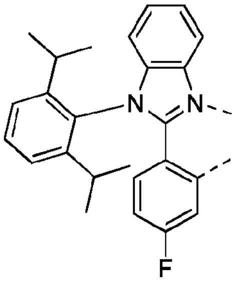
$L_{B750}$ ,
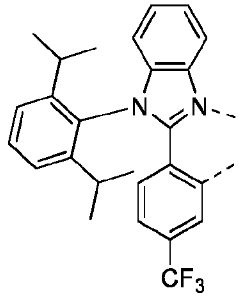
$L_{B751}$ ,
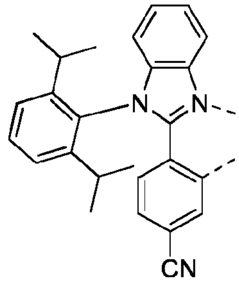
$L_{B752}$ ,
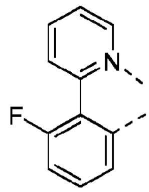
$L_{B753}$ ,

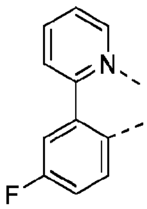
$L_{B754}$ ,
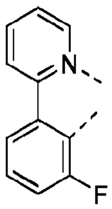
$L_{B755}$ ,
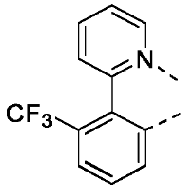
$L_{B756}$ ,
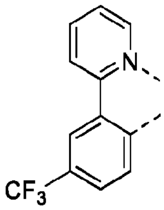
$L_{B757}$ ,
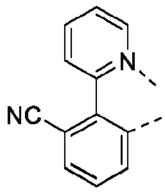
$L_{B758}$ ,
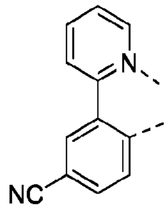
$L_{B759}$ ,
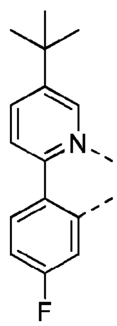
$L_{B760}$

,
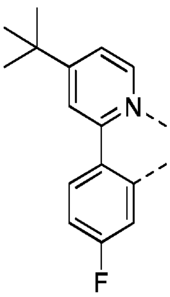
$L_{B761}$ ,
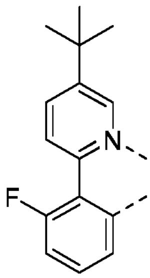
$L_{B762}$ ,
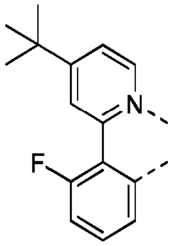
$L_{B763}$ ,
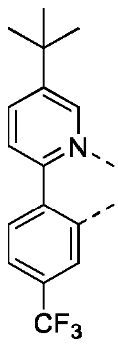
$L_{B764}$ ,
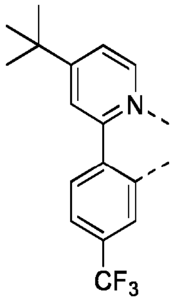
$L_{B765}$ ,
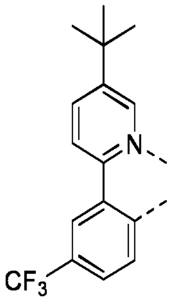
$L_{B766}$ ,

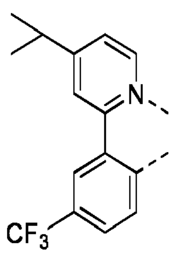 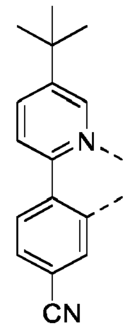 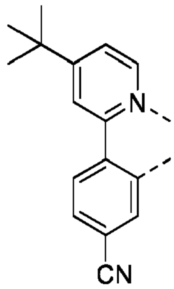

$L_{B767}$ , $L_{B768}$ , $L_{B769}$ ,

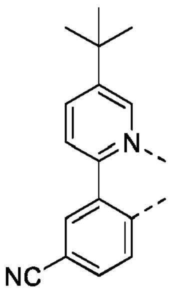 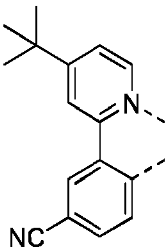 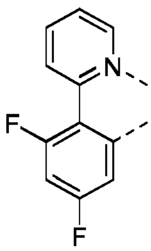 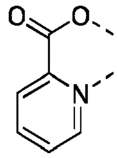 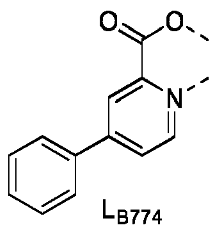 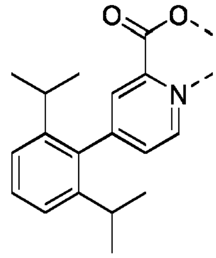

$L_{B770}$ , $L_{B771}$ , $L_{B772}$ , $L_{B773}$ , $L_{B774}$ , $L_{B775}$ ,

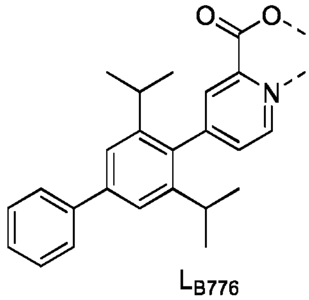 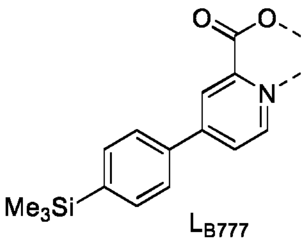 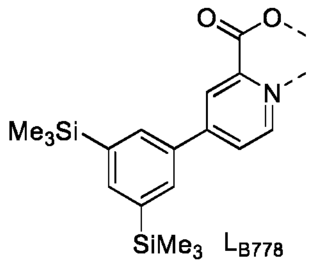

$L_{B776}$ , $L_{B777}$ , $L_{B778}$ ,

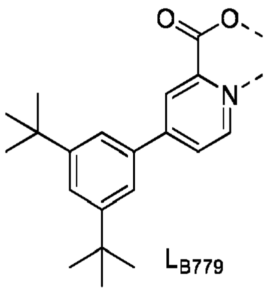 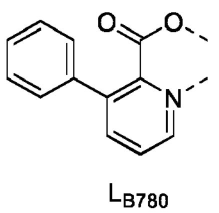 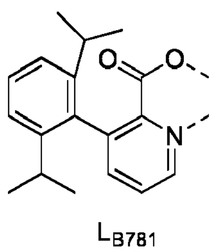 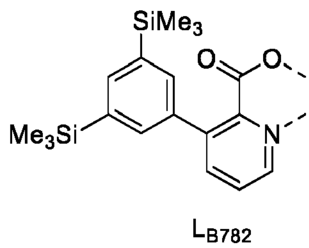

$L_{B779}$ , $L_{B780}$ , $L_{B781}$ , $L_{B782}$ ,

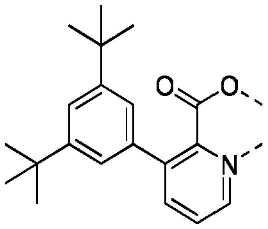
$L_{B783}$ ,
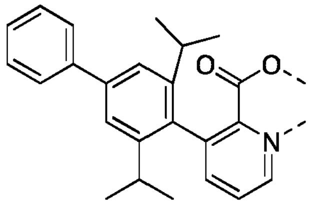
$L_{B784}$ ,
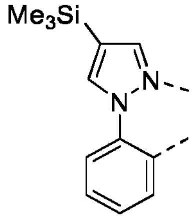
$L_{B785}$ ,
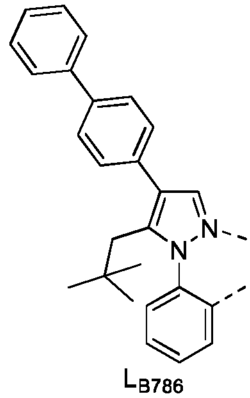
$L_{B786}$ ,

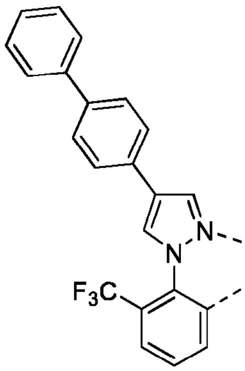
$L_{B787}$ ,
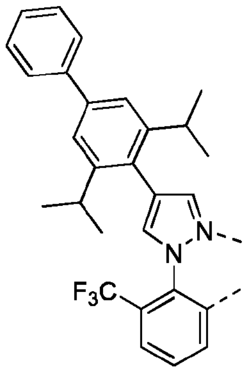
$L_{B788}$ ,
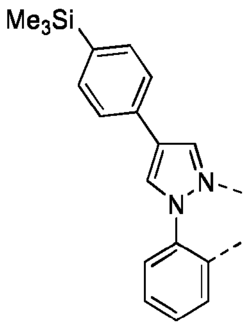
$L_{B789}$ ,
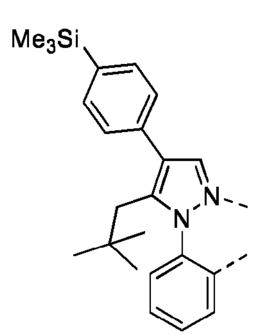
$L_{B790}$ ,

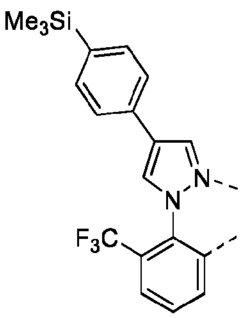
$L_{B791}$ ,
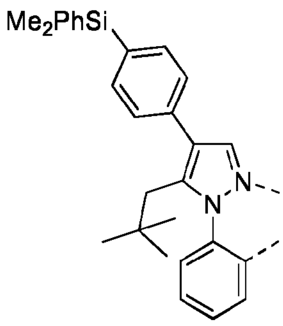
$L_{B792}$ ,
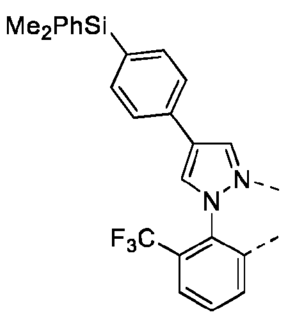
$L_{B793}$ ,
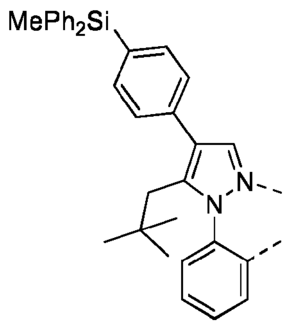
$L_{B794}$ ,

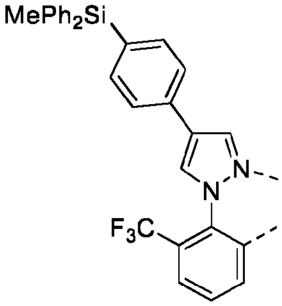
$L_{B795}$ ,
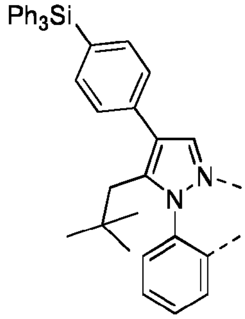
$L_{B796}$ ,
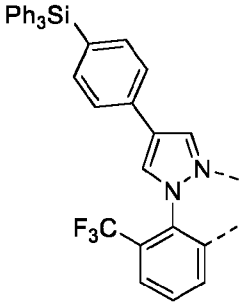
$L_{B797}$ ,
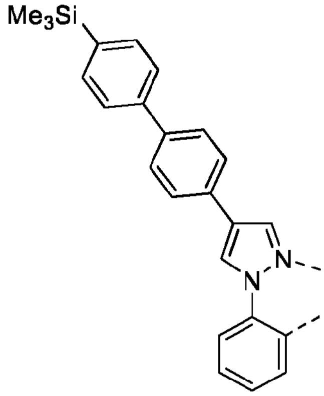
$L_{B798}$ ,

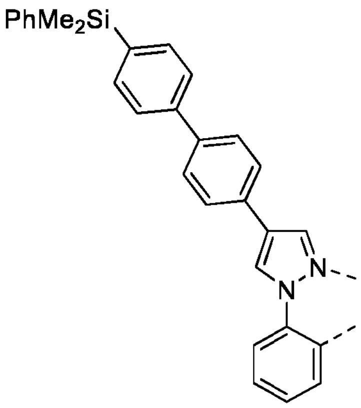
$L_{B799}$ ,

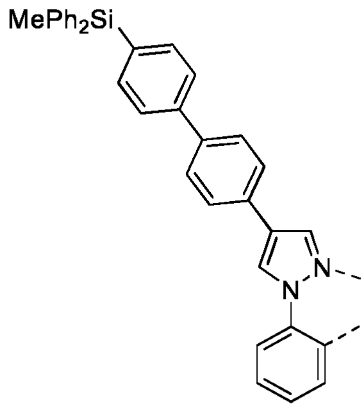
$L_{B800}$ ,

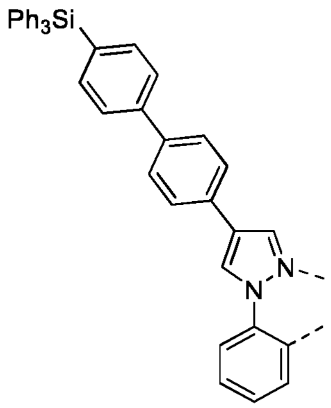
$L_{B801}$ ,

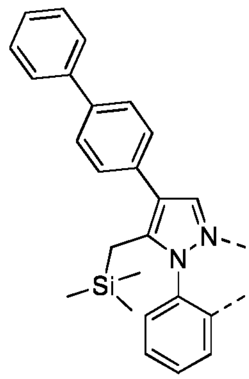
$L_{B802}$ ,

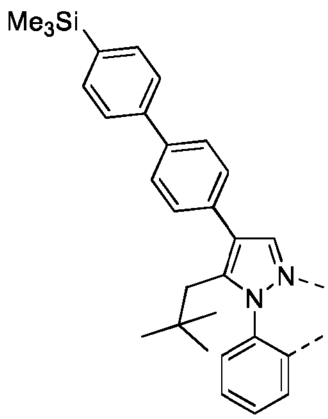
$L_{B803}$ ,

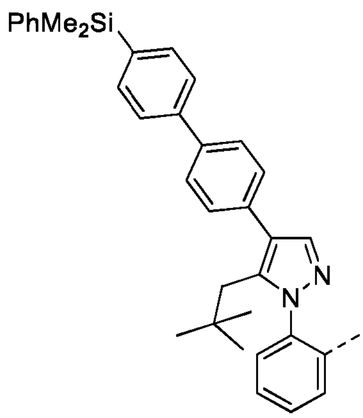
$L_{B804}$ ,

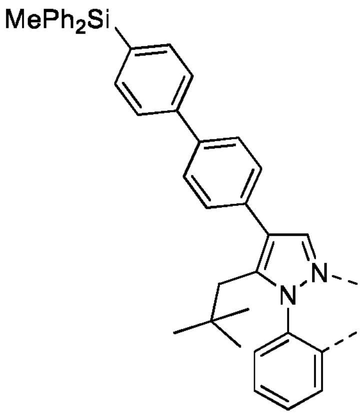
$L_{B805}$ ,

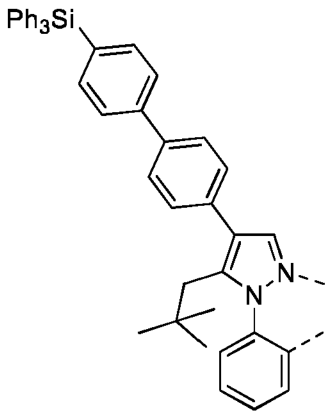
$L_{B806}$ ,

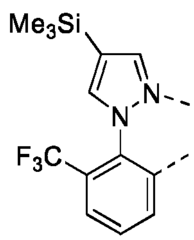
$L_{B807}$ ,

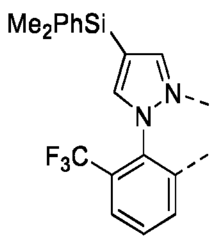
$L_{B808}$ ,

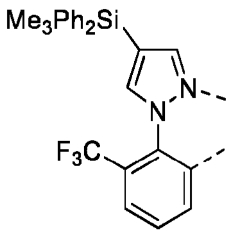 $L_{B809}$ , 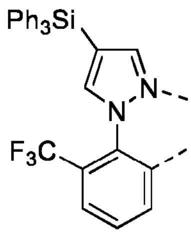 $L_{B810}$ , 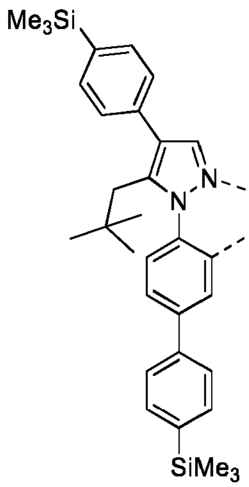 $L_{B811}$ , 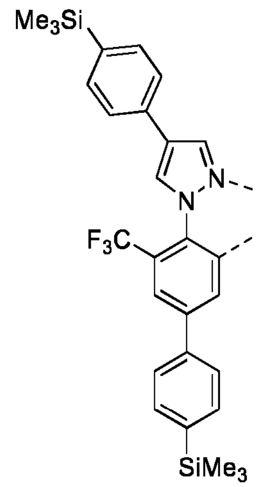 $L_{B812}$ ,

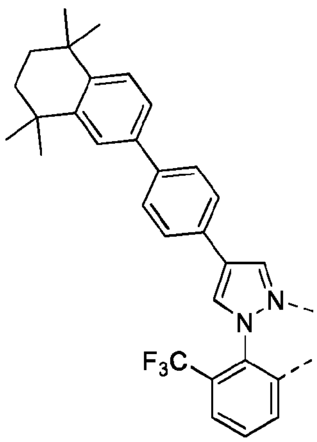 $L_{B813}$ , 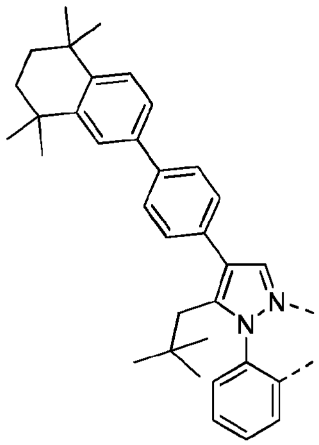 $L_{B814}$ , 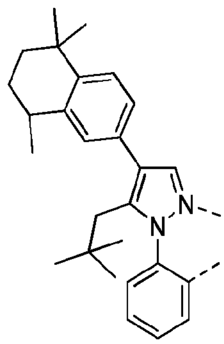 $L_{B815}$ , 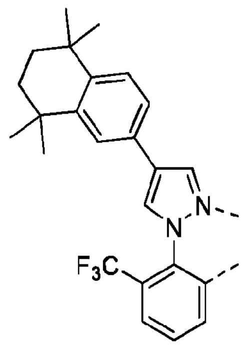 $L_{B816}$ ,

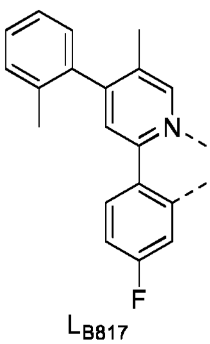 $L_{B817}$ , 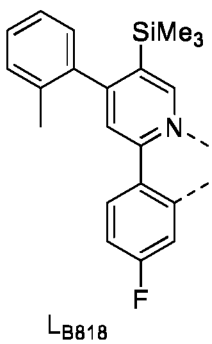 $L_{B818}$ , 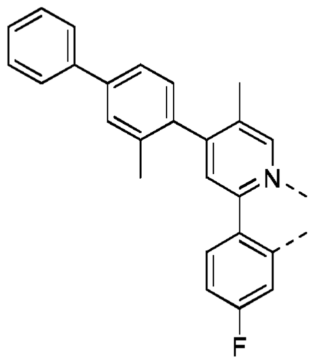 $L_{B8189}$ , 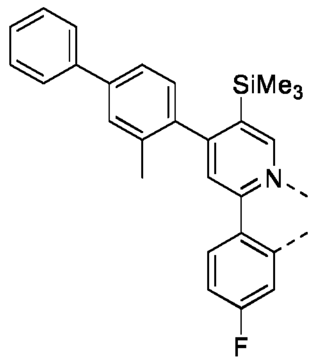 $L_{B820}$ ,

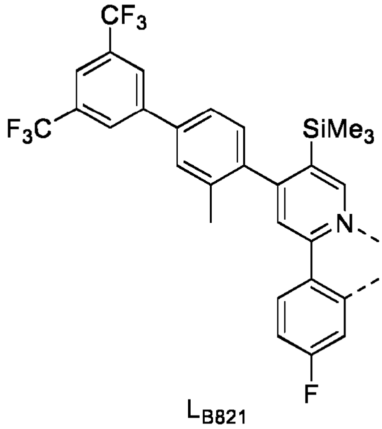
$L_{B821}$ ,

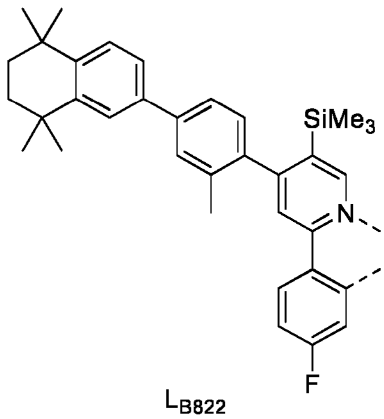
$L_{B822}$ ,

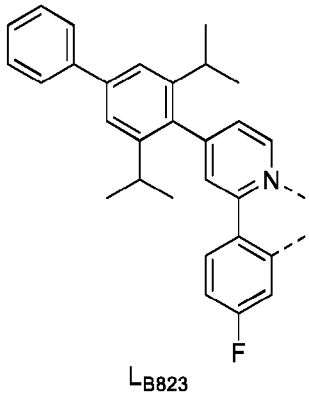
$L_{B823}$ ,

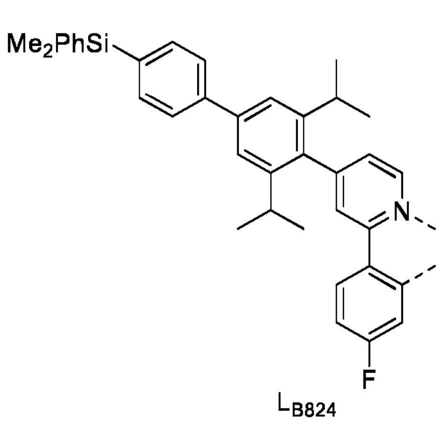
$L_{B824}$ ,

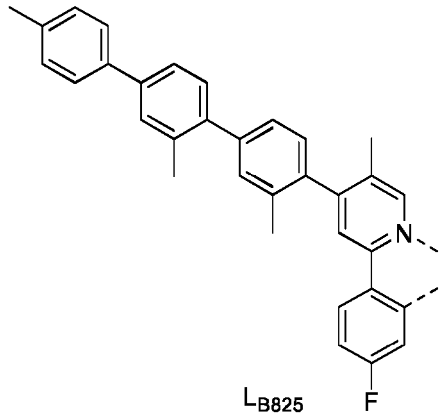
$L_{B825}$ ,

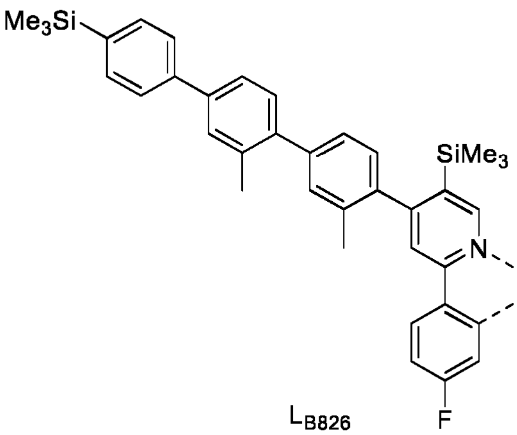
$L_{B826}$ ,

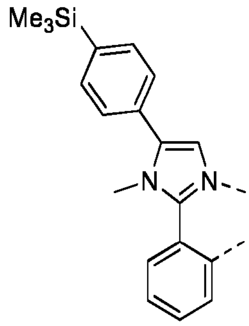
$L_{B827}$ ,

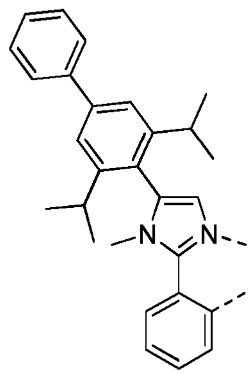
$L_{B828}$ ,

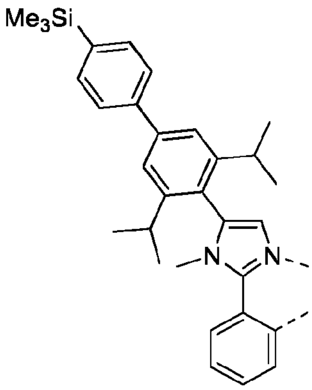 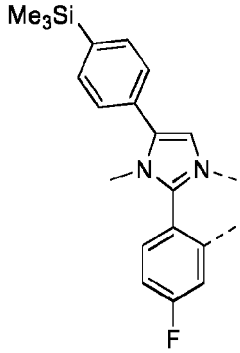 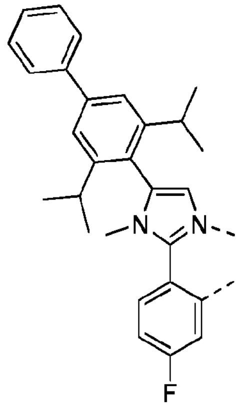 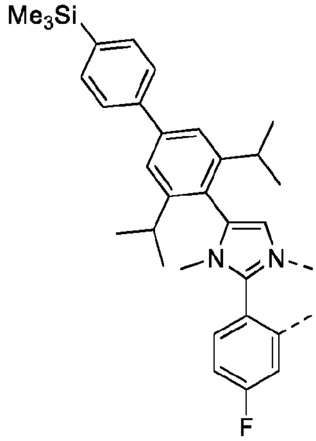

$L_{B829}$ , $L_{B830}$ , $L_{B831}$ , $L_{B832}$

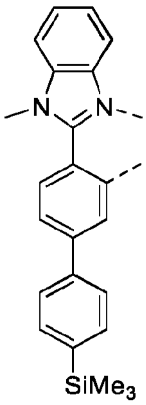 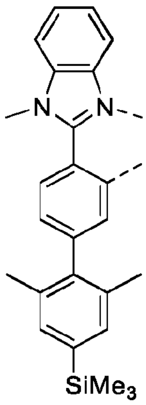 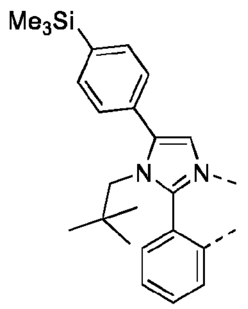 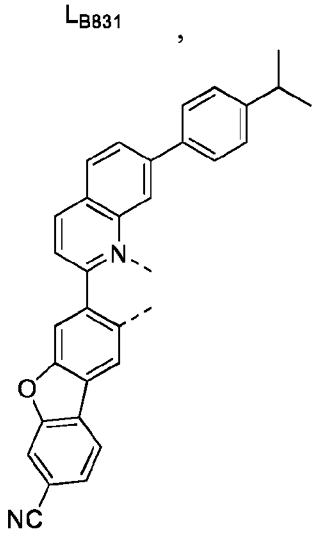

, $L_{B833}$ , $L_{B834}$ , $L_{B835}$ , and $L_{B836}$ ;

wherein j is an integer from 1 to 1416, and each $L_{Cj\text{-}I}$ has a structure based on formula

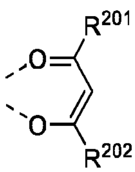
;

and
each $L_{Cj\text{-}II}$ has a structure based on formula

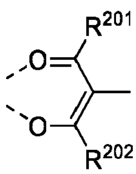
,

wherein for each $L_{Cj}$ in $L_{Cj\text{-}I}$ and $L_{Cj\text{-}II}$, $R^{201}$ and $R^{202}$ are each independently defined in the following LIST 8:

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C1}$ | $R^{D1}$ | $R^{D1}$ | $L_{C193}$ | $R^{D1}$ | $R^{D3}$ | $L_{C385}$ | $R^{D17}$ | $R^{D40}$ | $L_{C577}$ | $R^{D143}$ | $R^{D120}$ |
| $L_{C2}$ | $R^{D2}$ | $R^{D2}$ | $L_{C194}$ | $R^{D1}$ | $R^{D4}$ | $L_{C386}$ | $R^{D17}$ | $R^{D41}$ | $L_{C578}$ | $R^{D143}$ | $R^{D133}$ |
| $L_{C3}$ | $R^{D3}$ | $R^{D3}$ | $L_{C195}$ | $R^{D1}$ | $R^{D5}$ | $L_{C387}$ | $R^{D17}$ | $R^{D42}$ | $L_{C579}$ | $R^{D143}$ | $R^{D134}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C4}$ | $R^{D4}$ | $R^{D4}$ | $L_{C196}$ | $R^{D1}$ | $R^{D9}$ | $L_{C388}$ | $R^{D17}$ | $R^{D43}$ | $L_{C580}$ | $R^{D143}$ | $R^{D135}$ |
| $L_{C5}$ | $R^{D5}$ | $R^{D5}$ | $L_{C197}$ | $R^{D1}$ | $R^{D10}$ | $L_{C389}$ | $R^{D17}$ | $R^{D48}$ | $L_{C581}$ | $R^{D143}$ | $R^{D136}$ |
| $L_{C6}$ | $R^{D6}$ | $R^{D6}$ | $L_{C198}$ | $R^{D1}$ | $R^{D17}$ | $L_{C390}$ | $R^{D17}$ | $R^{D49}$ | $L_{C582}$ | $R^{D143}$ | $R^{D144}$ |
| $L_{C7}$ | $R^{D7}$ | $R^{D7}$ | $L_{C199}$ | $R^{D1}$ | $R^{D18}$ | $L_{C391}$ | $R^{D17}$ | $R^{D50}$ | $L_{C583}$ | $R^{D143}$ | $R^{D145}$ |
| $L_{C8}$ | $R^{D8}$ | $R^{D8}$ | $L_{C200}$ | $R^{D1}$ | $R^{D20}$ | $L_{C392}$ | $R^{D17}$ | $R^{D54}$ | $L_{C584}$ | $R^{D143}$ | $R^{D146}$ |
| $L_{C9}$ | $R^{D9}$ | $R^{D9}$ | $L_{C201}$ | $R^{D1}$ | $R^{D22}$ | $L_{C393}$ | $R^{D17}$ | $R^{D55}$ | $L_{C585}$ | $R^{D143}$ | $R^{D147}$ |
| $L_{C10}$ | $R^{D10}$ | $R^{D10}$ | $L_{C202}$ | $R^{D1}$ | $R^{D37}$ | $L_{C394}$ | $R^{D17}$ | $R^{D58}$ | $L_{C586}$ | $R^{D143}$ | $R^{D149}$ |
| $L_{C11}$ | $R^{D11}$ | $R^{D11}$ | $L_{C203}$ | $R^{D1}$ | $R^{D40}$ | $L_{C395}$ | $R^{D17}$ | $R^{D59}$ | $L_{C587}$ | $R^{D143}$ | $R^{D151}$ |
| $L_{C12}$ | $R^{D12}$ | $R^{D12}$ | $L_{C204}$ | $R^{D1}$ | $R^{D41}$ | $L_{C396}$ | $R^{D17}$ | $R^{D78}$ | $L_{C588}$ | $R^{D143}$ | $R^{D154}$ |
| $L_{C13}$ | $R^{D13}$ | $R^{D13}$ | $L_{C205}$ | $R^{D1}$ | $R^{D42}$ | $L_{C397}$ | $R^{D17}$ | $R^{D79}$ | $L_{C589}$ | $R^{D143}$ | $R^{D155}$ |
| $L_{C14}$ | $R^{D14}$ | $R^{D14}$ | $L_{C206}$ | $R^{D1}$ | $R^{D43}$ | $L_{C398}$ | $R^{D17}$ | $R^{D81}$ | $L_{C590}$ | $R^{D143}$ | $R^{D161}$ |
| $L_{C15}$ | $R^{D15}$ | $R^{D15}$ | $L_{C207}$ | $R^{D1}$ | $R^{D48}$ | $L_{C399}$ | $R^{D17}$ | $R^{D87}$ | $L_{C591}$ | $R^{D143}$ | $R^{D175}$ |
| $L_{C16}$ | $R^{D16}$ | $R^{D16}$ | $L_{C208}$ | $R^{D1}$ | $R^{D49}$ | $L_{C400}$ | $R^{D17}$ | $R^{D88}$ | $L_{C592}$ | $R^{D144}$ | $R^{D3}$ |
| $L_{C17}$ | $R^{D17}$ | $R^{D17}$ | $L_{C209}$ | $R^{D1}$ | $R^{D50}$ | $L_{C401}$ | $R^{D17}$ | $R^{D89}$ | $L_{C593}$ | $R^{D144}$ | $R^{D5}$ |
| $L_{C18}$ | $R^{D18}$ | $R^{D18}$ | $L_{C210}$ | $R^{D1}$ | $R^{D54}$ | $L_{C402}$ | $R^{D17}$ | $R^{D93}$ | $L_{C594}$ | $R^{D144}$ | $R^{D17}$ |
| $L_{C19}$ | $R^{D19}$ | $R^{D19}$ | $L_{C211}$ | $R^{D1}$ | $R^{D55}$ | $L_{C403}$ | $R^{D17}$ | $R^{D116}$ | $L_{C595}$ | $R^{D144}$ | $R^{D18}$ |
| $L_{C20}$ | $R^{D20}$ | $R^{D20}$ | $L_{C212}$ | $R^{D1}$ | $R^{D58}$ | $L_{C404}$ | $R^{D17}$ | $R^{D117}$ | $L_{C596}$ | $R^{D144}$ | $R^{D20}$ |
| $L_{C21}$ | $R^{D21}$ | $R^{D21}$ | $L_{C213}$ | $R^{D1}$ | $R^{D59}$ | $L_{C405}$ | $R^{D17}$ | $R^{D118}$ | $L_{C597}$ | $R^{D144}$ | $R^{D22}$ |
| $L_{C22}$ | $R^{D22}$ | $R^{D22}$ | $L_{C214}$ | $R^{D1}$ | $R^{D78}$ | $L_{C406}$ | $R^{D17}$ | $R^{D119}$ | $L_{C598}$ | $R^{D144}$ | $R^{D37}$ |
| $L_{C23}$ | $R^{D23}$ | $R^{D23}$ | $L_{C215}$ | $R^{D1}$ | $R^{D79}$ | $L_{C407}$ | $R^{D17}$ | $R^{D120}$ | $L_{C599}$ | $R^{D144}$ | $R^{D40}$ |
| $L_{C24}$ | $R^{D24}$ | $R^{D24}$ | $L_{C216}$ | $R^{D1}$ | $R^{D81}$ | $L_{C408}$ | $R^{D17}$ | $R^{D133}$ | $L_{C600}$ | $R^{D144}$ | $R^{D41}$ |
| $L_{C25}$ | $R^{D25}$ | $R^{D25}$ | $L_{C217}$ | $R^{D1}$ | $R^{D87}$ | $L_{C409}$ | $R^{D17}$ | $R^{D134}$ | $L_{C601}$ | $R^{D144}$ | $R^{D42}$ |
| $L_{C26}$ | $R^{D26}$ | $R^{D26}$ | $L_{C218}$ | $R^{D1}$ | $R^{D88}$ | $L_{C410}$ | $R^{D17}$ | $R^{D135}$ | $L_{C602}$ | $R^{D144}$ | $R^{D43}$ |
| $L_{C27}$ | $R^{D27}$ | $R^{D27}$ | $L_{C219}$ | $R^{D1}$ | $R^{D89}$ | $L_{C411}$ | $R^{D17}$ | $R^{D136}$ | $L_{C603}$ | $R^{D144}$ | $R^{D48}$ |
| $L_{C28}$ | $R^{D28}$ | $R^{D28}$ | $L_{C220}$ | $R^{D1}$ | $R^{D93}$ | $L_{C412}$ | $R^{D17}$ | $R^{D143}$ | $L_{C604}$ | $R^{D144}$ | $R^{D49}$ |
| $L_{C29}$ | $R^{D29}$ | $R^{D29}$ | $L_{C221}$ | $R^{D1}$ | $R^{D116}$ | $L_{C413}$ | $R^{D17}$ | $R^{D144}$ | $L_{C605}$ | $R^{D144}$ | $R^{D54}$ |
| $L_{C30}$ | $R^{D30}$ | $R^{D30}$ | $L_{C222}$ | $R^{D1}$ | $R^{D117}$ | $L_{C414}$ | $R^{D17}$ | $R^{D145}$ | $L_{C606}$ | $R^{D144}$ | $R^{D58}$ |
| $L_{C31}$ | $R^{D31}$ | $R^{D31}$ | $L_{C223}$ | $R^{D1}$ | $R^{D118}$ | $L_{C415}$ | $R^{D17}$ | $R^{D146}$ | $L_{C607}$ | $R^{D144}$ | $R^{D59}$ |
| $L_{C32}$ | $R^{D32}$ | $R^{D32}$ | $L_{C224}$ | $R^{D1}$ | $R^{D119}$ | $L_{C416}$ | $R^{D17}$ | $R^{D147}$ | $L_{C608}$ | $R^{D144}$ | $R^{D78}$ |
| $L_{C33}$ | $R^{D33}$ | $R^{D33}$ | $L_{C225}$ | $R^{D1}$ | $R^{D120}$ | $L_{C417}$ | $R^{D17}$ | $R^{D149}$ | $L_{C609}$ | $R^{D144}$ | $R^{D79}$ |
| $L_{C34}$ | $R^{D34}$ | $R^{D34}$ | $L_{C226}$ | $R^{D1}$ | $R^{D133}$ | $L_{C418}$ | $R^{D17}$ | $R^{D151}$ | $L_{C610}$ | $R^{D144}$ | $R^{D81}$ |
| $L_{C35}$ | $R^{D35}$ | $R^{D35}$ | $L_{C227}$ | $R^{D1}$ | $R^{D134}$ | $L_{C419}$ | $R^{D17}$ | $R^{D154}$ | $L_{C611}$ | $R^{D144}$ | $R^{D87}$ |
| $L_{C36}$ | $R^{D36}$ | $R^{D36}$ | $L_{C228}$ | $R^{D1}$ | $R^{D135}$ | $L_{C420}$ | $R^{D17}$ | $R^{D155}$ | $L_{C612}$ | $R^{D144}$ | $R^{D88}$ |
| $L_{C37}$ | $R^{D37}$ | $R^{D37}$ | $L_{C229}$ | $R^{D1}$ | $R^{D136}$ | $L_{C421}$ | $R^{D17}$ | $R^{D161}$ | $L_{C613}$ | $R^{D144}$ | $R^{D89}$ |
| $L_{C38}$ | $R^{D38}$ | $R^{D38}$ | $L_{C230}$ | $R^{D1}$ | $R^{D143}$ | $L_{C422}$ | $R^{D17}$ | $R^{D175}$ | $L_{C614}$ | $R^{D144}$ | $R^{D93}$ |
| $L_{C39}$ | $R^{D39}$ | $R^{D39}$ | $L_{C231}$ | $R^{D1}$ | $R^{D144}$ | $L_{C423}$ | $R^{D50}$ | $R^{D3}$ | $L_{C615}$ | $R^{D144}$ | $R^{D116}$ |
| $L_{C40}$ | $R^{D40}$ | $R^{D40}$ | $L_{C232}$ | $R^{D1}$ | $R^{D145}$ | $L_{C424}$ | $R^{D50}$ | $R^{D5}$ | $L_{C616}$ | $R^{D144}$ | $R^{D117}$ |
| $L_{C41}$ | $R^{D41}$ | $R^{D41}$ | $L_{C233}$ | $R^{D1}$ | $R^{D146}$ | $L_{C425}$ | $R^{D50}$ | $R^{D18}$ | $L_{C617}$ | $R^{D144}$ | $R^{D118}$ |
| $L_{C42}$ | $R^{D42}$ | $R^{D42}$ | $L_{C234}$ | $R^{D1}$ | $R^{D147}$ | $L_{C426}$ | $R^{D50}$ | $R^{D20}$ | $L_{C618}$ | $R^{D144}$ | $R^{D119}$ |
| $L_{C43}$ | $R^{D43}$ | $R^{D43}$ | $L_{C235}$ | $R^{D1}$ | $R^{D149}$ | $L_{C427}$ | $R^{D50}$ | $R^{D22}$ | $L_{C619}$ | $R^{D144}$ | $R^{D120}$ |
| $L_{C44}$ | $R^{D44}$ | $R^{D44}$ | $L_{C236}$ | $R^{D1}$ | $R^{D151}$ | $L_{C428}$ | $R^{D50}$ | $R^{D37}$ | $L_{C620}$ | $R^{D144}$ | $R^{D133}$ |
| $L_{C45}$ | $R^{D45}$ | $R^{D45}$ | $L_{C237}$ | $R^{D1}$ | $R^{D154}$ | $L_{C429}$ | $R^{D50}$ | $R^{D40}$ | $L_{C621}$ | $R^{D144}$ | $R^{D134}$ |
| $L_{C46}$ | $R^{D46}$ | $R^{D46}$ | $L_{C238}$ | $R^{D1}$ | $R^{D155}$ | $L_{C430}$ | $R^{D50}$ | $R^{D41}$ | $L_{C622}$ | $R^{D144}$ | $R^{D135}$ |
| $L_{C47}$ | $R^{D47}$ | $R^{D47}$ | $L_{C239}$ | $R^{D1}$ | $R^{D161}$ | $L_{C431}$ | $R^{D50}$ | $R^{D42}$ | $L_{C623}$ | $R^{D144}$ | $R^{D136}$ |
| $L_{C48}$ | $R^{D48}$ | $R^{D48}$ | $L_{C240}$ | $R^{D1}$ | $R^{D175}$ | $L_{C432}$ | $R^{D50}$ | $R^{D43}$ | $L_{C624}$ | $R^{D144}$ | $R^{D145}$ |
| $L_{C49}$ | $R^{D49}$ | $R^{D49}$ | $L_{C241}$ | $R^{D4}$ | $R^{D3}$ | $L_{C433}$ | $R^{D50}$ | $R^{D48}$ | $L_{C625}$ | $R^{D144}$ | $R^{D146}$ |
| $L_{C50}$ | $R^{D50}$ | $R^{D50}$ | $L_{C242}$ | $R^{D4}$ | $R^{D5}$ | $L_{C434}$ | $R^{D50}$ | $R^{D49}$ | $L_{C626}$ | $R^{D144}$ | $R^{D147}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C51}$ | $R^{D51}$ | $R^{D51}$ | $L_{C243}$ | $R^{D4}$ | $R^{D9}$ | $L_{C435}$ | $R^{D50}$ | $R^{D54}$ | $L_{C627}$ | $R^{D144}$ | $R^{D149}$ |
| $L_{C52}$ | $R^{D52}$ | $R^{D52}$ | $L_{C244}$ | $R^{D4}$ | $R^{D10}$ | $L_{C436}$ | $R^{D50}$ | $R^{D55}$ | $L_{C628}$ | $R^{D144}$ | $R^{D151}$ |
| $L_{C53}$ | $R^{D53}$ | $R^{D53}$ | $L_{C245}$ | $R^{D4}$ | $R^{D17}$ | $L_{C437}$ | $R^{D50}$ | $R^{D58}$ | $L_{C629}$ | $R^{D144}$ | $R^{D154}$ |
| $L_{C54}$ | $R^{D54}$ | $R^{D54}$ | $L_{C246}$ | $R^{D4}$ | $R^{D18}$ | $L_{C438}$ | $R^{D50}$ | $R^{D59}$ | $L_{C630}$ | $R^{D144}$ | $R^{D155}$ |
| $L_{C55}$ | $R^{D55}$ | $R^{D55}$ | $L_{C247}$ | $R^{D4}$ | $R^{D20}$ | $L_{C439}$ | $R^{D50}$ | $R^{D78}$ | $L_{C631}$ | $R^{D144}$ | $R^{D161}$ |
| $L_{C56}$ | $R^{D56}$ | $R^{D56}$ | $L_{C248}$ | $R^{D4}$ | $R^{D22}$ | $L_{C440}$ | $R^{D50}$ | $R^{D79}$ | $L_{C632}$ | $R^{D144}$ | $R^{D175}$ |
| $L_{C57}$ | $R^{D57}$ | $R^{D57}$ | $L_{C249}$ | $R^{D4}$ | $R^{D37}$ | $L_{C441}$ | $R^{D50}$ | $R^{D81}$ | $L_{C633}$ | $R^{D145}$ | $R^{D3}$ |
| $L_{C58}$ | $R^{D58}$ | $R^{D58}$ | $L_{C250}$ | $R^{D4}$ | $R^{D40}$ | $L_{C442}$ | $R^{D50}$ | $R^{D87}$ | $L_{C634}$ | $R^{D145}$ | $R^{D5}$ |
| $L_{C59}$ | $R^{D59}$ | $R^{D59}$ | $L_{C251}$ | $R^{D4}$ | $R^{D41}$ | $L_{C443}$ | $R^{D50}$ | $R^{D88}$ | $L_{C635}$ | $R^{D145}$ | $R^{D17}$ |
| $L_{C60}$ | $R^{D60}$ | $R^{D60}$ | $L_{C252}$ | $R^{D4}$ | $R^{D42}$ | $L_{C444}$ | $R^{D50}$ | $R^{D89}$ | $L_{C636}$ | $R^{D145}$ | $R^{D18}$ |
| $L_{C61}$ | $R^{D61}$ | $R^{D61}$ | $L_{C253}$ | $R^{D4}$ | $R^{D43}$ | $L_{C445}$ | $R^{D50}$ | $R^{D93}$ | $L_{C637}$ | $R^{D145}$ | $R^{D20}$ |
| $L_{C62}$ | $R^{D62}$ | $R^{D62}$ | $L_{C254}$ | $R^{D4}$ | $R^{D48}$ | $L_{C446}$ | $R^{D50}$ | $R^{D116}$ | $L_{C638}$ | $R^{D145}$ | $R^{D22}$ |
| $L_{C63}$ | $R^{D63}$ | $R^{D63}$ | $L_{C255}$ | $R^{D4}$ | $R^{D49}$ | $L_{C447}$ | $R^{D50}$ | $R^{D117}$ | $L_{C639}$ | $R^{D145}$ | $R^{D37}$ |
| $L_{C64}$ | $R^{D64}$ | $R^{D64}$ | $L_{C256}$ | $R^{D4}$ | $R^{D50}$ | $L_{C448}$ | $R^{D50}$ | $R^{D118}$ | $L_{C640}$ | $R^{D145}$ | $R^{D40}$ |
| $L_{C65}$ | $R^{D65}$ | $R^{D65}$ | $L_{C257}$ | $R^{D4}$ | $R^{D54}$ | $L_{C449}$ | $R^{D50}$ | $R^{D119}$ | $L_{C641}$ | $R^{D145}$ | $R^{D41}$ |
| $L_{C66}$ | $R^{D66}$ | $R^{D66}$ | $L_{C258}$ | $R^{D4}$ | $R^{D55}$ | $L_{C450}$ | $R^{D50}$ | $R^{D120}$ | $L_{C642}$ | $R^{D145}$ | $R^{D42}$ |
| $L_{C67}$ | $R^{D67}$ | $R^{D67}$ | $L_{C259}$ | $R^{D4}$ | $R^{D58}$ | $L_{C451}$ | $R^{D50}$ | $R^{D133}$ | $L_{C643}$ | $R^{D145}$ | $R^{D43}$ |
| $L_{C68}$ | $R^{D68}$ | $R^{D68}$ | $L_{C260}$ | $R^{D4}$ | $R^{D59}$ | $L_{C452}$ | $R^{D50}$ | $R^{D134}$ | $L_{C644}$ | $R^{D145}$ | $R^{D48}$ |
| $L_{C69}$ | $R^{D69}$ | $R^{D69}$ | $L_{C261}$ | $R^{D4}$ | $R^{D78}$ | $L_{C453}$ | $R^{D50}$ | $R^{D135}$ | $L_{C645}$ | $R^{D145}$ | $R^{D49}$ |
| $L_{C70}$ | $R^{D70}$ | $R^{D70}$ | $L_{C262}$ | $R^{D4}$ | $R^{D79}$ | $L_{C454}$ | $R^{D50}$ | $R^{D136}$ | $L_{C646}$ | $R^{D145}$ | $R^{D54}$ |
| $L_{C71}$ | $R^{D71}$ | $R^{D71}$ | $L_{C263}$ | $R^{D4}$ | $R^{D81}$ | $L_{C455}$ | $R^{D50}$ | $R^{D143}$ | $L_{C647}$ | $R^{D145}$ | $R^{D58}$ |
| $L_{C72}$ | $R^{D72}$ | $R^{D72}$ | $L_{C264}$ | $R^{D4}$ | $R^{D87}$ | $L_{C456}$ | $R^{D50}$ | $R^{D144}$ | $L_{C648}$ | $R^{D145}$ | $R^{D59}$ |
| $L_{C73}$ | $R^{D73}$ | $R^{D73}$ | $L_{C265}$ | $R^{D4}$ | $R^{D88}$ | $L_{C457}$ | $R^{D50}$ | $R^{D145}$ | $L_{C649}$ | $R^{D145}$ | $R^{D78}$ |
| $L_{C74}$ | $R^{D74}$ | $R^{D74}$ | $L_{C266}$ | $R^{D4}$ | $R^{D89}$ | $L_{C458}$ | $R^{D50}$ | $R^{D146}$ | $L_{C650}$ | $R^{D145}$ | $R^{D79}$ |
| $L_{C75}$ | $R^{D75}$ | $R^{D75}$ | $L_{C267}$ | $R^{D4}$ | $R^{D93}$ | $L_{C459}$ | $R^{D50}$ | $R^{D147}$ | $L_{C651}$ | $R^{D145}$ | $R^{D81}$ |
| $L_{C76}$ | $R^{D76}$ | $R^{D76}$ | $L_{C268}$ | $R^{D4}$ | $R^{D116}$ | $L_{C460}$ | $R^{D50}$ | $R^{D149}$ | $L_{C652}$ | $R^{D145}$ | $R^{D87}$ |
| $L_{C77}$ | $R^{D77}$ | $R^{D77}$ | $L_{C269}$ | $R^{D4}$ | $R^{D117}$ | $L_{C461}$ | $R^{D50}$ | $R^{D151}$ | $L_{C653}$ | $R^{D145}$ | $R^{D88}$ |
| $L_{C78}$ | $R^{D78}$ | $R^{D78}$ | $L_{C270}$ | $R^{D4}$ | $R^{D118}$ | $L_{C462}$ | $R^{D50}$ | $R^{D154}$ | $L_{C654}$ | $R^{D145}$ | $R^{D89}$ |
| $L_{C79}$ | $R^{D79}$ | $R^{D79}$ | $L_{C271}$ | $R^{D4}$ | $R^{D119}$ | $L_{C463}$ | $R^{D50}$ | $R^{D155}$ | $L_{C655}$ | $R^{D145}$ | $R^{D93}$ |
| $L_{C80}$ | $R^{D80}$ | $R^{D80}$ | $L_{C272}$ | $R^{D4}$ | $R^{D120}$ | $L_{C464}$ | $R^{D50}$ | $R^{D161}$ | $L_{C656}$ | $R^{D145}$ | $R^{D116}$ |
| $L_{C81}$ | $R^{D81}$ | $R^{D81}$ | $L_{C273}$ | $R^{D4}$ | $R^{D133}$ | $L_{C465}$ | $R^{D50}$ | $R^{D175}$ | $L_{C657}$ | $R^{D145}$ | $R^{D117}$ |
| $L_{C82}$ | $R^{D82}$ | $R^{D82}$ | $L_{C274}$ | $R^{D4}$ | $R^{D134}$ | $L_{C466}$ | $R^{D55}$ | $R^{D3}$ | $L_{C658}$ | $R^{D145}$ | $R^{D118}$ |
| $L_{C83}$ | $R^{D83}$ | $R^{D83}$ | $L_{C275}$ | $R^{D4}$ | $R^{D135}$ | $L_{C467}$ | $R^{D55}$ | $R^{D5}$ | $L_{C659}$ | $R^{D145}$ | $R^{D119}$ |
| $L_{C84}$ | $R^{D84}$ | $R^{D84}$ | $L_{C276}$ | $R^{D4}$ | $R^{D136}$ | $L_{C468}$ | $R^{D55}$ | $R^{D18}$ | $L_{C660}$ | $R^{D145}$ | $R^{D120}$ |
| $L_{C85}$ | $R^{D85}$ | $R^{D85}$ | $L_{C277}$ | $R^{D4}$ | $R^{D143}$ | $L_{C469}$ | $R^{D55}$ | $R^{D20}$ | $L_{C661}$ | $R^{D145}$ | $R^{D133}$ |
| $L_{C86}$ | $R^{D86}$ | $R^{D86}$ | $L_{C278}$ | $R^{D4}$ | $R^{D144}$ | $L_{C470}$ | $R^{D55}$ | $R^{D22}$ | $L_{C662}$ | $R^{D145}$ | $R^{D134}$ |
| $L_{C87}$ | $R^{D87}$ | $R^{D87}$ | $L_{C279}$ | $R^{D4}$ | $R^{D145}$ | $L_{C471}$ | $R^{D55}$ | $R^{D37}$ | $L_{C663}$ | $R^{D145}$ | $R^{D135}$ |
| $L_{C88}$ | $R^{D88}$ | $R^{D88}$ | $L_{C280}$ | $R^{D4}$ | $R^{D146}$ | $L_{C472}$ | $R^{D55}$ | $R^{D40}$ | $L_{C664}$ | $R^{D145}$ | $R^{D136}$ |
| $L_{C89}$ | $R^{D89}$ | $R^{D89}$ | $L_{C281}$ | $R^{D4}$ | $R^{D147}$ | $L_{C473}$ | $R^{D55}$ | $R^{D41}$ | $L_{C665}$ | $R^{D145}$ | $R^{D146}$ |
| $L_{C90}$ | $R^{D90}$ | $R^{D90}$ | $L_{C282}$ | $R^{D4}$ | $R^{D149}$ | $L_{C474}$ | $R^{D55}$ | $R^{D42}$ | $L_{C666}$ | $R^{D145}$ | $R^{D147}$ |
| $L_{C91}$ | $R^{D91}$ | $R^{D91}$ | $L_{C283}$ | $R^{D4}$ | $R^{D151}$ | $L_{C475}$ | $R^{D55}$ | $R^{D43}$ | $L_{C667}$ | $R^{D145}$ | $R^{D149}$ |
| $L_{C92}$ | $R^{D92}$ | $R^{D92}$ | $L_{C284}$ | $R^{D4}$ | $R^{D154}$ | $L_{C476}$ | $R^{D55}$ | $R^{D48}$ | $L_{C668}$ | $R^{D145}$ | $R^{D151}$ |
| $L_{C93}$ | $R^{D93}$ | $R^{D93}$ | $L_{C285}$ | $R^{D4}$ | $R^{D155}$ | $L_{C477}$ | $R^{D55}$ | $R^{D49}$ | $L_{C669}$ | $R^{D145}$ | $R^{D154}$ |
| $L_{C94}$ | $R^{D94}$ | $R^{D94}$ | $L_{C286}$ | $R^{D4}$ | $R^{D161}$ | $L_{C478}$ | $R^{D55}$ | $R^{D54}$ | $L_{C670}$ | $R^{D145}$ | $R^{D155}$ |
| $L_{C95}$ | $R^{D95}$ | $R^{D95}$ | $L_{C287}$ | $R^{D4}$ | $R^{D175}$ | $L_{C479}$ | $R^{D55}$ | $R^{D58}$ | $L_{C671}$ | $R^{D145}$ | $R^{D161}$ |
| $L_{C96}$ | $R^{D96}$ | $R^{D96}$ | $L_{C288}$ | $R^{D9}$ | $R^{D3}$ | $L_{C480}$ | $R^{D55}$ | $R^{D59}$ | $L_{C672}$ | $R^{D145}$ | $R^{D175}$ |
| $L_{C97}$ | $R^{D97}$ | $R^{D97}$ | $L_{C289}$ | $R^{D9}$ | $R^{D5}$ | $L_{C481}$ | $R^{D55}$ | $R^{D78}$ | $L_{C673}$ | $R^{D146}$ | $R^{D3}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C98}$ | $R^{D98}$ | $R^{D98}$ | $L_{C290}$ | $R^{D9}$ | $R^{D10}$ | $L_{C482}$ | $R^{D55}$ | $R^{D79}$ | $L_{C674}$ | $R^{D146}$ | $R^{D5}$ |
| $L_{C99}$ | $R^{D99}$ | $R^{D99}$ | $L_{C291}$ | $R^{D9}$ | $R^{D17}$ | $L_{C483}$ | $R^{D55}$ | $R^{D81}$ | $L_{C675}$ | $R^{D146}$ | $R^{D17}$ |
| $L_{C100}$ | $R^{D100}$ | $R^{D100}$ | $L_{C292}$ | $R^{D9}$ | $R^{D18}$ | $L_{C484}$ | $R^{D55}$ | $R^{D87}$ | $L_{C676}$ | $R^{D146}$ | $R^{D18}$ |
| $L_{C101}$ | $R^{D101}$ | $R^{D101}$ | $L_{C293}$ | $R^{D9}$ | $R^{D20}$ | $L_{C485}$ | $R^{D55}$ | $R^{D88}$ | $L_{C677}$ | $R^{D146}$ | $R^{D20}$ |
| $L_{C102}$ | $R^{D102}$ | $R^{D102}$ | $L_{C294}$ | $R^{D9}$ | $R^{D22}$ | $L_{C486}$ | $R^{D55}$ | $R^{D89}$ | $L_{C678}$ | $R^{D146}$ | $R^{D22}$ |
| $L_{C103}$ | $R^{D103}$ | $R^{D103}$ | $L_{C295}$ | $R^{D9}$ | $R^{D37}$ | $L_{C487}$ | $R^{D55}$ | $R^{D93}$ | $L_{C679}$ | $R^{D146}$ | $R^{D37}$ |
| $L_{C104}$ | $R^{D104}$ | $R^{D104}$ | $L_{C296}$ | $R^{D9}$ | $R^{D40}$ | $L_{C488}$ | $R^{D55}$ | $R^{D116}$ | $L_{C680}$ | $R^{D146}$ | $R^{D40}$ |
| $L_{C105}$ | $R^{D105}$ | $R^{D105}$ | $L_{C297}$ | $R^{D9}$ | $R^{D41}$ | $L_{C489}$ | $R^{D55}$ | $R^{D117}$ | $L_{C681}$ | $R^{D146}$ | $R^{D41}$ |
| $L_{C106}$ | $R^{D106}$ | $R^{D106}$ | $L_{C298}$ | $R^{D9}$ | $R^{D42}$ | $L_{C490}$ | $R^{D55}$ | $R^{D118}$ | $L_{C682}$ | $R^{D146}$ | $R^{D42}$ |
| $L_{C107}$ | $R^{D107}$ | $R^{D107}$ | $L_{C299}$ | $R^{D9}$ | $R^{D43}$ | $L_{C491}$ | $R^{D55}$ | $R^{D119}$ | $L_{C683}$ | $R^{D146}$ | $R^{D43}$ |
| $L_{C108}$ | $R^{D108}$ | $R^{D108}$ | $L_{C300}$ | $R^{D9}$ | $R^{D48}$ | $L_{C492}$ | $R^{D55}$ | $R^{D120}$ | $L_{C684}$ | $R^{D146}$ | $R^{D48}$ |
| $L_{C109}$ | $R^{D109}$ | $R^{D109}$ | $L_{C301}$ | $R^{D9}$ | $R^{D49}$ | $L_{C493}$ | $R^{D55}$ | $R^{D133}$ | $L_{C685}$ | $R^{D146}$ | $R^{D49}$ |
| $L_{C110}$ | $R^{D110}$ | $R^{D110}$ | $L_{C302}$ | $R^{D9}$ | $R^{D50}$ | $L_{C494}$ | $R^{D55}$ | $R^{D134}$ | $L_{C686}$ | $R^{D146}$ | $R^{D54}$ |
| $L_{C111}$ | $R^{D111}$ | $R^{D111}$ | $L_{C303}$ | $R^{D9}$ | $R^{D54}$ | $L_{C495}$ | $R^{D55}$ | $R^{D135}$ | $L_{C687}$ | $R^{D146}$ | $R^{D58}$ |
| $L_{C112}$ | $R^{D112}$ | $R^{D112}$ | $L_{C304}$ | $R^{D9}$ | $R^{D55}$ | $L_{C496}$ | $R^{D55}$ | $R^{D136}$ | $L_{C688}$ | $R^{D146}$ | $R^{D59}$ |
| $L_{C113}$ | $R^{D113}$ | $R^{D113}$ | $L_{C305}$ | $R^{D9}$ | $R^{D58}$ | $L_{C497}$ | $R^{D55}$ | $R^{D143}$ | $L_{C689}$ | $R^{D146}$ | $R^{D78}$ |
| $L_{C114}$ | $R^{D114}$ | $R^{D114}$ | $L_{C306}$ | $R^{D9}$ | $R^{D59}$ | $L_{C498}$ | $R^{D55}$ | $R^{D144}$ | $L_{C690}$ | $R^{D146}$ | $R^{D79}$ |
| $L_{C115}$ | $R^{D115}$ | $R^{D115}$ | $L_{C307}$ | $R^{D9}$ | $R^{D78}$ | $L_{C499}$ | $R^{D55}$ | $R^{D145}$ | $L_{C691}$ | $R^{D146}$ | $R^{D81}$ |
| $L_{C116}$ | $R^{D116}$ | $R^{D116}$ | $L_{C308}$ | $R^{D9}$ | $R^{D79}$ | $L_{C500}$ | $R^{D55}$ | $R^{D146}$ | $L_{C692}$ | $R^{D146}$ | $R^{D87}$ |
| $L_{C117}$ | $R^{D117}$ | $R^{D117}$ | $L_{C309}$ | $R^{D9}$ | $R^{D81}$ | $L_{C501}$ | $R^{D55}$ | $R^{D147}$ | $L_{C693}$ | $R^{D146}$ | $R^{D88}$ |
| $L_{C118}$ | $R^{D118}$ | $R^{D118}$ | $L_{C310}$ | $R^{D9}$ | $R^{D87}$ | $L_{C502}$ | $R^{D55}$ | $R^{D149}$ | $L_{C694}$ | $R^{D146}$ | $R^{D89}$ |
| $L_{C119}$ | $R^{D119}$ | $R^{D119}$ | $L_{C311}$ | $R^{D9}$ | $R^{D88}$ | $L_{C503}$ | $R^{D55}$ | $R^{D151}$ | $L_{C695}$ | $R^{D146}$ | $R^{D93}$ |
| $L_{C120}$ | $R^{D120}$ | $R^{D120}$ | $L_{C312}$ | $R^{D9}$ | $R^{D89}$ | $L_{C504}$ | $R^{D55}$ | $R^{D154}$ | $L_{C696}$ | $R^{D146}$ | $R^{D117}$ |
| $L_{C121}$ | $R^{D121}$ | $R^{D121}$ | $L_{C313}$ | $R^{D9}$ | $R^{D93}$ | $L_{C505}$ | $R^{D55}$ | $R^{D155}$ | $L_{C697}$ | $R^{D146}$ | $R^{D118}$ |
| $L_{C122}$ | $R^{D122}$ | $R^{D122}$ | $L_{C314}$ | $R^{D9}$ | $R^{D116}$ | $L_{C506}$ | $R^{D55}$ | $R^{D161}$ | $L_{C698}$ | $R^{D146}$ | $R^{D119}$ |
| $L_{C123}$ | $R^{D123}$ | $R^{D123}$ | $L_{C315}$ | $R^{D9}$ | $R^{D117}$ | $L_{C507}$ | $R^{D55}$ | $R^{D175}$ | $L_{C699}$ | $R^{D146}$ | $R^{D120}$ |
| $L_{C124}$ | $R^{D124}$ | $R^{D124}$ | $L_{C316}$ | $R^{D9}$ | $R^{D118}$ | $L_{C508}$ | $R^{D116}$ | $R^{D3}$ | $L_{C700}$ | $R^{D146}$ | $R^{D133}$ |
| $L_{C125}$ | $R^{D125}$ | $R^{D125}$ | $L_{C317}$ | $R^{D9}$ | $R^{D119}$ | $L_{C509}$ | $R^{D116}$ | $R^{D5}$ | $L_{C701}$ | $R^{D146}$ | $R^{D134}$ |
| $L_{C126}$ | $R^{D126}$ | $R^{D126}$ | $L_{C318}$ | $R^{D9}$ | $R^{D120}$ | $L_{C510}$ | $R^{D116}$ | $R^{D17}$ | $L_{C702}$ | $R^{D146}$ | $R^{D135}$ |
| $L_{C127}$ | $R^{D127}$ | $R^{D127}$ | $L_{C319}$ | $R^{D9}$ | $R^{D133}$ | $L_{C511}$ | $R^{D116}$ | $R^{D18}$ | $L_{C703}$ | $R^{D146}$ | $R^{D136}$ |
| $L_{C128}$ | $R^{D128}$ | $R^{D128}$ | $L_{C320}$ | $R^{D9}$ | $R^{D134}$ | $L_{C512}$ | $R^{D116}$ | $R^{D20}$ | $L_{C704}$ | $R^{D146}$ | $R^{D146}$ |
| $L_{C129}$ | $R^{D129}$ | $R^{D129}$ | $L_{C321}$ | $R^{D9}$ | $R^{D135}$ | $L_{C513}$ | $R^{D116}$ | $R^{D22}$ | $L_{C705}$ | $R^{D146}$ | $R^{D147}$ |
| $L_{C130}$ | $R^{D130}$ | $R^{D130}$ | $L_{C322}$ | $R^{D9}$ | $R^{D136}$ | $L_{C514}$ | $R^{D116}$ | $R^{D37}$ | $L_{C706}$ | $R^{D146}$ | $R^{D149}$ |
| $L_{C131}$ | $R^{D131}$ | $R^{D131}$ | $L_{C323}$ | $R^{D9}$ | $R^{D143}$ | $L_{C515}$ | $R^{D116}$ | $R^{D40}$ | $L_{C707}$ | $R^{D146}$ | $R^{D151}$ |
| $L_{C132}$ | $R^{D132}$ | $R^{D132}$ | $L_{C324}$ | $R^{D9}$ | $R^{D144}$ | $L_{C516}$ | $R^{D116}$ | $R^{D41}$ | $L_{C708}$ | $R^{D146}$ | $R^{D154}$ |
| $L_{C133}$ | $R^{D133}$ | $R^{D133}$ | $L_{C325}$ | $R^{D9}$ | $R^{D145}$ | $L_{C517}$ | $R^{D116}$ | $R^{D42}$ | $L_{C709}$ | $R^{D146}$ | $R^{D155}$ |
| $L_{C134}$ | $R^{D134}$ | $R^{D134}$ | $L_{C326}$ | $R^{D9}$ | $R^{D146}$ | $L_{C518}$ | $R^{D116}$ | $R^{D43}$ | $L_{C710}$ | $R^{D146}$ | $R^{D161}$ |
| $L_{C135}$ | $R^{D135}$ | $R^{D135}$ | $L_{C327}$ | $R^{D9}$ | $R^{D147}$ | $L_{C519}$ | $R^{D116}$ | $R^{D48}$ | $L_{C711}$ | $R^{D146}$ | $R^{D175}$ |
| $L_{C136}$ | $R^{D136}$ | $R^{D136}$ | $L_{C328}$ | $R^{D9}$ | $R^{D149}$ | $L_{C520}$ | $R^{D116}$ | $R^{D49}$ | $L_{C712}$ | $R^{D133}$ | $R^{D3}$ |
| $L_{C137}$ | $R^{D137}$ | $R^{D137}$ | $L_{C329}$ | $R^{D9}$ | $R^{D151}$ | $L_{C521}$ | $R^{D116}$ | $R^{D54}$ | $L_{C713}$ | $R^{D133}$ | $R^{D5}$ |
| $L_{C138}$ | $R^{D138}$ | $R^{D138}$ | $L_{C330}$ | $R^{D9}$ | $R^{D154}$ | $L_{C522}$ | $R^{D116}$ | $R^{D58}$ | $L_{C714}$ | $R^{D133}$ | $R^{D3}$ |
| $L_{C139}$ | $R^{D139}$ | $R^{D139}$ | $L_{C331}$ | $R^{D9}$ | $R^{D155}$ | $L_{C523}$ | $R^{D116}$ | $R^{D59}$ | $L_{C715}$ | $R^{D133}$ | $R^{D18}$ |
| $L_{C140}$ | $R^{D140}$ | $R^{D140}$ | $L_{C332}$ | $R^{D9}$ | $R^{D161}$ | $L_{C524}$ | $R^{D116}$ | $R^{D78}$ | $L_{C716}$ | $R^{D133}$ | $R^{D20}$ |
| $L_{C141}$ | $R^{D141}$ | $R^{D141}$ | $L_{C333}$ | $R^{D9}$ | $R^{D175}$ | $L_{C525}$ | $R^{D116}$ | $R^{D79}$ | $L_{C717}$ | $R^{D133}$ | $R^{D22}$ |
| $L_{C142}$ | $R^{D142}$ | $R^{D142}$ | $L_{C334}$ | $R^{D10}$ | $R^{D3}$ | $L_{C526}$ | $R^{D116}$ | $R^{D81}$ | $L_{C718}$ | $R^{D133}$ | $R^{D37}$ |
| $L_{C143}$ | $R^{D143}$ | $R^{D143}$ | $L_{C335}$ | $R^{D10}$ | $R^{D5}$ | $L_{C527}$ | $R^{D116}$ | $R^{D87}$ | $L_{C719}$ | $R^{D133}$ | $R^{D40}$ |
| $L_{C144}$ | $R^{D144}$ | $R^{D144}$ | $L_{C336}$ | $R^{D10}$ | $R^{D17}$ | $L_{C528}$ | $R^{D116}$ | $R^{D88}$ | $L_{C720}$ | $R^{D133}$ | $R^{D41}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C145}$ | $R^{D145}$ | $R^{D145}$ | $L_{C337}$ | $R^{D10}$ | $R^{D18}$ | $L_{C529}$ | $R^{D116}$ | $R^{D89}$ | $L_{C721}$ | $R^{D133}$ | $R^{D42}$ |
| $L_{C146}$ | $R^{D146}$ | $R^{D146}$ | $L_{C338}$ | $R^{D10}$ | $R^{D20}$ | $L_{C530}$ | $R^{D116}$ | $R^{D93}$ | $L_{C722}$ | $R^{D133}$ | $R^{D43}$ |
| $L_{C147}$ | $R^{D147}$ | $R^{D147}$ | $L_{C339}$ | $R^{D10}$ | $R^{D22}$ | $L_{C531}$ | $R^{D116}$ | $R^{D117}$ | $L_{C723}$ | $R^{D133}$ | $R^{D48}$ |
| $L_{C148}$ | $R^{D148}$ | $R^{D148}$ | $L_{C340}$ | $R^{D10}$ | $R^{D37}$ | $L_{C532}$ | $R^{D116}$ | $R^{D118}$ | $L_{C724}$ | $R^{D133}$ | $R^{D49}$ |
| $L_{C149}$ | $R^{D149}$ | $R^{D149}$ | $L_{C341}$ | $R^{D10}$ | $R^{D40}$ | $L_{C533}$ | $R^{D116}$ | $R^{D119}$ | $L_{C725}$ | $R^{D133}$ | $R^{D54}$ |
| $L_{C150}$ | $R^{D150}$ | $R^{D150}$ | $L_{C342}$ | $R^{D10}$ | $R^{D41}$ | $L_{C534}$ | $R^{D116}$ | $R^{D120}$ | $L_{C726}$ | $R^{D133}$ | $R^{D58}$ |
| $L_{C151}$ | $R^{D151}$ | $R^{D151}$ | $L_{C343}$ | $R^{D10}$ | $R^{D42}$ | $L_{C535}$ | $R^{D116}$ | $R^{D133}$ | $L_{C727}$ | $R^{D133}$ | $R^{D59}$ |
| $L_{C152}$ | $R^{D152}$ | $R^{D152}$ | $L_{C344}$ | $R^{D10}$ | $R^{D43}$ | $L_{C536}$ | $R^{D116}$ | $R^{D134}$ | $L_{C728}$ | $R^{D133}$ | $R^{D78}$ |
| $L_{C153}$ | $R^{D153}$ | $R^{D153}$ | $L_{C345}$ | $R^{D10}$ | $R^{D48}$ | $L_{C537}$ | $R^{D116}$ | $R^{D135}$ | $L_{C729}$ | $R^{D133}$ | $R^{D79}$ |
| $L_{C154}$ | $R^{D154}$ | $R^{D154}$ | $L_{C346}$ | $R^{D10}$ | $R^{D49}$ | $L_{C538}$ | $R^{D116}$ | $R^{D136}$ | $L_{C730}$ | $R^{D133}$ | $R^{D81}$ |
| $L_{C155}$ | $R^{D155}$ | $R^{D155}$ | $L_{C347}$ | $R^{D10}$ | $R^{D50}$ | $L_{C539}$ | $R^{D116}$ | $R^{D143}$ | $L_{C731}$ | $R^{D133}$ | $R^{D87}$ |
| $L_{C156}$ | $R^{D156}$ | $R^{D156}$ | $L_{C348}$ | $R^{D10}$ | $R^{D54}$ | $L_{C540}$ | $R^{D116}$ | $R^{D144}$ | $L_{C732}$ | $R^{D133}$ | $R^{D88}$ |
| $L_{C157}$ | $R^{D157}$ | $R^{D157}$ | $L_{C349}$ | $R^{D10}$ | $R^{D55}$ | $L_{C541}$ | $R^{D116}$ | $R^{D145}$ | $L_{C733}$ | $R^{D133}$ | $R^{D89}$ |
| $L_{C158}$ | $R^{D158}$ | $R^{D158}$ | $L_{C350}$ | $R^{D10}$ | $R^{D58}$ | $L_{C542}$ | $R^{D116}$ | $R^{D146}$ | $L_{C734}$ | $R^{D133}$ | $R^{D93}$ |
| $L_{C159}$ | $R^{D159}$ | $R^{D159}$ | $L_{C351}$ | $R^{D10}$ | $R^{D59}$ | $L_{C543}$ | $R^{D116}$ | $R^{D147}$ | $L_{C735}$ | $R^{D133}$ | $R^{D117}$ |
| $L_{C160}$ | $R^{D160}$ | $R^{D160}$ | $L_{C352}$ | $R^{D10}$ | $R^{D78}$ | $L_{C544}$ | $R^{D116}$ | $R^{D149}$ | $L_{C736}$ | $R^{D133}$ | $R^{D118}$ |
| $L_{C161}$ | $R^{D161}$ | $R^{D161}$ | $L_{C353}$ | $R^{D10}$ | $R^{D79}$ | $L_{C545}$ | $R^{D116}$ | $R^{D151}$ | $L_{C737}$ | $R^{D133}$ | $R^{D119}$ |
| $L_{C162}$ | $R^{D162}$ | $R^{D162}$ | $L_{C354}$ | $R^{D10}$ | $R^{D81}$ | $L_{C546}$ | $R^{D116}$ | $R^{D154}$ | $L_{C738}$ | $R^{D133}$ | $R^{D120}$ |
| $L_{C163}$ | $R^{D163}$ | $R^{D163}$ | $L_{C355}$ | $R^{D10}$ | $R^{D87}$ | $L_{C547}$ | $R^{D116}$ | $R^{D155}$ | $L_{C739}$ | $R^{D133}$ | $R^{D133}$ |
| $L_{C164}$ | $R^{D164}$ | $R^{D164}$ | $L_{C356}$ | $R^{D10}$ | $R^{D88}$ | $L_{C548}$ | $R^{D116}$ | $R^{D161}$ | $L_{C740}$ | $R^{D133}$ | $R^{D134}$ |
| $L_{C165}$ | $R^{D165}$ | $R^{D165}$ | $L_{C357}$ | $R^{D10}$ | $R^{D89}$ | $L_{C549}$ | $R^{D116}$ | $R^{D175}$ | $L_{C741}$ | $R^{D133}$ | $R^{D135}$ |
| $L_{C166}$ | $R^{D166}$ | $R^{D166}$ | $L_{C358}$ | $R^{D10}$ | $R^{D93}$ | $L_{C550}$ | $R^{D143}$ | $R^{D3}$ | $L_{C742}$ | $R^{D133}$ | $R^{D136}$ |
| $L_{C167}$ | $R^{D167}$ | $R^{D167}$ | $L_{C359}$ | $R^{D10}$ | $R^{D116}$ | $L_{C551}$ | $R^{D143}$ | $R^{D5}$ | $L_{C743}$ | $R^{D133}$ | $R^{D146}$ |
| $L_{C168}$ | $R^{D168}$ | $R^{D168}$ | $L_{C360}$ | $R^{D10}$ | $R^{D117}$ | $L_{C552}$ | $R^{D143}$ | $R^{D17}$ | $L_{C744}$ | $R^{D133}$ | $R^{D147}$ |
| $L_{C169}$ | $R^{D169}$ | $R^{D169}$ | $L_{C361}$ | $R^{D10}$ | $R^{D118}$ | $L_{C553}$ | $R^{D143}$ | $R^{D18}$ | $L_{C745}$ | $R^{D133}$ | $R^{D149}$ |
| $L_{C170}$ | $R^{D170}$ | $R^{D170}$ | $L_{C362}$ | $R^{D10}$ | $R^{D119}$ | $L_{C554}$ | $R^{D143}$ | $R^{D20}$ | $L_{C746}$ | $R^{D133}$ | $R^{D151}$ |
| $L_{C171}$ | $R^{D171}$ | $R^{D171}$ | $L_{C363}$ | $R^{D10}$ | $R^{D120}$ | $L_{C555}$ | $R^{D143}$ | $R^{D22}$ | $L_{C747}$ | $R^{D133}$ | $R^{D154}$ |
| $L_{C172}$ | $R^{D172}$ | $R^{D172}$ | $L_{C364}$ | $R^{D10}$ | $R^{D133}$ | $L_{C556}$ | $R^{D143}$ | $R^{D37}$ | $L_{C748}$ | $R^{D133}$ | $R^{D155}$ |
| $L_{C173}$ | $R^{D173}$ | $R^{D173}$ | $L_{C365}$ | $R^{D10}$ | $R^{D134}$ | $L_{C557}$ | $R^{D143}$ | $R^{D40}$ | $L_{C749}$ | $R^{D133}$ | $R^{D161}$ |
| $L_{C174}$ | $R^{D174}$ | $R^{D174}$ | $L_{C366}$ | $R^{D10}$ | $R^{D135}$ | $L_{C558}$ | $R^{D143}$ | $R^{D41}$ | $L_{C750}$ | $R^{D133}$ | $R^{D175}$ |
| $L_{C175}$ | $R^{D175}$ | $R^{D175}$ | $L_{C367}$ | $R^{D10}$ | $R^{D136}$ | $L_{C559}$ | $R^{D143}$ | $R^{D42}$ | $L_{C751}$ | $R^{D175}$ | $R^{D3}$ |
| $L_{C176}$ | $R^{D176}$ | $R^{D176}$ | $L_{C368}$ | $R^{D10}$ | $R^{D143}$ | $L_{C560}$ | $R^{D143}$ | $R^{D43}$ | $L_{C752}$ | $R^{D175}$ | $R^{D5}$ |
| $L_{C177}$ | $R^{D177}$ | $R^{D177}$ | $L_{C369}$ | $R^{D10}$ | $R^{D144}$ | $L_{C561}$ | $R^{D143}$ | $R^{D48}$ | $L_{C753}$ | $R^{D175}$ | $R^{D18}$ |
| $L_{C178}$ | $R^{D178}$ | $R^{D178}$ | $L_{C370}$ | $R^{D10}$ | $R^{D145}$ | $L_{C562}$ | $R^{D143}$ | $R^{D49}$ | $L_{C754}$ | $R^{D175}$ | $R^{D20}$ |
| $L_{C179}$ | $R^{D179}$ | $R^{D179}$ | $L_{C371}$ | $R^{D10}$ | $R^{D146}$ | $L_{C563}$ | $R^{D143}$ | $R^{D54}$ | $L_{C755}$ | $R^{D175}$ | $R^{D22}$ |
| $L_{C180}$ | $R^{D180}$ | $R^{D180}$ | $L_{C372}$ | $R^{D10}$ | $R^{D147}$ | $L_{C564}$ | $R^{D143}$ | $R^{D58}$ | $L_{C756}$ | $R^{D175}$ | $R^{D37}$ |
| $L_{C181}$ | $R^{D181}$ | $R^{D181}$ | $L_{C373}$ | $R^{D10}$ | $R^{D149}$ | $L_{C565}$ | $R^{D143}$ | $R^{D59}$ | $L_{C757}$ | $R^{D175}$ | $R^{D40}$ |
| $L_{C182}$ | $R^{D182}$ | $R^{D182}$ | $L_{C374}$ | $R^{D10}$ | $R^{D151}$ | $L_{C566}$ | $R^{D143}$ | $R^{D78}$ | $L_{C758}$ | $R^{D175}$ | $R^{D41}$ |
| $L_{C183}$ | $R^{D183}$ | $R^{D183}$ | $L_{C375}$ | $R^{D10}$ | $R^{D154}$ | $L_{C567}$ | $R^{D143}$ | $R^{D79}$ | $L_{C759}$ | $R^{D175}$ | $R^{D42}$ |
| $L_{C184}$ | $R^{D184}$ | $R^{D184}$ | $L_{C376}$ | $R^{D10}$ | $R^{D155}$ | $L_{C568}$ | $R^{D143}$ | $R^{D81}$ | $L_{C760}$ | $R^{D175}$ | $R^{D43}$ |
| $L_{C185}$ | $R^{D185}$ | $R^{D185}$ | $L_{C377}$ | $R^{D10}$ | $R^{D161}$ | $L_{C569}$ | $R^{D143}$ | $R^{D87}$ | $L_{C761}$ | $R^{D175}$ | $R^{D48}$ |
| $L_{C186}$ | $R^{D186}$ | $R^{D186}$ | $L_{C378}$ | $R^{D10}$ | $R^{D175}$ | $L_{C570}$ | $R^{D143}$ | $R^{D88}$ | $L_{C762}$ | $R^{D175}$ | $R^{D49}$ |
| $L_{C187}$ | $R^{D187}$ | $R^{D187}$ | $L_{C379}$ | $R^{D17}$ | $R^{D3}$ | $L_{C571}$ | $R^{D143}$ | $R^{D89}$ | $L_{C763}$ | $R^{D175}$ | $R^{D54}$ |
| $L_{C188}$ | $R^{D188}$ | $R^{D188}$ | $L_{C380}$ | $R^{D17}$ | $R^{D5}$ | $L_{C572}$ | $R^{D143}$ | $R^{D93}$ | $L_{C764}$ | $R^{D175}$ | $R^{D58}$ |
| $L_{C189}$ | $R^{D189}$ | $R^{D189}$ | $L_{C381}$ | $R^{D17}$ | $R^{D18}$ | $L_{C573}$ | $R^{D143}$ | $R^{D116}$ | $L_{C765}$ | $R^{D175}$ | $R^{D59}$ |
| $L_{C190}$ | $R^{D190}$ | $R^{D190}$ | $L_{C382}$ | $R^{D17}$ | $R^{D20}$ | $L_{C574}$ | $R^{D143}$ | $R^{D117}$ | $L_{C766}$ | $R^{D175}$ | $R^{D78}$ |
| $L_{C191}$ | $R^{D191}$ | $R^{D191}$ | $L_{C383}$ | $R^{D17}$ | $R^{D22}$ | $L_{C575}$ | $R^{D143}$ | $R^{D118}$ | $L_{C767}$ | $R^{D175}$ | $R^{D79}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C192}$ | $R^{D192}$ | $R^{D192}$ | $L_{C384}$ | $R^{D17}$ | $R^{D37}$ | $L_{C576}$ | $R^{D143}$ | $R^{D119}$ | $L_{C768}$ | $R^{D175}$ | $R^{D81}$ |
| $L_{C769}$ | $R^{D193}$ | $R^{D193}$ | $L_{C877}$ | $R^{D1}$ | $R^{D193}$ | $L_{C985}$ | $R^{D4}$ | $R^{D193}$ | $L_{C1093}$ | $R^{D9}$ | $R^{D193}$ |
| $L_{C770}$ | $R^{D194}$ | $R^{D194}$ | $L_{C878}$ | $R^{D1}$ | $R^{D194}$ | $L_{C986}$ | $R^{D4}$ | $R^{D194}$ | $L_{C1094}$ | $R^{D9}$ | $R^{D194}$ |
| $L_{C771}$ | $R^{D195}$ | $R^{D195}$ | $L_{C879}$ | $R^{D1}$ | $R^{D195}$ | $L_{C987}$ | $R^{D4}$ | $R^{D195}$ | $L_{C1095}$ | $R^{D9}$ | $R^{D195}$ |
| $L_{C772}$ | $R^{D196}$ | $R^{D196}$ | $L_{C880}$ | $R^{D1}$ | $R^{D196}$ | $L_{C988}$ | $R^{D4}$ | $R^{D196}$ | $L_{C1096}$ | $R^{D9}$ | $R^{D196}$ |
| $L_{C773}$ | $R^{D197}$ | $R^{D197}$ | $L_{C881}$ | $R^{D1}$ | $R^{D197}$ | $L_{C989}$ | $R^{D4}$ | $R^{D197}$ | $L_{C1097}$ | $R^{D9}$ | $R^{D197}$ |
| $L_{C774}$ | $R^{D198}$ | $R^{D198}$ | $L_{C882}$ | $R^{D1}$ | $R^{D198}$ | $L_{C990}$ | $R^{D4}$ | $R^{D198}$ | $L_{C1098}$ | $R^{D9}$ | $R^{D198}$ |
| $L_{C775}$ | $R^{D199}$ | $R^{D199}$ | $L_{C883}$ | $R^{D1}$ | $R^{D199}$ | $L_{C991}$ | $R^{D4}$ | $R^{D199}$ | $L_{C1099}$ | $R^{D9}$ | $R^{D199}$ |
| $L_{C776}$ | $R^{D200}$ | $R^{D200}$ | $L_{C884}$ | $R^{D1}$ | $R^{D200}$ | $L_{C992}$ | $R^{D4}$ | $R^{D200}$ | $L_{C1100}$ | $R^{D9}$ | $R^{D200}$ |
| $L_{C777}$ | $R^{D201}$ | $R^{D201}$ | $L_{C885}$ | $R^{D1}$ | $R^{D201}$ | $L_{C993}$ | $R^{D4}$ | $R^{D201}$ | $L_{C1101}$ | $R^{D9}$ | $R^{D201}$ |
| $L_{C778}$ | $R^{D202}$ | $R^{D202}$ | $L_{C886}$ | $R^{D1}$ | $R^{D202}$ | $L_{C994}$ | $R^{D4}$ | $R^{D202}$ | $L_{C1102}$ | $R^{D9}$ | $R^{D202}$ |
| $L_{C779}$ | $R^{D203}$ | $R^{D203}$ | $L_{C887}$ | $R^{D1}$ | $R^{D203}$ | $L_{C995}$ | $R^{D4}$ | $R^{D203}$ | $L_{C1103}$ | $R^{D9}$ | $R^{D203}$ |
| $L_{C780}$ | $R^{D204}$ | $R^{D204}$ | $L_{C888}$ | $R^{D1}$ | $R^{D204}$ | $L_{C996}$ | $R^{D4}$ | $R^{D204}$ | $L_{C1104}$ | $R^{D9}$ | $R^{D204}$ |
| $L_{C781}$ | $R^{D205}$ | $R^{D205}$ | $L_{C889}$ | $R^{D1}$ | $R^{D205}$ | $L_{C997}$ | $R^{D4}$ | $R^{D205}$ | $L_{C1105}$ | $R^{D9}$ | $R^{D205}$ |
| $L_{C782}$ | $R^{D206}$ | $R^{D206}$ | $L_{C890}$ | $R^{D1}$ | $R^{D206}$ | $L_{C998}$ | $R^{D4}$ | $R^{D206}$ | $L_{C1106}$ | $R^{D9}$ | $R^{D206}$ |
| $L_{C783}$ | $R^{D207}$ | $R^{D207}$ | $L_{C891}$ | $R^{D1}$ | $R^{D207}$ | $L_{C999}$ | $R^{D4}$ | $R^{D207}$ | $L_{C1107}$ | $R^{D9}$ | $R^{D207}$ |
| $L_{C784}$ | $R^{D208}$ | $R^{D208}$ | $L_{C892}$ | $R^{D1}$ | $R^{D208}$ | $L_{C1000}$ | $R^{D4}$ | $R^{D208}$ | $L_{C1108}$ | $R^{D9}$ | $R^{D208}$ |
| $L_{C785}$ | $R^{D209}$ | $R^{D209}$ | $L_{C893}$ | $R^{D1}$ | $R^{D209}$ | $L_{C1001}$ | $R^{D4}$ | $R^{D209}$ | $L_{C1109}$ | $R^{D9}$ | $R^{D209}$ |
| $L_{C786}$ | $R^{D210}$ | $R^{D210}$ | $L_{C894}$ | $R^{D1}$ | $R^{D210}$ | $L_{C1002}$ | $R^{D4}$ | $R^{D210}$ | $L_{C1110}$ | $R^{D9}$ | $R^{D210}$ |
| $L_{C787}$ | $R^{D211}$ | $R^{D211}$ | $L_{C895}$ | $R^{D1}$ | $R^{D211}$ | $L_{C1003}$ | $R^{D4}$ | $R^{D211}$ | $L_{C1111}$ | $R^{D9}$ | $R^{D211}$ |
| $L_{C788}$ | $R^{D212}$ | $R^{D212}$ | $L_{C896}$ | $R^{D1}$ | $R^{D212}$ | $L_{C1004}$ | $R^{D4}$ | $R^{D212}$ | $L_{C1112}$ | $R^{D9}$ | $R^{D212}$ |
| $L_{C789}$ | $R^{D213}$ | $R^{D213}$ | $L_{C897}$ | $R^{D1}$ | $R^{D213}$ | $L_{C1005}$ | $R^{D4}$ | $R^{D213}$ | $L_{C1113}$ | $R^{D9}$ | $R^{D213}$ |
| $L_{C790}$ | $R^{D214}$ | $R^{D214}$ | $L_{C898}$ | $R^{D1}$ | $R^{D214}$ | $L_{C1006}$ | $R^{D4}$ | $R^{D214}$ | $L_{C1114}$ | $R^{D9}$ | $R^{D214}$ |
| $L_{C791}$ | $R^{D215}$ | $R^{D215}$ | $L_{C899}$ | $R^{D1}$ | $R^{D215}$ | $L_{C1007}$ | $R^{D4}$ | $R^{D215}$ | $L_{C1115}$ | $R^{D9}$ | $R^{D215}$ |
| $L_{C792}$ | $R^{D216}$ | $R^{D216}$ | $L_{C900}$ | $R^{D1}$ | $R^{D216}$ | $L_{C1008}$ | $R^{D4}$ | $R^{D216}$ | $L_{C1116}$ | $R^{D9}$ | $R^{D216}$ |
| $L_{C793}$ | $R^{D217}$ | $R^{D217}$ | $L_{C901}$ | $R^{D1}$ | $R^{D217}$ | $L_{C1009}$ | $R^{D4}$ | $R^{D217}$ | $L_{C1117}$ | $R^{D9}$ | $R^{D217}$ |
| $L_{C794}$ | $R^{D218}$ | $R^{D218}$ | $L_{C902}$ | $R^{D1}$ | $R^{D218}$ | $L_{C1010}$ | $R^{D4}$ | $R^{D218}$ | $L_{C1118}$ | $R^{D9}$ | $R^{D218}$ |
| $L_{C795}$ | $R^{D219}$ | $R^{D219}$ | $L_{C903}$ | $R^{D1}$ | $R^{D219}$ | $L_{C1011}$ | $R^{D4}$ | $R^{D219}$ | $L_{C1119}$ | $R^{D9}$ | $R^{D219}$ |
| $L_{C796}$ | $R^{D220}$ | $R^{D220}$ | $L_{C904}$ | $R^{D1}$ | $R^{D220}$ | $L_{C1012}$ | $R^{D4}$ | $R^{D220}$ | $L_{C1120}$ | $R^{D9}$ | $R^{D220}$ |
| $L_{C797}$ | $R^{D221}$ | $R^{D221}$ | $L_{C905}$ | $R^{D1}$ | $R^{D221}$ | $L_{C1013}$ | $R^{D4}$ | $R^{D221}$ | $L_{C1121}$ | $R^{D9}$ | $R^{D221}$ |
| $L_{C798}$ | $R^{D222}$ | $R^{D222}$ | $L_{C906}$ | $R^{D1}$ | $R^{D222}$ | $L_{C1014}$ | $R^{D4}$ | $R^{D222}$ | $L_{C1122}$ | $R^{D9}$ | $R^{D222}$ |
| $L_{C799}$ | $R^{D223}$ | $R^{D223}$ | $L_{C907}$ | $R^{D1}$ | $R^{D223}$ | $L_{C1015}$ | $R^{D4}$ | $R^{D223}$ | $L_{C1123}$ | $R^{D9}$ | $R^{D223}$ |
| $L_{C800}$ | $R^{D224}$ | $R^{D224}$ | $L_{C908}$ | $R^{D1}$ | $R^{D224}$ | $L_{C1016}$ | $R^{D4}$ | $R^{D224}$ | $L_{C1124}$ | $R^{D9}$ | $R^{D224}$ |
| $L_{C801}$ | $R^{D225}$ | $R^{D225}$ | $L_{C909}$ | $R^{D1}$ | $R^{D225}$ | $L_{C1017}$ | $R^{D4}$ | $R^{D225}$ | $L_{C1125}$ | $R^{D9}$ | $R^{D225}$ |
| $L_{C802}$ | $R^{D226}$ | $R^{D226}$ | $L_{C910}$ | $R^{D1}$ | $R^{D226}$ | $L_{C1018}$ | $R^{D4}$ | $R^{D226}$ | $L_{C1126}$ | $R^{D9}$ | $R^{D226}$ |
| $L_{C803}$ | $R^{D227}$ | $R^{D227}$ | $L_{C911}$ | $R^{D1}$ | $R^{D227}$ | $L_{C1019}$ | $R^{D4}$ | $R^{D227}$ | $L_{C1127}$ | $R^{D9}$ | $R^{D227}$ |
| $L_{C804}$ | $R^{D228}$ | $R^{D228}$ | $L_{C912}$ | $R^{D1}$ | $R^{D228}$ | $L_{C1020}$ | $R^{D4}$ | $R^{D228}$ | $L_{C1128}$ | $R^{D9}$ | $R^{D228}$ |
| $L_{C805}$ | $R^{D229}$ | $R^{D229}$ | $L_{C913}$ | $R^{D1}$ | $R^{D229}$ | $L_{C1021}$ | $R^{D4}$ | $R^{D229}$ | $L_{C1129}$ | $R^{D9}$ | $R^{D229}$ |
| $L_{C806}$ | $R^{D230}$ | $R^{D230}$ | $L_{C914}$ | $R^{D1}$ | $R^{D230}$ | $L_{C1022}$ | $R^{D4}$ | $R^{D230}$ | $L_{C1130}$ | $R^{D9}$ | $R^{D230}$ |
| $L_{C807}$ | $R^{D231}$ | $R^{D231}$ | $L_{C915}$ | $R^{D1}$ | $R^{D231}$ | $L_{C1023}$ | $R^{D4}$ | $R^{D231}$ | $L_{C1131}$ | $R^{D9}$ | $R^{D231}$ |
| $L_{C808}$ | $R^{D232}$ | $R^{D232}$ | $L_{C916}$ | $R^{D1}$ | $R^{D232}$ | $L_{C1024}$ | $R^{D4}$ | $R^{D232}$ | $L_{C1132}$ | $R^{D9}$ | $R^{D232}$ |
| $L_{C809}$ | $R^{D233}$ | $R^{D233}$ | $L_{C917}$ | $R^{D1}$ | $R^{D233}$ | $L_{C1025}$ | $R^{D4}$ | $R^{D233}$ | $L_{C1133}$ | $R^{D9}$ | $R^{D233}$ |
| $L_{C810}$ | $R^{D234}$ | $R^{D234}$ | $L_{C918}$ | $R^{D1}$ | $R^{D234}$ | $L_{C1026}$ | $R^{D4}$ | $R^{D234}$ | $L_{C1134}$ | $R^{D9}$ | $R^{D234}$ |
| $L_{C811}$ | $R^{D235}$ | $R^{D235}$ | $L_{C919}$ | $R^{D1}$ | $R^{D235}$ | $L_{C1027}$ | $R^{D4}$ | $R^{D235}$ | $L_{C1135}$ | $R^{D9}$ | $R^{D235}$ |
| $L_{C812}$ | $R^{D236}$ | $R^{D236}$ | $L_{C920}$ | $R^{D1}$ | $R^{D236}$ | $L_{C1028}$ | $R^{D4}$ | $R^{D236}$ | $L_{C1136}$ | $R^{D9}$ | $R^{D236}$ |
| $L_{C813}$ | $R^{D237}$ | $R^{D237}$ | $L_{C921}$ | $R^{D1}$ | $R^{D237}$ | $L_{C1029}$ | $R^{D4}$ | $R^{D237}$ | $L_{C1137}$ | $R^{D9}$ | $R^{D237}$ |
| $L_{C814}$ | $R^{D238}$ | $R^{D238}$ | $L_{C922}$ | $R^{D1}$ | $R^{D238}$ | $L_{C1030}$ | $R^{D4}$ | $R^{D238}$ | $L_{C1138}$ | $R^{D9}$ | $R^{D238}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C815}$ | $R^{D239}$ | $R^{D239}$ | $L_{C923}$ | $R^{D1}$ | $R^{D239}$ | $L_{C1031}$ | $R^{D4}$ | $R^{D239}$ | $L_{C1139}$ | $R^{D9}$ | $R^{D239}$ |
| $L_{C816}$ | $R^{D240}$ | $R^{D240}$ | $L_{C924}$ | $R^{D1}$ | $R^{D240}$ | $L_{C1032}$ | $R^{D4}$ | $R^{D240}$ | $L_{C1140}$ | $R^{D9}$ | $R^{D240}$ |
| $L_{C817}$ | $R^{D241}$ | $R^{D241}$ | $L_{C925}$ | $R^{D1}$ | $R^{D241}$ | $L_{C1033}$ | $R^{D4}$ | $R^{D241}$ | $L_{C1141}$ | $R^{D9}$ | $R^{D241}$ |
| $L_{C818}$ | $R^{D242}$ | $R^{D242}$ | $L_{C926}$ | $R^{D1}$ | $R^{D242}$ | $L_{C1034}$ | $R^{D4}$ | $R^{D242}$ | $L_{C1142}$ | $R^{D9}$ | $R^{D242}$ |
| $L_{C819}$ | $R^{D243}$ | $R^{D243}$ | $L_{C927}$ | $R^{D1}$ | $R^{D243}$ | $L_{C1035}$ | $R^{D4}$ | $R^{D243}$ | $L_{C1143}$ | $R^{D9}$ | $R^{D243}$ |
| $L_{C820}$ | $R^{D244}$ | $R^{D244}$ | $L_{C928}$ | $R^{D1}$ | $R^{D244}$ | $L_{C1036}$ | $R^{D4}$ | $R^{D244}$ | $L_{C1144}$ | $R^{D9}$ | $R^{D244}$ |
| $L_{C821}$ | $R^{D245}$ | $R^{D245}$ | $L_{C929}$ | $R^{D1}$ | $R^{D245}$ | $L_{C1037}$ | $R^{D4}$ | $R^{D245}$ | $L_{C1145}$ | $R^{D9}$ | $R^{D245}$ |
| $L_{C822}$ | $R^{D246}$ | $R^{D246}$ | $L_{C930}$ | $R^{D1}$ | $R^{D246}$ | $L_{C1038}$ | $R^{D4}$ | $R^{D246}$ | $L_{C1146}$ | $R^{D9}$ | $R^{D246}$ |
| $L_{C823}$ | $R^{D17}$ | $R^{D193}$ | $L_{C931}$ | $R^{D50}$ | $R^{D193}$ | $L_{C1039}$ | $R^{D145}$ | $R^{D193}$ | $L_{C1147}$ | $R^{D168}$ | $R^{D193}$ |
| $L_{C824}$ | $R^{D17}$ | $R^{D194}$ | $L_{C932}$ | $R^{D50}$ | $R^{D194}$ | $L_{C1040}$ | $R^{D145}$ | $R^{D194}$ | $L_{C1148}$ | $R^{D168}$ | $R^{D194}$ |
| $L_{C825}$ | $R^{D17}$ | $R^{D195}$ | $L_{C933}$ | $R^{D50}$ | $R^{D195}$ | $L_{C1041}$ | $R^{D145}$ | $R^{D195}$ | $L_{C1149}$ | $R^{D168}$ | $R^{D195}$ |
| $L_{C826}$ | $R^{D17}$ | $R^{D196}$ | $L_{C934}$ | $R^{D50}$ | $R^{D196}$ | $L_{C1042}$ | $R^{D145}$ | $R^{D196}$ | $L_{C1150}$ | $R^{D168}$ | $R^{D196}$ |
| $L_{C827}$ | $R^{D17}$ | $R^{D197}$ | $L_{C935}$ | $R^{D50}$ | $R^{D197}$ | $L_{C1043}$ | $R^{D145}$ | $R^{D197}$ | $L_{C1151}$ | $R^{D168}$ | $R^{D197}$ |
| $L_{C828}$ | $R^{D17}$ | $R^{D198}$ | $L_{C936}$ | $R^{D50}$ | $R^{D198}$ | $L_{C1044}$ | $R^{D145}$ | $R^{D198}$ | $L_{C1152}$ | $R^{D168}$ | $R^{D198}$ |
| $L_{C829}$ | $R^{D17}$ | $R^{D199}$ | $L_{C937}$ | $R^{D50}$ | $R^{D199}$ | $L_{C1045}$ | $R^{D145}$ | $R^{D199}$ | $L_{C1153}$ | $R^{D168}$ | $R^{D199}$ |
| $L_{C830}$ | $R^{D17}$ | $R^{D200}$ | $L_{C938}$ | $R^{D50}$ | $R^{D200}$ | $L_{C1046}$ | $R^{D145}$ | $R^{D200}$ | $L_{C1154}$ | $R^{D168}$ | $R^{D200}$ |
| $L_{C831}$ | $R^{D17}$ | $R^{D201}$ | $L_{C939}$ | $R^{D50}$ | $R^{D201}$ | $L_{C1047}$ | $R^{D145}$ | $R^{D201}$ | $L_{C1155}$ | $R^{D168}$ | $R^{D201}$ |
| $L_{C832}$ | $R^{D17}$ | $R^{D202}$ | $L_{C940}$ | $R^{D50}$ | $R^{D202}$ | $L_{C1048}$ | $R^{D145}$ | $R^{D202}$ | $L_{C1156}$ | $R^{D168}$ | $R^{D202}$ |
| $L_{C833}$ | $R^{D17}$ | $R^{D203}$ | $L_{C941}$ | $R^{D50}$ | $R^{D203}$ | $L_{C1049}$ | $R^{D145}$ | $R^{D203}$ | $L_{C1157}$ | $R^{D168}$ | $R^{D203}$ |
| $L_{C834}$ | $R^{D17}$ | $R^{D204}$ | $L_{C942}$ | $R^{D50}$ | $R^{D204}$ | $L_{C1050}$ | $R^{D145}$ | $R^{D204}$ | $L_{C1158}$ | $R^{D168}$ | $R^{D204}$ |
| $L_{C835}$ | $R^{D17}$ | $R^{D205}$ | $L_{C943}$ | $R^{D50}$ | $R^{D205}$ | $L_{C1051}$ | $R^{D145}$ | $R^{D205}$ | $L_{C1159}$ | $R^{D168}$ | $R^{D205}$ |
| $L_{C836}$ | $R^{D17}$ | $R^{D206}$ | $L_{C944}$ | $R^{D50}$ | $R^{D206}$ | $L_{C1052}$ | $R^{D145}$ | $R^{D206}$ | $L_{C1160}$ | $R^{D168}$ | $R^{D206}$ |
| $L_{C837}$ | $R^{D17}$ | $R^{D207}$ | $L_{C945}$ | $R^{D50}$ | $R^{D207}$ | $L_{C1053}$ | $R^{D145}$ | $R^{D207}$ | $L_{C1161}$ | $R^{D168}$ | $R^{D207}$ |
| $L_{C838}$ | $R^{D17}$ | $R^{D208}$ | $L_{C946}$ | $R^{D50}$ | $R^{D208}$ | $L_{C1054}$ | $R^{D145}$ | $R^{D208}$ | $L_{C1162}$ | $R^{D168}$ | $R^{D208}$ |
| $L_{C839}$ | $R^{D17}$ | $R^{D209}$ | $L_{C947}$ | $R^{D50}$ | $R^{D209}$ | $L_{C1055}$ | $R^{D145}$ | $R^{D209}$ | $L_{C1163}$ | $R^{D168}$ | $R^{D209}$ |
| $L_{C840}$ | $R^{D17}$ | $R^{D210}$ | $L_{C948}$ | $R^{D50}$ | $R^{D210}$ | $L_{C1056}$ | $R^{D145}$ | $R^{D210}$ | $L_{C1164}$ | $R^{D168}$ | $R^{D210}$ |
| $L_{C841}$ | $R^{D17}$ | $R^{D211}$ | $L_{C949}$ | $R^{D50}$ | $R^{D211}$ | $L_{C1057}$ | $R^{D145}$ | $R^{D211}$ | $L_{C1165}$ | $R^{D168}$ | $R^{D211}$ |
| $L_{C842}$ | $R^{D17}$ | $R^{D212}$ | $L_{C950}$ | $R^{D50}$ | $R^{D212}$ | $L_{C1058}$ | $R^{D145}$ | $R^{D212}$ | $L_{C1166}$ | $R^{D168}$ | $R^{D212}$ |
| $L_{C843}$ | $R^{D17}$ | $R^{D213}$ | $L_{C951}$ | $R^{D50}$ | $R^{D213}$ | $L_{C1059}$ | $R^{D145}$ | $R^{D213}$ | $L_{C1167}$ | $R^{D168}$ | $R^{D213}$ |
| $L_{C844}$ | $R^{D17}$ | $R^{D214}$ | $L_{C952}$ | $R^{D50}$ | $R^{D214}$ | $L_{C1060}$ | $R^{D145}$ | $R^{D214}$ | $L_{C1168}$ | $R^{D168}$ | $R^{D214}$ |
| $L_{C845}$ | $R^{D17}$ | $R^{D215}$ | $L_{C953}$ | $R^{D50}$ | $R^{D215}$ | $L_{C1061}$ | $R^{D145}$ | $R^{D215}$ | $L_{C1169}$ | $R^{D168}$ | $R^{D215}$ |
| $L_{C846}$ | $R^{D17}$ | $R^{D216}$ | $L_{C954}$ | $R^{D50}$ | $R^{D216}$ | $L_{C1062}$ | $R^{D145}$ | $R^{D216}$ | $L_{C1170}$ | $R^{D168}$ | $R^{D216}$ |
| $L_{C847}$ | $R^{D17}$ | $R^{D217}$ | $L_{C955}$ | $R^{D50}$ | $R^{D217}$ | $L_{C1063}$ | $R^{D145}$ | $R^{D217}$ | $L_{C1171}$ | $R^{D168}$ | $R^{D217}$ |
| $L_{C848}$ | $R^{D17}$ | $R^{D218}$ | $L_{C956}$ | $R^{D50}$ | $R^{D218}$ | $L_{C1064}$ | $R^{D145}$ | $R^{D218}$ | $L_{C1172}$ | $R^{D168}$ | $R^{D218}$ |
| $L_{C849}$ | $R^{D17}$ | $R^{D219}$ | $L_{C957}$ | $R^{D50}$ | $R^{D219}$ | $L_{C1065}$ | $R^{D145}$ | $R^{D219}$ | $L_{C1173}$ | $R^{D168}$ | $R^{D219}$ |
| $L_{C850}$ | $R^{D17}$ | $R^{D220}$ | $L_{C958}$ | $R^{D50}$ | $R^{D220}$ | $L_{C1066}$ | $R^{D145}$ | $R^{D220}$ | $L_{C1174}$ | $R^{D168}$ | $R^{D220}$ |
| $L_{C851}$ | $R^{D17}$ | $R^{D221}$ | $L_{C959}$ | $R^{D50}$ | $R^{D221}$ | $L_{C1067}$ | $R^{D145}$ | $R^{D221}$ | $L_{C1175}$ | $R^{D168}$ | $R^{D221}$ |
| $L_{C852}$ | $R^{D17}$ | $R^{D222}$ | $L_{C960}$ | $R^{D50}$ | $R^{D222}$ | $L_{C1068}$ | $R^{D145}$ | $R^{D222}$ | $L_{C1176}$ | $R^{D168}$ | $R^{D222}$ |
| $L_{C853}$ | $R^{D17}$ | $R^{D223}$ | $L_{C961}$ | $R^{D50}$ | $R^{D223}$ | $L_{C1069}$ | $R^{D145}$ | $R^{D223}$ | $L_{C1177}$ | $R^{D168}$ | $R^{D223}$ |
| $L_{C854}$ | $R^{D17}$ | $R^{D224}$ | $L_{C962}$ | $R^{D50}$ | $R^{D224}$ | $L_{C1070}$ | $R^{D145}$ | $R^{D224}$ | $L_{C1178}$ | $R^{D168}$ | $R^{D224}$ |
| $L_{C855}$ | $R^{D17}$ | $R^{D225}$ | $L_{C963}$ | $R^{D50}$ | $R^{D225}$ | $L_{C1071}$ | $R^{D145}$ | $R^{D225}$ | $L_{C1179}$ | $R^{D168}$ | $R^{D225}$ |
| $L_{C856}$ | $R^{D17}$ | $R^{D226}$ | $L_{C964}$ | $R^{D50}$ | $R^{D226}$ | $L_{C1072}$ | $R^{D145}$ | $R^{D226}$ | $L_{C1180}$ | $R^{D168}$ | $R^{D226}$ |
| $L_{C857}$ | $R^{D17}$ | $R^{D227}$ | $L_{C965}$ | $R^{D50}$ | $R^{D227}$ | $L_{C1073}$ | $R^{D145}$ | $R^{D227}$ | $L_{C1181}$ | $R^{D168}$ | $R^{D227}$ |
| $L_{C858}$ | $R^{D17}$ | $R^{D228}$ | $L_{C966}$ | $R^{D50}$ | $R^{D228}$ | $L_{C1074}$ | $R^{D145}$ | $R^{D228}$ | $L_{C1182}$ | $R^{D168}$ | $R^{D228}$ |
| $L_{C859}$ | $R^{D17}$ | $R^{D229}$ | $L_{C967}$ | $R^{D50}$ | $R^{D229}$ | $L_{C1075}$ | $R^{D145}$ | $R^{D229}$ | $L_{C1183}$ | $R^{D168}$ | $R^{D229}$ |
| $L_{C860}$ | $R^{D17}$ | $R^{D230}$ | $L_{C968}$ | $R^{D50}$ | $R^{D230}$ | $L_{C1076}$ | $R^{D145}$ | $R^{D230}$ | $L_{C1184}$ | $R^{D168}$ | $R^{D230}$ |
| $L_{C861}$ | $R^{D17}$ | $R^{D231}$ | $L_{C969}$ | $R^{D50}$ | $R^{D231}$ | $L_{C1077}$ | $R^{D145}$ | $R^{D231}$ | $L_{C1185}$ | $R^{D168}$ | $R^{D231}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C862}$ | $R^{D17}$ | $R^{D232}$ | $L_{C970}$ | $R^{D50}$ | $R^{D232}$ | $L_{C1078}$ | $R^{D145}$ | $R^{D232}$ | $L_{C1186}$ | $R^{D168}$ | $R^{D232}$ |
| $L_{C863}$ | $R^{D17}$ | $R^{D233}$ | $L_{C971}$ | $R^{D50}$ | $R^{D233}$ | $L_{C1079}$ | $R^{D145}$ | $R^{D233}$ | $L_{C1187}$ | $R^{D168}$ | $R^{D233}$ |
| $L_{C864}$ | $R^{D17}$ | $R^{D234}$ | $L_{C972}$ | $R^{D50}$ | $R^{D234}$ | $L_{C1080}$ | $R^{D145}$ | $R^{D234}$ | $L_{C1188}$ | $R^{D168}$ | $R^{D234}$ |
| $L_{C865}$ | $R^{D17}$ | $R^{D235}$ | $L_{C973}$ | $R^{D50}$ | $R^{D235}$ | $L_{C1081}$ | $R^{D145}$ | $R^{D235}$ | $L_{C1189}$ | $R^{D168}$ | $R^{D235}$ |
| $L_{C866}$ | $R^{D17}$ | $R^{D236}$ | $L_{C974}$ | $R^{D50}$ | $R^{D236}$ | $L_{C1082}$ | $R^{D145}$ | $R^{D236}$ | $L_{C1190}$ | $R^{D168}$ | $R^{D236}$ |
| $L_{C867}$ | $R^{D17}$ | $R^{D237}$ | $L_{C975}$ | $R^{D50}$ | $R^{D237}$ | $L_{C1083}$ | $R^{D145}$ | $R^{D237}$ | $L_{C1191}$ | $R^{D168}$ | $R^{D237}$ |
| $L_{C868}$ | $R^{D17}$ | $R^{D238}$ | $L_{C976}$ | $R^{D50}$ | $R^{D238}$ | $L_{C1084}$ | $R^{D145}$ | $R^{D238}$ | $L_{C1192}$ | $R^{D168}$ | $R^{D238}$ |
| $L_{C869}$ | $R^{D17}$ | $R^{D239}$ | $L_{C977}$ | $R^{D50}$ | $R^{D239}$ | $L_{C1085}$ | $R^{D145}$ | $R^{D239}$ | $L_{C1193}$ | $R^{D168}$ | $R^{D239}$ |
| $L_{C870}$ | $R^{D17}$ | $R^{D240}$ | $L_{C978}$ | $R^{D50}$ | $R^{D240}$ | $L_{C1086}$ | $R^{D145}$ | $R^{D240}$ | $L_{C1194}$ | $R^{D168}$ | $R^{D240}$ |
| $L_{C871}$ | $R^{D17}$ | $R^{D241}$ | $L_{C979}$ | $R^{D50}$ | $R^{D241}$ | $L_{C1087}$ | $R^{D145}$ | $R^{D241}$ | $L_{C1195}$ | $R^{D168}$ | $R^{D241}$ |
| $L_{C872}$ | $R^{D17}$ | $R^{D242}$ | $L_{C980}$ | $R^{D50}$ | $R^{D242}$ | $L_{C1088}$ | $R^{D145}$ | $R^{D242}$ | $L_{C1196}$ | $R^{D168}$ | $R^{D242}$ |
| $L_{C873}$ | $R^{D17}$ | $R^{D243}$ | $L_{C981}$ | $R^{D50}$ | $R^{D243}$ | $L_{C1089}$ | $R^{D145}$ | $R^{D243}$ | $L_{C1197}$ | $R^{D168}$ | $R^{D243}$ |
| $L_{C874}$ | $R^{D17}$ | $R^{D244}$ | $L_{C982}$ | $R^{D50}$ | $R^{D244}$ | $L_{C1090}$ | $R^{D145}$ | $R^{D244}$ | $L_{C1198}$ | $R^{D168}$ | $R^{D244}$ |
| $L_{C875}$ | $R^{D17}$ | $R^{D245}$ | $L_{C983}$ | $R^{D50}$ | $R^{D245}$ | $L_{C1091}$ | $R^{D145}$ | $R^{D245}$ | $L_{C1199}$ | $R^{D168}$ | $R^{D245}$ |
| $L_{C876}$ | $R^{D17}$ | $R^{D246}$ | $L_{C984}$ | $R^{D50}$ | $R^{D246}$ | $L_{C1092}$ | $R^{D145}$ | $R^{D246}$ | $L_{C1200}$ | $R^{D168}$ | $R^{D246}$ |
| $L_{C1201}$ | $R^{D10}$ | $R^{D193}$ | $L_{C1255}$ | $R^{D55}$ | $R^{D193}$ | $L_{C1309}$ | $R^{D37}$ | $R^{D193}$ | $L_{C1363}$ | $R^{D143}$ | $R^{D193}$ |
| $L_{C1202}$ | $R^{D10}$ | $R^{D194}$ | $L_{C1256}$ | $R^{D55}$ | $R^{D194}$ | $L_{C1310}$ | $R^{D37}$ | $R^{D194}$ | $L_{C1364}$ | $R^{D143}$ | $R^{D194}$ |
| $L_{C1203}$ | $R^{D10}$ | $R^{D195}$ | $L_{C1257}$ | $R^{D55}$ | $R^{D195}$ | $L_{C1311}$ | $R^{D37}$ | $R^{D195}$ | $L_{C1365}$ | $R^{D143}$ | $R^{D195}$ |
| $L_{C1204}$ | $R^{D10}$ | $R^{D196}$ | $L_{C1258}$ | $R^{D55}$ | $R^{D196}$ | $L_{C1312}$ | $R^{D37}$ | $R^{D196}$ | $L_{C1366}$ | $R^{D143}$ | $R^{D196}$ |
| $L_{C1205}$ | $R^{D10}$ | $R^{D197}$ | $L_{C1259}$ | $R^{D55}$ | $R^{D197}$ | $L_{C1313}$ | $R^{D37}$ | $R^{D197}$ | $L_{C1367}$ | $R^{D143}$ | $R^{D197}$ |
| $L_{C1206}$ | $R^{D10}$ | $R^{D198}$ | $L_{C1260}$ | $R^{D55}$ | $R^{D198}$ | $L_{C1314}$ | $R^{D37}$ | $R^{D198}$ | $L_{C1368}$ | $R^{D143}$ | $R^{D198}$ |
| $L_{C1207}$ | $R^{D10}$ | $R^{D199}$ | $L_{C1261}$ | $R^{D55}$ | $R^{D199}$ | $L_{C1315}$ | $R^{D37}$ | $R^{D199}$ | $L_{C1369}$ | $R^{D143}$ | $R^{D199}$ |
| $L_{C1208}$ | $R^{D10}$ | $R^{D200}$ | $L_{C1262}$ | $R^{D55}$ | $R^{D200}$ | $L_{C1316}$ | $R^{D37}$ | $R^{D200}$ | $L_{C1370}$ | $R^{D143}$ | $R^{D200}$ |
| $L_{C1209}$ | $R^{D10}$ | $R^{D201}$ | $L_{C1263}$ | $R^{D55}$ | $R^{D201}$ | $L_{C1317}$ | $R^{D37}$ | $R^{D201}$ | $L_{C1371}$ | $R^{D143}$ | $R^{D201}$ |
| $L_{C1210}$ | $R^{D10}$ | $R^{D202}$ | $L_{C1264}$ | $R^{D55}$ | $R^{D202}$ | $L_{C1318}$ | $R^{D37}$ | $R^{D202}$ | $L_{C1372}$ | $R^{D143}$ | $R^{D202}$ |
| $L_{C1211}$ | $R^{D10}$ | $R^{D203}$ | $L_{C1265}$ | $R^{D55}$ | $R^{D203}$ | $L_{C1319}$ | $R^{D37}$ | $R^{D203}$ | $L_{C1373}$ | $R^{D143}$ | $R^{D203}$ |
| $L_{C1212}$ | $R^{D10}$ | $R^{D204}$ | $L_{C1266}$ | $R^{D55}$ | $R^{D204}$ | $L_{C1320}$ | $R^{D37}$ | $R^{D204}$ | $L_{C1374}$ | $R^{D143}$ | $R^{D204}$ |
| $L_{C1213}$ | $R^{D10}$ | $R^{D205}$ | $L_{C1267}$ | $R^{D55}$ | $R^{D205}$ | $L_{C1321}$ | $R^{D37}$ | $R^{D205}$ | $L_{C1375}$ | $R^{D143}$ | $R^{D205}$ |
| $L_{C1214}$ | $R^{D10}$ | $R^{D206}$ | $L_{C1268}$ | $R^{D55}$ | $R^{D206}$ | $L_{C1322}$ | $R^{D37}$ | $R^{D206}$ | $L_{C1376}$ | $R^{D143}$ | $R^{D206}$ |
| $L_{C1215}$ | $R^{D10}$ | $R^{D207}$ | $L_{C1269}$ | $R^{D55}$ | $R^{D207}$ | $L_{C1323}$ | $R^{D37}$ | $R^{D207}$ | $L_{C1377}$ | $R^{D143}$ | $R^{D207}$ |
| $L_{C1216}$ | $R^{D10}$ | $R^{D208}$ | $L_{C1270}$ | $R^{D55}$ | $R^{D208}$ | $L_{C1324}$ | $R^{D37}$ | $R^{D208}$ | $L_{C1378}$ | $R^{D143}$ | $R^{D208}$ |
| $L_{C1217}$ | $R^{D10}$ | $R^{D209}$ | $L_{C1271}$ | $R^{D55}$ | $R^{D209}$ | $L_{C1325}$ | $R^{D37}$ | $R^{D209}$ | $L_{C1379}$ | $R^{D143}$ | $R^{D209}$ |
| $L_{C1218}$ | $R^{D10}$ | $R^{D210}$ | $L_{C1272}$ | $R^{D55}$ | $R^{D210}$ | $L_{C1326}$ | $R^{D37}$ | $R^{D210}$ | $L_{C1380}$ | $R^{D143}$ | $R^{D210}$ |
| $L_{C1219}$ | $R^{D10}$ | $R^{D211}$ | $L_{C1273}$ | $R^{D55}$ | $R^{D211}$ | $L_{C1327}$ | $R^{D37}$ | $R^{D211}$ | $L_{C1381}$ | $R^{D143}$ | $R^{D211}$ |
| $L_{C1220}$ | $R^{D10}$ | $R^{D212}$ | $L_{C1274}$ | $R^{D55}$ | $R^{D212}$ | $L_{C1328}$ | $R^{D37}$ | $R^{D212}$ | $L_{C1382}$ | $R^{D143}$ | $R^{D212}$ |
| $L_{C1221}$ | $R^{D10}$ | $R^{D213}$ | $L_{C1275}$ | $R^{D55}$ | $R^{D213}$ | $L_{C1329}$ | $R^{D37}$ | $R^{D213}$ | $L_{C1383}$ | $R^{D143}$ | $R^{D213}$ |
| $L_{C1222}$ | $R^{D10}$ | $R^{D214}$ | $L_{C1276}$ | $R^{D55}$ | $R^{D214}$ | $L_{C1330}$ | $R^{D37}$ | $R^{D214}$ | $L_{C1384}$ | $R^{D143}$ | $R^{D214}$ |
| $L_{C1223}$ | $R^{D10}$ | $R^{D215}$ | $L_{C1277}$ | $R^{D55}$ | $R^{D215}$ | $L_{C1331}$ | $R^{D37}$ | $R^{D215}$ | $L_{C1385}$ | $R^{D143}$ | $R^{D215}$ |
| $L_{C1224}$ | $R^{D10}$ | $R^{D216}$ | $L_{C1278}$ | $R^{D55}$ | $R^{D216}$ | $L_{C1332}$ | $R^{D37}$ | $R^{D216}$ | $L_{C1386}$ | $R^{D143}$ | $R^{D216}$ |
| $L_{C1225}$ | $R^{D10}$ | $R^{D217}$ | $L_{C1279}$ | $R^{D55}$ | $R^{D217}$ | $L_{C1333}$ | $R^{D37}$ | $R^{D217}$ | $L_{C1387}$ | $R^{D143}$ | $R^{D217}$ |
| $L_{C1226}$ | $R^{D10}$ | $R^{D218}$ | $L_{C1280}$ | $R^{D55}$ | $R^{D218}$ | $L_{C1334}$ | $R^{D37}$ | $R^{D218}$ | $L_{C1388}$ | $R^{D143}$ | $R^{D218}$ |
| $L_{C1227}$ | $R^{D10}$ | $R^{D219}$ | $L_{C1281}$ | $R^{D55}$ | $R^{D219}$ | $L_{C1335}$ | $R^{D37}$ | $R^{D219}$ | $L_{C1389}$ | $R^{D143}$ | $R^{D219}$ |
| $L_{C1228}$ | $R^{D10}$ | $R^{D220}$ | $L_{C1282}$ | $R^{D55}$ | $R^{D220}$ | $L_{C1336}$ | $R^{D37}$ | $R^{D220}$ | $L_{C1390}$ | $R^{D143}$ | $R^{D220}$ |
| $L_{C1229}$ | $R^{D10}$ | $R^{D221}$ | $L_{C1283}$ | $R^{D55}$ | $R^{D221}$ | $L_{C1337}$ | $R^{D37}$ | $R^{D221}$ | $L_{C1391}$ | $R^{D143}$ | $R^{D221}$ |
| $L_{C1230}$ | $R^{D10}$ | $R^{D222}$ | $L_{C1284}$ | $R^{D55}$ | $R^{D222}$ | $L_{C1338}$ | $R^{D37}$ | $R^{D222}$ | $L_{C1392}$ | $R^{D143}$ | $R^{D222}$ |
| $L_{C1231}$ | $R^{D10}$ | $R^{D223}$ | $L_{C1285}$ | $R^{D55}$ | $R^{D223}$ | $L_{C1339}$ | $R^{D37}$ | $R^{D223}$ | $L_{C1393}$ | $R^{D143}$ | $R^{D223}$ |
| $L_{C1232}$ | $R^{D10}$ | $R^{D224}$ | $L_{C1286}$ | $R^{D55}$ | $R^{D224}$ | $L_{C1340}$ | $R^{D37}$ | $R^{D224}$ | $L_{C1394}$ | $R^{D143}$ | $R^{D224}$ |

| $L_{Ci}$ | $R^{201}$ | $R^{202}$ | $L_{Ci}$ | $R^{201}$ | $R^{202}$ | $L_{Ci}$ | $R^{201}$ | $R^{202}$ | $L_{Ci}$ | $R^{201}$ | $R^{202}$ |
|---|---|---|---|---|---|---|---|---|---|---|---|
| $L_{C1233}$ | $R^{D10}$ | $R^{D225}$ | $L_{C1287}$ | $R^{D55}$ | $R^{D225}$ | $L_{C1341}$ | $R^{D37}$ | $R^{D225}$ | $L_{C1395}$ | $R^{D143}$ | $R^{D225}$ |
| $L_{C1234}$ | $R^{D10}$ | $R^{D226}$ | $L_{C1288}$ | $R^{D55}$ | $R^{D226}$ | $L_{C1342}$ | $R^{D37}$ | $R^{D226}$ | $L_{C1396}$ | $R^{D143}$ | $R^{D226}$ |
| $L_{C1235}$ | $R^{D10}$ | $R^{D227}$ | $L_{C1289}$ | $R^{D55}$ | $R^{D227}$ | $L_{C1343}$ | $R^{D37}$ | $R^{D227}$ | $L_{C1397}$ | $R^{D143}$ | $R^{D227}$ |
| $L_{C1236}$ | $R^{D10}$ | $R^{D228}$ | $L_{C1290}$ | $R^{D55}$ | $R^{D228}$ | $L_{C1344}$ | $R^{D37}$ | $R^{D228}$ | $L_{C1398}$ | $R^{D143}$ | $R^{D228}$ |
| $L_{C1237}$ | $R^{D10}$ | $R^{D229}$ | $L_{C1291}$ | $R^{D55}$ | $R^{D229}$ | $L_{C1345}$ | $R^{D37}$ | $R^{D229}$ | $L_{C1399}$ | $R^{D143}$ | $R^{D229}$ |
| $L_{C1238}$ | $R^{D10}$ | $R^{D230}$ | $L_{C1292}$ | $R^{D55}$ | $R^{D230}$ | $L_{C1346}$ | $R^{D37}$ | $R^{D230}$ | $L_{C1400}$ | $R^{D143}$ | $R^{D230}$ |
| $L_{C1239}$ | $R^{D10}$ | $R^{D231}$ | $L_{C1293}$ | $R^{D55}$ | $R^{D231}$ | $L_{C1347}$ | $R^{D37}$ | $R^{D231}$ | $L_{C1401}$ | $R^{D143}$ | $R^{D231}$ |
| $L_{C1240}$ | $R^{D10}$ | $R^{D232}$ | $L_{C1294}$ | $R^{D55}$ | $R^{D232}$ | $L_{C1348}$ | $R^{D37}$ | $R^{D232}$ | $L_{C1402}$ | $R^{D143}$ | $R^{D232}$ |
| $L_{C1241}$ | $R^{D10}$ | $R^{D233}$ | $L_{C1295}$ | $R^{D55}$ | $R^{D233}$ | $L_{C1349}$ | $R^{D37}$ | $R^{D233}$ | $L_{C1403}$ | $R^{D143}$ | $R^{D233}$ |
| $L_{C1242}$ | $R^{D10}$ | $R^{D234}$ | $L_{C1296}$ | $R^{D55}$ | $R^{D234}$ | $L_{C1350}$ | $R^{D37}$ | $R^{D234}$ | $L_{C1404}$ | $R^{D143}$ | $R^{D234}$ |
| $L_{C1243}$ | $R^{D10}$ | $R^{D235}$ | $L_{C1297}$ | $R^{D55}$ | $R^{D235}$ | $L_{C1351}$ | $R^{D37}$ | $R^{D235}$ | $L_{C1405}$ | $R^{D143}$ | $R^{D235}$ |
| $L_{C1244}$ | $R^{D10}$ | $R^{D236}$ | $L_{C1298}$ | $R^{D55}$ | $R^{D236}$ | $L_{C1352}$ | $R^{D37}$ | $R^{D236}$ | $L_{C1406}$ | $R^{D143}$ | $R^{D236}$ |
| $L_{C1245}$ | $R^{D10}$ | $R^{D237}$ | $L_{C1299}$ | $R^{D55}$ | $R^{D237}$ | $L_{C1353}$ | $R^{D37}$ | $R^{D237}$ | $L_{C1407}$ | $R^{D143}$ | $R^{D237}$ |
| $L_{C1246}$ | $R^{D10}$ | $R^{D238}$ | $L_{C1300}$ | $R^{D55}$ | $R^{D238}$ | $L_{C1354}$ | $R^{D37}$ | $R^{D238}$ | $L_{C1408}$ | $R^{D143}$ | $R^{D238}$ |
| $L_{C1247}$ | $R^{D10}$ | $R^{D239}$ | $L_{C1301}$ | $R^{D55}$ | $R^{D239}$ | $L_{C1355}$ | $R^{D37}$ | $R^{D239}$ | $L_{C1409}$ | $R^{D143}$ | $R^{D239}$ |
| $L_{C1248}$ | $R^{D10}$ | $R^{D240}$ | $L_{C1302}$ | $R^{D55}$ | $R^{D240}$ | $L_{C1356}$ | $R^{D37}$ | $R^{D240}$ | $L_{C1410}$ | $R^{D143}$ | $R^{D240}$ |
| $L_{C1249}$ | $R^{D10}$ | $R^{D241}$ | $L_{C1303}$ | $R^{D55}$ | $R^{D241}$ | $L_{C1357}$ | $R^{D37}$ | $R^{D241}$ | $L_{C1411}$ | $R^{D143}$ | $R^{D241}$ |
| $L_{C1250}$ | $R^{D10}$ | $R^{D242}$ | $L_{C1304}$ | $R^{D55}$ | $R^{D242}$ | $L_{C1358}$ | $R^{D37}$ | $R^{D242}$ | $L_{C1412}$ | $R^{D143}$ | $R^{D242}$ |
| $L_{C1251}$ | $R^{D10}$ | $R^{D243}$ | $L_{C1305}$ | $R^{D55}$ | $R^{D243}$ | $L_{C1359}$ | $R^{D37}$ | $R^{D243}$ | $L_{C1413}$ | $R^{D143}$ | $R^{D243}$ |
| $L_{C1252}$ | $R^{D10}$ | $R^{D244}$ | $L_{C1306}$ | $R^{D55}$ | $R^{D244}$ | $L_{C1360}$ | $R^{D37}$ | $R^{D244}$ | $L_{C1414}$ | $R^{D143}$ | $R^{D244}$ |
| $L_{C1253}$ | $R^{D10}$ | $R^{D245}$ | $L_{C1307}$ | $R^{D55}$ | $R^{D245}$ | $L_{C1361}$ | $R^{D37}$ | $R^{D245}$ | $L_{C1415}$ | $R^{D143}$ | $R^{D245}$ |
| $L_{C1254}$ | $R^{D10}$ | $R^{D246}$ | $L_{C1308}$ | $R^{D55}$ | $R^{D246}$ | $L_{C1362}$ | $R^{D37}$ | $R^{D246}$ | $L_{C1416}$ | $R^{D143}$ | $R^{D246}$ |

wherein $R^{D1}$ to $R^{D246}$ have the structures defined in the following LIST 9:

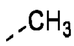
$R^{D1}$,
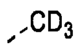
$R^{D2}$,

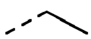
$R^{D3}$,
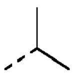
$R^{D4}$,
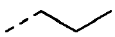
$R^{D5}$,
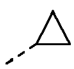
$R^{D6}$,
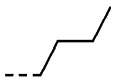
$R^{D7}$,
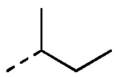
$R^{D8}$,
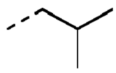
$R^{D9}$,
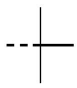
$R^{D10}$,
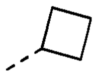
$R^{D11}$,
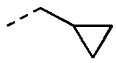
$R^{D12}$,

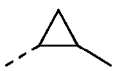
$R^{D13}$,
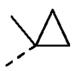
$R^{D14}$,
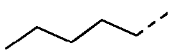
$R^{D15}$,
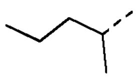
$R^{D16}$,
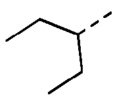
$R^{D17}$,
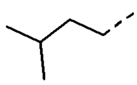
$R^{D18}$,
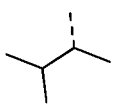
$R^{D19}$,
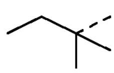
$R^{D20}$,

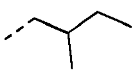
$R^{D21}$,
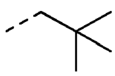
$R^{D22}$,
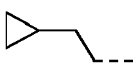
$R^{D23}$,
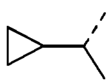
$R^{D24}$,
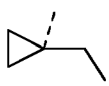
$R^{D25}$,
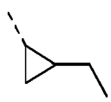
$R^{D26}$,
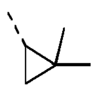
$R^{D27}$,
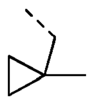
$R^{D28}$,

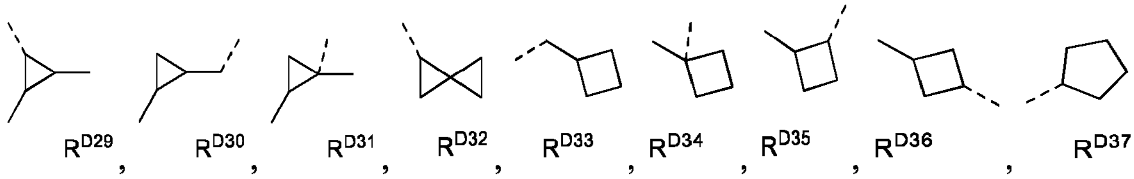
$R^{D29}$, $R^{D30}$, $R^{D31}$, $R^{D32}$, $R^{D33}$, $R^{D34}$, $R^{D35}$, $R^{D36}$, $R^{D37}$,

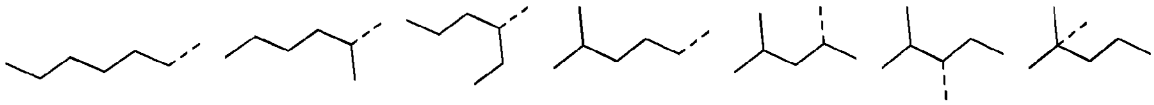
$R^{D38}$, $R^{D39}$, $R^{D40}$, $R^{D41}$, $R^{D42}$, $R^{D43}$, $R^{D44}$,

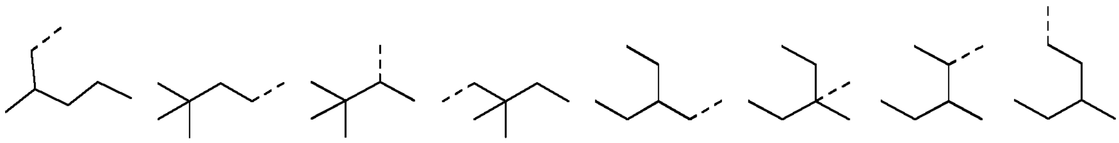
$R^{D45}$, $R^{D46}$, $R^{D47}$, $R^{D48}$, $R^{D49}$, $R^{D50}$, $R^{D51}$, $R^{D52}$,

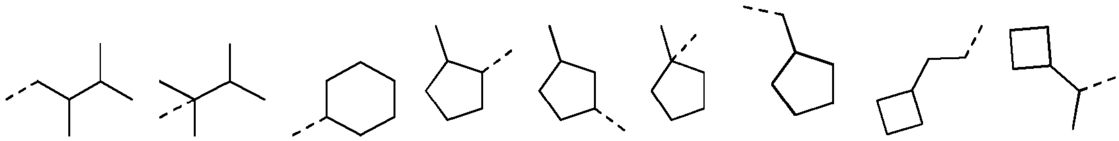
$R^{D53}$, $R^{D54}$, $R^{D55}$, $R^{D56}$, $R^{D57}$, $R^{D58}$, $R^{D59}$, $R^{D60}$, $R^{D61}$,

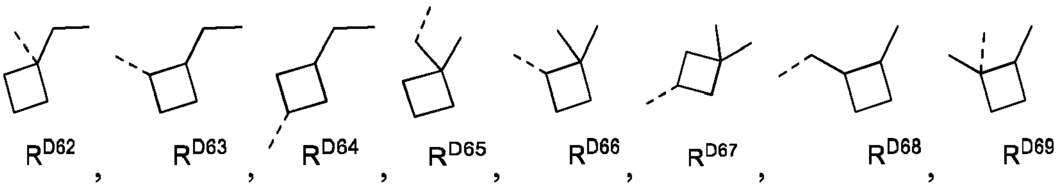
$R^{D62}$, $R^{D63}$, $R^{D64}$, $R^{D65}$, $R^{D66}$, $R^{D67}$, $R^{D68}$, $R^{D69}$,

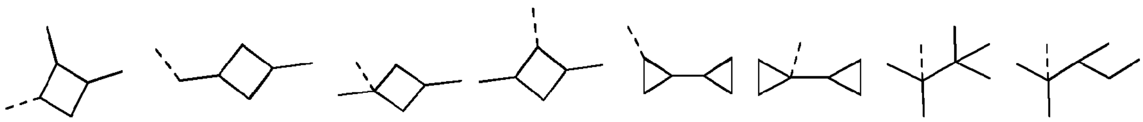
$R^{D70}$, $R^{D71}$, $R^{D72}$, $R^{D73}$, $R^{D74}$, $R^{D75}$, $R^{D76}$, $R^{D77}$,

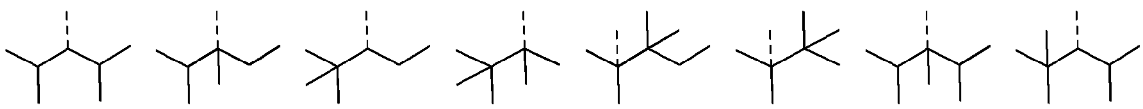
$R^{D78}$, $R^{D79}$, $R^{D80}$, $R^{D81}$, $R^{D82}$, $R^{D83}$, $R^{D84}$, $R^{D85}$,

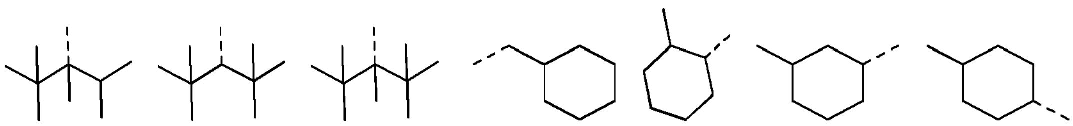
$R^{D86}$, $R^{D87}$, $R^{D88}$, $R^{D89}$, $R^{D90}$, $R^{D91}$, $R^{D92}$,

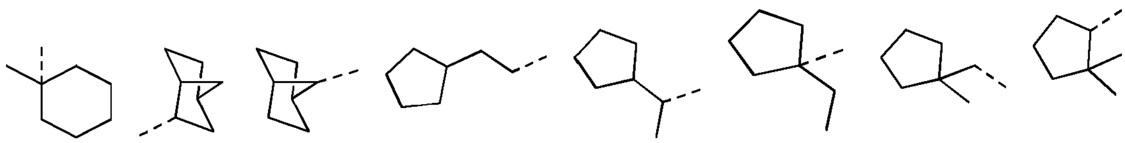

$R^{D93}$, $R^{D94}$, $R^{D95}$, $R^{D96}$, $R^{D97}$, $R^{D98}$, $R^{D99}$, $R^{D100}$,

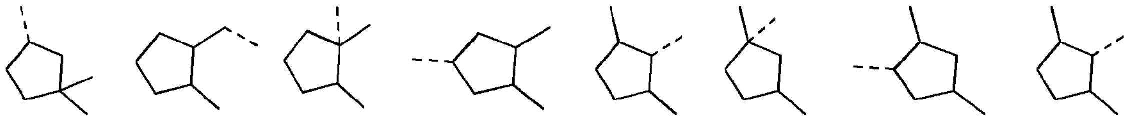

$R^{D101}$, $R^{D102}$, $R^{D103}$, $R^{D104}$, $R^{D105}$, $R^{D106}$, $R^{D107}$, $R^{D108}$,

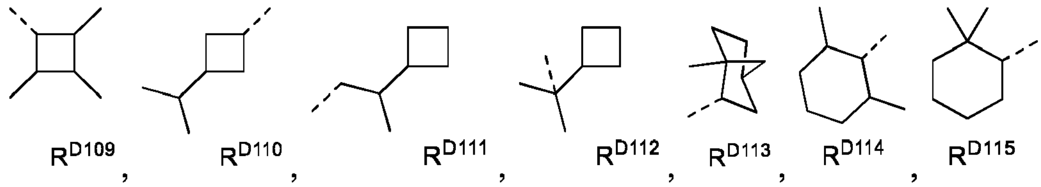

$R^{D109}$, $R^{D110}$, $R^{D111}$, $R^{D112}$, $R^{D113}$, $R^{D114}$, $R^{D115}$,

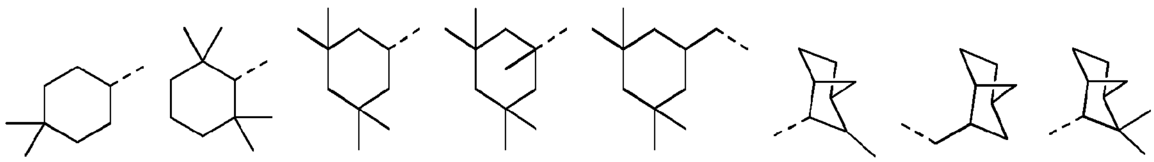

$R^{D116}$, $R^{D117}$, $R^{D118}$, $R^{D119}$, $R^{D120}$, $R^{D121}$, $R^{D122}$, $R^{D123}$

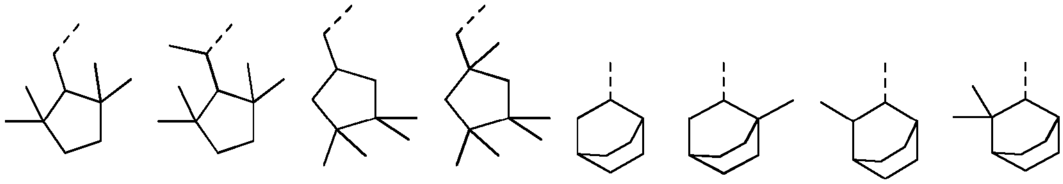

, $R^{D124}$, $R^{D125}$, $R^{D126}$, $R^{D127}$, $R^{D128}$, $R^{D129}$, $R^{D130}$, $R^{D131}$,

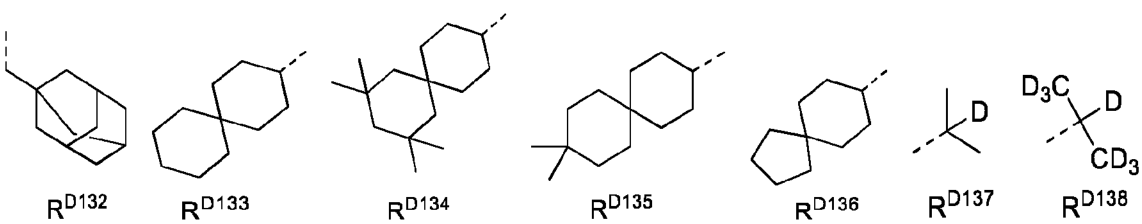

$R^{D132}$, $R^{D133}$, $R^{D134}$, $R^{D135}$, $R^{D136}$, $R^{D137}$, $R^{D138}$,

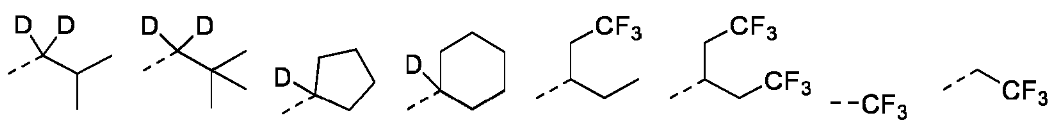

$R^{D139}$, $R^{D140}$, $R^{D141}$, $R^{D142}$, $R^{D143}$, $R^{D144}$, $R^{D145}$, $R^{D146}$,

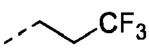 $R^{D147}$, 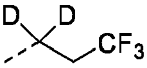 $R^{D148}$, 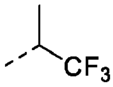 $R^{D149}$, 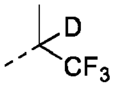 $R^{D150}$, 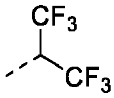 $R^{D151}$, 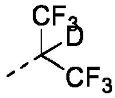 $R^{D152}$, 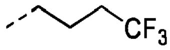 $R^{D153}$,

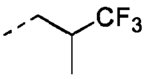 $R^{D154}$, 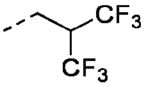 $R^{D155}$, 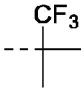 $R^{D156}$, 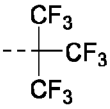 $R^{D157}$, 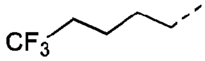 $R^{D158}$, 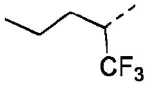 $R^{D159}$, 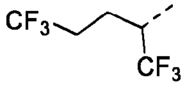 $R^{D160}$,

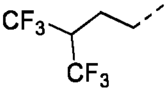 $R^{D161}$, 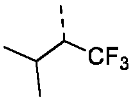 $R^{D162}$, 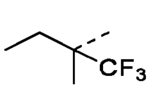 $R^{D163}$, 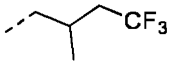 $R^{D164}$, 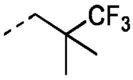 $R^{D165}$, 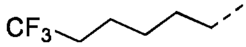 $R^{D166}$,

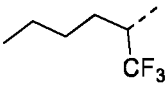 $R^{D167}$, 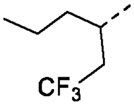 $R^{D168}$, 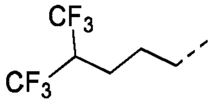 $R^{D169}$, 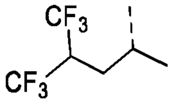 $R^{D170}$, 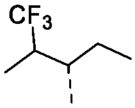 $R^{D171}$, 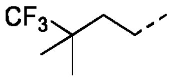 $R^{D172}$,

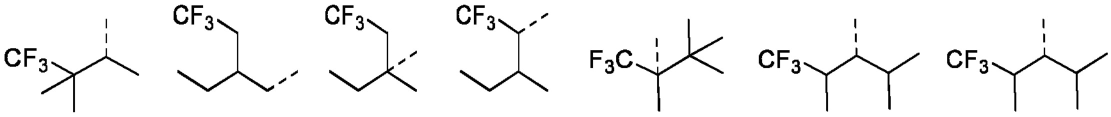 $R^{D173}$, $R^{D174}$, $R^{D175}$, $R^{D176}$, $R^{D177}$, $R^{D178}$, $R^{D179}$,

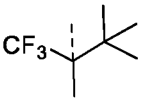 $R^{D180}$, 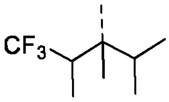 $R^{D181}$, 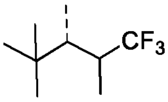 $R^{D182}$, 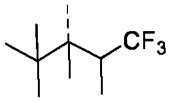 $R^{D183}$, 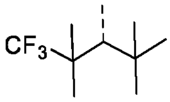 $R^{D184}$, 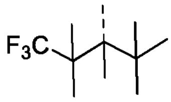 $R^{D185}$,

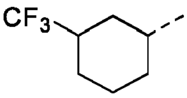 $R^{D186}$, 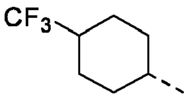 $R^{D187}$, 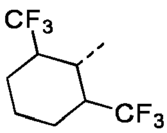 $R^{D188}$, 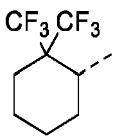 $R^{D189}$, 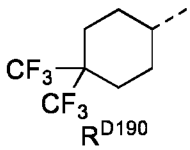 $R^{D190}$, 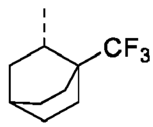 $R^{D191}$,

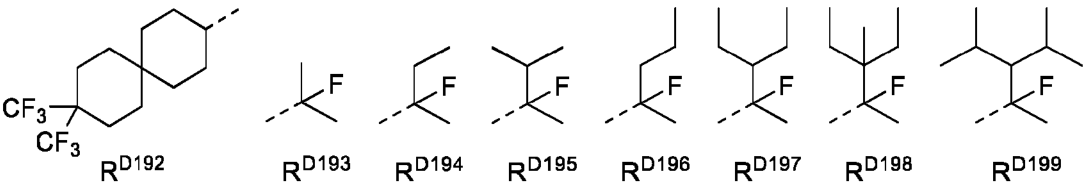 $R^{D192}$, $R^{D193}$, $R^{D194}$, $R^{D195}$, $R^{D196}$, $R^{D197}$, $R^{D198}$, $R^{D199}$,

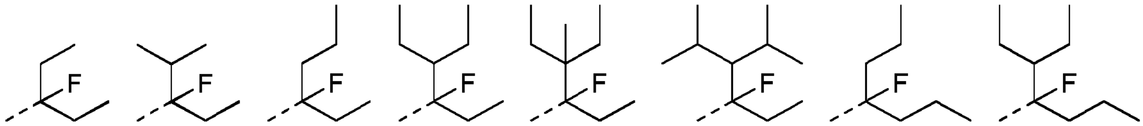

$R^{D200}$, $R^{D201}$, $R^{D202}$, $R^{D203}$, $R^{D204}$, $R^{D205}$, $R^{D206}$, $R^{D207}$,

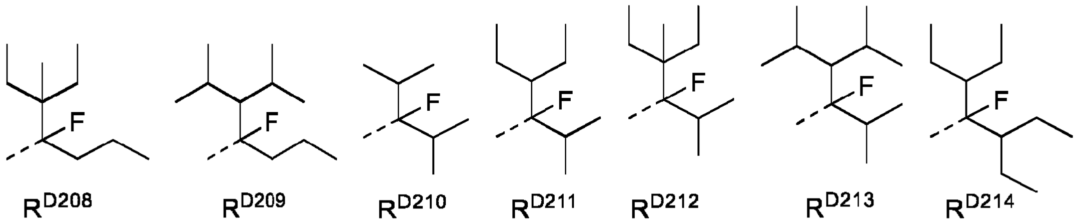

$R^{D208}$, $R^{D209}$, $R^{D210}$, $R^{D211}$, $R^{D212}$, $R^{D213}$, $R^{D214}$,

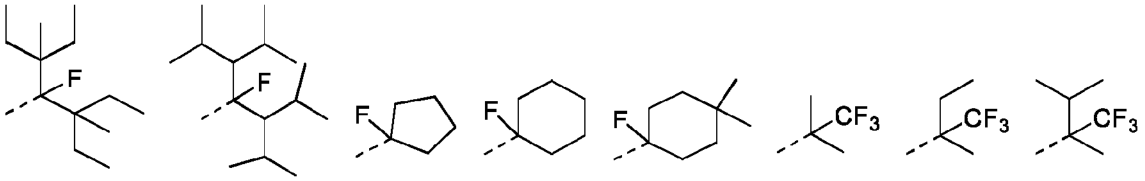

$R^{D215}$, $R^{D216}$, $R^{D217}$, $R^{D218}$, $R^{D219}$, $R^{D220}$, $R^{D221}$, $R^{D222}$,

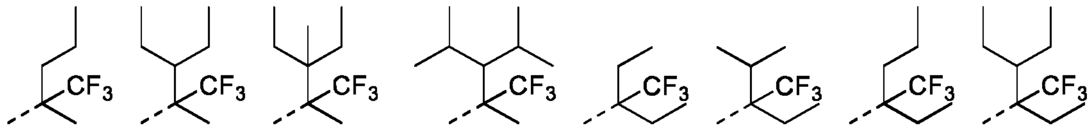

$R^{D223}$, $R^{D224}$, $R^{D225}$, $R^{D226}$, $R^{D227}$, $R^{D228}$, $R^{D229}$, $R^{D230}$,

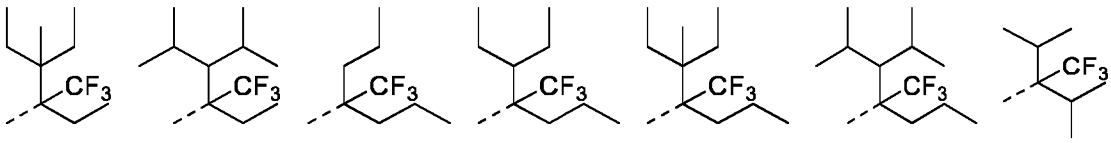

$R^{D231}$, $R^{D232}$, $R^{D233}$, $R^{D234}$, $R^{D235}$, $R^{D236}$, $R^{D237}$,

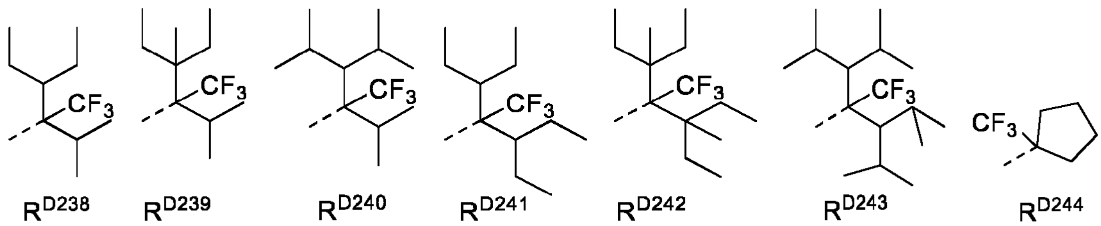

$R^{D238}$, $R^{D239}$, $R^{D240}$, $R^{D241}$, $R^{D242}$, $R^{D243}$, $R^{D244}$,

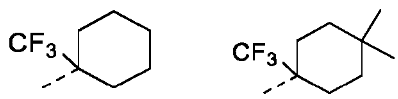

$R^{D245}$, and $R^{D246}$.

**12.** The compound of clam 1, wherein the compound is selected from the group consisting of:

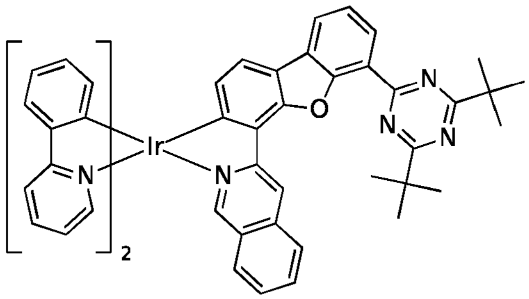

,

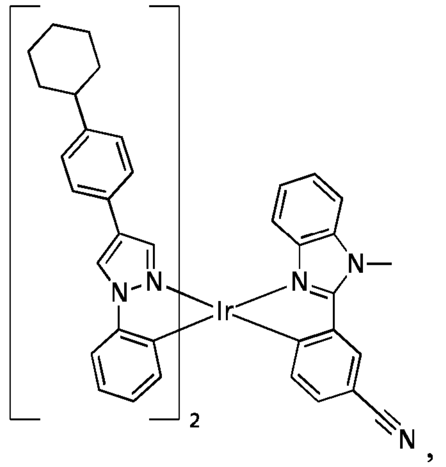

,

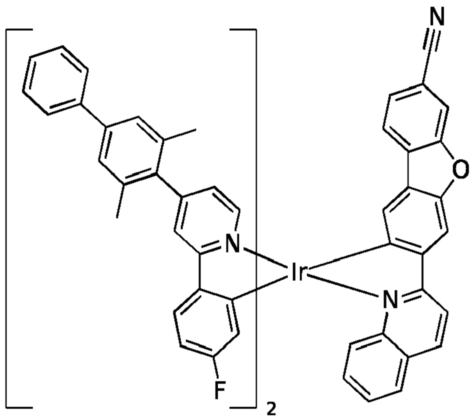

,

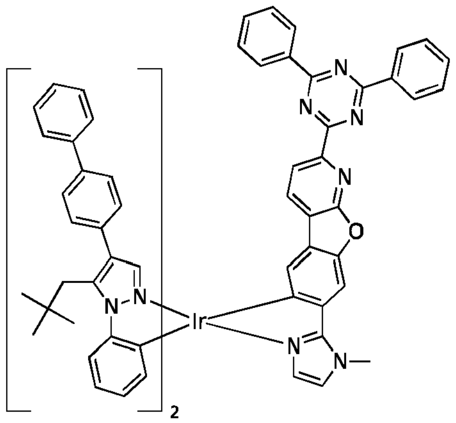

,

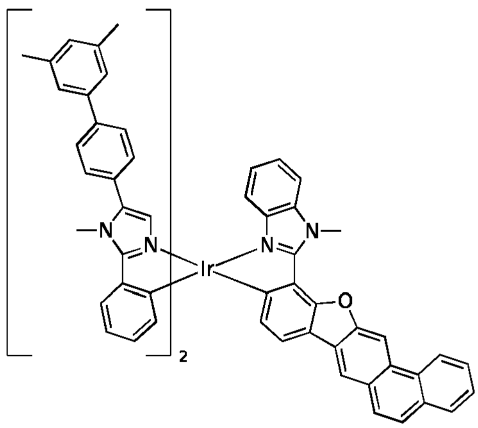

,

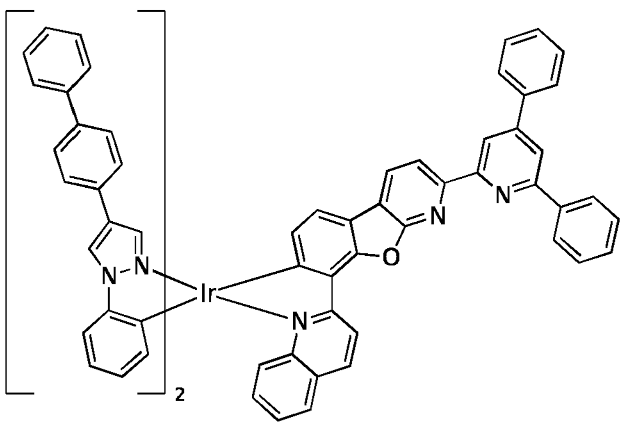

,

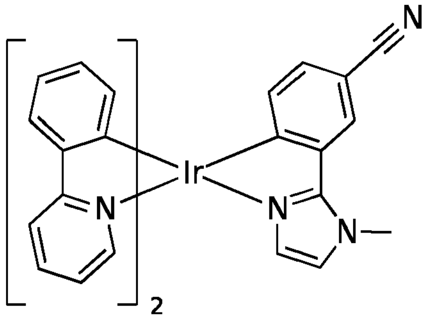

,

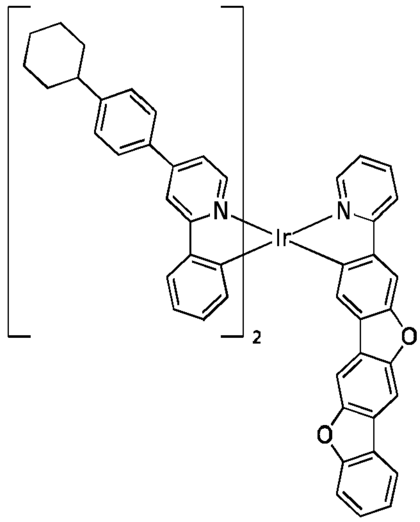

,

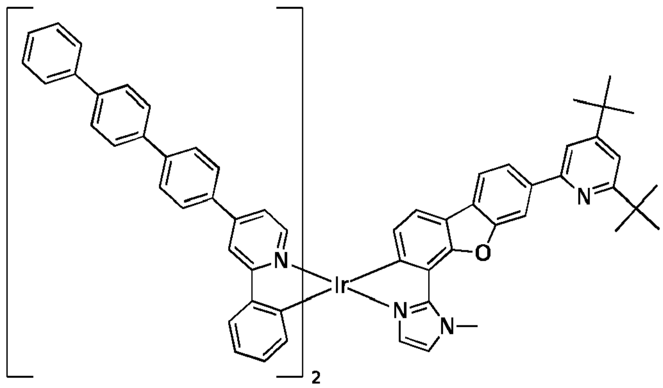

,

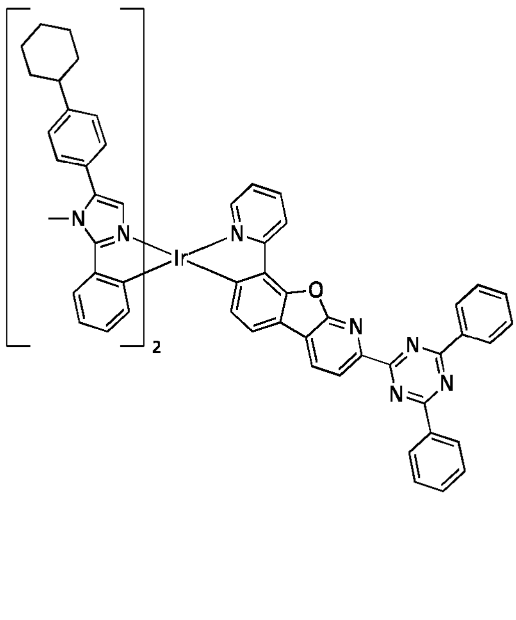

,

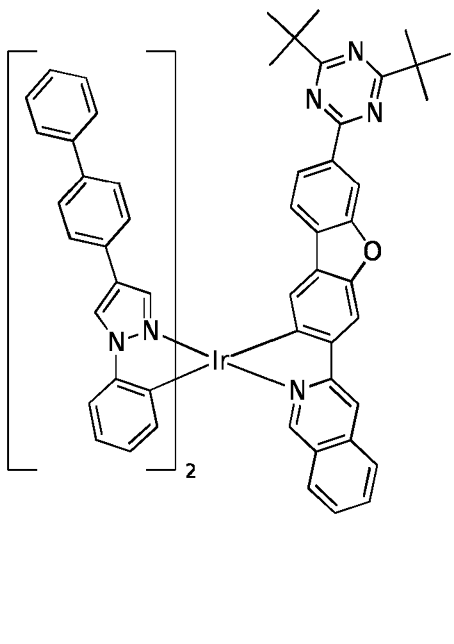

,

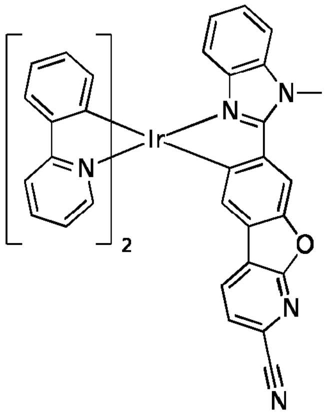,
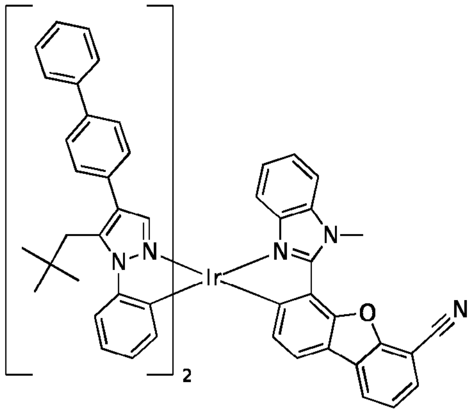,

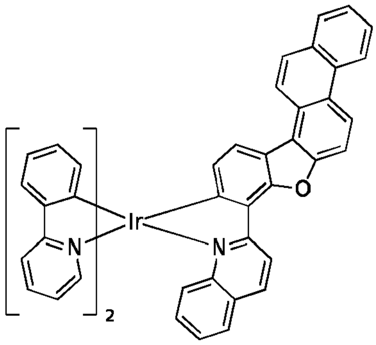,
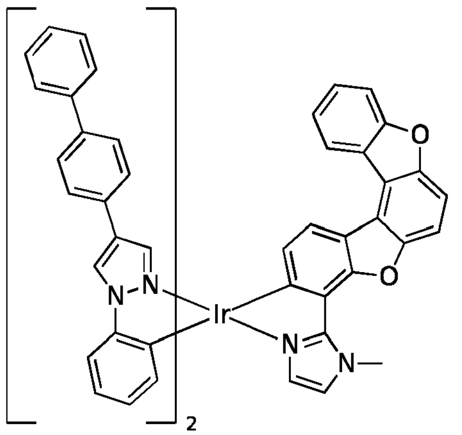,

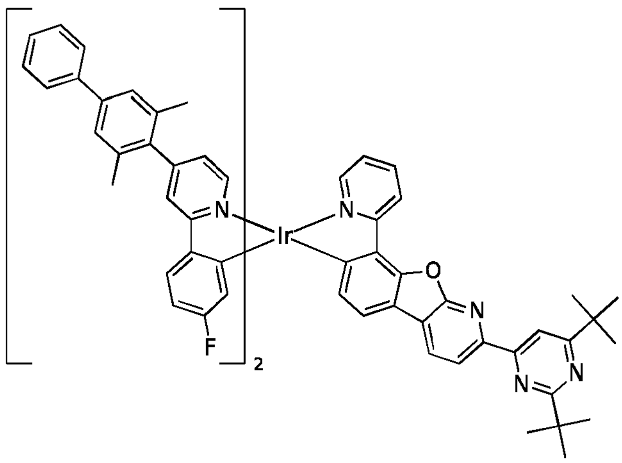,
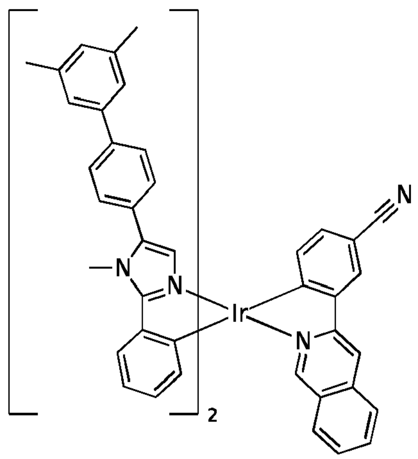,

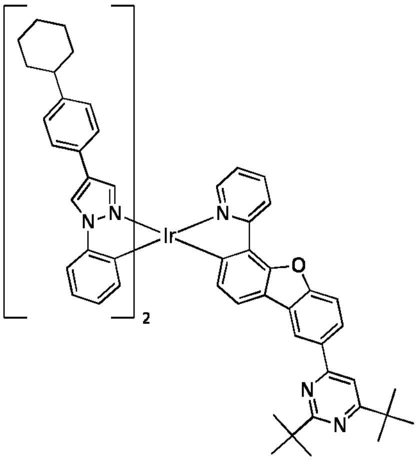

,

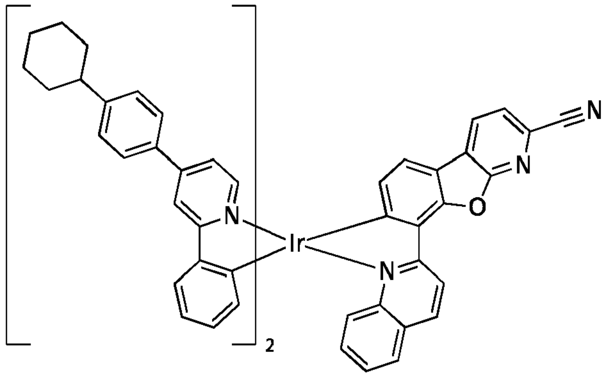

,

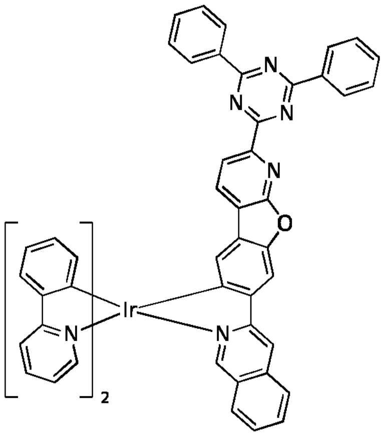

,

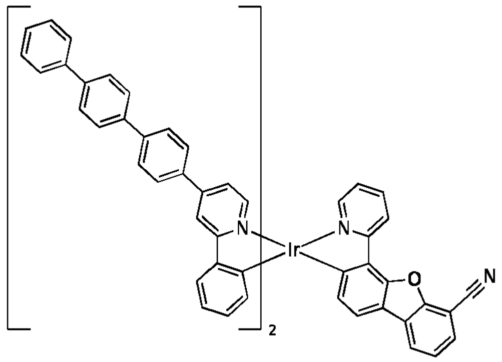

,

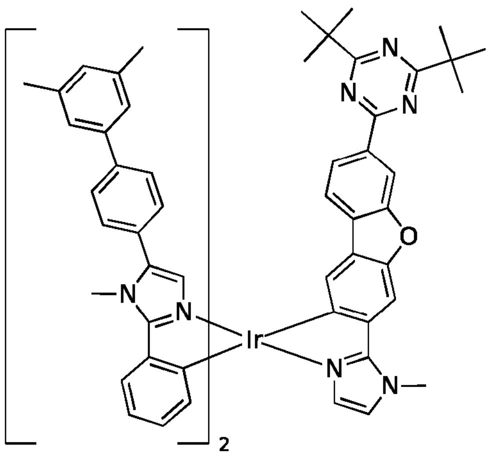

,

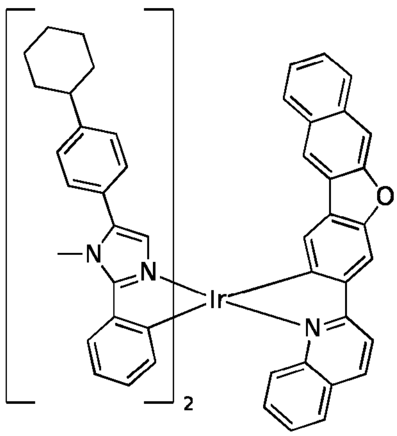

,

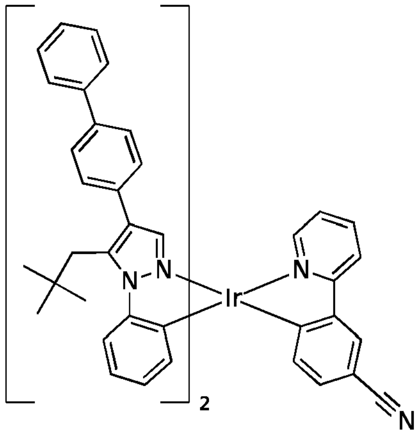, 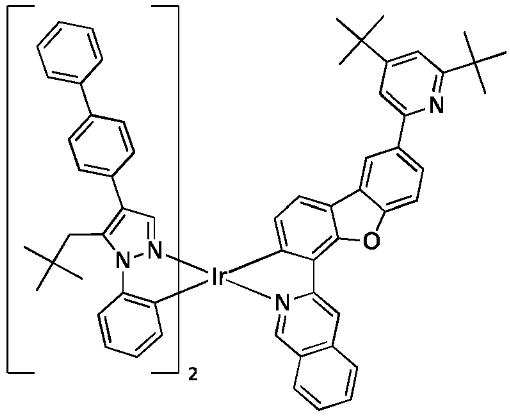,

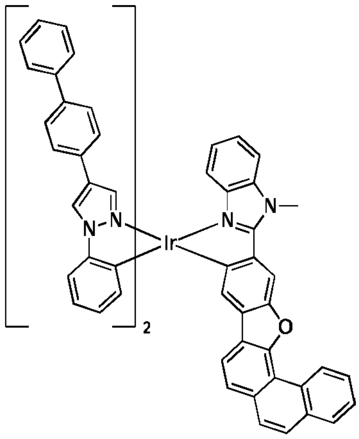, 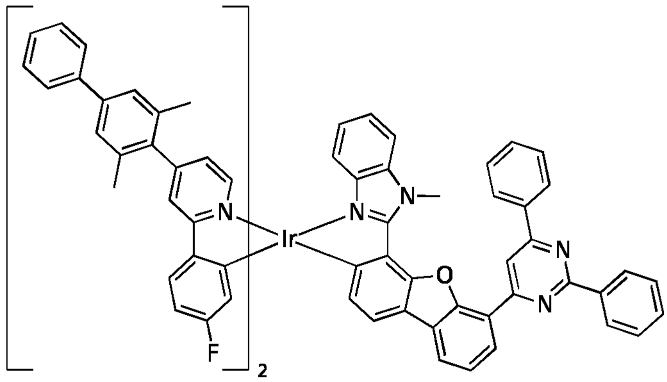,

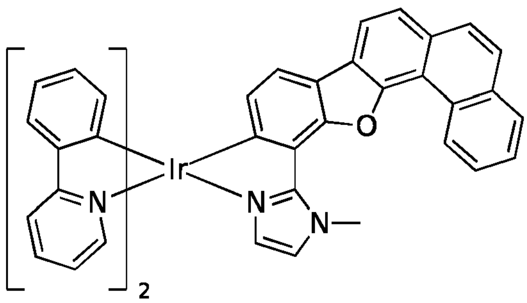, 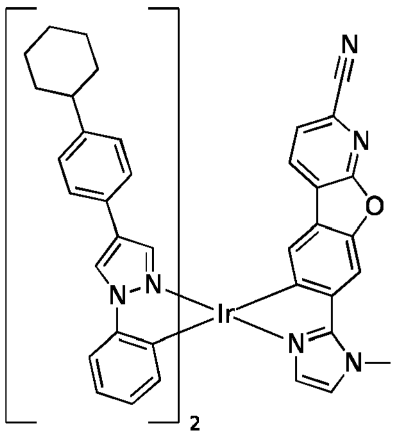,

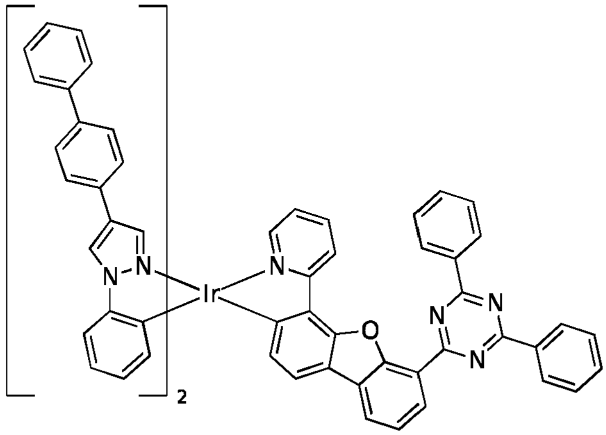

,

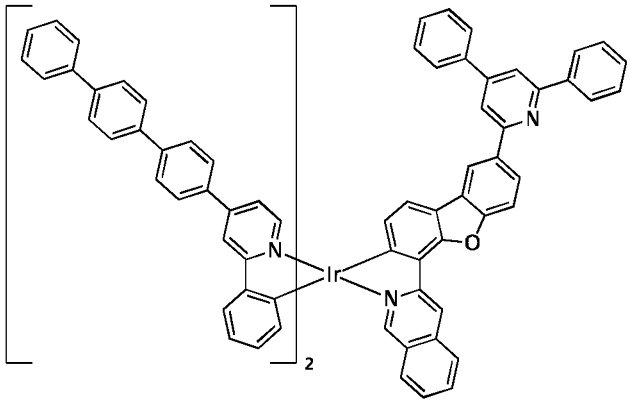

,

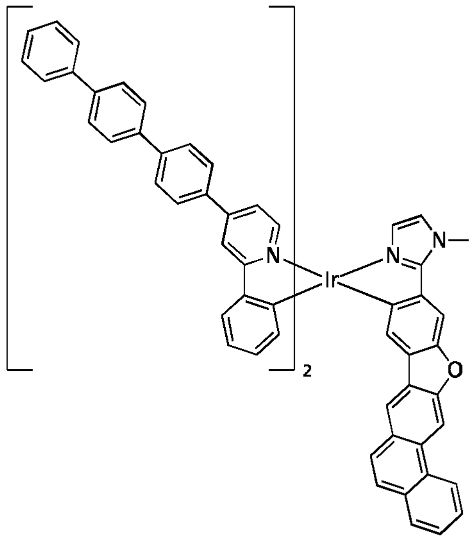

,

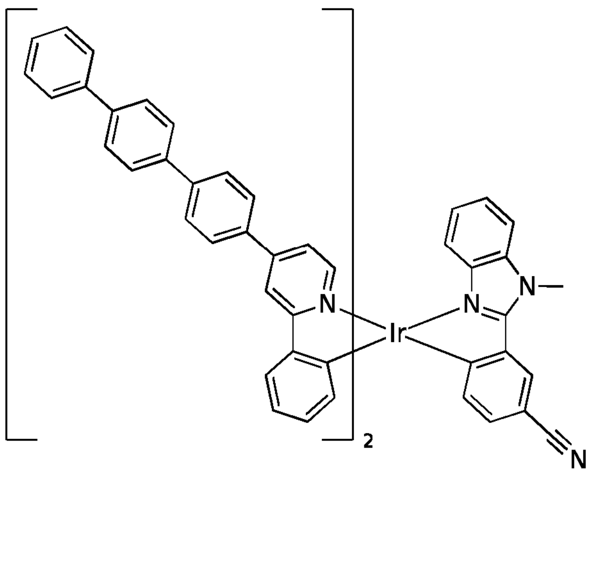

,

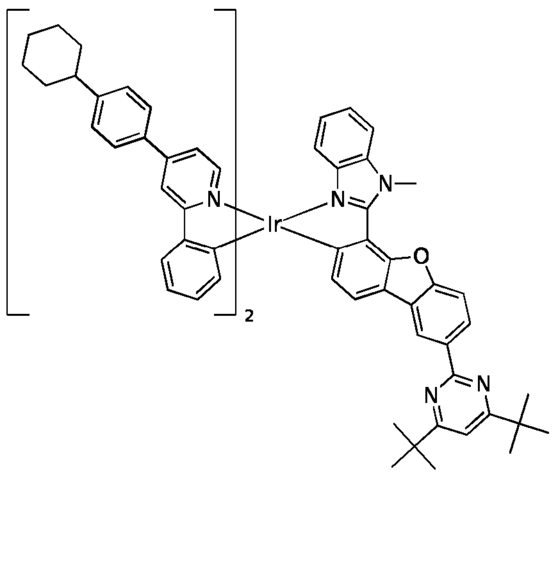

,

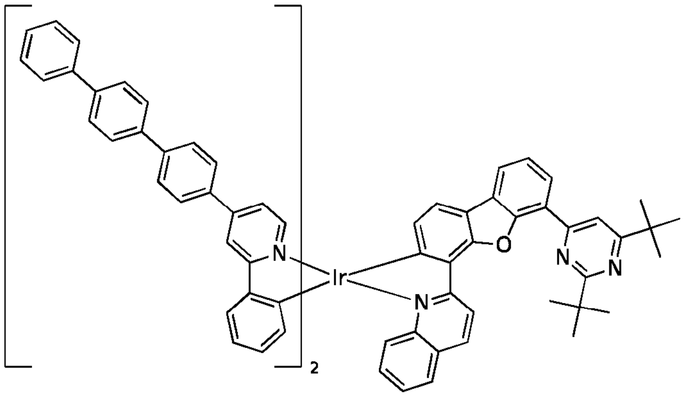

,

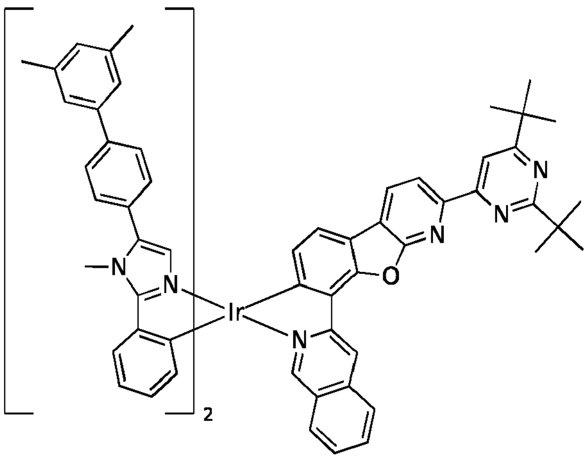

,

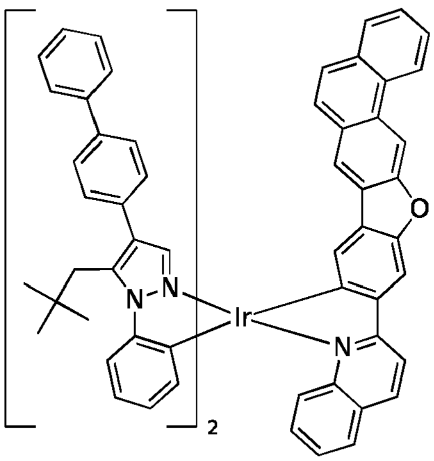

,

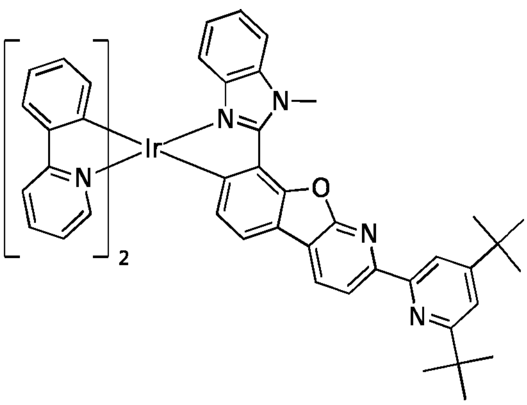

,

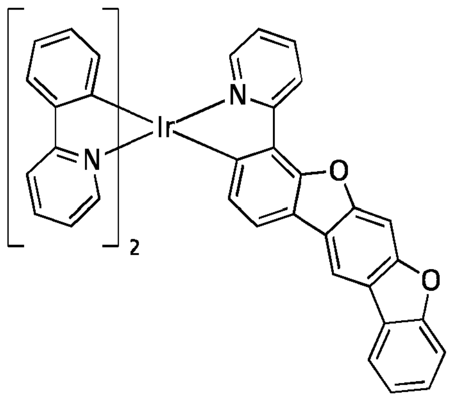

,

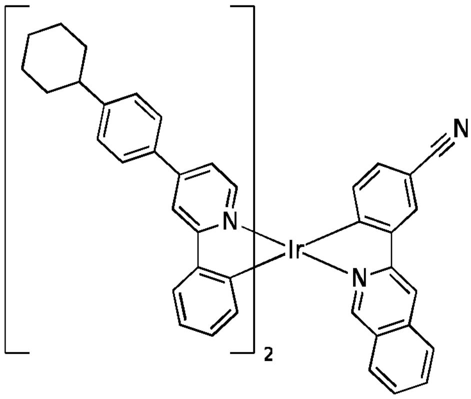

,

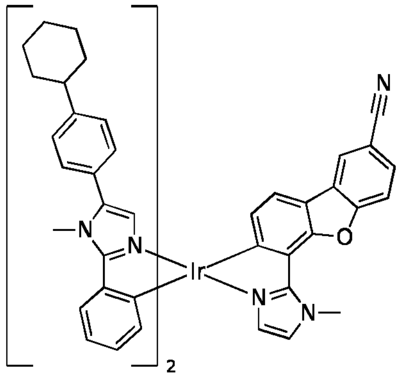

,

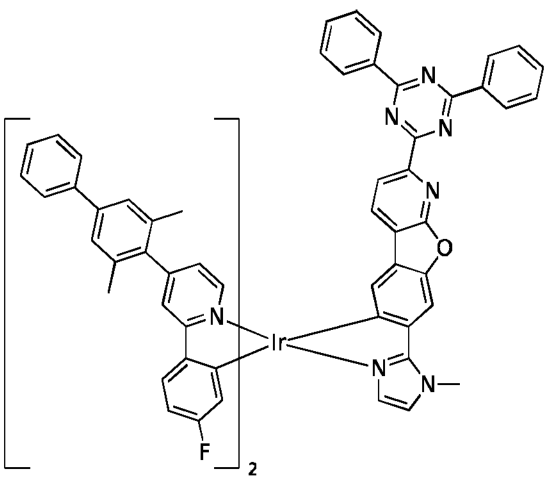

,

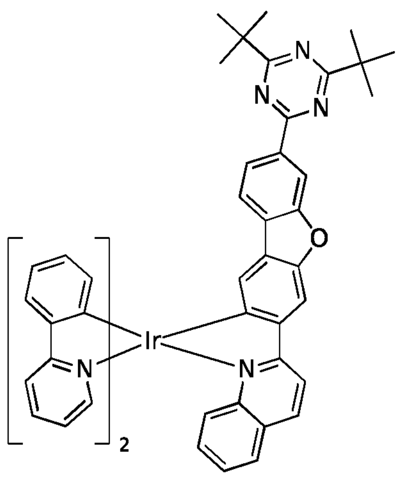

,

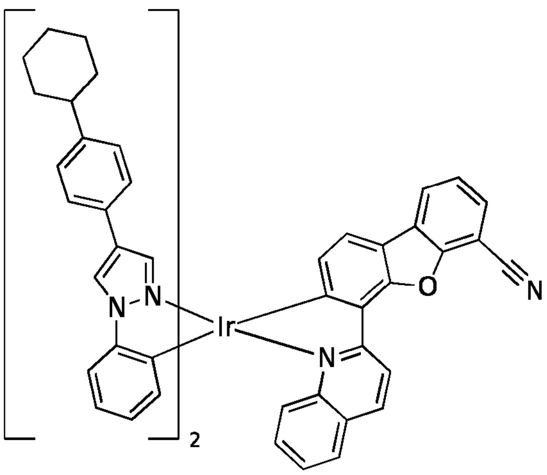

,

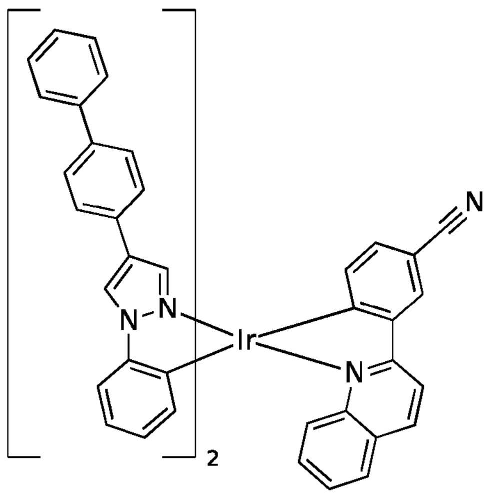

,

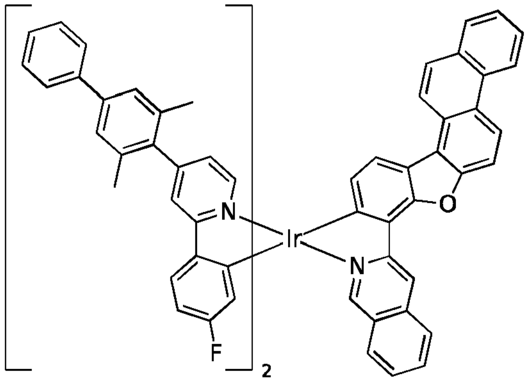

,

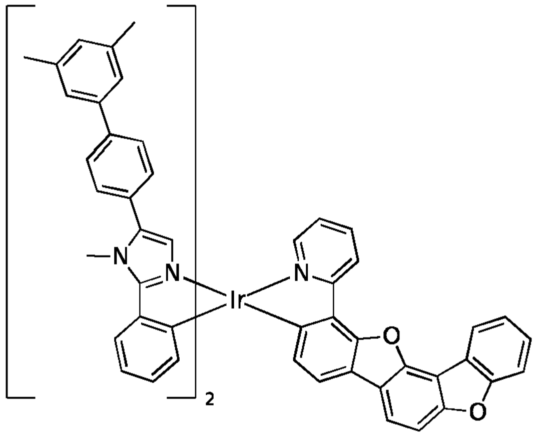

,

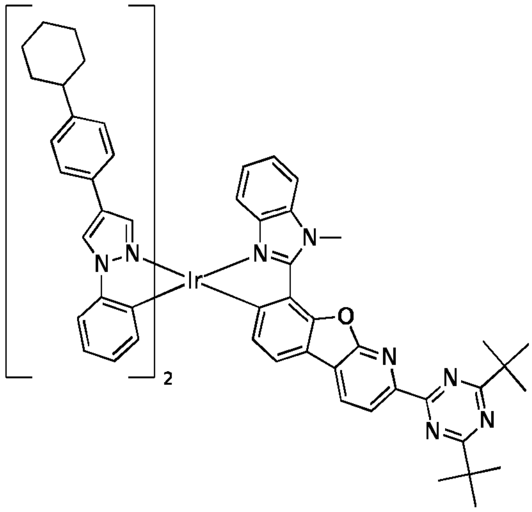

,

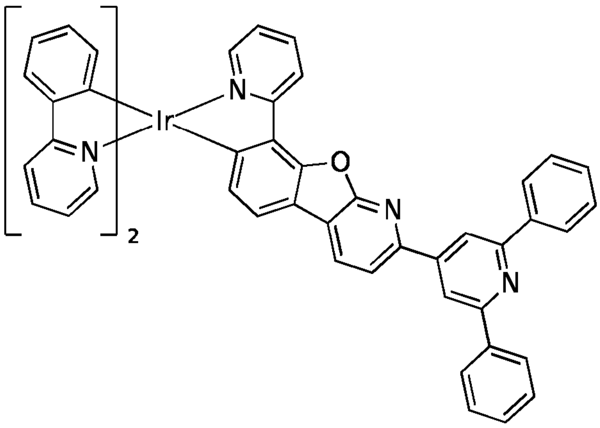

,

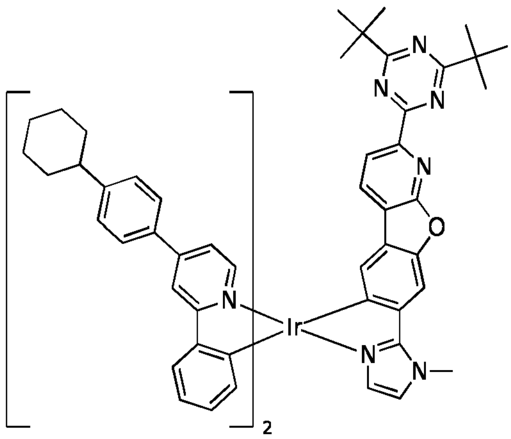

,

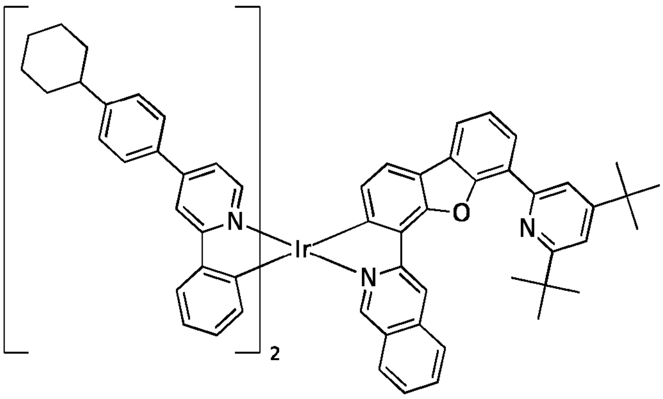

,

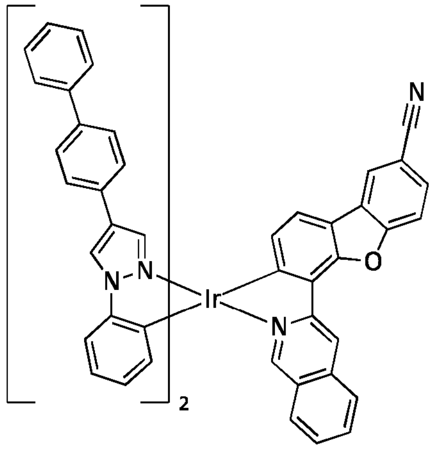

,

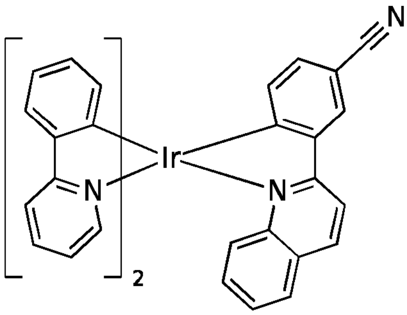

,

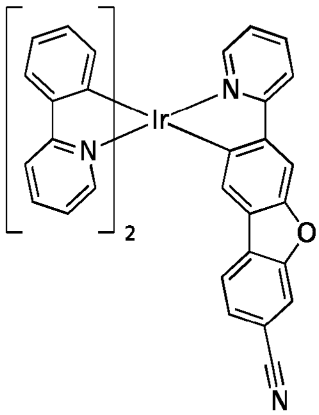

,

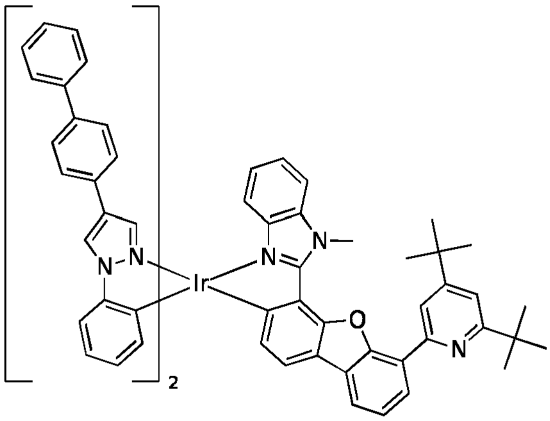

,

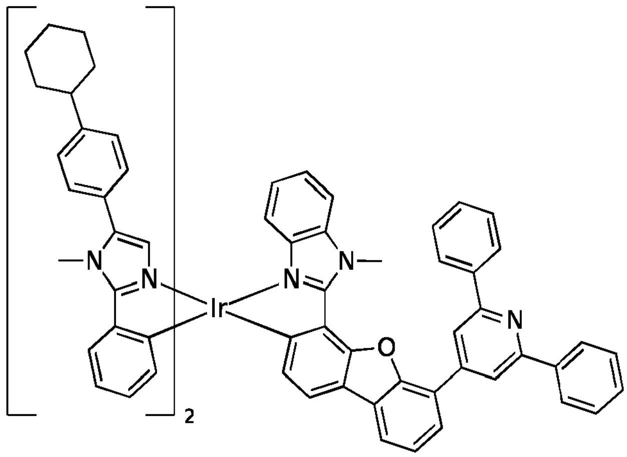,
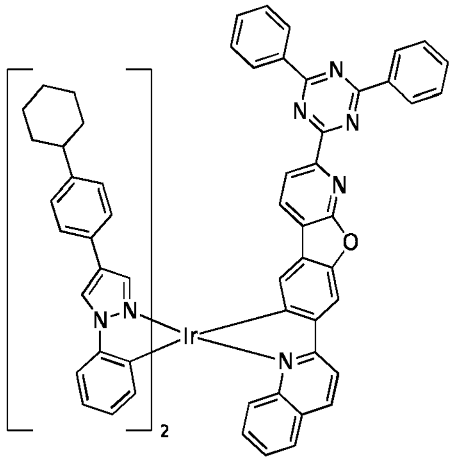,

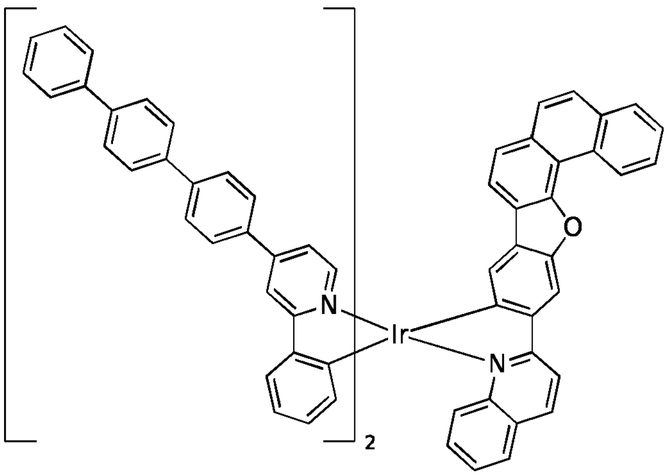,
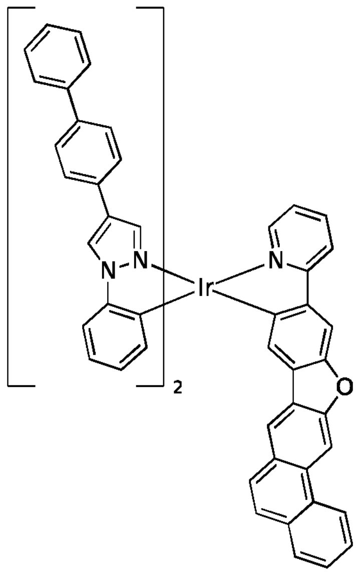,

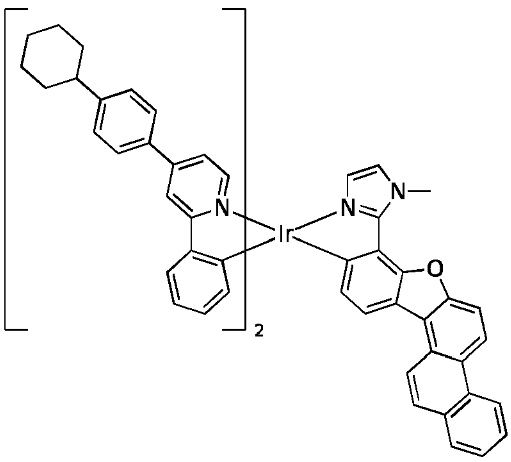,
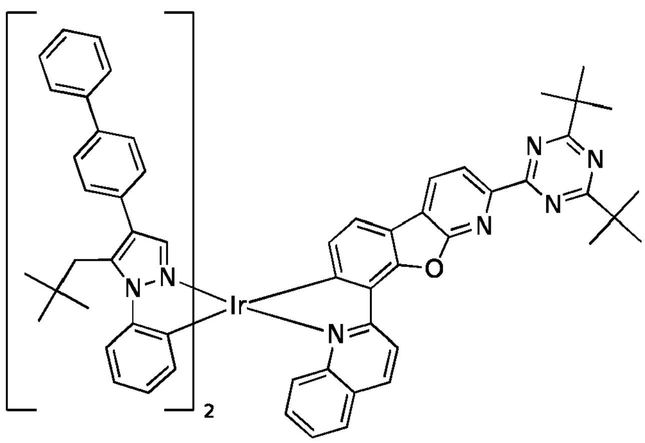,

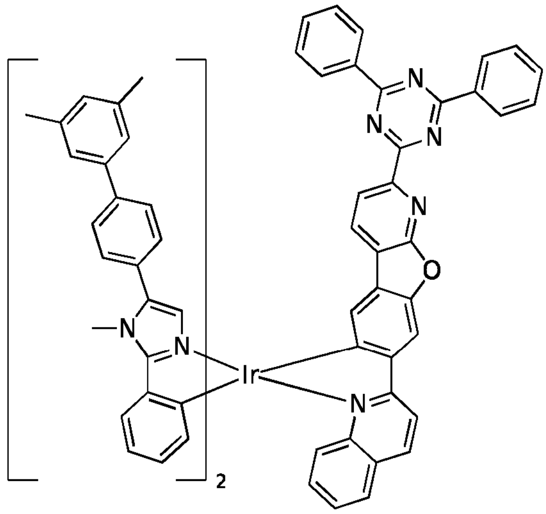

,

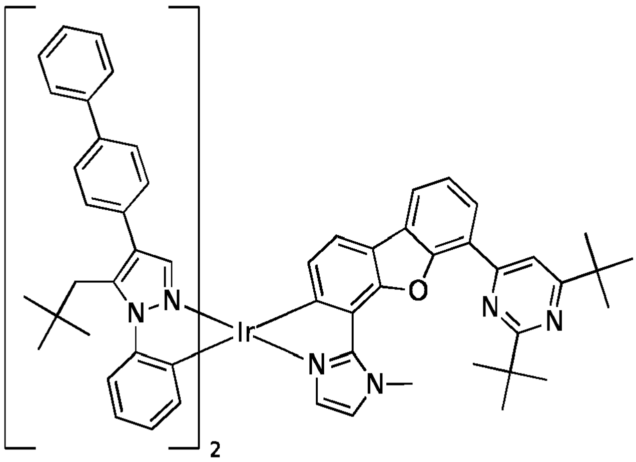

,

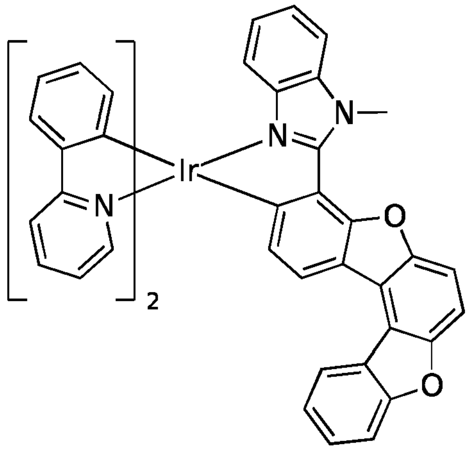

,

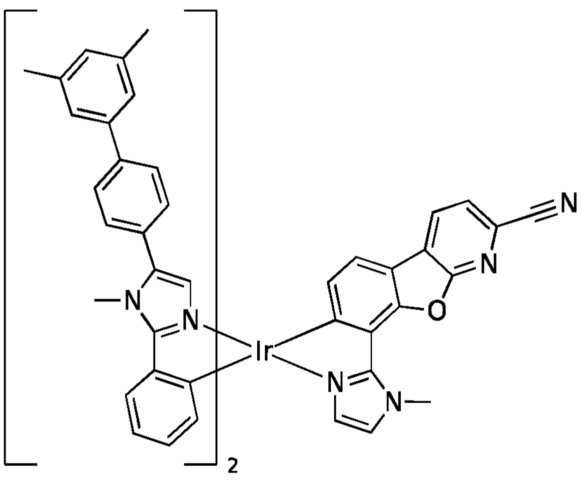

,

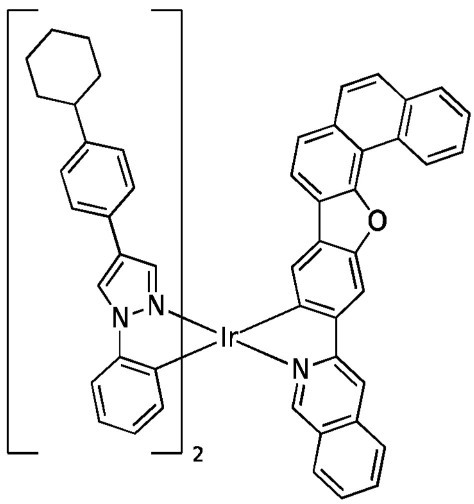

,

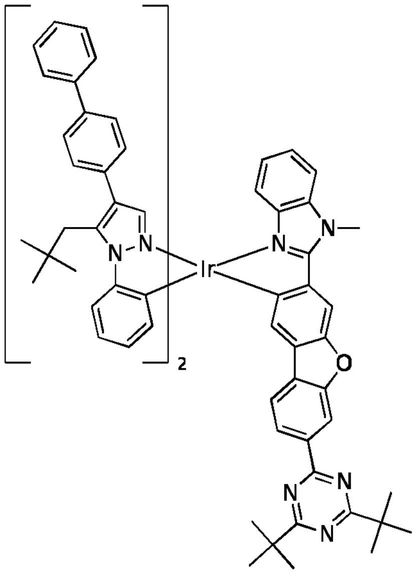

,

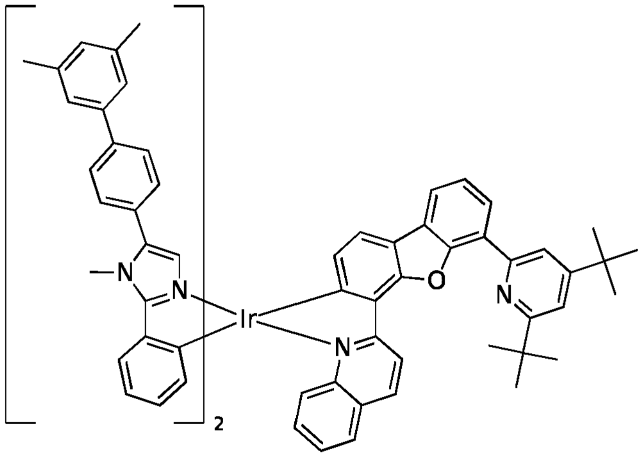

,

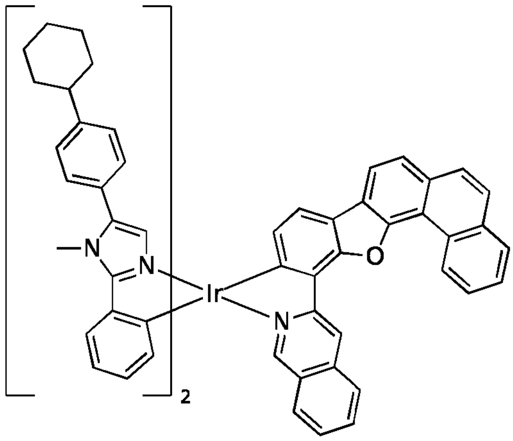

,

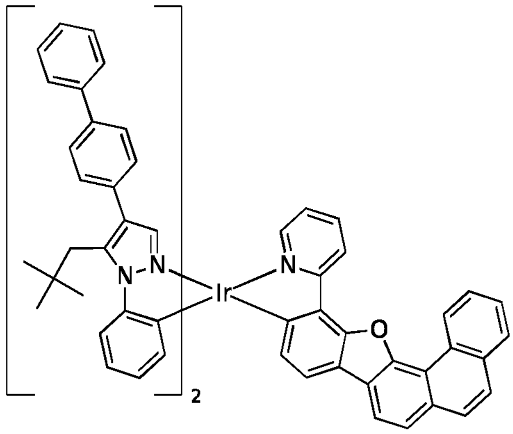

,

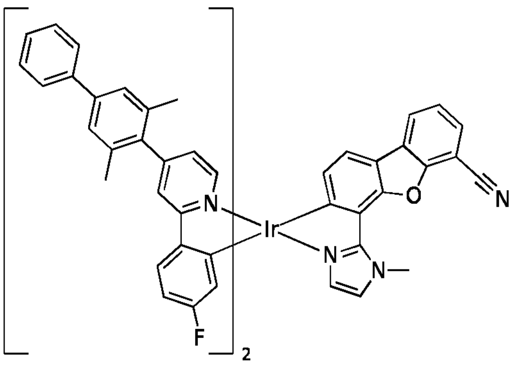

,

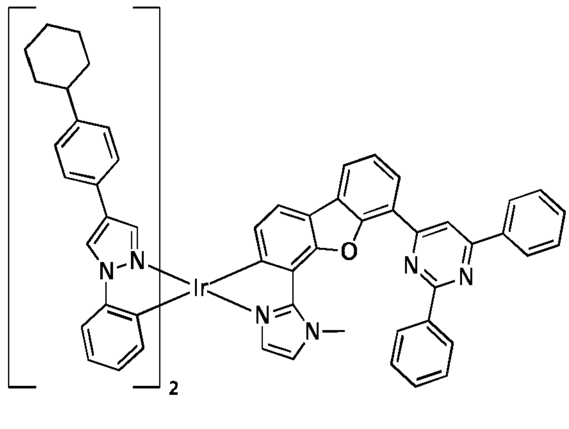

,

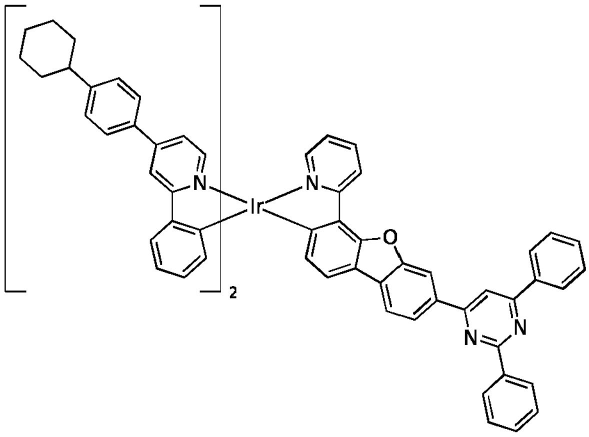

,

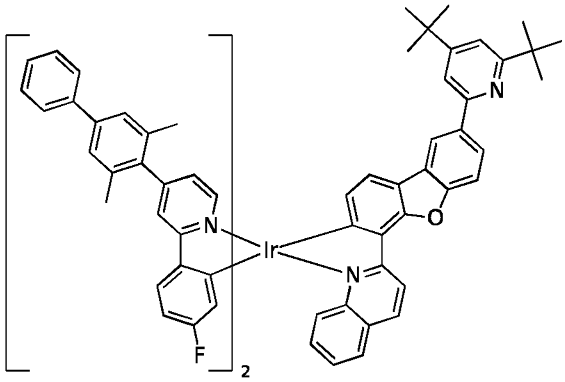

,

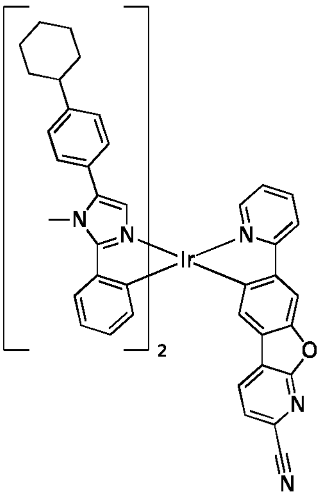

,

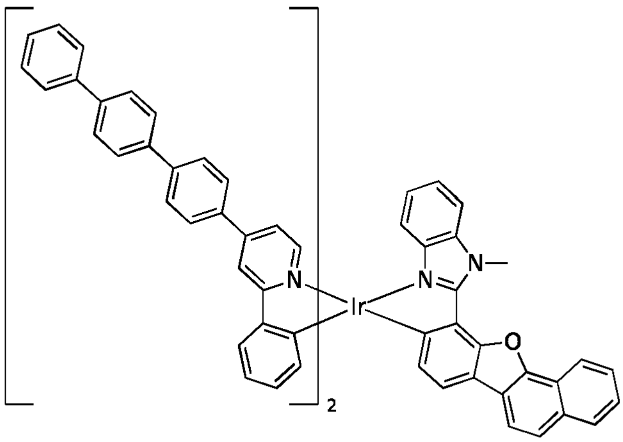

,

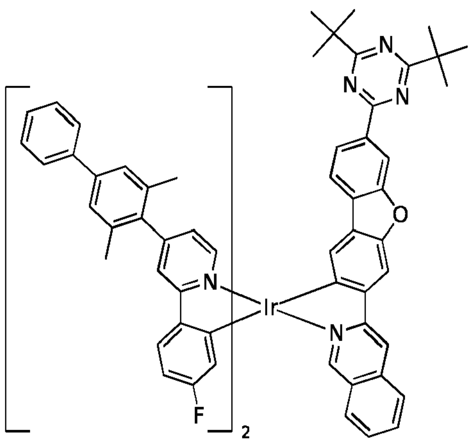

,

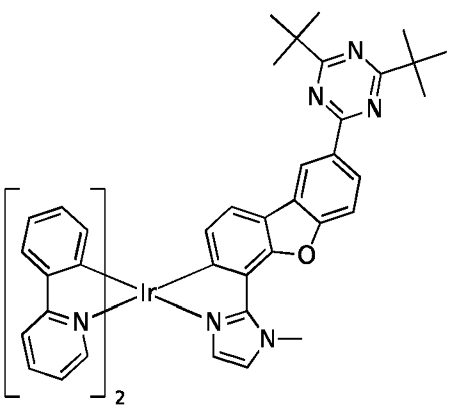

,

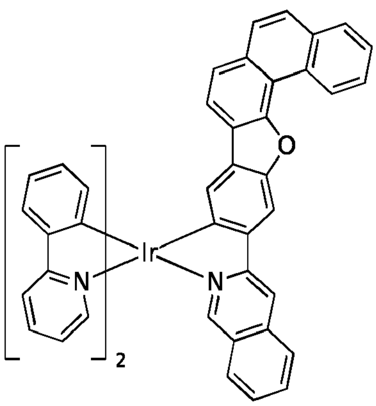

,

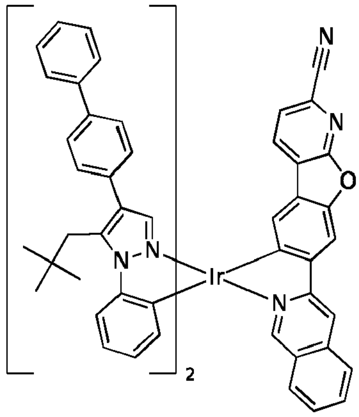

,

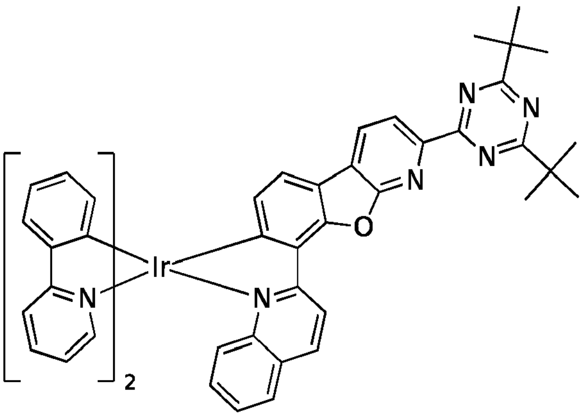

,

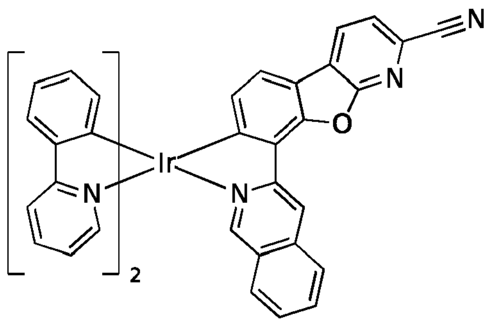

,

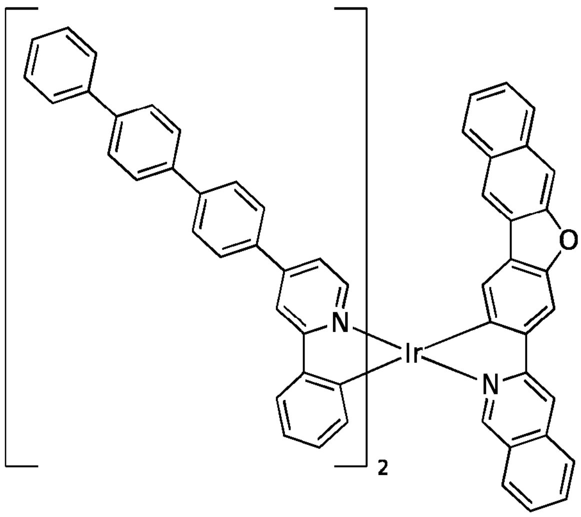

,

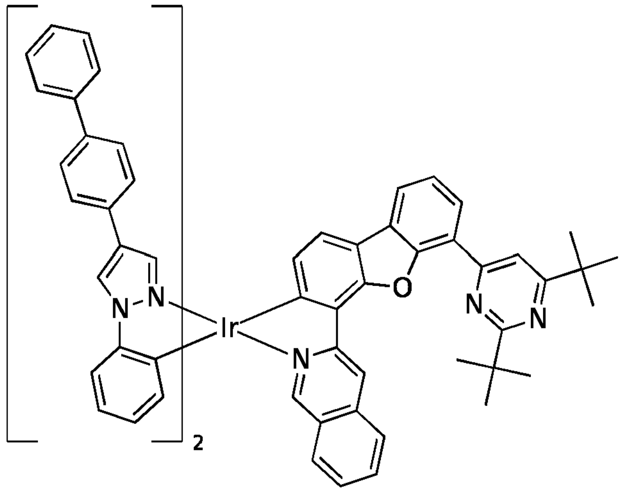

,

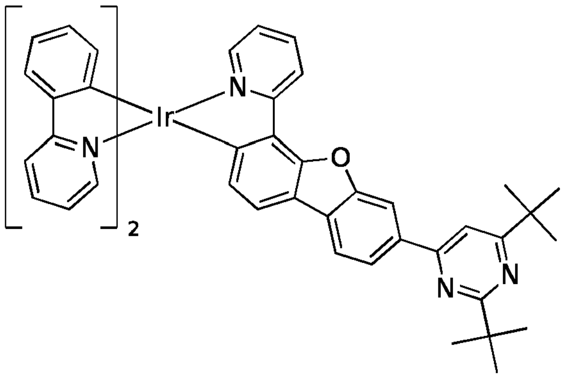

,

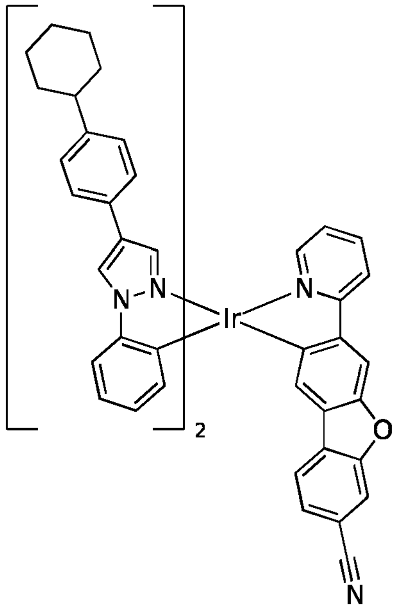

,

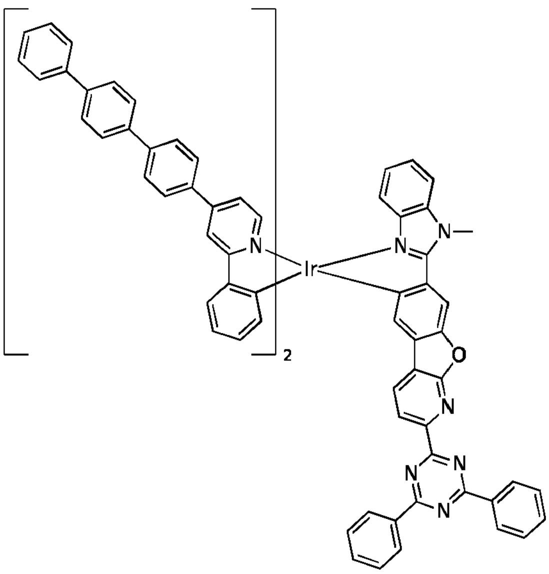

,

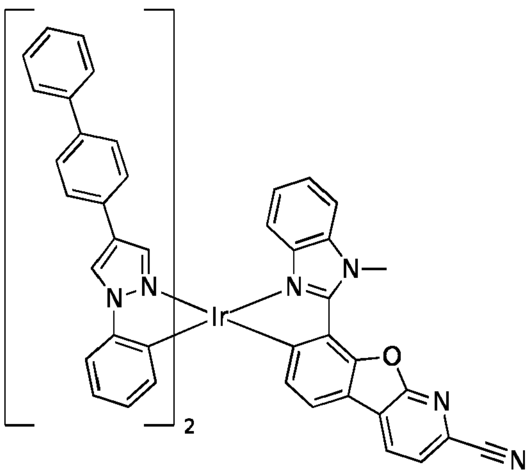

,

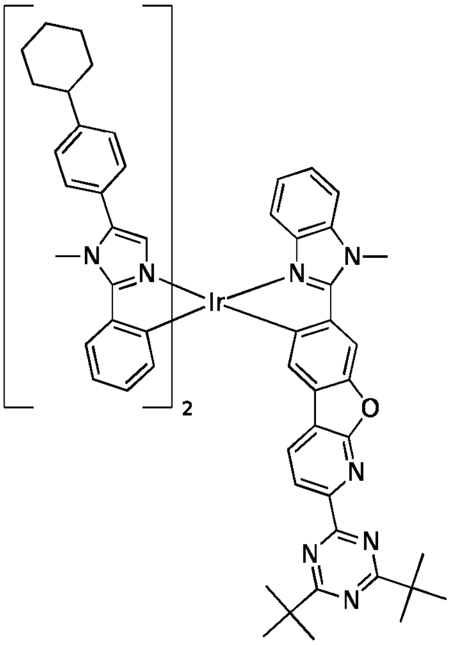
,
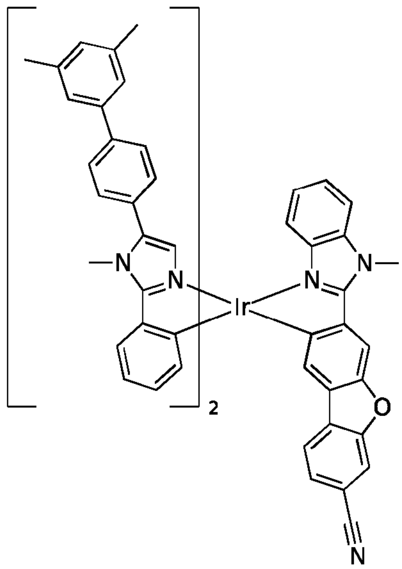
,
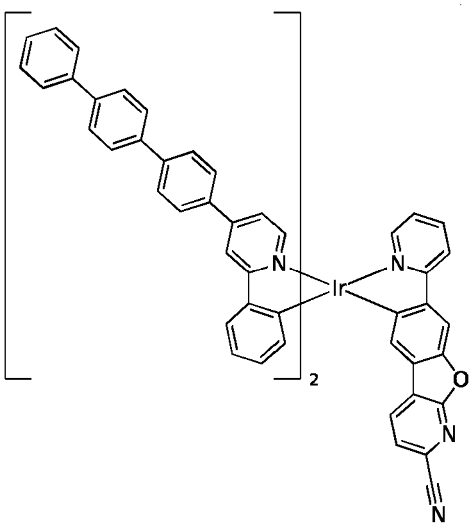
,
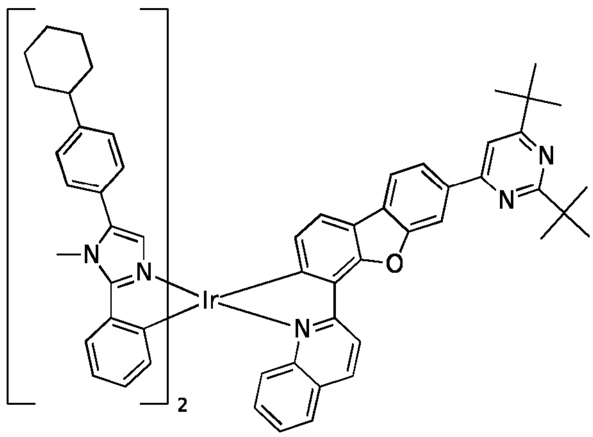
,
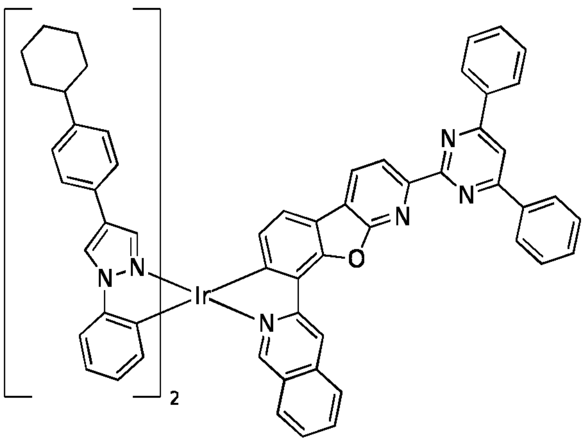
,
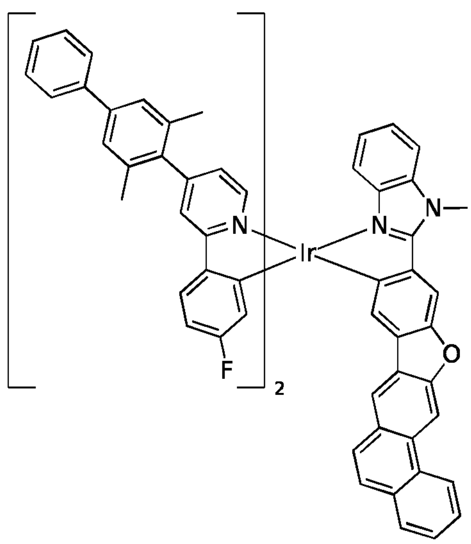
,

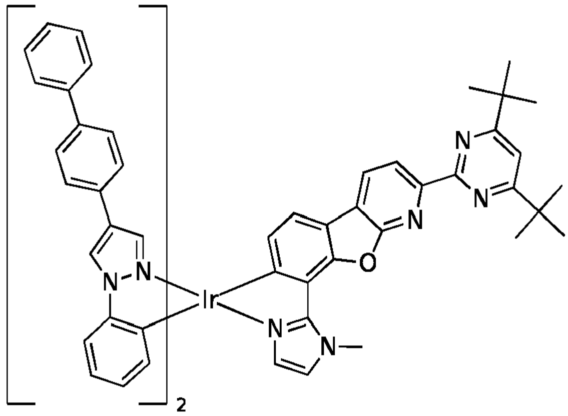

,

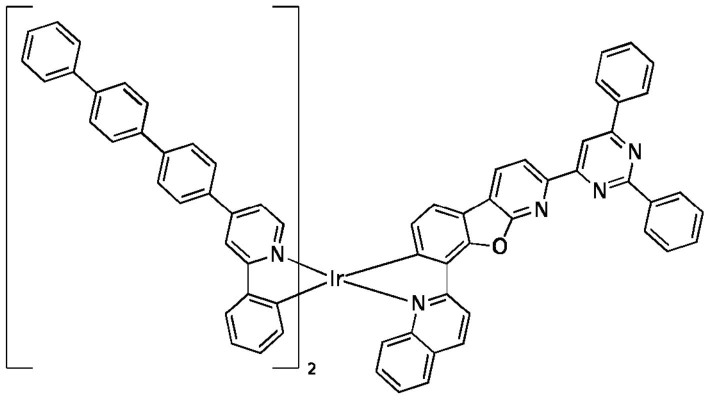

,

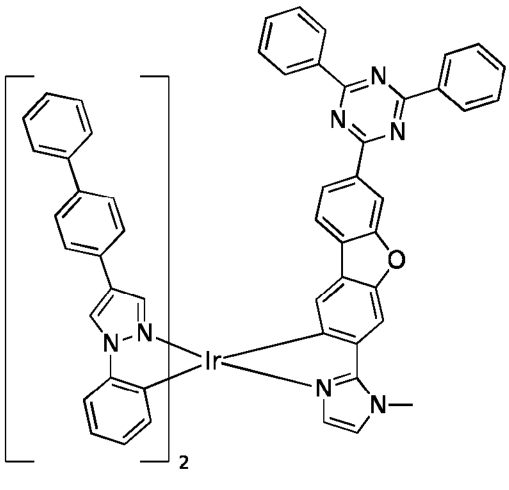

,

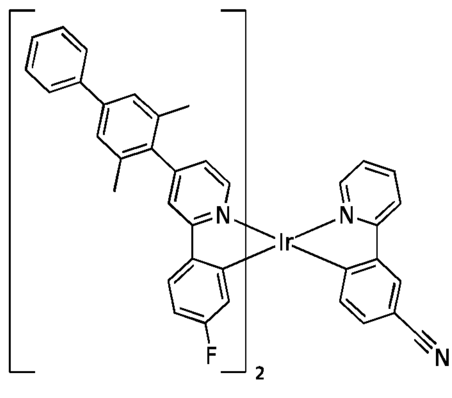

,

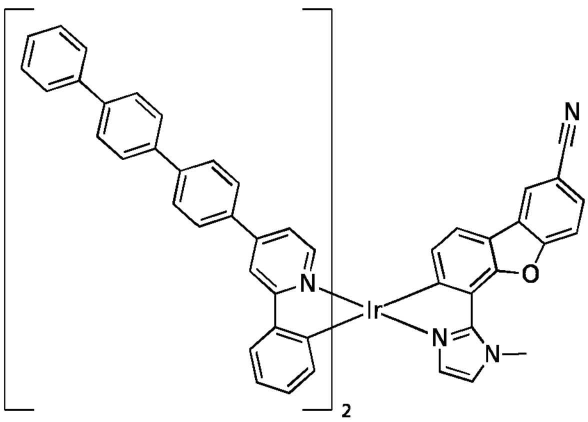
,
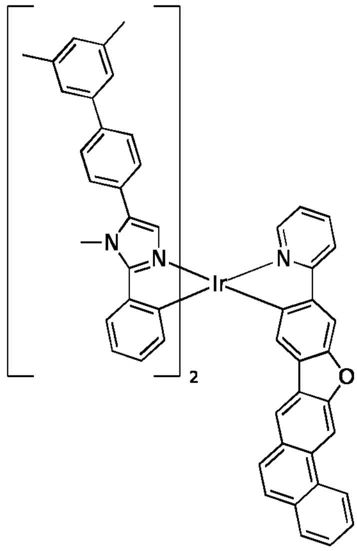
,

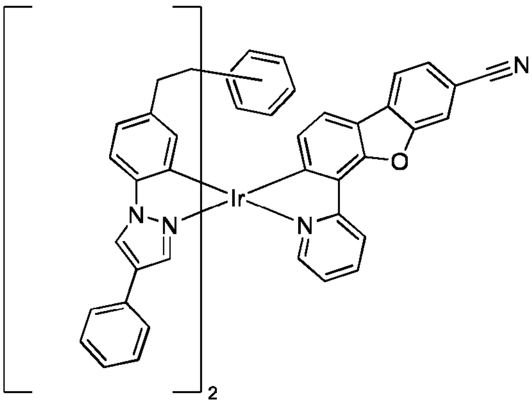
,
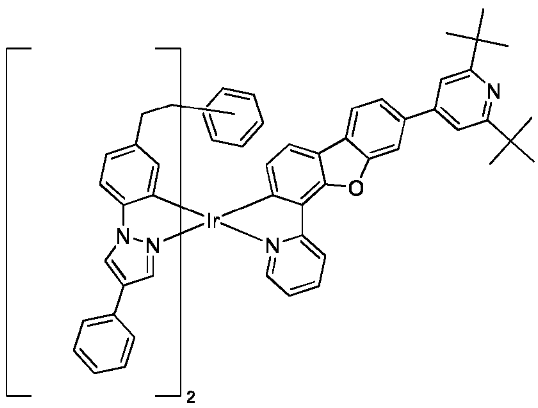
,

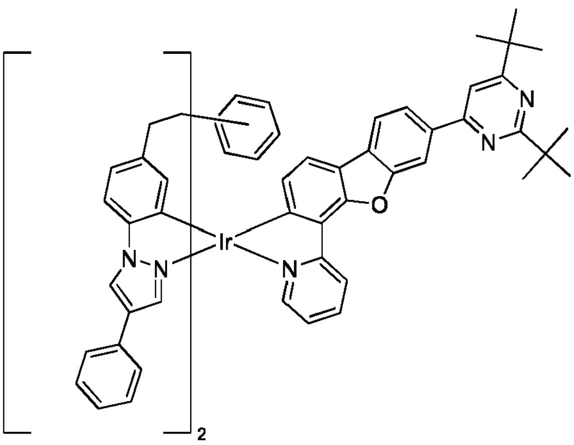
,
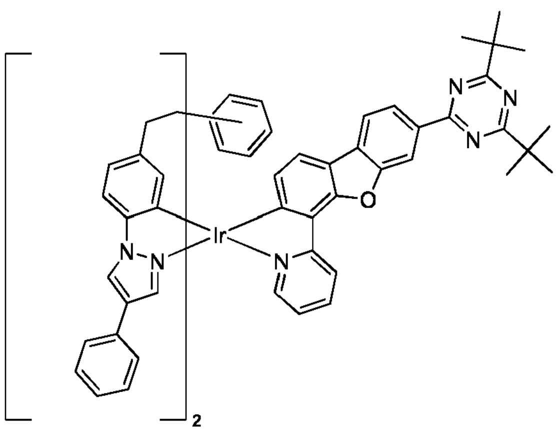
,

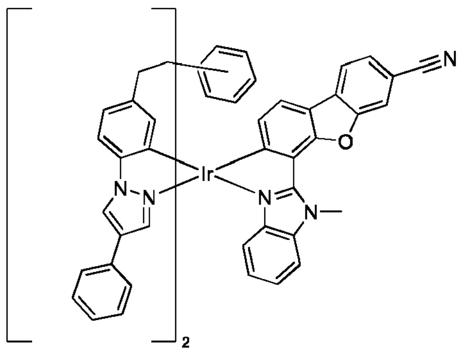,
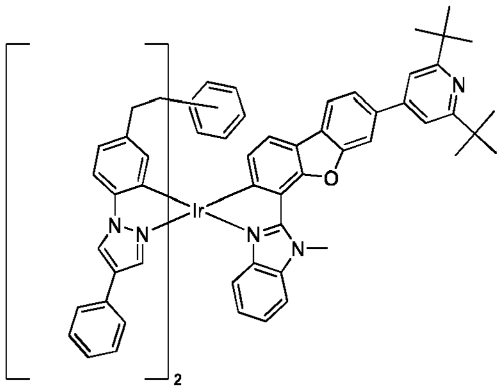,

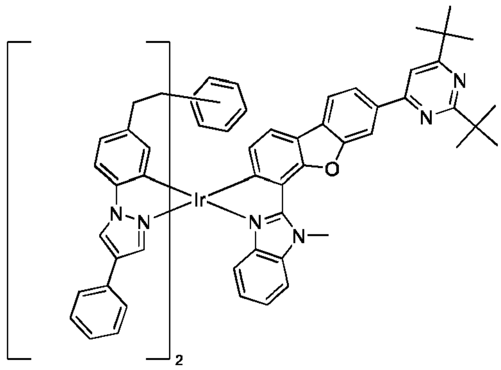, and
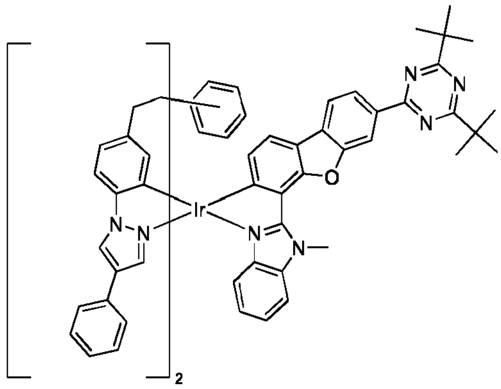.

**13.** An organic light emitting device (OLED) comprising:

an anode;
a cathode; and
an organic layer disposed between the anode and the cathode, wherein the organic layer comprises a metal coordination complex compound that is capable of functioning as an emitter in an organic light emitting device (OLED) at room temperature; wherein
the compound comprises a first emissive ligand that is coordinated to the metal;
the compound has a vertical dipole ratio (VDR) > 0.33; and
at least one of the following is true:

(1) the first emissive ligand has a spin density population is > 60%;
(2) the first emissive ligand has a natural transition orbital (NTO) particle population is > 50%;
(3) the first emissive ligand has a ligand-centered character (LC) is > 30%;
(4) the firstemissive ligand has a complex ligand-to-ligand charge transfer (LLCT) is < 40%; and
(5) the first emissive ligand has an M/T ratio is > 0.42.

**14.** The OLED of claim 13, wherein the OLED further comprises an enhancement layer, wherein the enhancement layer comprises a plasmonic material exhibiting surface plasmon resonance that non-radiatively couples to the emitter material and transfers excited state energy from the emitter material to non-radiative mode of surface plasmon polariton.

**15.** A consumer product comprising an organic light-emitting device comprising:

an anode;
a cathode; and
an organic layer disposed between the anode and the cathode, wherein the organic layer comprises a metal coordination complex compound that is capable of functioning as an emitter in an organic light emitting device (OLED) at room temperature; wherein
the compound comprises a first emissive ligand that is coordinated to the metal;

the compound has a vertical dipole ratio (VDR) > 0.33; and
at least one of the following is true:

(1) the first emissive ligand has a spin density population is > 60%;
(2) the first emissive ligand has a natural transition orbital (NTO) particle population is > 50%;
(3) the first emissive ligand has a ligand-centered character (LC) is > 30%;
(4) the firstemissive ligand has a complex ligand-to-ligand charge transfer (LLCT) is < 40%; and
(5) the first emissive ligand has an M/T ratio is > 0.42;

wherein the consumer product is one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a microdisplay that is less than 2 inches diagonal, a 3-D display, a virtual reality or augmented reality display, a vehicle, a video wall comprising multiple displays tiled together, a theater or stadium screen, a light therapy device, and a sign.

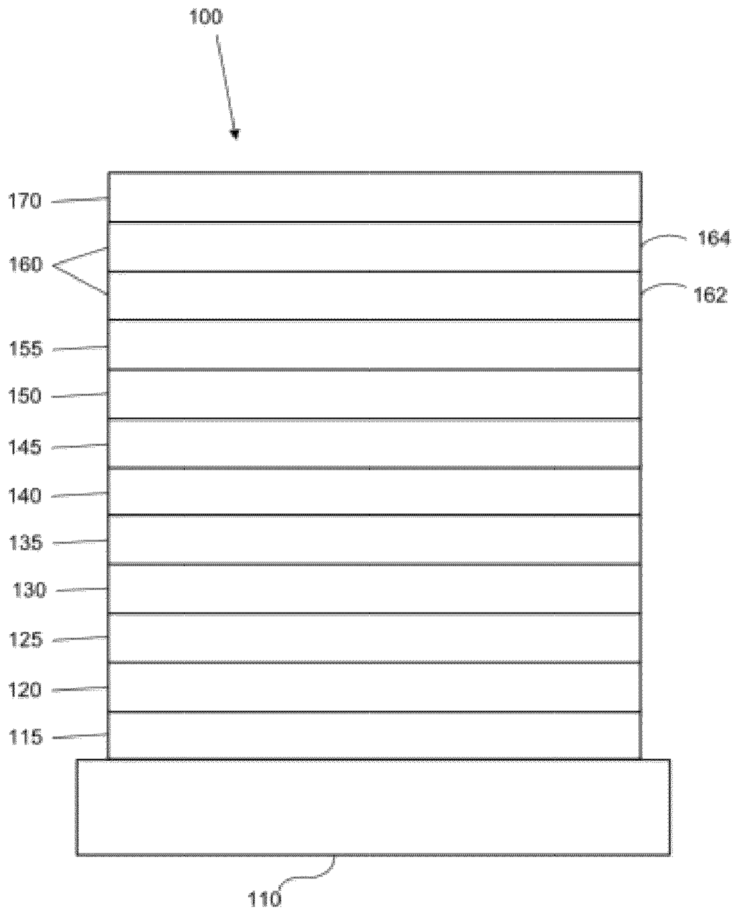
100
170
160
164
162
155
150
145
140
135
130
125
120
115
110

FIG. 1

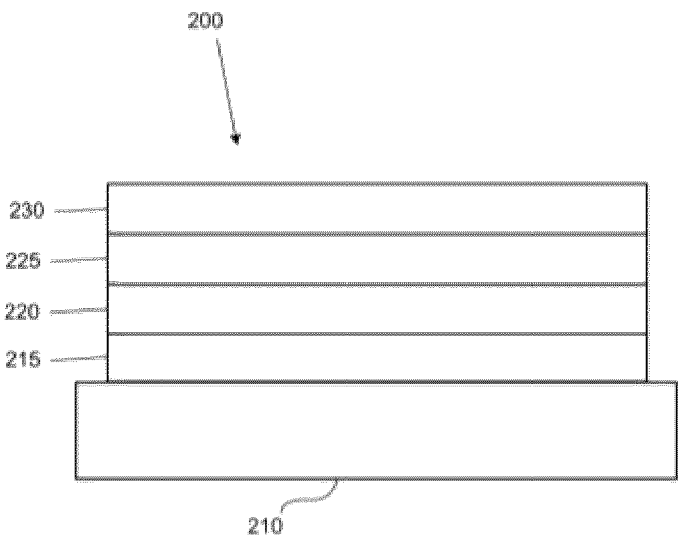
200
230
225
220
215
210

FIG. 2

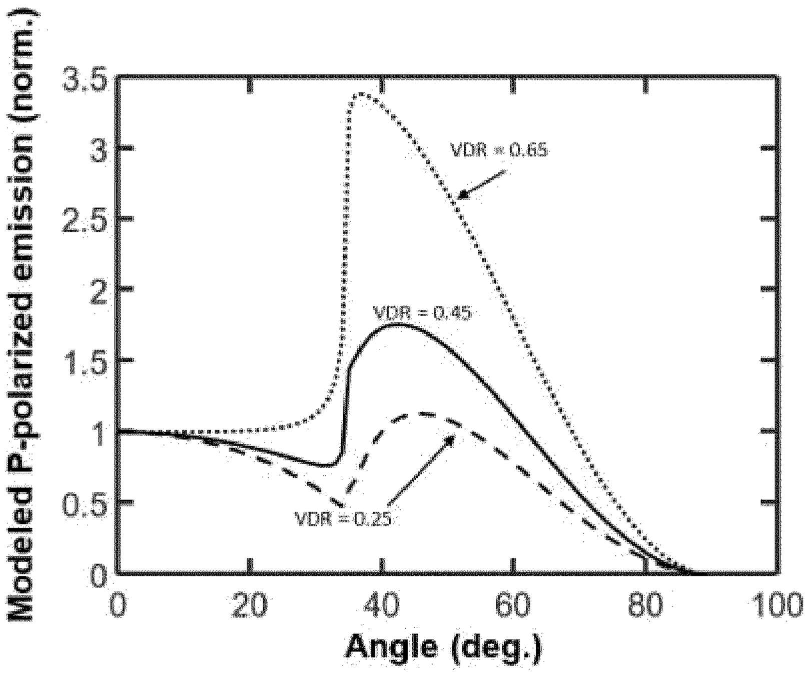
Modeled P-polarized emission (norm.)
3.5
3
2.5
2
1.5
1
0.5
0
0
20
40
60
80
100
Angle (deg.)
VDR = 0.65
VDR = 0.45
VDR = 0.25

FIG. 3

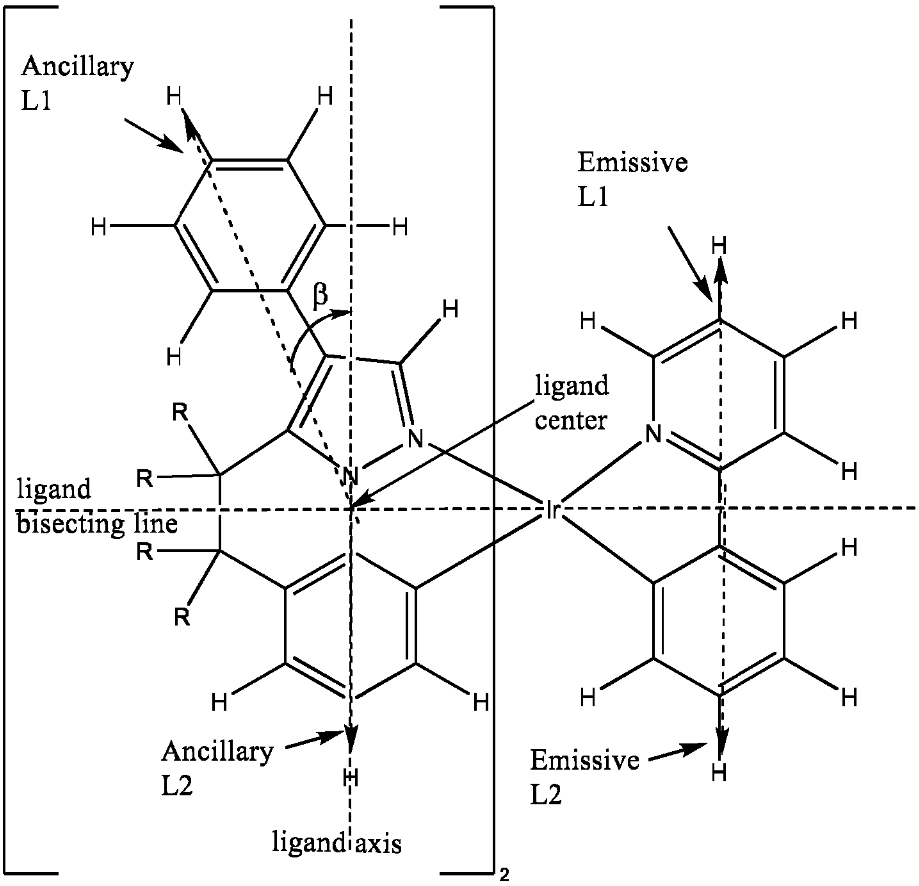
Ancillary L1
Emissive L1
ligand center
ligand bisecting line
Ancillary L2
Emissive L2
ligand axis

FIG. 4

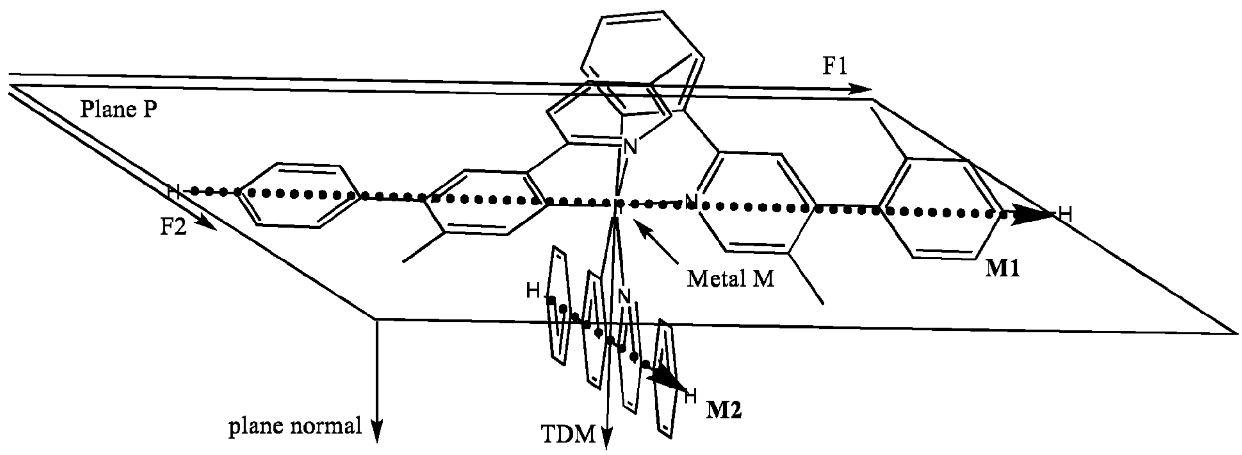


FIG. 5

Europäisches Patentamt
European Patent Office
Office européen des brevets

# EUROPEAN SEARCH REPORT

Application Number
EP 24 21 5190

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 937 268 A1 (UNIVERSAL DISPLAY CORP [US]) 12 January 2022 (2022-01-12)<br>* page 111; figure 25; table 3; compound 14 *<br>* paragraph [0195]; claim 3 *<br>----- | 1-15 | INV.<br>H10K85/30<br>H10K50/852<br>H10K50/85<br><br>ADD.<br>H10K50/11<br>H10K101/10 |
| X | US 2021/249633 A1 (FUSELLA MICHAEL [US] ET AL) 12 August 2021 (2021-08-12)<br>* claim 3; figure 25; table 3; compound 14 *<br>----- | 1-15 | |
| A | US 2023/399350 A1 (FLEETHAM TYLER [US] ET AL) 14 December 2023 (2023-12-14)<br>* paragraph [0245]; claim 18; example 1; compounds Pt-A *<br>----- | 1-15 | |
| A | CN 116 731 079 A (UNIVERSAL DISPLAY CORP) 12 September 2023 (2023-09-12)<br>* example 1; compounds Pt-A *<br>----- | 1-15 | |
| | | | TECHNICAL FIELDS SEARCHED (IPC) |
| | | | H10K |

The present search report has been drawn up for all claims

| Place of search | Date of completion of the search | Examiner |
|---|---|---|
| The Hague | 19 May 2025 | Fratiloiu, Silvia |

3

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..........................................................................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 21 5190

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2025

| Patent document cited in search report | Publication date | Patent family member(s) | Publication date |
|---|---|---|---|
| EP 3937268 A1 | 12-01-2022 | CN 113921728 A | 11-01-2022 |
| | | EP 3937268 A1 | 12-01-2022 |
| | | KR 20220007543 A | 18-01-2022 |
| US 2021249633 A1 | 12-08-2021 | US 2021249633 A1 | 12-08-2021 |
| | | US 2023129581 A1 | 27-04-2023 |
| | | US 2024215302 A1 | 27-06-2024 |
| US 2023399350 A1 | 14-12-2023 | NONE | |
| CN 116731079 A | 12-09-2023 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 8557400 B
- WO 2006095951 A
- US 20110037057 A
- US 5844363 A
- US 6303238 B
- US 5707745 A
- US 4769292 A
- US 7279704 B
- US 20030230980
- US 5703436 A
- US 6097147 A
- US 20040174116
- US 5247190 A, Friend
- US 6091195 A, Forrest
- US 5834893 A, Bulovic
- US 6013982 A
- US 6087196 A
- US 6337102 B, Forrest
- US 7431968 B
- US 6294398 B
- US 6468819 B
- US 7968146 B
- US 2007023098 W
- US 2009042829 W
- US 700352
- EP 01617493 A
- EP 01968131 A
- EP 2020694 A
- EP 2684932 A
- US 20050139810 A
- US 20070160905 A
- US 20090167167 A
- US 2010288362 A
- WO 06081780 A
- WO 2009003455 A
- WO 2009008277 A
- WO 2009011327 A
- WO 2014009310 A
- US 2007252140 A
- US 2015060804 A
- US 20150123047 A
- US 2012146012 A
- CN 102702075
- DE 102012005215
- EP 01624500 A
- EP 01698613 A
- EP 01806334 A
- EP 01930964 A
- EP 01972613 A
- EP 01997799 A
- EP 02011790 A
- EP 02055700 A
- EP 02055701 A
- EP 1725079 A
- EP 2085382 A
- EP 2660300 A
- EP 650955 A
- JP 7073529 A
- JP 2005112765 B
- JP 2007091719 B
- JP 2008021687 B
- JP 2014009196 A
- KR 20110088898
- KR 20130077473
- TW 201139402
- US 06517957 B
- US 20020158242 A
- US 20030162053 A
- US 20050123751 A
- US 20060182993 A
- US 20060240279 A
- US 20070145888 A
- US 20070181874 A
- US 20070278938 A
- US 20080014464 A
- US 20080091025 A
- US 20080106190 A
- US 20080124572 A
- US 20080145707 A
- US 20080220265 A
- US 20080233434 A
- US 20080303417 A
- US 2008107919 A
- US 20090115320 A
- US 20090167161 A
- US 2009066235 A
- US 2011007385 A
- US 20110163302 A
- US 2011240968 A
- US 2011278551 A
- US 2012205642 A
- US 2013241401 A
- US 20140117329 A
- US 2014183517 A
- US 5061569 A
- US 5639914 A
- WO 05075451 A
- WO 07125714 A

- WO 08023550 A
- WO 08023759 A
- WO 2009145016 A
- WO 2010061824 A
- WO 2011075644 A
- WO 2012177006 A
- WO 2013018530 A
- WO 2013039073 A
- WO 2013087142 A
- WO 2013118812 A
- WO 2013120577 A
- WO 2013157367 A
- WO 2013175747 A
- WO 2014002873 A
- WO 2014015935 A
- WO 2014015937 A
- WO 2014030872 A
- WO 2014030921 A
- WO 2014034791 A
- WO 2014104514 A
- WO 2014157018 A
- EP 2034538 A
- EP 2757608 A
- JP 2007254297 B
- KR 20100079458
- KR 20120088644
- KR 20120129733
- KR 20130115564
- TW 201329200
- US 20030175553 A
- US 20050238919 A
- US 20060280965 A
- US 20090017330 A
- US 20090030202 A
- US 20090167162 A
- US 20090302743 A
- US 20090309488 A
- US 20100012931 A
- US 20100084966 A
- US 20100187984 A
- US 2010187984 A
- US 2012075273 A
- US 2012126221 A
- US 2013009543 A
- US 2013105787 A
- US 2013175519 A
- US 2014001446 A
- US 20140183503 A
- US 20140225088 A
- US 2014034914 A
- US 7154114 B
- WO 2001039234 A
- WO 2004093207 A
- WO 2005014551 A
- WO 2005089025 A
- WO 2006072002 A
- WO 2006114966 A
- WO 2007063754 A
- WO 2008056746 A
- WO 2009003898 A
- WO 2009021126 A
- WO 2009063833 A
- WO 2009066778 A
- WO 2009066779 A
- WO 2009086028 A
- WO 2010056066 A
- WO 2010107244 A
- WO 2011081423 A
- WO 2011081431 A
- WO 2011086863 A
- WO 2012128298 A
- WO 2012133644 A
- WO 2012133649 A
- WO 2013024872 A
- WO 2013035275 A
- WO 2013081315 A
- WO 2013191404 A
- WO 2014142472 A
- US 20170263869 A
- US 20160163995 A
- US 9466803 B
- CN 103694277
- CN 1696137
- EP 01238981 A
- EP 01239526 A
- EP 01961743 A
- EP 1239526 A
- EP 1244155 A
- EP 1642951 A
- EP 1647554 A
- EP 1841834 A
- EP 1841834 B
- EP 2062907 A
- EP 2730583 A
- JP 2012074444 B
- JP 2013110263 B
- JP 4478555 B
- KR 1020090133652
- KR 20120032054
- KR 20130043460
- TW 201332980
- US 06699599 B
- US 06916554 B
- US 20010019782 A
- US 20020034656 A
- US 20030068526 A
- US 20030072964 A
- US 20030138657 A
- US 20050123788 A
- US 20050244673 A
- US 2005123791 A
- US 2005260449 A
- US 20060008670 A
- US 20060065890 A
- US 20060127696 A
- US 20060134459 A

- US 20060134462 A
- US 20060202194 A
- US 20060251923 A
- US 20070034863 A
- US 20070087321 A
- US 20070103060 A
- US 20070111026 A
- US 20070190359 A
- US 20070231600 A
- US 2007034863 A
- US 2007104979 A
- US 2007104980 A
- US 2007138437 A
- US 2007224450 A
- US 2007278936 A
- US 20080020237 A
- US 20080233410 A
- US 20080261076 A
- US 20080297033 A
- US 200805851 B
- US 2008161567 A
- US 2008210930 A
- US 20090039776 A
- US 20090108737 A
- US 20090115322 A
- US 20090179555 A
- US 2009085476 A
- US 2009104472 A
- US 20100090591 A
- US 20100148663 A
- US 20100244004 A
- US 20100295032 A
- US 2010102716 A
- US 2010105902 A
- US 2010244004 A
- US 2010270916 A
- US 20110057559 A
- US 20110108822 A
- US 20110204333 A
- US 2011215710 A
- US 2011227049 A
- US 2011285275 A
- US 2012292601 A
- US 20130146848 A
- US 2013033172 A
- US 2013165653 A
- US 2013181190 A
- US 2013334521 A
- US 20140246656 A
- US 2014103305 A
- US 6413656 B
- US 6653654 B
- US 6670645 B
- US 6687266 B
- US 6835469 B
- US 6921915 B
- US 7332232 B
- US 7378162 B
- US 7534505 B
- US 7675228 B
- US 7728137 B
- US 7740957 B
- US 7759489 B
- US 7951947 B
- US 8067099 B
- US 8592586 B
- US 8871361 B
- WO 06081973 A
- WO 06121811 A
- WO 07018067 A
- WO 07108362 A
- WO 07115970 A
- WO 07115981 A
- WO 08035571 A
- WO 2002015645 A
- WO 2003040257 A
- WO 2005019373 A
- WO 2006056418 A
- WO 2008054584 A
- WO 2008078800 A
- WO 2008096609 A
- WO 2008101842 A
- WO 2009000673 A
- WO 2009050281 A
- WO 2009100991 A
- WO 2010028151 A
- WO 2010054731 A
- WO 2010086089 A
- WO 2010118029 A
- WO 2011044988 A
- WO 2011051404 A
- WO 2011107491 A
- WO 2012020327 A
- WO 2012163471 A
- WO 2013094620 A
- WO 2013107487 A
- WO 2013174471 A
- WO 2014007565 A
- WO 2014008982 A
- WO 2014023377 A
- WO 2014024131 A
- WO 2014031977 A
- WO 2014038456 A
- WO 2014112450 A
- CN 103508940
- EP 01602648 A
- EP 01734038 A
- EP 01956007 A
- JP 2004022334 A
- JP 2005149918 B
- JP 2005268199 A
- KR 0117693
- KR 20130108183
- US 20040036077 A
- US 20070104977 A
- US 2007018155 A

- US 20090101870 A
- US 20090115316 A
- US 20090140637 A
- US 20090179554 A
- US 2009218940 A
- US 2010108990 A
- US 2011156017 A
- US 2011210320 A
- US 2012193612 A
- US 2012214993 A
- US 2014014925 A
- US 2014014927 A
- US 20140284580 A
- US 6656612 B
- US 8415031 B
- WO 2003060956 A
- WO 2007111263 A
- WO 2009148269 A
- WO 2010067894 A
- WO 2010072300 A
- WO 2011074770 A
- WO 2011105373 A
- WO 2013079217 A
- WO 2013145667 A
- WO 2013180376 A
- WO 2014104499 A
- WO 2014104535 A

**Non-patent literature cited in the description**


- **MING YAN et al.** *Tetrahedron*, 2015, vol. 71, 1425-30
- **ATZRODT et al.** *Angew. Chem. Int. Ed. (Reviews)*, 2007, vol. 46, 7744-65
- **LÖWDIN, P.-O.** *J. Chem. Phys.*, 1950, vol. 18, 365
- **LÖWDIN, P.-O.** *Adv Quantum Chem*, 1970, vol. 5, 185
- **HONG et al.** *Chem. Mater.*, 2016, vol. 28, 5791-98, 5792-935791, 98, 5792-93
- **TAVASLI et al.** *J. Mater. Chem.*, 2012, vol. 22, 6419-29, 6422
- **MORELLO, G.R.** *J. Mol. Model.*, 2017, vol. 23, 174
- **MAI et al.** *Coord. Chem. Rev.*, 2018, vol. 361, 74-97
- **BALDO et al.** Highly Efficient Phosphorescent Emission from Organic Electroluminescent Devices. *Nature*, 1998, vol. 395, 151-154
- **BALDO et al.** Very high-efficiency green organic light-emitting devices based on electrophosphorescence. *Appl. Phys. Lett.*, 1999, vol. 75 (3), 4-6